# EUROPEAN PATENT APPLICATION

(11) **EP 2 062 900 A1**
(43) Date of publication of application: **27.05.2009**
(21) Application number: 08169720.3
(22) Date of filing: 21.11.2008
(51) Int. Cl.: C07F 3/06, C09K 11/06, H05B 33/14, H01L 51/00

(54) **Novel organic electroluminescent compounds and organic electroluminescent device using the same**

(30) Priority: 22.11.2007 KR 20070119836
(71) Applicant: Gracel Display Inc., Seoul 133-833 (KR)
(72) Inventor: Kim, Hyun, 139-873, Seoul (KR); Eum, Sung Jin, 152-053, Seoul (KR); Cho, Young Jun, 136-060, Seoul (KR); Kwon, Hyuck Joo, 130-100, Seoul (KR); Kim, Bong Ok, 135-090, Seoul (KR); Kim, Sung Min, 157-886, Seoul-city (KR); Yoon, Seung Soo, 135-884, Seoul (KR)
(74) Representative: Buckley, Guy Julian

(57) **Abstract**

The present invention relates to organic electroluminescent compounds represented by Chemical Formula (1), and electroluminescent devices comprising the same as host material.

Chemical Formula 1 L¹L¹M

The electroluminescent compounds according to the invention, when used as electroluminescent host material in an OLED, provide lowered operation voltage and significantly improved power efficiency as compared to conventional host material.

## Description

### FIELD OF THE INVENTION

The present invention relates to electroluminescent compounds consisting of metal complexes exhibiting excellent electric conductivity and electroluminescent property of high efficiency, and electroluminescent devices comprising the same as host material, and organic solar cells comprising the same.

### BACKGROUND OF THE INVENTION

The most important factor to determine luminous efficiency in an OLED (organic light-emitting diode) is the type of electroluminescent material. Though fluorescent materials has been widely used as an electroluminescent material up to the present, development of phosphorescent materials is one of the best methods to improve the luminous efficiency theoretically up to four(4) times, in view of electroluminescent mechanism.

Up to now, iridium (III) complexes are widely known as phosphorescent material, including (acac)Ir(btp)2, Ir(ppy)₃ and Firpic, as the red, green and blue one, respectively. In particular, a lot of phosphorescent materials have been recently investigated in Japan, Europe and America.

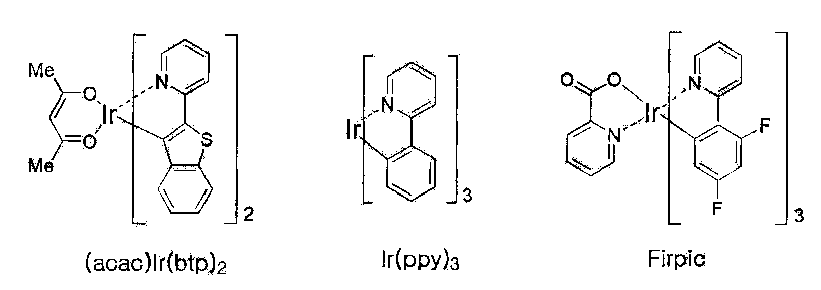

As a host material for phosphorescent light emitting material, CBP has been most widely known up to the present, and OLEDs having high efficiency to which a hole blocking layer (such as BCP and BAlq) has been applied have been known. Pioneer (Japan) or the like reported OLEDs having high efficiency using a BAlq derivative as the host.

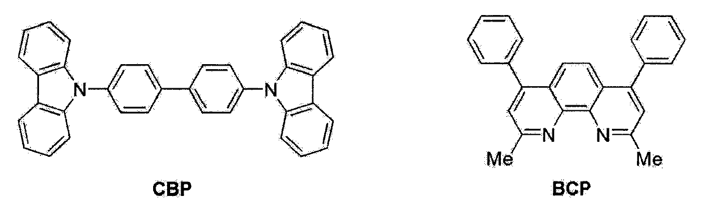

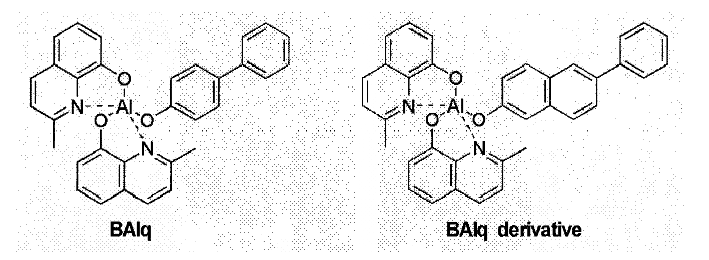

Though the materials in prior art are advantageous in view of light emitting property, they have low glass transition temperature and very poor thermal stability, so that the materials tend to be changed during the process of high temperature vapor-deposition in vacuo. In an organic electroluminescent device (OLED), it is defined that power efficiency = (π/voltage) x current efficiency. Thus, the power efficiency is inversely proportional to the voltage, and the power efficiency should be higher in order to obtain lower power consumption of an OLED. In practice, an OLED employing phosphorescent electroluminescent (EL) material shows significantly higher current efficiency (cd/A) than an OLED employing fluorescent EL material. However, in case that a conventional material such as BAlq and CBP as host material of the phosphorescent EL material is employed, no significant advantage can be obtained in terms of power efficiency (lm/w) because of higher operating voltage as compared to an OLED employing a fluorescent material.

Since those OLED's are also unsatisfactory in terms of device life, development of host materials showing more enhanced performance is required.

Researches on conventional complexes of this type have been intensively progressed since the middle of 1990's as blue electroluminescent materials or the like. However, those materials have been simply applied as electroluminescent material, but rarely known to be applied as host material.

### SUMMARY OF THE INVENTION

Thus, the object of the invention is to overcome the problems described above and to provide novel electroluminescent compounds having the backbone of ligand metal complex exhibiting more excellent electroluminescent properties and physical properties as compared to conventional organic host materials. Another object of the invention is to provide electroluminescent devices comprising the electroluminescent compound as host material. Still another object of the invention is to provide organic solar cells comprising the novel electroluminescent compounds.

The present invention relates to electroluminescent compounds represented by Chemical Formula (1), and electroluminescent devices comprising the same as host material.

Chemical Formula 1 L¹L¹M

In Chemical Formula (1), ligand L¹ is represented by the following structural formula: 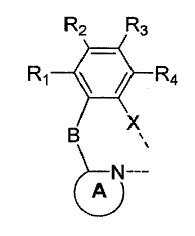 wherein, M represents a bivalent metal;
X represents O, S or Se;
ring A represents a 5- or 6-membered heteroaromatic ring or a 5- or 6-heteroaromatic ring fused with a (C6-C20)aromatic ring, and the heteroaromatic ring or the heteroaromatic ring fused with an aromatic ring may form a chemical bond with R₁ to create a fused ring, and ring A may be further substituted by (C1-C10)alkyl, halogen, (C1-C1010)alkyl with halogen substituent(s), phenyl, naphthyl, biphenyl, fluorenyl, thiophenyl, furanyl, tri(C1-C10)alkylsilyl, tri(C6-C20)arylsilyl, di(C1-C10)alkyl(C6-C20)arylsilyl, di(C1-C10)alkylamino or di(C6-C20)arylamino;
B represents 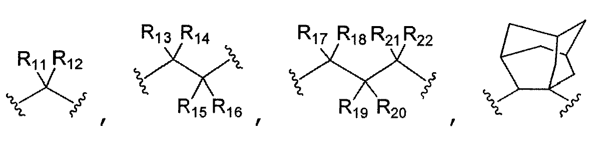 or 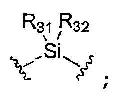 R₁ through R₄ independently represent hydrogen, (C1-C10)alkyl, halogen, (C1-C10)alkyl with halogen substituent(s), tri(C1-C10)alkylsilyl, tri(C6-C20)arylsilyl, di(C1-C10)alkyl(C6-C20)arylsilyl, (C6520)aryl, (C4-C20)heteroaryl, di(C1-C10)alkylamino or di(C6-C20)arylamino, or each of them may be linked to an adjacent sustituent via alkylene of alkenylene to form a fused ring;
R₁₁ through R₂₂ independently represent hydrogen, (C1-C10)alkyl, halogen, (C1-C10)alkyl with halogen substituent(s), (C1-C10)alkoxy, phenyl, cyano or (C3-C7)cycloalkyl, or each of them may be linked to an adjacent substituent via alkylene or alkenylene to form a (C5-C7) spiro ring or a (C5-C9) fused ring, and R₁₁-R₁₂, R₁₃-R₁₄, R₁₅-R₁₆, R₁₇-R₁₈, R₁₉-R₂₀ or R₂-R₂₂ may form a double bond or carbonyl;
R₃₁ and R₃₂ independently represent (C1-C10)alkyl or (C6-C20)aryl; and
the phenyl, naphthyl, biphenyl, fluorenyl, thiophenyl or furanyl substituent on ring A, or aryl or heteroaryl of R₁ through R₄ may be further substituted by one or more substituent(s) selected from (C1-C10)alkyl, halogen, (C1-C10)alkyl with halogen substituent(s), (C1-C10)alkoxy, phenyl, naphthyl, fluorenyl, tri(C1-C10)alkylsilyl, tri(C6-C20)arylsilyl, di(C1-C10)alkyl(C6-C20)arylsilyl, di(C1-C10)alkylamino and di(C6-C20)arylamino.

### BRIEF DESCRIPTION OF THE DRAWINGS

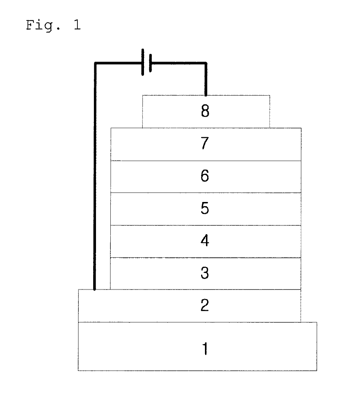

Fig. 1 is a cross-sectional view of an OLED.

### DETAILED DESCRIPTION OF THE INVENTION

Referring now to the Drawings, Fig. 1 illustrates a cross-sectional view of an OLED comprising a Glass 1, a Transparent electrode 2, a Hole injection layer 3, a Hole transport layer 4, an Electroluminescent layer 5, an Electron transport layer 6, an Electron injection layer 7 and an A1 cathode 8.

The term "alkyl" described herein and any substituents comprising "alkyl" moiety include both linear and branched species.

The term "aryl" described herein means an organic radical derived from aromatic hydrocarbon via elimination of one hydrogen atom. Each ring comprises a monocyclic or fused ring system suitably containing from 4 to 7, preferably from 5 to 6 cyclic atoms. Specific examples include phenyl, naphthyl, biphenyl, anthryl, indenyl, fluorenyl, phenanthryl, triphenylenyl, pyrenyl, perylenyl, chrysenyl, naphthacenyl and fluoranthenyl, but they are not restricted thereto.

The term "heteroaromatic ring" described herein means a 5-or 6-membered aromatic group containing one or more heteroatom(s) selected from N, O and S, and include, for example, pyrrole, pyrazole, oxazole, isoxazole, thiazole, isothiazole, imidazole, oxadiazole, thiadiazole, pyridine, pyrazine, pyrimidine and pyridazine. Specific examples of 5-or 6-membered heteroaromatic rings fused with a (C6-C20)aromatic ring include indazole, benzoxazole, benzothiazole, benzimidazole, phthalazine, quinoxaline, quinazoline, cinnoline, carbazole, phenathridine, acridine, quinoline and isoquinoline. Ring A is preferably selected from oxazole, thiazole, imidazole, oxadiazole, thiadiazole, benzoxazole, benzothiazole, benzimidazole, pyridine and quinoline. Ligand L₁ is selected from the following structures: 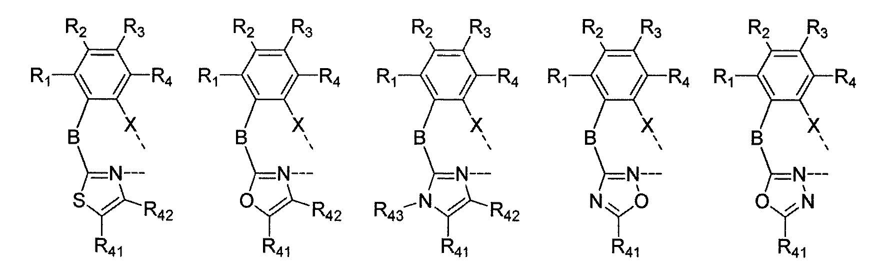 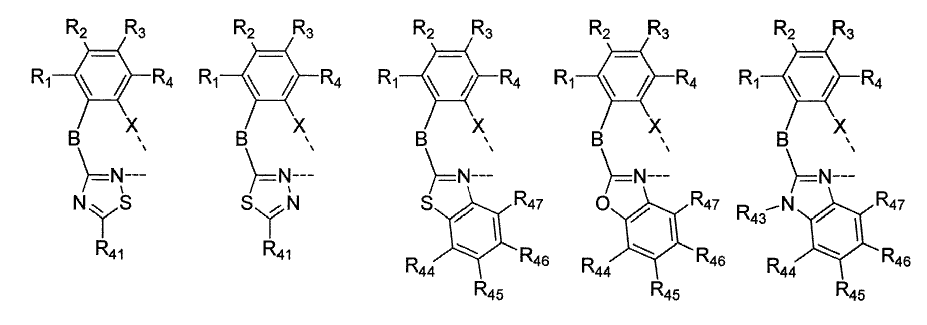 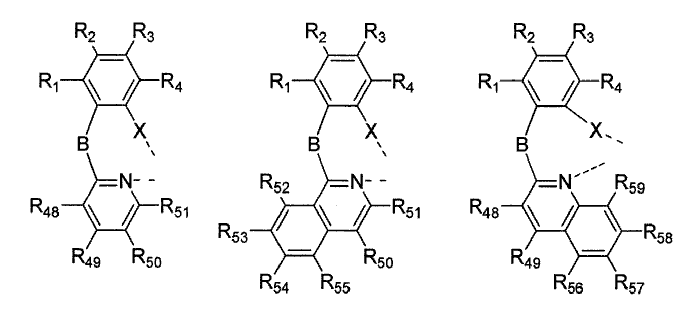 wherein, R₁, R₂, R₃, R₄, X and B are defined as in Chemical Formula (1);
R₄₁ and R₄₂ independently represent hydrogen, (C1-C10)alkyl, halogen, (C1-C10)alkyl with halogen substituent(s), phenyl, naphthyl, biphenyl, fluorenyl, thiophenyl, furanyl, tri(C1-C10)alkylsilyl, tri(C6-C20)arylsilyl, di(C1-C10)alkylamino or di(C6-C20)arylamino;
R₄₃ represents (C1-C10)alkyl, phenyl or naphthyl;
R₄₄ through R₅₉ independently represent hydrogen, (C1-C10)alkyl, halogen, (C1-C10)alkyl with halogen substituent(s), phenyl, naphthyl, biphenyl, fluorenyl, thiophenyl, furanyl, tri(C1-C10)alkylsilyl, tri(C6-C20)arylsilyl, di(C1-C10)alkylamino or di(C6-C20)arylamino; and
the phenyl, naphthyl, biphenyl, fluorenyl, thiophenyl or furanyl of R₄₁ through R₅₉ may be further substituted by one or more substituent(s) selected from (C1-C10)alkyl, halogen, (C1-C10)alkoxy, phenyl, tri(C1-C10)alkylsilyl, tri(C6-C20)arylsilyl, di(C1-C10)alkylamino and di(C6-C20)arylamino.

In Chemical Formula (1), M represents a bivalent metal, preferably selected from Be, Zn, Mg, Cu and Ni; and B is preferably selected from the following structures: 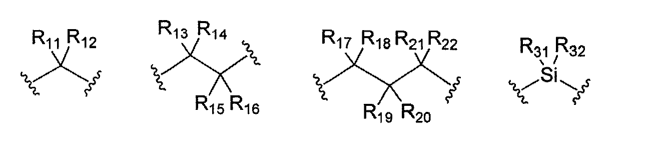 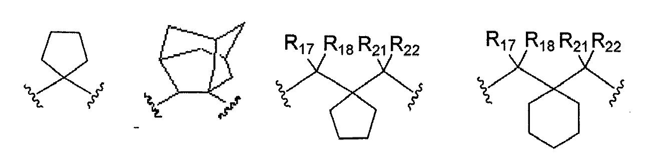 wherein, R₁₁ through R₂₂ independently represent hydrogen, methyl, ethyl or fluoro; and R₃₁ and R₃₂ independently represent methyl or phenyl.

The electroluminescent compounds of Chemical Formula (1) according to the present invention can be specifically exemplified by the following compounds, but they are not restricted thereto: 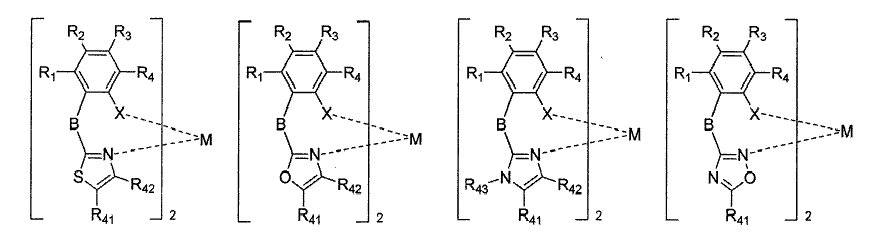 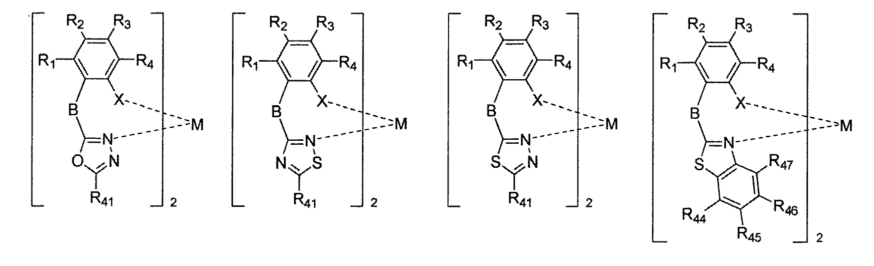 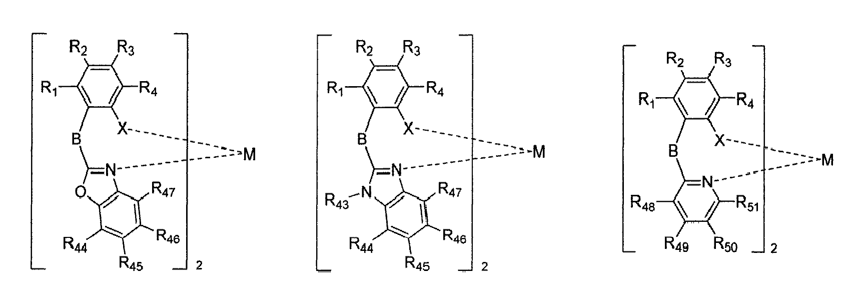 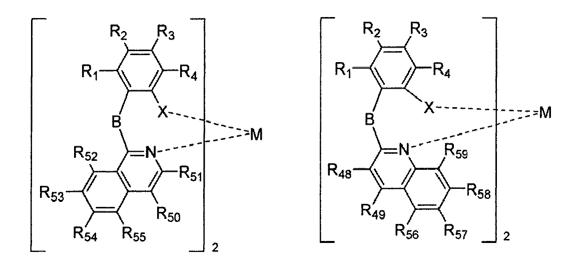 wherein, M represents Be, Zn, Mg, Cu or Ni;
X represents O, S or Se;
B represents

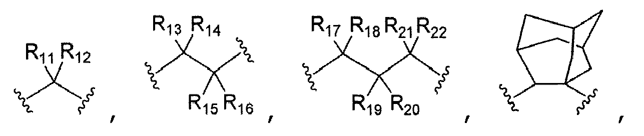

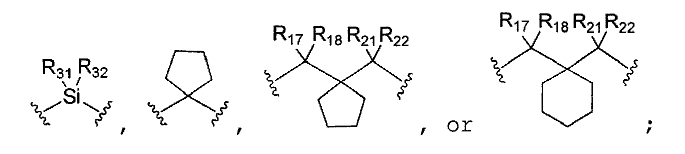

R₁ through R₄ independently represent hydrogen, methyl, ethyl, n-propyl, i-propyl, n-butyl, i-butyl, t-butyl, fluoro, trifluoromethyl, trimethylsilyl, triphenylsilyl, phenyl or biphenyl; and the phenyl or biphenyl of R₁ through R₄ may be further substituted by methyl, ethyl, n-propyl, i-propyl, n-butyl, i-butyl, t-butyl, fluoro or phenyl;
R₁₁ through R₂₂ independently represent hydrogen, methyl, ethyl or fluoro;
R₃₁ and R₃₂ independently represent methyl or phenyl;
R₄₁ and R₄₂ independently represent hydrogen, methyl, ethyl, n-propyl, i-propyl, n-butyl, i-butyl, t-butyl, fluoro, trifluoromethyl, phenyl, naphthyl, biphenyl, fluorenyl, thiophenyl, furanyl, trimethylsilyl, triphenylsilyl, dimethylamino or diphenylamino;
R₄₃ represents methyl, ethyl, n-propyl, i-propyl, n-butyl, i-butyl, t-butyl or phenyl;
R₄₄ through R₅₉ independently represent hydrogen, methyl, ethyl, n-propyl, i-propyl, n-butyl, i-butyl, t-butyl, fluoro, trifluoromethyl, phenyl, naphthyl, biphenyl, fluorenyl, thiophenyl, furanyl, trimethylsilyl, triphenylsilyl, dimethylamino or diphenylamino; and
the phenyl, naphthyl or biphenyl of R₄₁ through R₅₉ may be further substituted by one or more substituent(s) selected from methyl, ethyl, n-propyl, i-propyl, n-butyl, i-butyl, t-butyl, fluoro, methoxy, ethoxy, t-butoxy, phenyl, trimethylsilyl, triphenylsilyl, dimethylamino and diphenylamino.

The present invention also provides organic solar cells, which comprises one or more electroluminescent compound(s) represented by Chemical Formula (1).

The present invention also provides an electroluminescent device which is comprised of a first electrode; a second electrode; and at least one organic layer(s) interposed between the first electrode and the second electrode; wherein the organic layer comprises one or more compound(s) represented by Chemical Formula (1).

The electroluminescent device according to the present invention is characterized in that the organic layer comprises an electroluminescent layer, which comprises one or more electroluminescent compound(s) represented by Chemical Formula (1) as electroluminescent host in an amount of 2 to 30% by weight, and one or more electroluminescent dopant(s). The electroluminescent dopant applied to the electroluminescent device according to the invention is not particularly restricted, but may be exemplified by the compounds represented by Chemical Formula (2):

Chemical Formula 2 M¹L³L⁴L⁵

wherein, M¹ is selected from a group consisting of Group 7, 8, 9, 10, 11, 13, 14, 15 and 16 in the Periodic Table, and ligands L³, L⁴ and L⁵ are independently selected from the following structures: 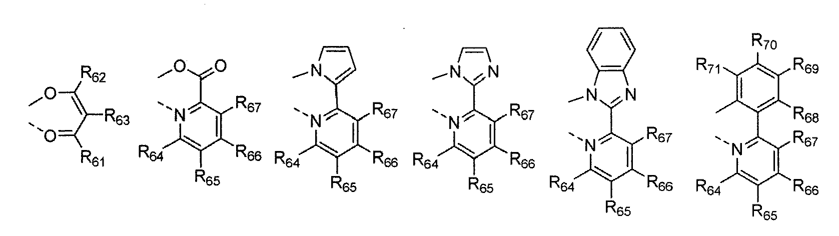 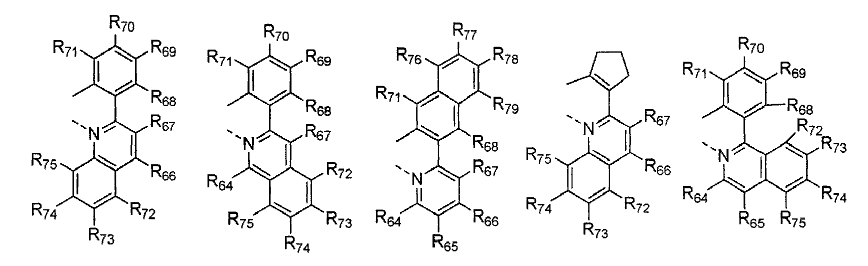 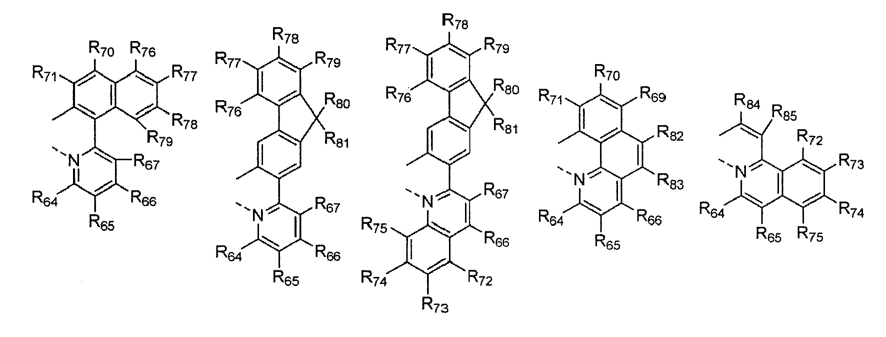 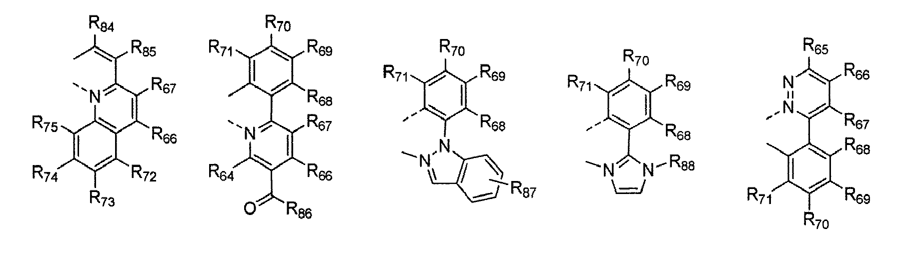 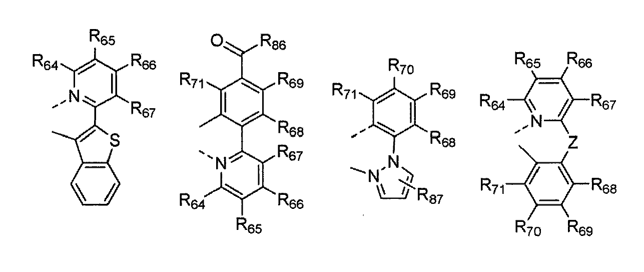 wherein, R₆₁ and R₆₂ independently represent hydrogen, (C1-C20)alkyl with or without halogen substituent(s), phenyl with or without (C1-C20)alkyl substituent(s), or halogen;
R₆₃ through R₇₉, R₈₂ and R₈₃ independently represent hydrogen, (C1-C20)alkyl with or without halogen substituent(s), (C1-C20)alkoxy, phenyl with or without (C1-C20)alkyl substituent(s), SF₅, tri(C1-C20)alkylsilyl or halogen;
R₈₀, R₈₁, R₈₄ and R₈₅ independently represent hydrogen, (C1-C20)alkyl, or phenyl with or without (C1-C20)alkyl substituent(s);
R₈₆ represents (C1-C20)alkyl, phenyl with or without (C1-C20)alkyl substituent(s), or halogen;
R₈₇ and R₈₈ independently represent hydrogen, (C1-C20)alkyl with or without halogen substituent(s), phenyl with or without (C1-C20)alkyl substituent(s), or halogen;
Z represents 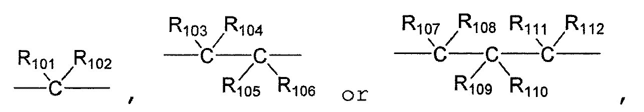 wherein R₁₀₁ through R₁₁₂ independently represent hydrogen, (C1-C20)alkyl with or without halogen substituent(s), alkoxy group, halogen, phenyl, ketone, cyano or (C5-C7) cycloalkyl, or R₁₀₁ through R₁₁₂ and another adjacent group from R₁₀₁ through R₁₁₂ may be linked via alkylene or alkenylene to form a (C5-C7) spiro ring or a (C5-C9) fused ring, or they may be linked to R₆₇ or R₆₈ via alkylene or alkenylene to form a (C5-C7) fused ring.
m¹ may be selected from Ir, Pt, Pd, Rh, Re, Os, Tl, Pb, Bi, In, Sn, Sb, Te, Au and Ag, and the compound of Chemical Formula (2) may be specifically exemplified by the compounds with one of the following structures, but they are not restricted thereto.

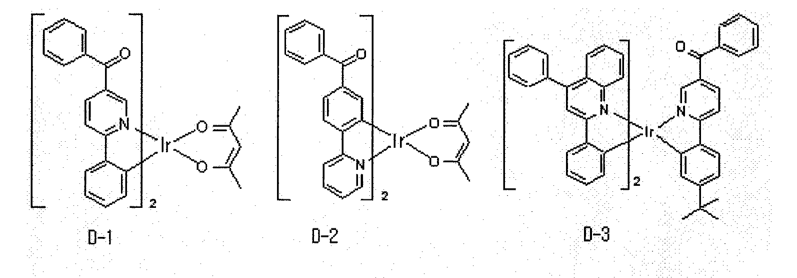

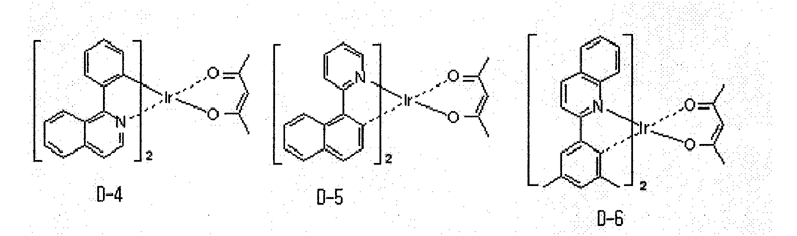

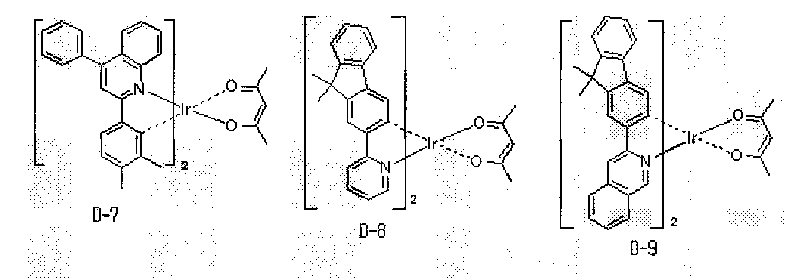

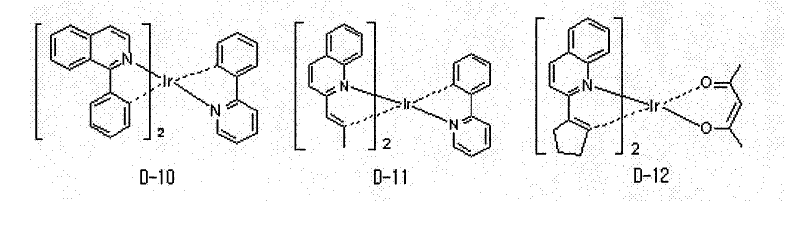

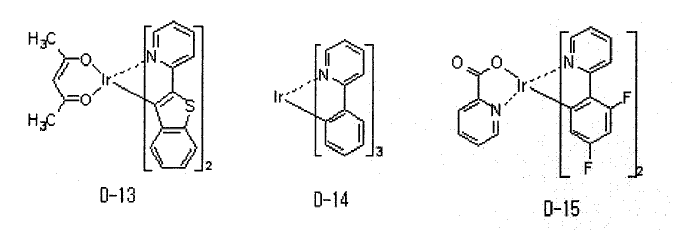

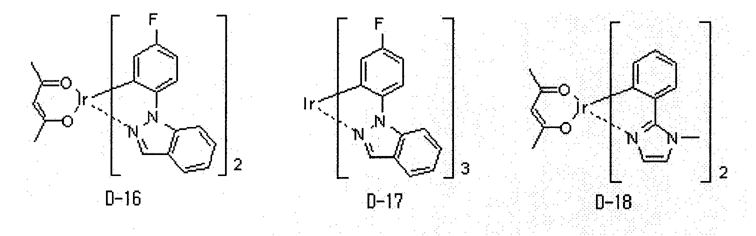

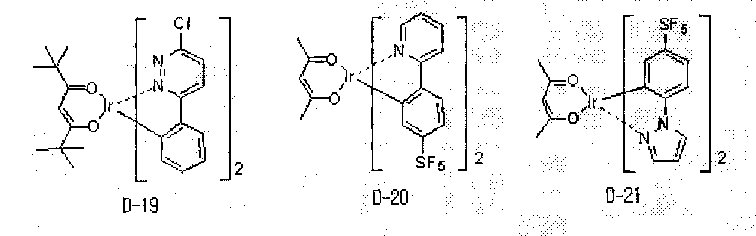

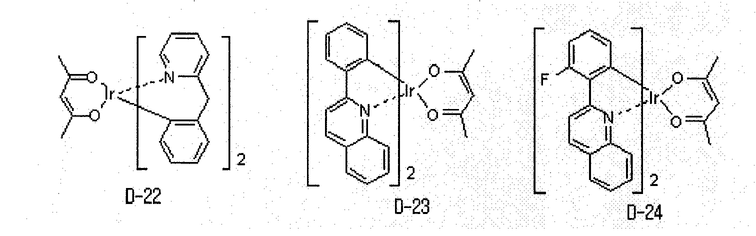

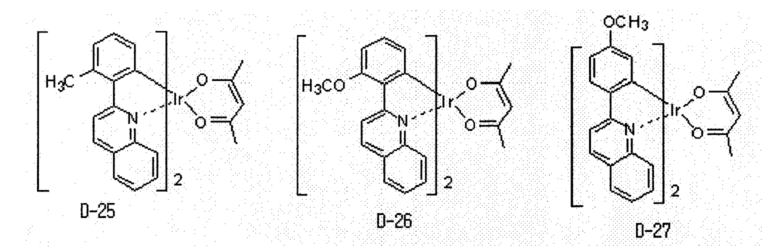

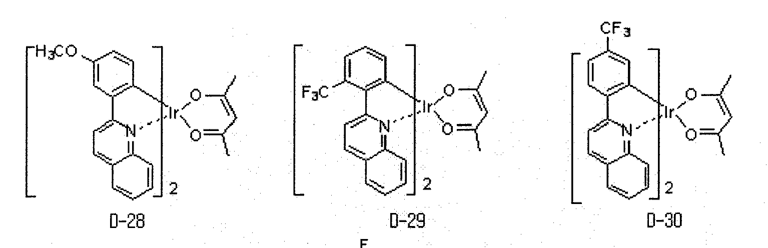

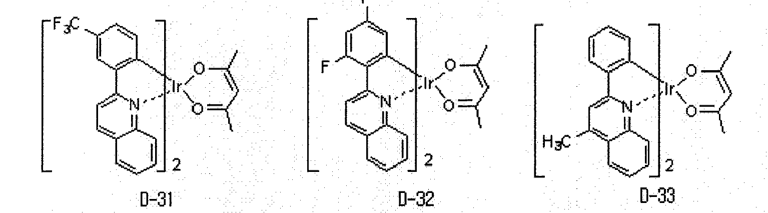

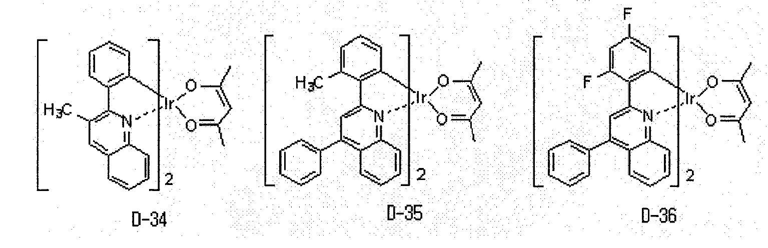

The electroluminescent layer means the layer where electroluminescence occurs, and it may be a single layer or a multi-layer consisting of two or more layers laminated. When a mixture of host-dopant is used according to the constitution of the present invention, noticeable improvement in device life as well as in luminous efficiency could be confirmed.

The electroluminescent device according to the invention may further comprise one or more compound(s) selected from arylamine compounds and styrylarylamine compounds, as well as the electroluminescent compound represented by Chemical Formula (1). Examples of arylamine or styrylarylamine compounds include the compounds represented by Chemical Formula (3), but they are not restricted thereto: 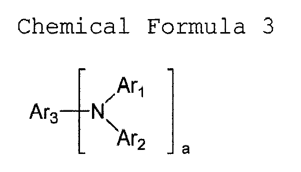 wherein, Ar₁ and Ar₂ independently represent (C1-C60)alkyl, (C6-C60)aryl, (C4-C60)heteroaryl, (C6-C60)arylamino, (C1-C60)alkylamino, a 5- or 6-membered heterocycloalkyl containing one or more heteroatom(s) selected from N, O and S, or (C3-C60)cycloalkyl, or Ar₁ and Ar₂ may be linked via (C3-C60)alkylene or (C3-C60)alkenylene with or without a fused ring to form an alicyclic ring, or a monocyclic or polycyclic aromatic ring;
when a is 1, Ar₃ represents (C6-C60)aryl, (C4-C60)heteroaryl, or an aryl represented by one of the following structural formulas: 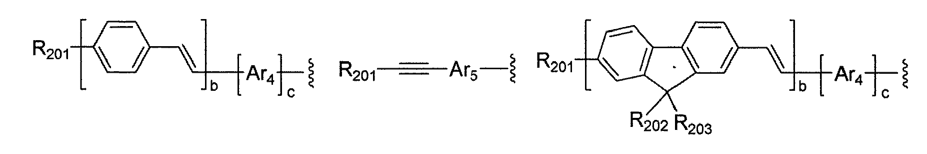 when a is 2, Ar₃ represents (C6-C60)arylene, (C4-C60)heteroarylene, or an arylene represented by one of the following structural formulas: 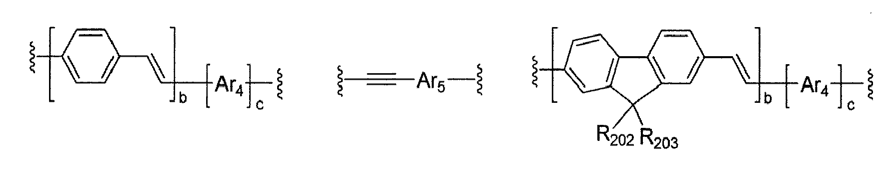 wherein Ar₄ and Ar₅ independently represent (C6-C60)arylene or (C4-C60)heteroarylene;
R₂₀₁, R₂₀₂ and R₂₀₃ independently represent hydrogen, (C1-C60)alkyl or (C6-C60)aryl;
b is an integer from 1 to 4, c is an integer of 0 or 1; and
the alkyl, aryl, heteroaryl, arylamino, alkylamino, cycloalkyl or heterocycloalkyl of Ar₁ and Ar₂, or the aryl, heteroaryl, arylene or heteroarylene of Ar₃, or the arylene or heteroarylene of Ar₄ and Ar₅, or the alkyl or aryl of R₂₀₁ through R₂₀₃ may be further substituted by one or more substituent(s) selected from a group consisting of halogen, (C1-C60)alkyl, (C6-C60)aryl, (C4-C60)heteroaryl, a 5- or 6-membered heterocycloalkyl containing one or more heteroatom(s) selected from N, O and S, (C3-C60)cycloalkyl, tri(C1-C60)alkylsilyl, di(C1-C60)alkyl(C6-C60)arylsilyl, tri(C6-C60)arylsilyl, adamantyl, (C7-C60)bicycloalkyl, (C2-C60)alkenyl, (C2-C60)alkynyl, cyano, (C1-C60)alkylamino, (C6-C60)arylamino, (C6-C60)ar(C1-C60)alkyl, (C6-C60)aryloxy, (C1-C60)alkyloxy, (C6-C60)arylthio, (C1-C60)alkylthio, (C1-C60)alkoxycarbonyl, (C1-C60)alkylcarbonyl, (C6-C60)arylcarbonyl, carboxyl, nitro and hydroxyl.

The arylamine compounds and styrylarylamine compounds may be more specifically exemplified by the following compounds, but are not restricted thereto.

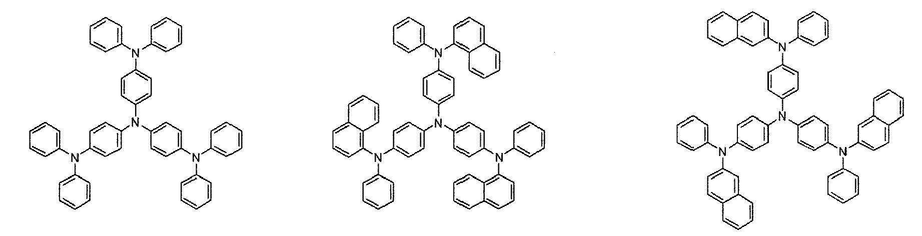

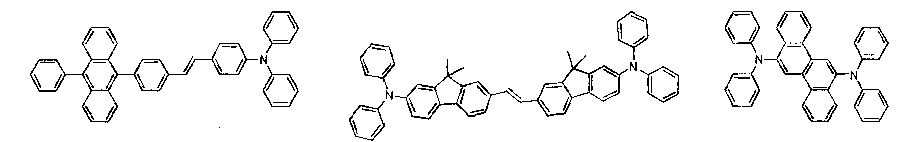

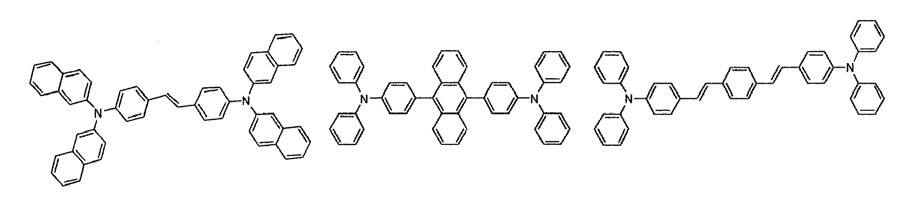

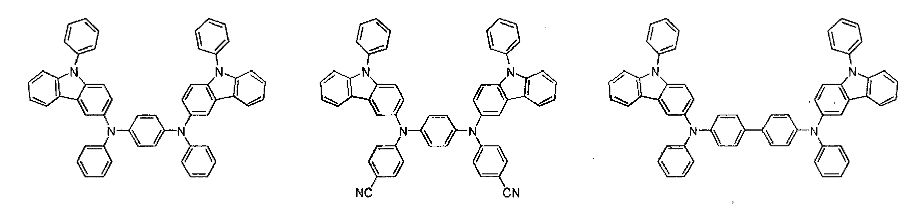

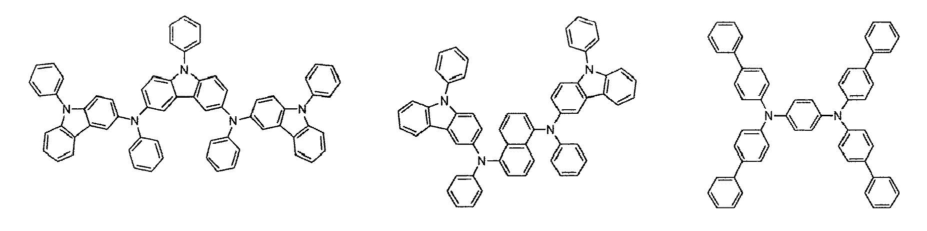

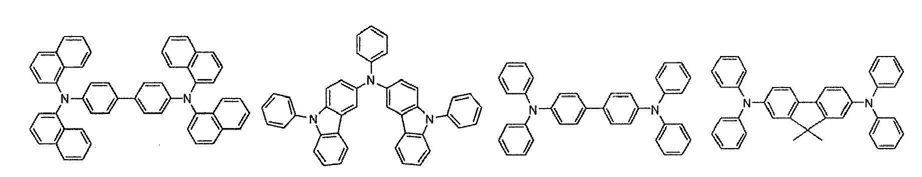

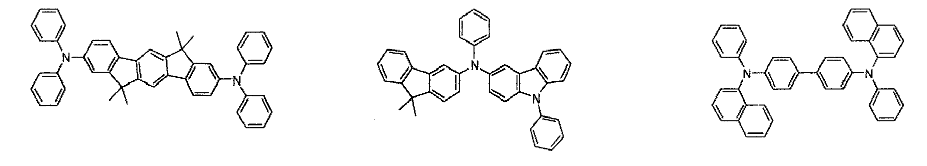

In an organic electroluminescent device according to the present invention, the organic layer may further comprise one or more metal(s) selected from a group consisting of organic metals of Group 1, Group 2, 4^{th} period and 5^{th} period transition metals, lanthanide metals and d-transition elements, as well as the electroluminescent compound represented by Chemical Formula (1). The organic layer may comprise a charge generating layer in addition to the electroluminescent layer.

The present invention can realize an electroluminescent device having a pixel structure of independent light-emitting mode, which comprises an electroluminescent device containing the compound of Chemical Formula (1) as a sub-pixel, and one or more sub-pixel(s) comprising one or more compound(s) selected from a group consisting of arylamine compounds and styrylarylamine compounds, patterned in parallel at the same time.

Further, the electroluminescent device is an organic display which comprises one or more compound(s) selected from compounds having electroluminescent peak of wavelength of blue or green, at the same time. The compounds having electroluminescent peak of wavelength of blue or green may be exemplified by the compounds represented by one of Chemical Formulas (4) to (8), but they are not restricted thereto.

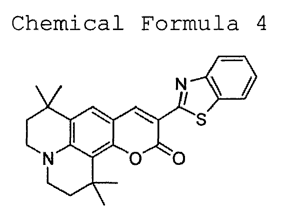

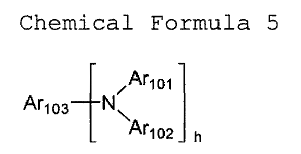

In Chemical Formula (5), Ar₁₁ and Ar₁₂ independently represent (C1-C60)alkyl, (C6-C60)aryl, (C4-C60)heteroaryl, (C6-C60)arylamino, (C1-C60)alkylamino, a 5- or 6-membered heterocycloalkyl containing one or more heteroatom(s) selected from N, O and S, or (C3-C60)cycloalkyl, or Ar₁₁ and Ar₁₂ may be linked via (C3-C60)alkylene or (C3-C60)alkenylene with or without a fused ring to form an alicyclic ring, or a monocyclic or polycyclic aromatic ring;
when d is 1, Ar₁₃ represents (C6-C60)aryl, (C4-C60)heteroaryl, or a substituent represented by one of the following structural formulas: 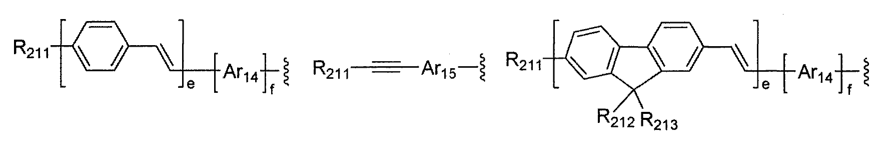 when d is 2, Ar₁₃ represents (C6-C60)arylene, (C4-C60)heteroarylene, or a substituent represented by one of the following structural formulas: 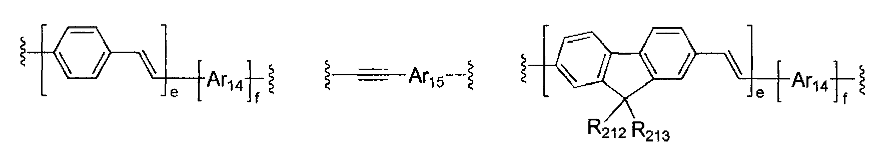 wherein Ar₁₄ and Ar₁₅ independently represent (C6-C60)arylene or (C4-C60)heteroarylene;
R₂₁₁, R₂₁₂ and R₂₁₃ independently represent hydrogen, (C1-C60)alkyl or (C6-C60)aryl;
e is an integer from 1 to 4, f is an integer of 0 or 1; and
the alkyl, aryl, heteroaryl, arylamino, alkylamino, cycloalkyl or heterocycloalkyl of Ar₁₁ and Ar₁₂, or the aryl, heteroaryl, arylene or heteroarylene of Ar₁₃, or the arylene or heteroarylene of Ar₁₄ and Ar₁₅, or the alkyl or aryl of R₂₁₁ through R₂₁₃ may be further substituted by one or more substituent(s) selected from a group consisting of halogen, (C1-C60)alkyl, (C6-C60)aryl, (C4-C60)heteroaryl, a 5- or 6-membered heterocycloalkyl containing one or more heteroatom(s) selected from N, O and S, (C3-C60)cycloalkyl, tri(C1-C60)alkylsilyl, di(C1-C60)alkyl(C6-C60)arylsilyl, tri(C6-C60)arylsilyl, adamantyl, (C7-C60)bicycloalkyl, (C2-C60)alkenyl, (C2-C60)alkynyl, cyano, (C1-C60)alkylamino, (C6-C60)arylamino, (C6-C60)ar(C1-C60)alkyl, (C6-C60)aryloxy, (C1-C60)alkyloxy, (C6-C60)arylthio, (C1-C60)alkylthio, (C1-C60)alkoxycarbonyl, (C1-C60)alkylcarbonyl, (C6-C60)arylcarbonyl, carboxyl, nitro and hydroxyl.

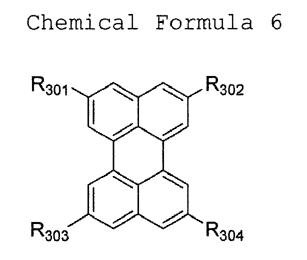

In Chemical Formula (6), R₃₀₁ through R₃₀₄ independently represent hydrogen, halogen, (C1-C60)alkyl, (C6-C60)aryl, (C4-C60)heteroaryl, a 5- or 6-membered heterocycloalkyl containing one or more heteroatom(s) selected from N, O and S, (C3-C60)cycloalkyl, tri(C1-C60)alkylsilyl, di(C1-C60)alkyl(C6-C60)arylsilyl, tri(C6-C60)arylsilyl, adamantyl, (C7-C60)bicycloalkyl, (C2-C60)alkenyl, (C2-C60)alkynyl, cyano, (C1-C60)alkylamino, (C6-C60)arylamino, (C6-C60)ar(C1-C60)alkyl, (C1-C60)alkyloxy, (C1-C60)alkylthio, (C6-C60)aryloxy, (C6-C60)arylthio, (C1-C60)alkoxycarbonyl, (C1-C60)alkylcarbonyl, (C6-C60)arylcarbonyl, carboxyl, nitro or hydroxyl, or each of R₃₀₁ through R₃₀₄ may be linked to an adjacent substituent via (C3-C60)alkylene or (C3-C60)alkenylene with or without a fused ring to form an alicyclic ring, or a monocyclic or polycyclic aromatic ring; the alkyl, alkenyl, alkynyl, cycloalkyl, heterocycloalkyl, aryl, heteroaryl, arylsilyl, alkylsilyl, alkylamino or arylamino of R₃₀₁ through R₃₀₄, or the alicyclic ring, or the monocyclic or polycyclic aromatic ring formed therefrom by linkage to an adjacent substituent via (C3-C60)alkylene or (C3-C60)alkenylene with or without a fused ring may be further substituted by one or more substituent(s) selected from halogen, (C1-C60)alkyl, (C6-C60)aryl, (C4-C60)heteroaryl, a 5- or 6-membered heterocycloalkyl containing one or more heteroatom(s) selected from N, O and S, (C3-C60)cycloalkyl, tri(C1-C60)alkylsilyl, di(C1-C60)alkyl(C6-C60)arylsilyl, tri(C6-C60)arylsilyl, adamantyl, (C7-C60)bicycloalkyl, (C2-C60)alkenyl, (C2-C60)alkynyl, cyano, (C1-C60)alkylamino, (C6-C60)arylamino, (C6-C60)ar(C1-C60)alkyl, (C1-C60)alkyloxy, (C1-C60)alkylthio, (C6-C60)aryloxy, (C6-C60)arylthio, (C1-C60)alkoxycarbonyl, (C1-C60)alkylcarbonyl, (C6-C60)arylcarbonyl, carboxyl, nitro and hydroxyl.

Chemical Formula 7 (Ar₂₁)_{g}-L₁₁-(Ar₂₂)ₕ

Chemical Formula 8 (Ar₂₃)ᵢ-L₁₂-(Ar₂₄)ⱼ

In Chemical Formulas (7) and (8),
L₁₁ represents (C6-C60)arylene or (C4-C60)heteroarylene;
L₁₂ represents anthracenylene;
Ar₂₁ through Ar₂₄ are independently selected from hydrogen, (C1-C60)alkyl, (C1-C60)alkoxy, halogen, (C4-C60)heteroaryl, (C5-C60)cycloalkyl and (C6-C60)aryl, and the cycloalkyl, aryl or heteroaryl of Ar₂₁ through Ar₂₄ may be further substituted by one or more substituent(s) selected from a group consisting of (C6-C60)aryl or (C4-C60)heteroaryl with or without at least one substituent(s) selected from a group consisting of (C1-C60)alkyl with or without halogen substituent(s), (C1-C60)alkoxy, (C3-C60)cycloalkyl, halogen, cyano, tri(C1-C60)alkylsilyl, di(C1-C60)alkyl(C6-C60)arylsilyl and tri(C6-C60)arylsilyl; (C1-C60)alkyl with or without halogen substituent(s), (C1-C60)alkoxy, (C3-C60)cycloalkyl, halogen, cyano, tri(C1-C60)alkylsilyl, di(C1-C60)alkyl(C6-C60)arylsilyl and tri(C6-C60)arylsilyl; and
g, h, i and j independently represent an integer from 0 to 4.

The compounds represented by Chemical Formula (7) or (8) may be exemplified by the anthracene derivatives or benz[a]anthracene derivatives represented by one of Chemical Formulas (9) through (11).

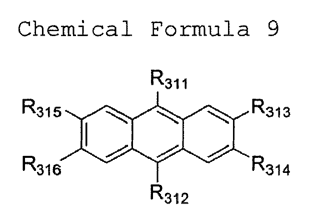

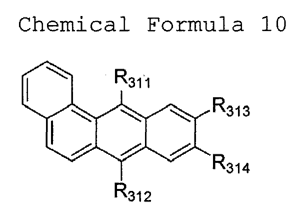

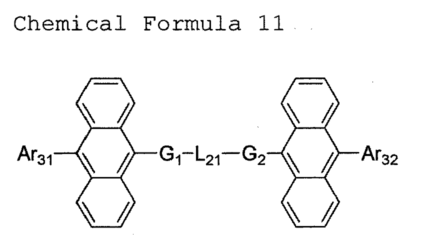

In Chemical Formulas (9) to (11), R₃₁₁ and R₃₁₂ independently represent (C6-C60)aryl, (C4-C60)heteroaryl, a 5- or 6-membered heterocycloalkyl containing one or more heteroatom(s) selected from N, O and S, or (C3-C60)cycloalkyl, and the aryl or heteroaryl of R₃₁₁ and R₃₁₂ may be further substituted by one or more substituent(s) selected from a group consisting of (C1-C60)alkyl, halo(C1-C60)alkyl, (C1-C60)alkoxy, (C3-C60)cycloalkyl, (C6-C60)aryl, (C4-C60)heteroaryl, halogen, cyano, tri(C1-C60)alkylsilyl, di(C1-C60)alkyl(C6-C60)arylsilyl and tri(C6-C60)arylsilyl;
R₃₁₃ through R₃₁₆ independently represent hydrogen, (C1-C60)alkyl, (C1-C60)alkoxy, halogen, (C4-C60)heteroaryl, (C5-C60)cycloalkyl or (C6-C60)aryl, and the heteroaryl, cycloalkyl or aryl of R₃₁₃ through R₃₁₆ may be further substituted by one or more substituent(s) selected from a group consisting of (C1-C60)alkyl with or without halogen substituent(s), (C1-C60)alkoxy, (C3-C60)cycloalkyl, halogen, cyano, tri(C1-C60)alkylsilyl, di(C1-C60)alkyl(C6-C60)arylsilyl and tri(C6-C60)arylsilyl;
G₁ and G₂ independently represent a chemical bond or (C6-C60)arylene with or without one or more substituent(s) selected from (C1-C60)alkyl, (C1-C60)alkoxy, (C6-C60)aryl, (C4-C60)heteroaryl and halogen;
Ar₃₁ and Ar₃₂ represent an aryl selected from the following structures, or (C4-C60)heteroaryl: 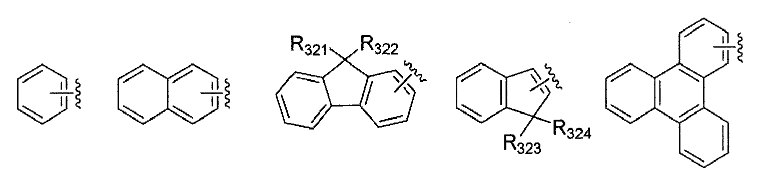 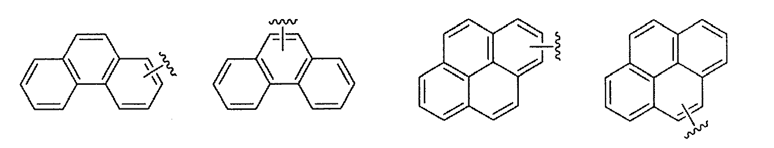 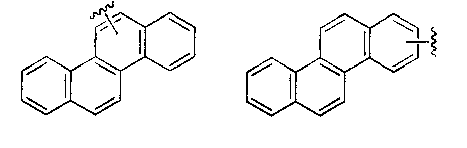 the aryl or heteroaryl of Ar₃₁ and Ar₃₂ may be substituted by one or more substituent(s) selected from (C1-C60)alkyl, (C1-C60)alkoxy, (C6-C60)aryl and (C4-C60)heteroaryl;
L₂₁ represents (C6-C60)arylene, (C4-C60)heteroarylene or a compound represented by the following structure: 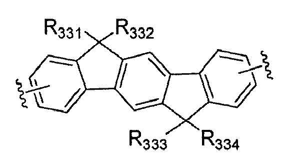 the arylene or heteroarylene of L₂₁ may be substituted by one or more substituent(s) selected from (C1-C60)alkyl, (C1-C60)alkoxy, (C6-C60)aryl, (C4-C60)heteroaryl and halogen;
R₃₂₁, R₃₂₂, R₃₂₃ and R₃₂₄ independently represent hydrogen, (C1-C60)alkyl or (C6-C60)aryl, or each of them may be linked to an adjacent substituent via (C3-C60)alkylene or (C3-C60)alkenylene with or without a fused ring to form an alicyclic ring, or a monocyclic or polycyclic aromatic ring;
R₃₃₁, R₃₃₂, R₃₃₃ and R₃₃₄ independently represent hydrogen, (C1-C60)alkyl, (C1-C60)alkoxy, (C6-C60)aryl, (C4-C60)heteroaryl or halogen, or each of them may be linked to an adjacent substituent via (C3-C60)alkylene or (C3-C60)alkenylene with or without a fused ring to form an alicyclic ring, or a monocyclic or polycyclic aromatic ring. 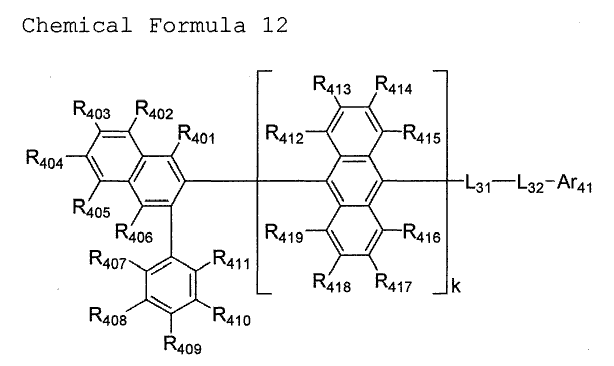 In Chemical Formula 12,
L₃₁ and L₃₂ independently represent a chemical bond, (C6-C60)arylene or (C3-C60)heteroarylene, and the arylene or heteroarylene of L₃₁ and L₃₂ may be further substituted by one or more substituent(s) selected from (C1-C60)alkyk halogen, cyano, (C1-C60)alkoxy, (C3-C60)cycloalkyl, (C6-C60)aryl, (C3-C60)heteroaryl, tri(C1-C30)alkylsilyl, di(C1-C30)alkyl(C6-C30)arylsilyl and tri(C6-C30)arylsilyl;
R₄₀₁ through R₄₁₉ independently represent hydrogen, halogen, (C1-C60)alkyl, (C6-C60)aryl, (C4-C60)heteroaryl, a 5- or 6-membered heterocycloalkyl containing one or more heteroatom(s) selected from N, O and S, (C3-C60)cycloalkyl, tri(C1-C60)alkylsilyl, di(C1-C60)alkyl(C6-C60)arylsilyl, tri(C6-C60)arylsilyl, adamantyl, (C7-C60)bicycloalkyl, (C2-C60)alkenyl, (C2-C60)alkynyl, (C1-C60)alkoxy, cyano, (C1-C60)alkylamino, (C6-C60)arylamino, (C6-C60)ar(C1-C60)alkyl, (C6-C60)aryloxy, (C6-C60)arylthio, (C1-C60)alkoxycarbonyl, carboxyl, nitro or hydroxyl, or each of R₄₀₁ through R₄₁₉ may be linked to an adjacent substituent via (C3-C60)alkylene or (C3-C60)alkenylene with or without a fused ring to form an alicyclic ring, or a monocyclic or polycyclic aromatic ring;
Ar₄₁ represents (C6-C60)aryl, (C4-C60)heteroaryl, a 5- or 6-membered heterocycloalkyl containing one or more heteroatom(s) selected from N, O and S, (C3-C60)cycloalkyl, adamantyl, (C7-C60)bicycloalkyl, or a substituent selected from the following structures: 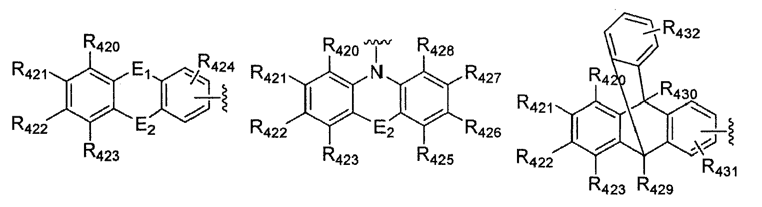 wherein, R₄₂₀ through R₄₃₂ independently represent hydrogen, halogen, (C1-C60)alkyl, (C6-C60)aryl, (C4-C60)heteroaryl, a 5- or 6-membered heterocycloalkyl containing one or more heteroatom(s) selected from N, O and S, (C3-C60)cycloalkyl, tri(C1-C60)alkylsilyl, di(C1-C60)alkyl(C6-C60)arylsilyl, tri(C6-C60)arylsilyl, adamantyl, (C7-C60)bicycloalkyl, (C2-C60)alkenyl, (C2-C60)alkynyl, (C1-C60)alkoxy, cyano, (C1-C60)alkylamino, (C6-C60)arylamino, (C6-C60)ar(C1-C60)alkyl, (C6-C60)aryloxy, (C6-C60)arylthio, (C1-C60)alkoxycarbonyl, carboxyl, nitro or hydroxyl;
E₁ and E₂ independently represent a chemical bond, - (CR₄₃₃R₄₃₄)ₘ-, -N(R₄₃₅)-, -S-, -O-, -Si(_{R436}) (R₄₃₇)-, -P(R₄₃₈)-, - C(=O)-, -B(R₄₃₉)-, -In(R₄₄₀)-, -Se-, -Ge(R₄₄₁₎ (R₄₄₂)-, - Sn(R₄₄₃) (R₄₄₄)-, -Ga(_{R445})- or -C(R₄₄₆)=C(R₄₄₇)-;
R₄₃₃ through R₄₄₇ independently represent hydrogen, halogen, (C1-C60)alkyl, (C6-C60)aryl, (C4-C60)heteroaryl, a 5- or 6-membered heterocycloalkyl containing one or more heteroatom(s) selected from N, O and S, (C3-C60)cycloalkyl, tri(C1-C60)alkylsilyl, di(C1-C60)alkyl(C6-C60)arylsilyl, tri(C6-C60)arylsilyl, adamantyl, (C7-C60)bicycloalkyl, (C2-C60)alkenyl, (C2-C60)alkynyl, (C1-C60)alkoxy, cyano, (C1-C60)alkylamino, (C6-C60)arylamino, (C6-C60)ar(C1-C60)alkyl, (C6-C60)aryloxy, (C6-C60)arylthio, (C1-C60)alkoxycarbonyl, carboxyl, nitro or hydroxyl, or each of R₄₃₃ through R₄₄₇ may be linked to an adjacent substituent via (C3-C60)alkylene or (C3-C60)alkenylene with or without a fused ring to form an alicyclic ring, or a monocyclic or polycyclic aromatic ring;
the aryl, heteroaryl, heterocycloalkyl, adamantyl or bicycloalkyl of Ar₄₁, or the alkyl, alkenyl, alkynyl, cycloalkyl, heterocycloalkyl, aryl, heteroaryl, arylsilyl, alkylsilyl, alkylamino or arylamino of R₄₀₁ through R₄₃₂ may be further substituted by one or more substituent(s) selected from halogen, (C1-C60)alkyl, (C6-C60)aryl, (C4-C60)heteroaryl, a 5- or 6-membered heterocycloalkyl containing one or more heteroatom(s) selected from N, O and S, (C3-C60)cycloalkyl, tri(C1-C60)alkylsilyl, di(C1-C60)alkyl(C6-C60)arylsilyl, tri(C6-C60)arylsilyl, adamantyl, (C7-C60)bicycloalkyl, (C2-C60)alkenyl, (C2-C60)alkynyl, (C1-C60)alkoxy, cyano, (C1-C60)alkylamino, (C6-C60)arylamino, (C6-C60)ar(C1-C60)alkyl, (C6-C60)aryloxy, (C6-C60)arylthio, (C1-C60)alkoxycarbonyl, carboxyl, nitro and hydroxyl;
k is an integer from 1 to 4; and
m is an integer from 0 to 4.
The organic compounds and organometallic compounds with green or blue electroluminescence can be more specifically exemplified by the following compounds, but they are not restricted thereto.

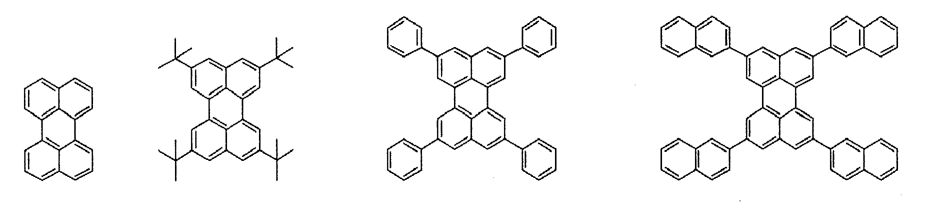

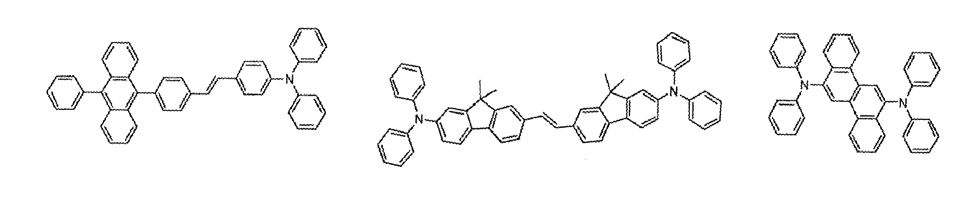

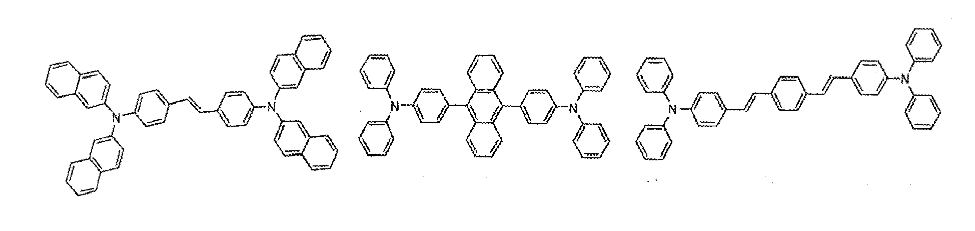

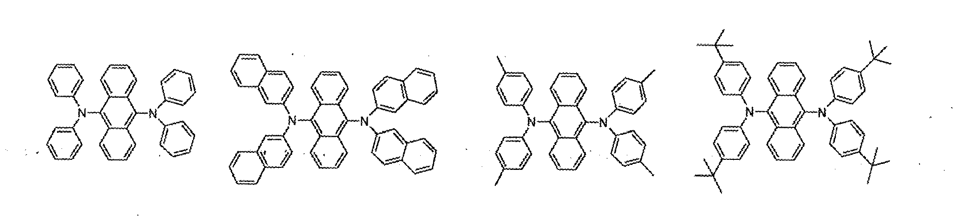

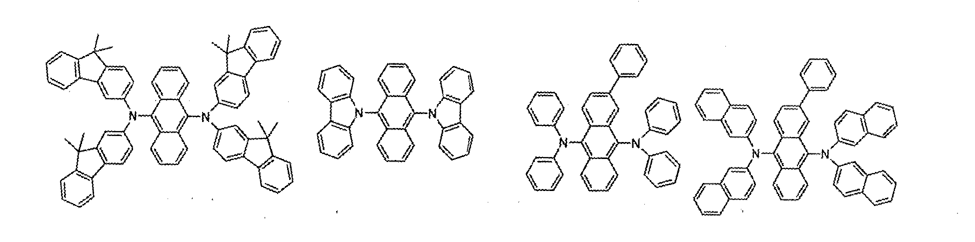

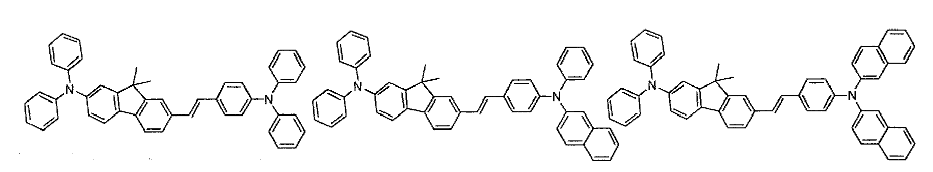

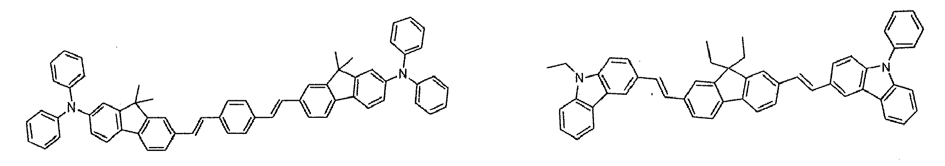

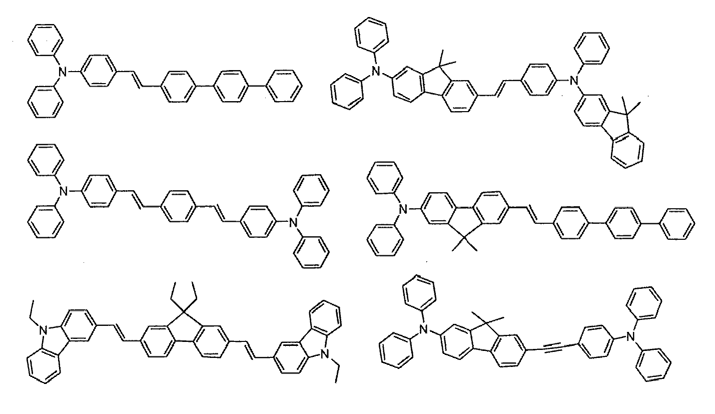

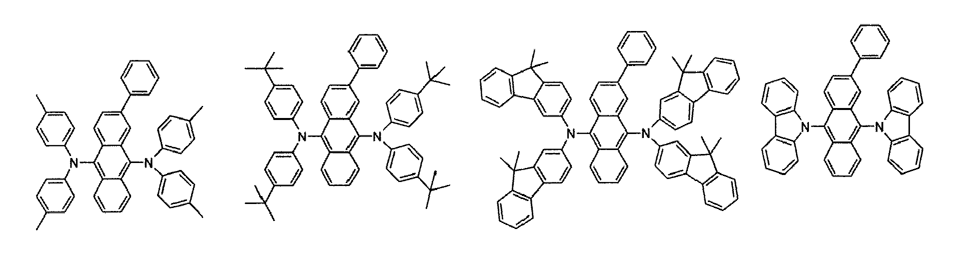

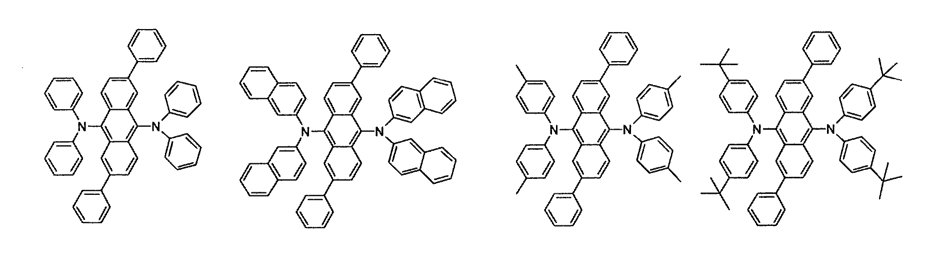

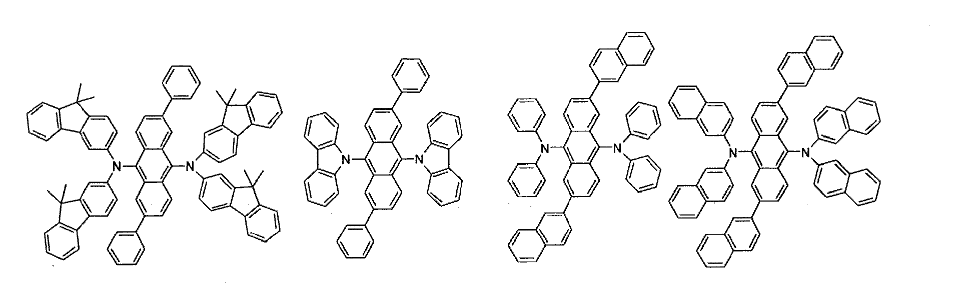

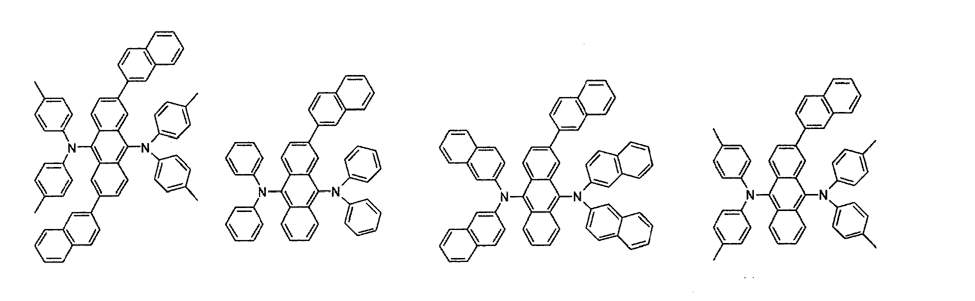

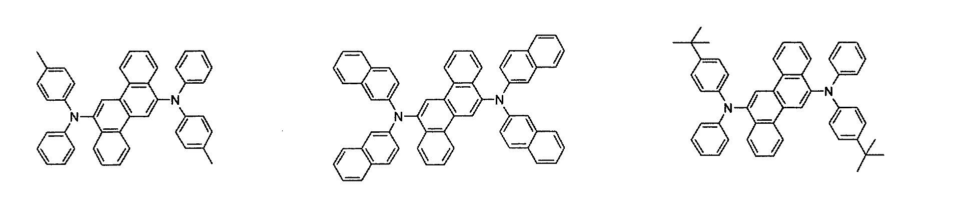

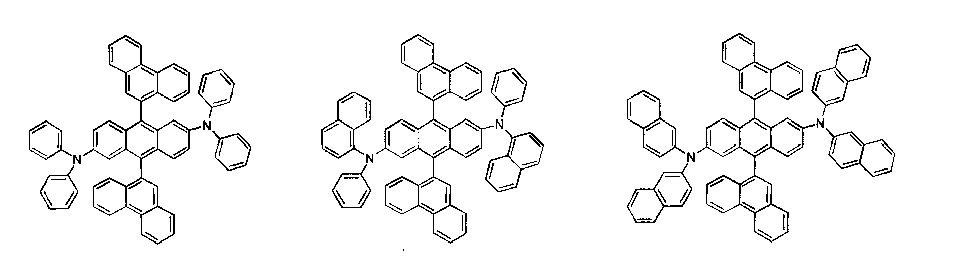

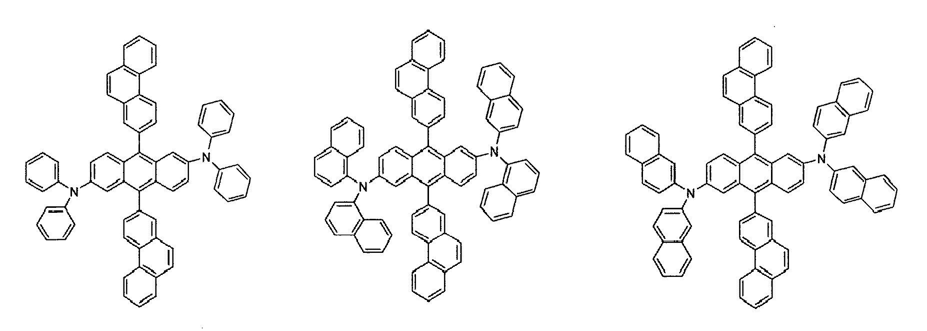

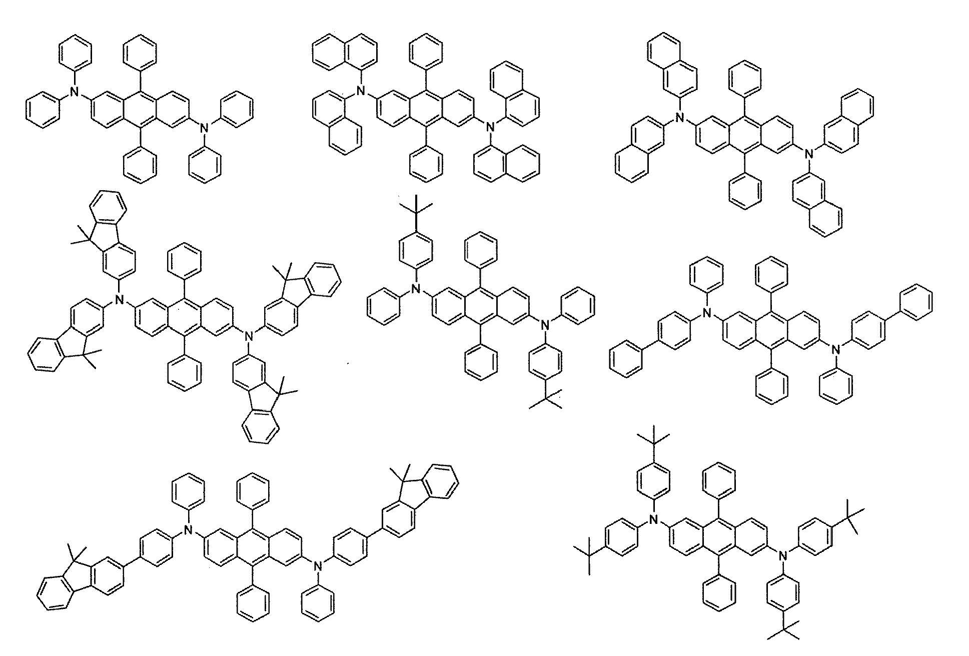

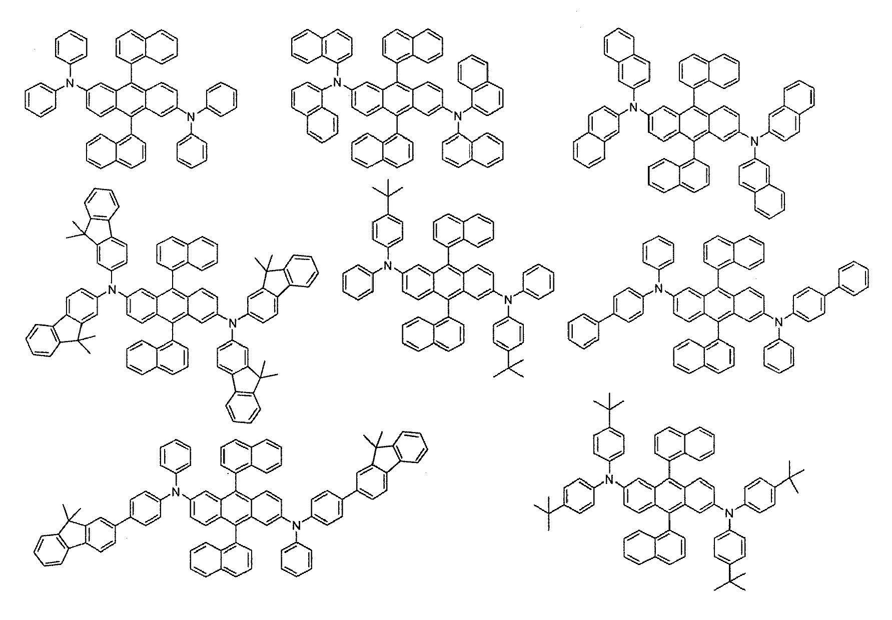

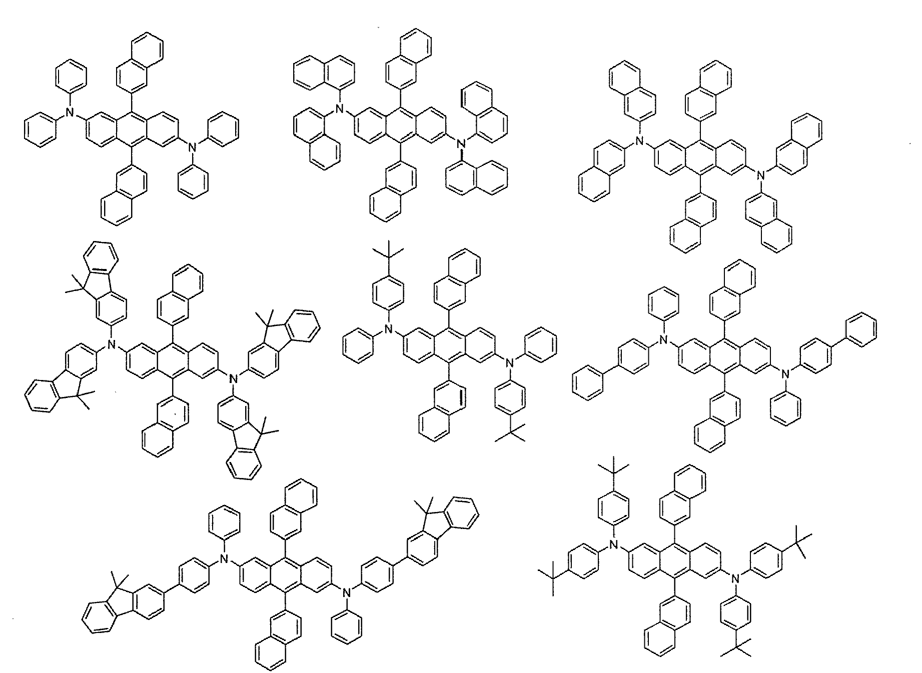

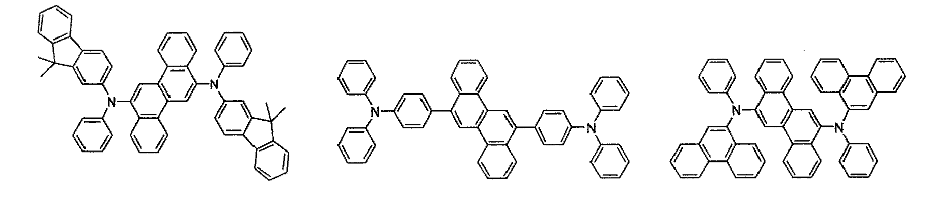

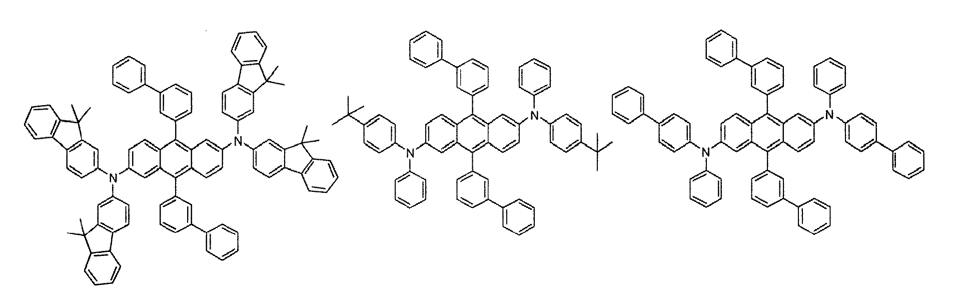

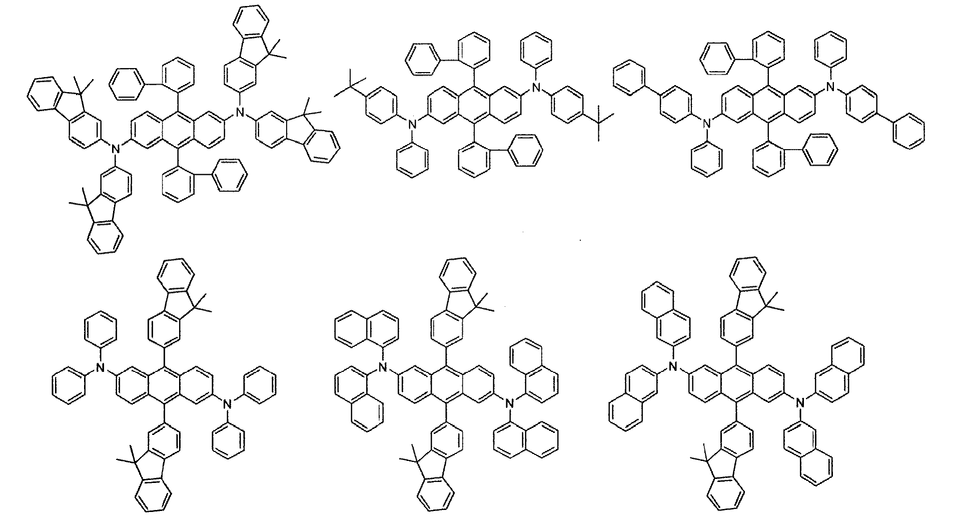

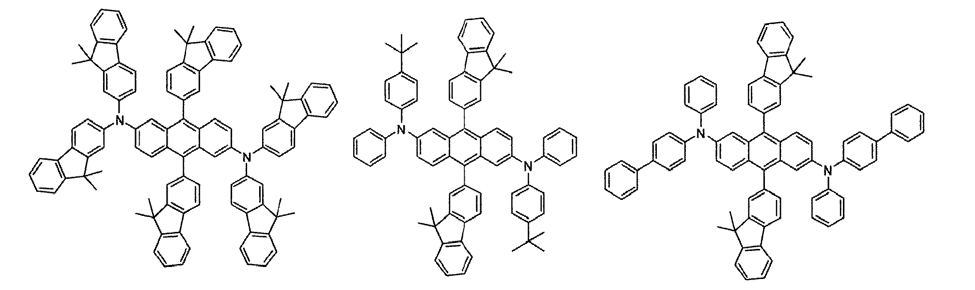

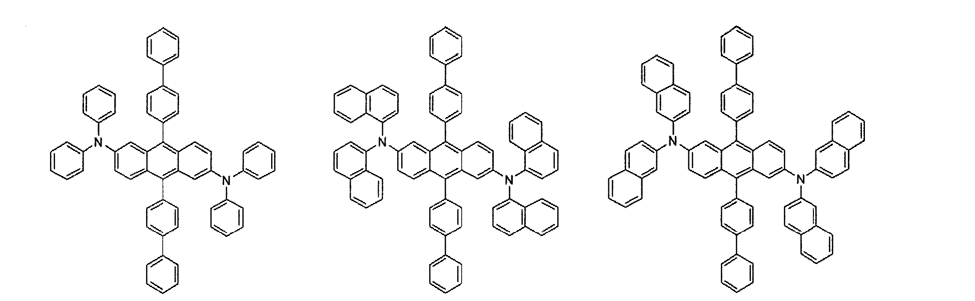

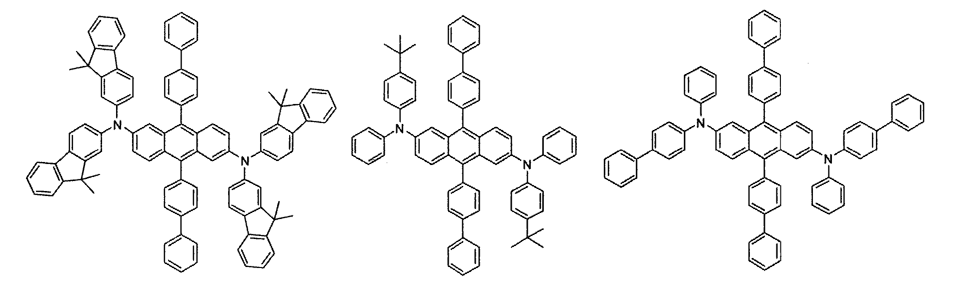

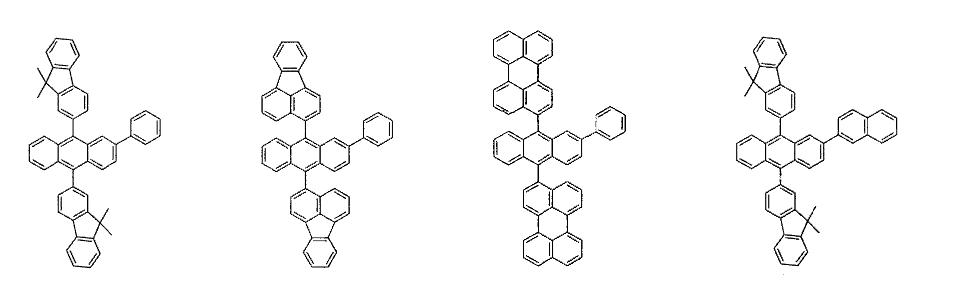

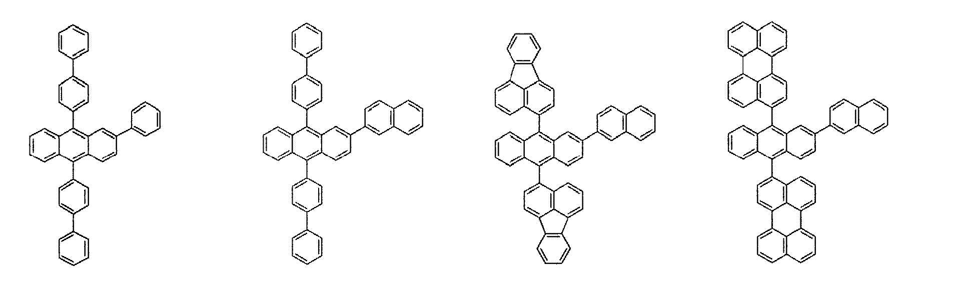

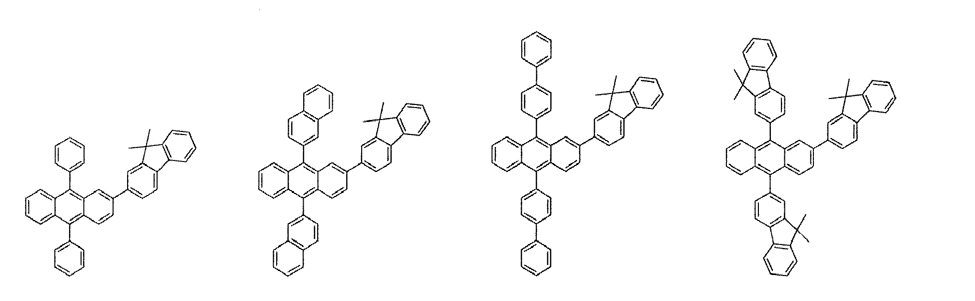

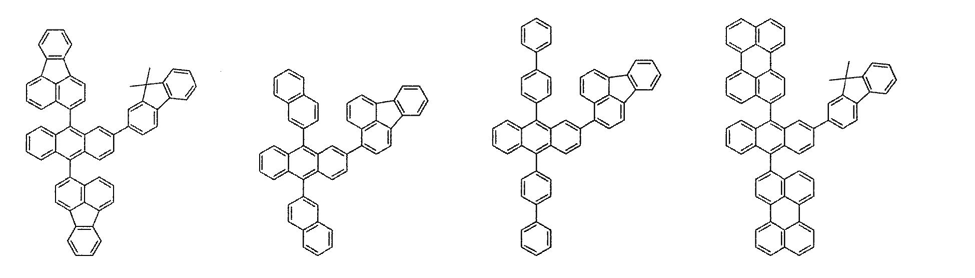

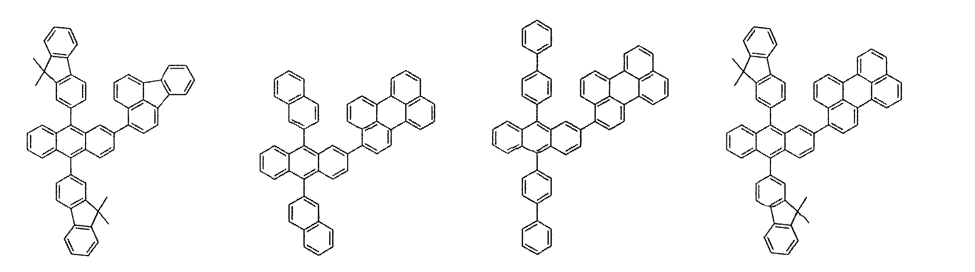

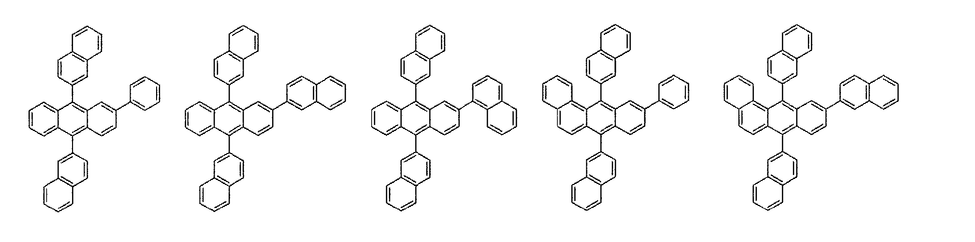

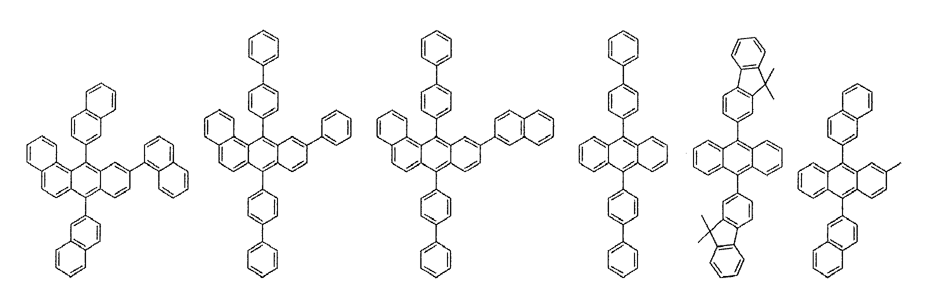

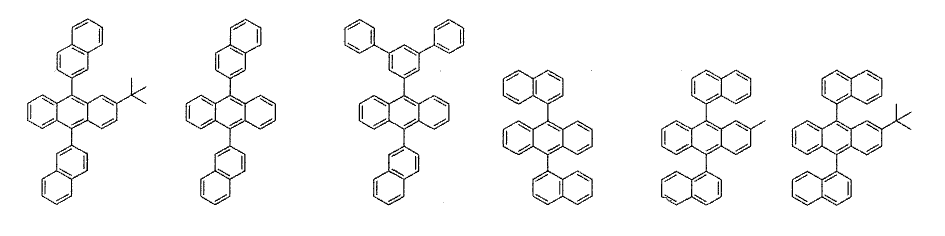

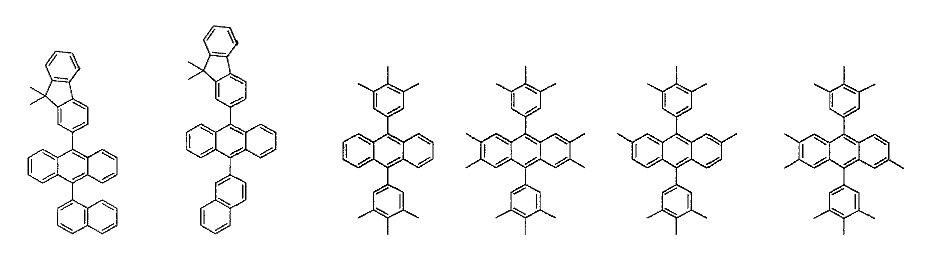

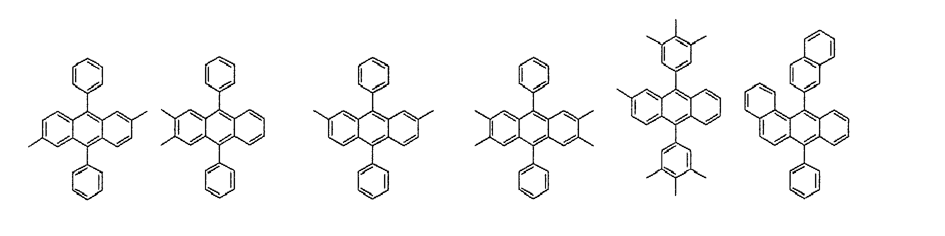

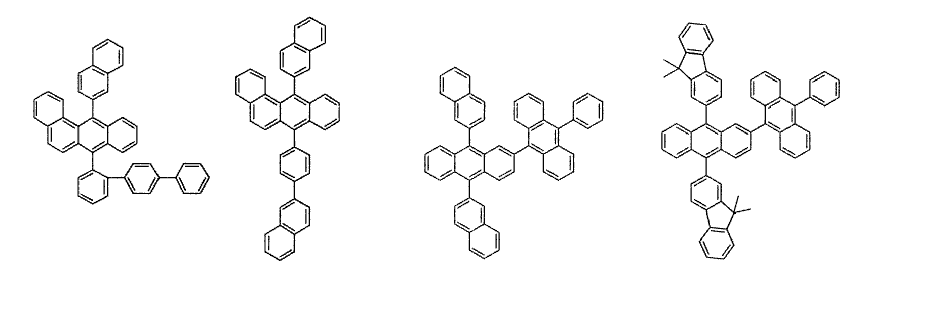

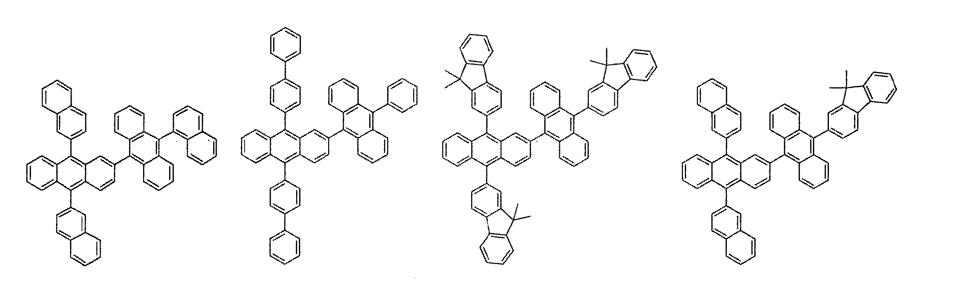

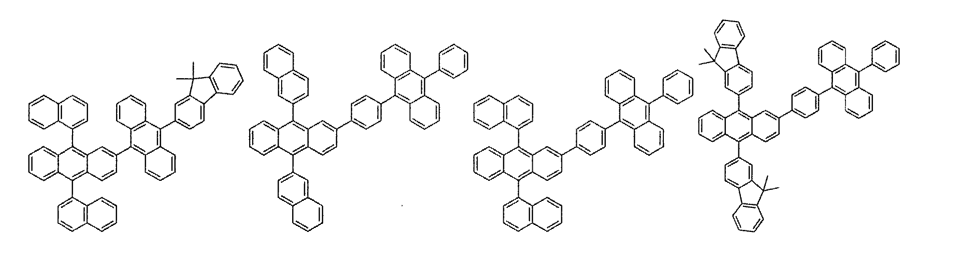

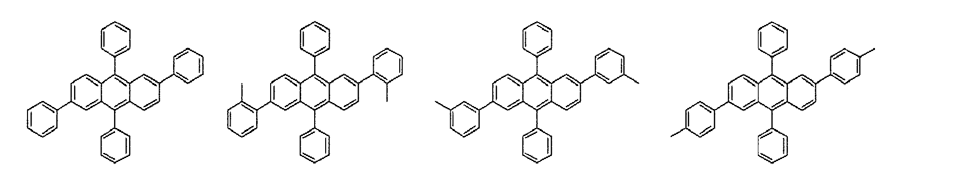

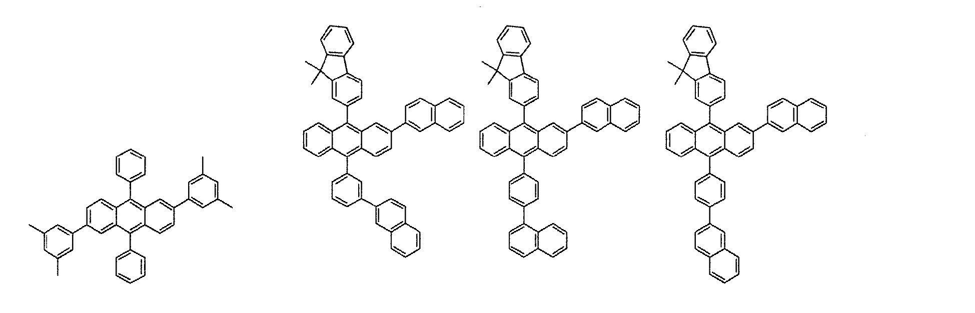

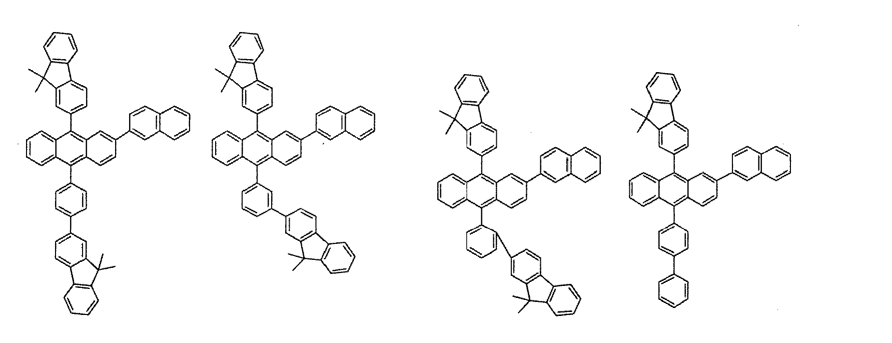

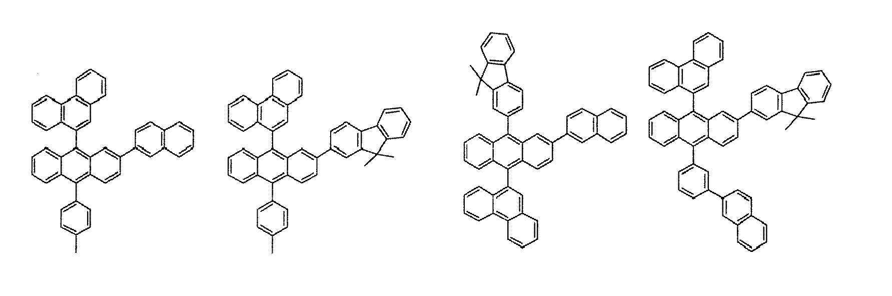

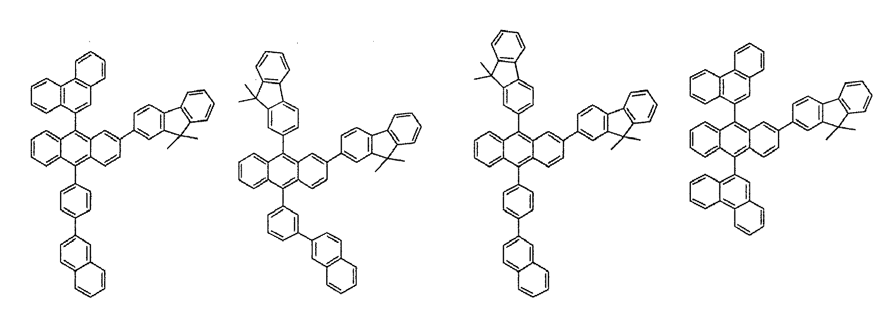

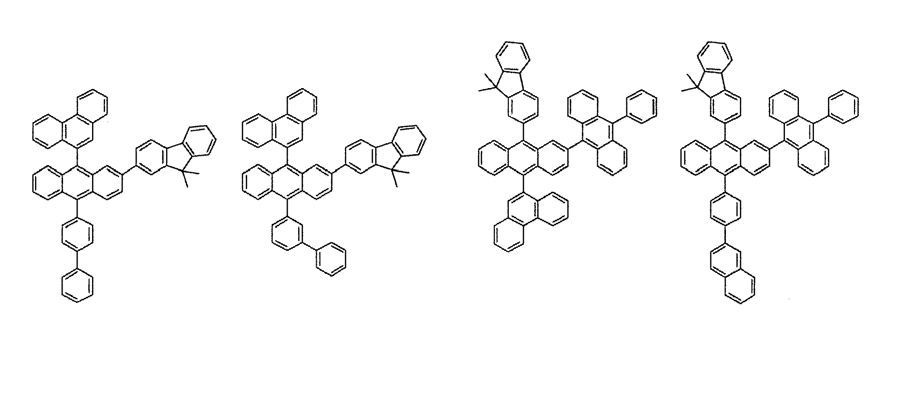

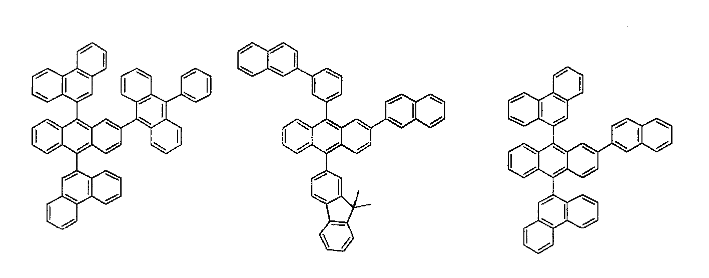

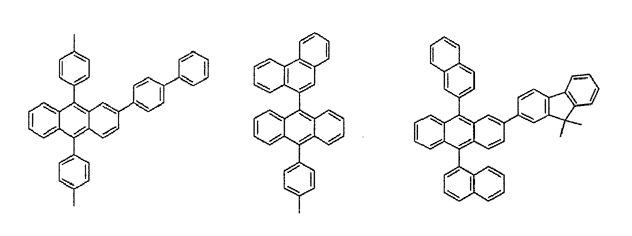

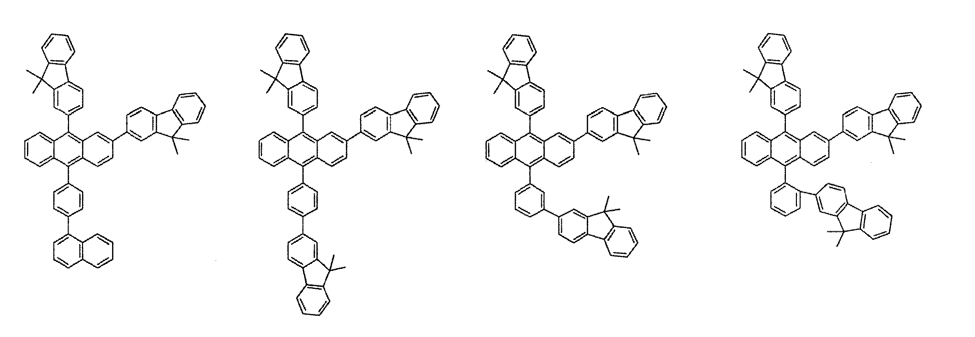

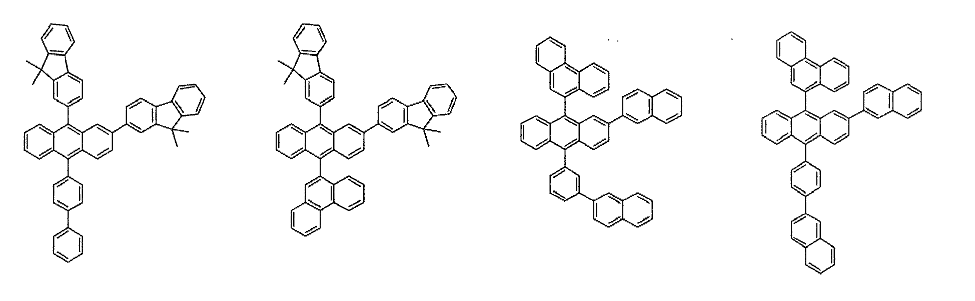

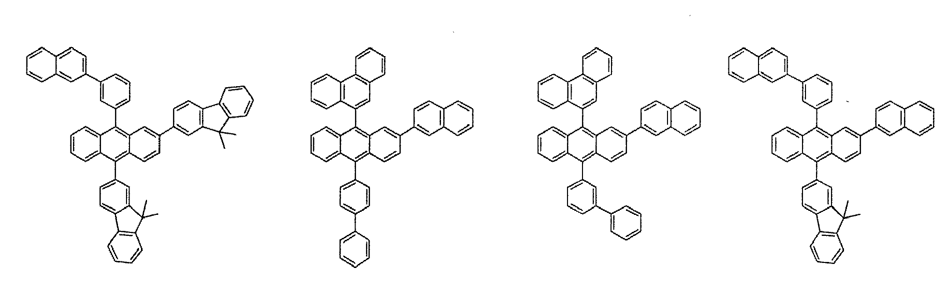

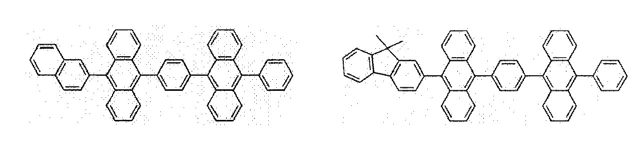

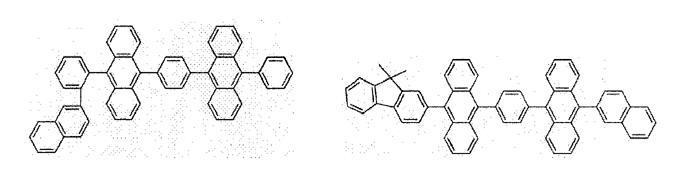

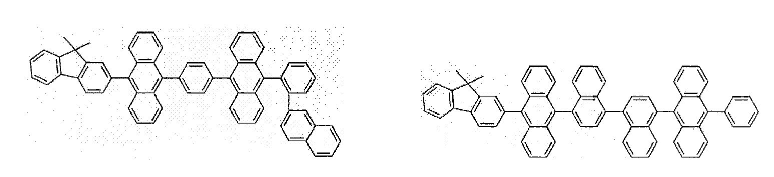

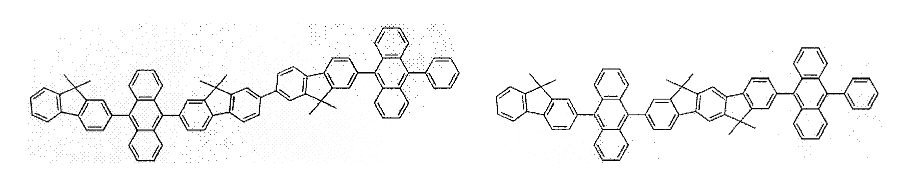

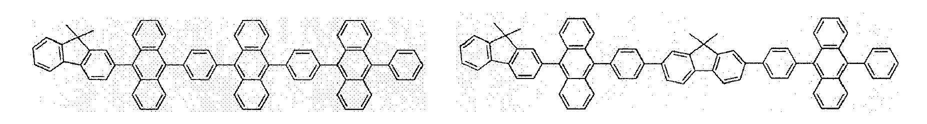

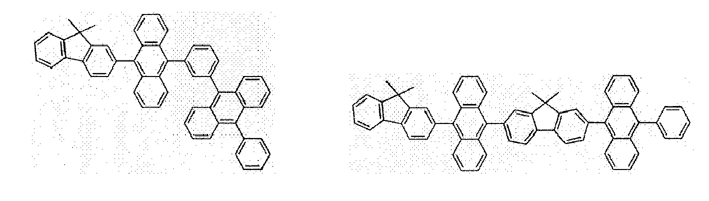

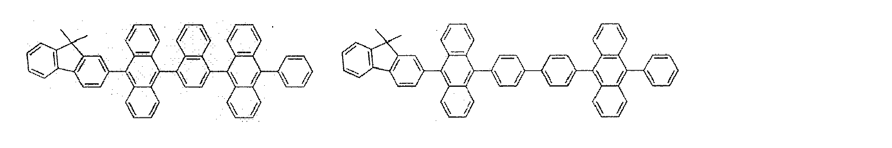

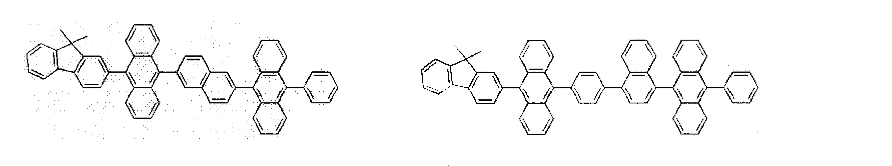

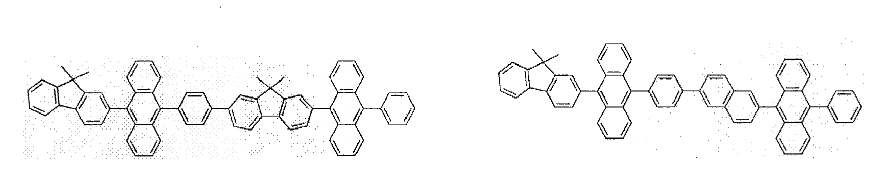

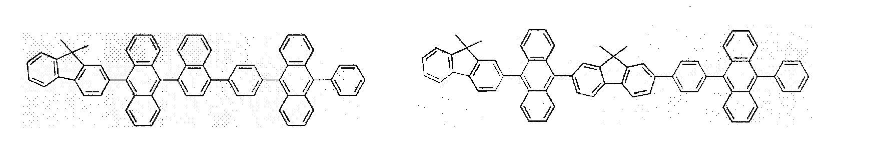

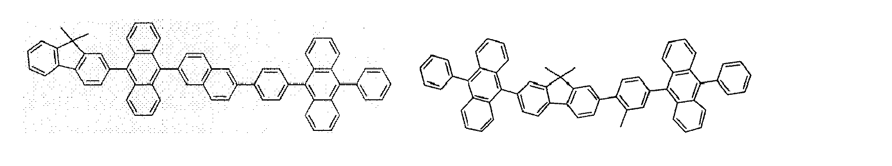

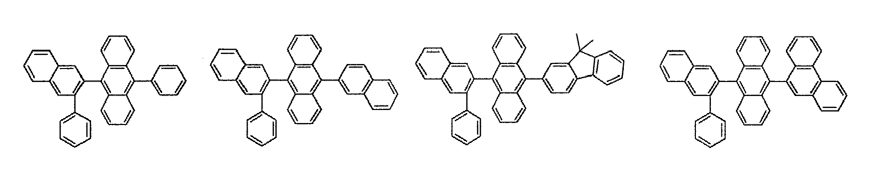

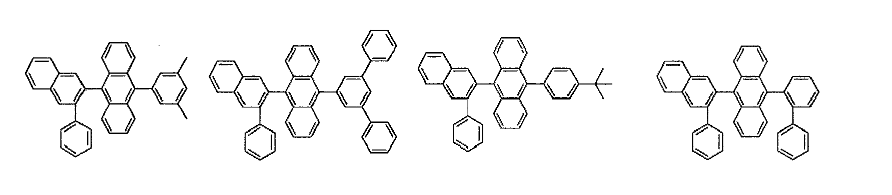

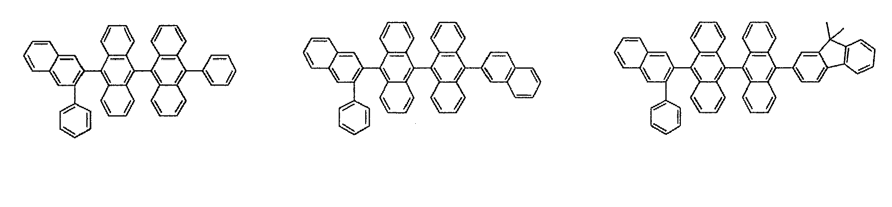

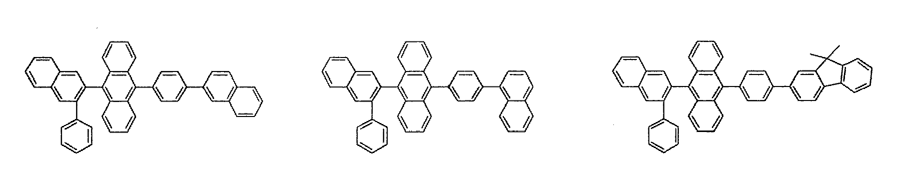

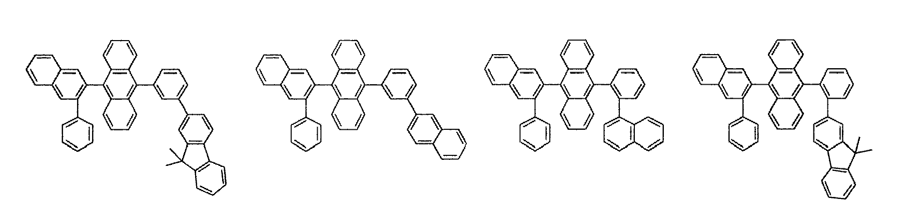

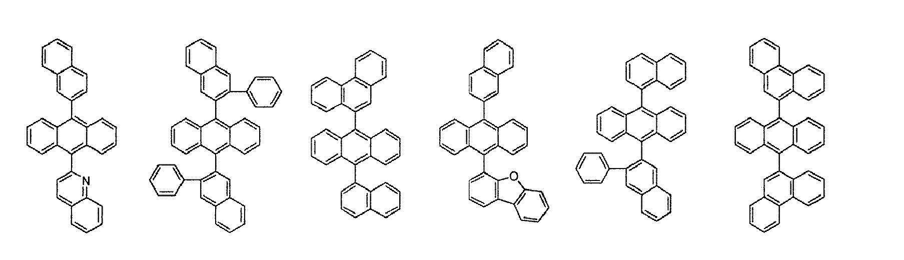

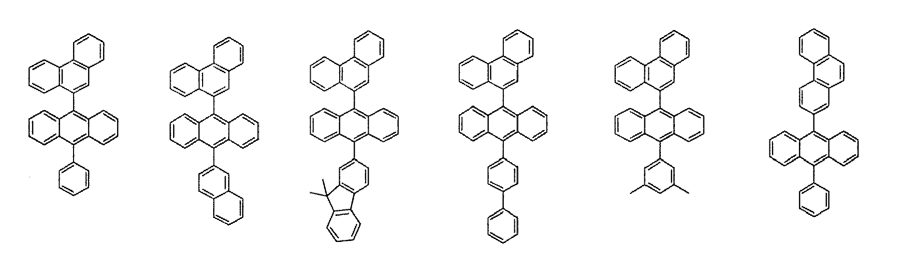

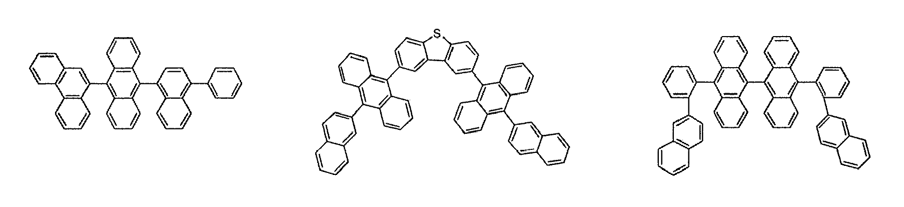

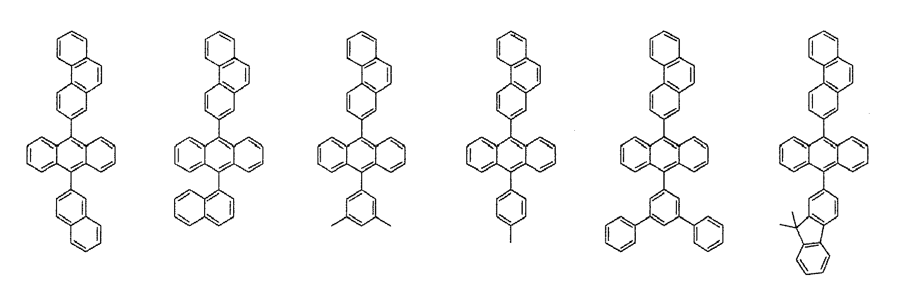

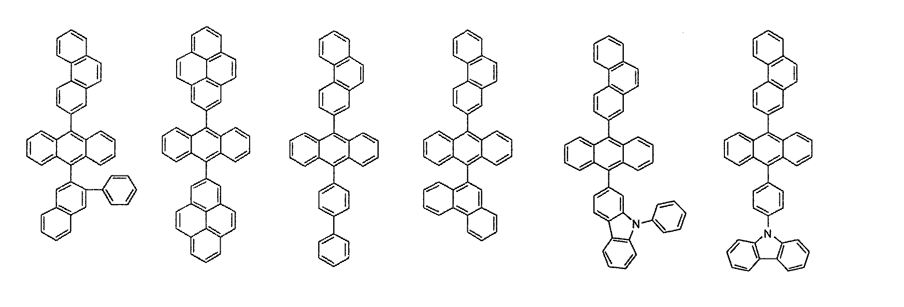

In an organic electroluminescent device according to the present invention, it is preferable to displace one or more layer(s) (here-in-below, referred to as the "surface layer") selected from chalcogenide layers, metal halide layers and metal oxide layers, on the inner surface of at least one side of the pair of electrodes. Specifically, it is preferable to arrange a chalcogenide layer of silicon and aluminum metal (including oxides) on the anode surface of the EL medium layer, and a metal halide layer or a metal oxide layer on the cathode surface of the EL medium layer. As the result, stability in operation can be obtained.

Examples of chalcogenides preferably include SiOₓ (1≤X≤2), AlOₓ (1≤X≤1.5), SiON, SiAlON, or the like. Examples of metal halides preferably include LiF, MgF₂, CaF₂, fluorides of rare earth metals or the like. Examples of metal oxides preferably include Cs₂O, Li₂O, MgO, SrO, BaO, CaO, or the like.

In an organic electroluminescent device according to the present invention, it is also preferable to arrange, on at least one surface of the pair of electrodes thus manufactured, a mixed region of electron transport compound and a reductive dopant, or a mixed region of a hole transport compound with an oxidative dopant. Accordingly, the electron transport compound is reduced to an anion, so that injection and transportation of electrons from the mixed region to an EL medium are facilitated. In addition, since the hole transport compound is oxidized to form a cation, injection and transportation of holes from the mixed region to an EL medium are facilitated. Preferable oxidative dopants include various Lewis acids and acceptor compounds. Preferable reductive dopants include alkali metals, alkali metal compounds, alkaline earth metals, rare-earth metals, and mixtures thereof.

The electroluminescent compounds according to the invention, when used in OLED's as electroluminescent host material, provide higher luminous efficiency, better color purity, and lower operation voltage as compared to conventional host materials. Further, if the compound is applied to an organic solar cell as a material of high efficiency, more excellent properties are anticipated as compared to conventional materials.

### Best Mode

The present invention is further described with respect to the novel electroluminescent compounds according to the invention, the processes for preparing the same, and electroluminescent properties of devices manufactured therefrom by referring to Preparation Examples and Examples, which are provided for illustration of the invention only but are not intended to limit the scope of the invention by any means.

### Preparation Example 1 Preparation of Compound (9)

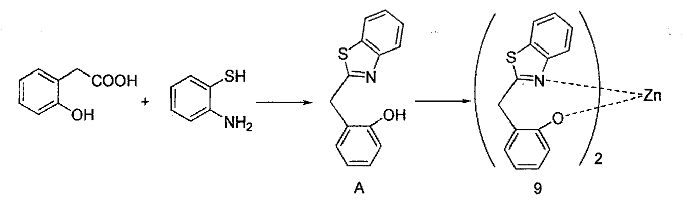

### Preparation of Compound (A)

In PPA (polyphosphoric acid) (12 mL), dissolved were 2-aminobenzenethiol (3.8 g, 30.2 mmol) and 2-hydroxyphenylacetic acid (3.8 g, 25.2 mmol), and the solution was stirred at 100°C under pressure for 12 hours. When the reaction was completed, the reaction mixture was cooled to room temperature, and extract with dichloromethane (100 mL) and water (100 mL). The extract was dried under reduced pressure, and the residue was purified via silica gel column chromatography (n-hexane:MC = 3:1) to obtain Compound (A) (3.5 g, 14.8 mmol).

### Preparation of Compound (9)

Compound A (3.5 g, 14.8 mmol) and sodium hydroxide (0.6 g, 14.8 mmol) were dissolved in ethanol (100 mL), and the solution was stirred for 30 minutes. To the solution, slowly added was Zn(CH₃COO)₂· 2H₂O (1.8 g; 8.2 mmol), and the resultant mixture was stirred at room temperature for 12 hours. When the reaction was completed, the reaction mixture was washed with water (200 mL), ethanol (200 mL) and hexane (200 mL), sequentially, and filtered under reduced pressure to obtain the target compound (9) (3.5 g, 6.7 mmol, 45%).

According to the same procedure as Preparation Example 1, Compounds 1 through 1950 listed in Table 1 were prepared, of which the ¹H NMR and MS/FAB data are listed in Table 2.

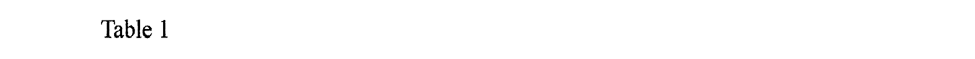

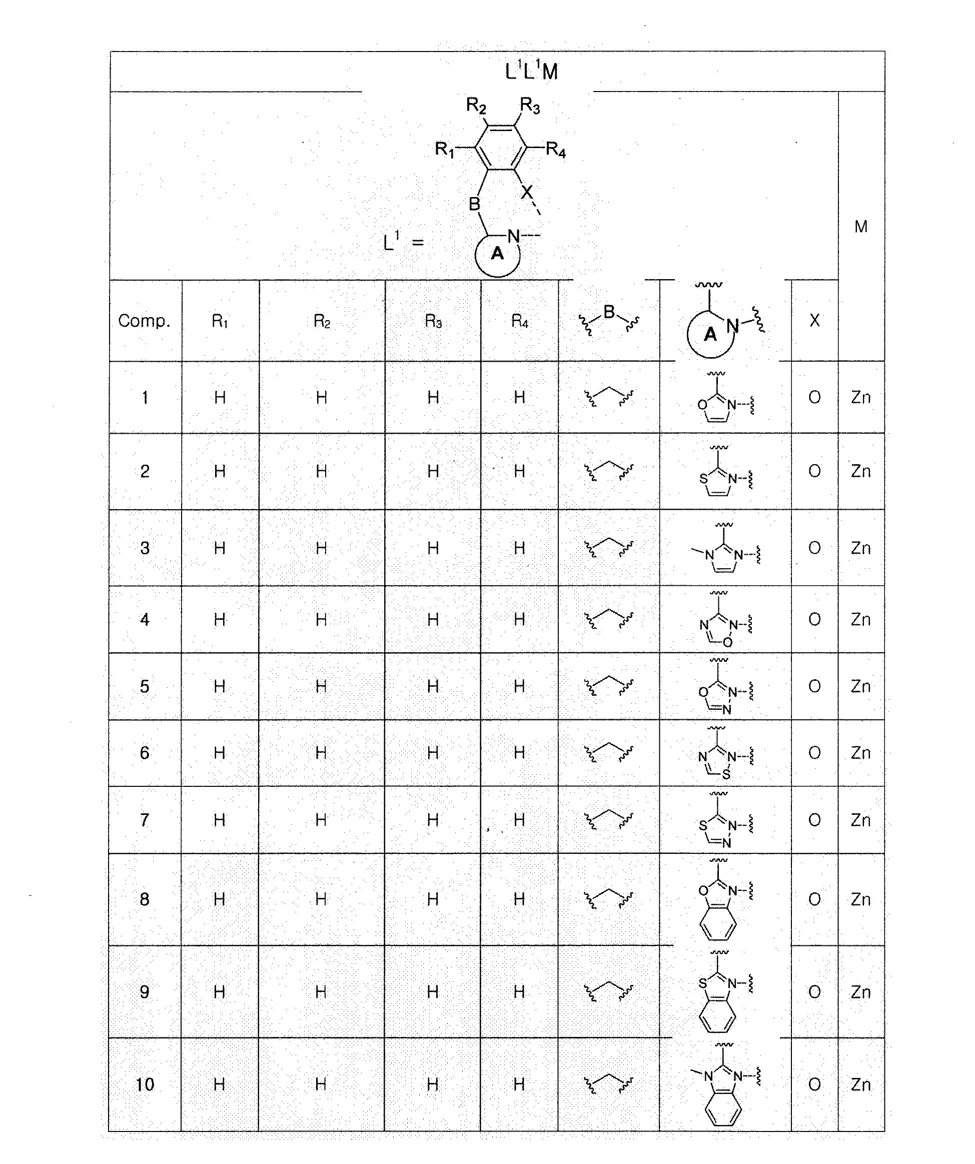

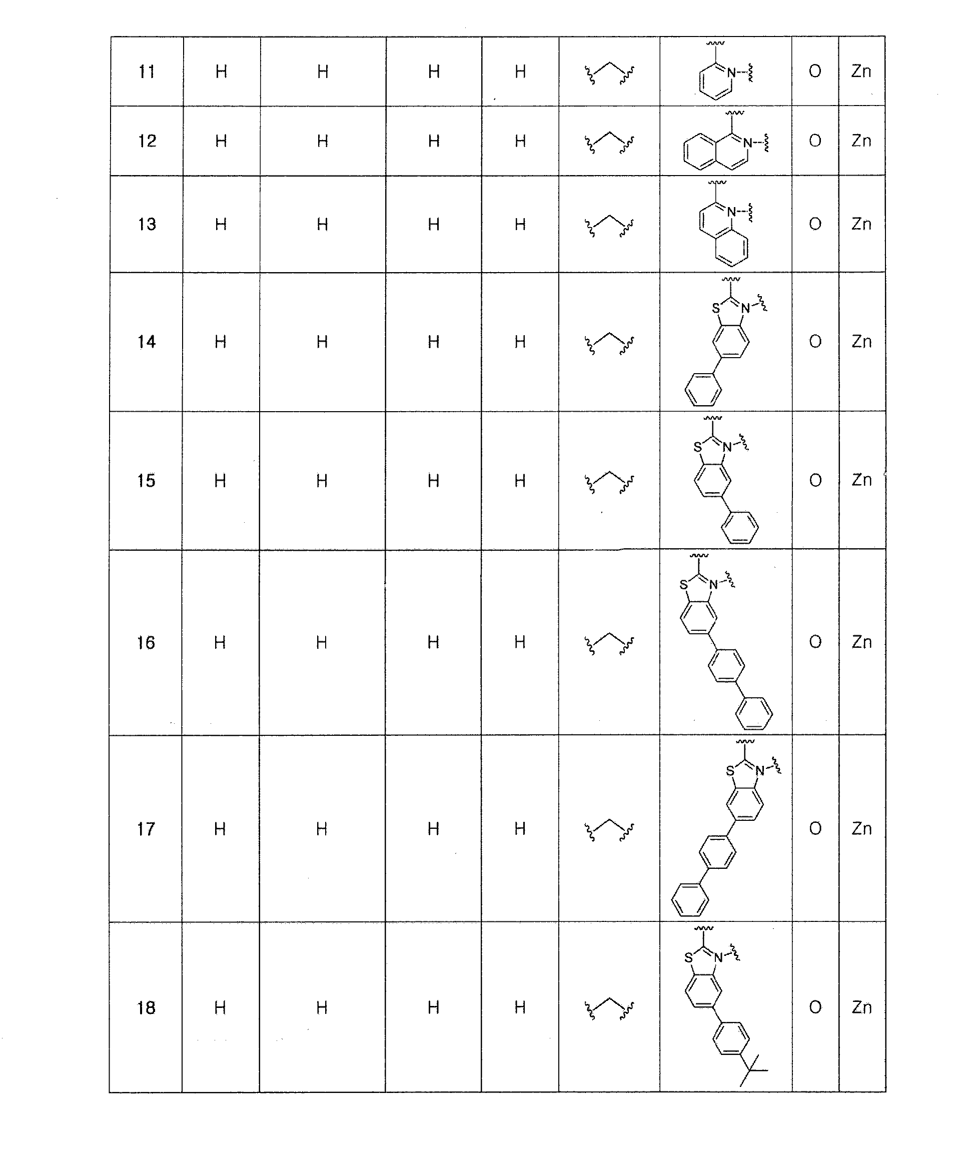

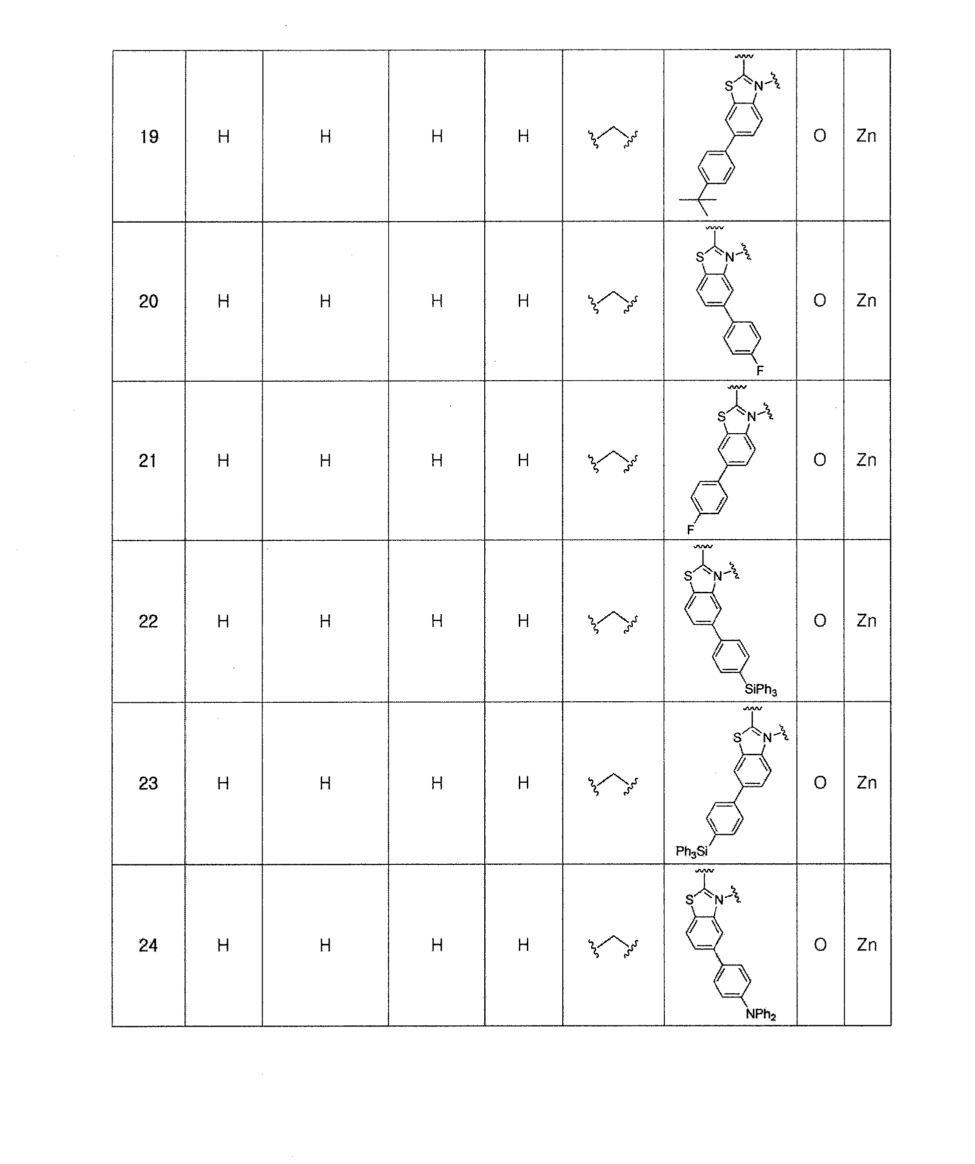

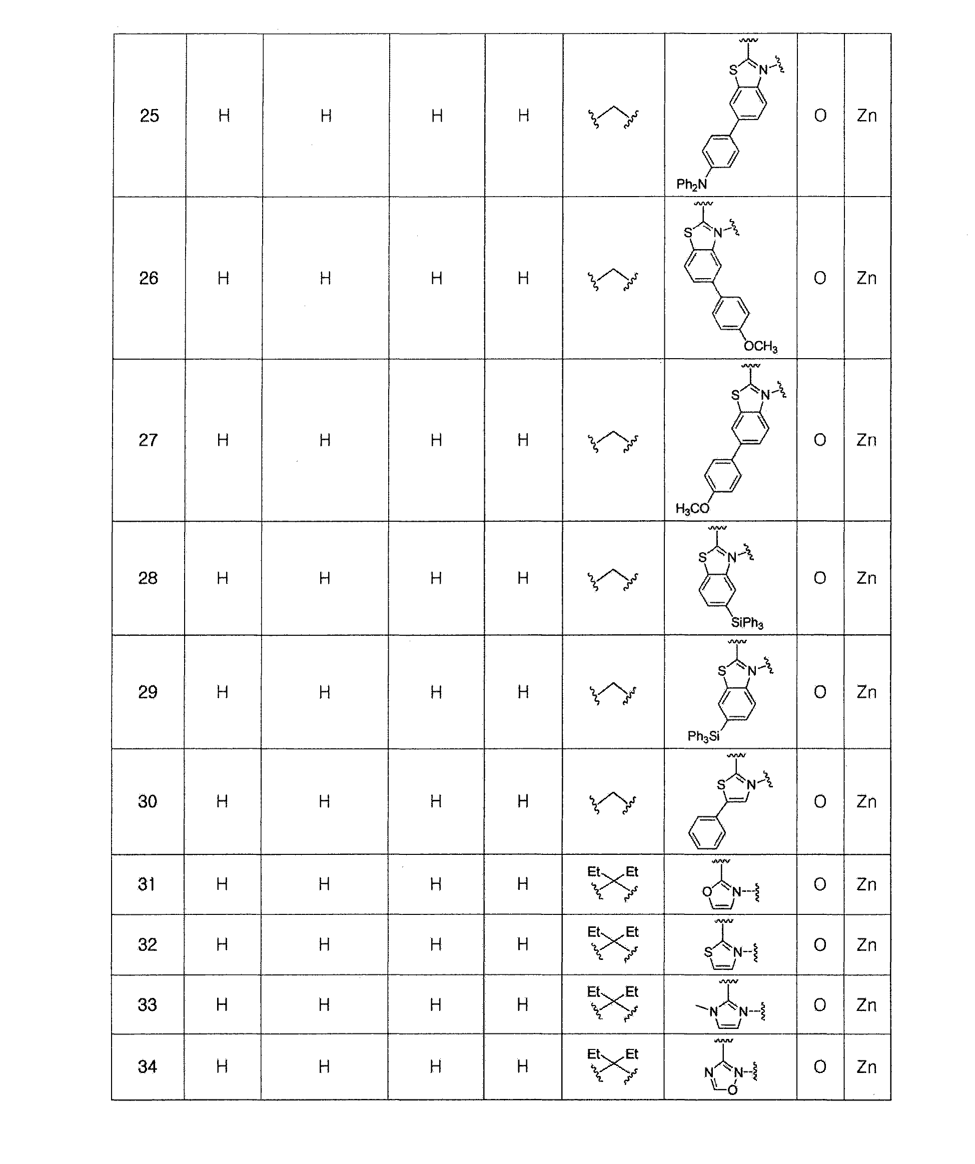

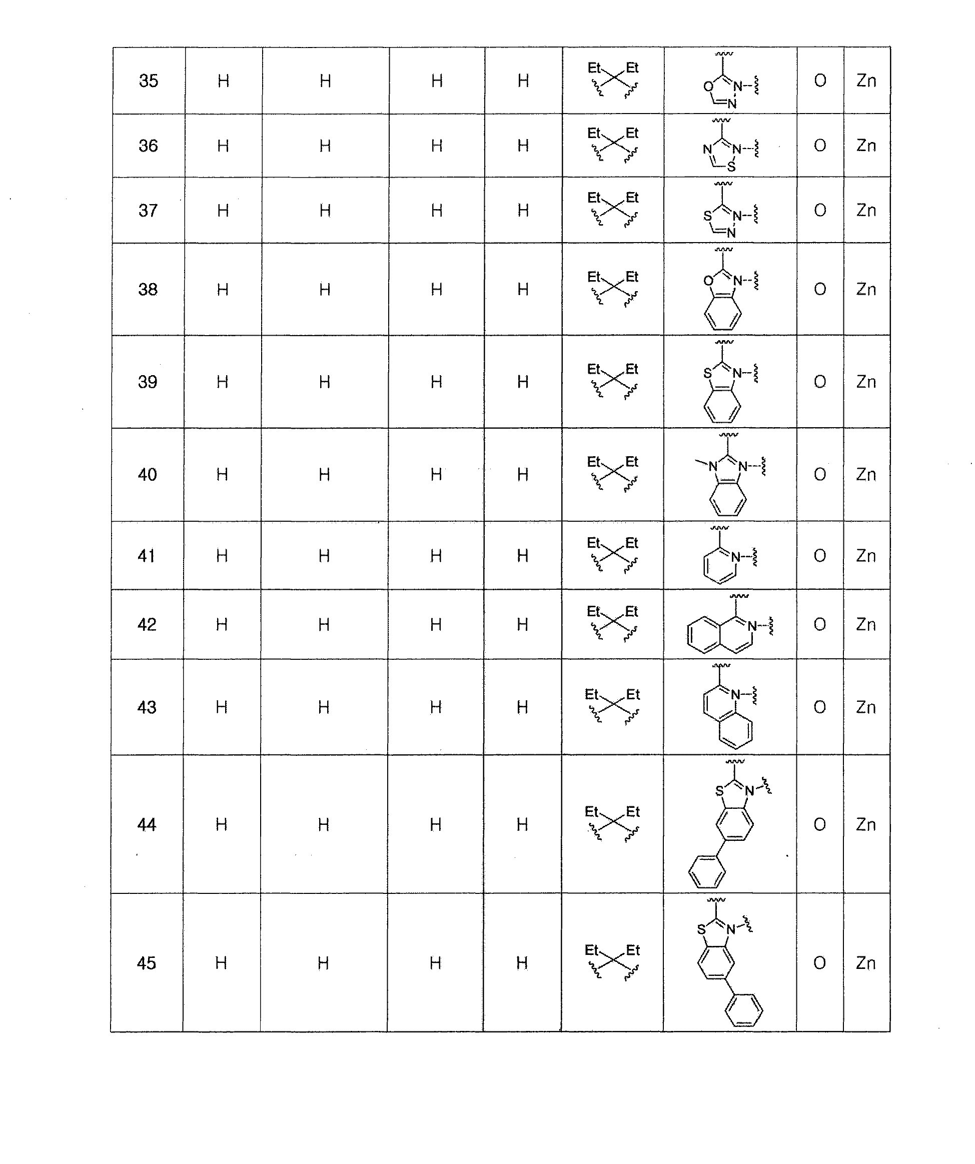

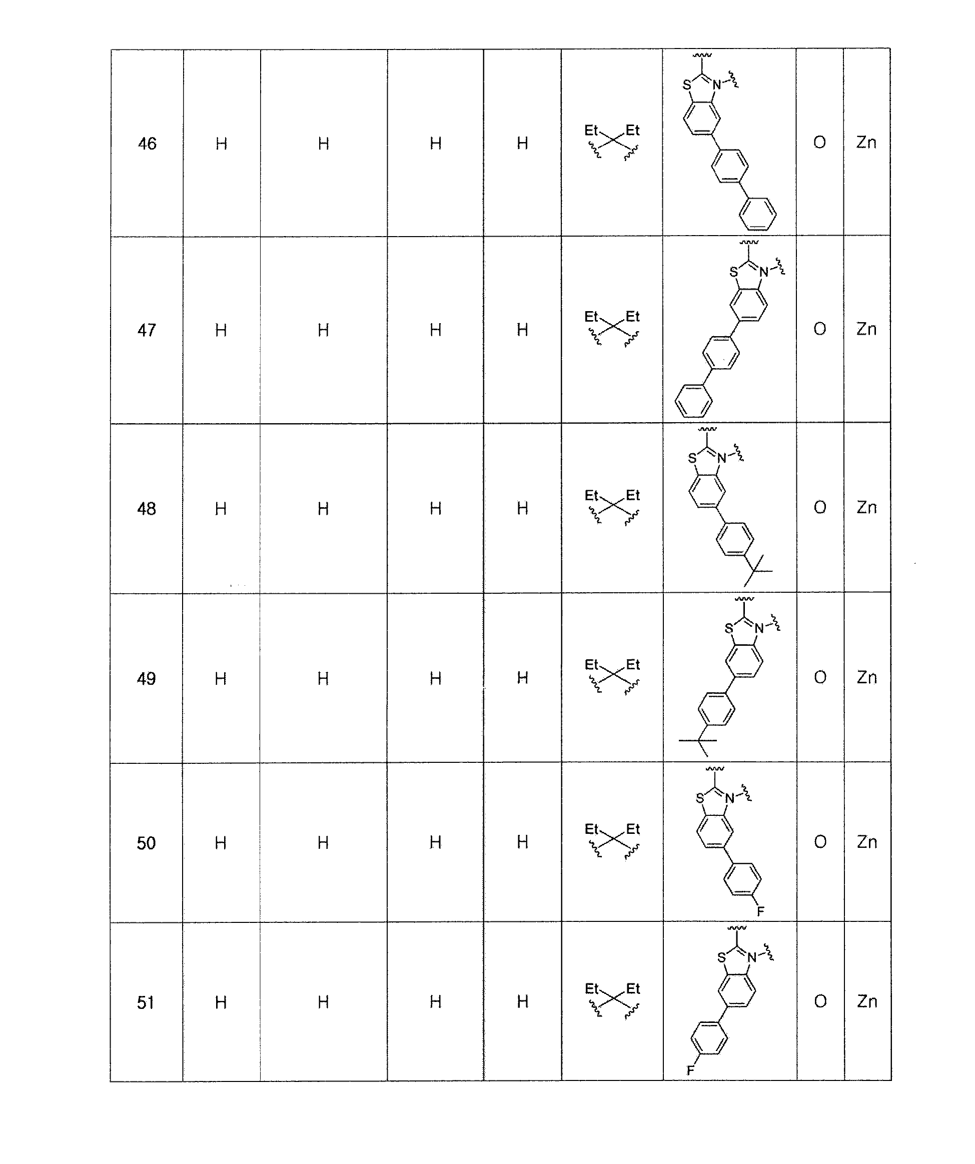

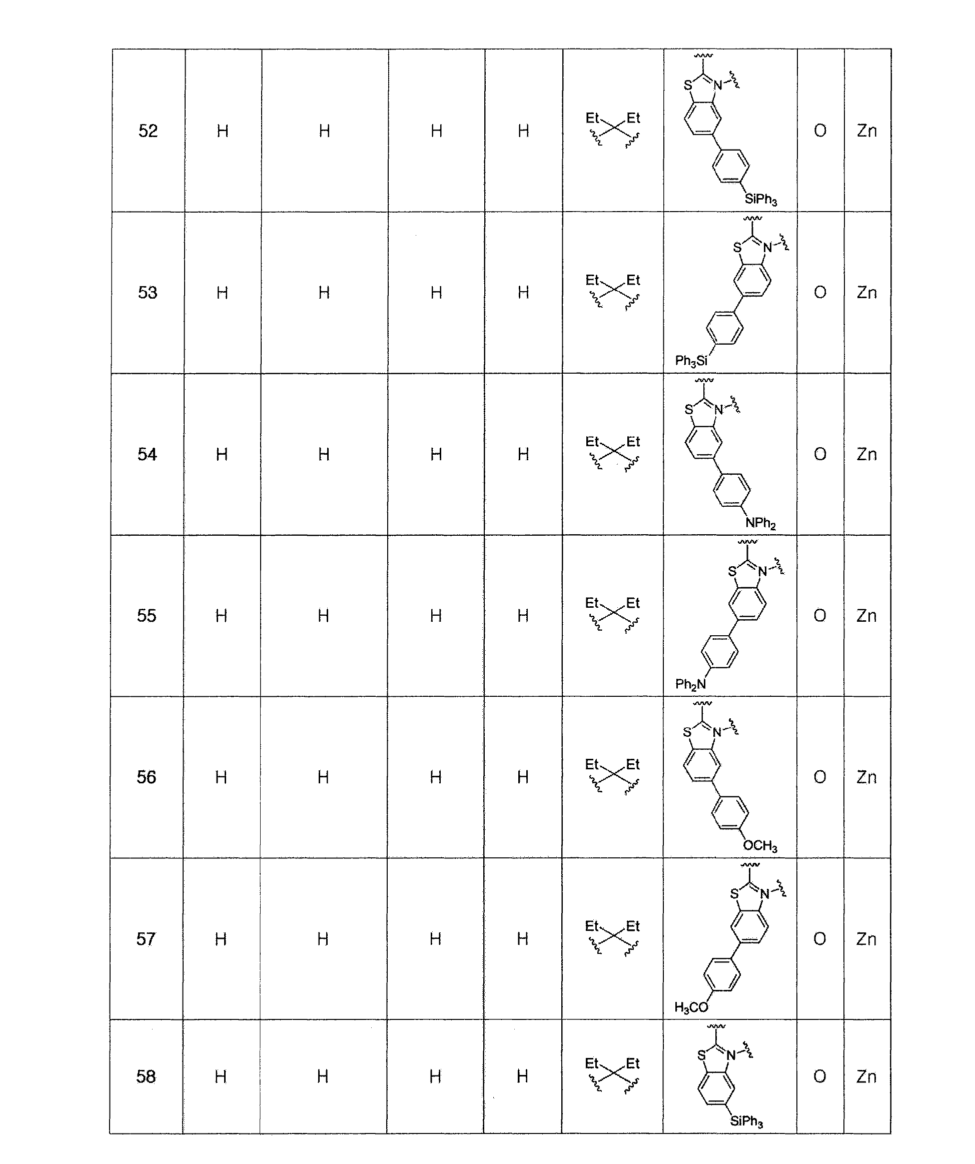

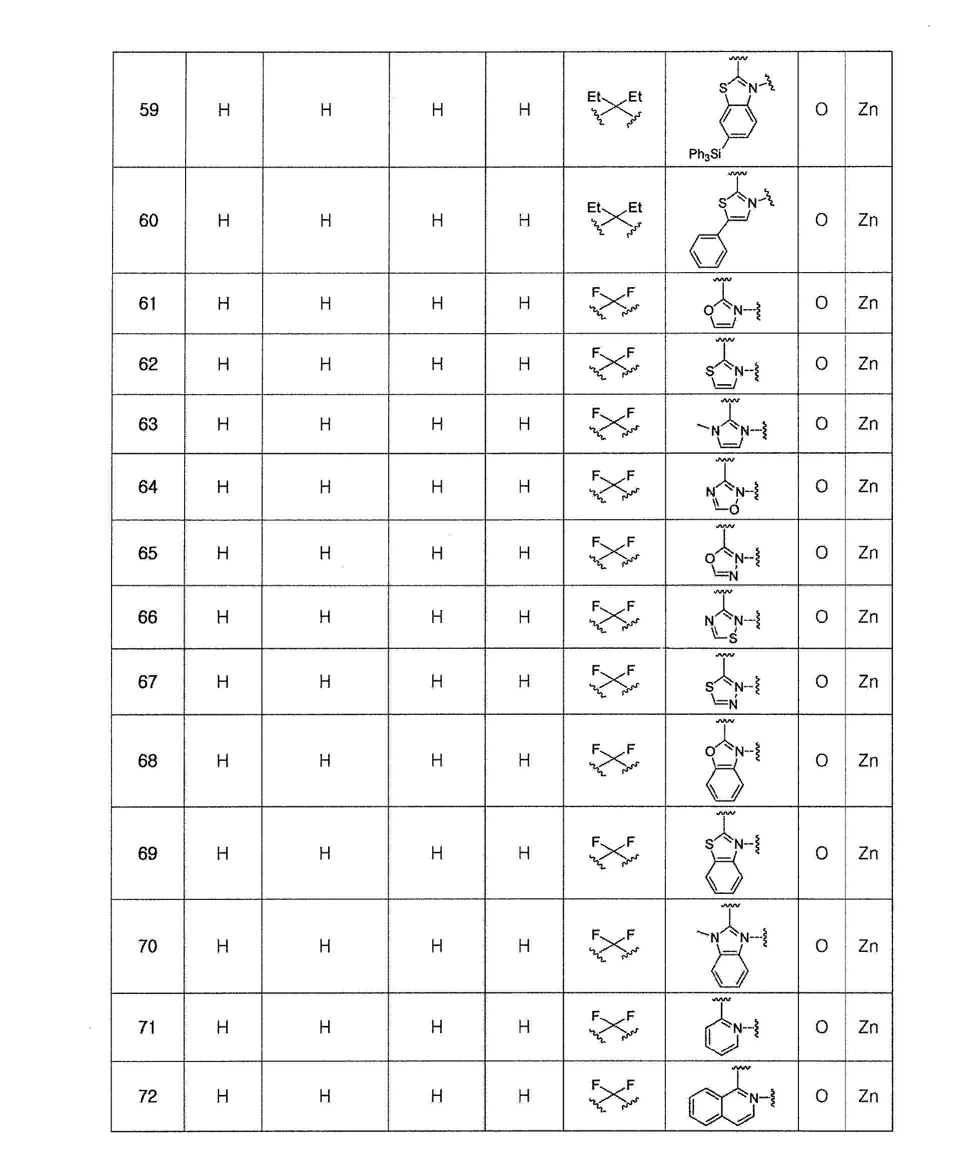

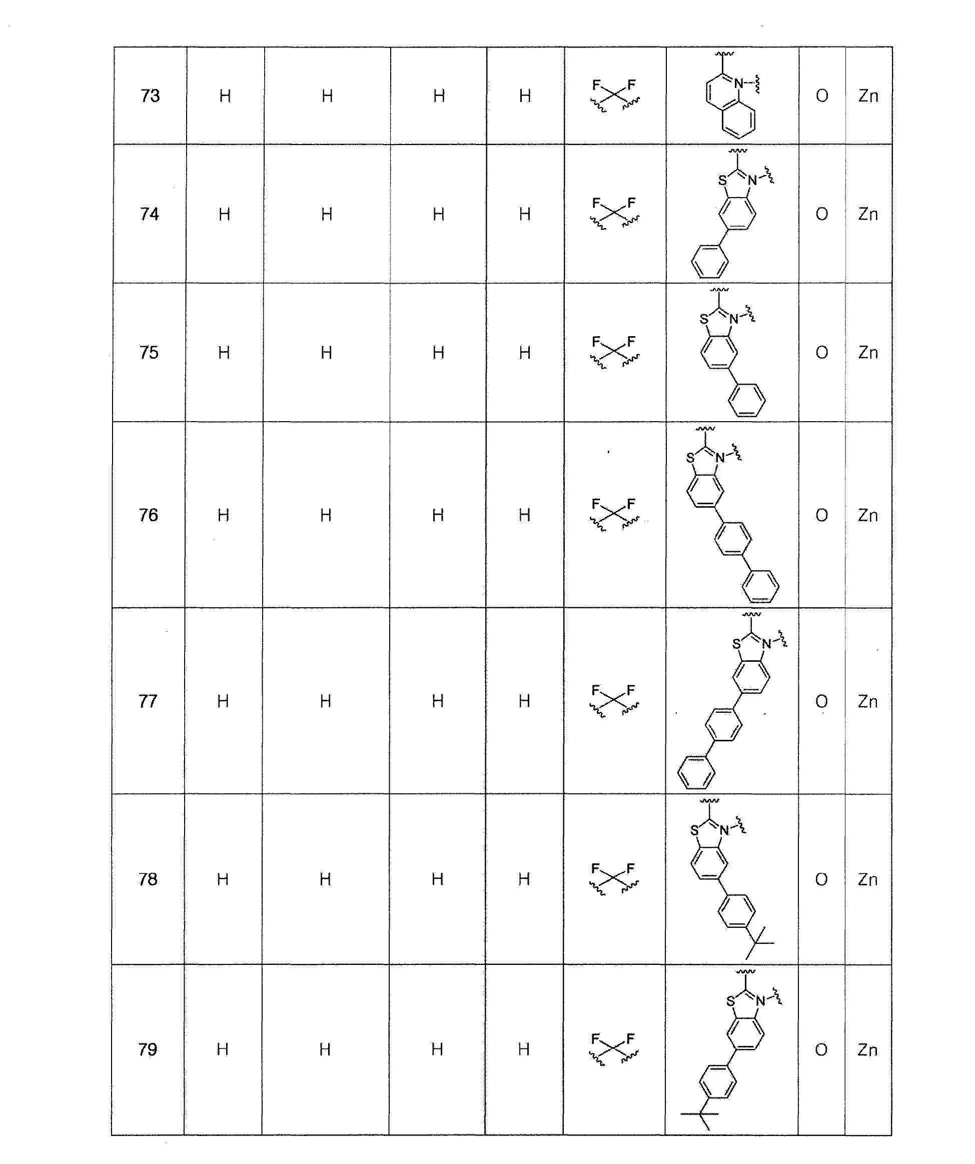

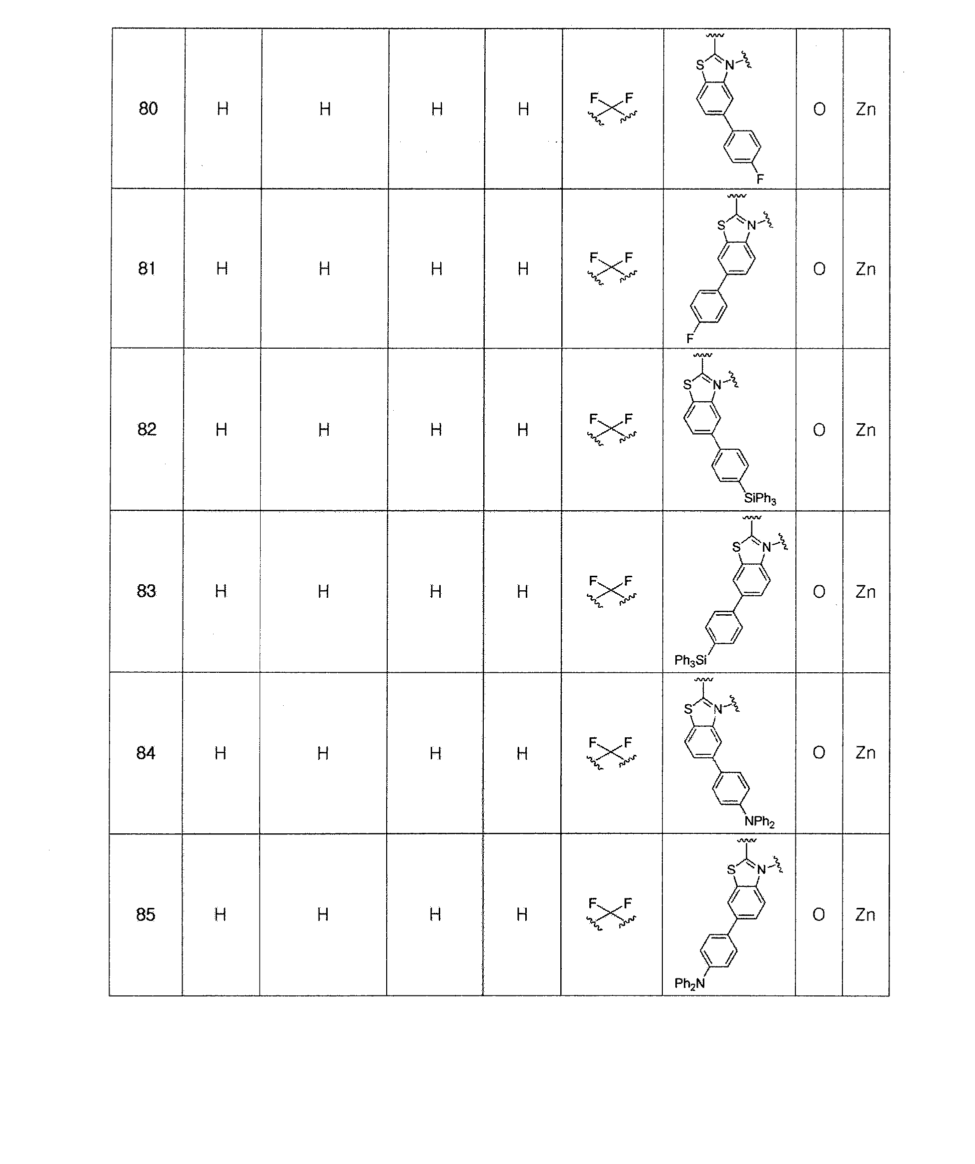

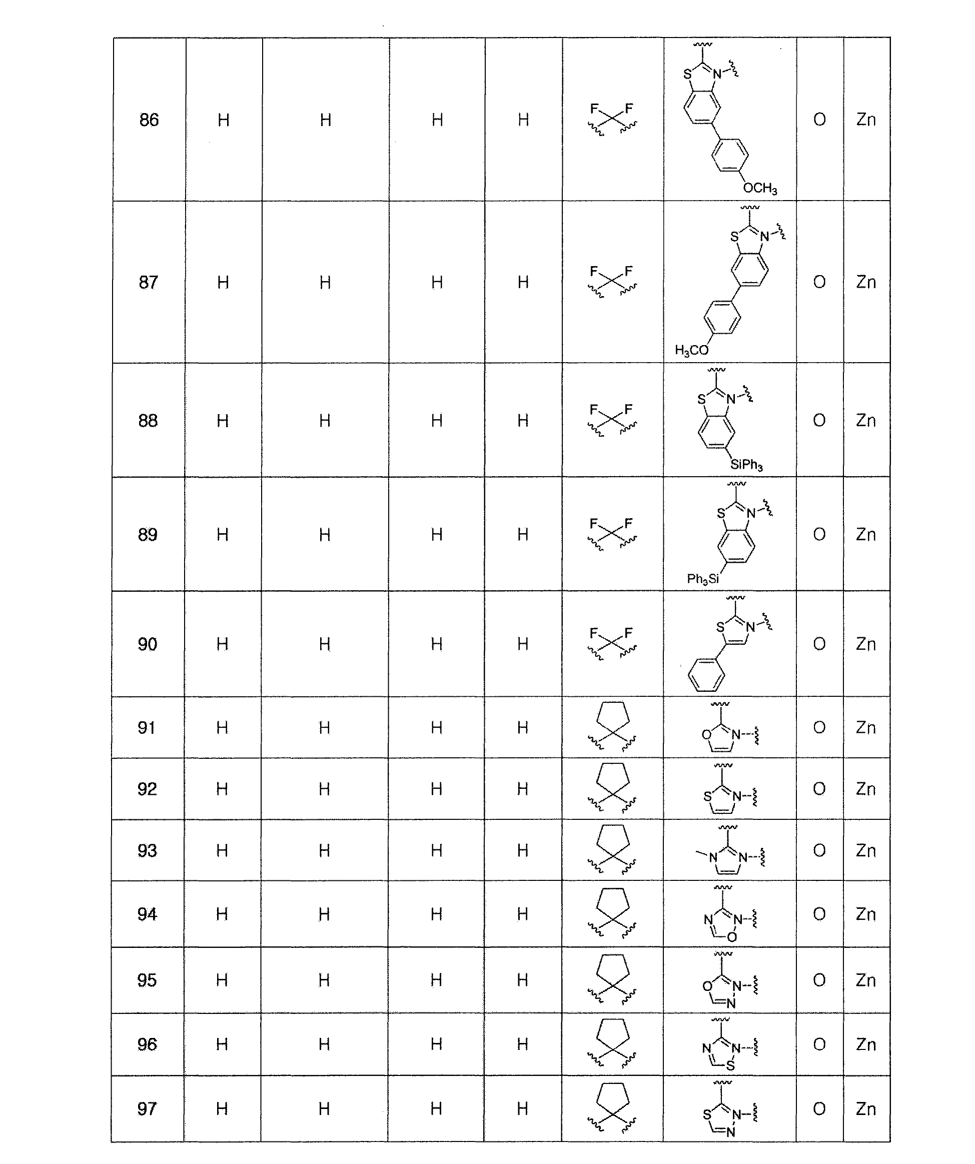

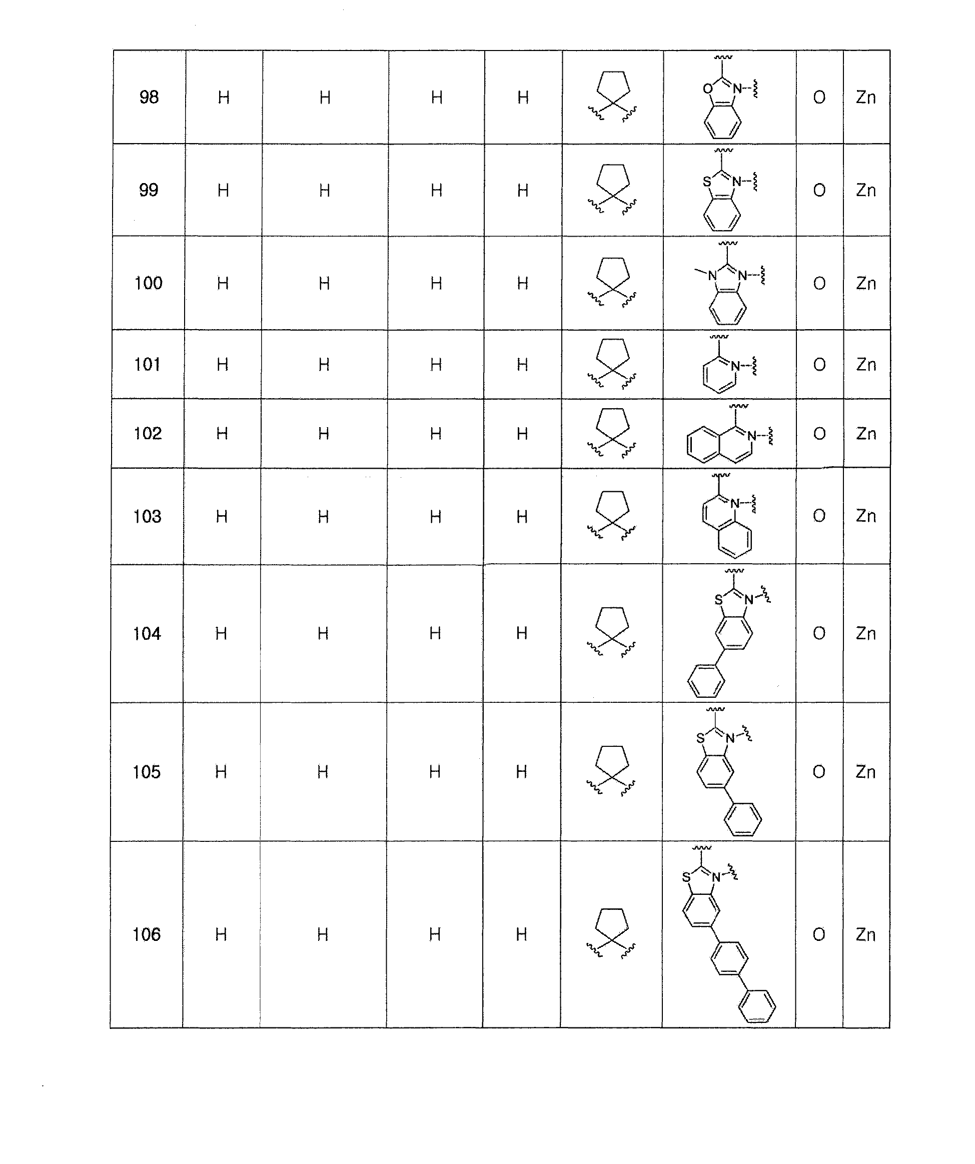

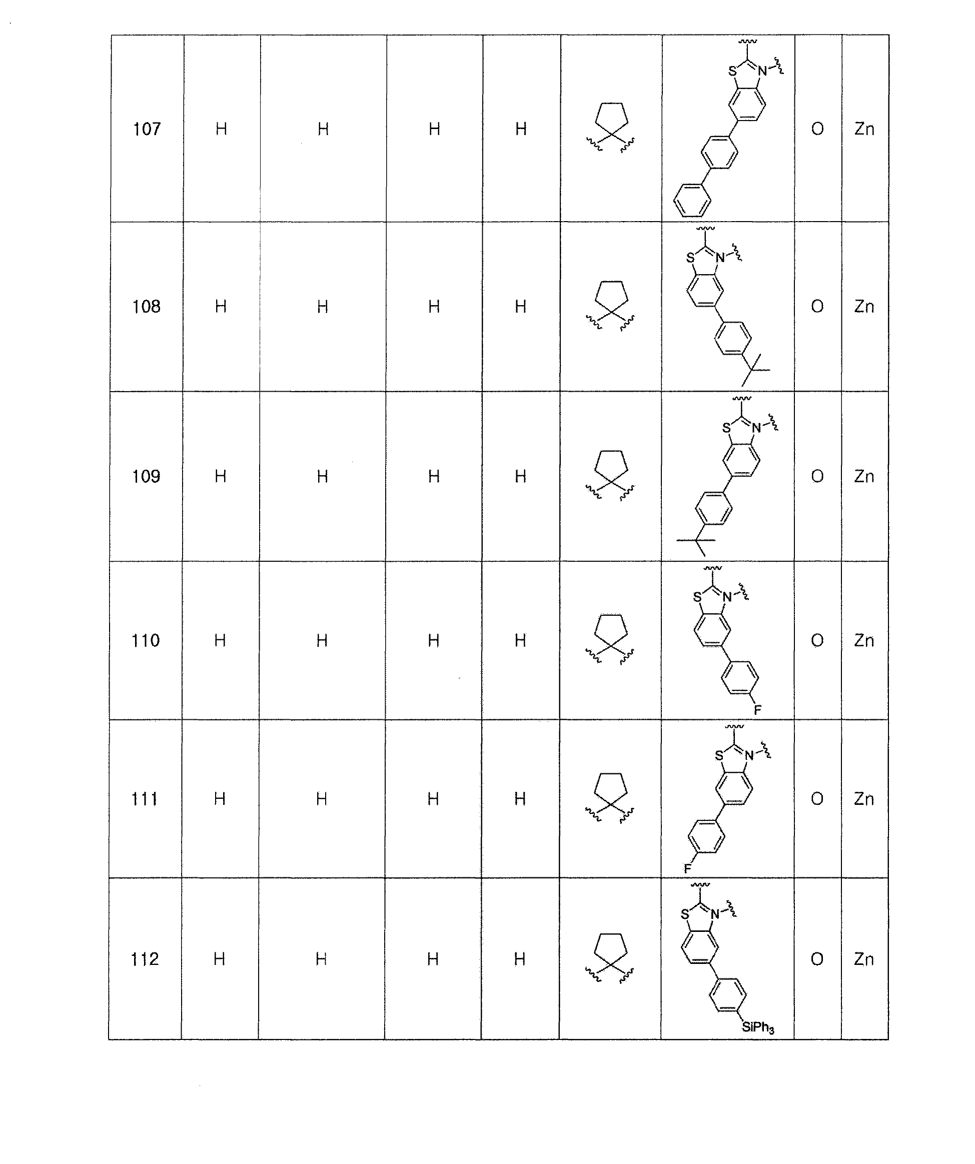

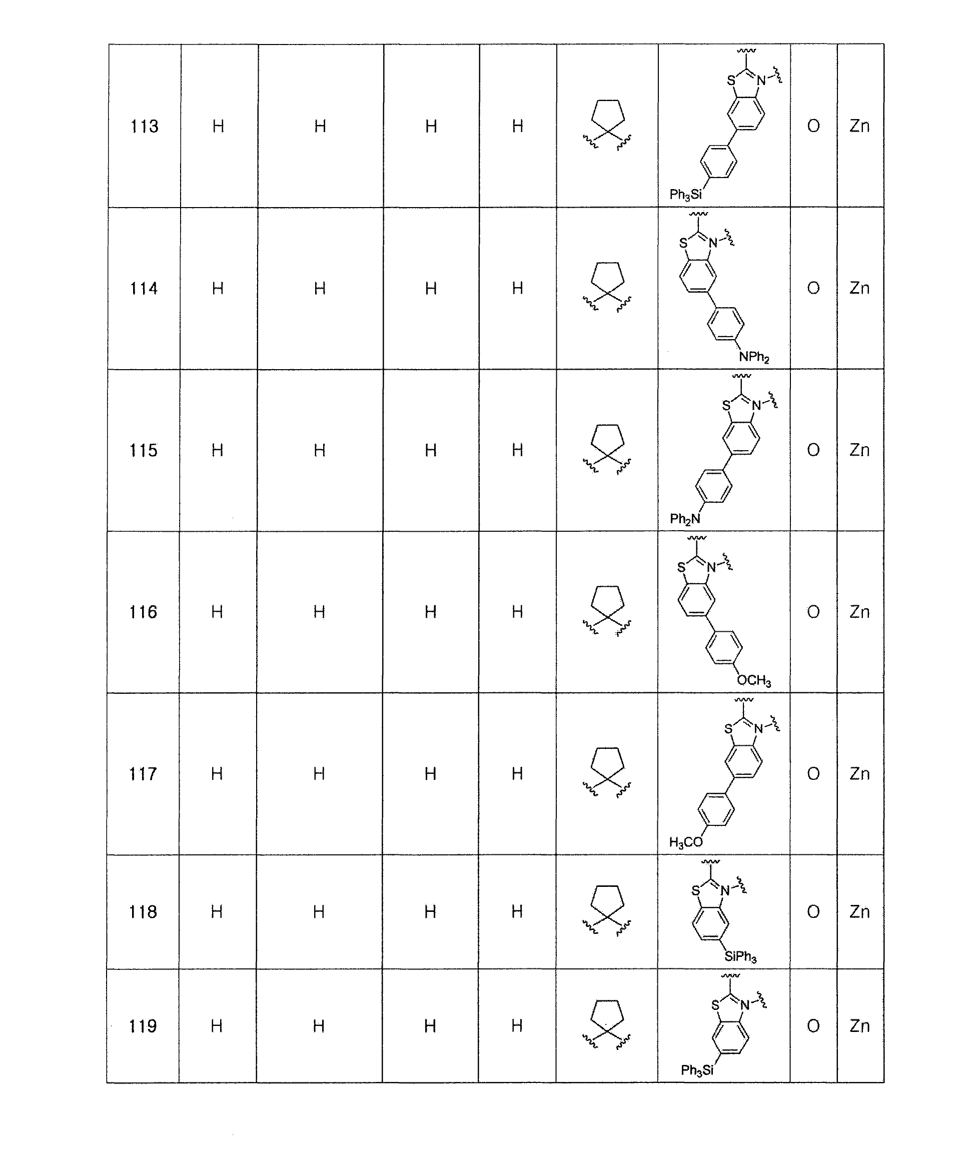

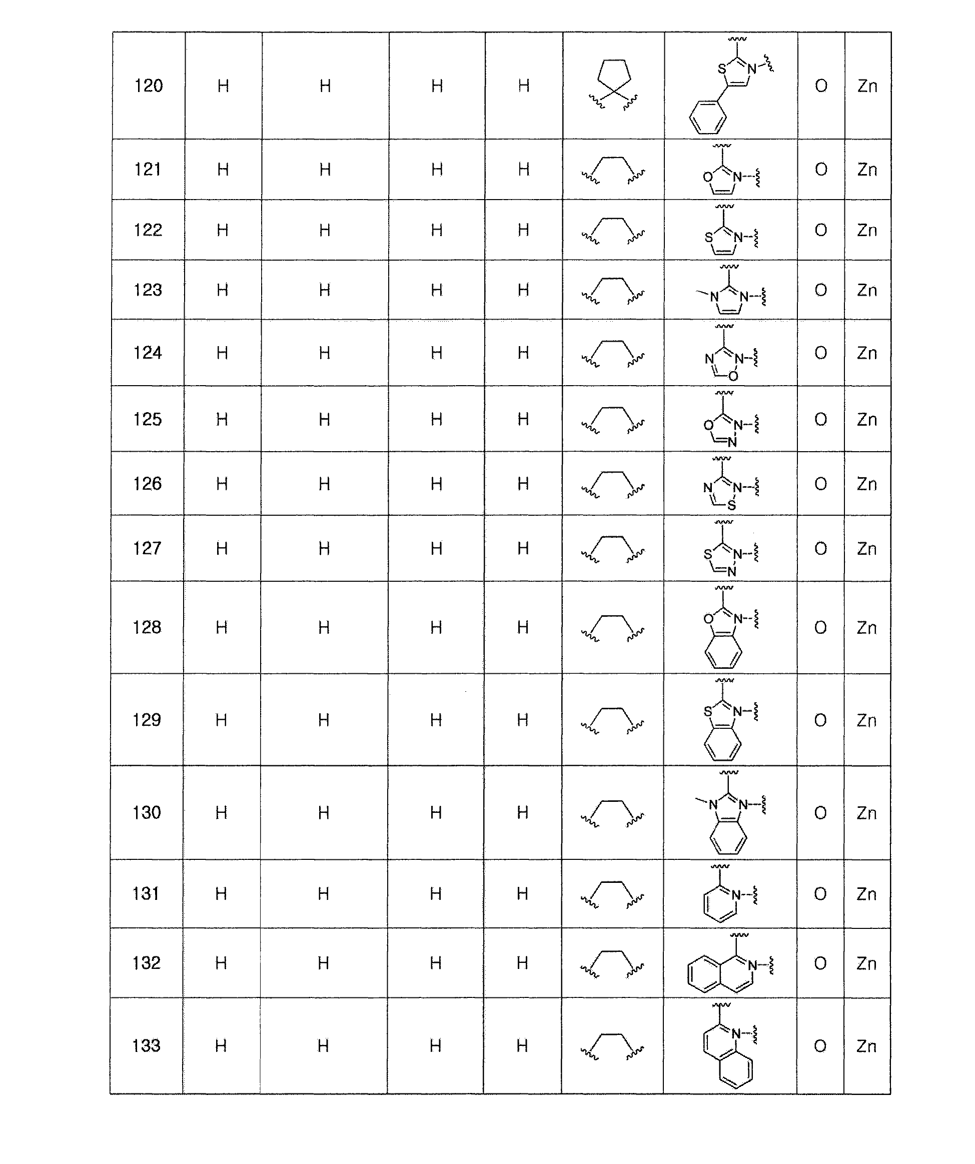

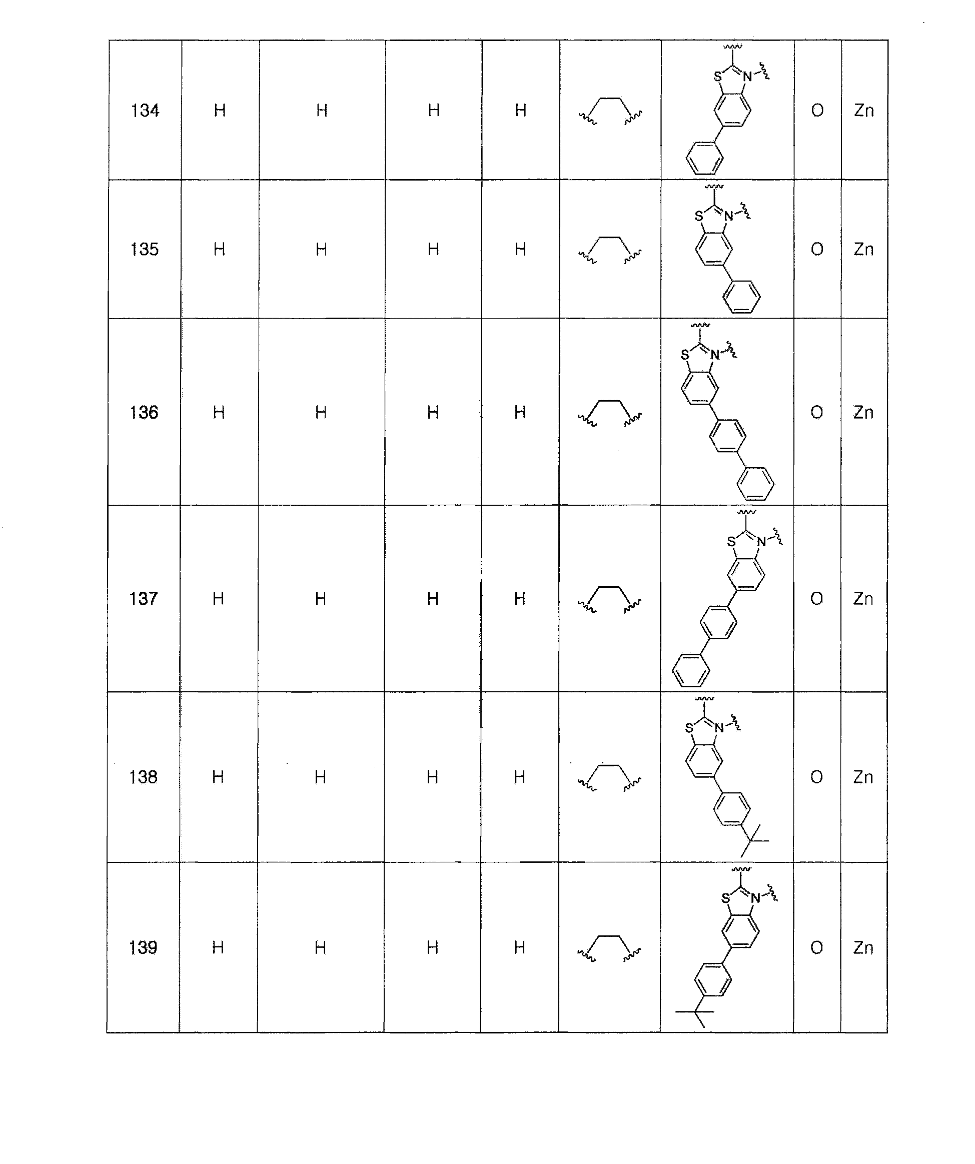

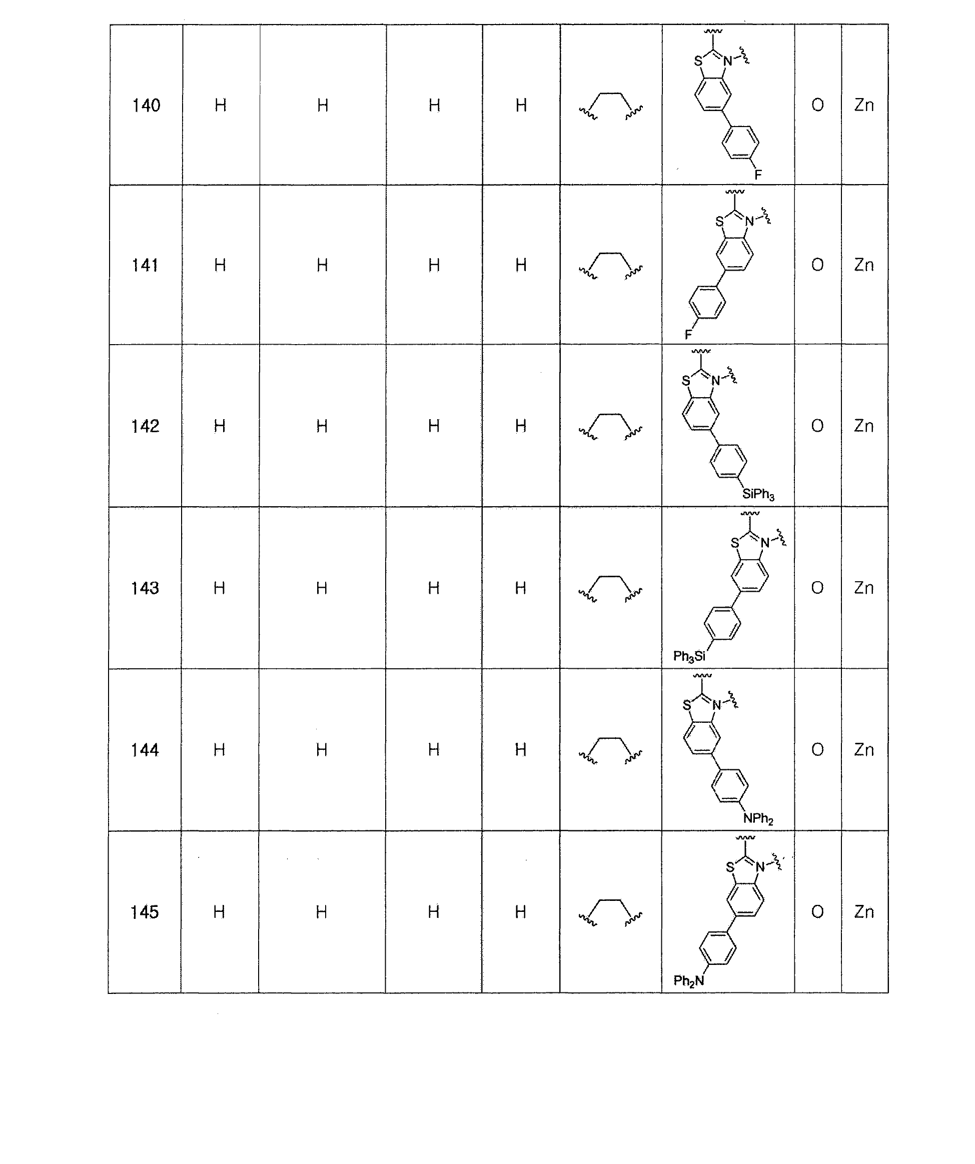

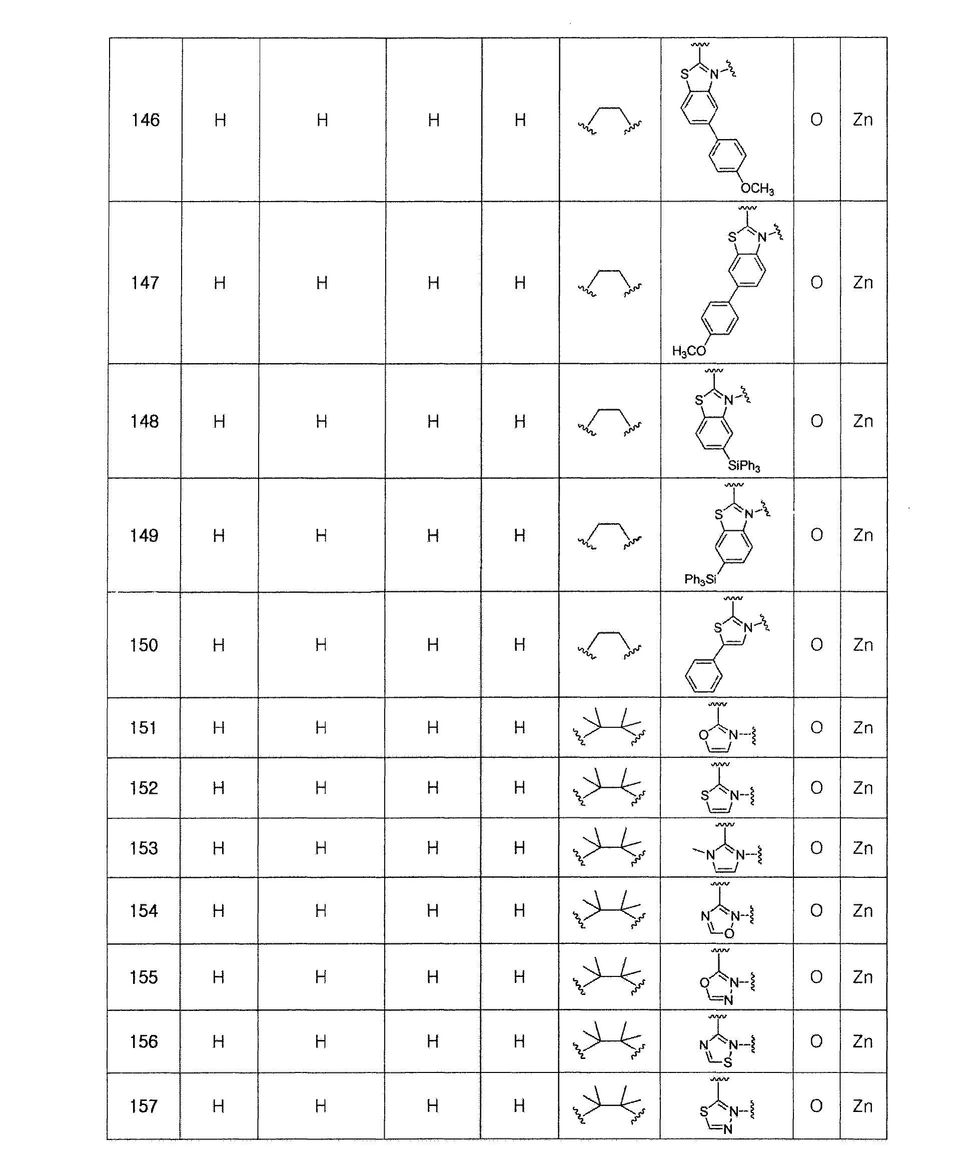

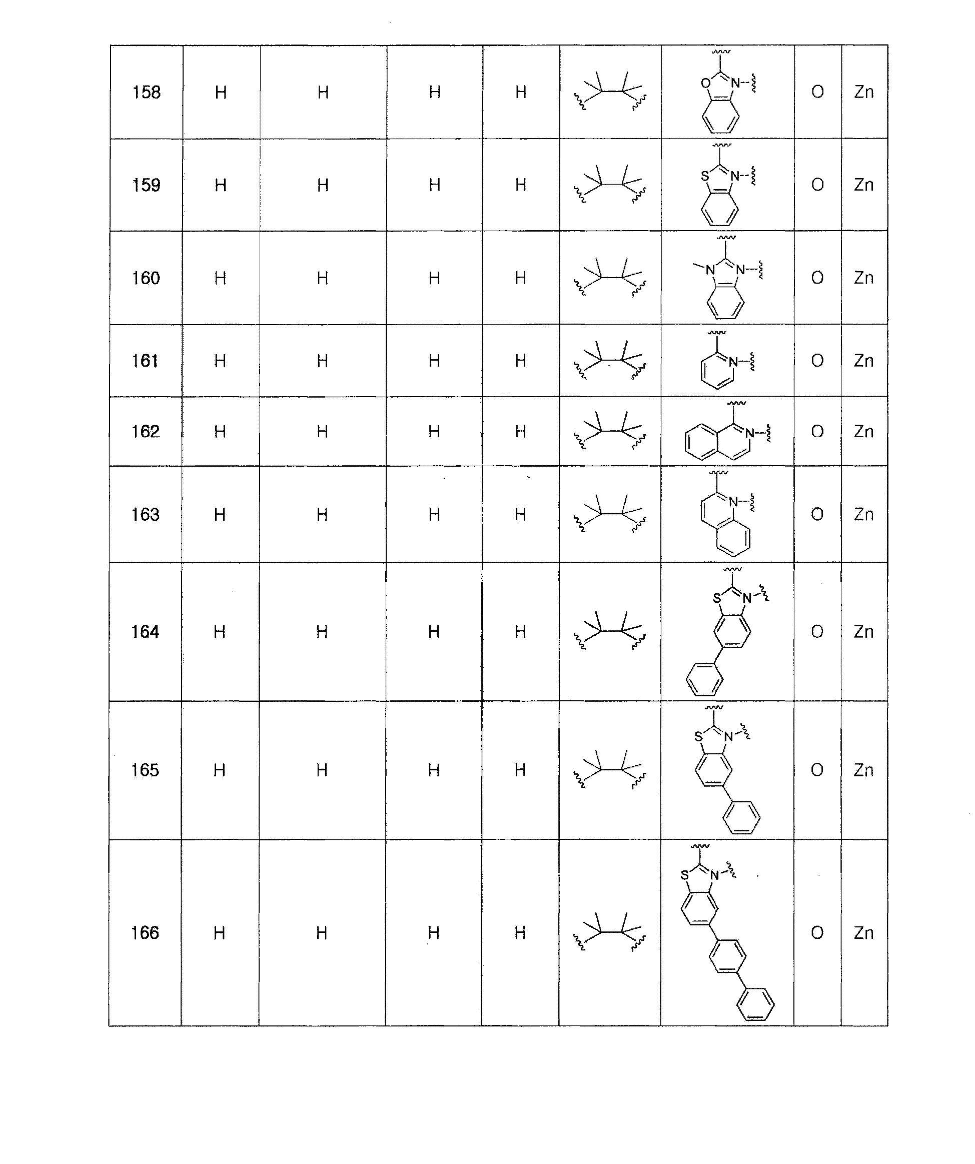

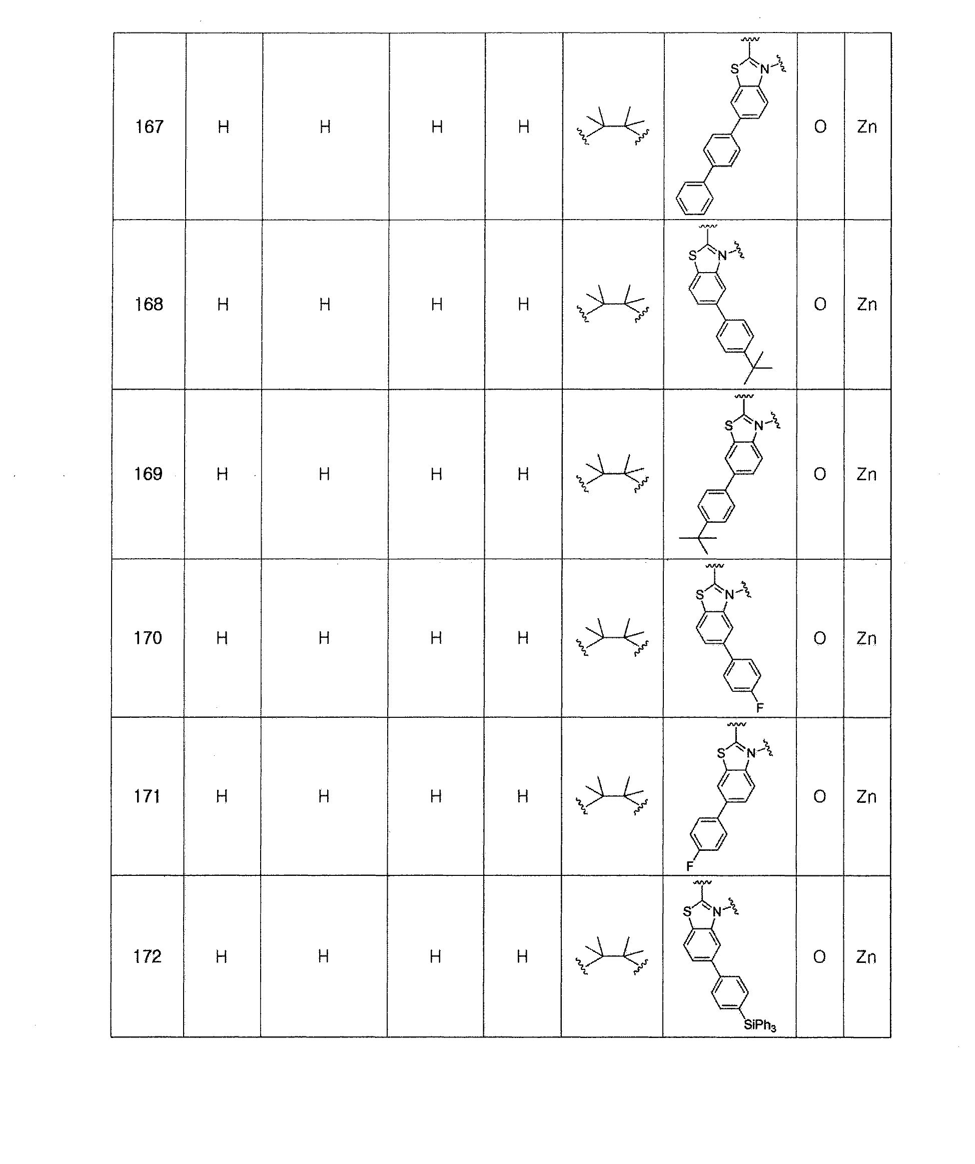

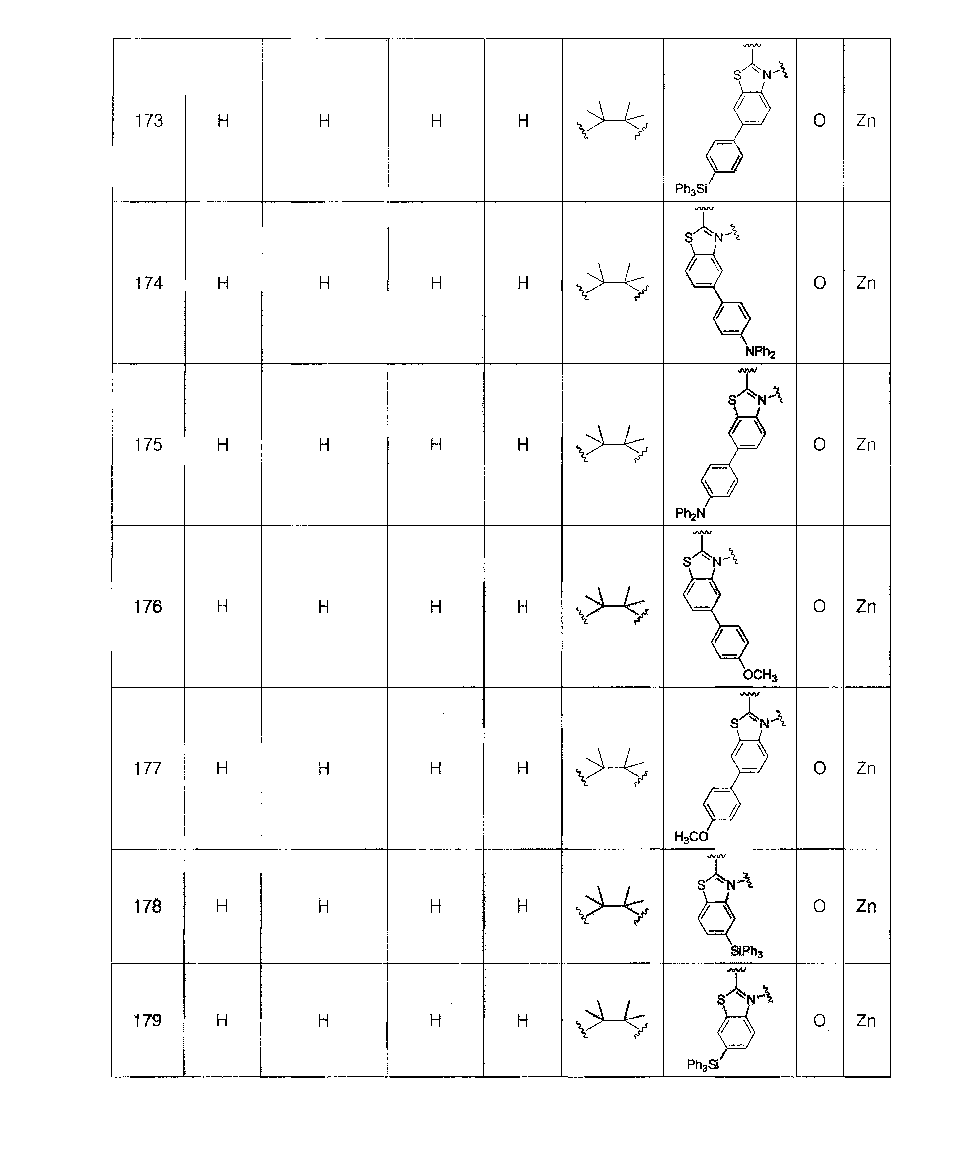

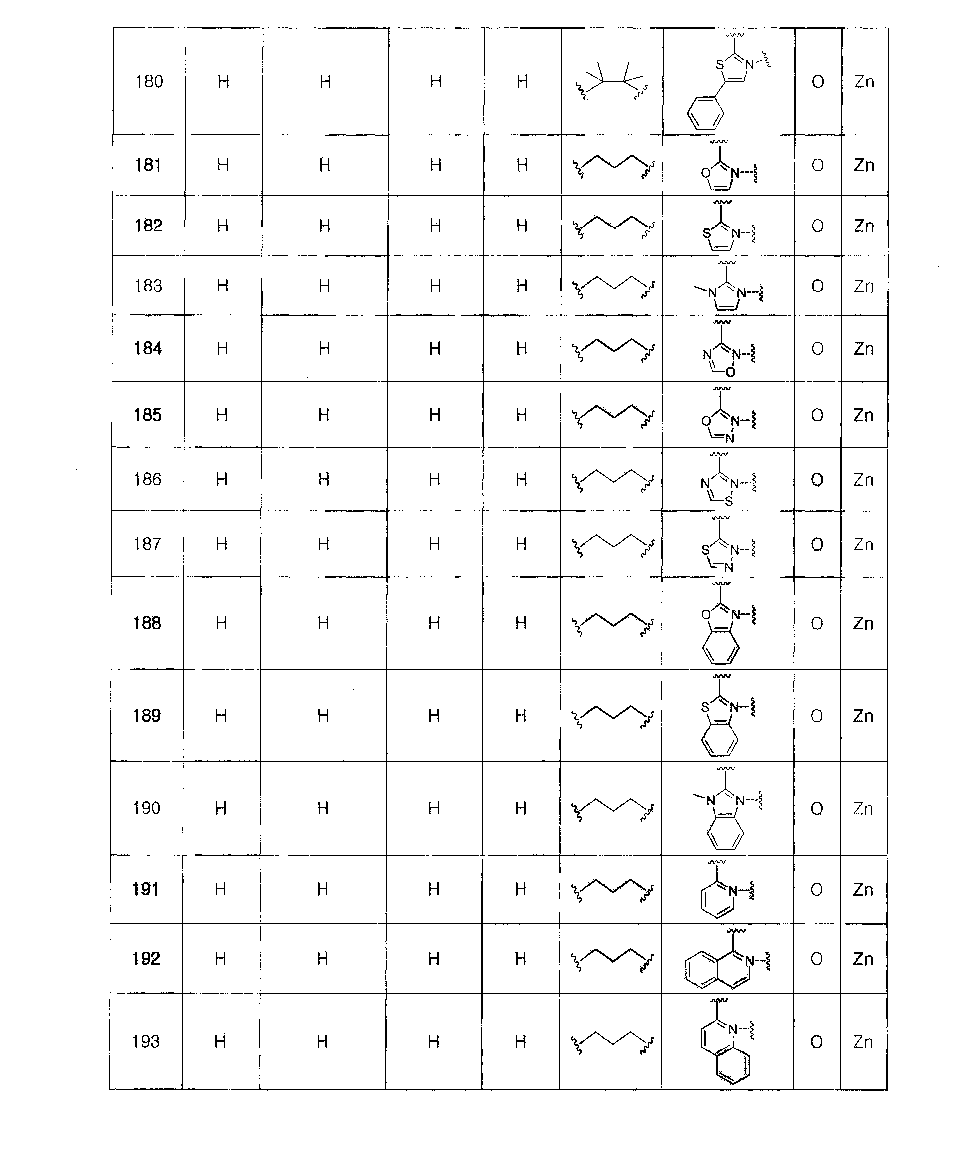

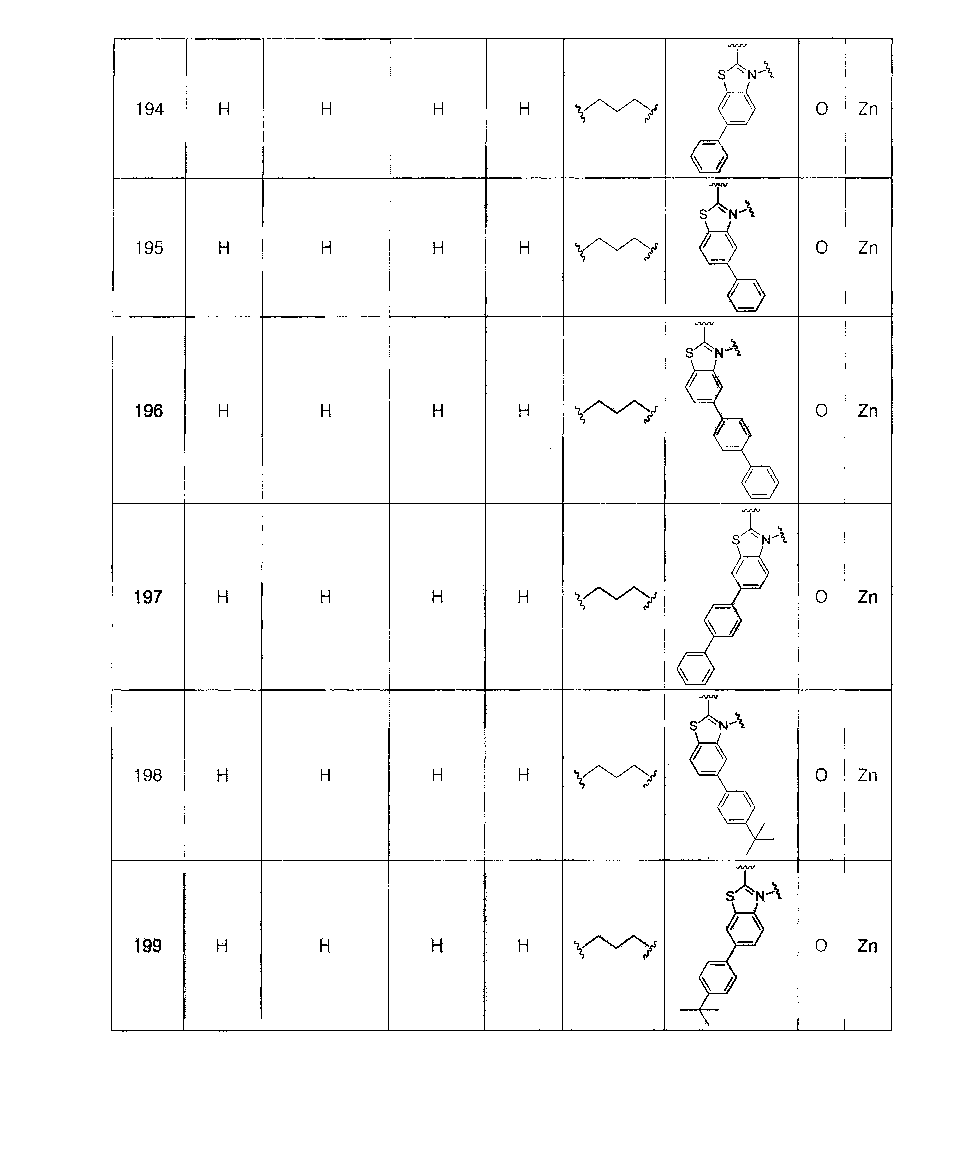

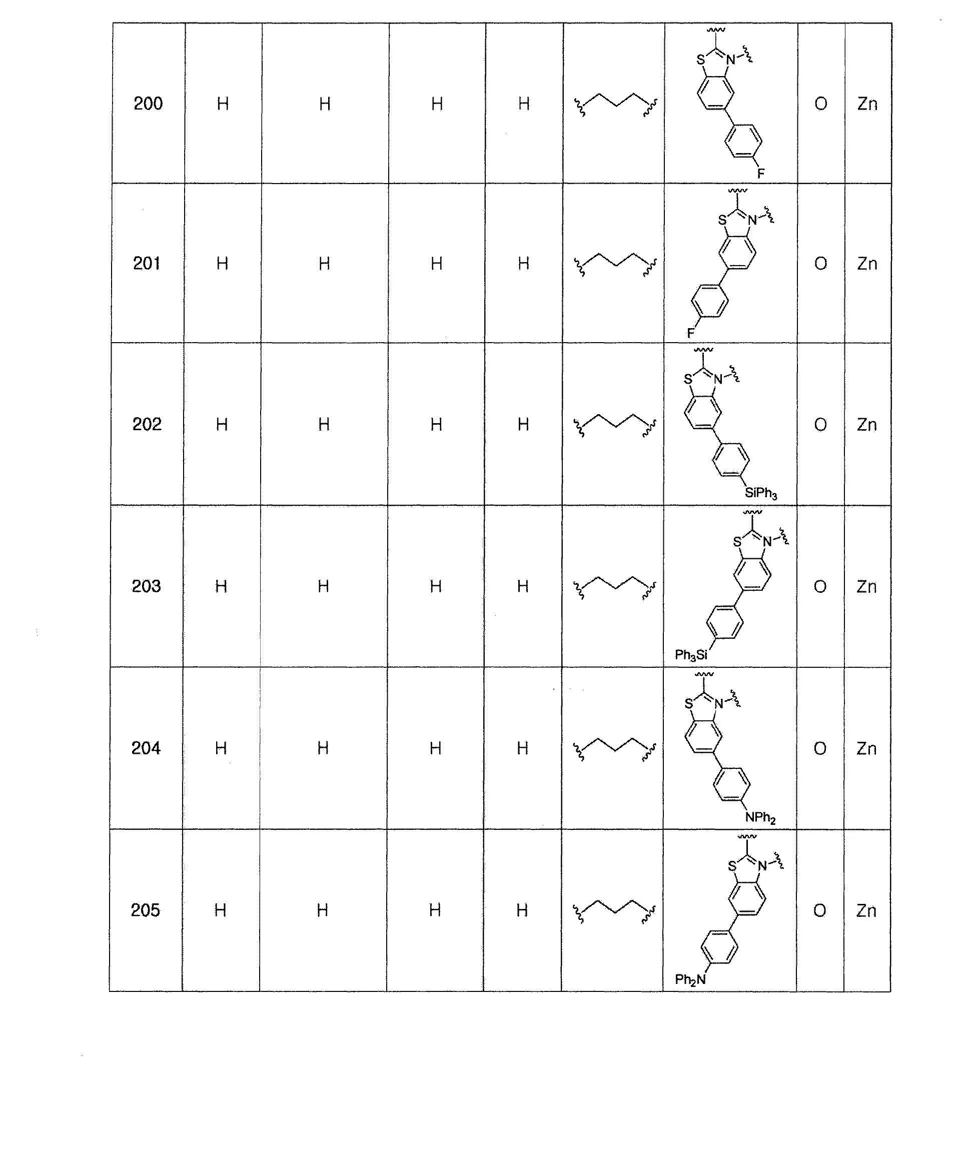

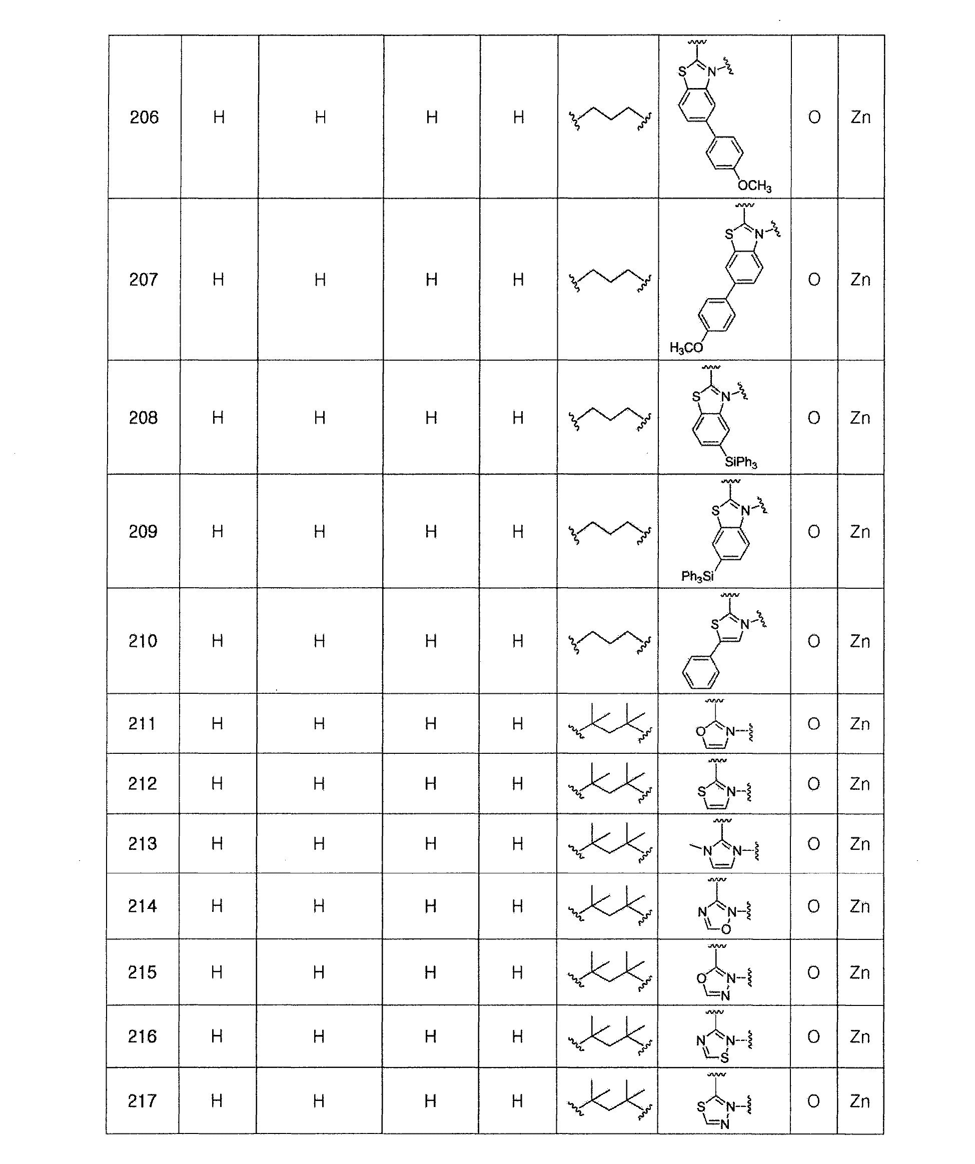

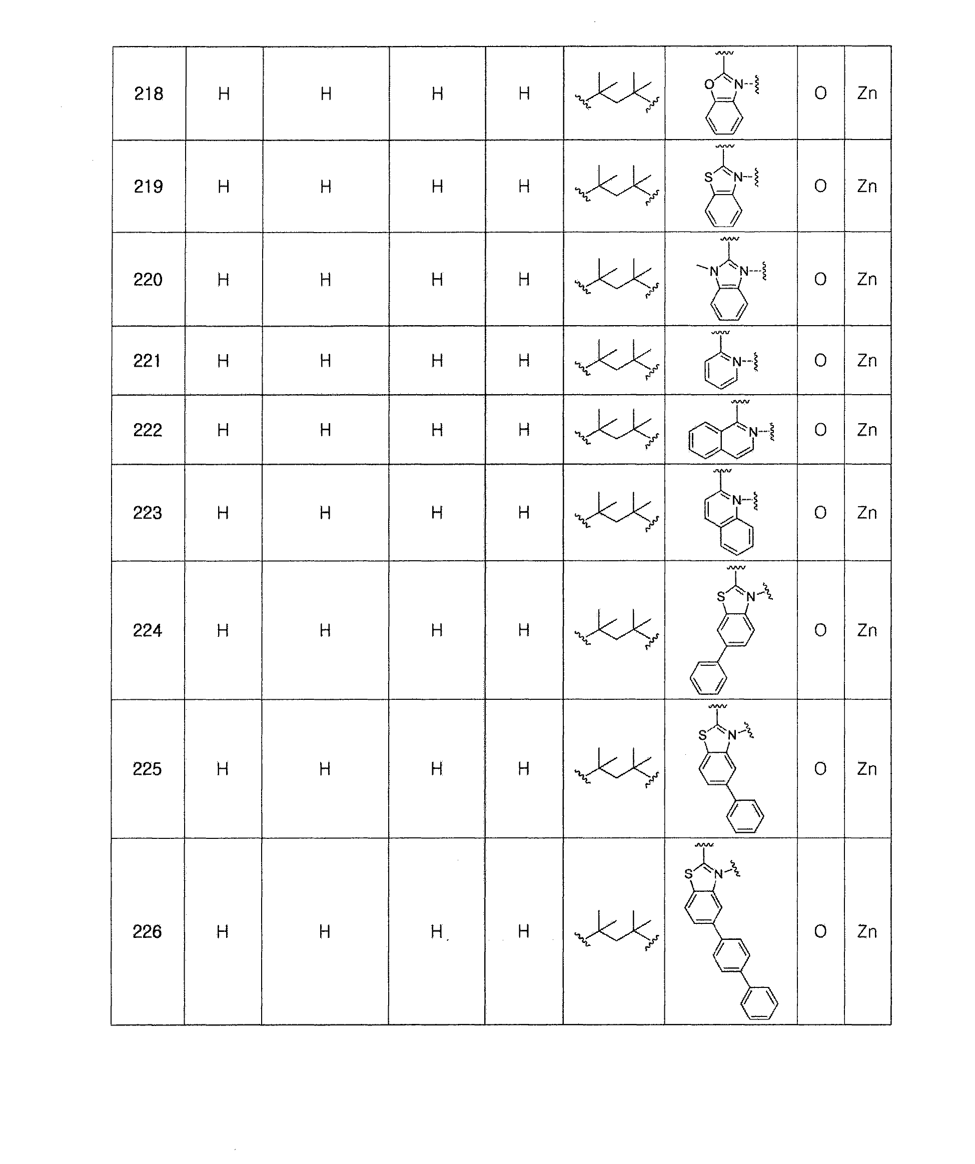

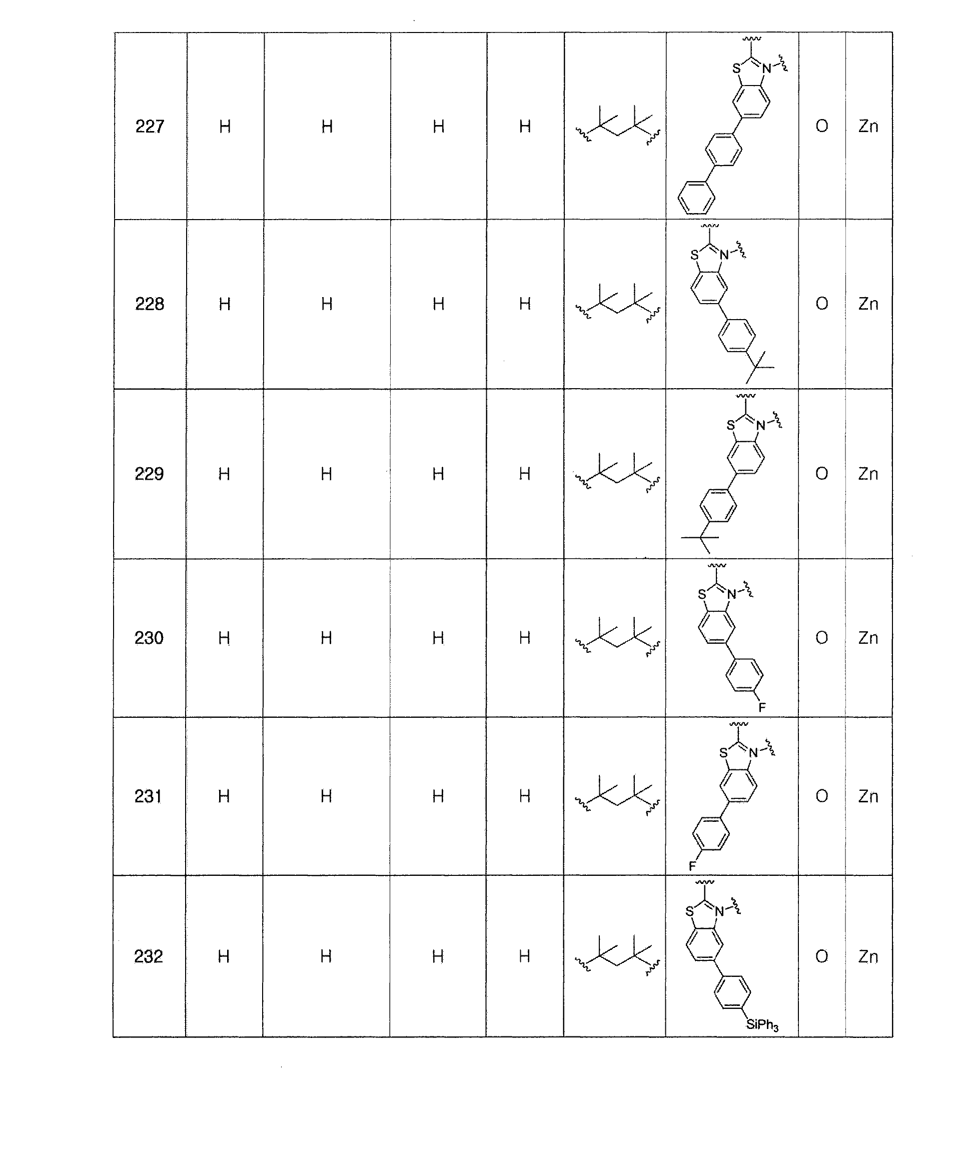

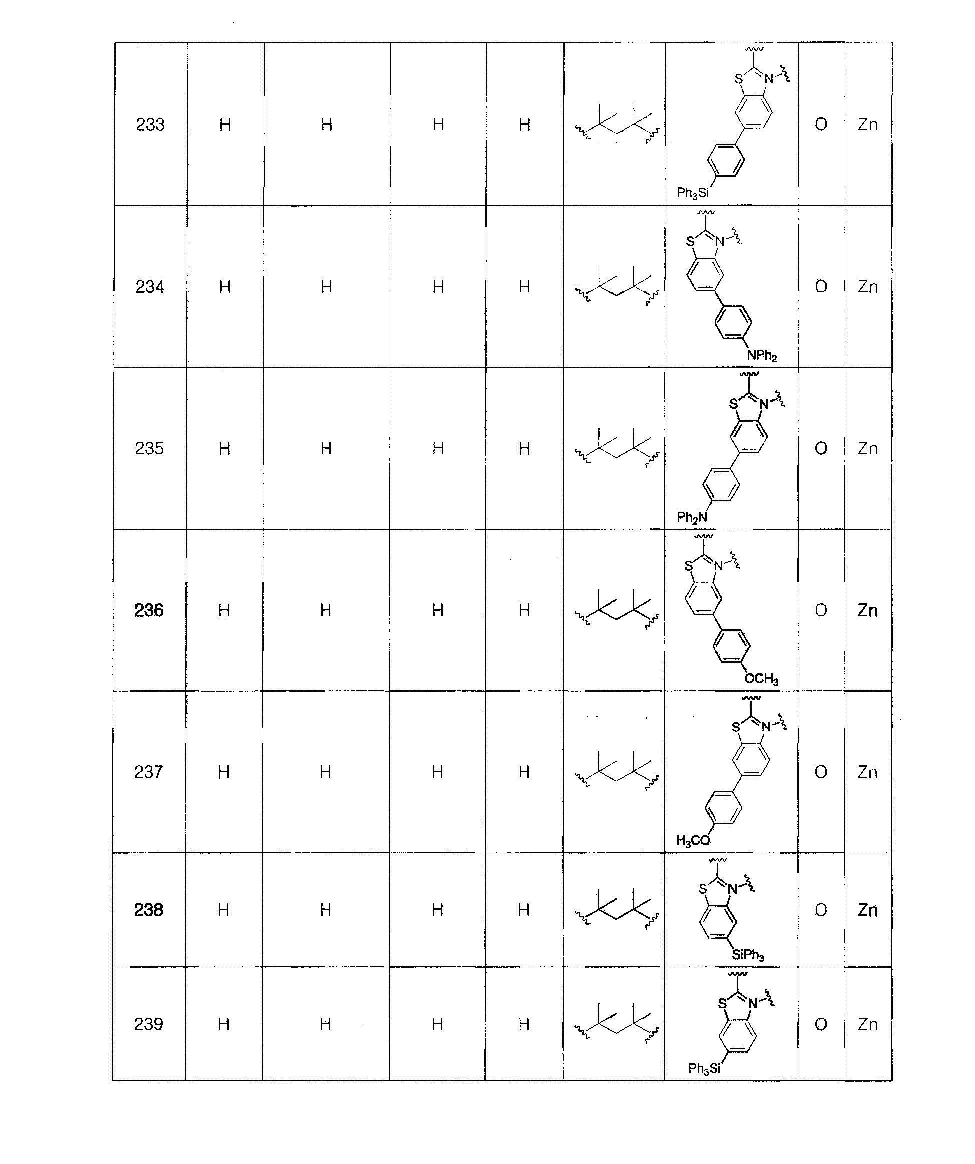

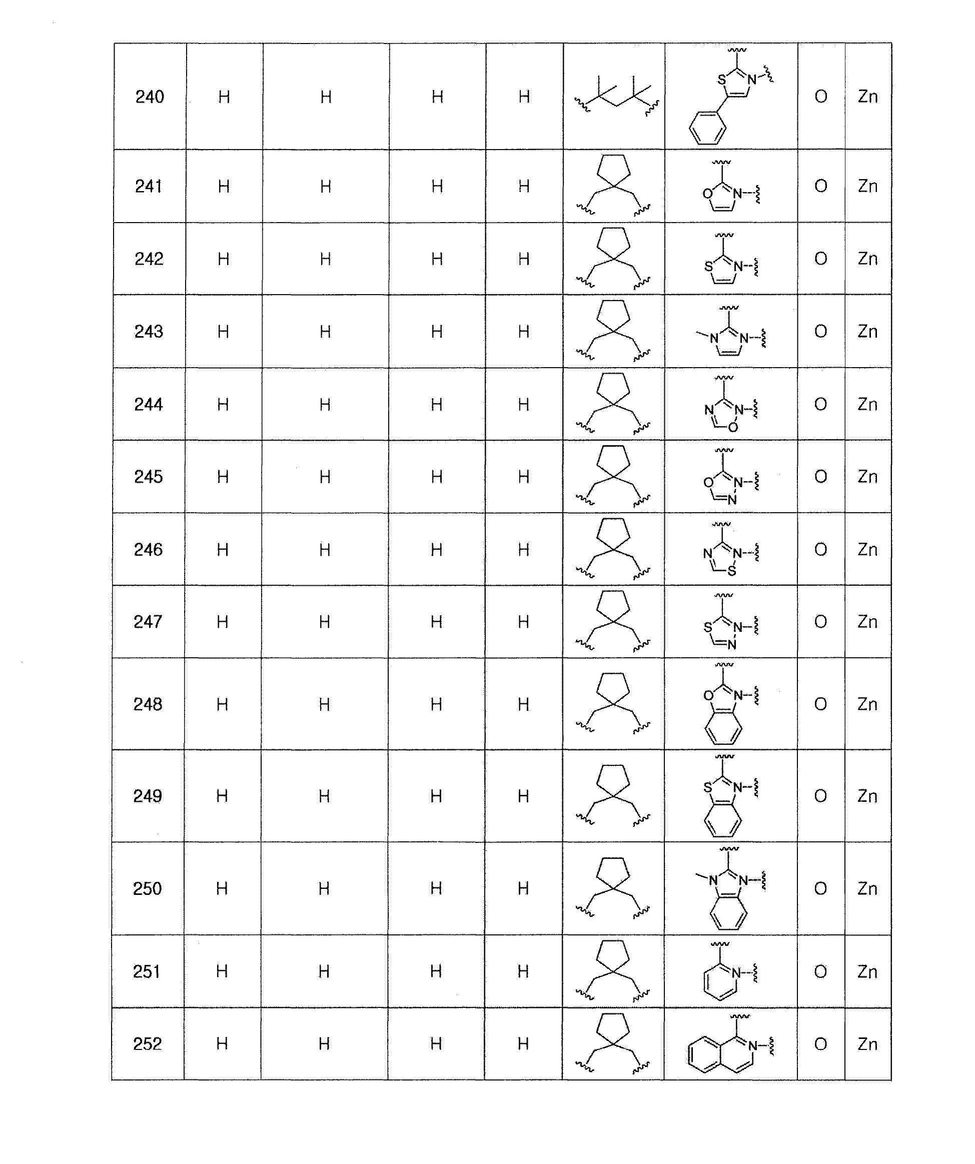

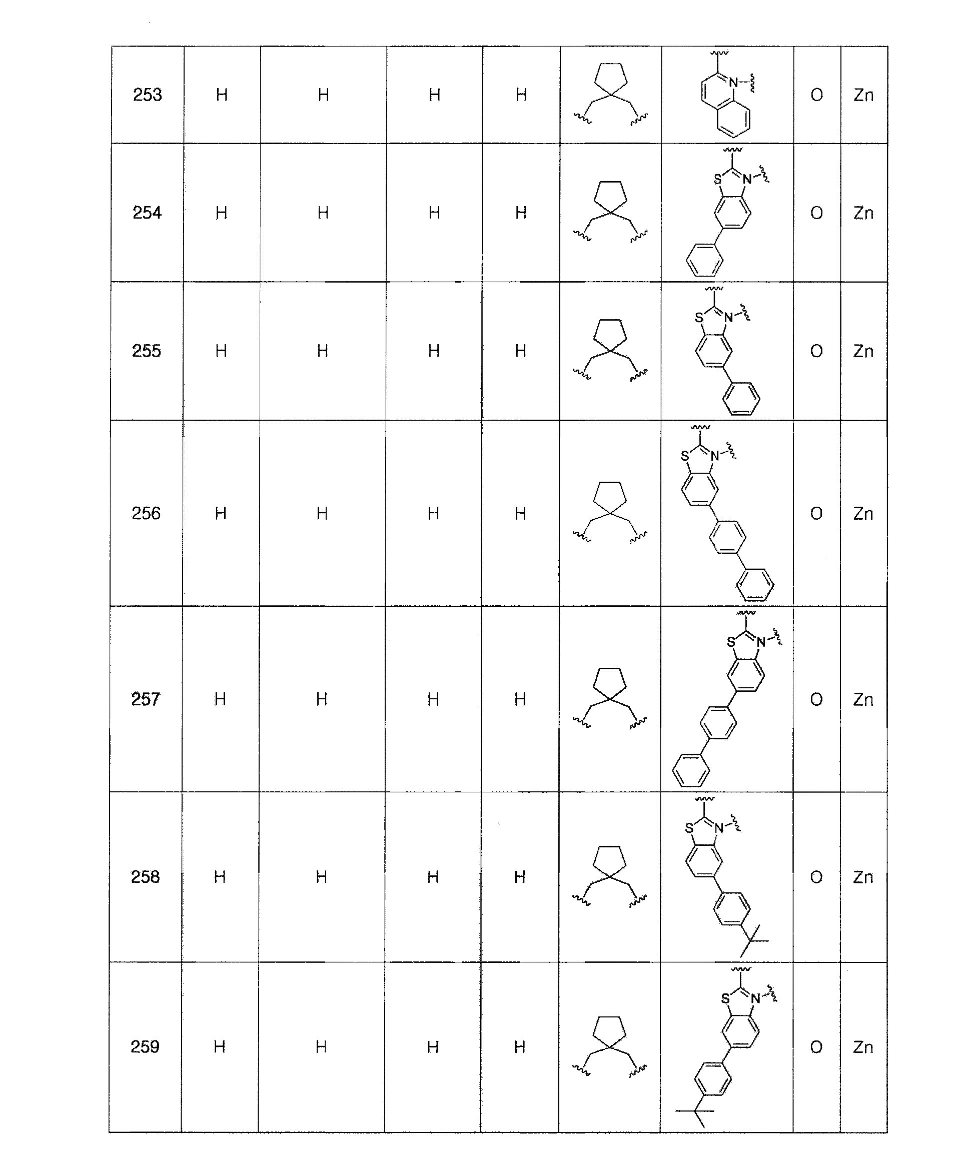

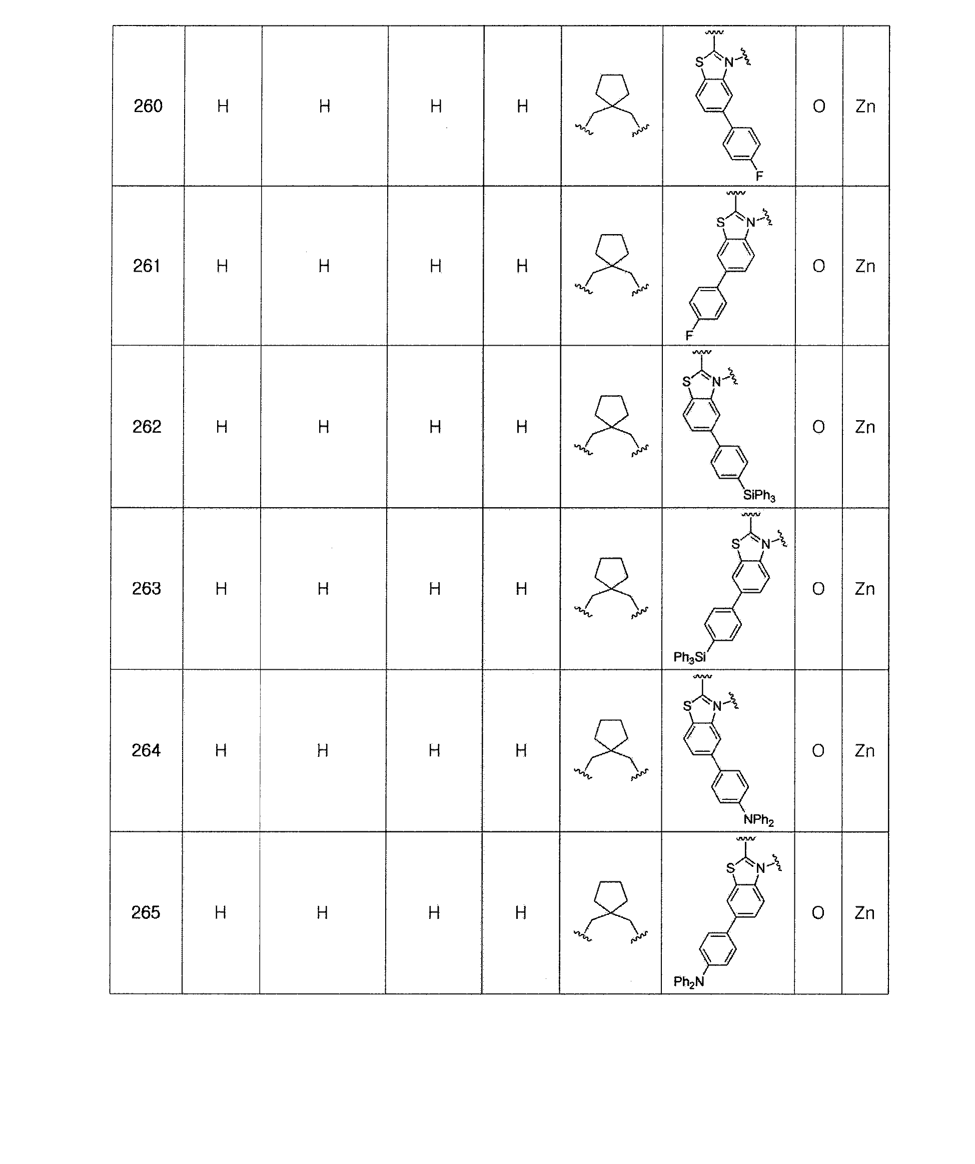

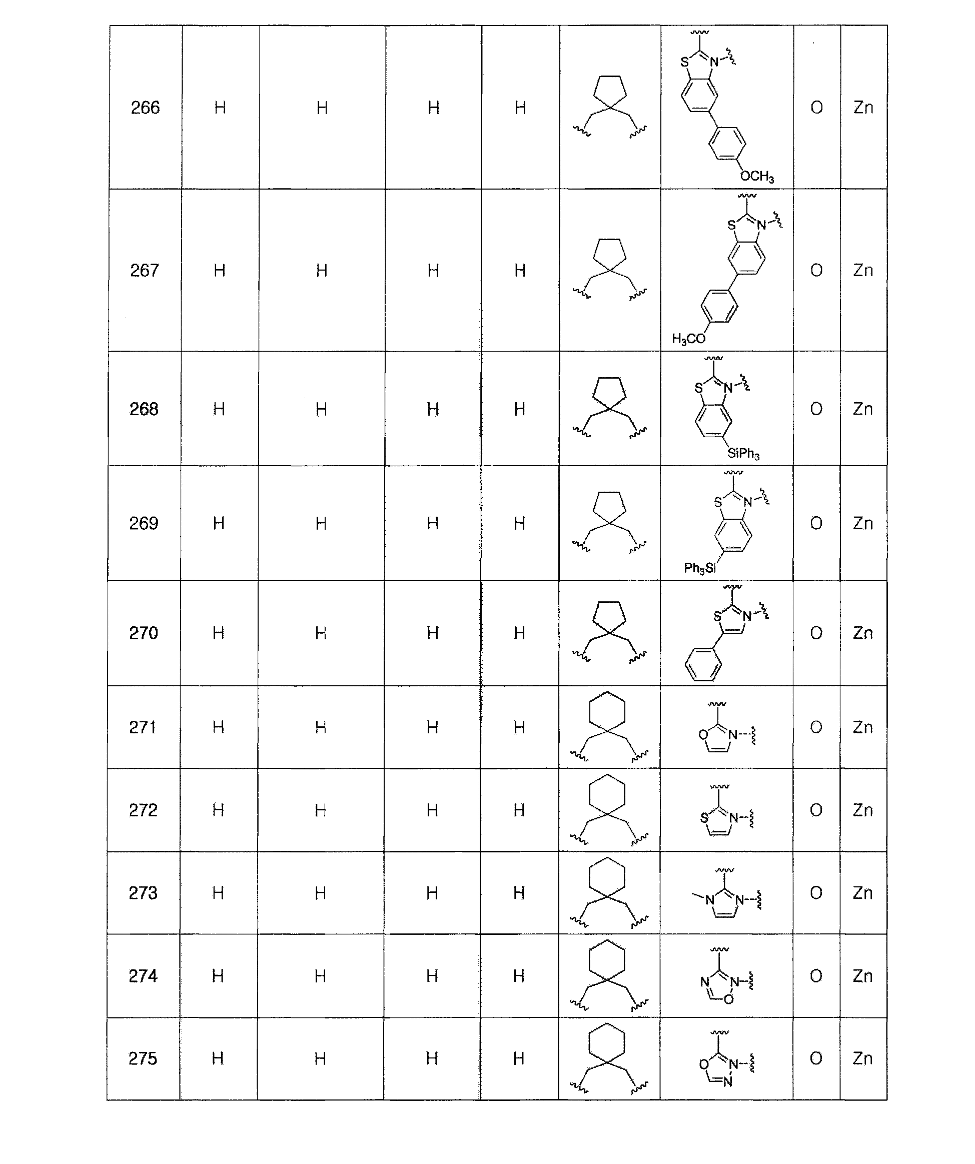

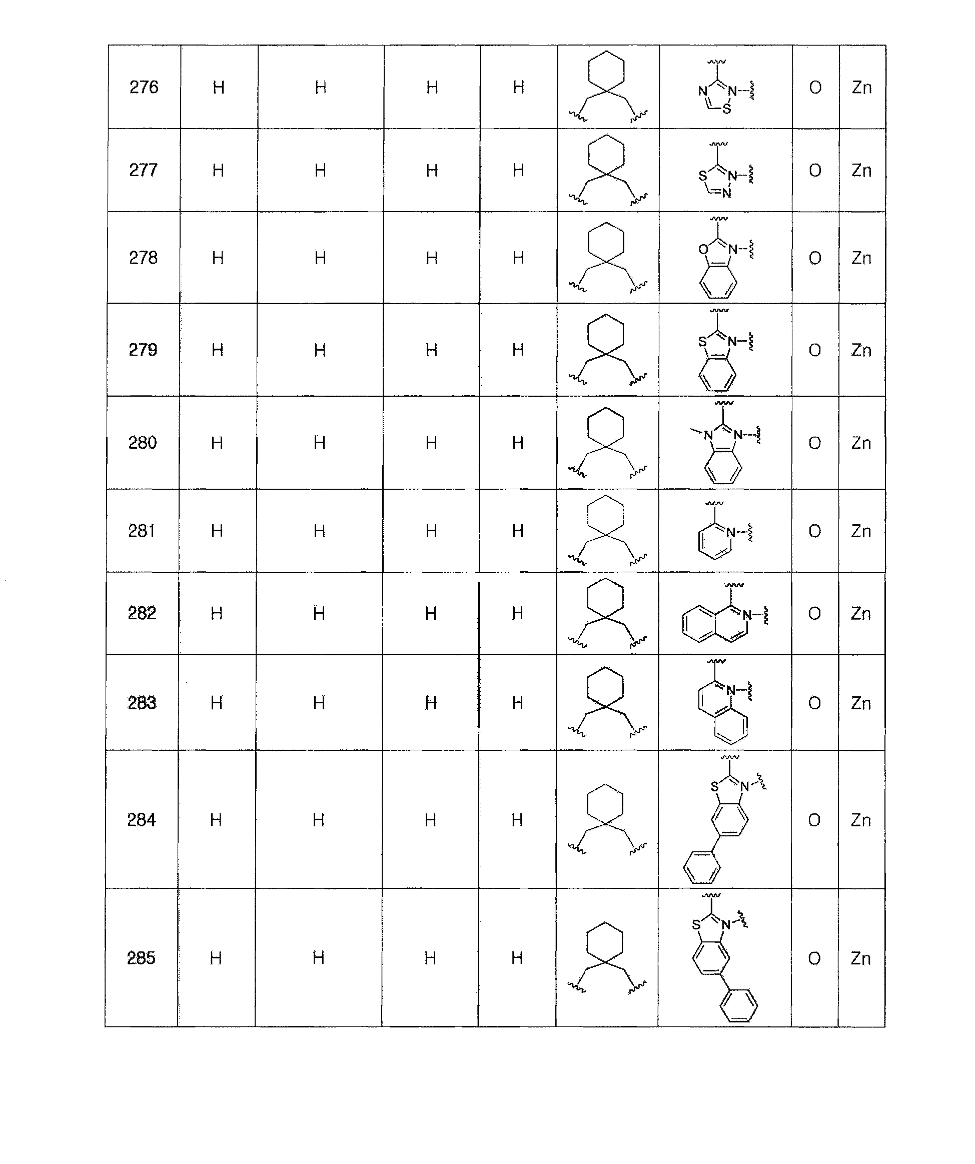

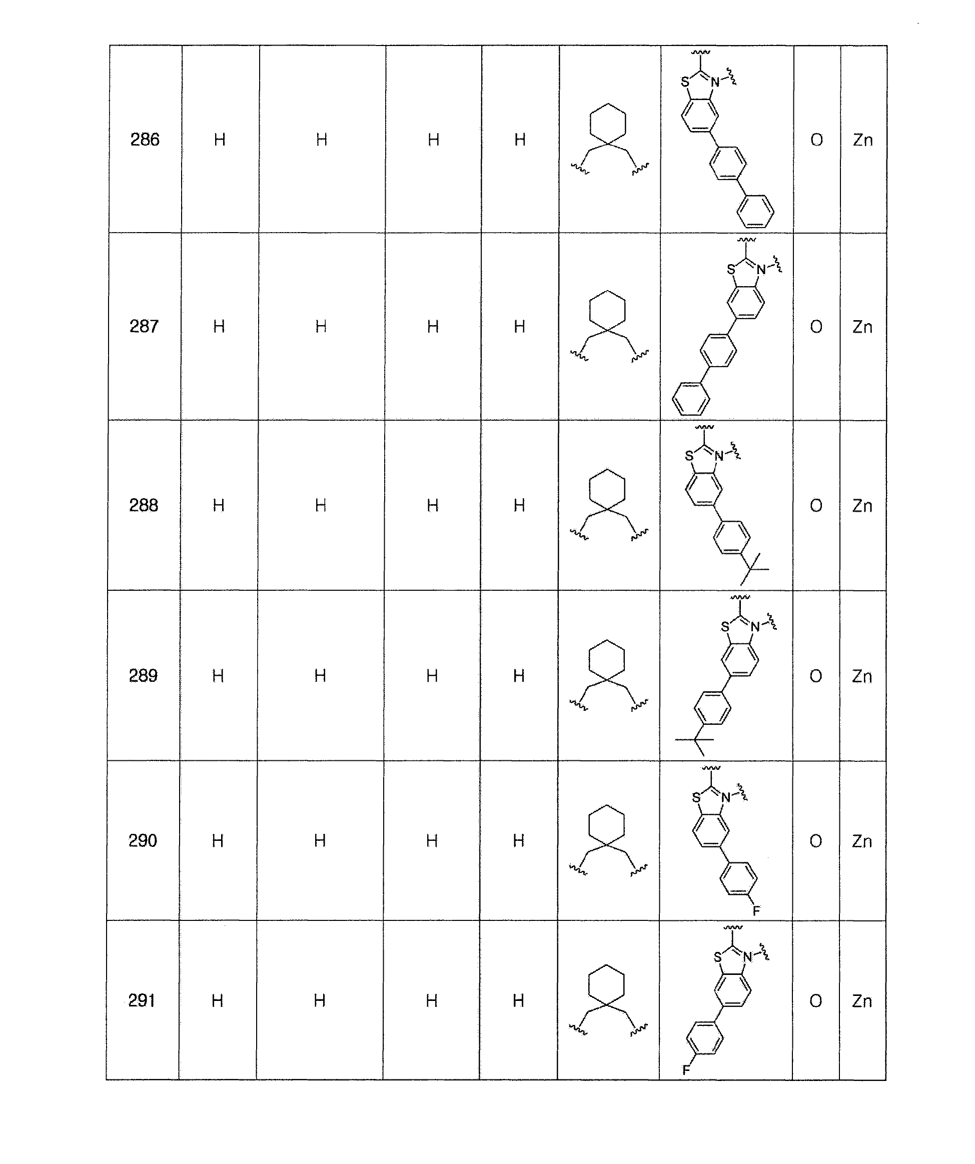

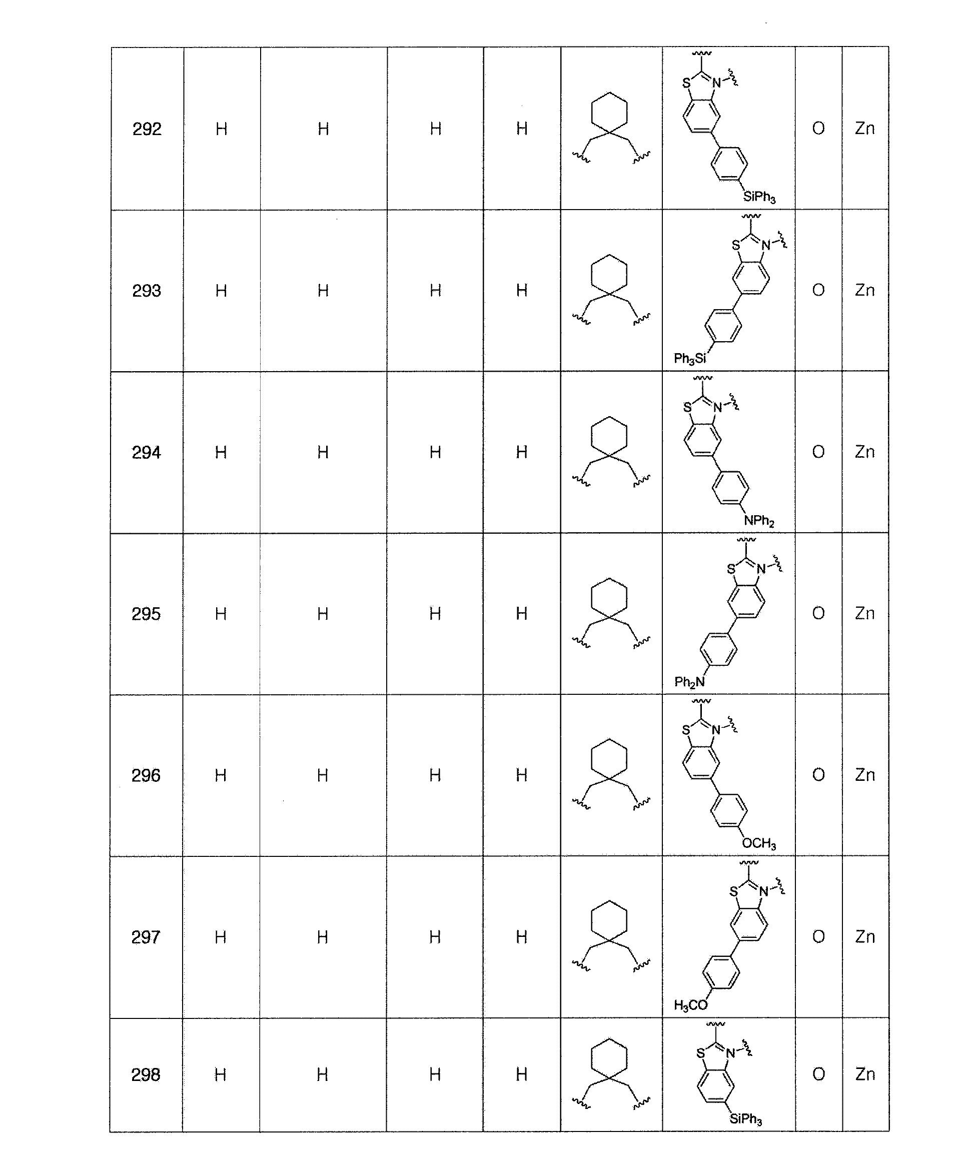

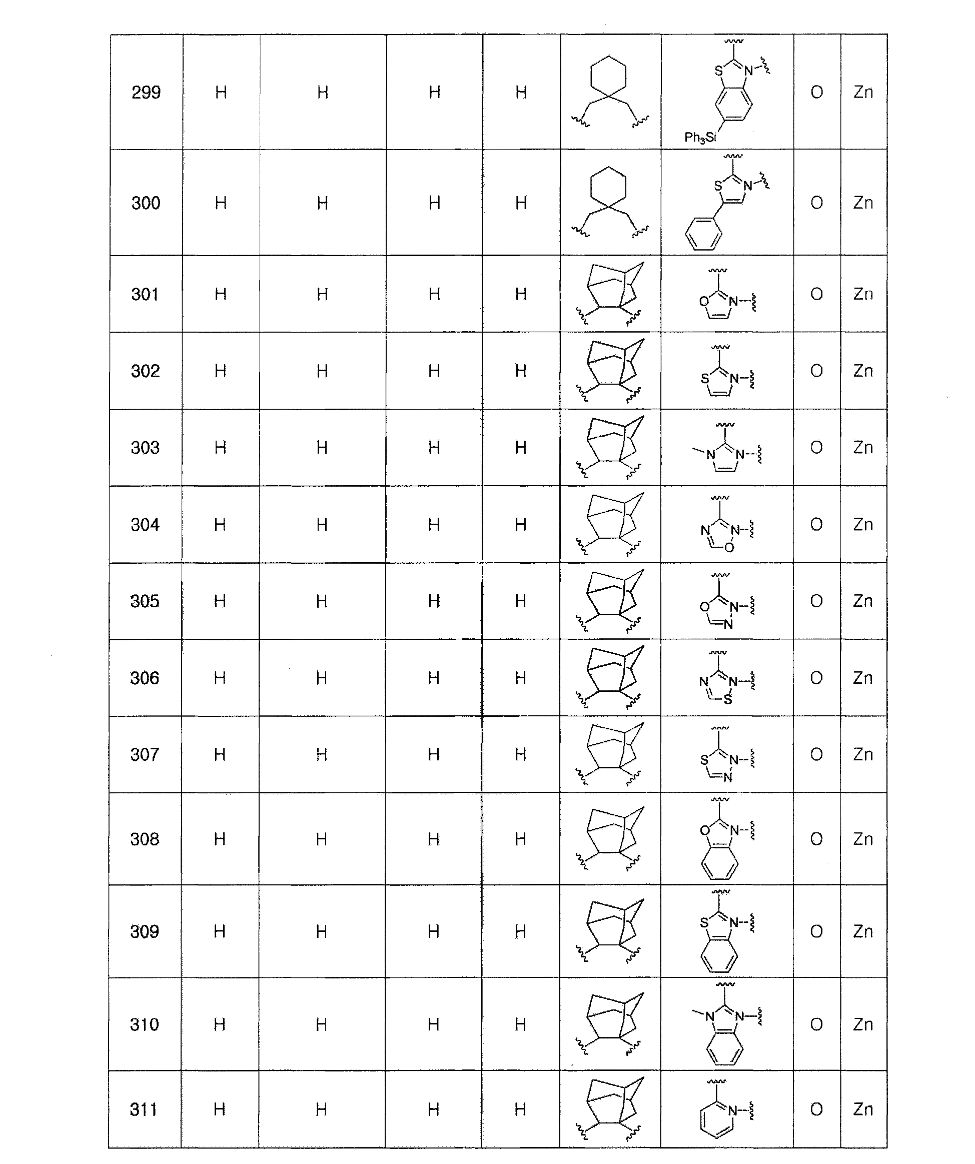

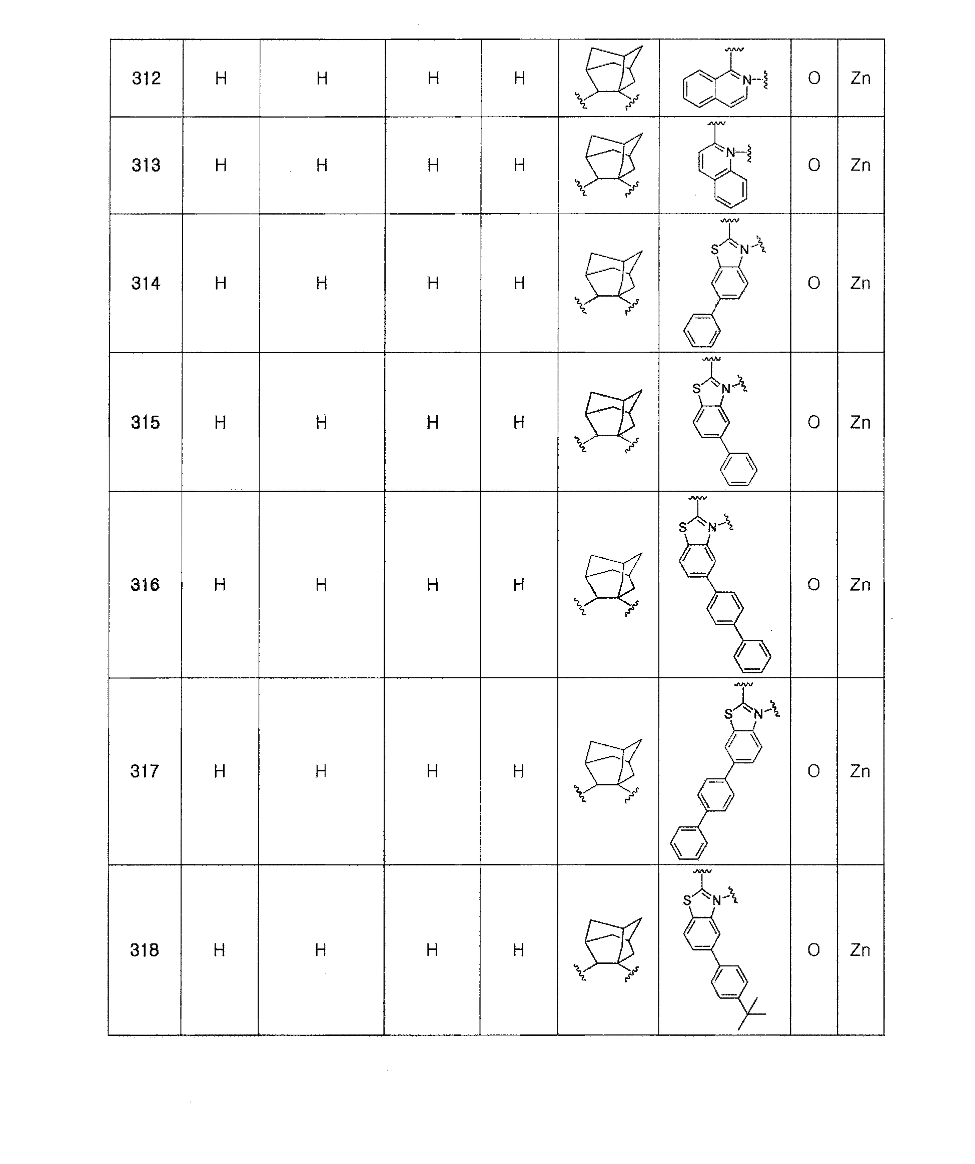

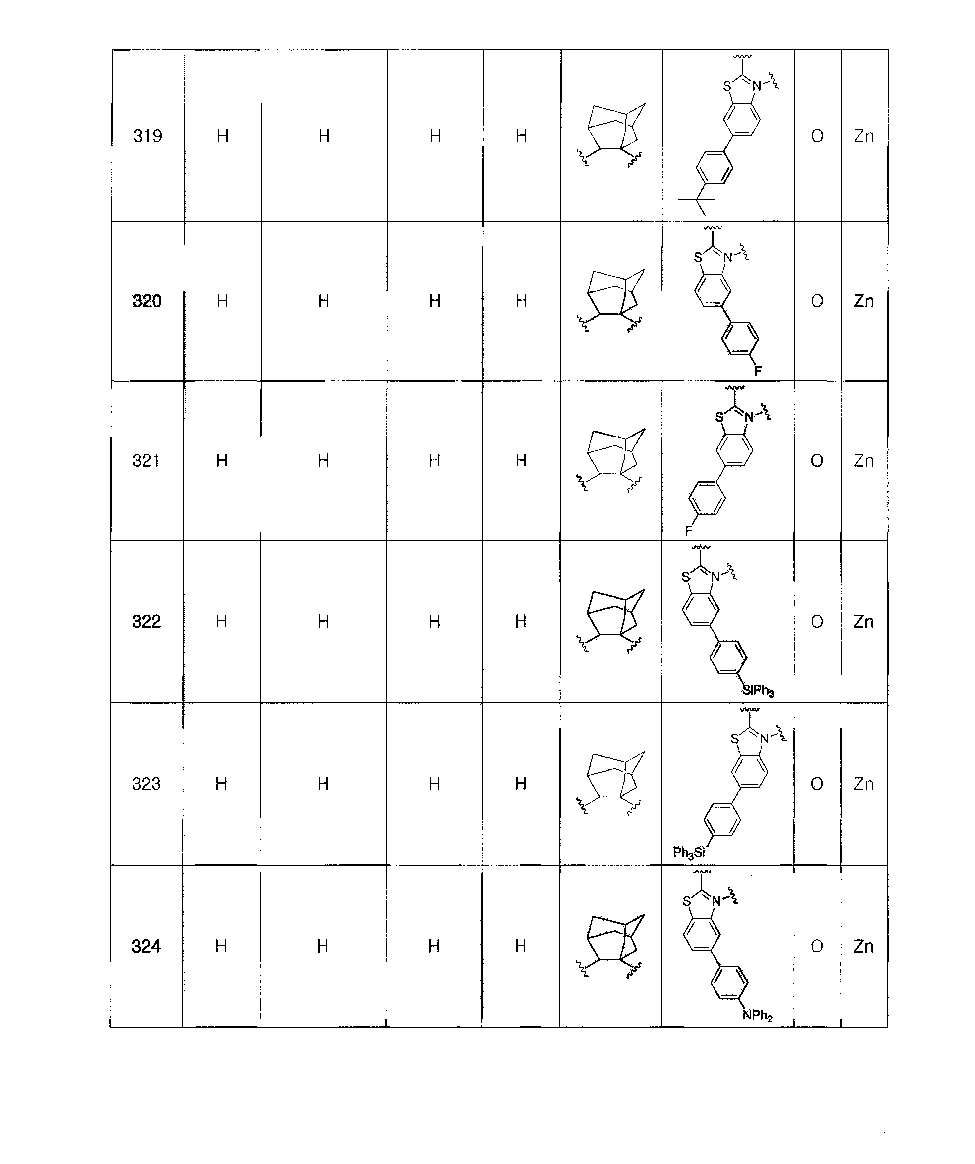

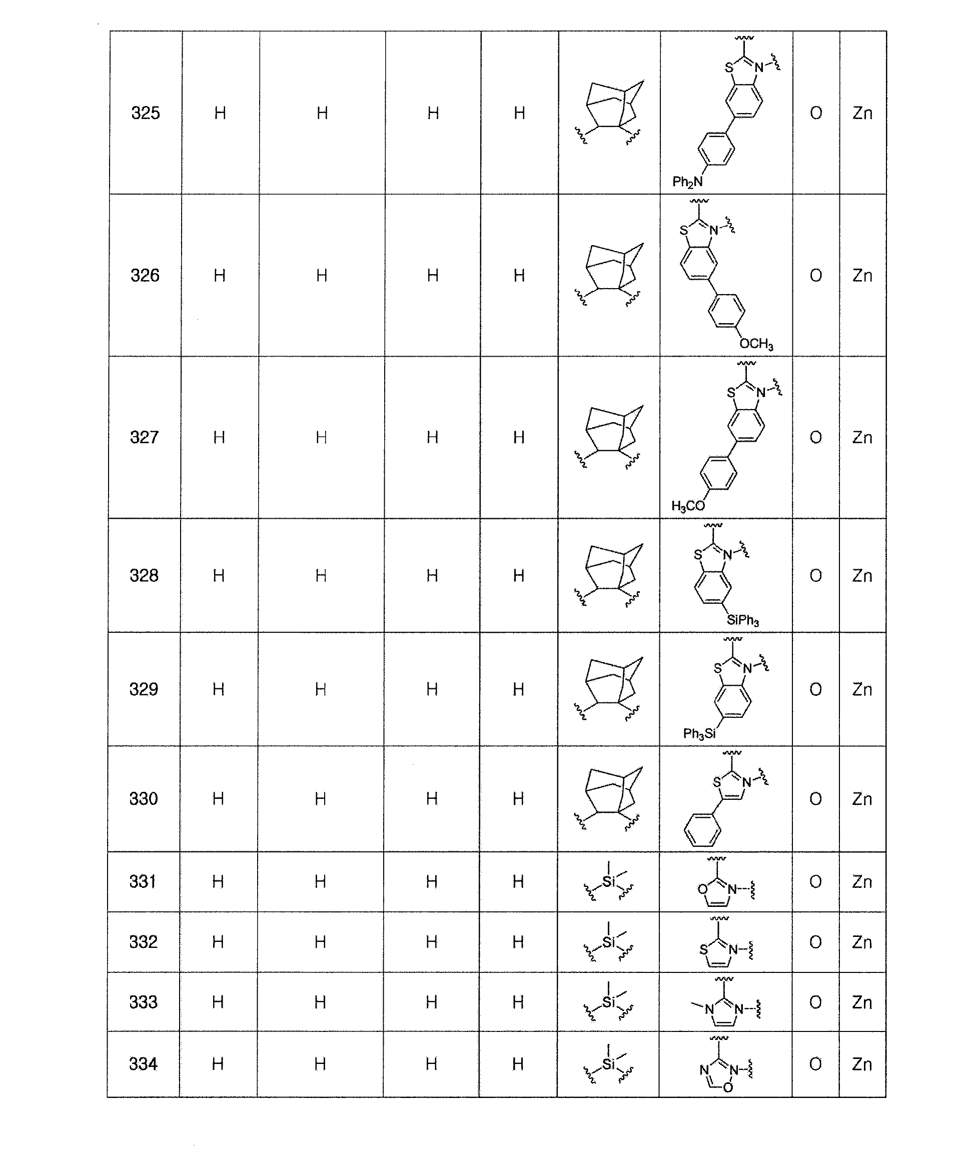

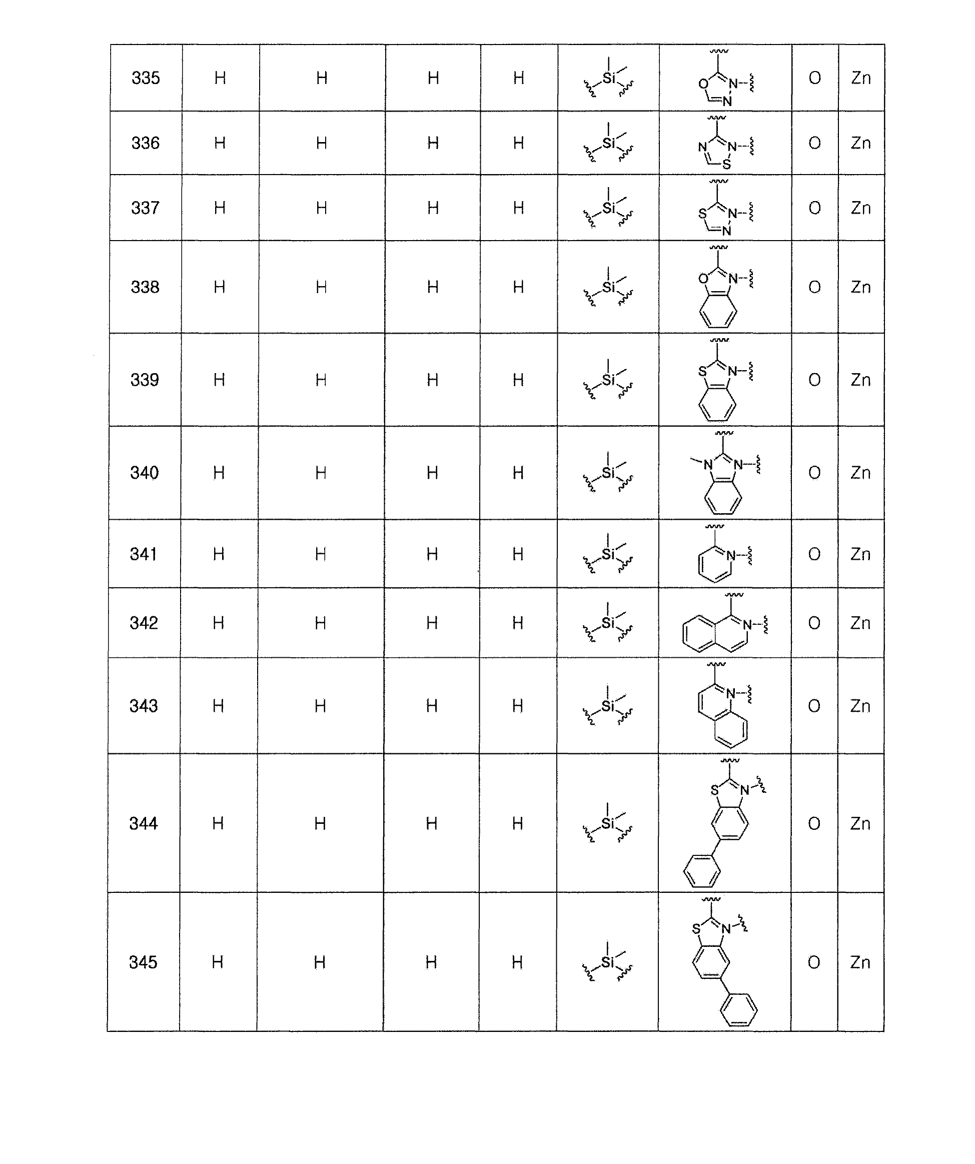

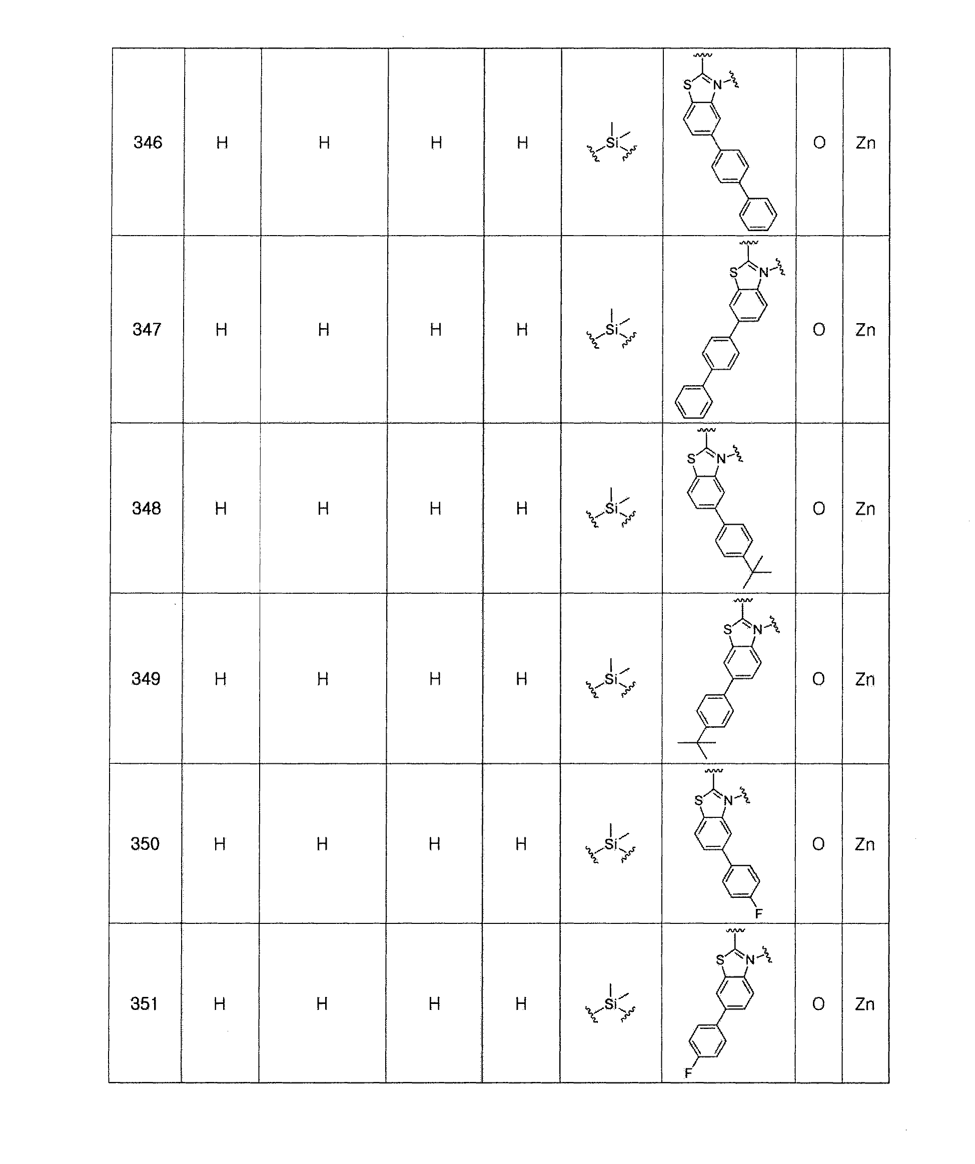

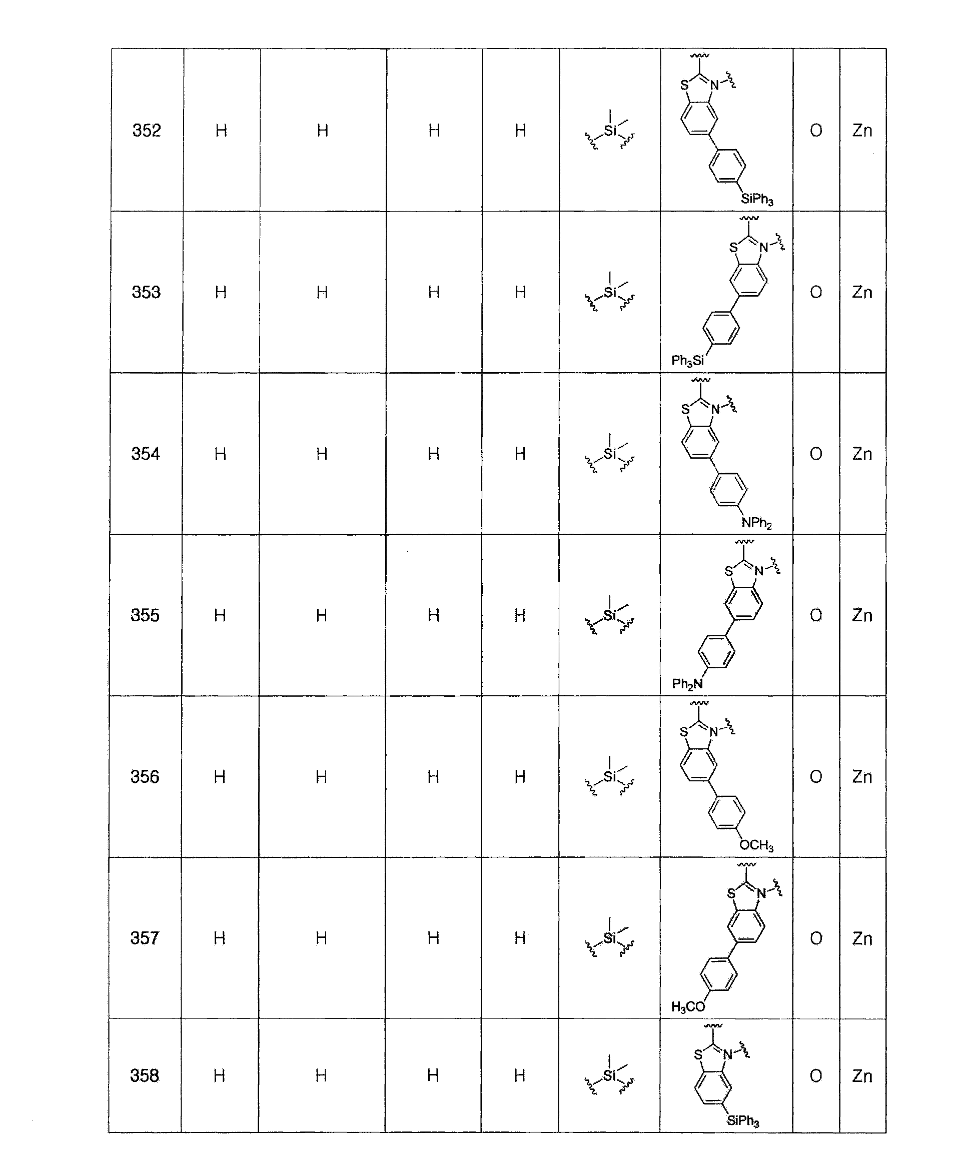

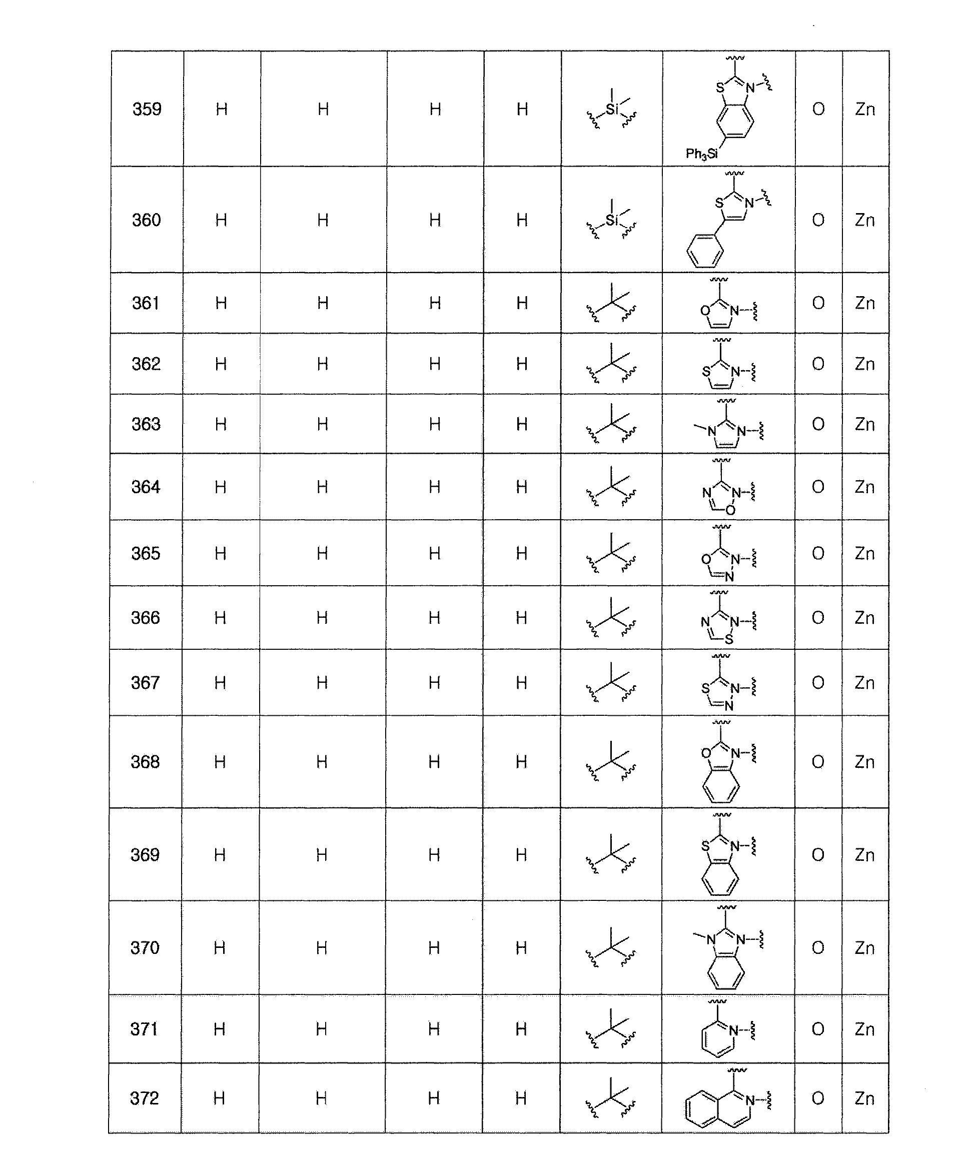

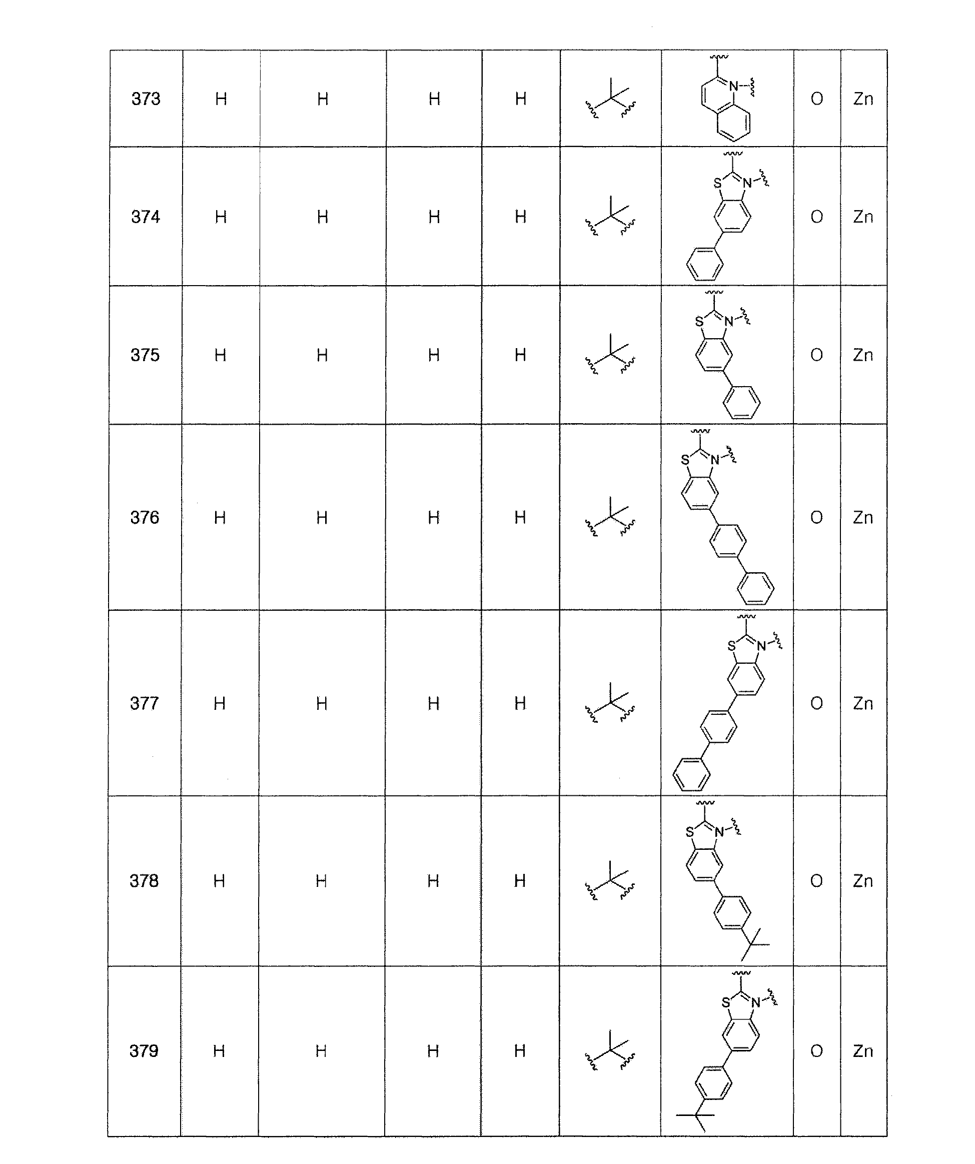

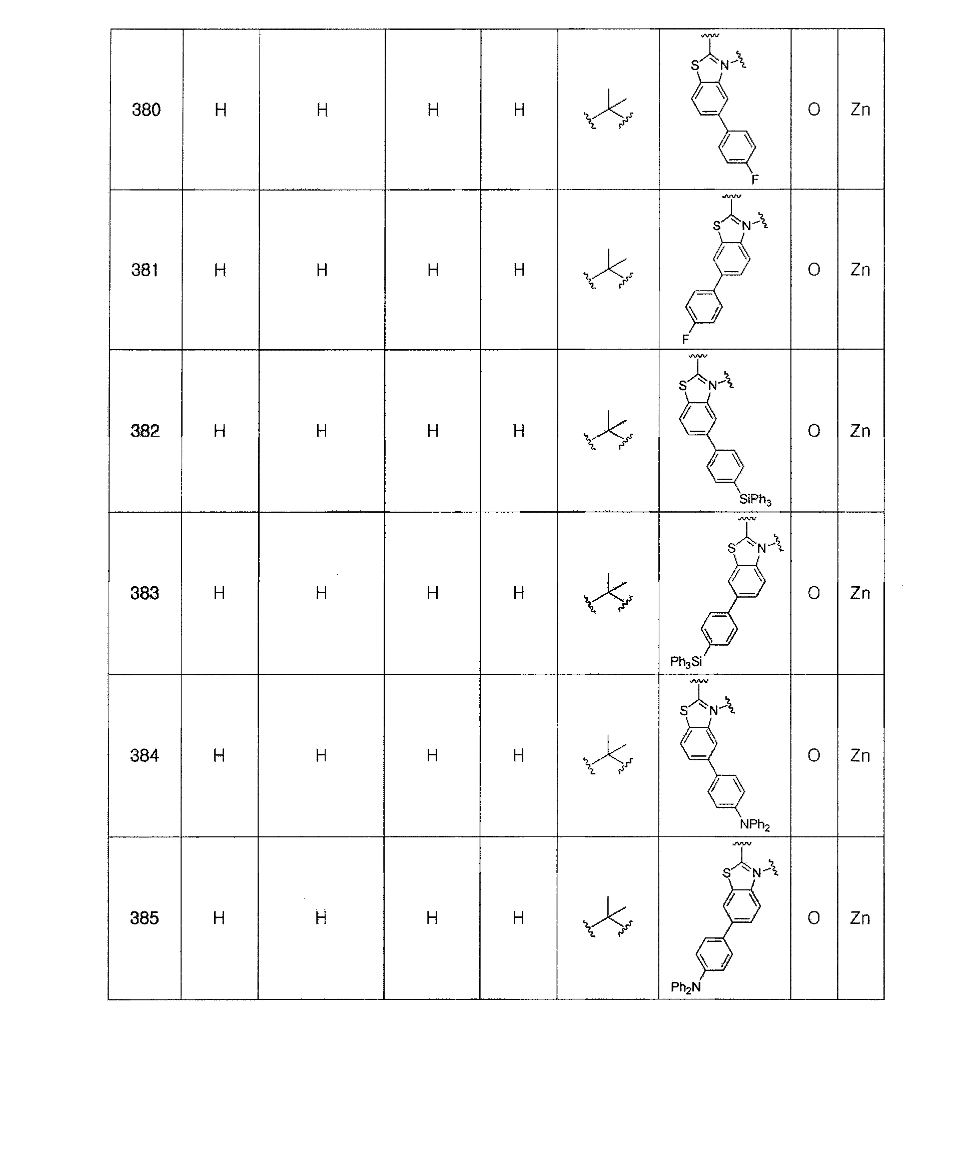

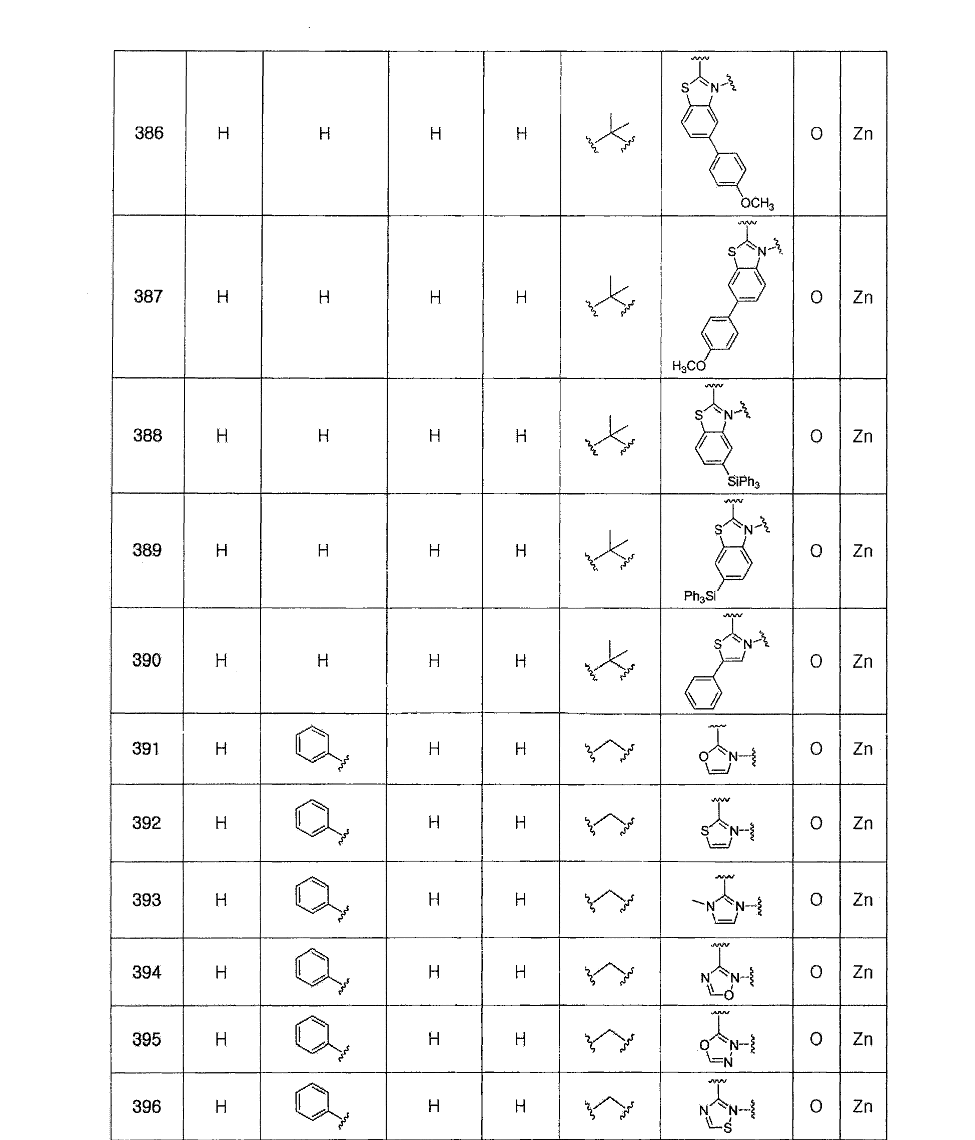

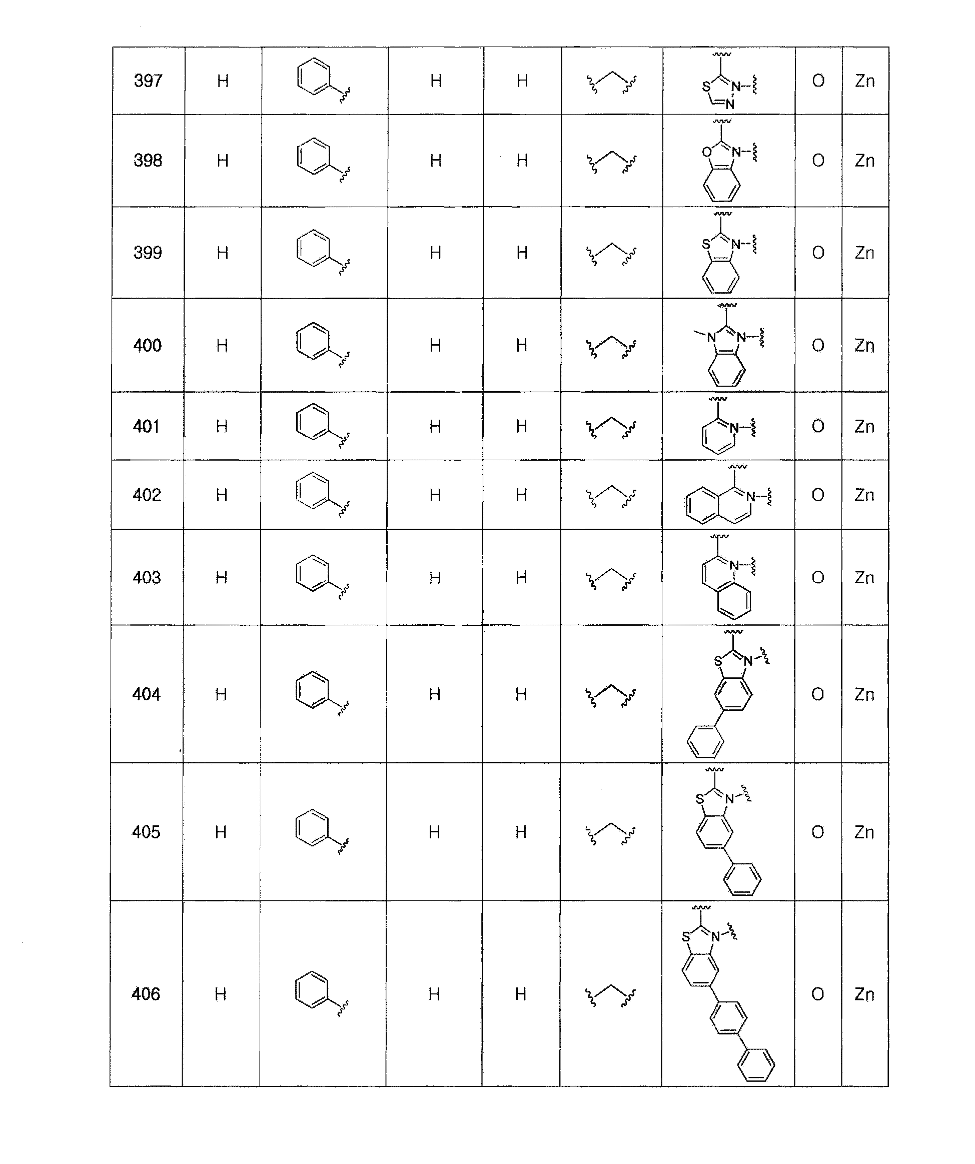

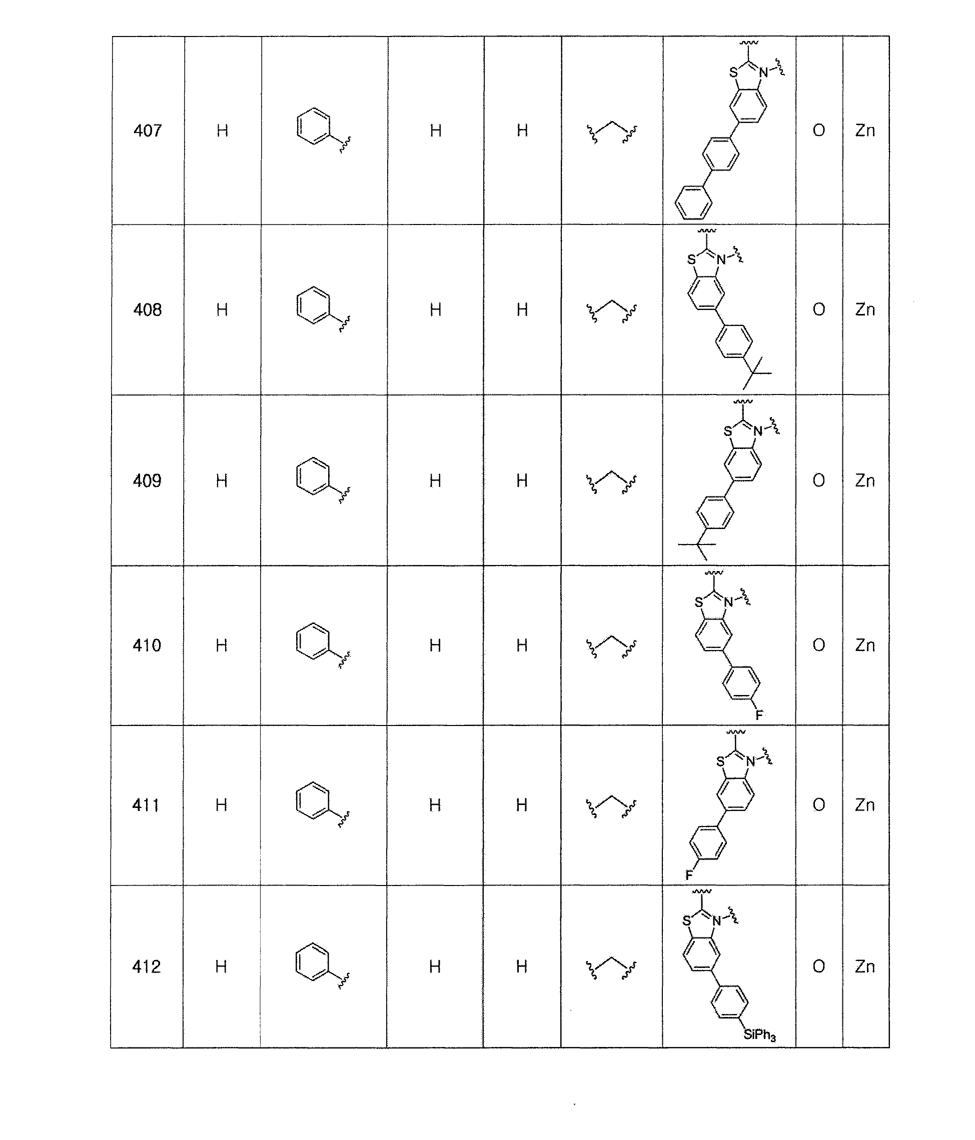

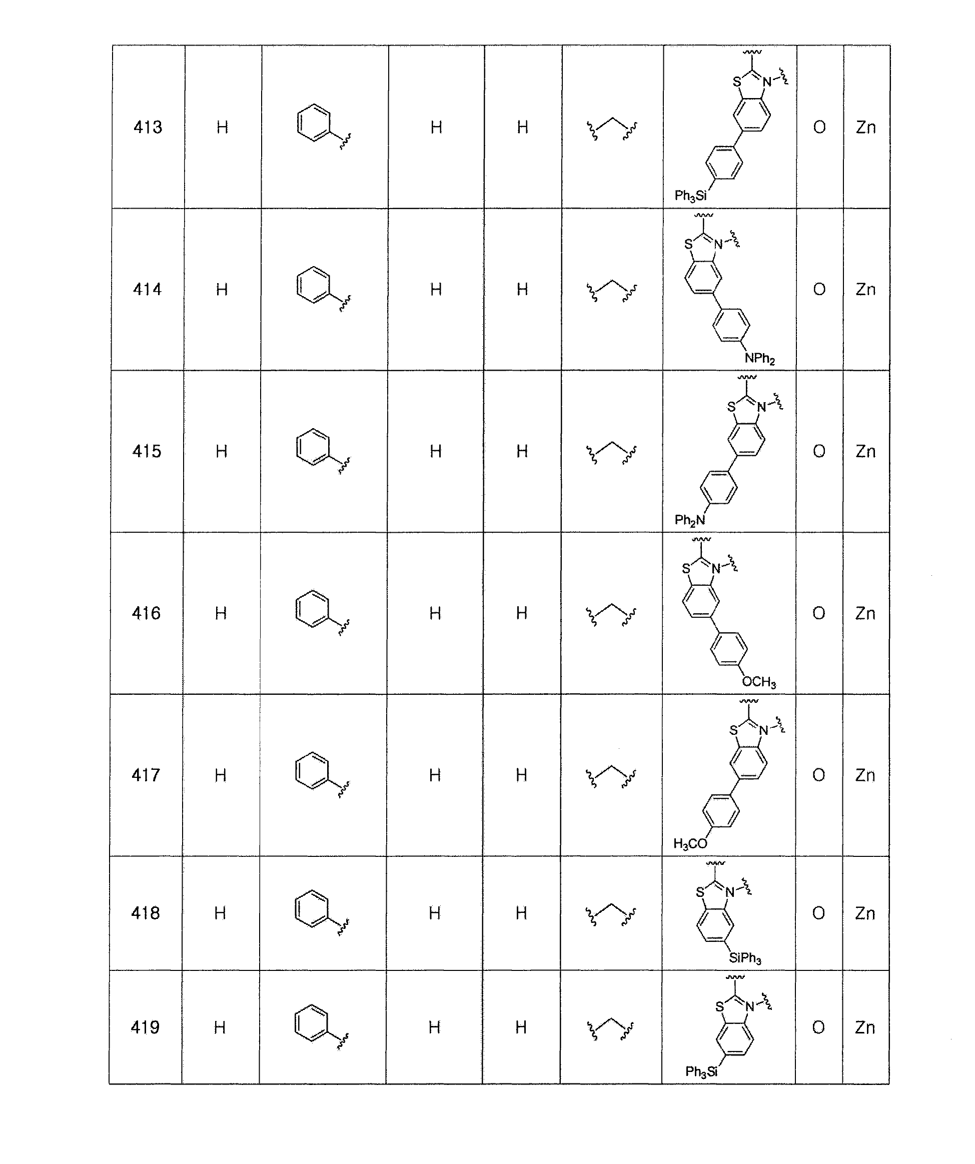

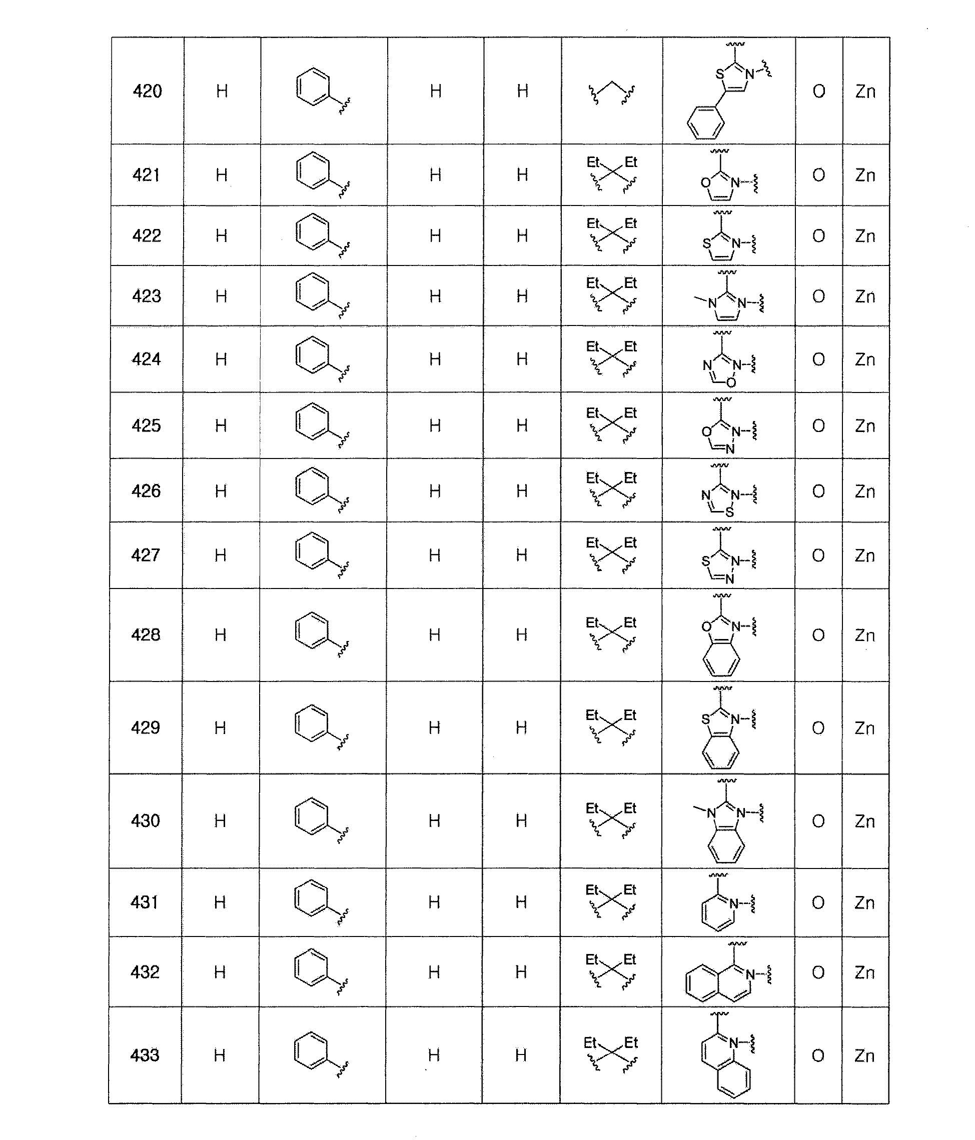

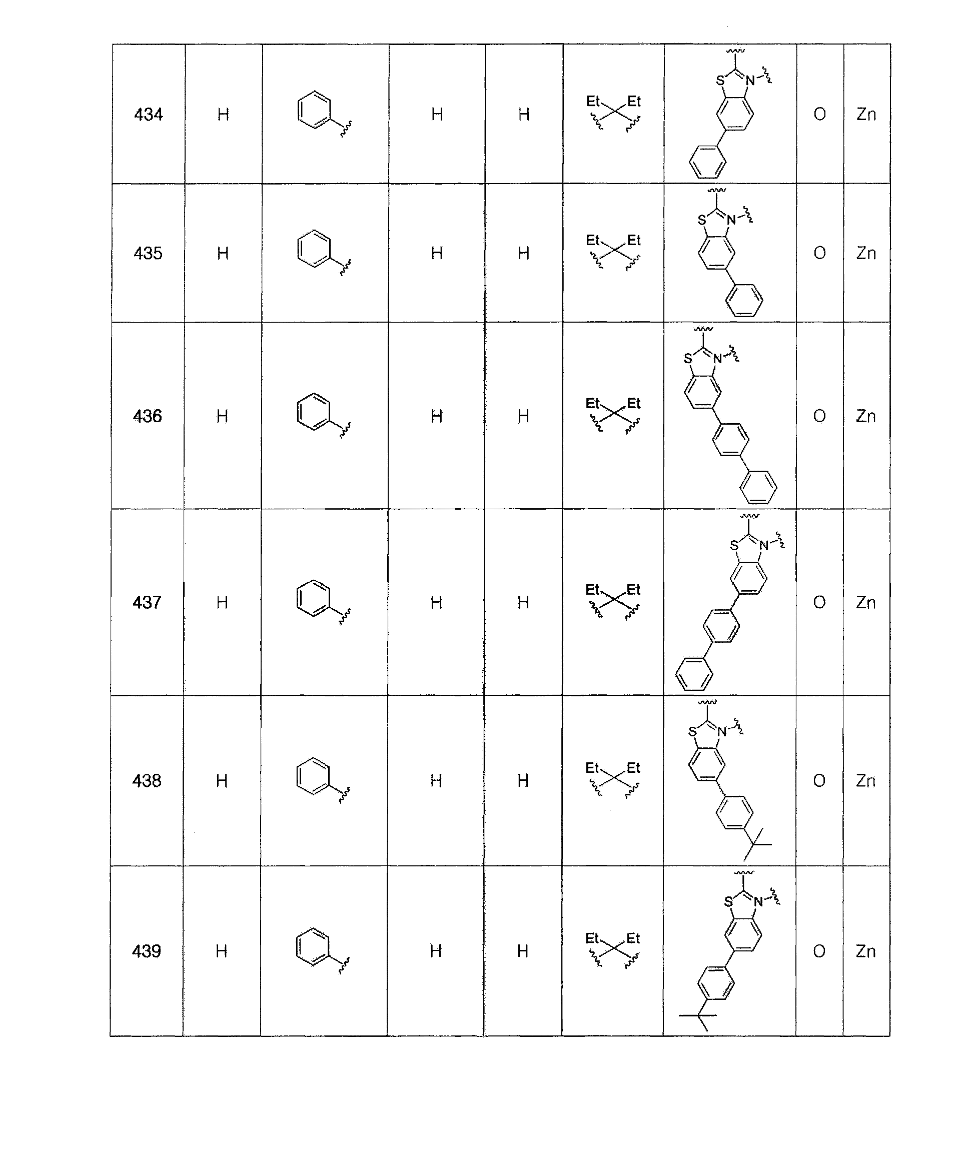

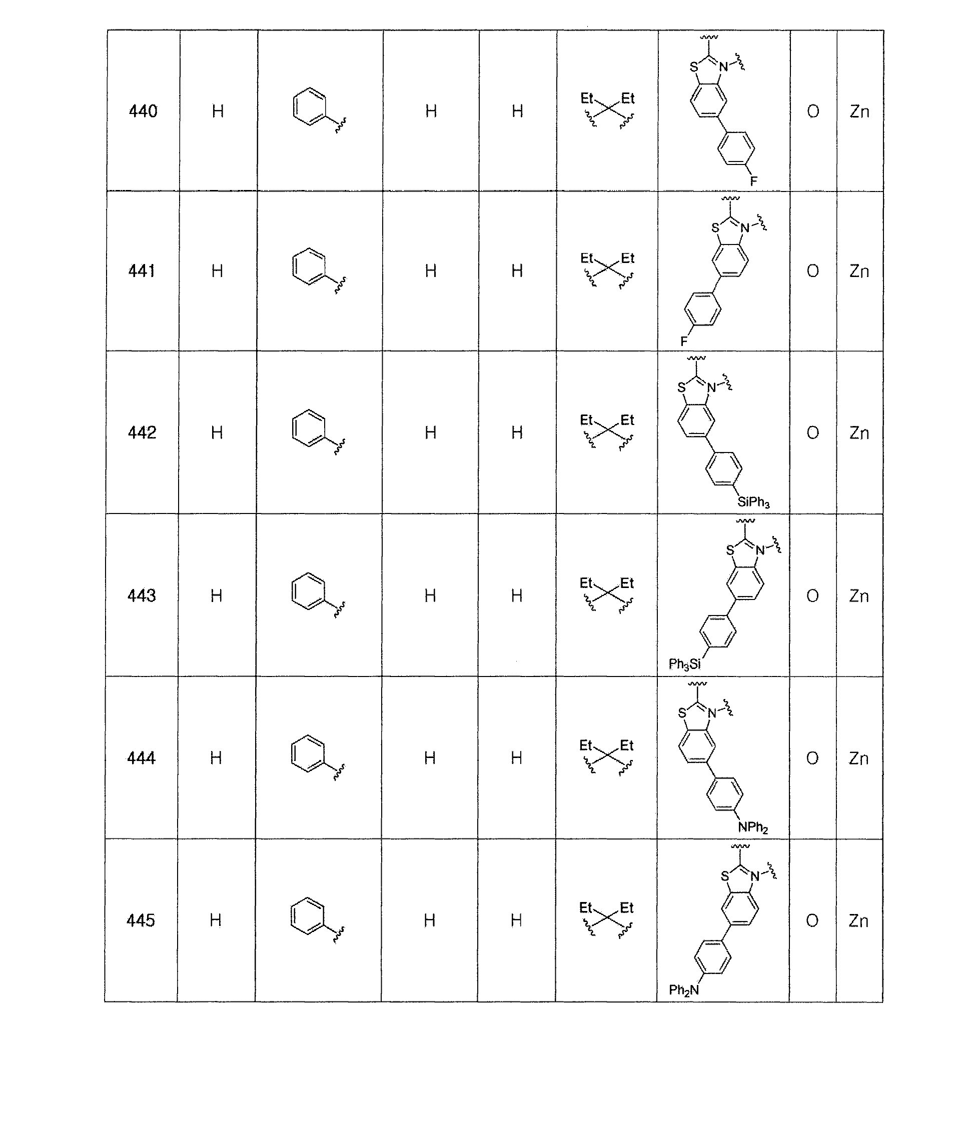

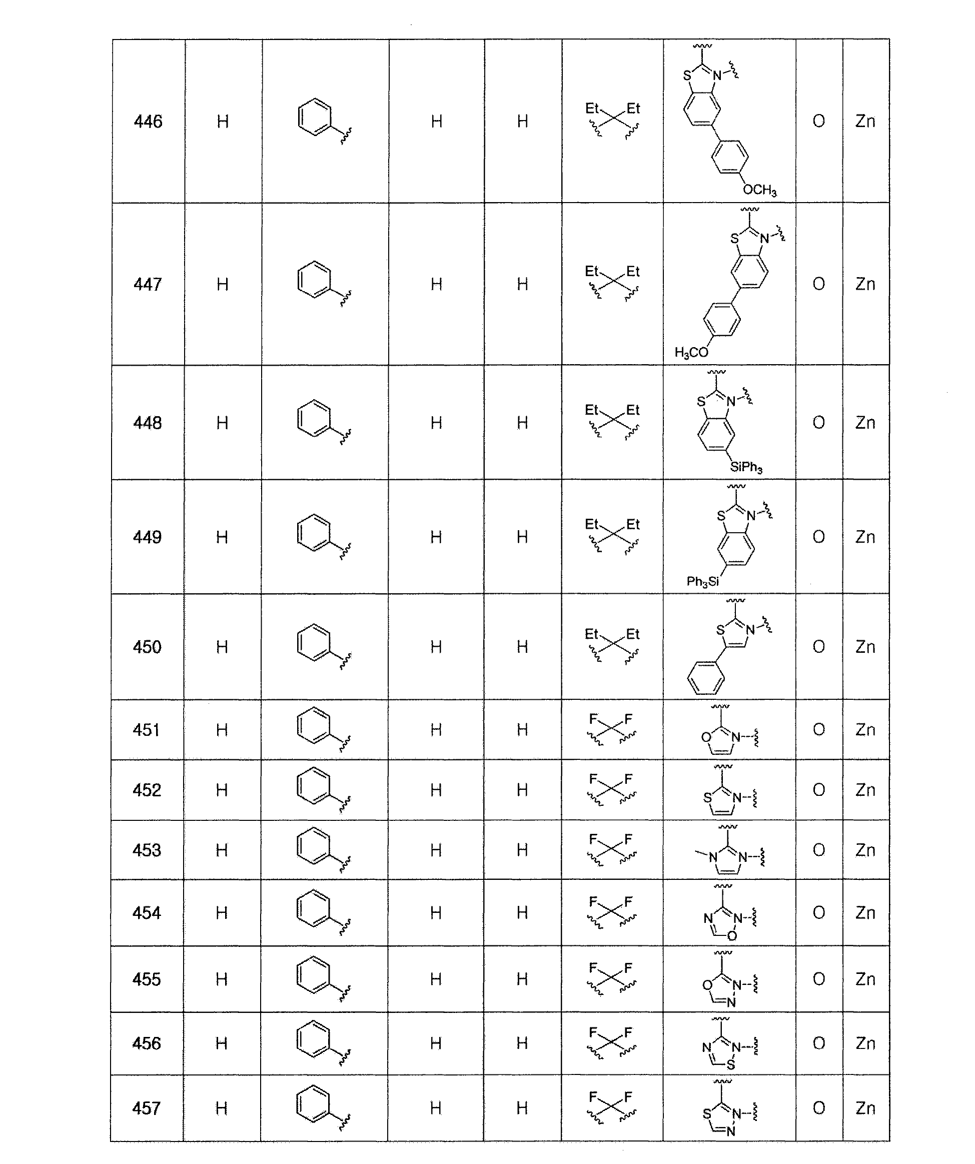

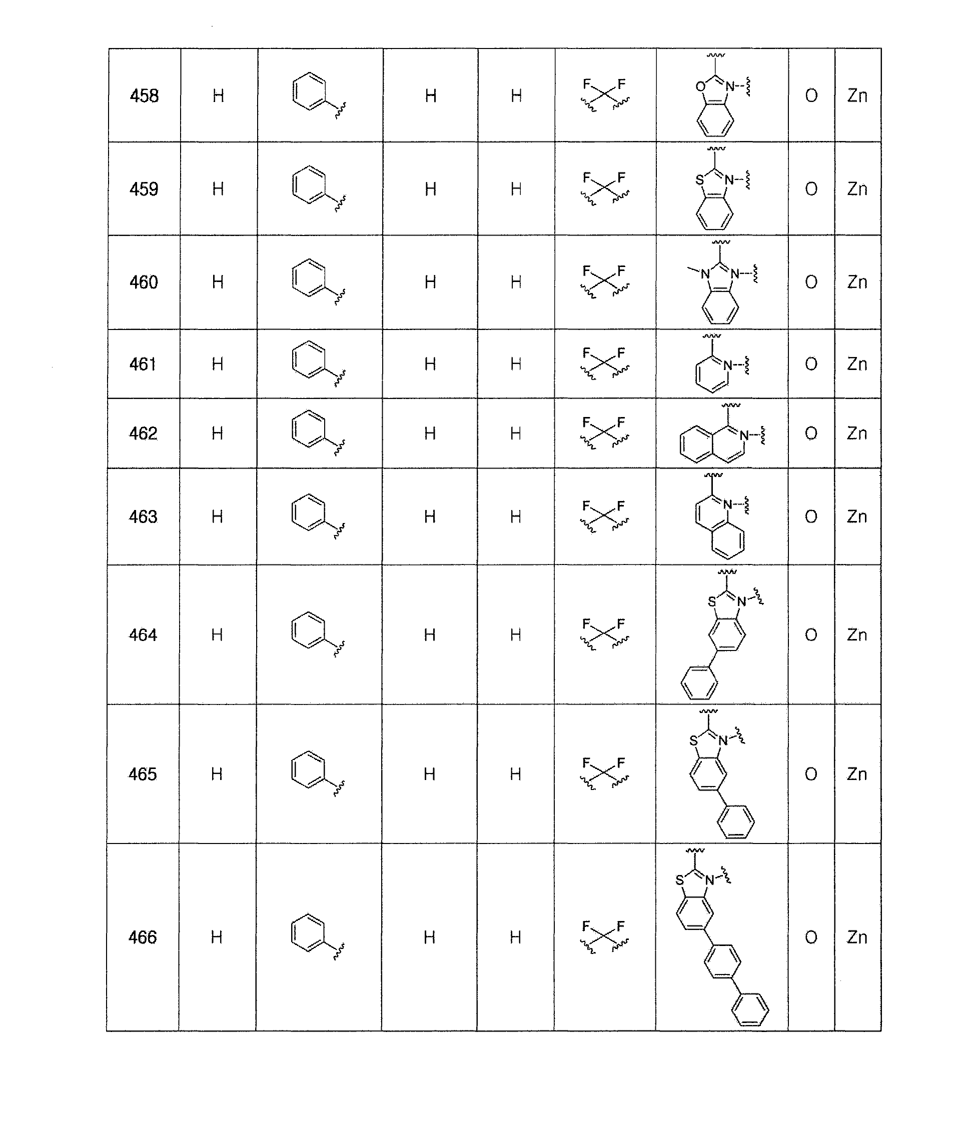

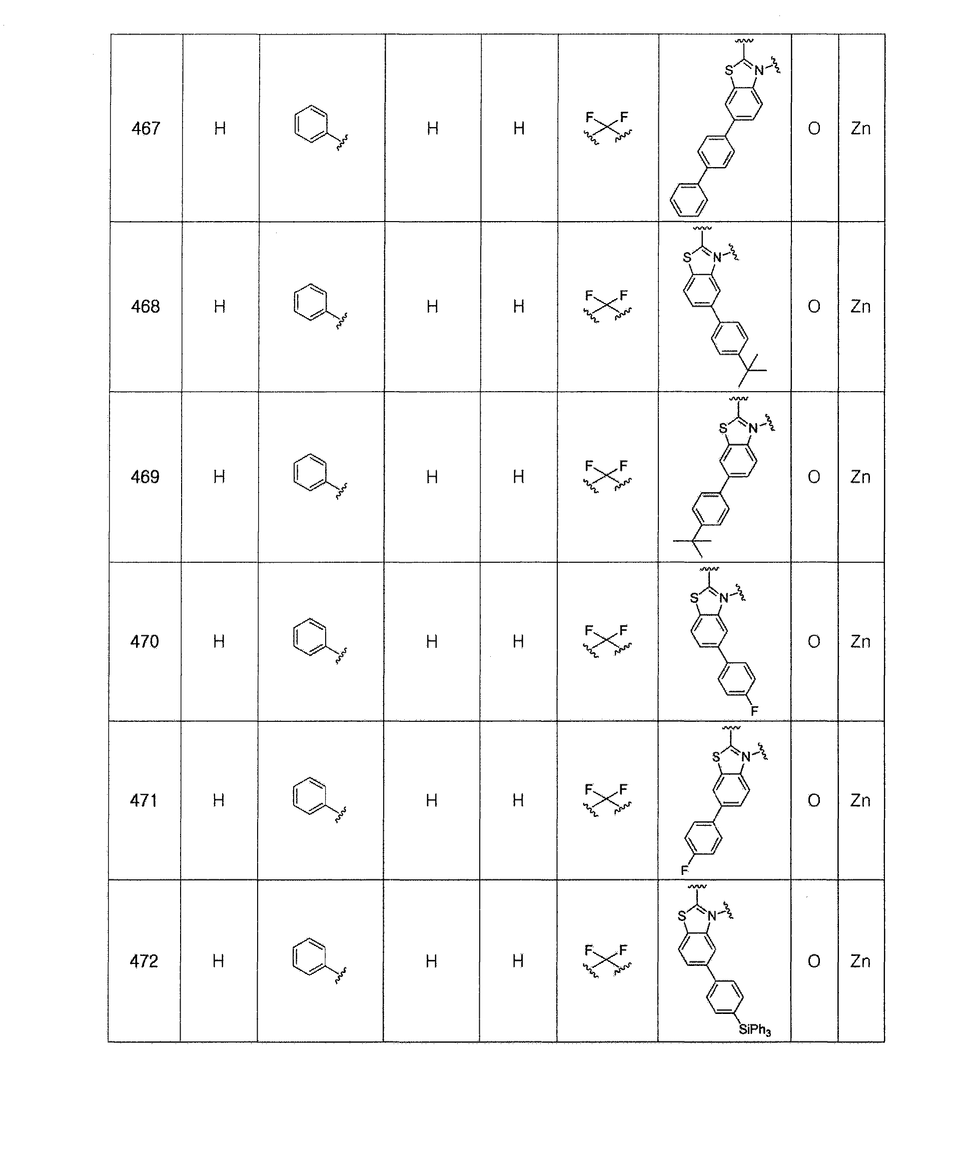

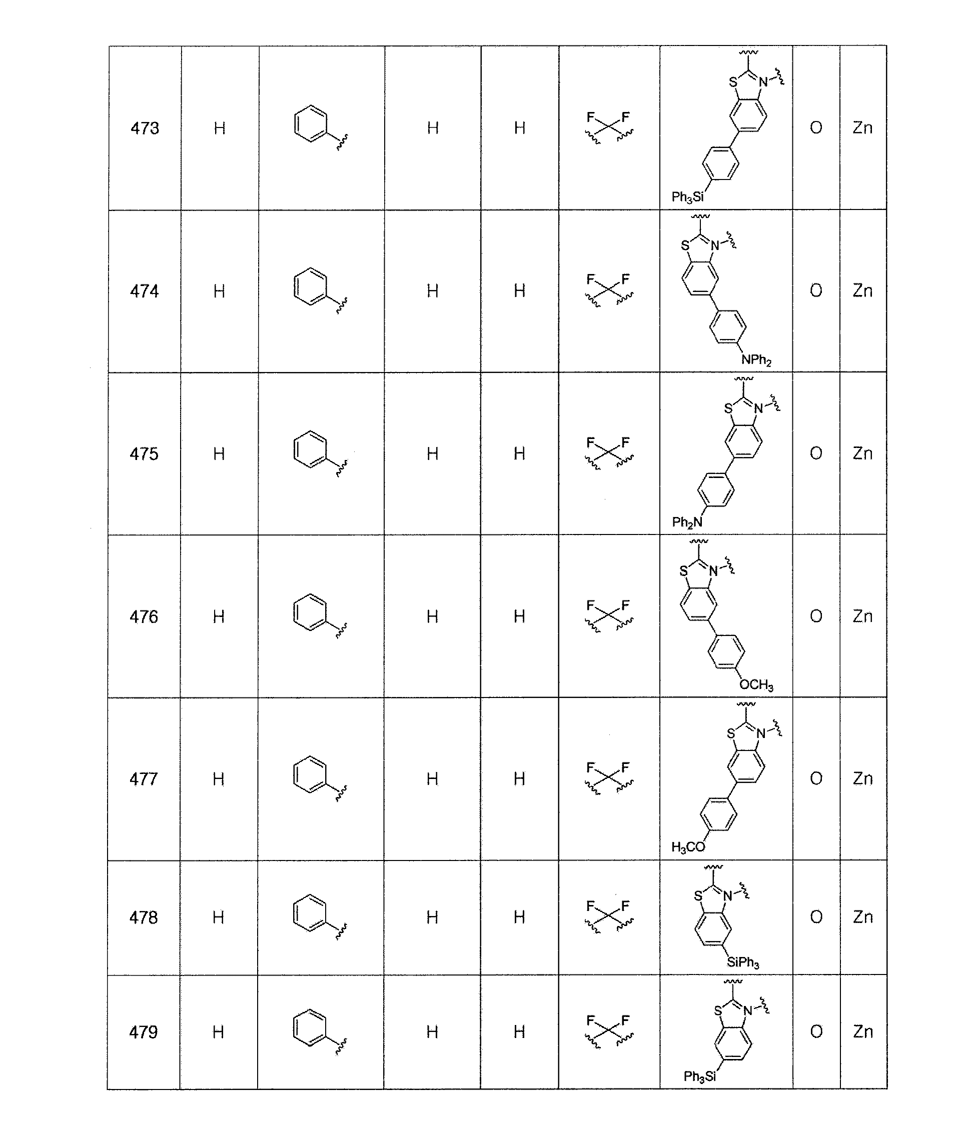

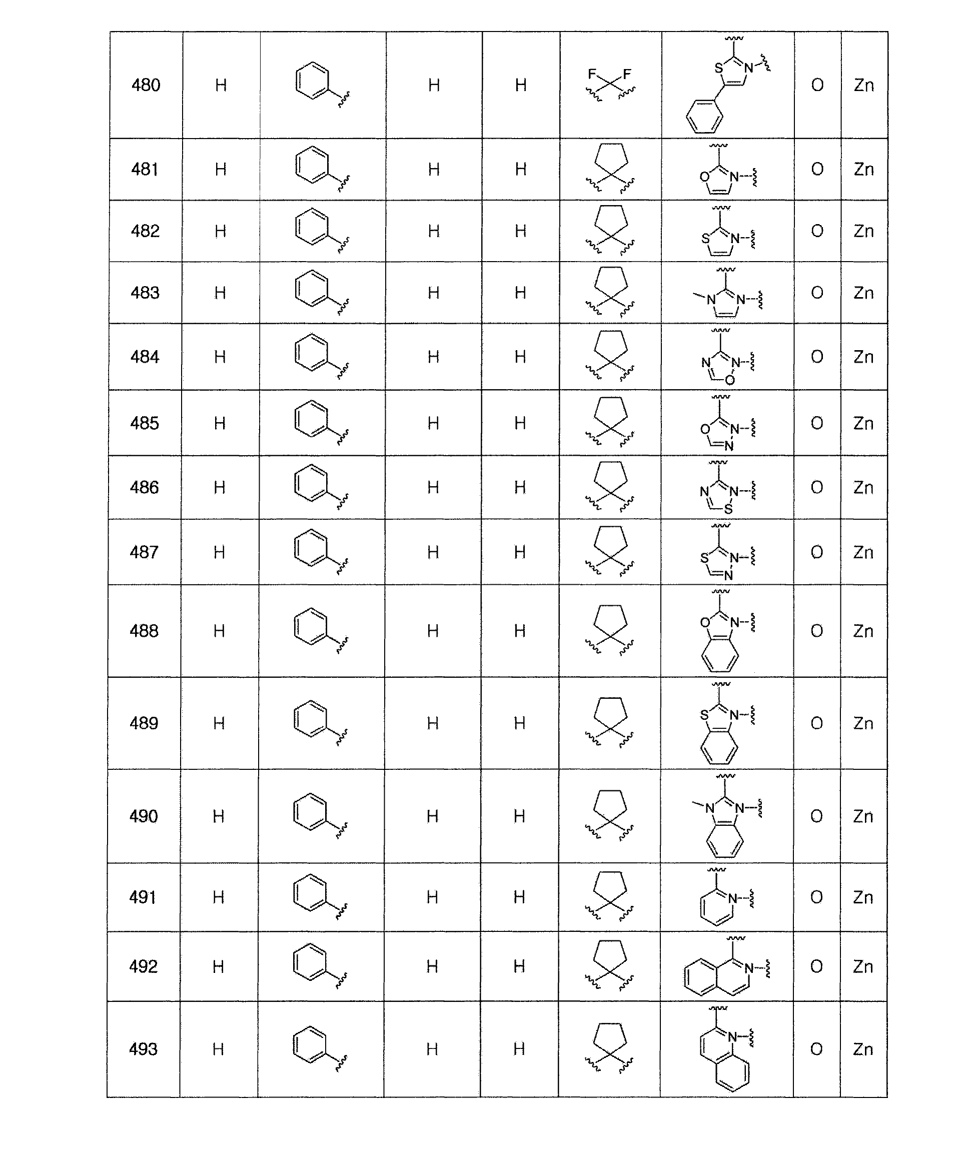

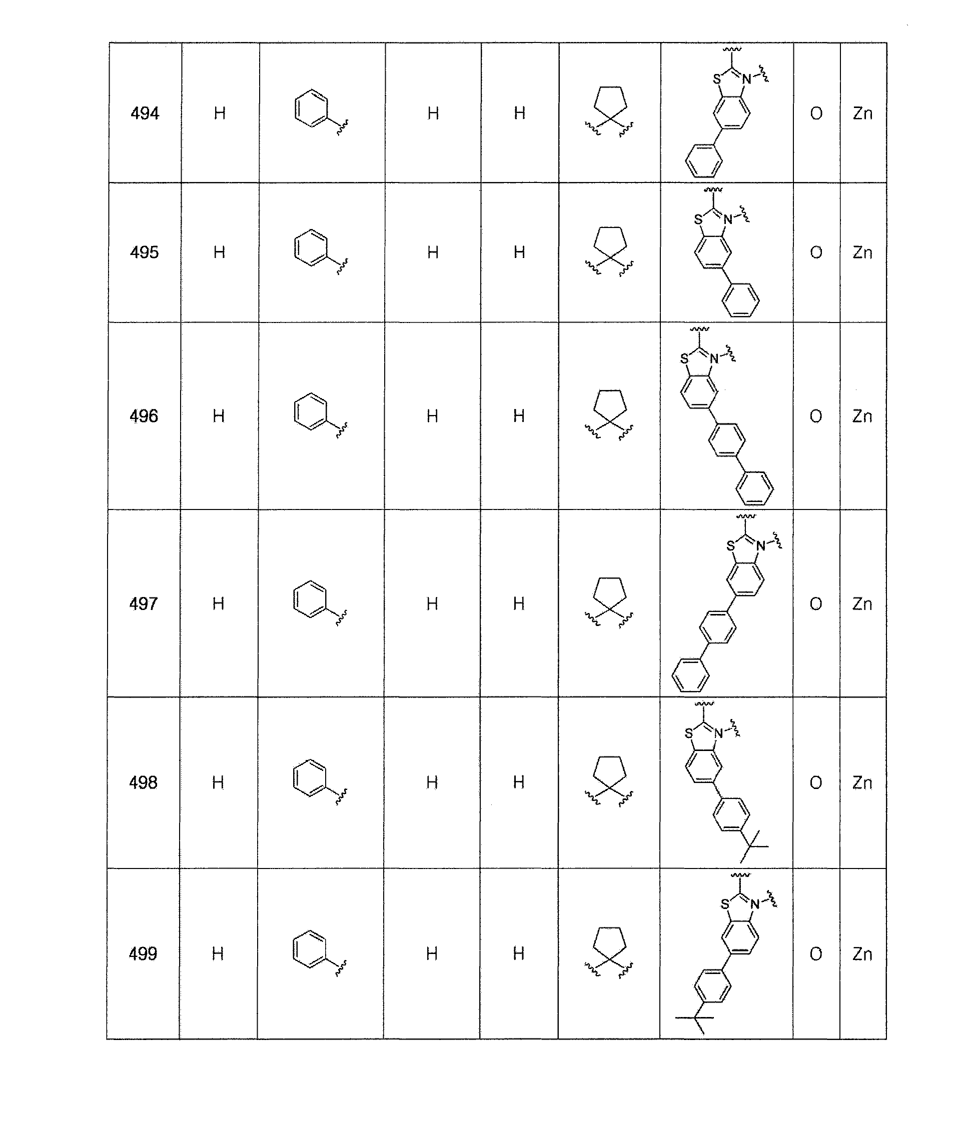

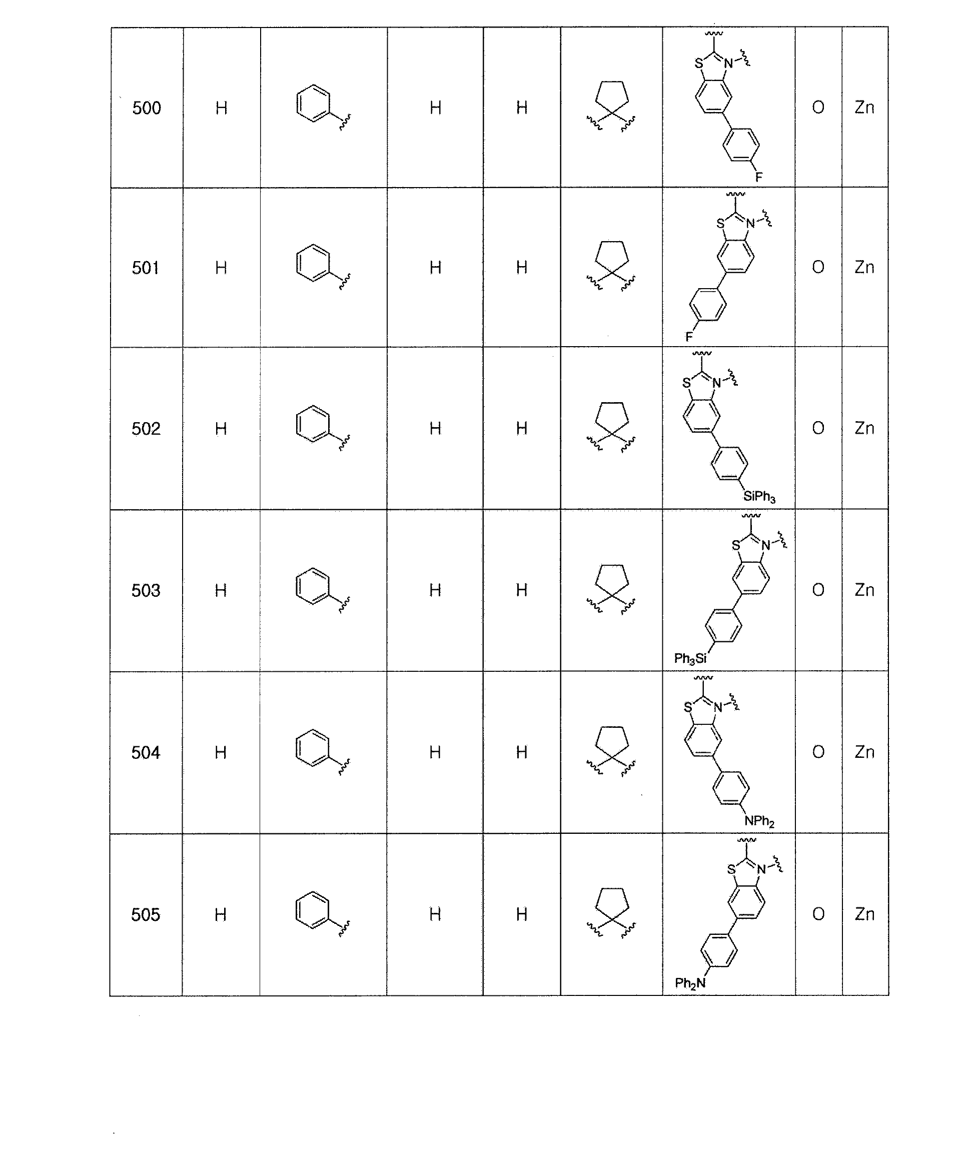

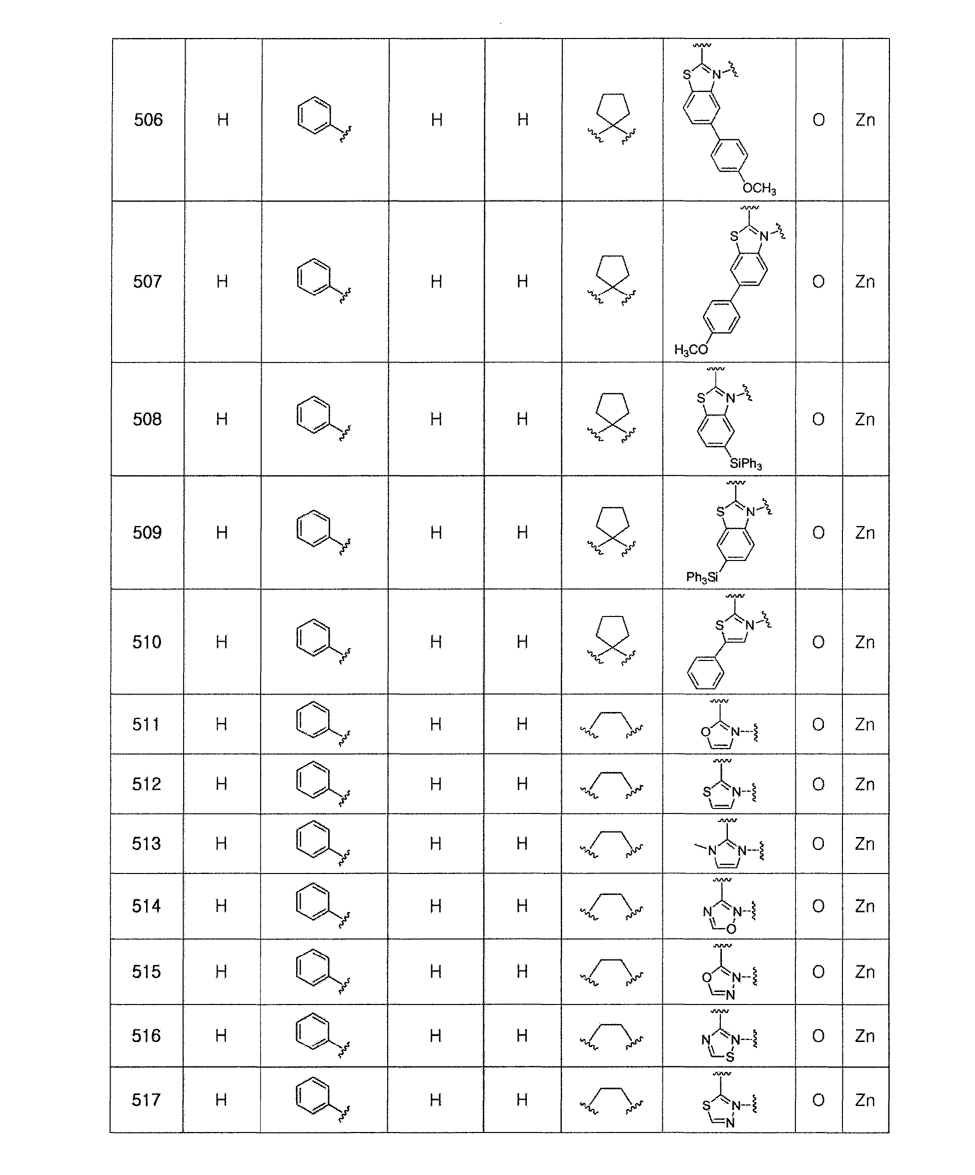

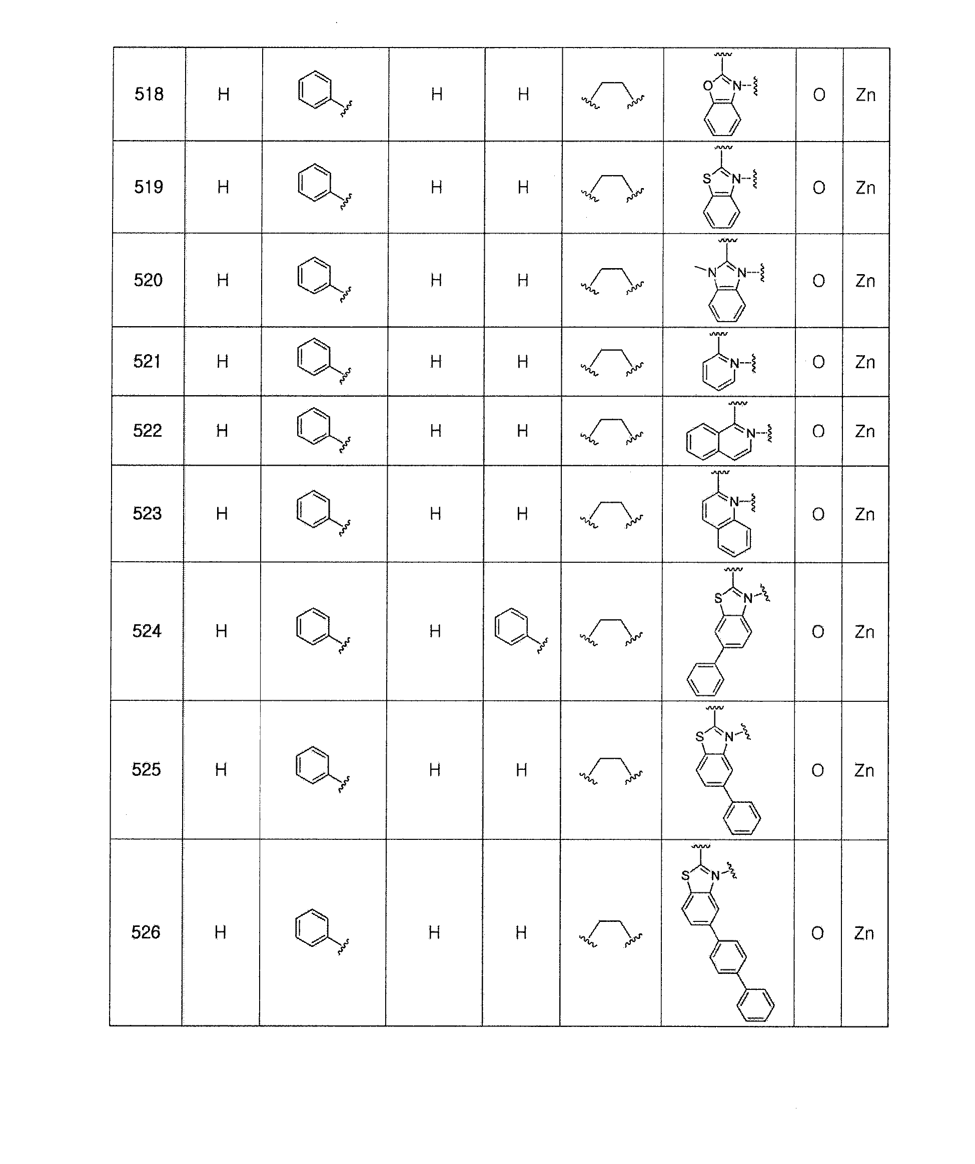

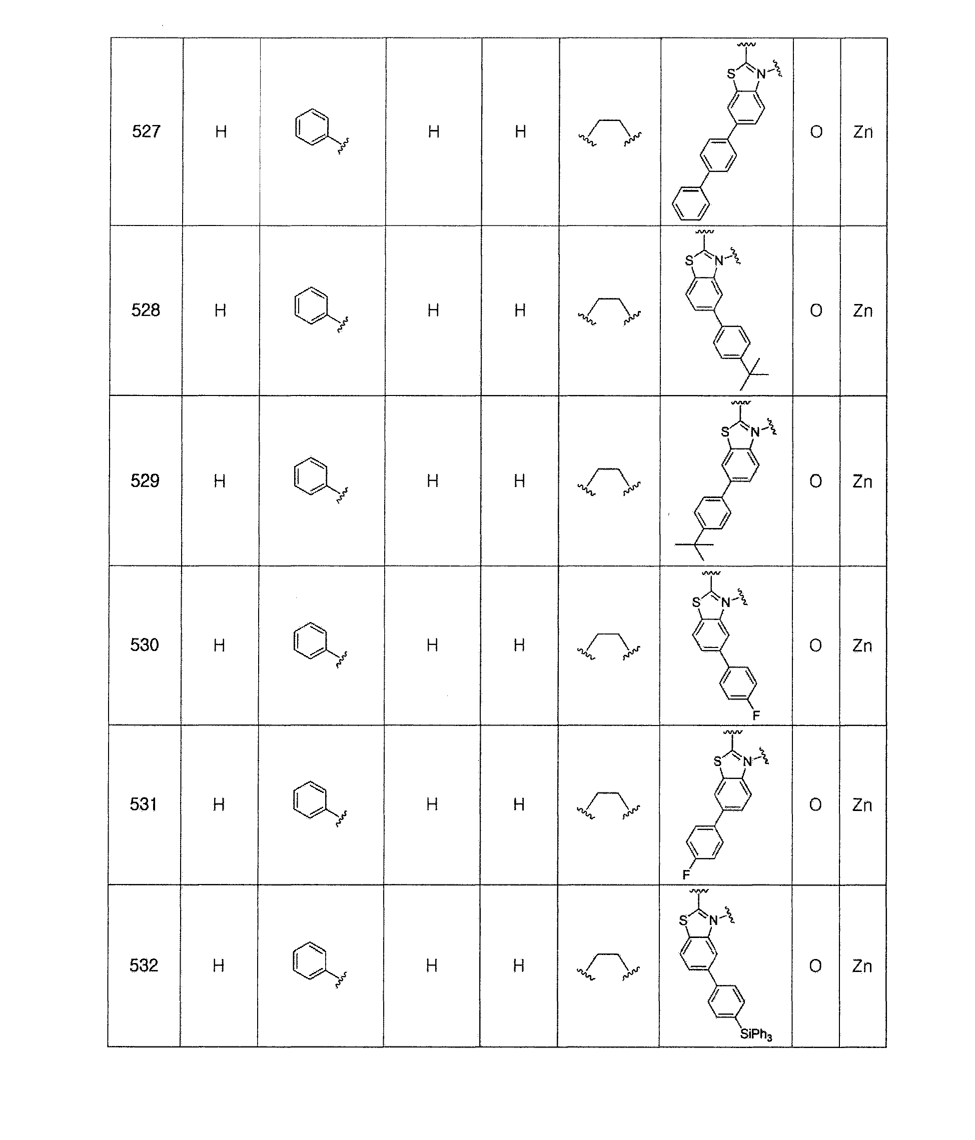

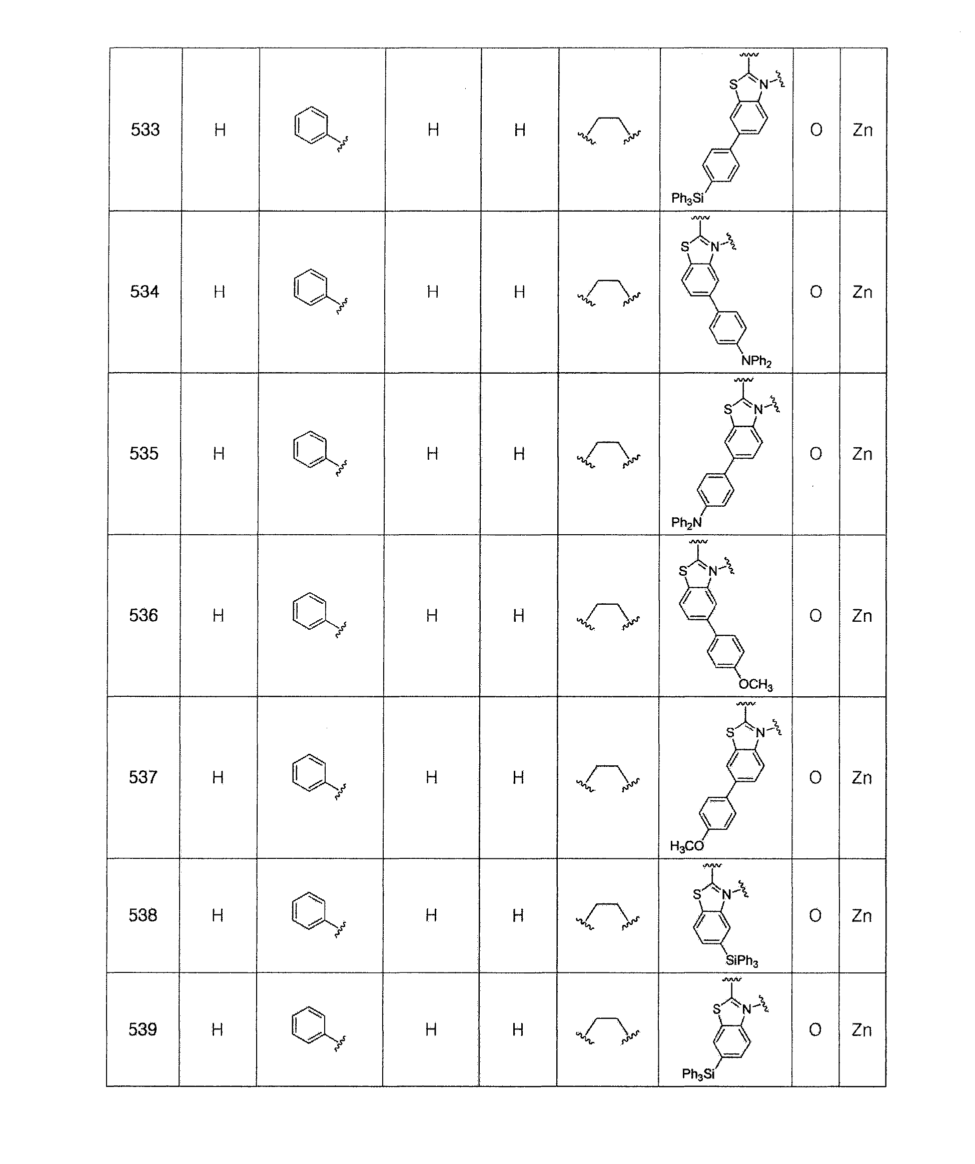

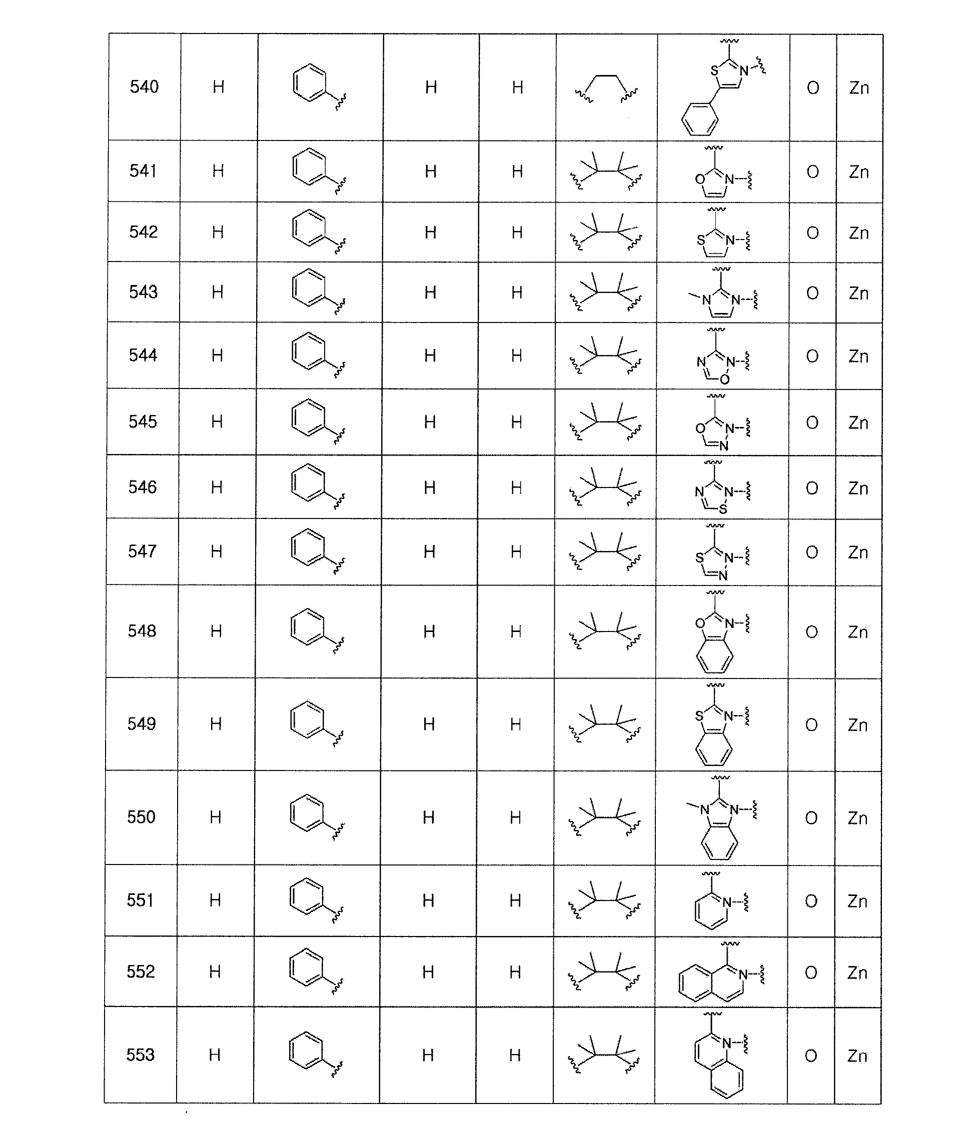

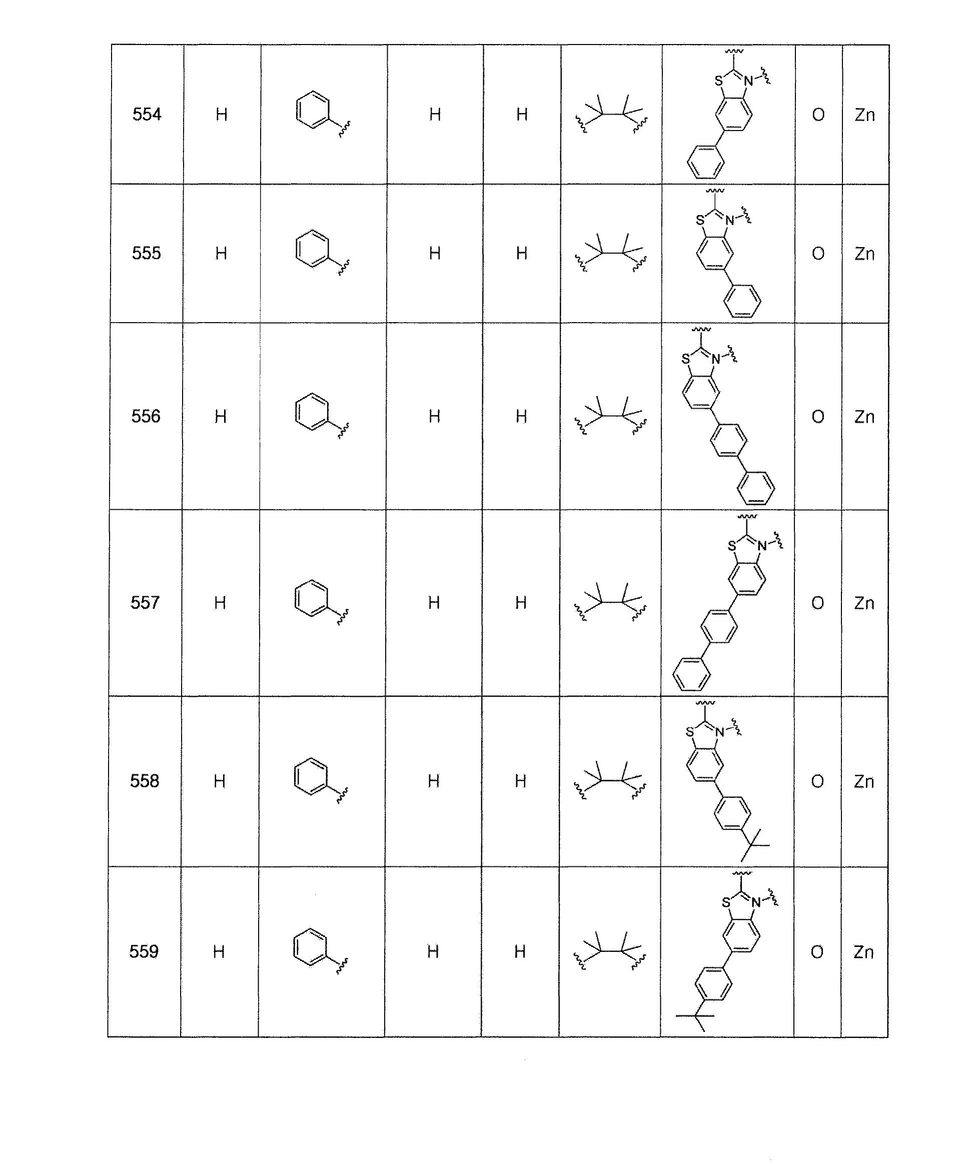

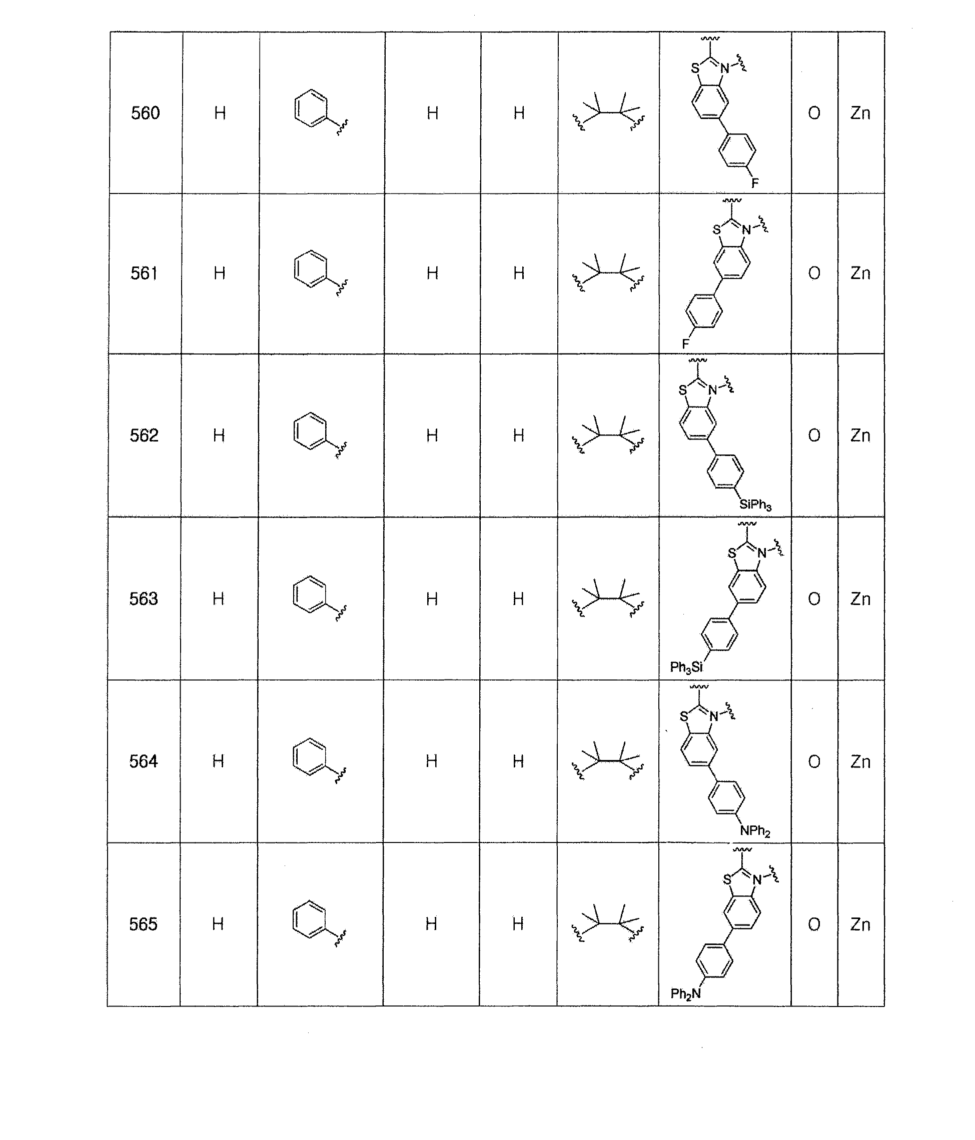

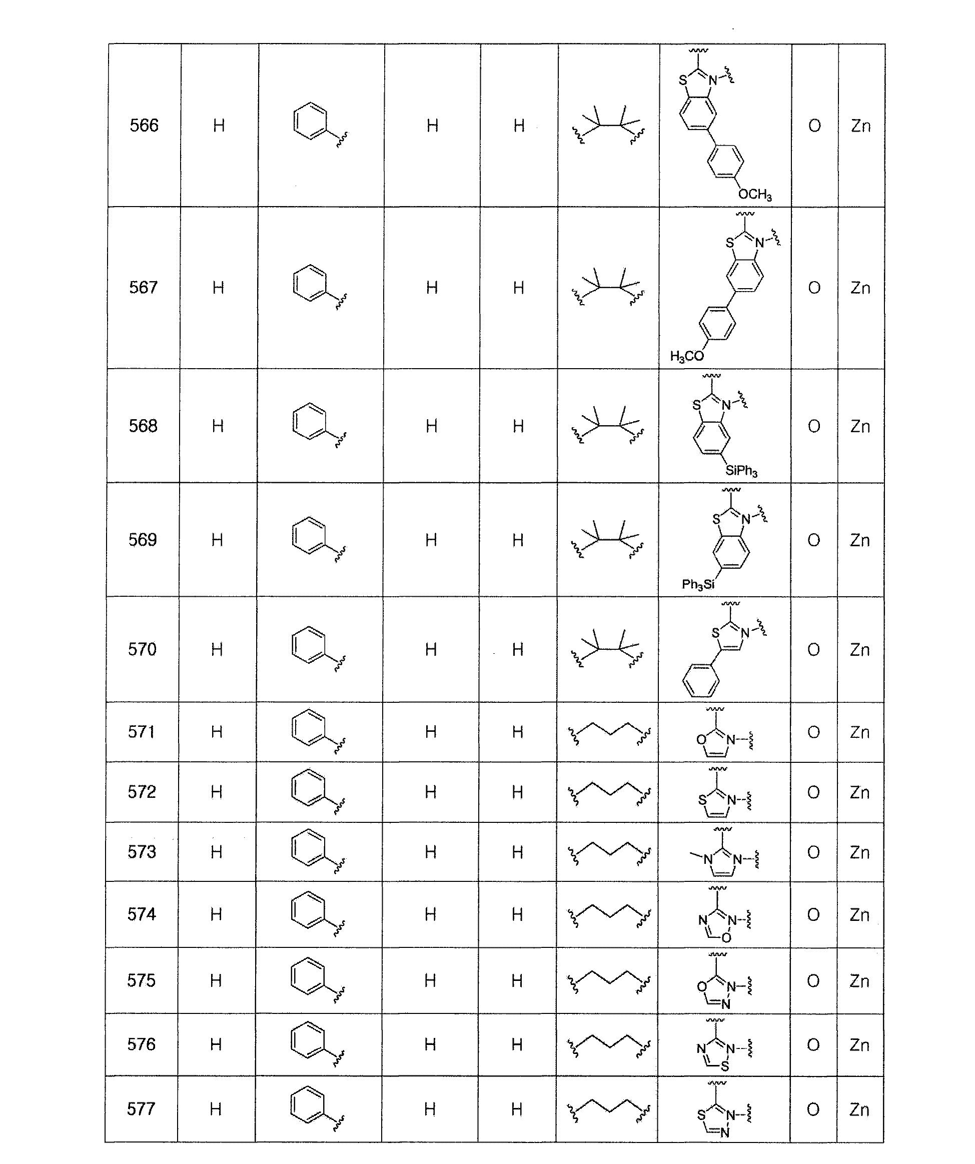

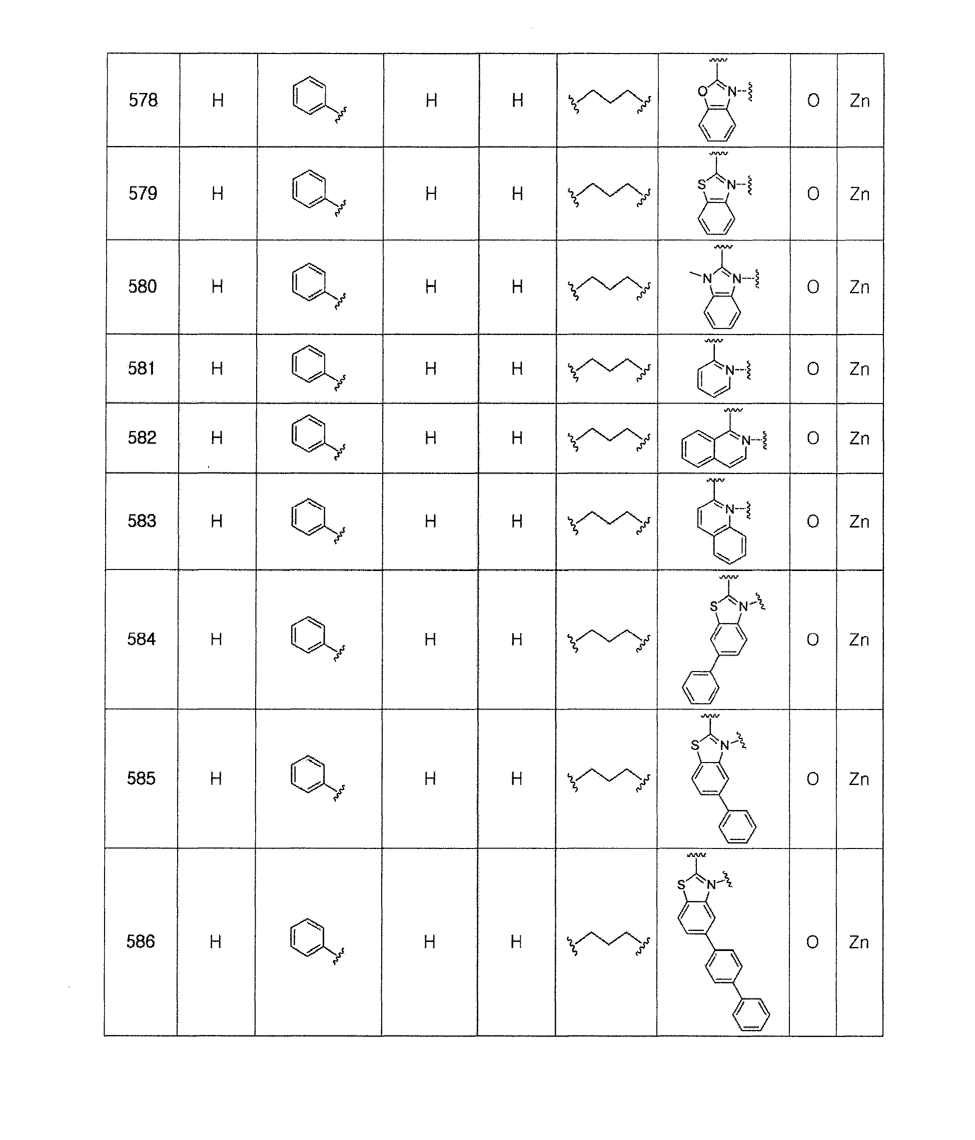

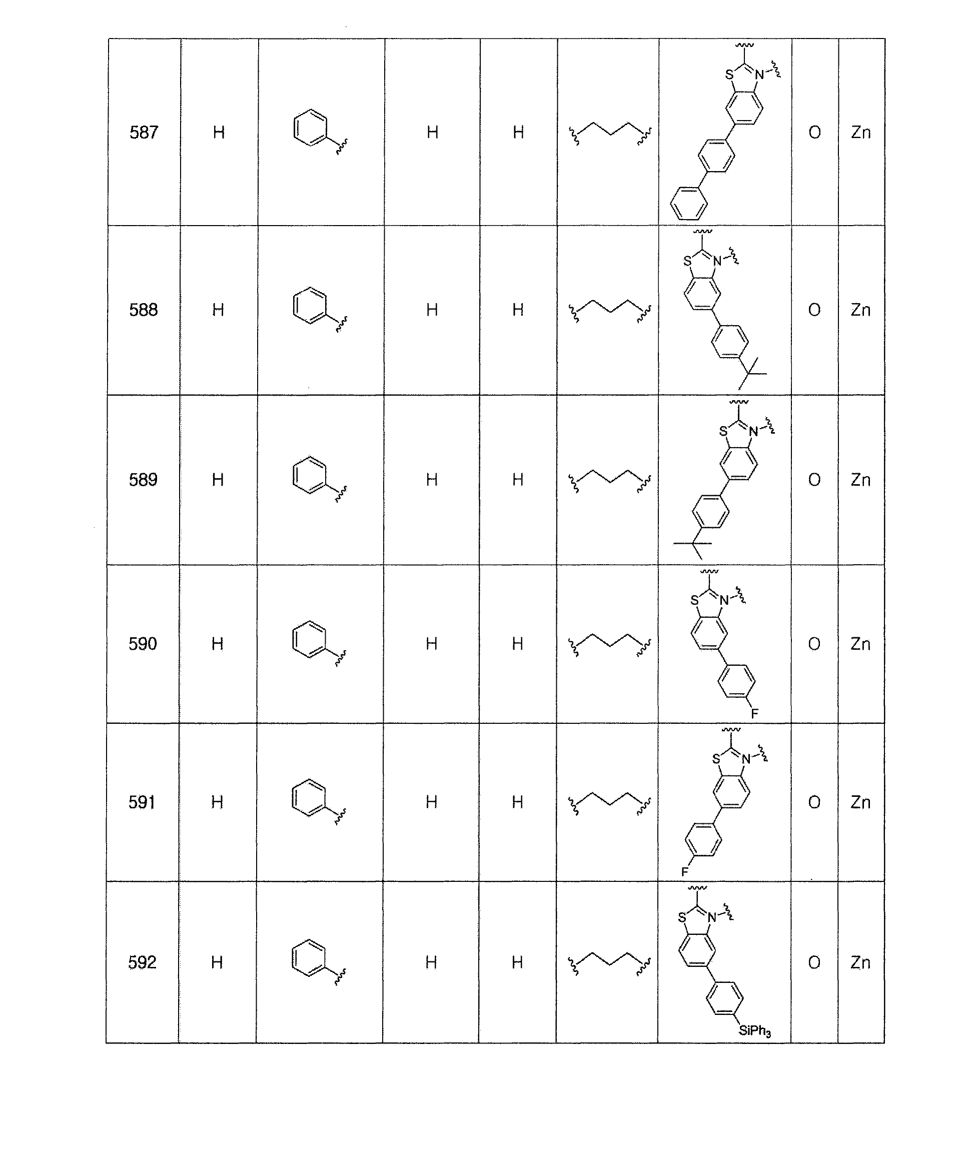

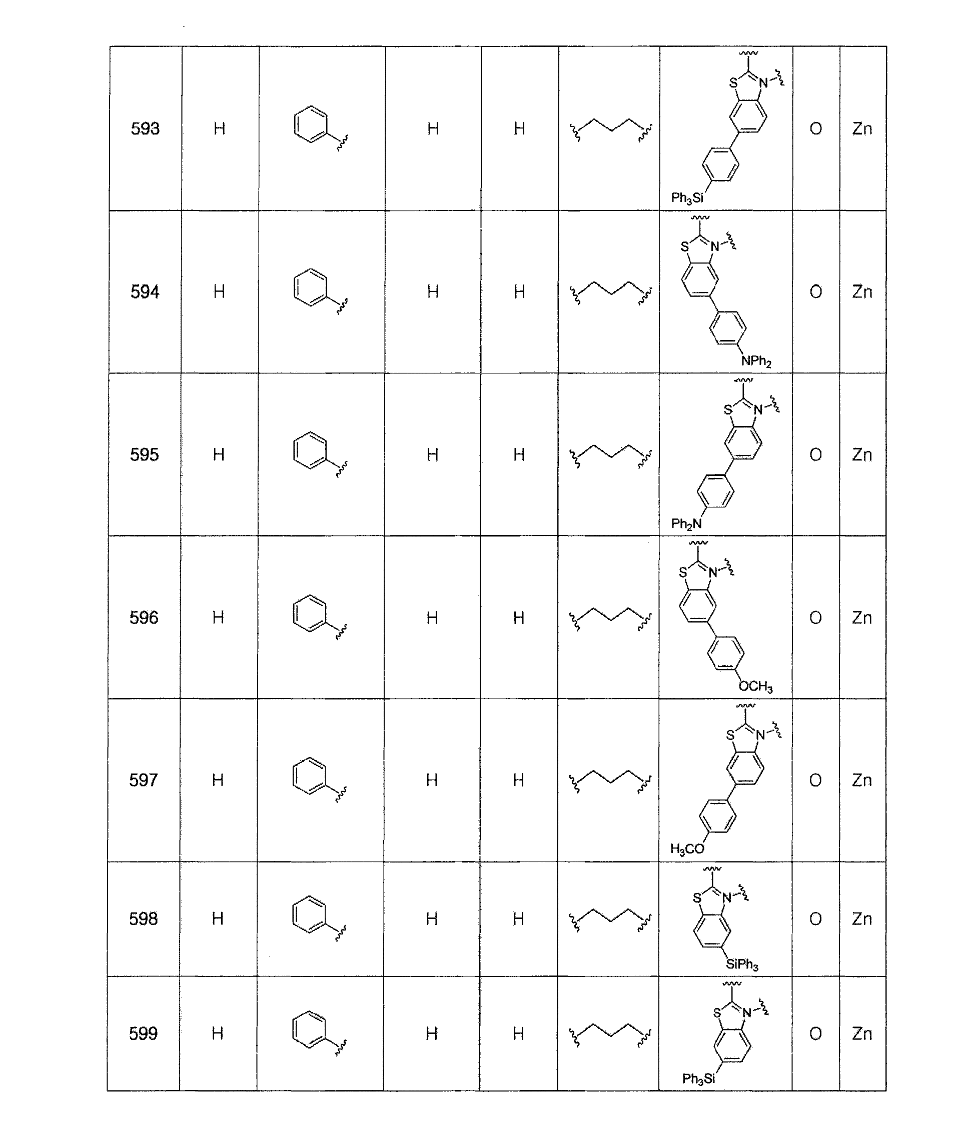

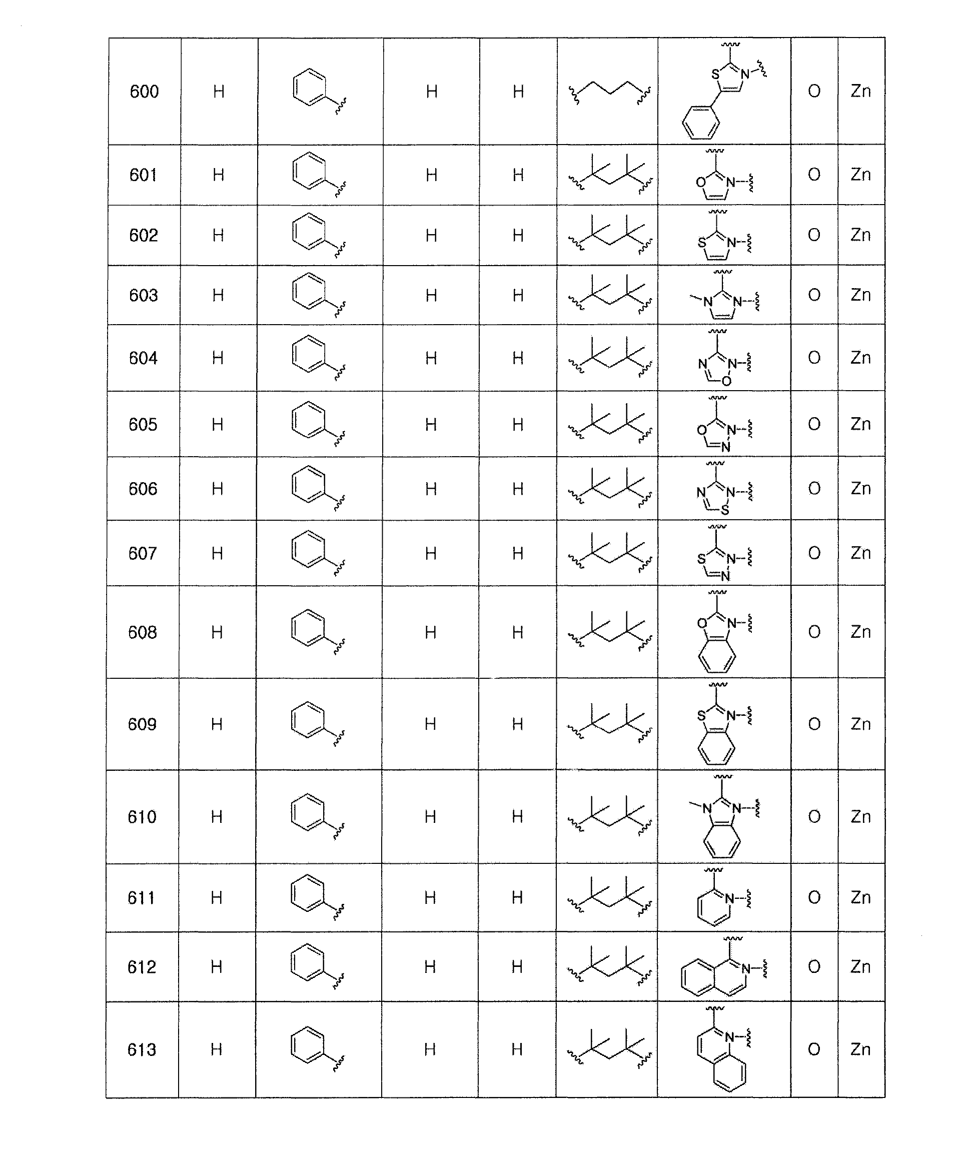

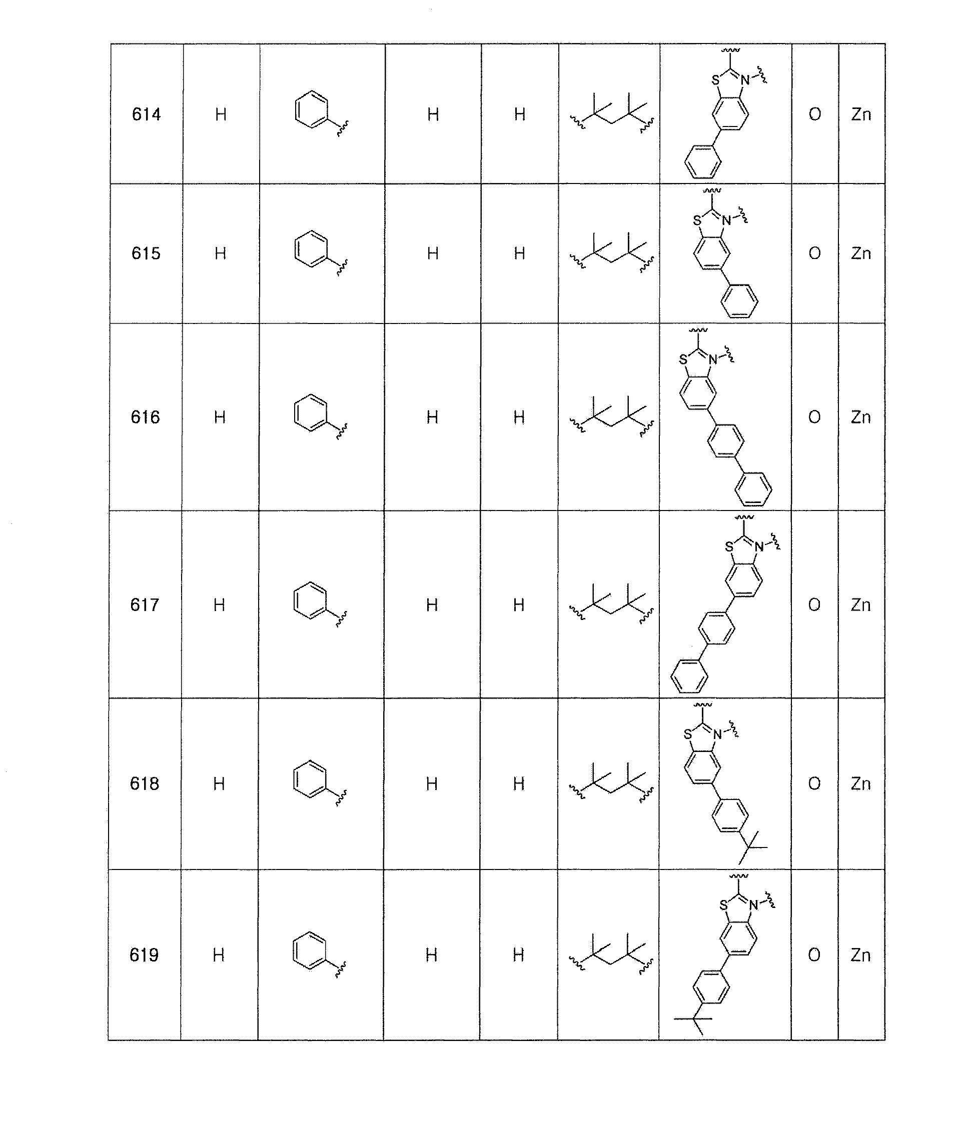

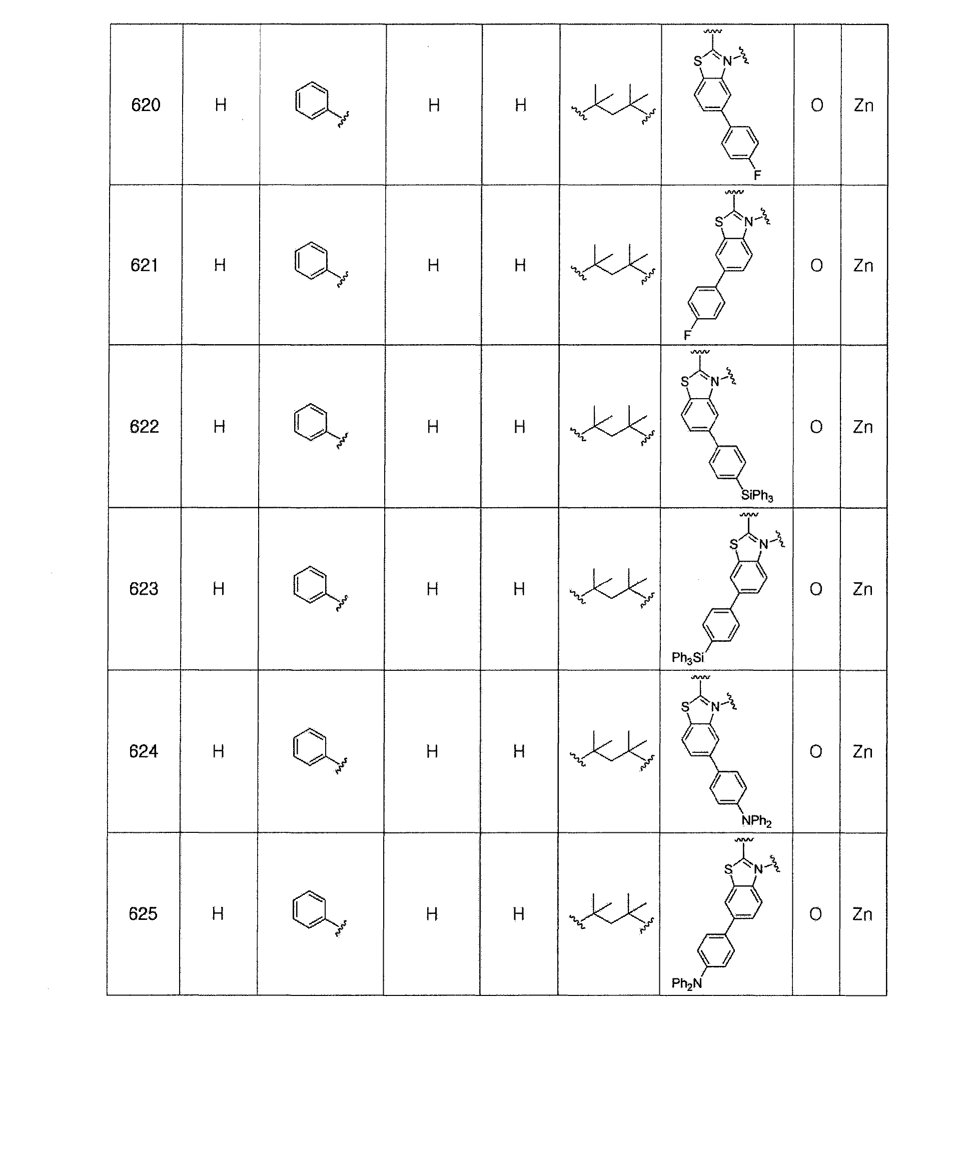

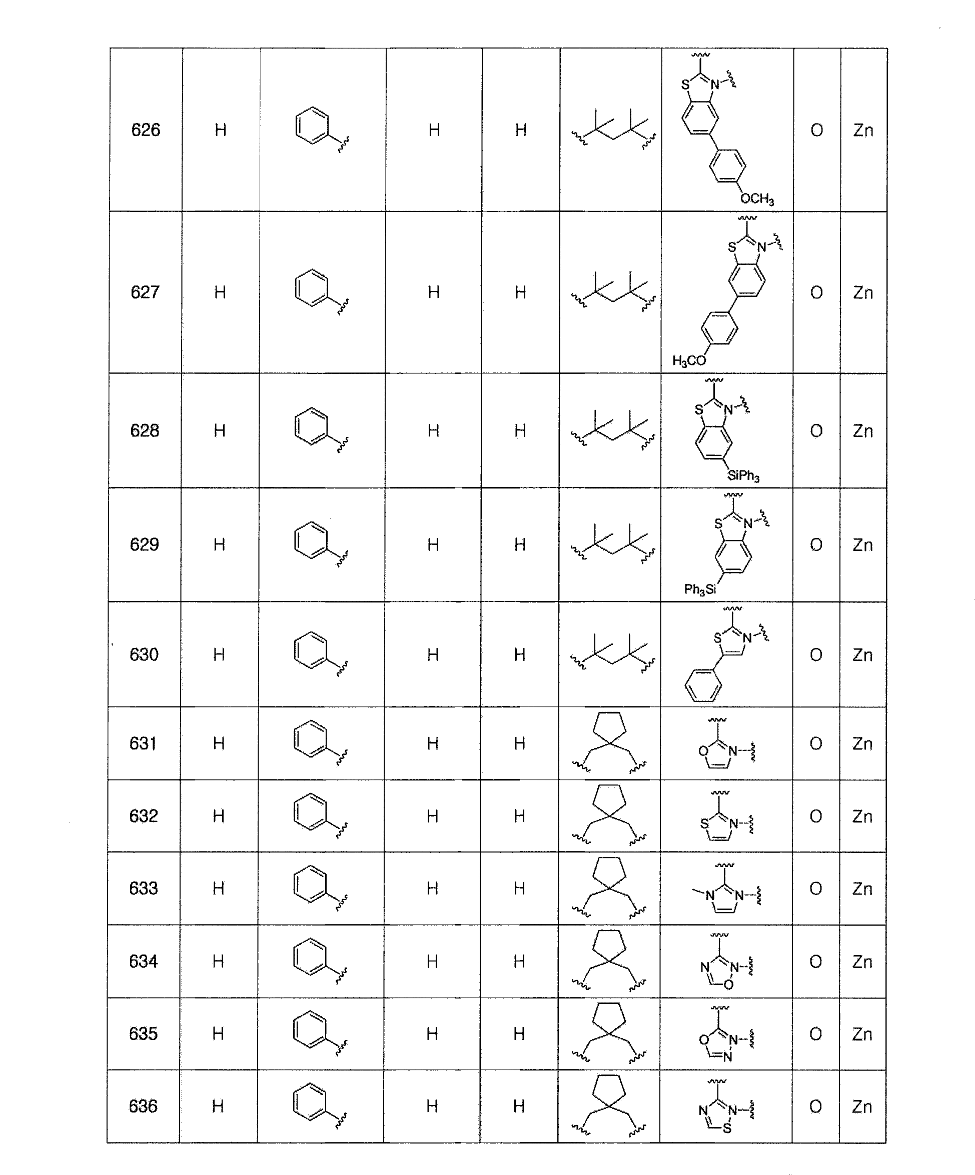

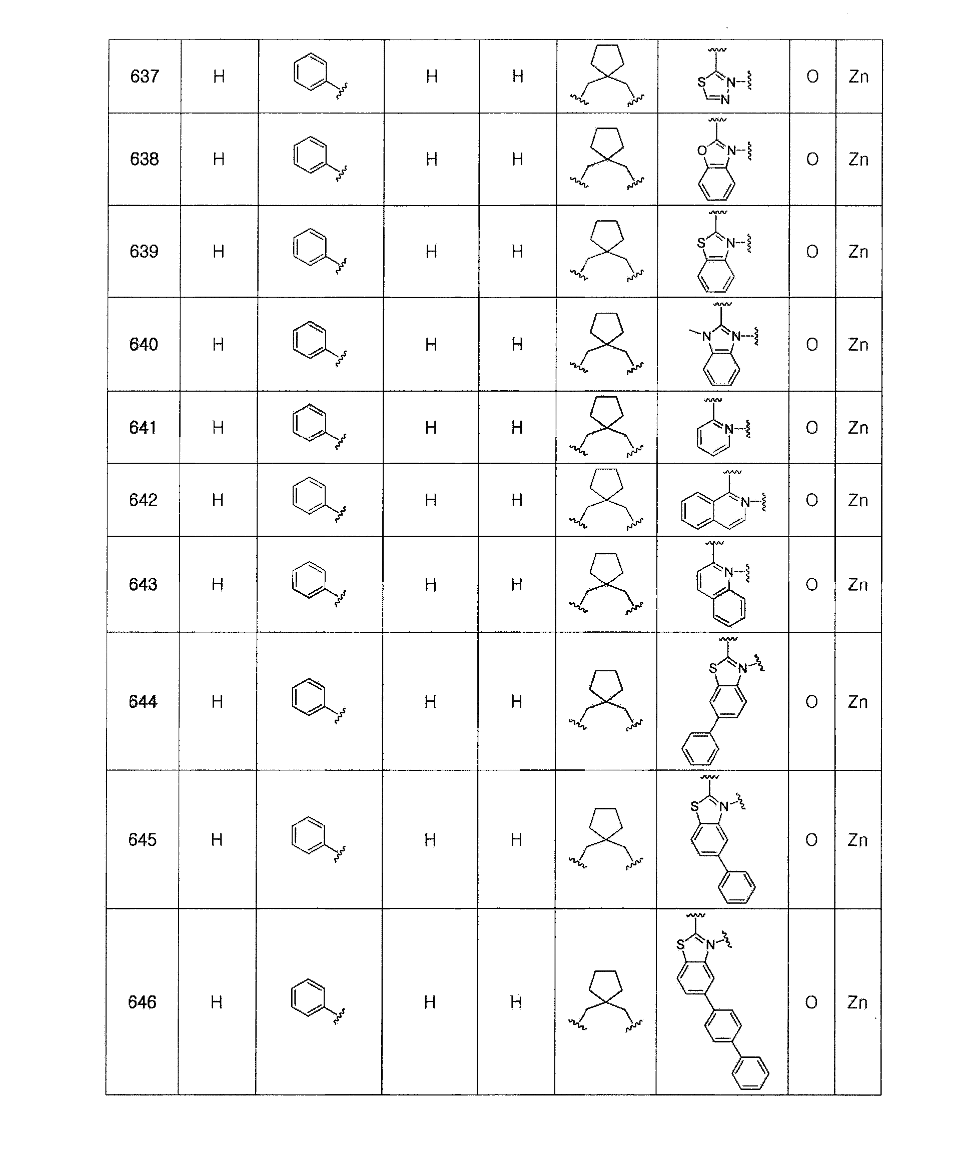

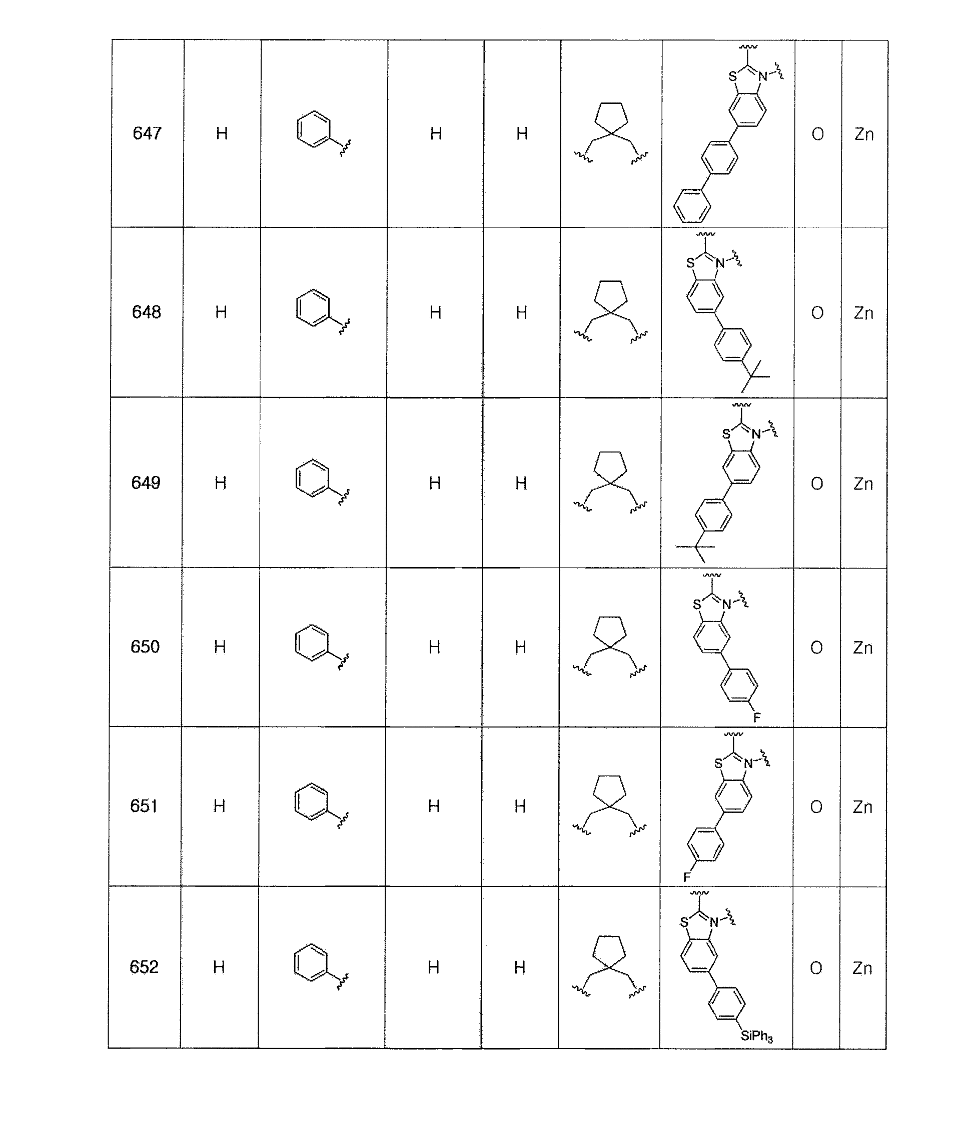

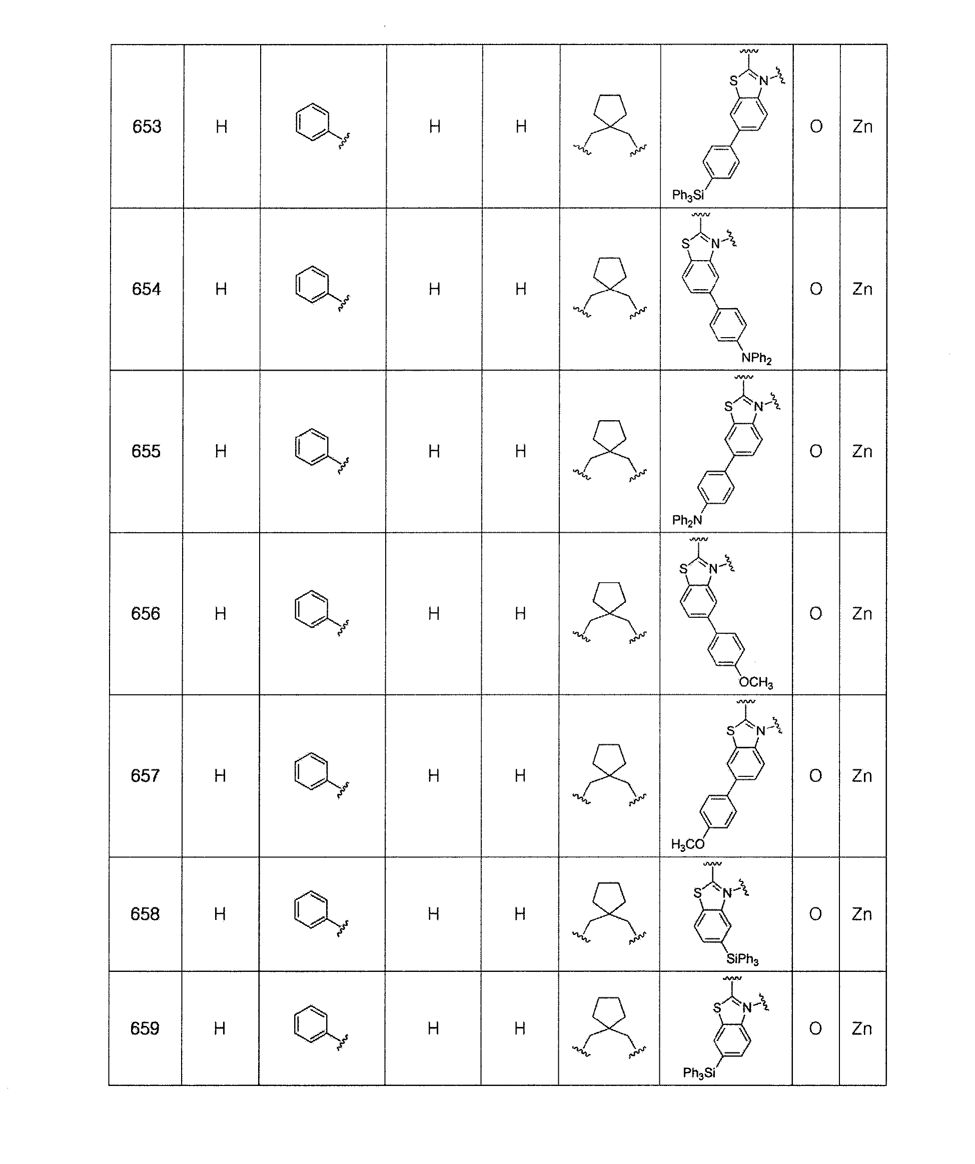

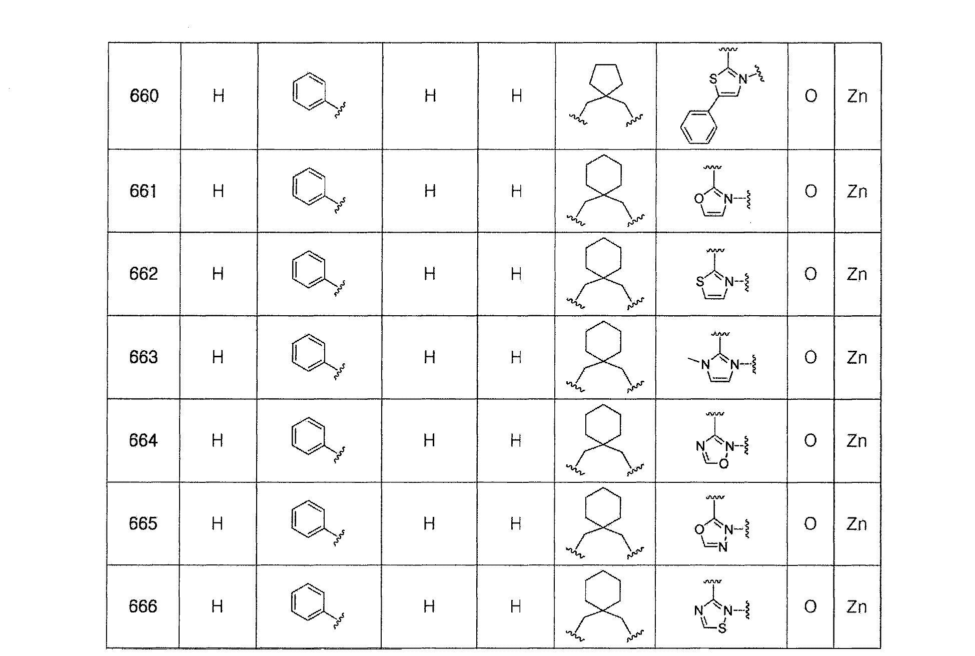

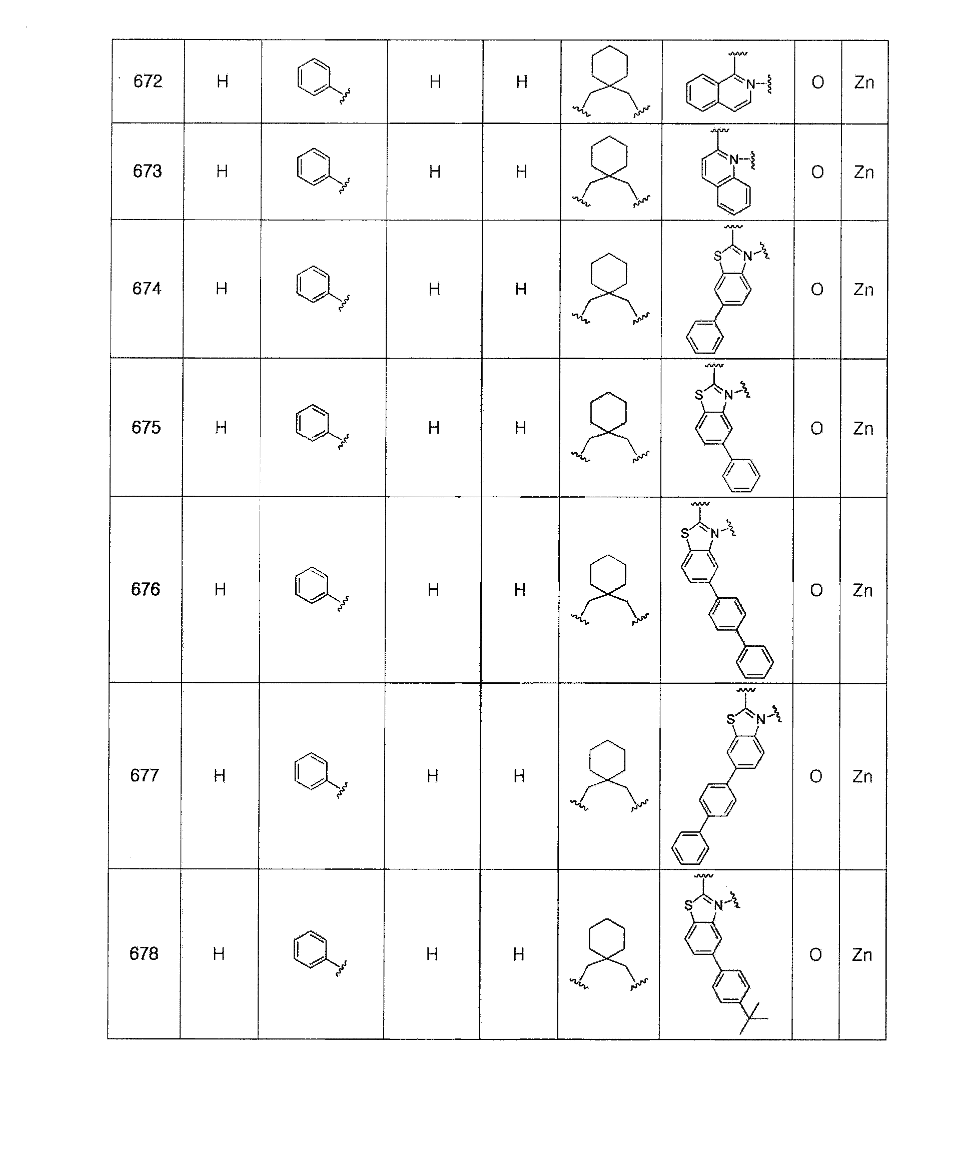

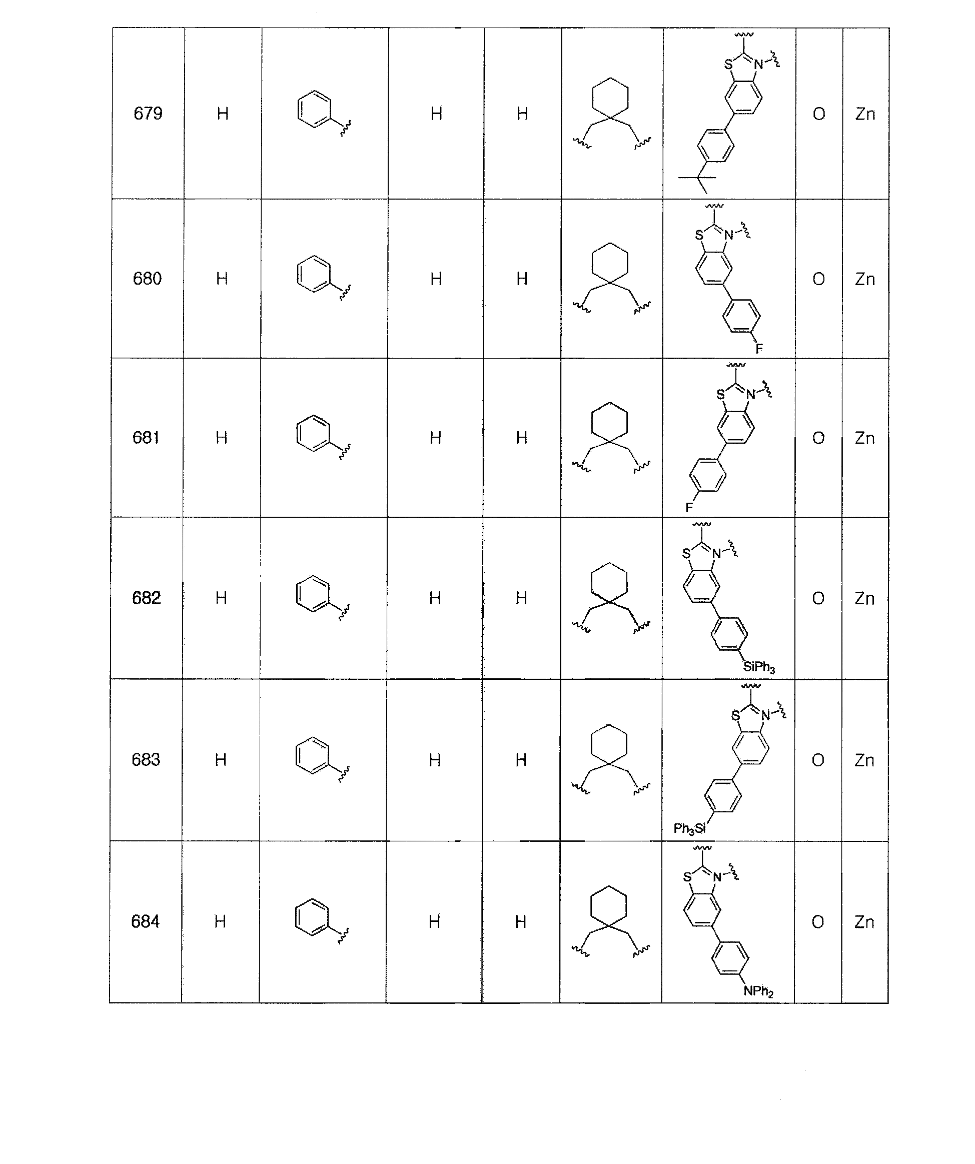

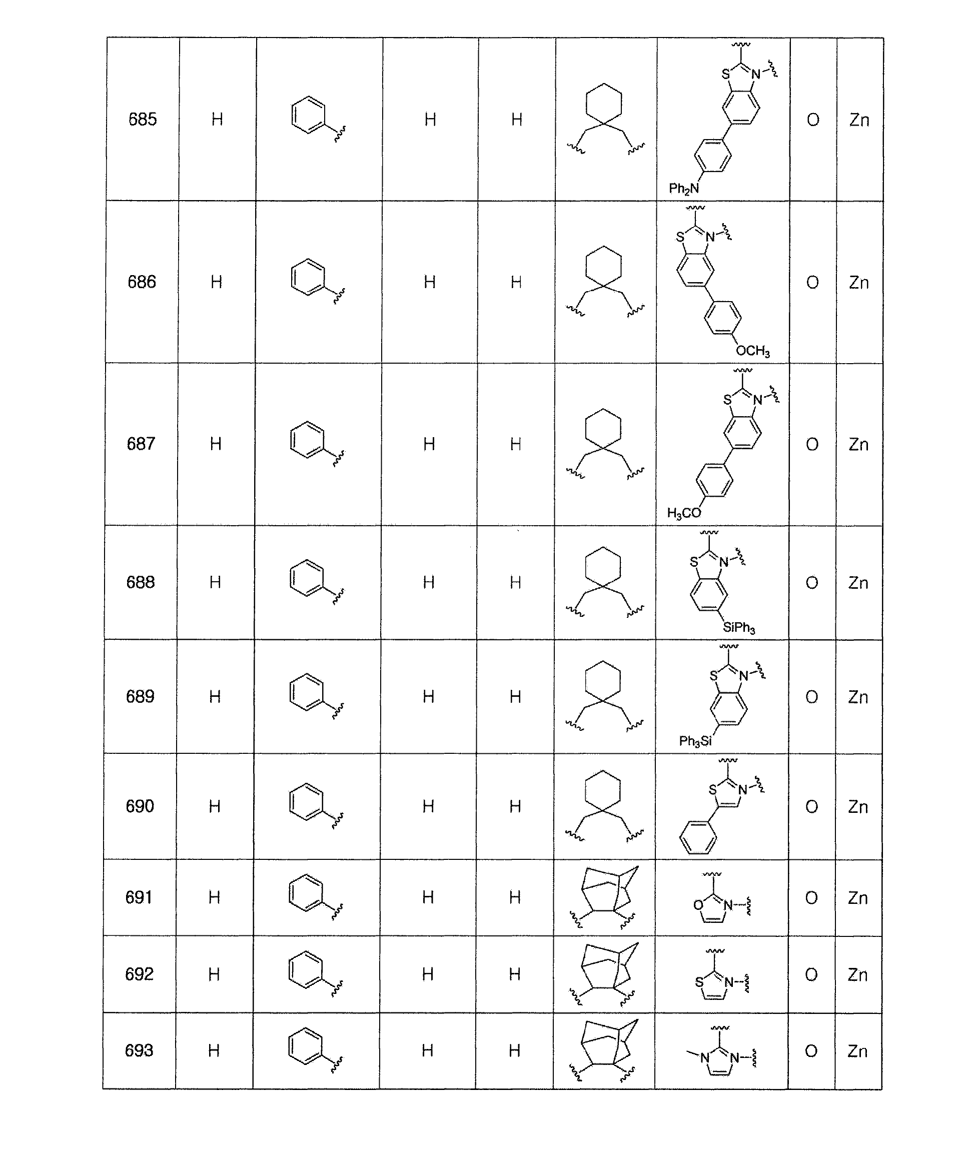

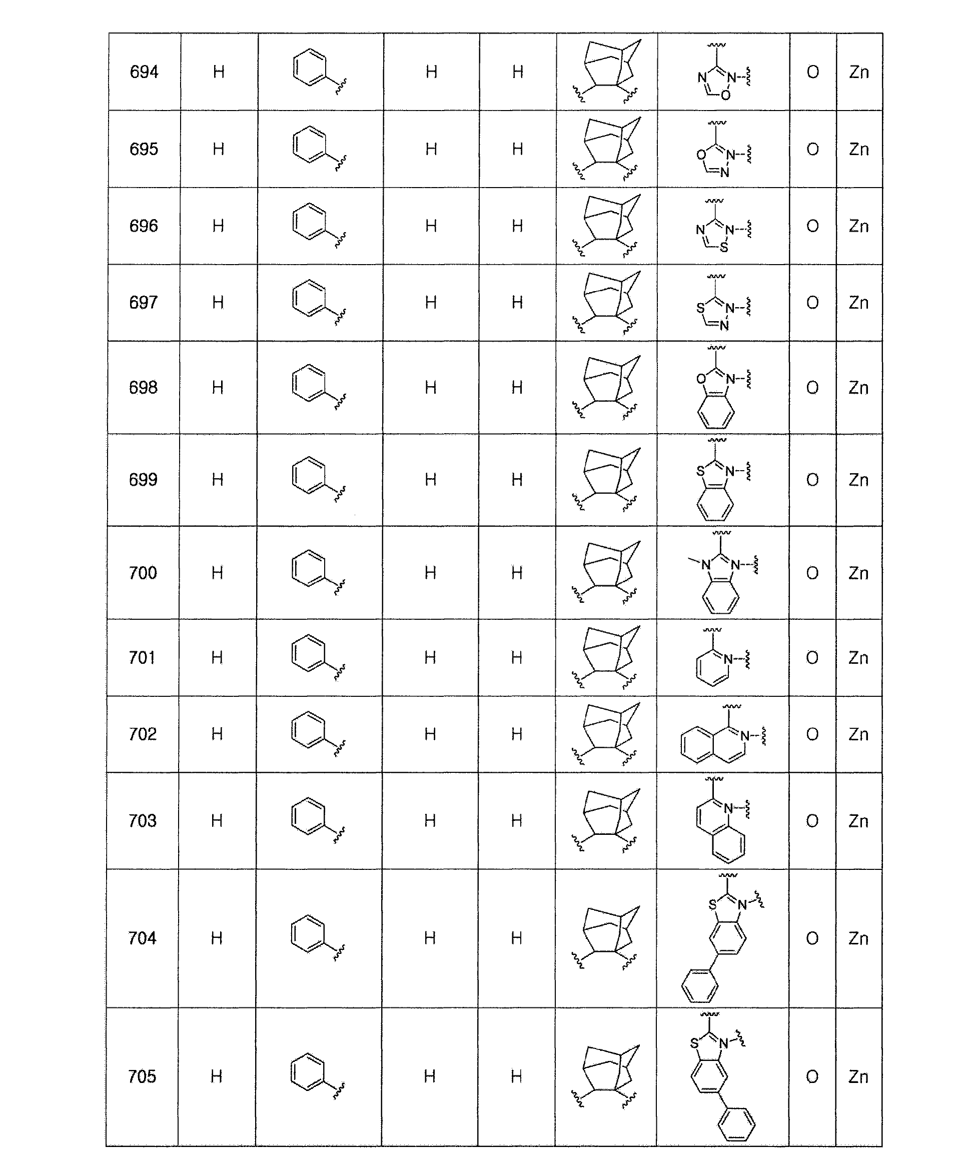

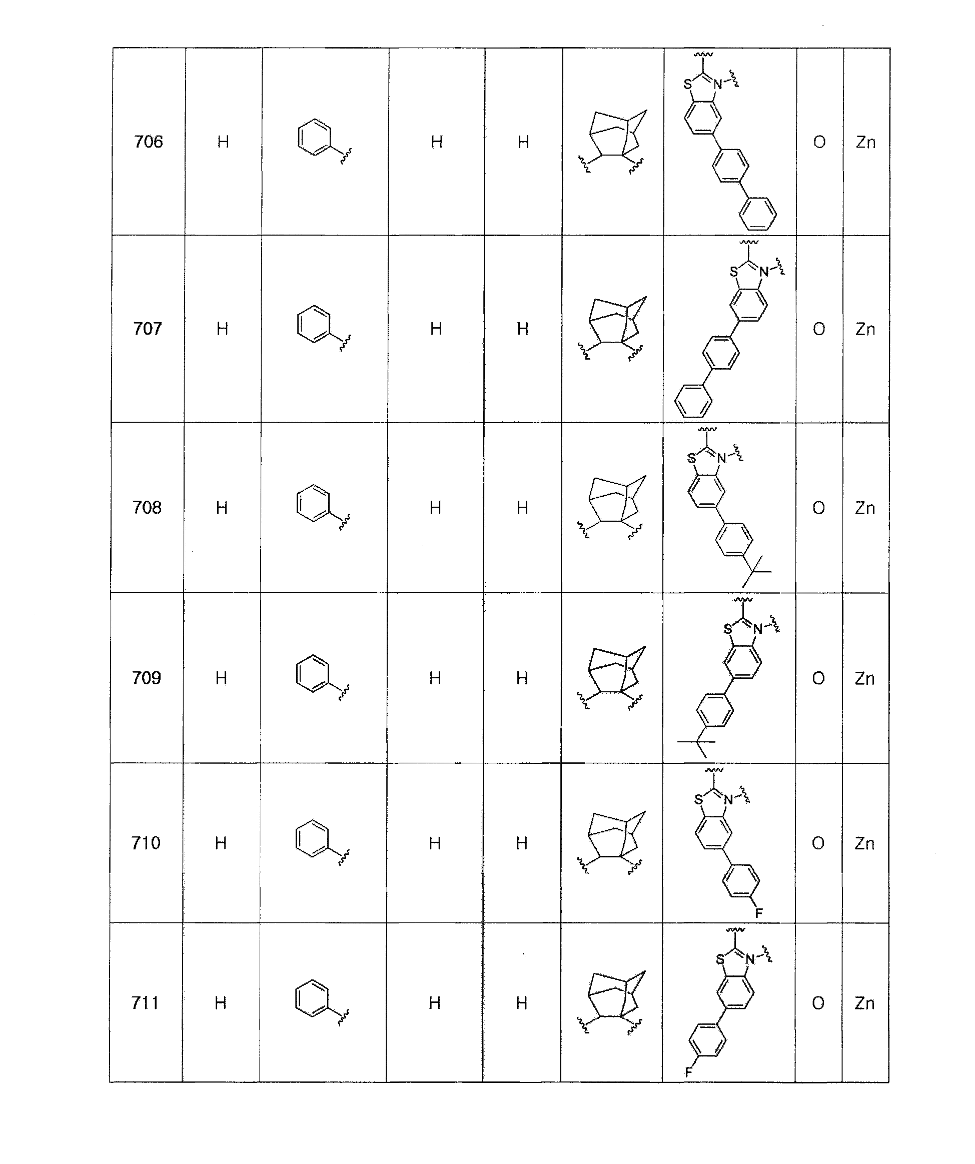

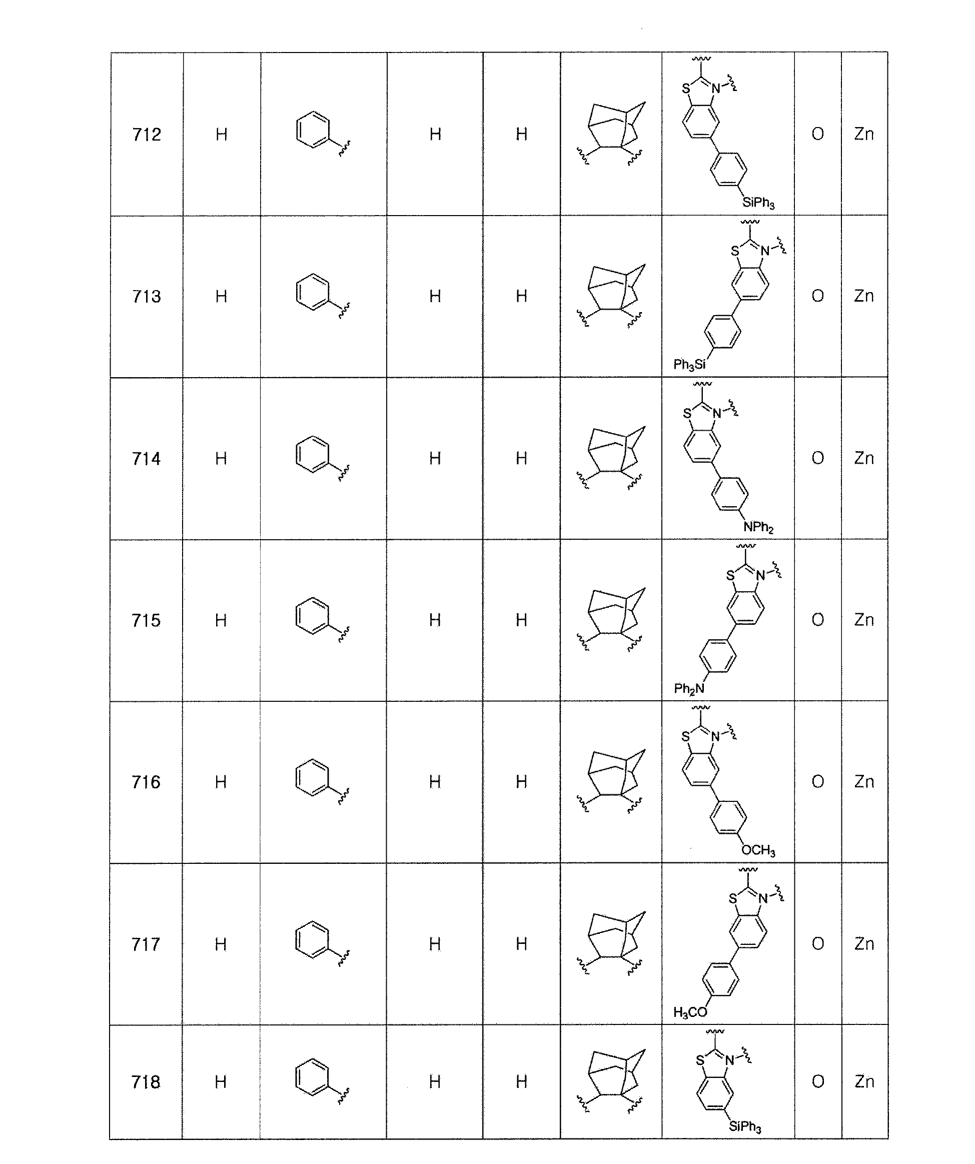

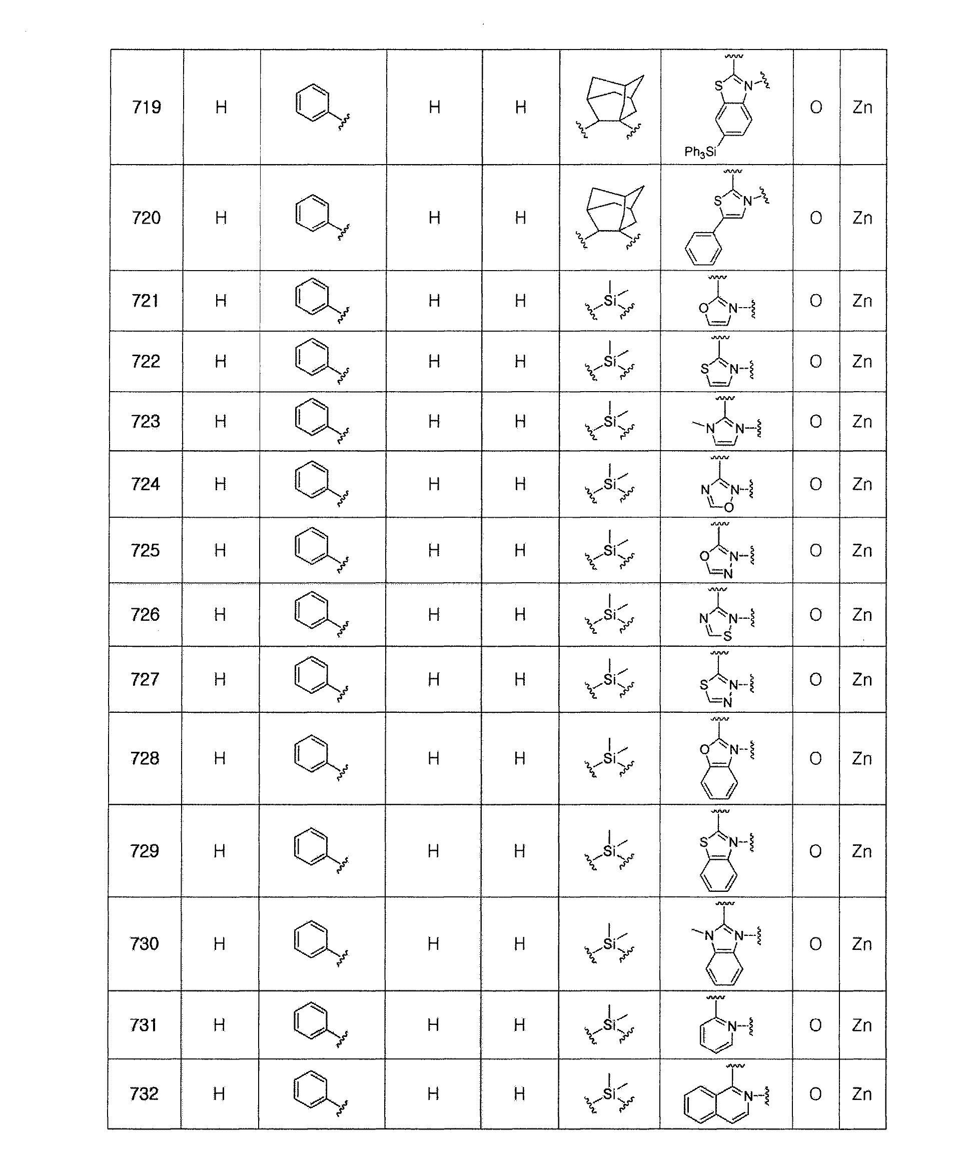

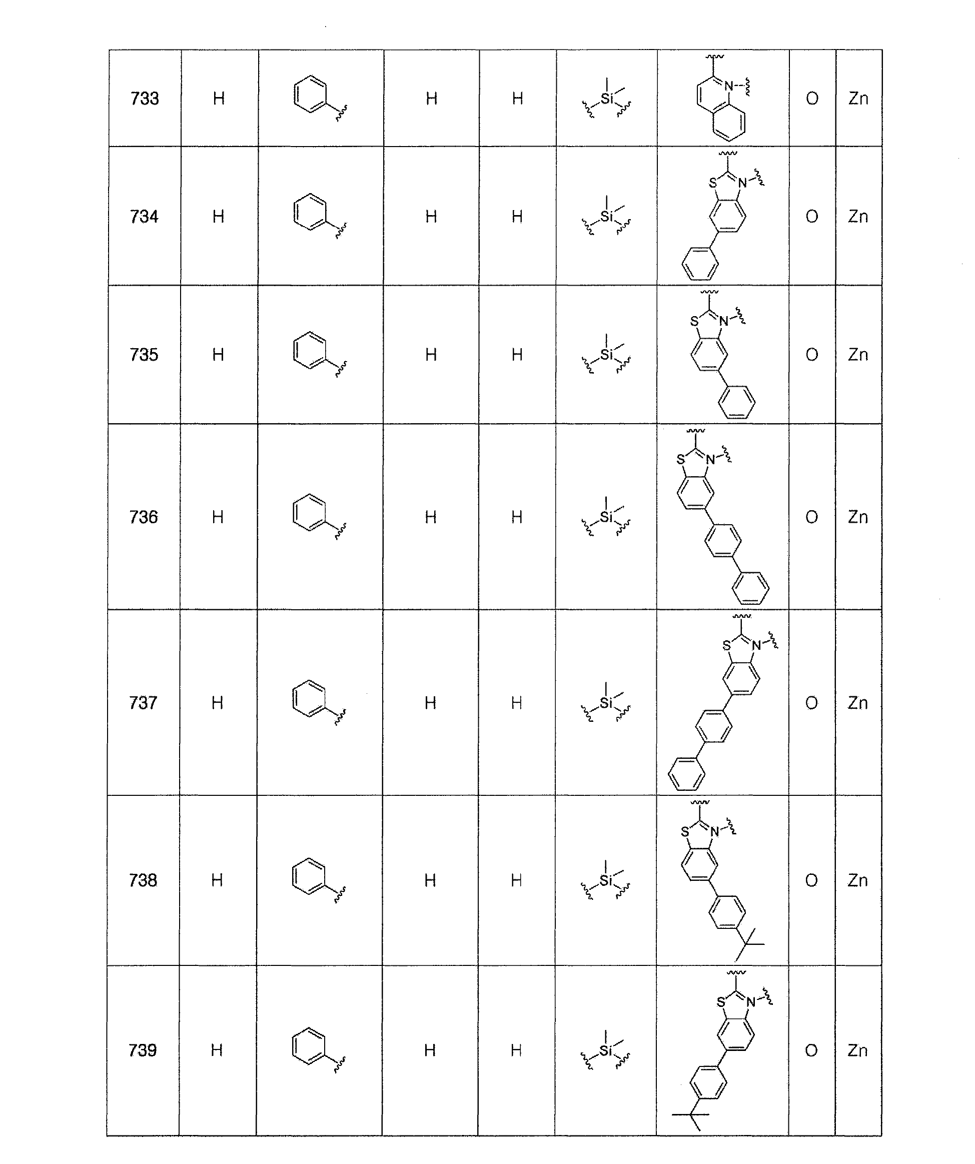

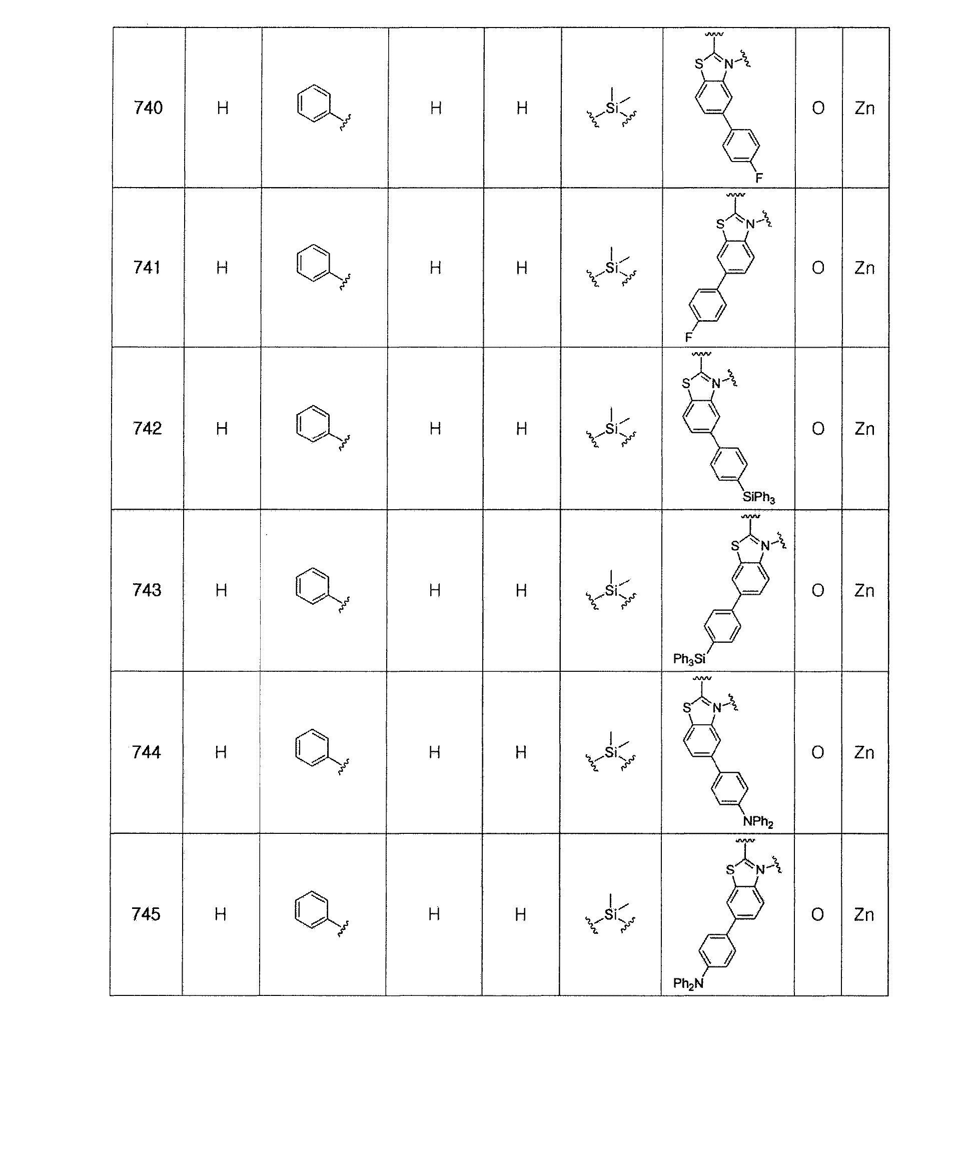

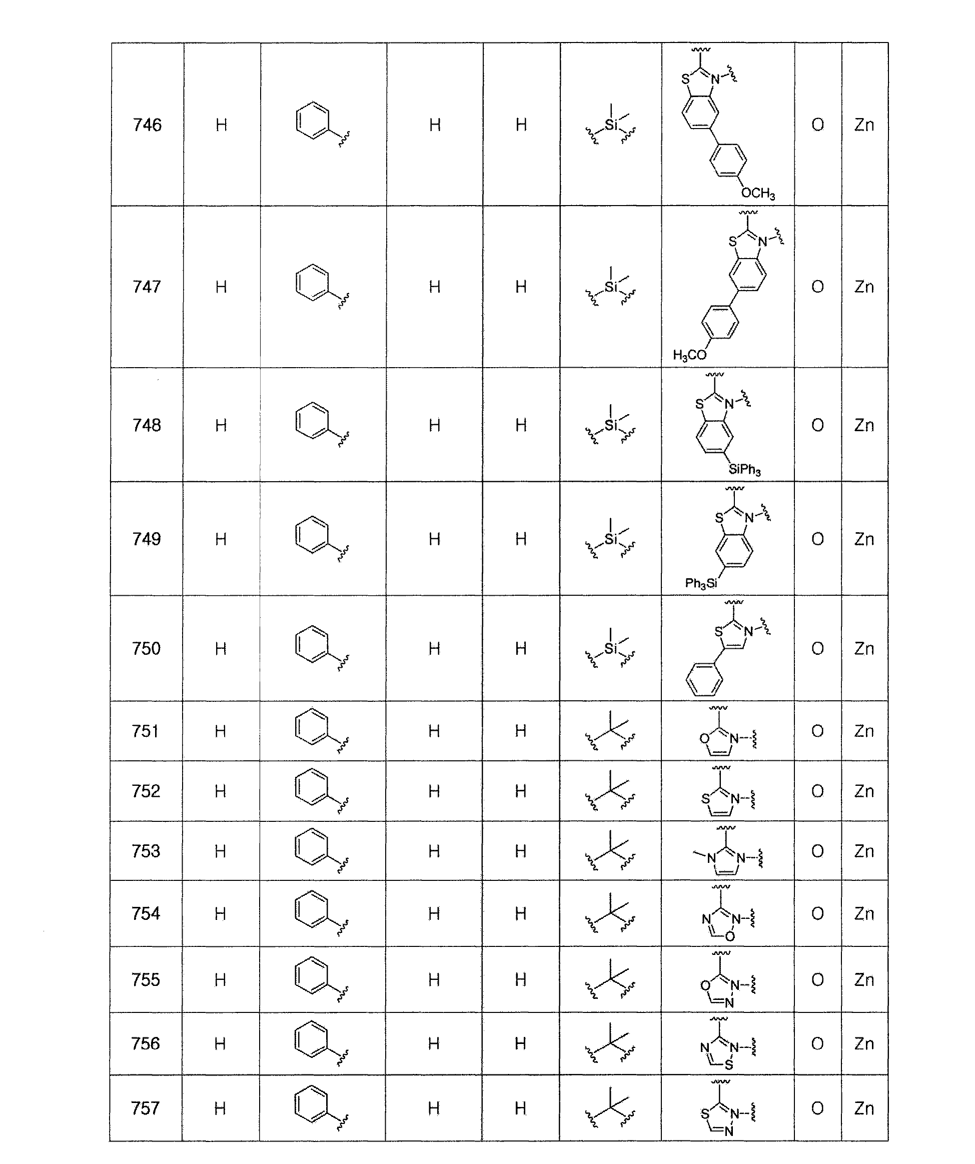

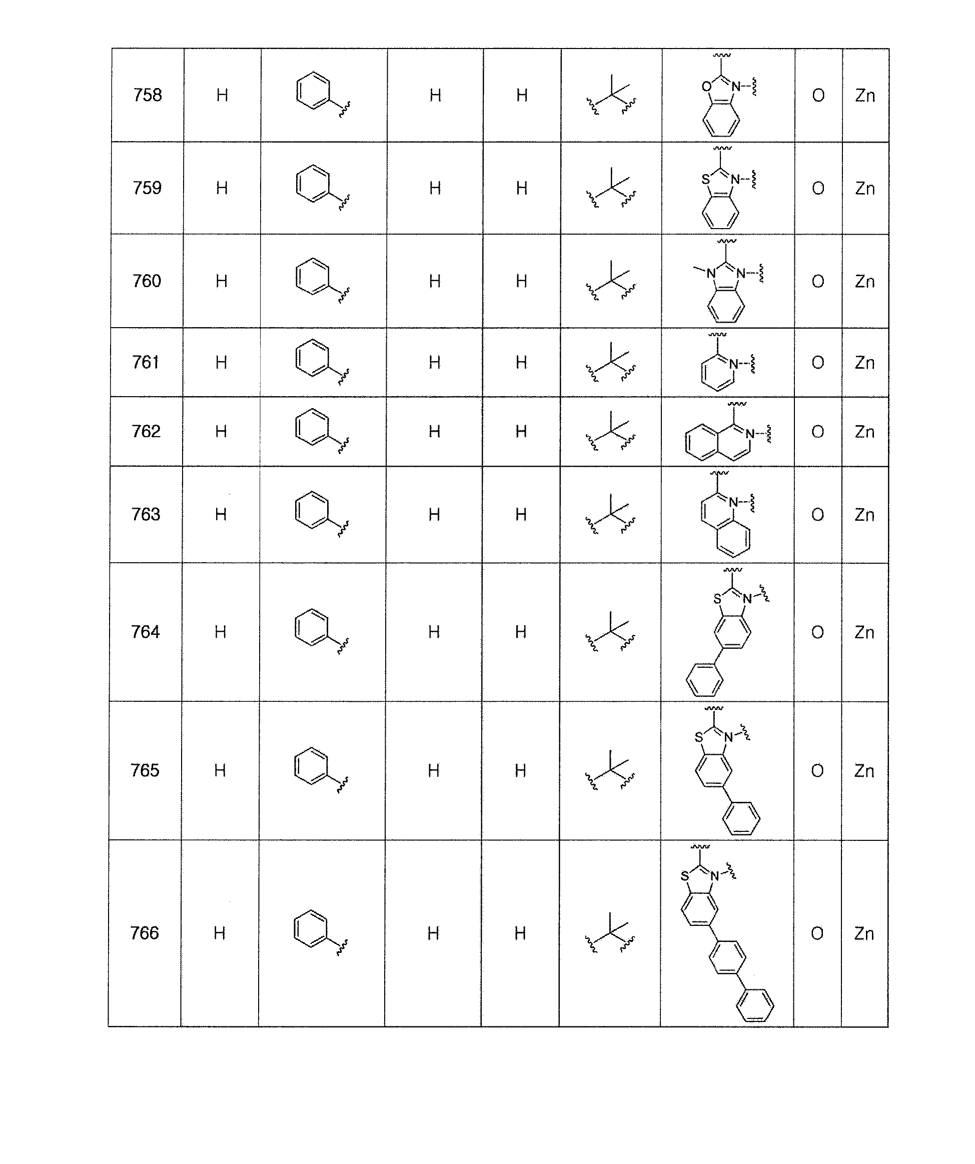

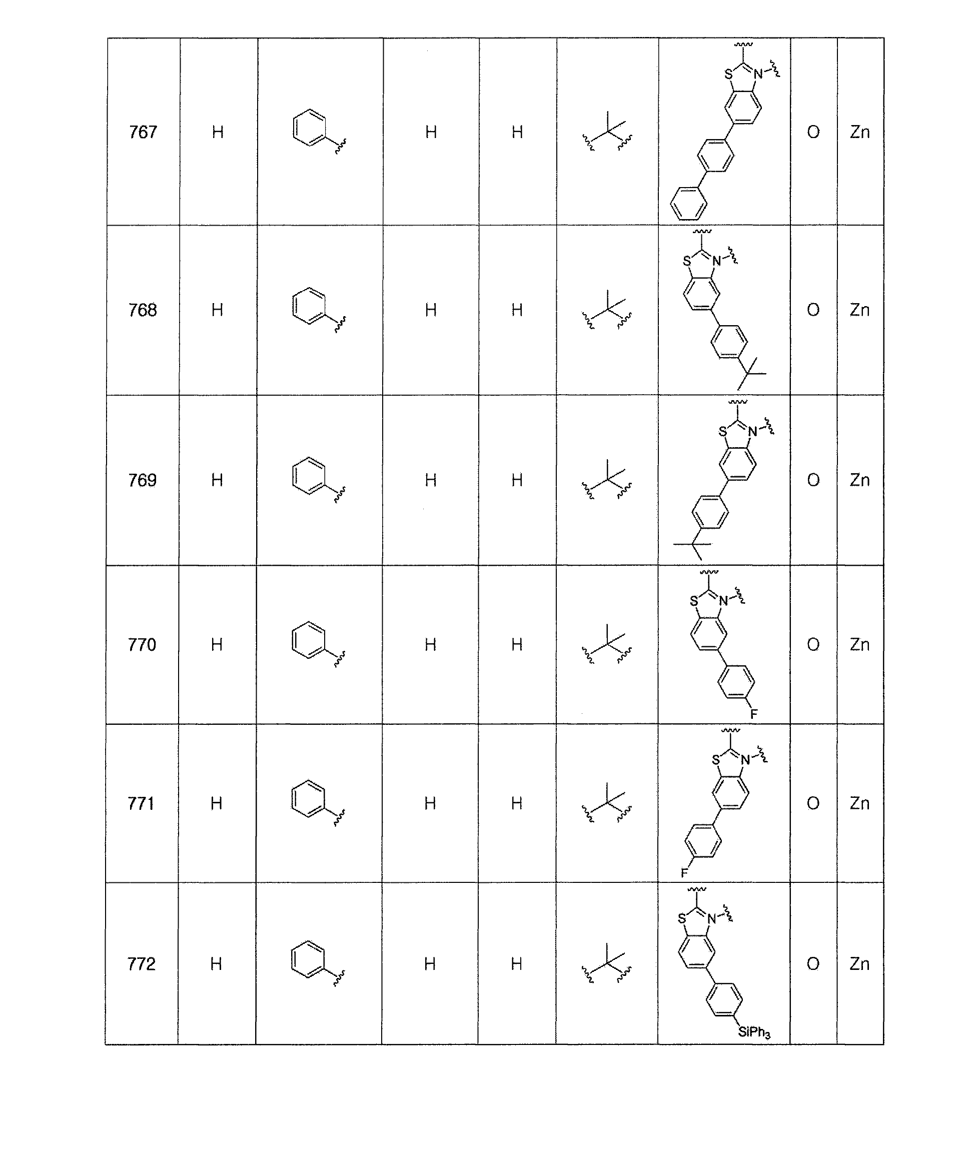

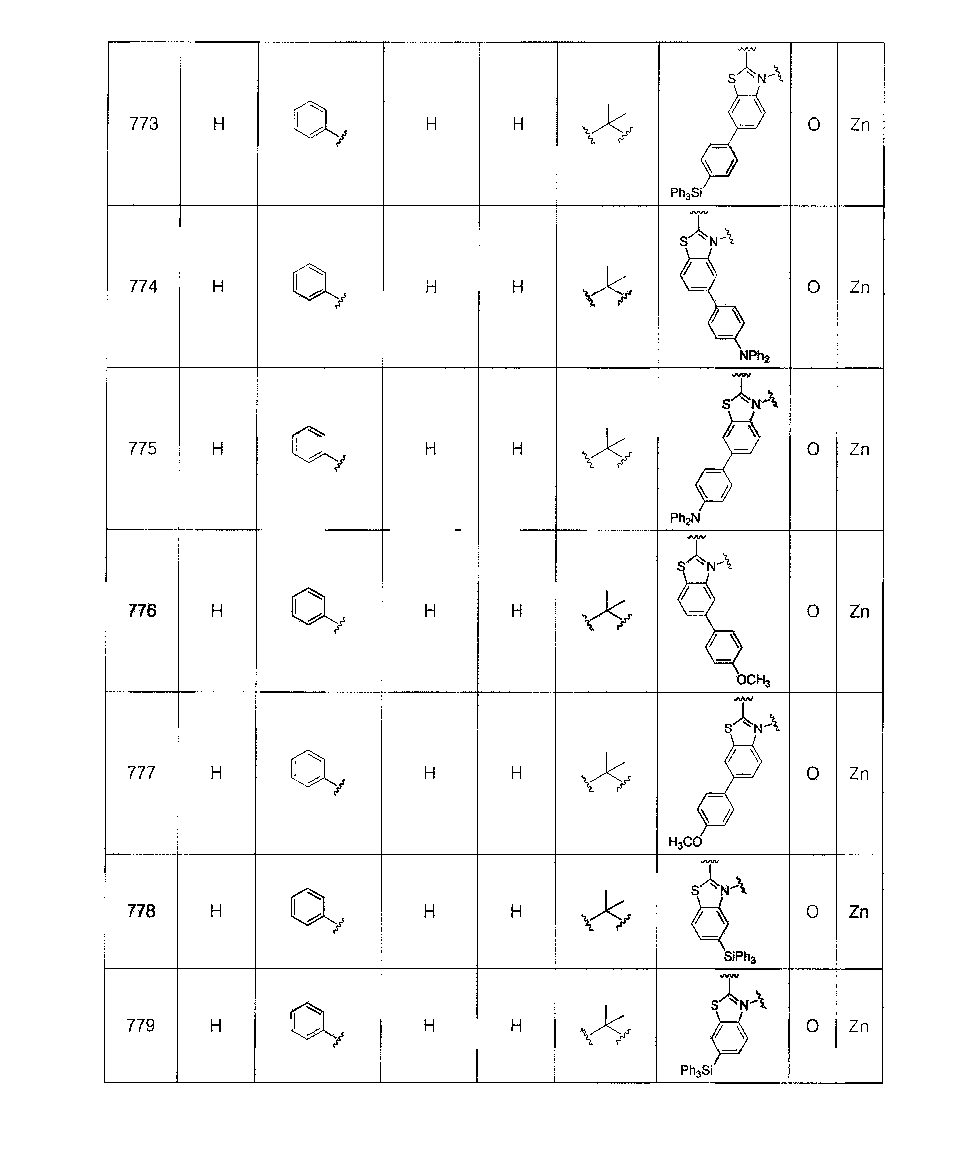

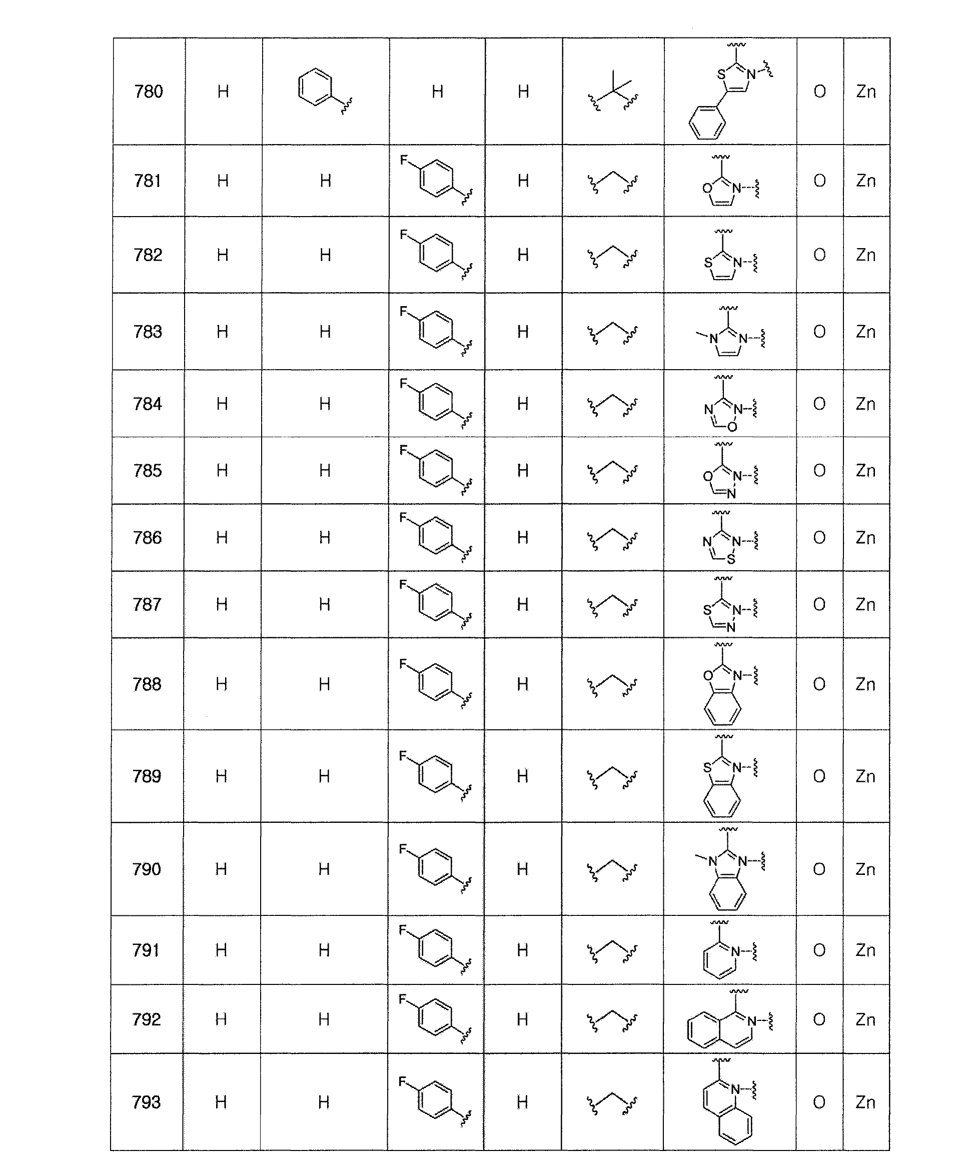

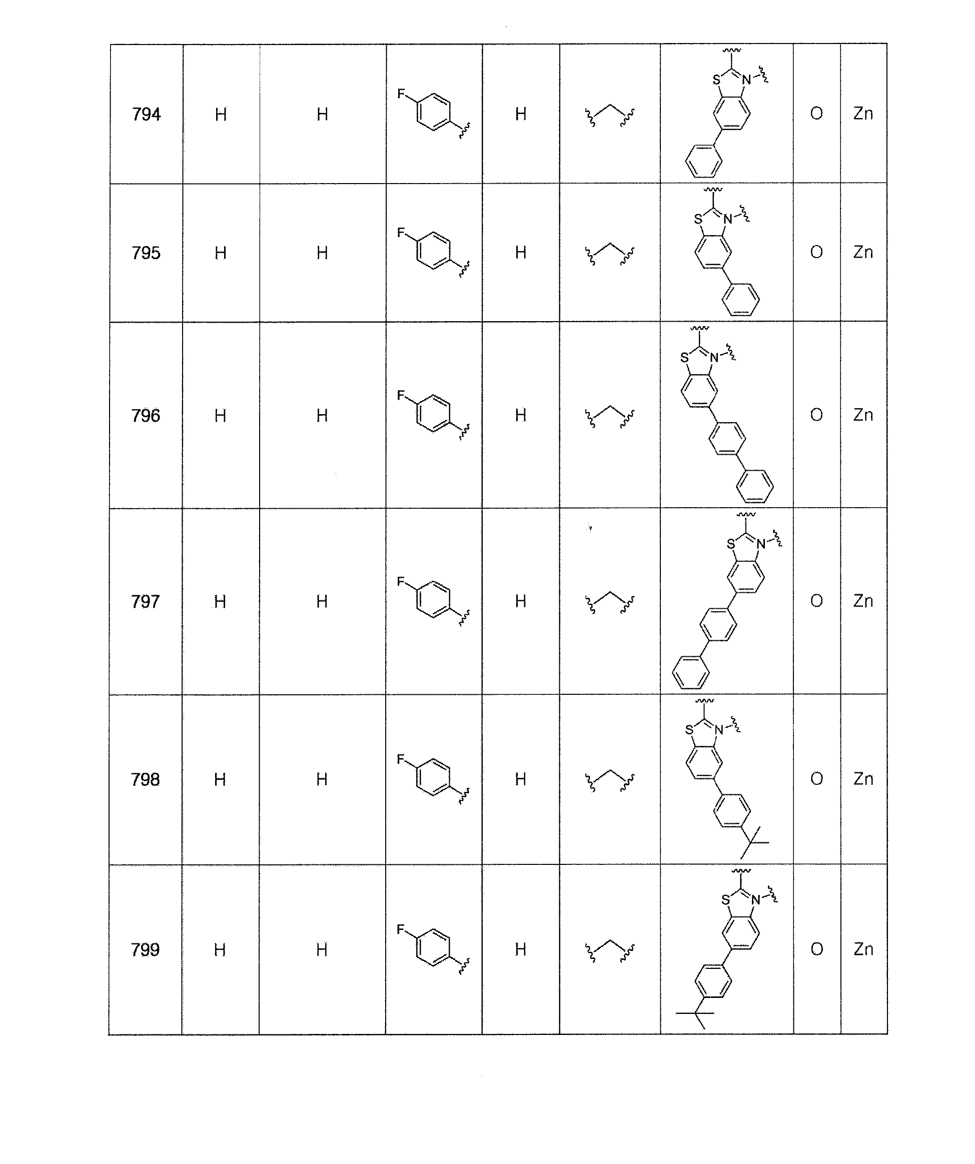

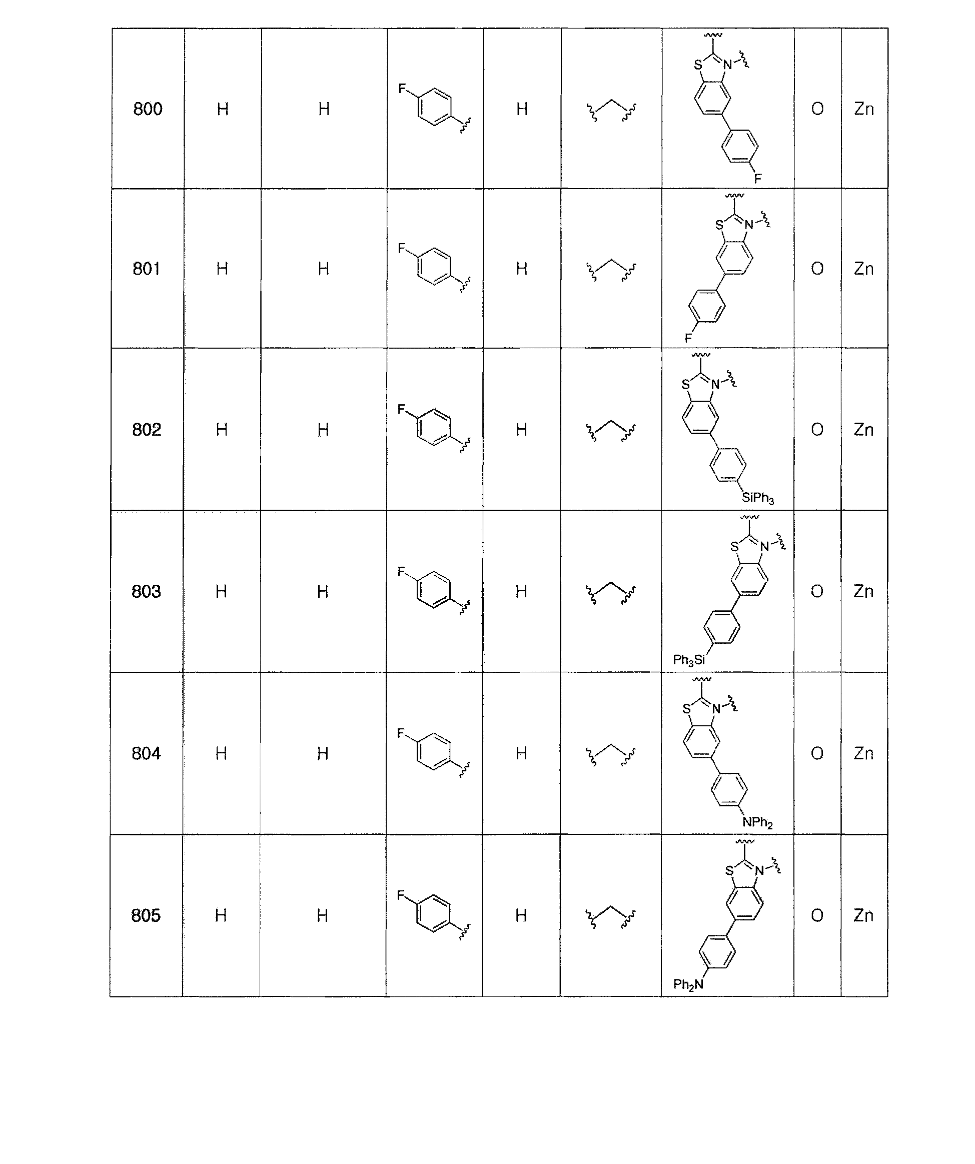

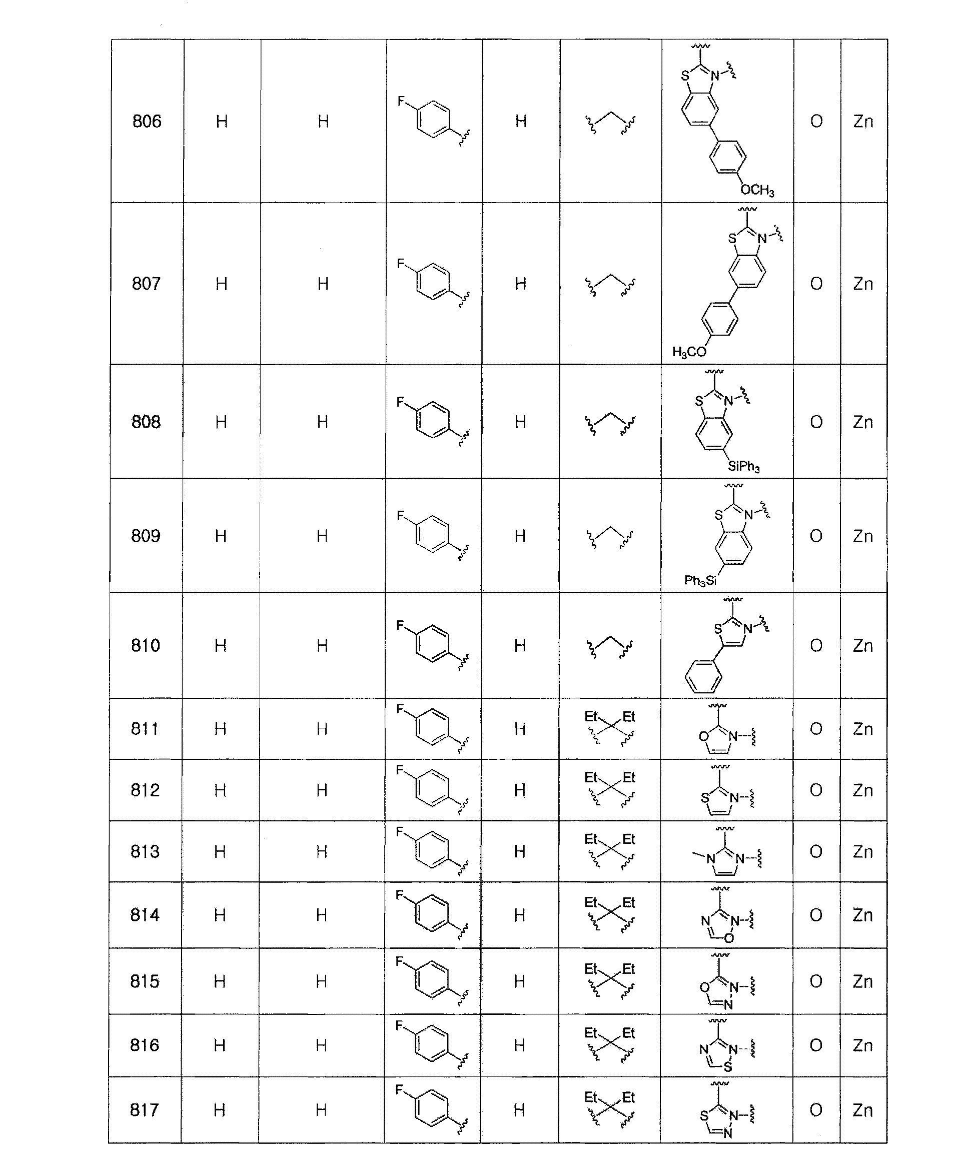

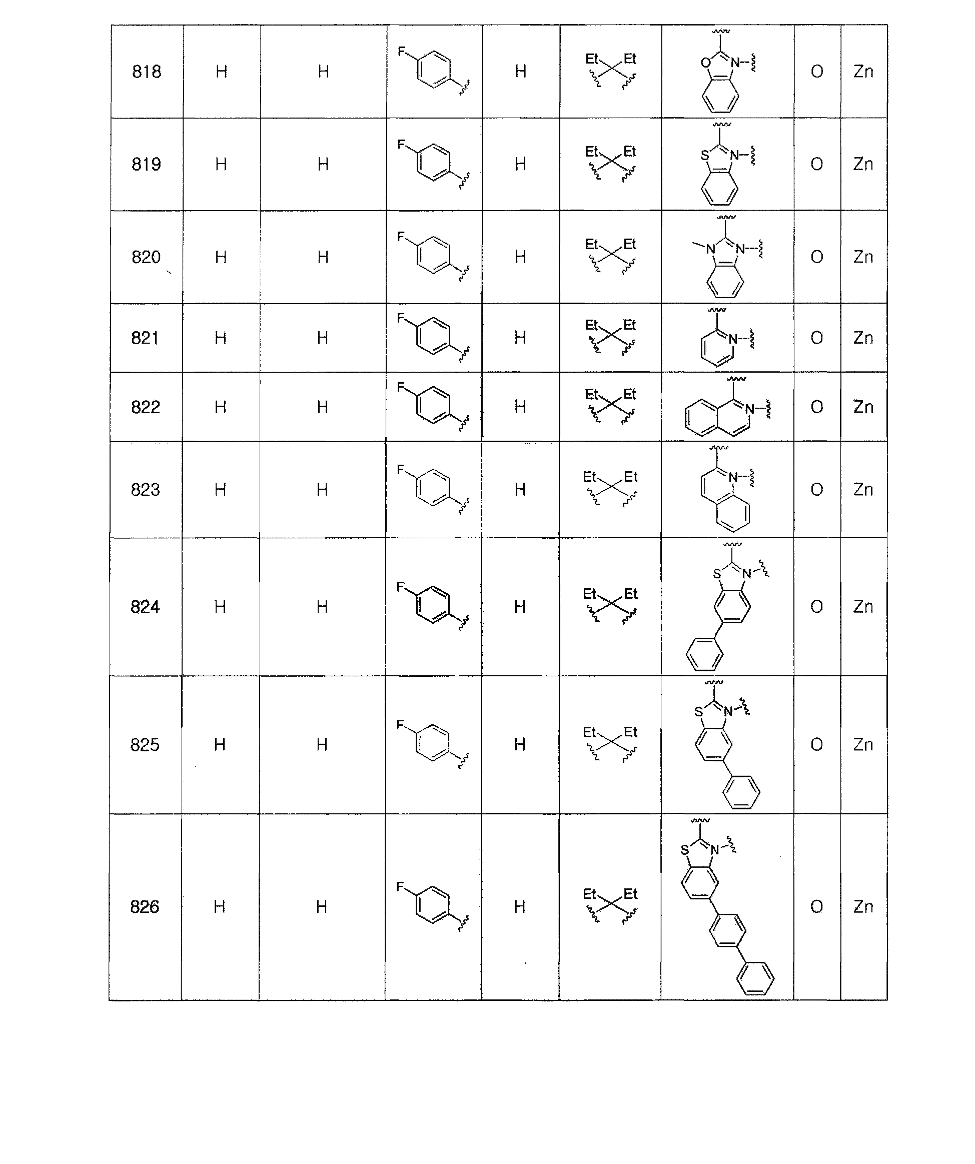

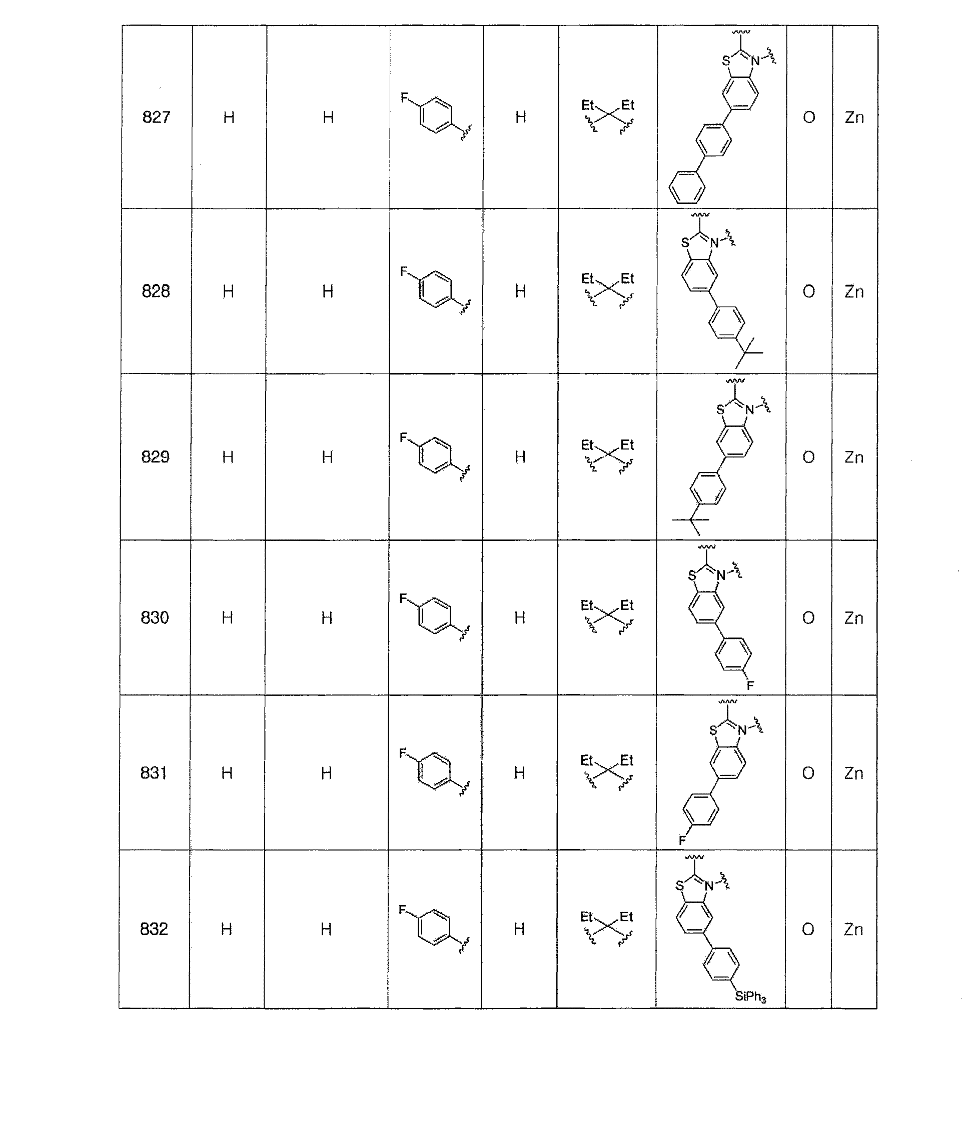

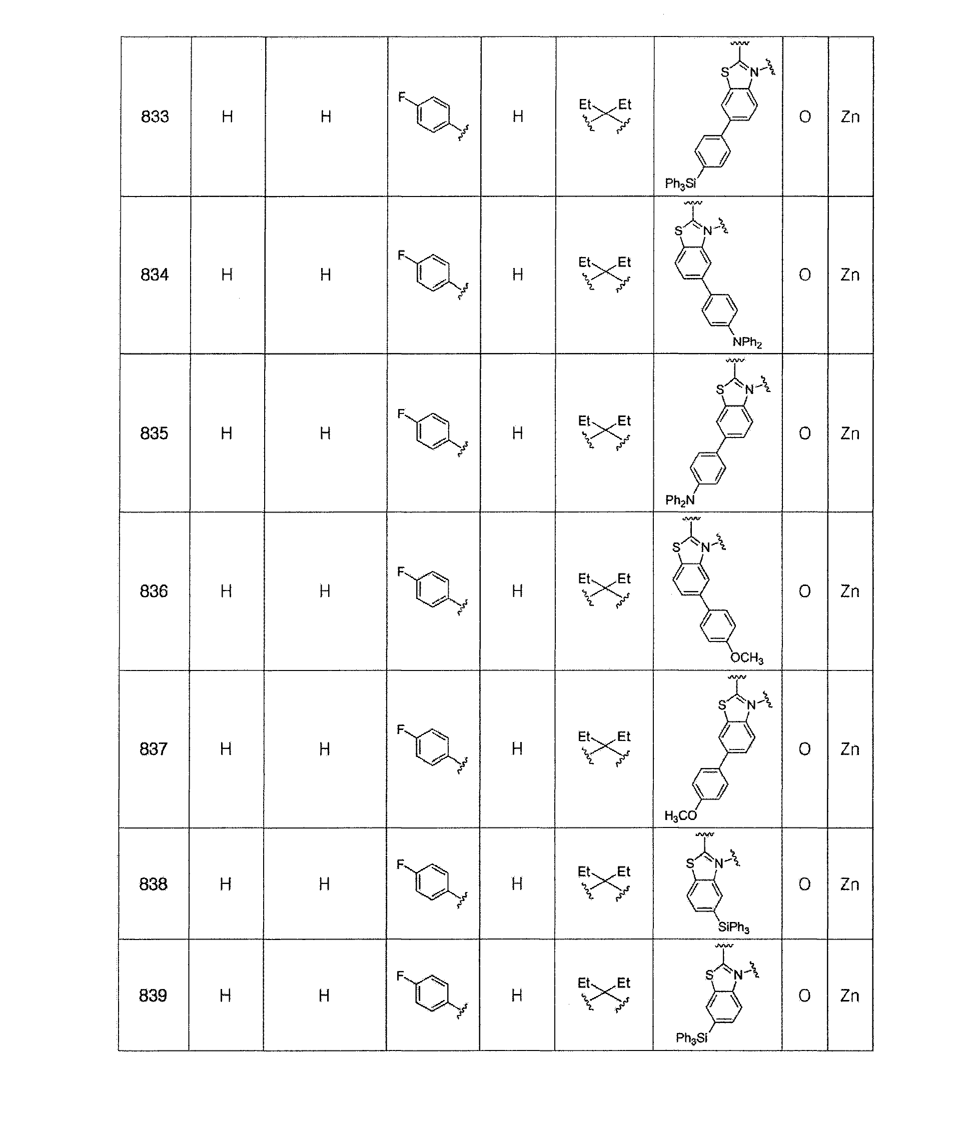

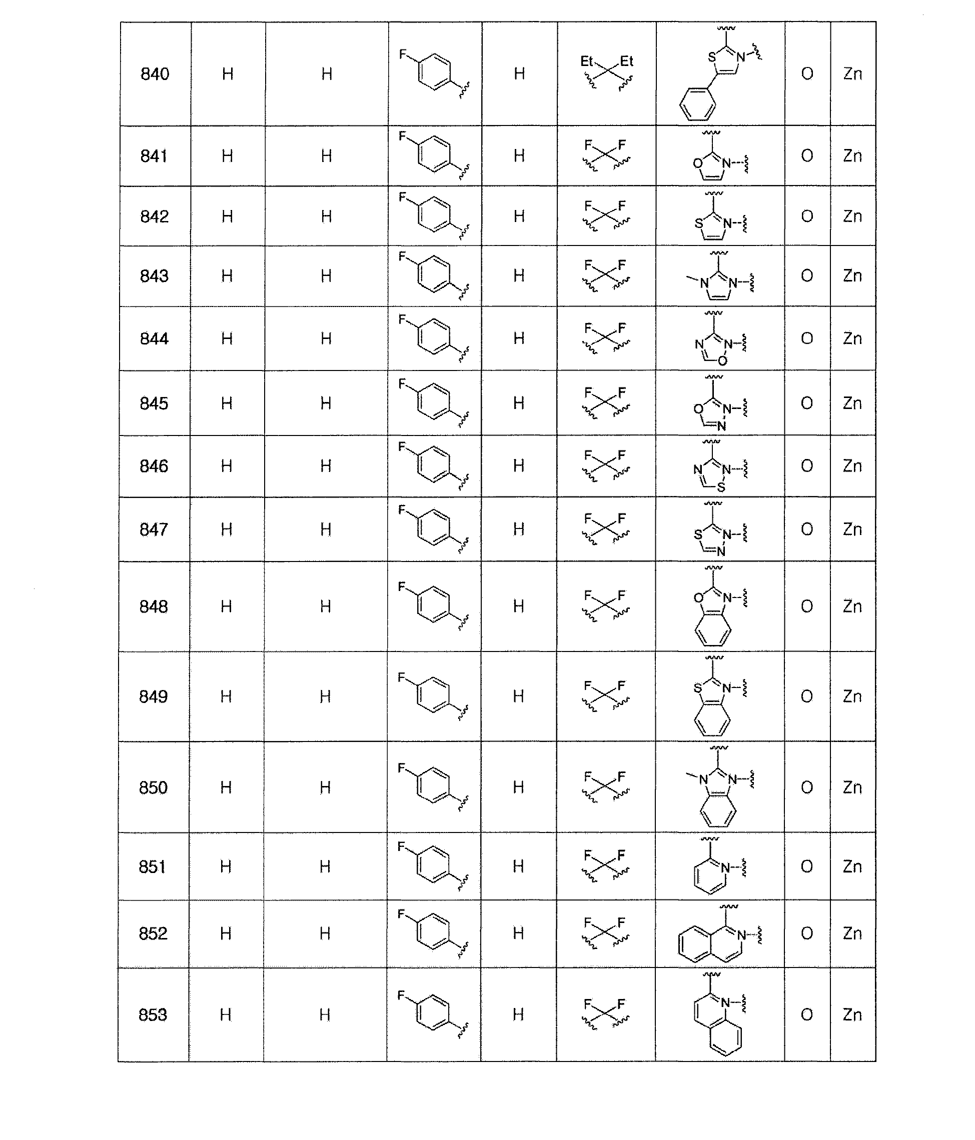

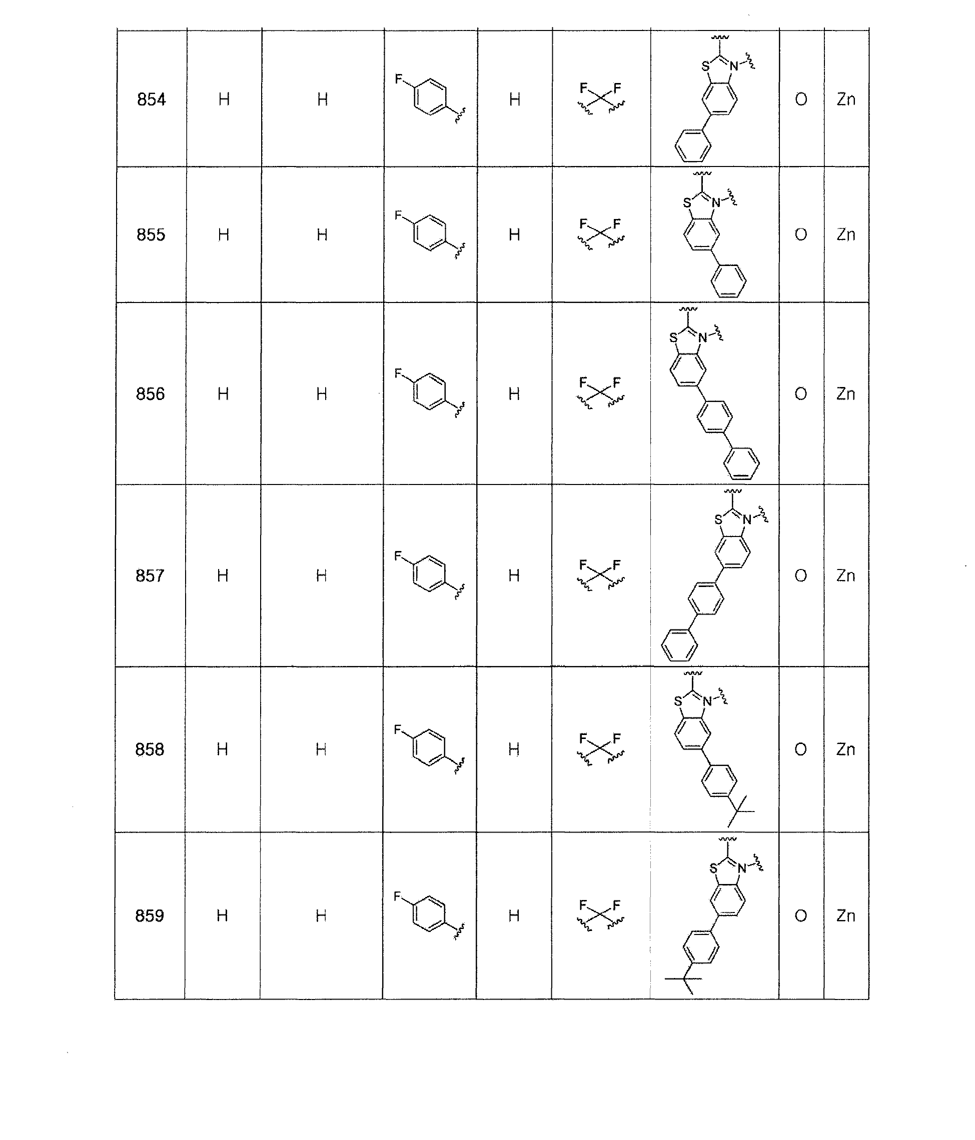

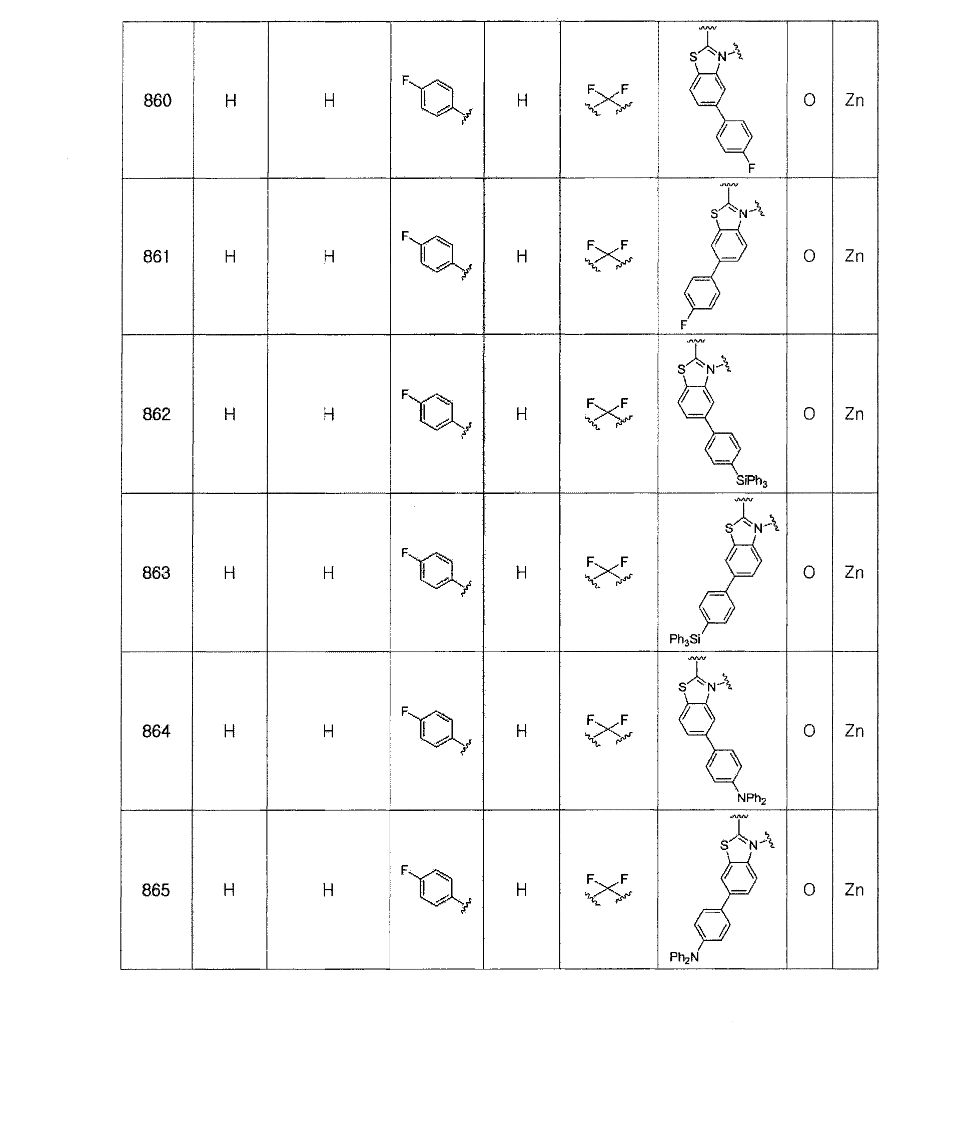

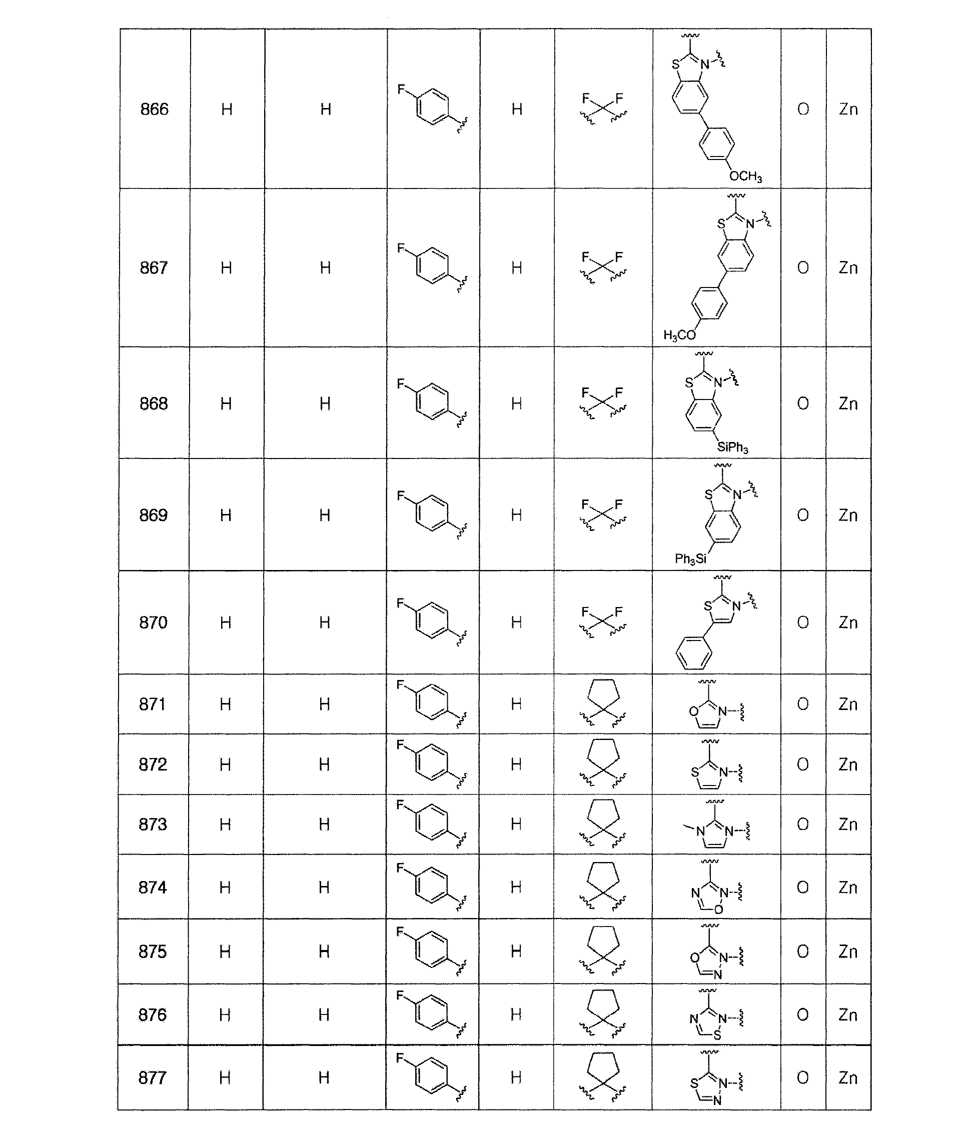

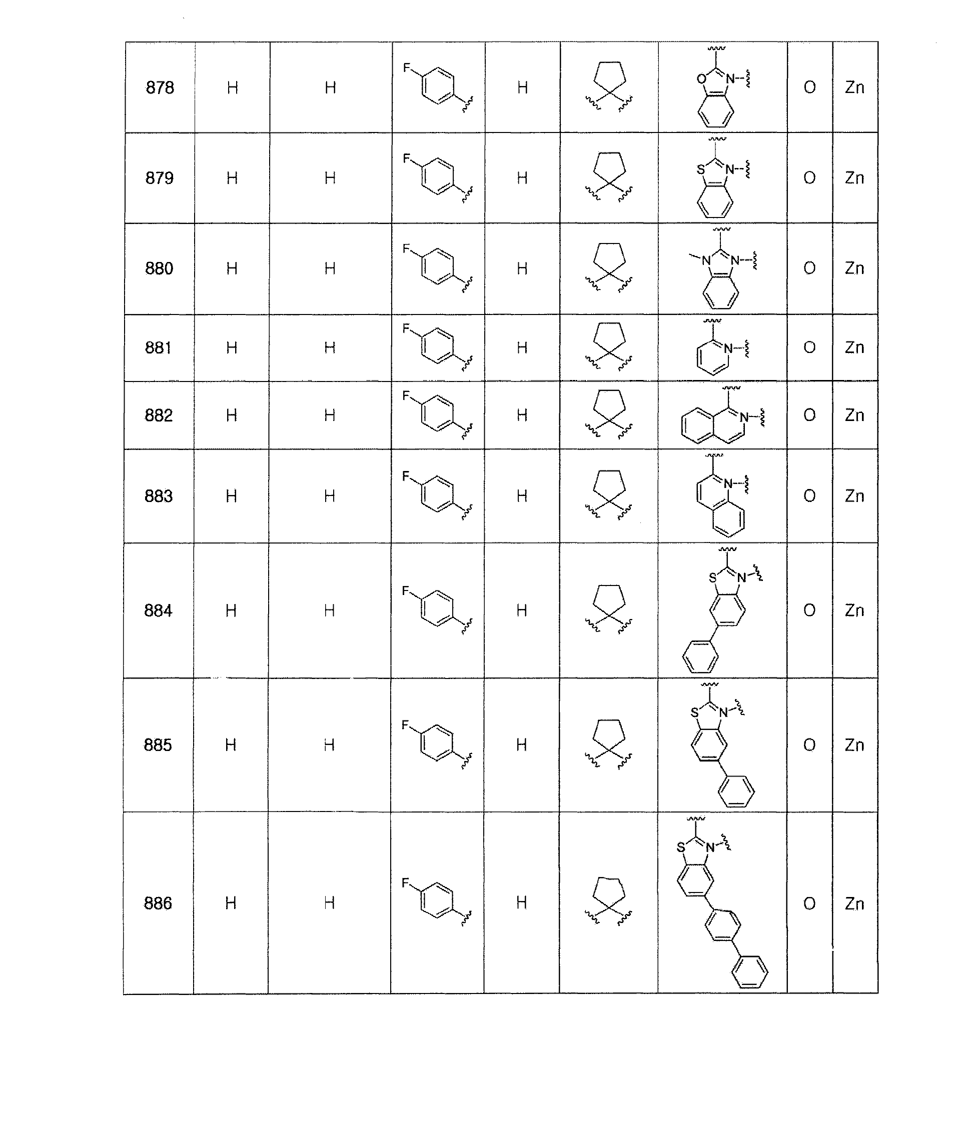

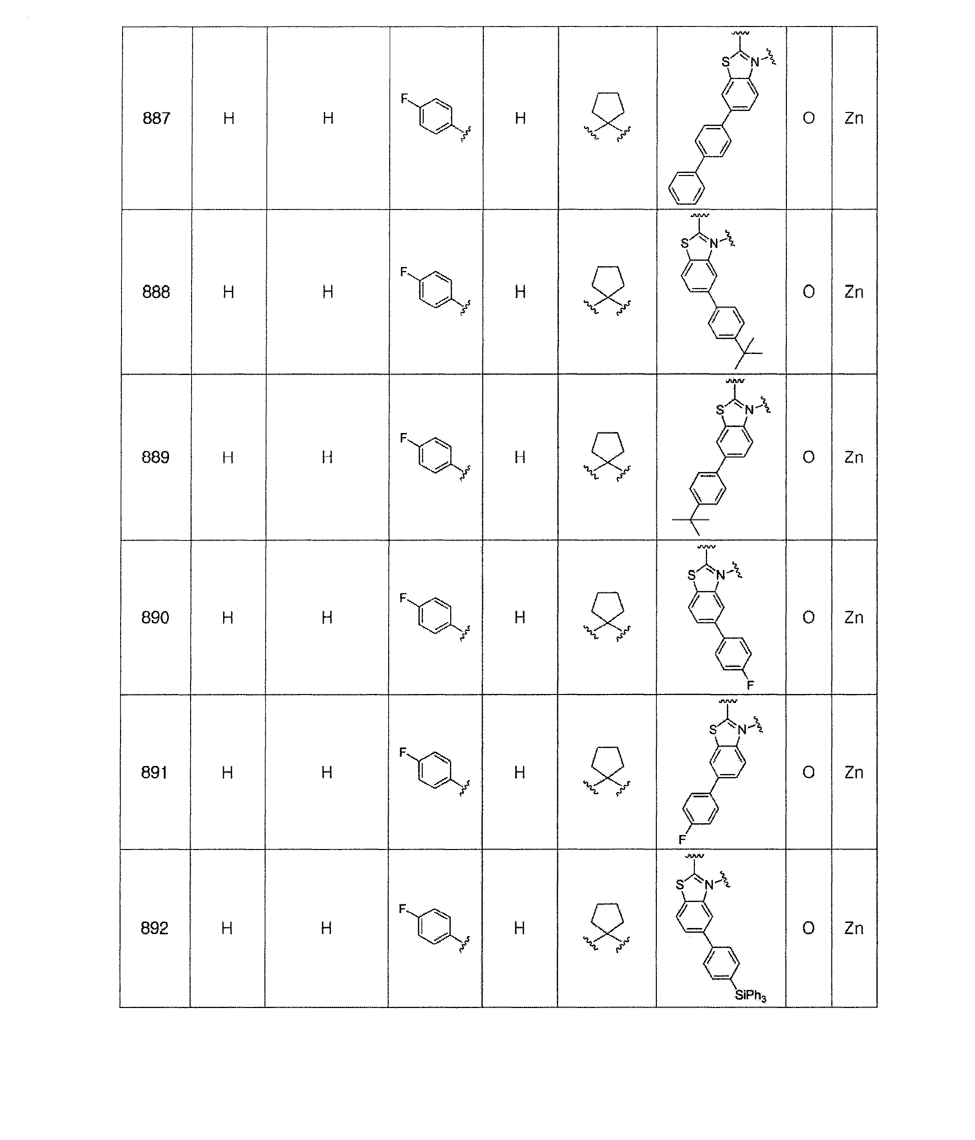

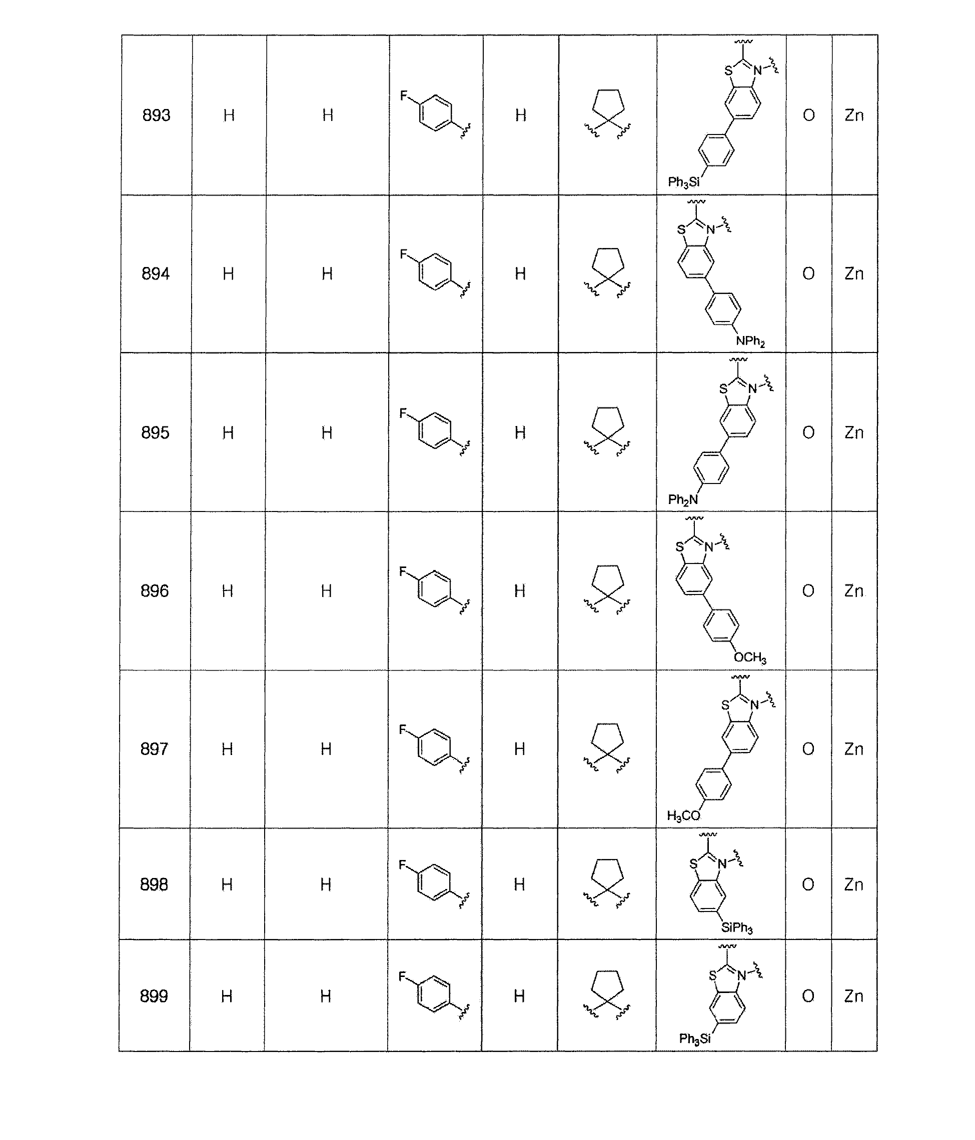

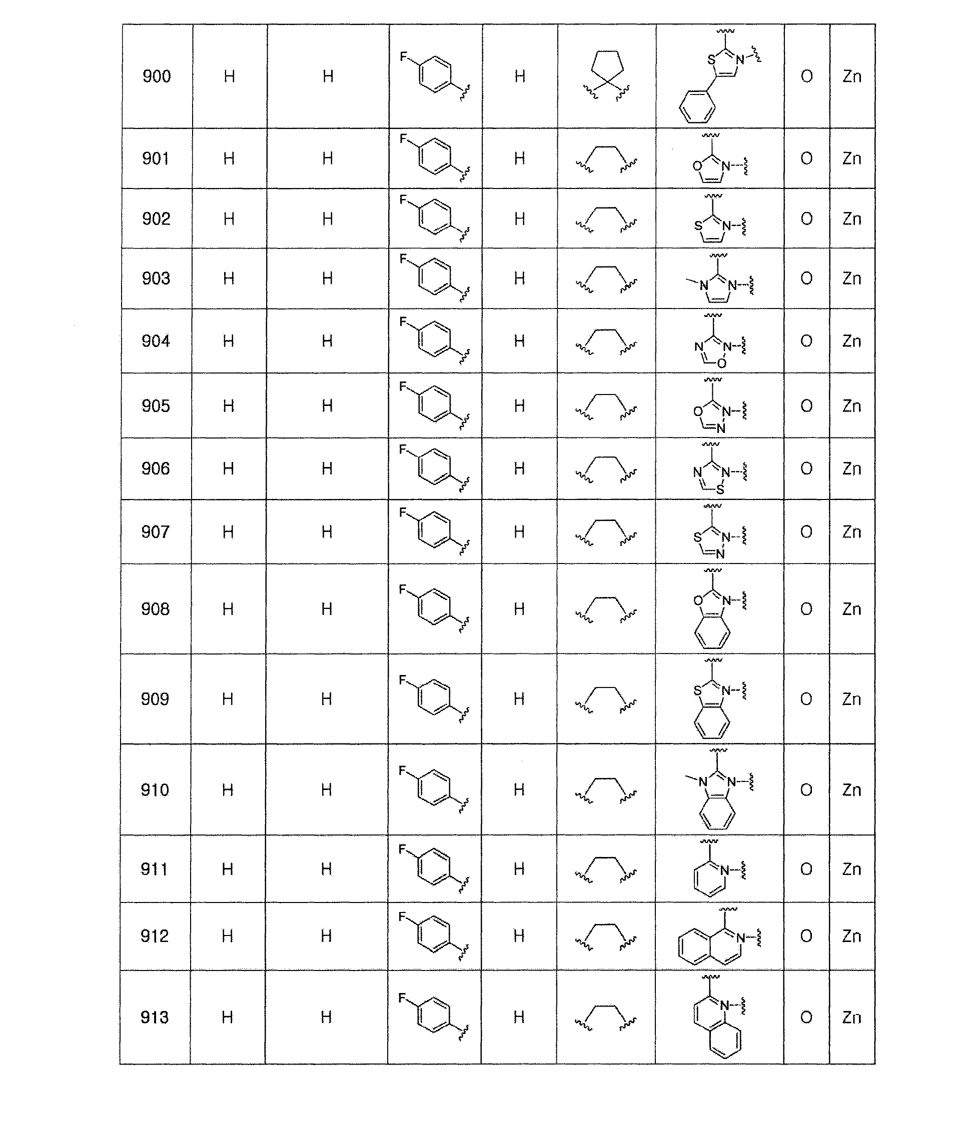

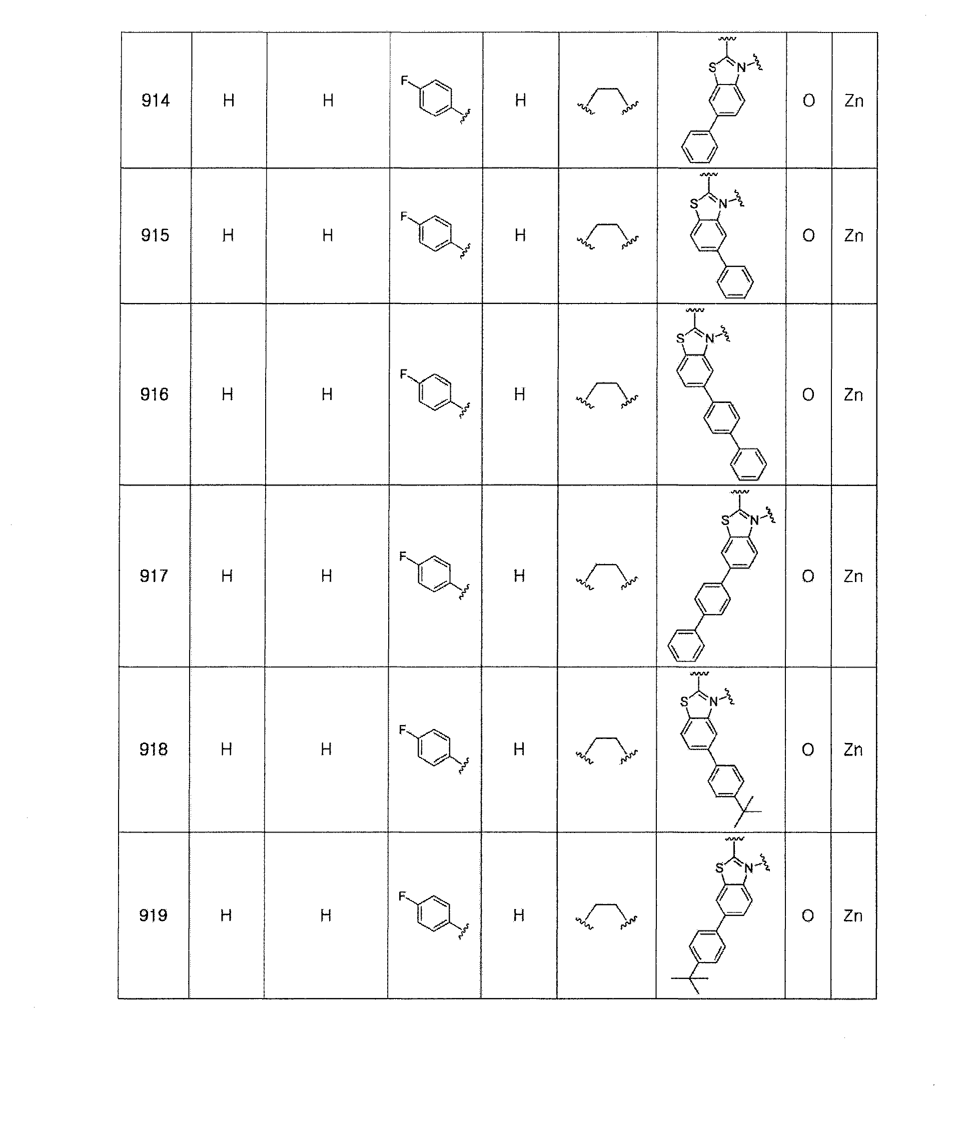

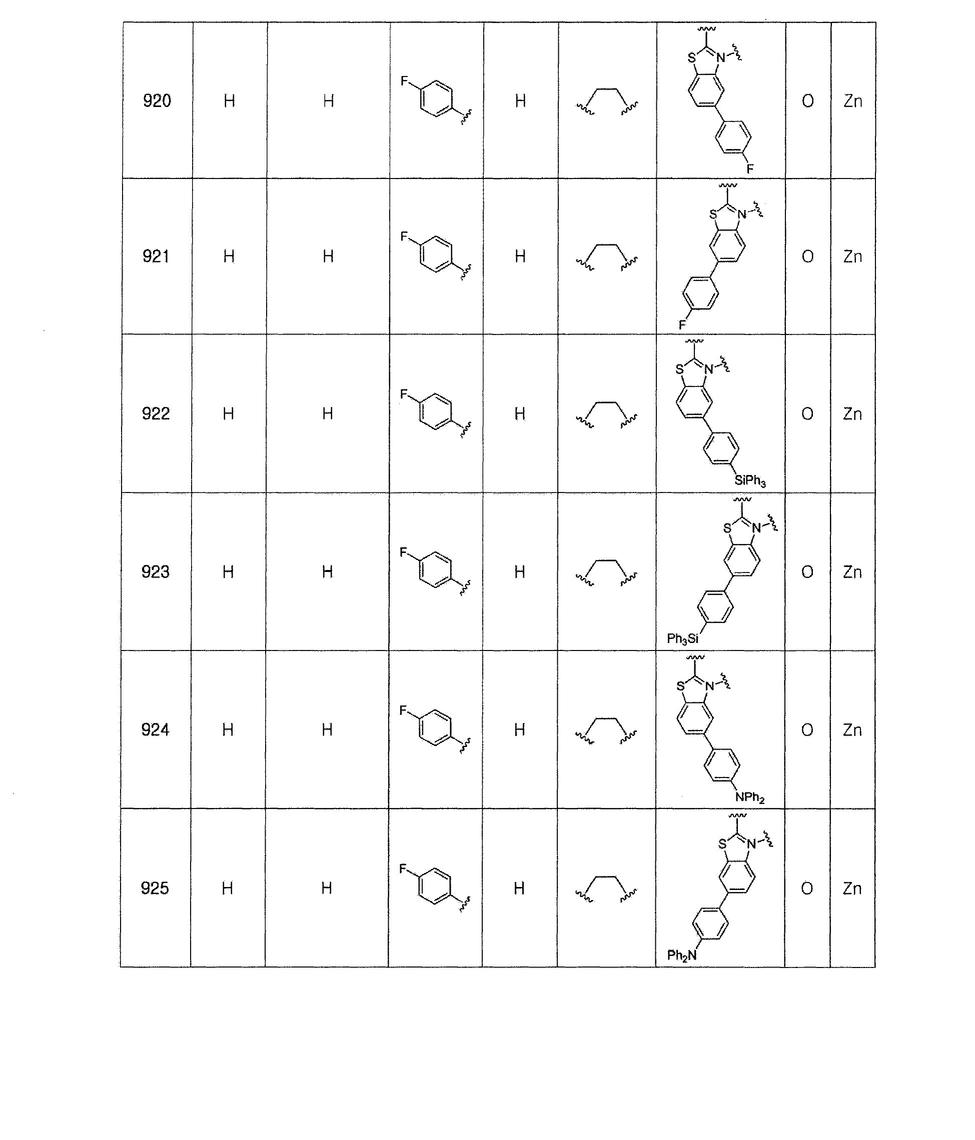

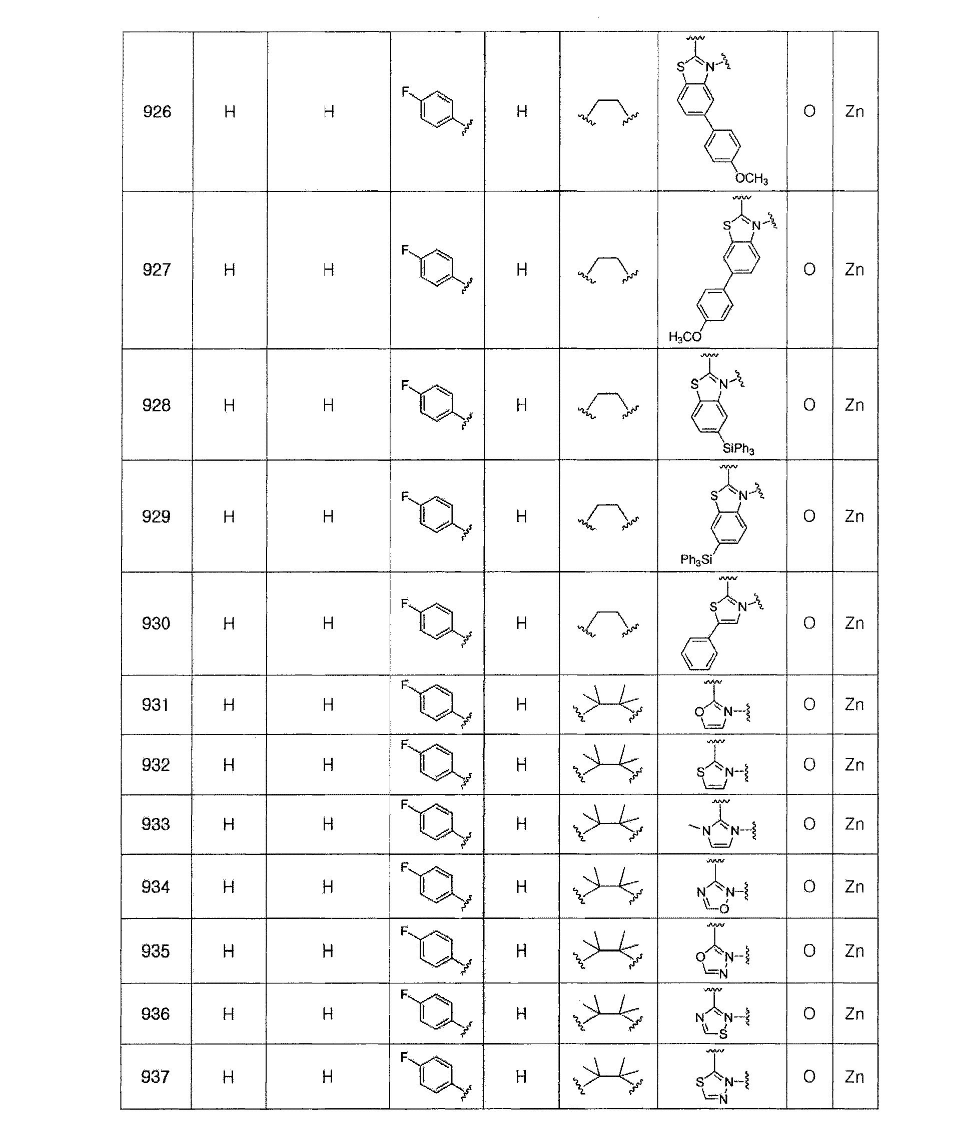

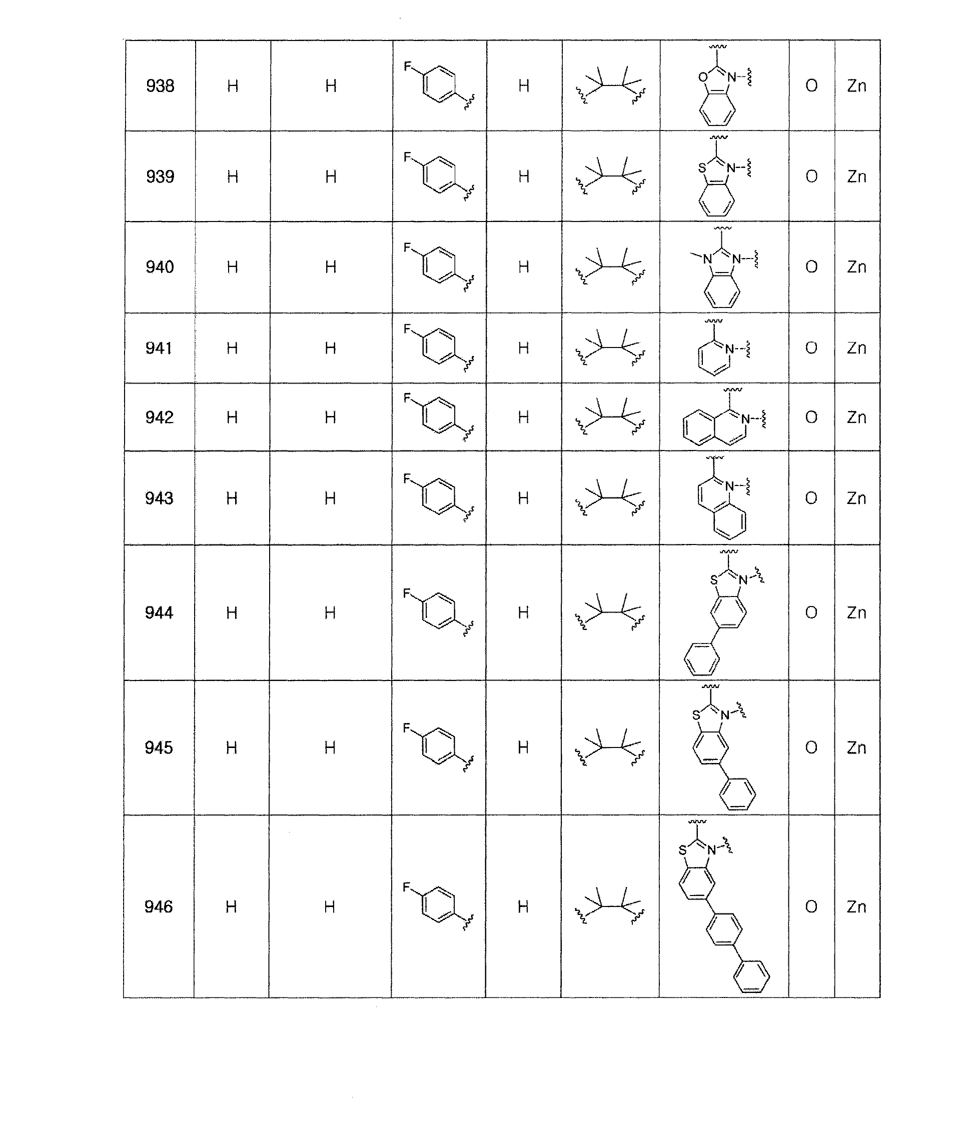

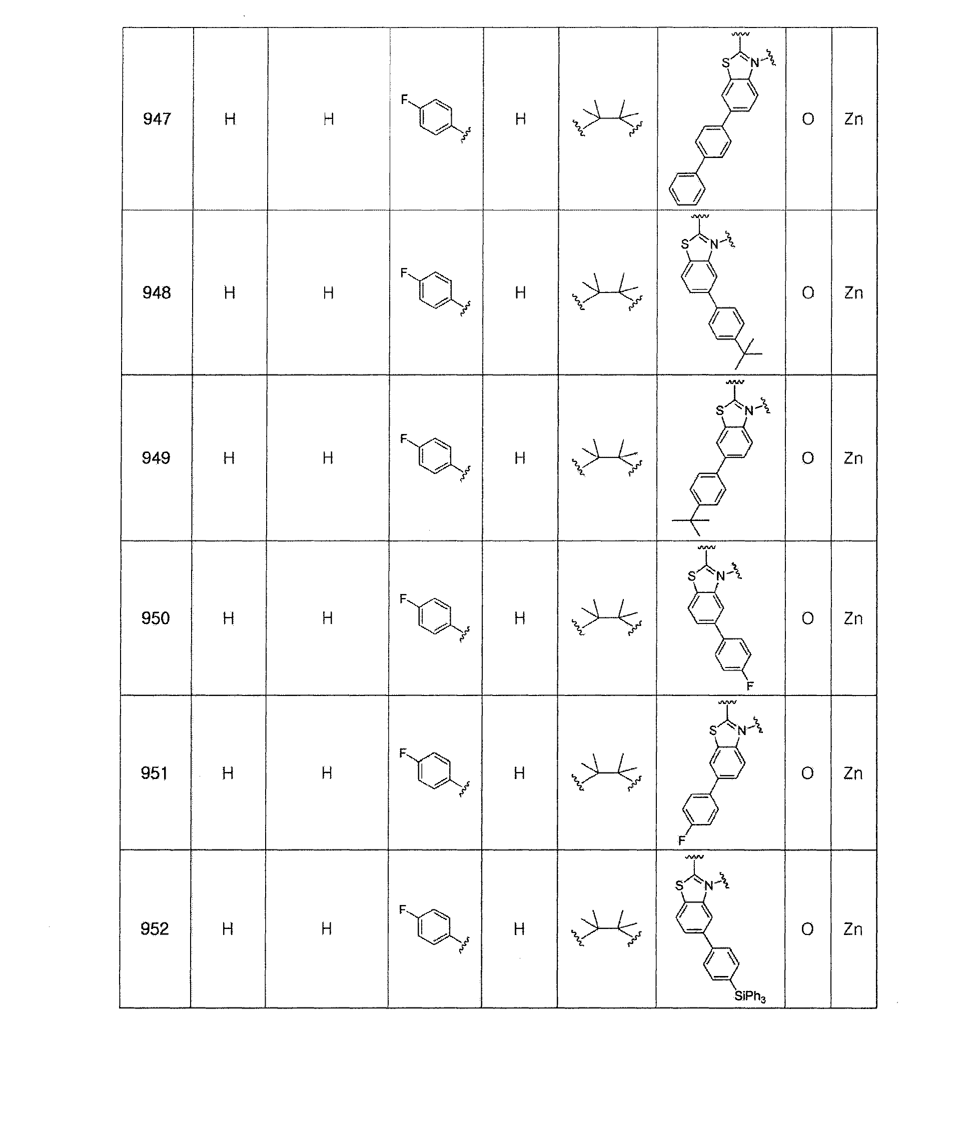

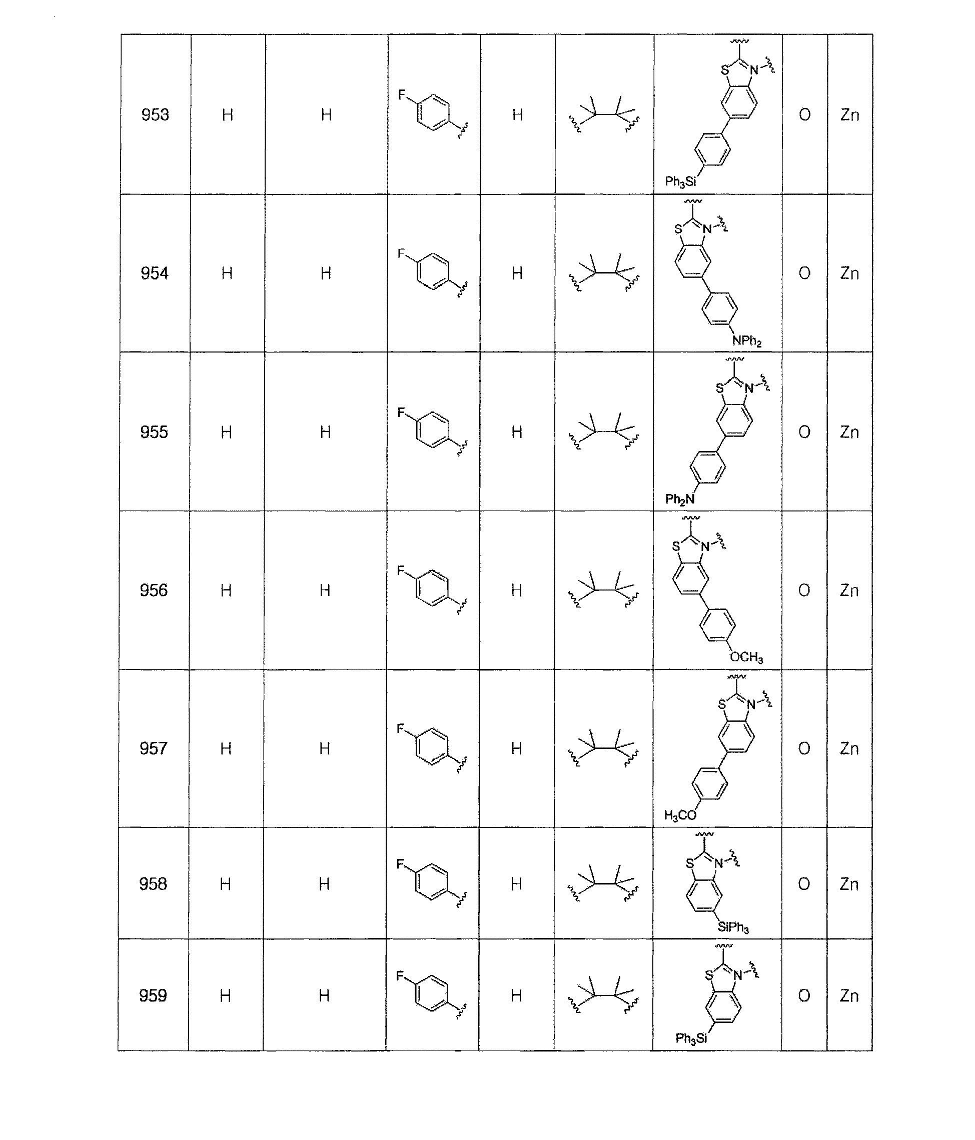

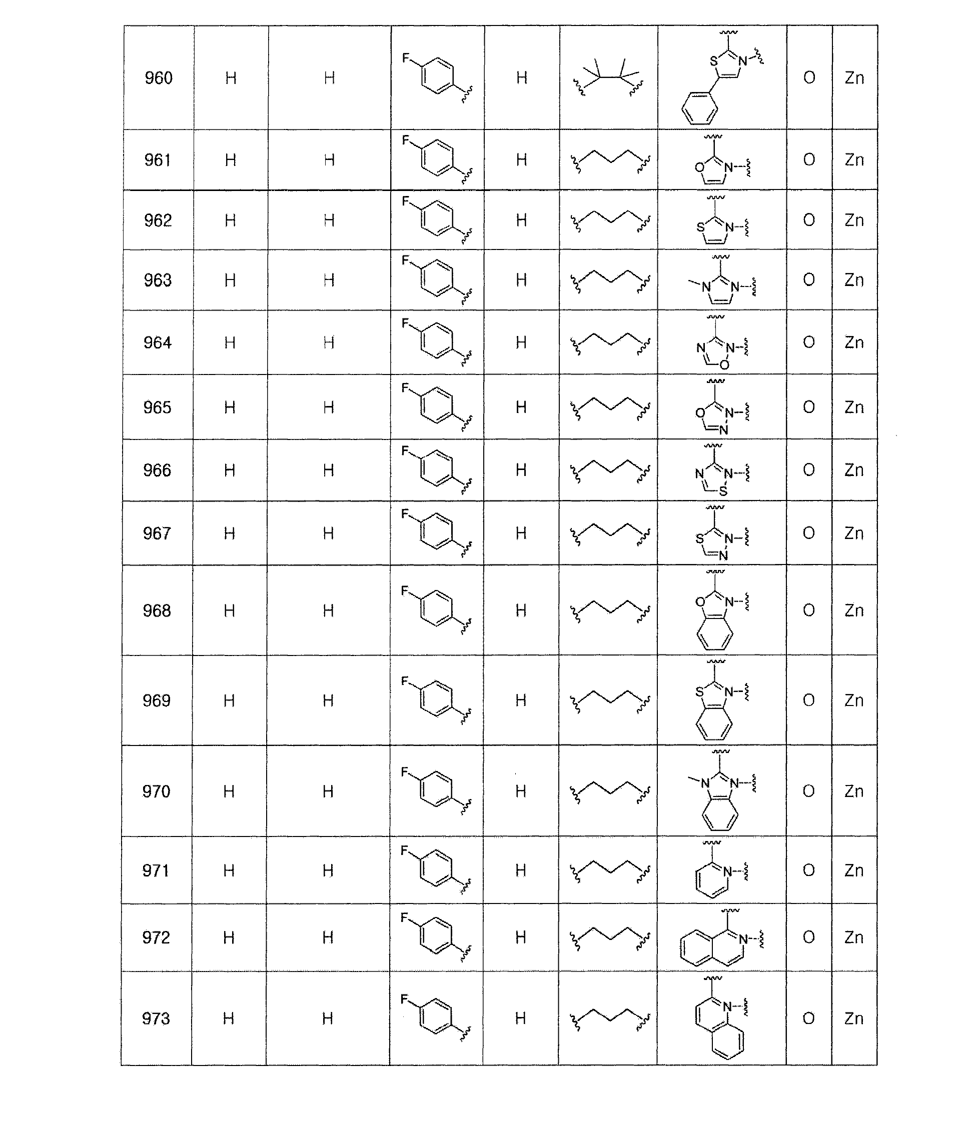

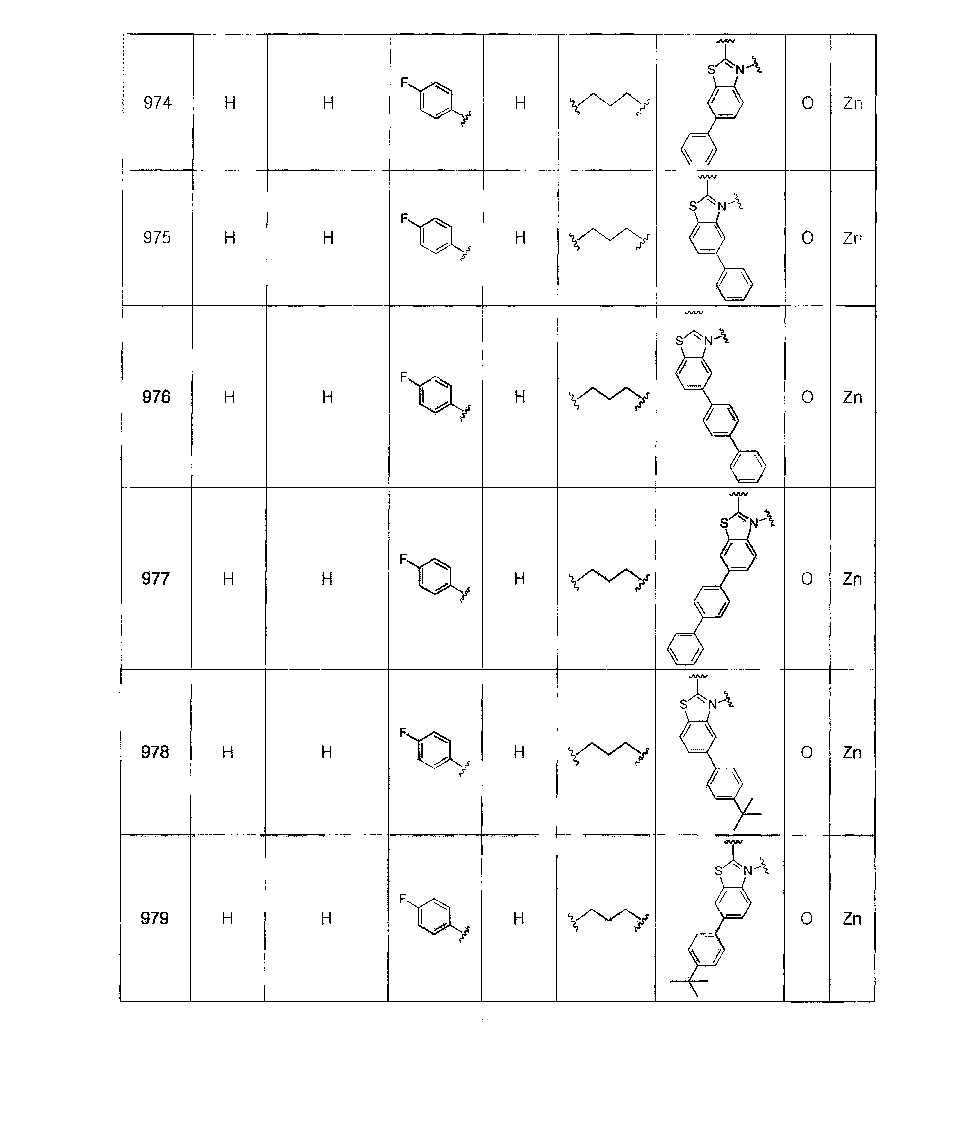

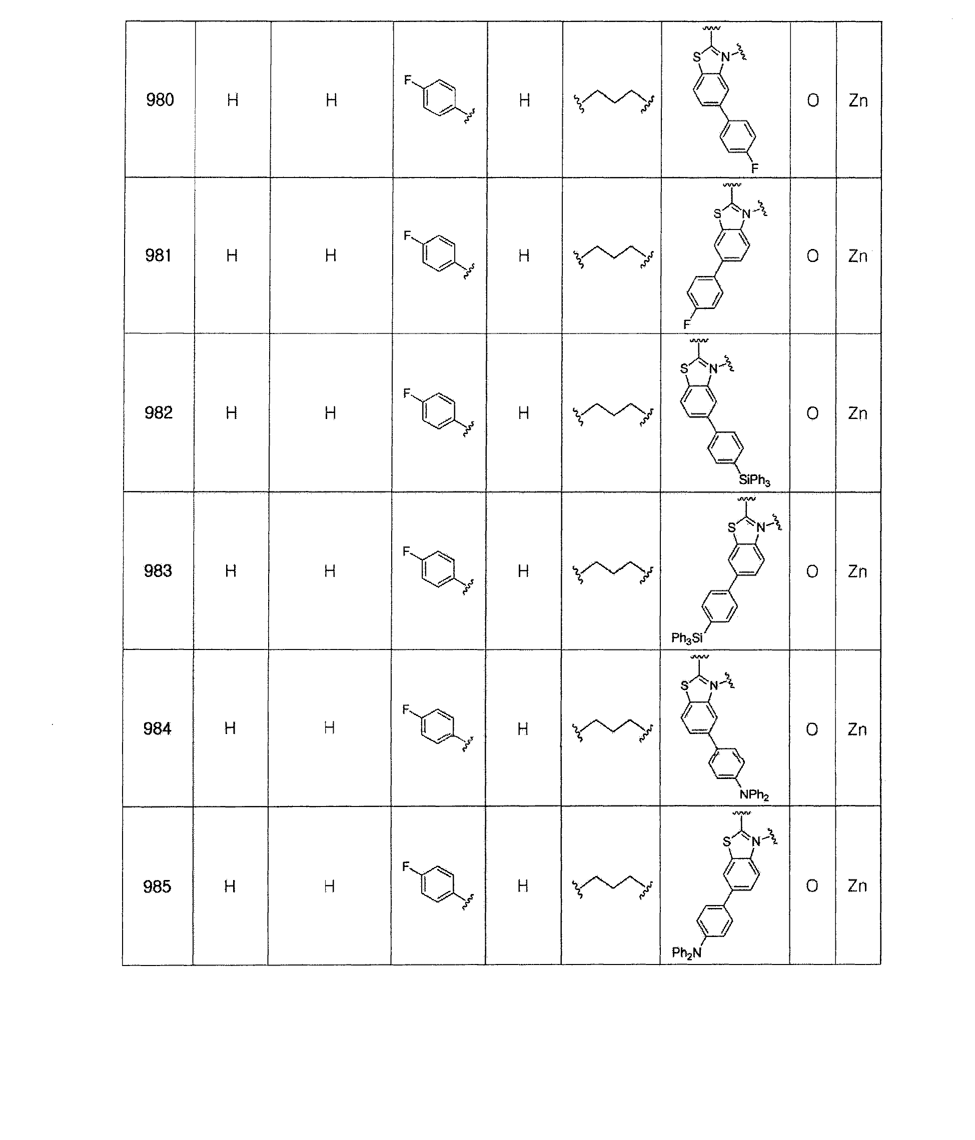

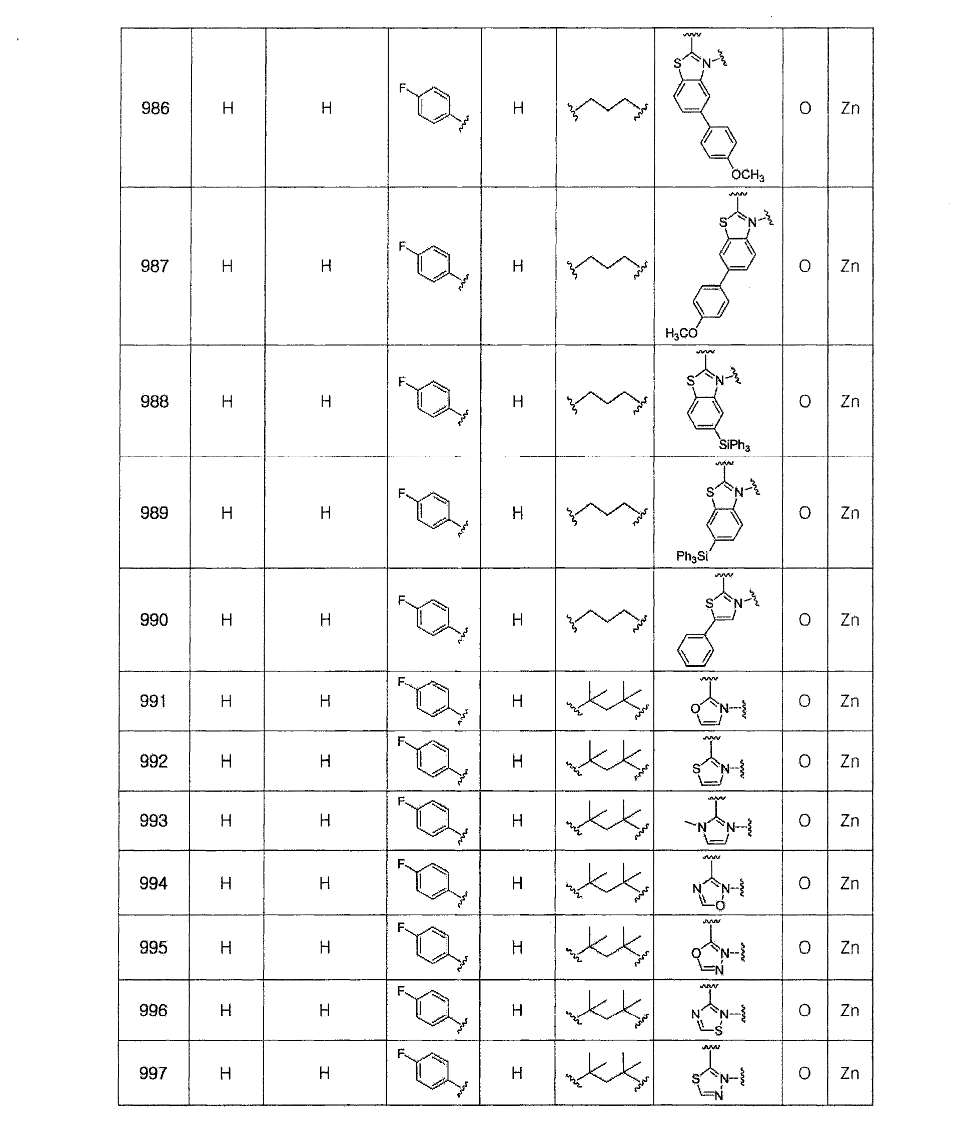

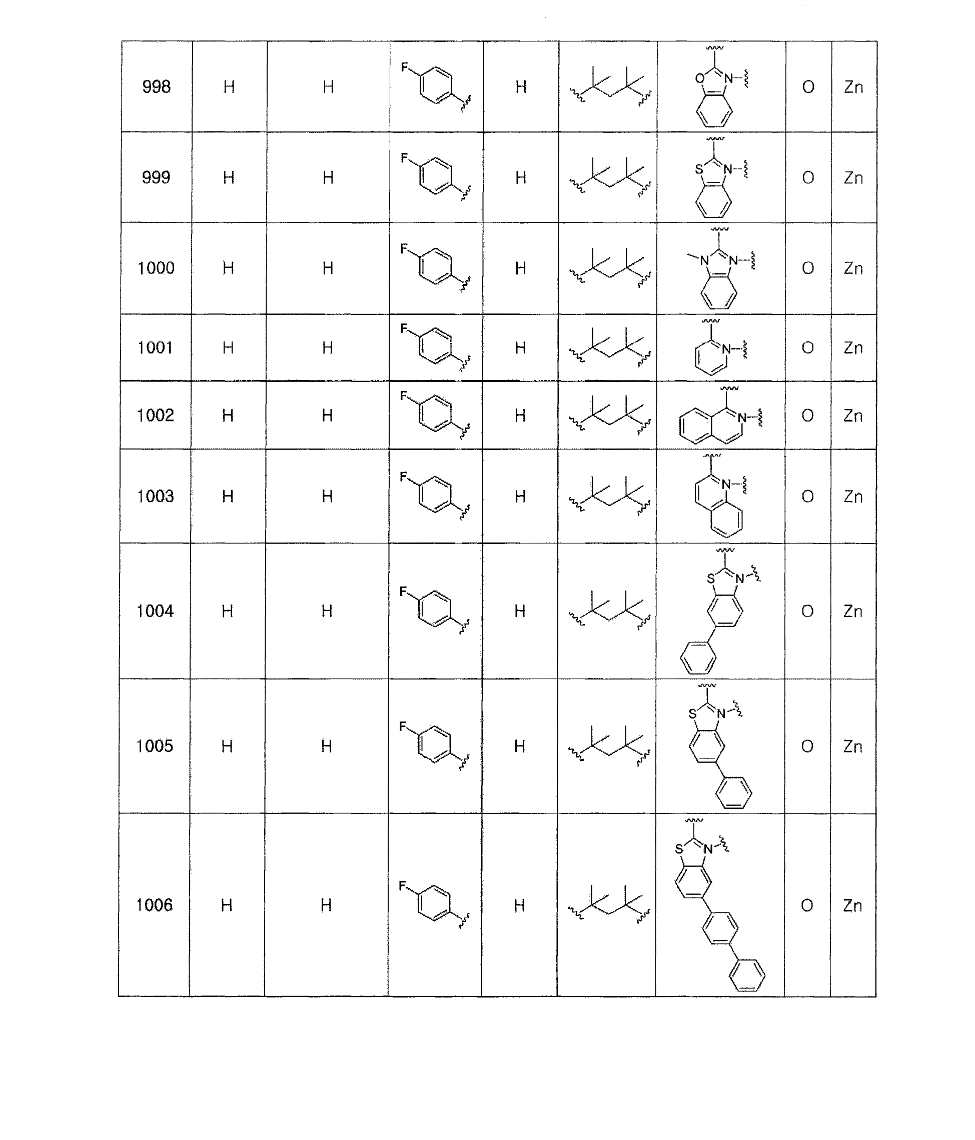

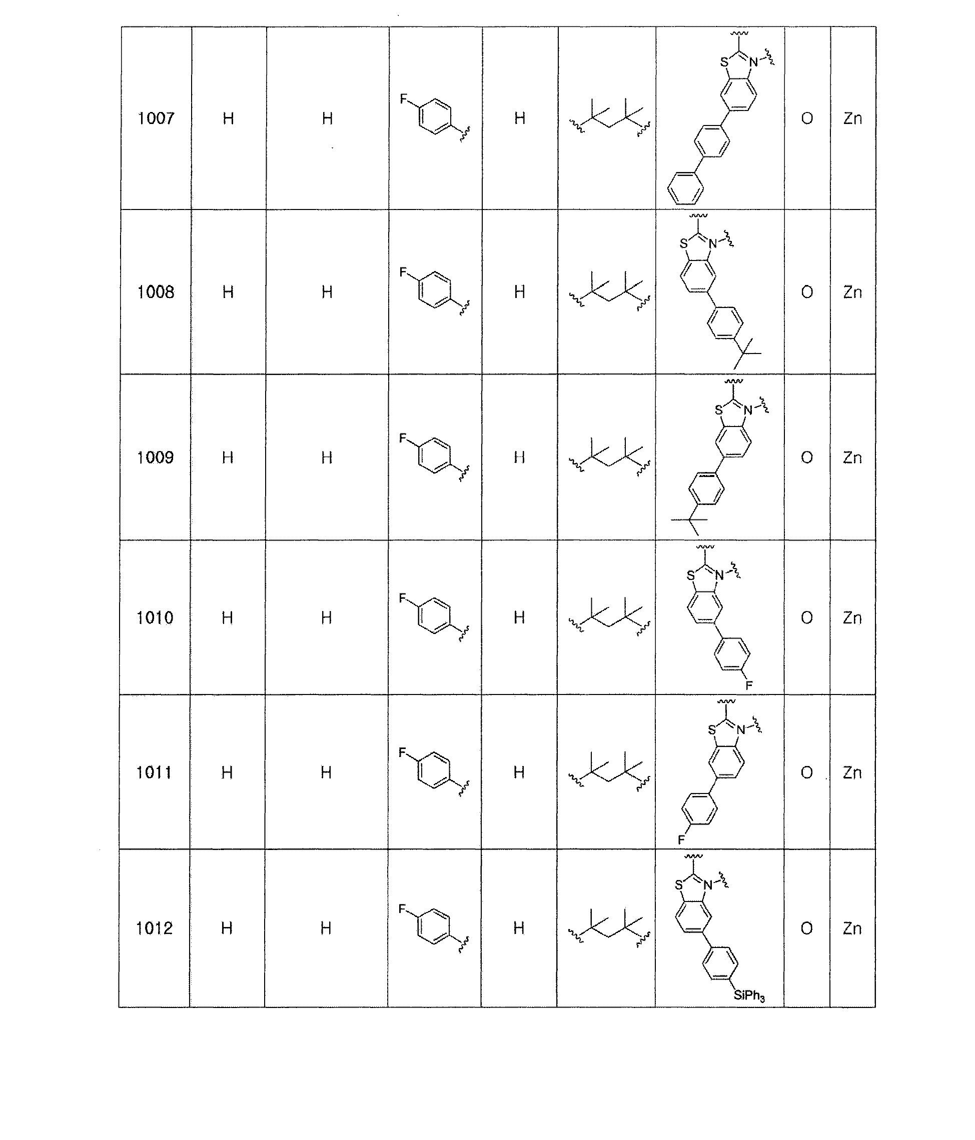

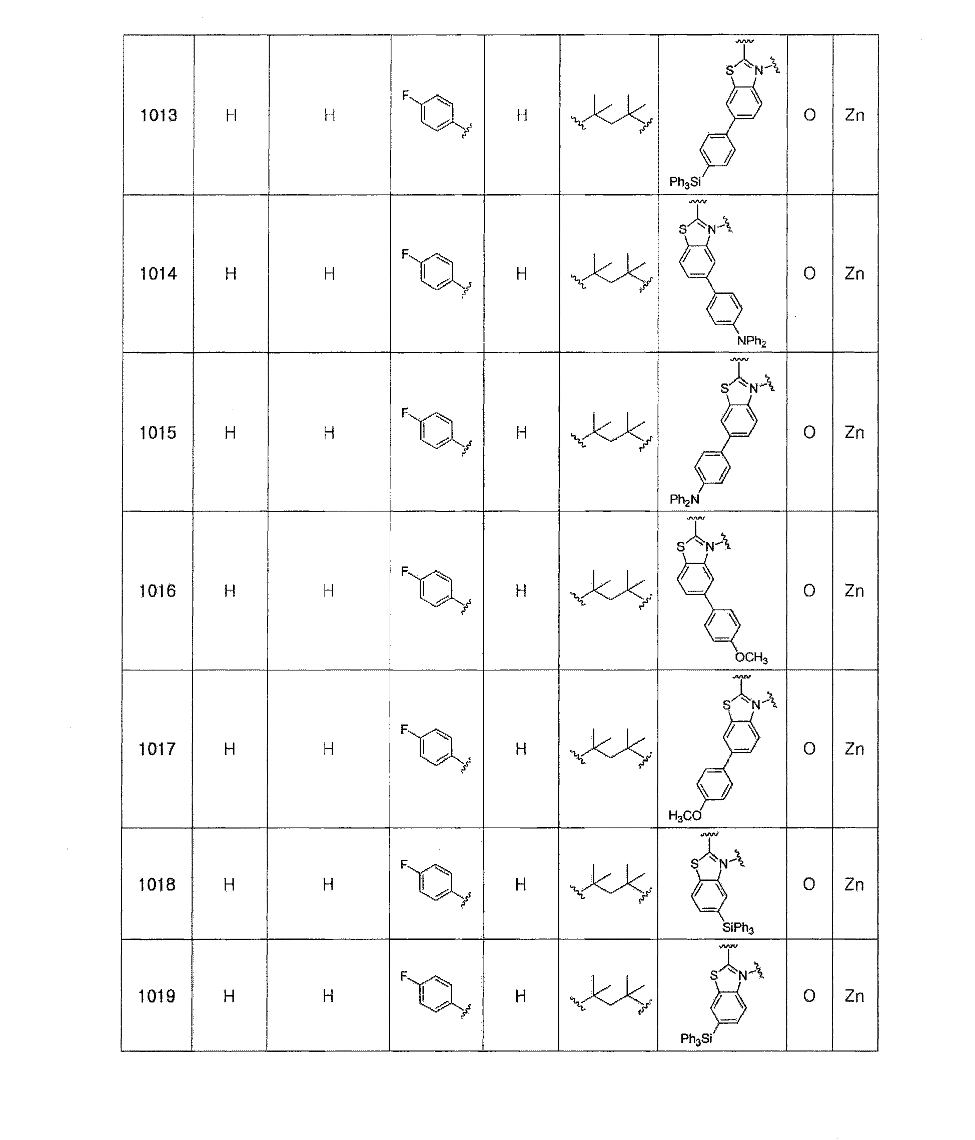

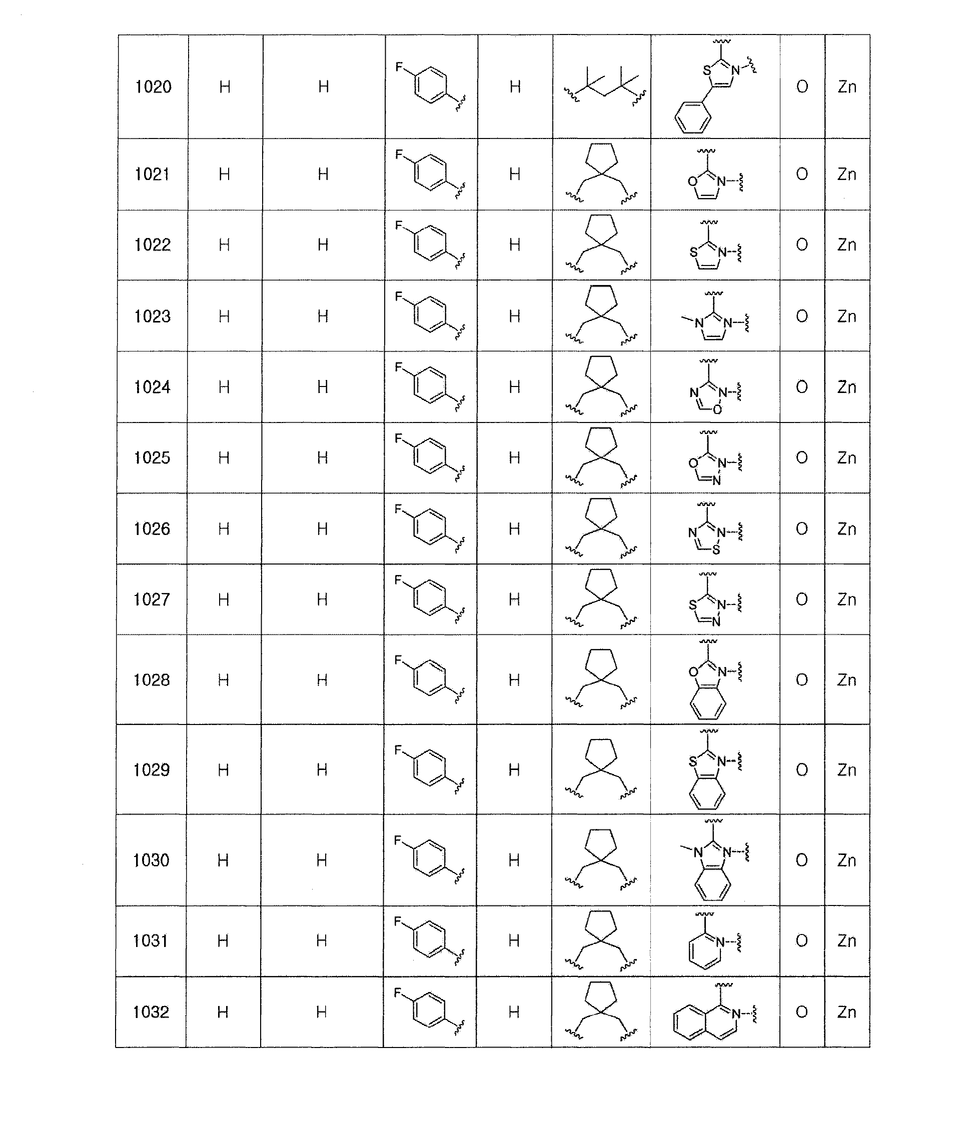

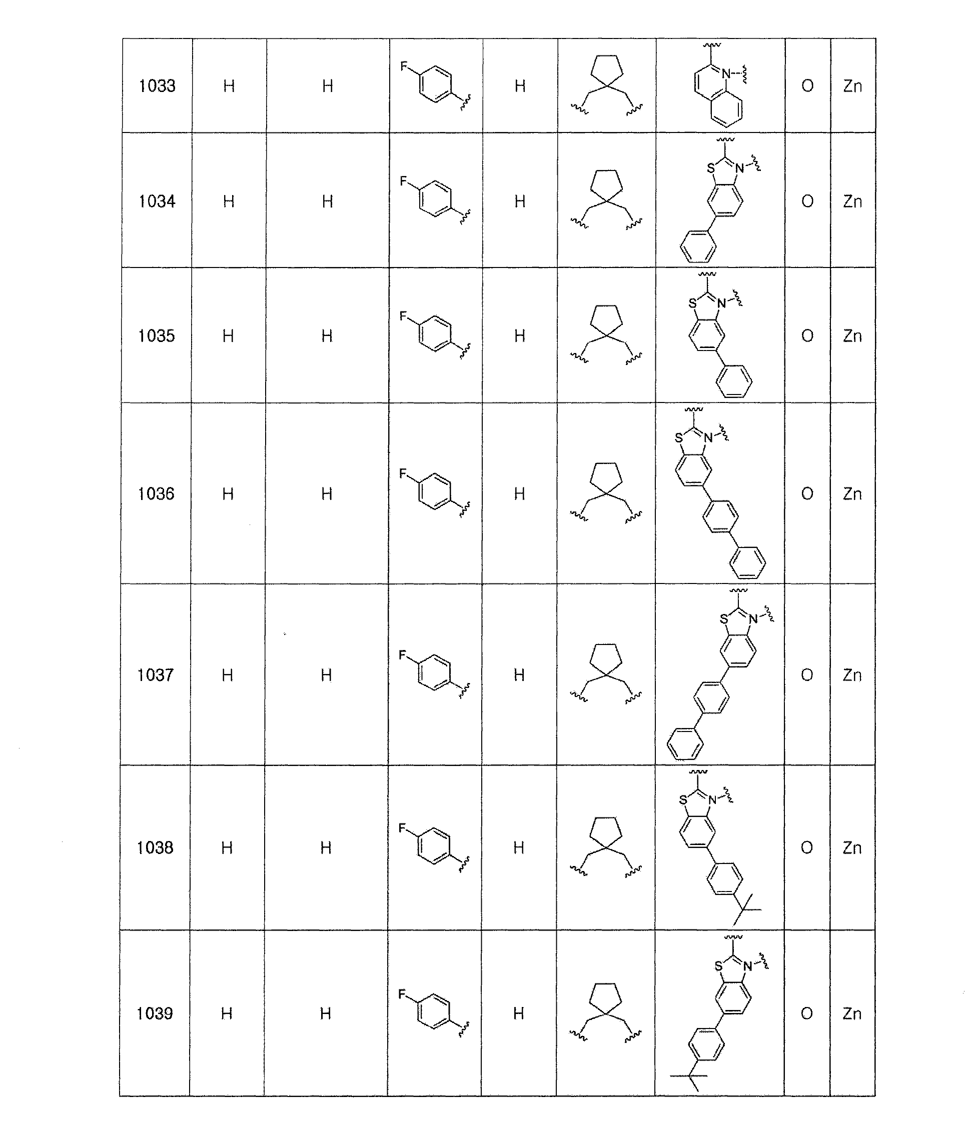

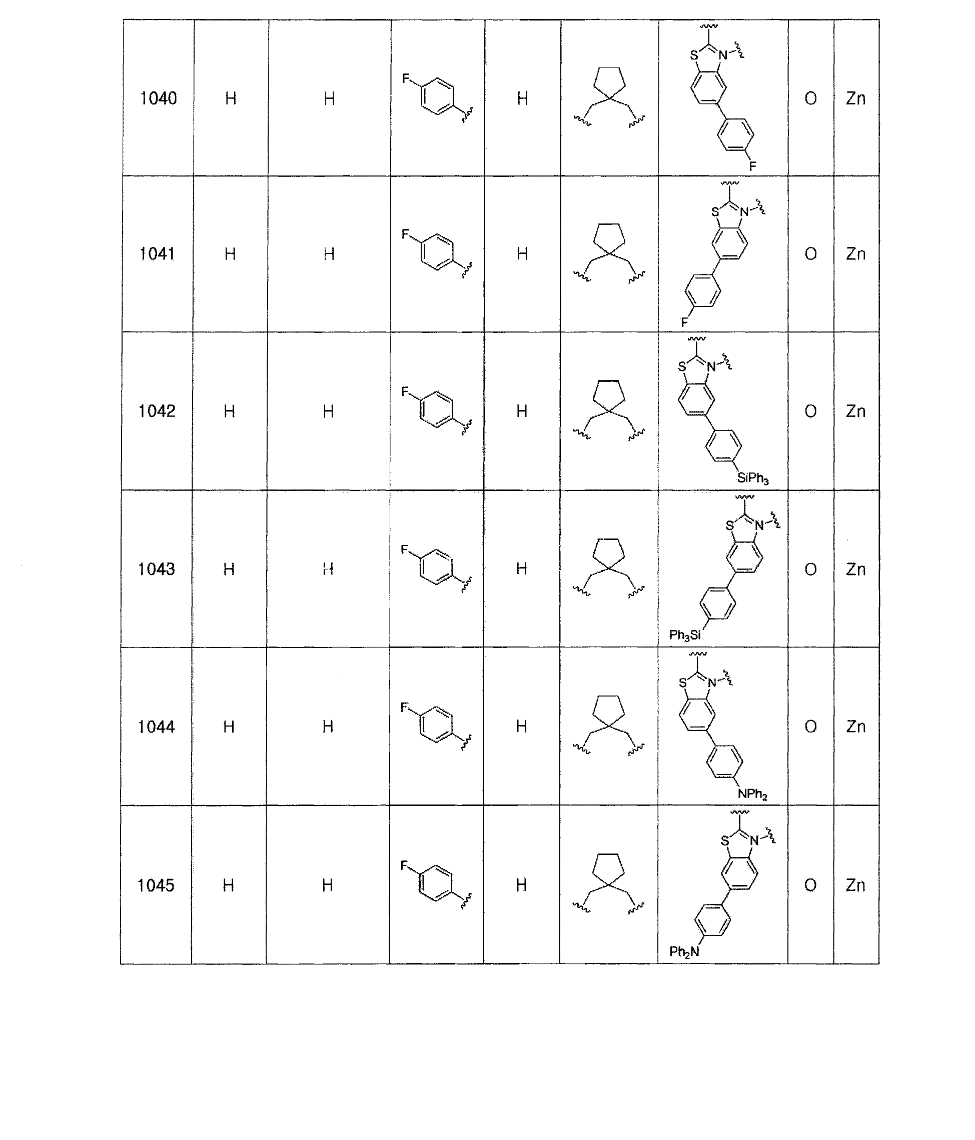

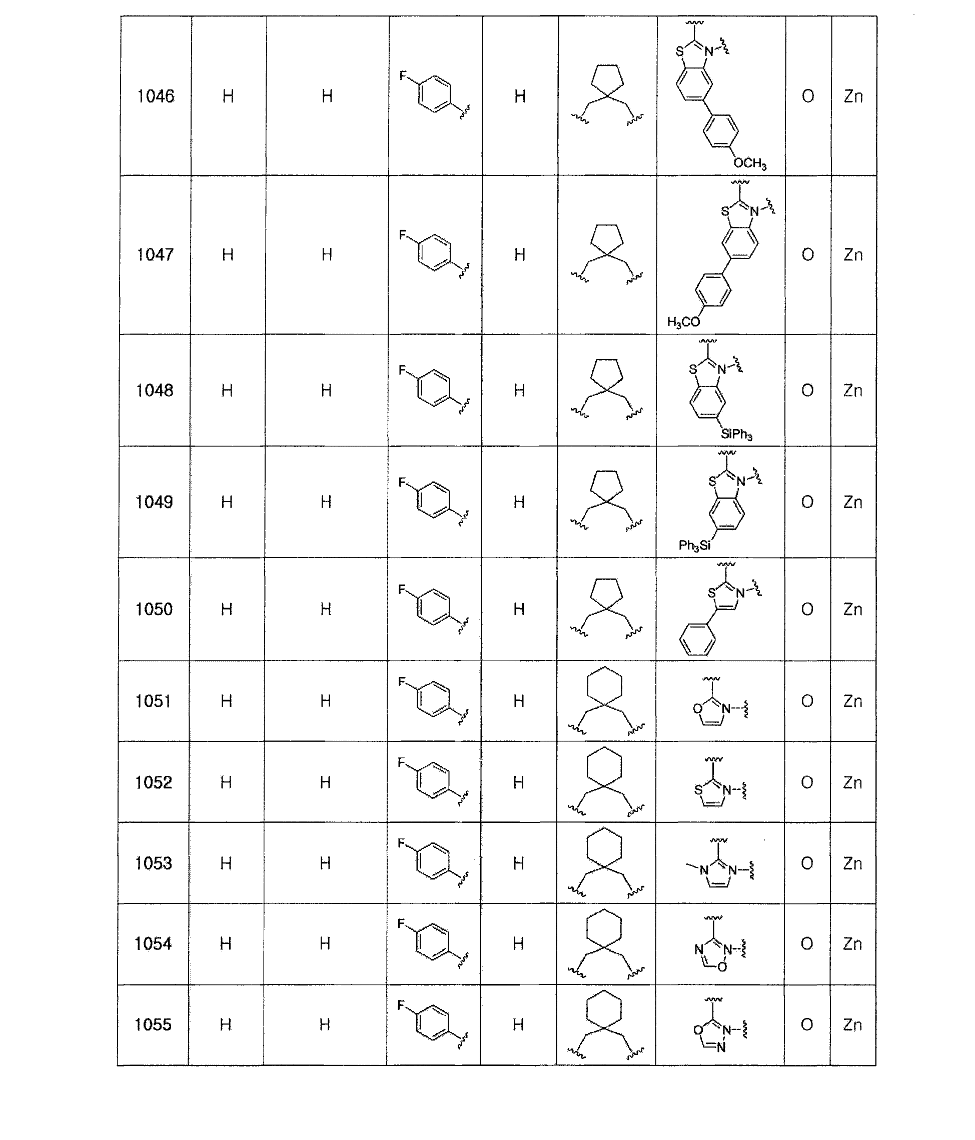

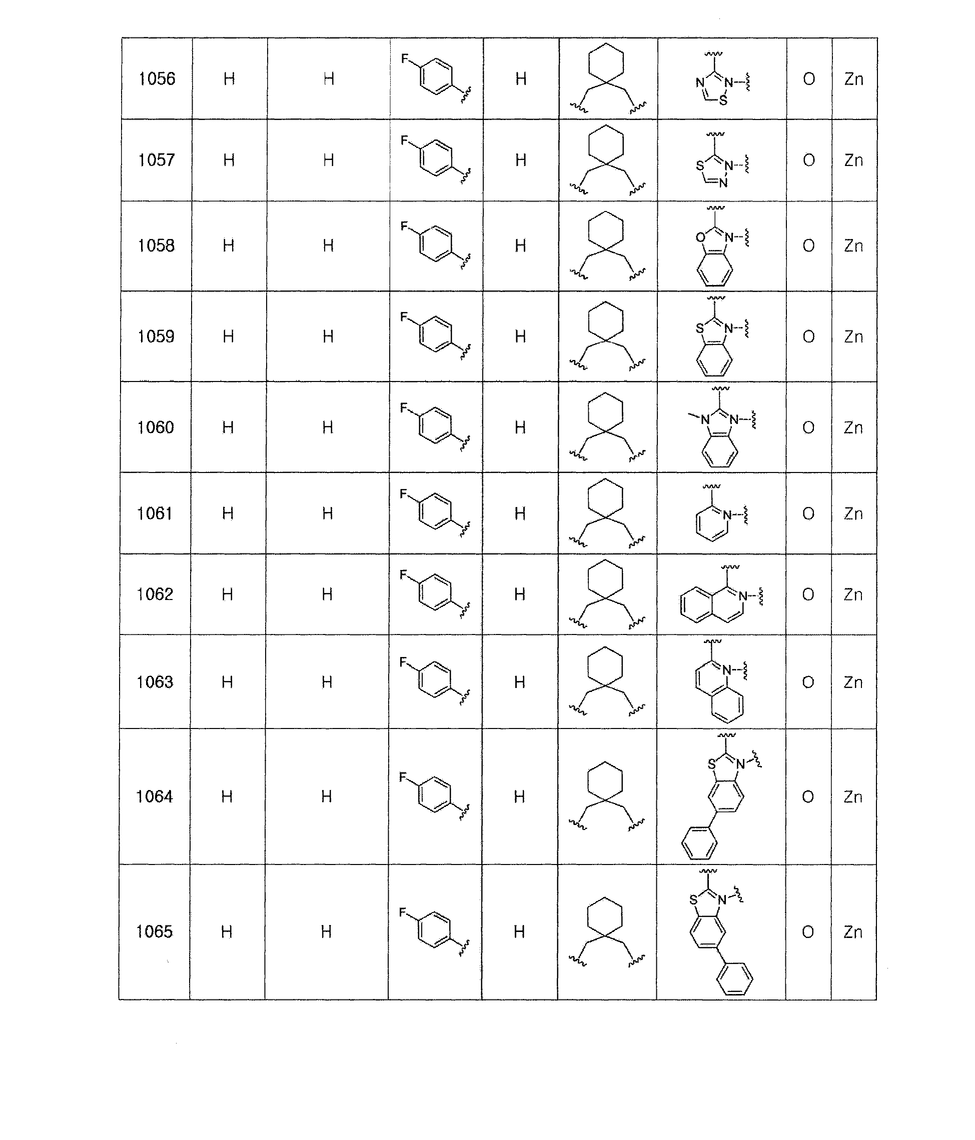

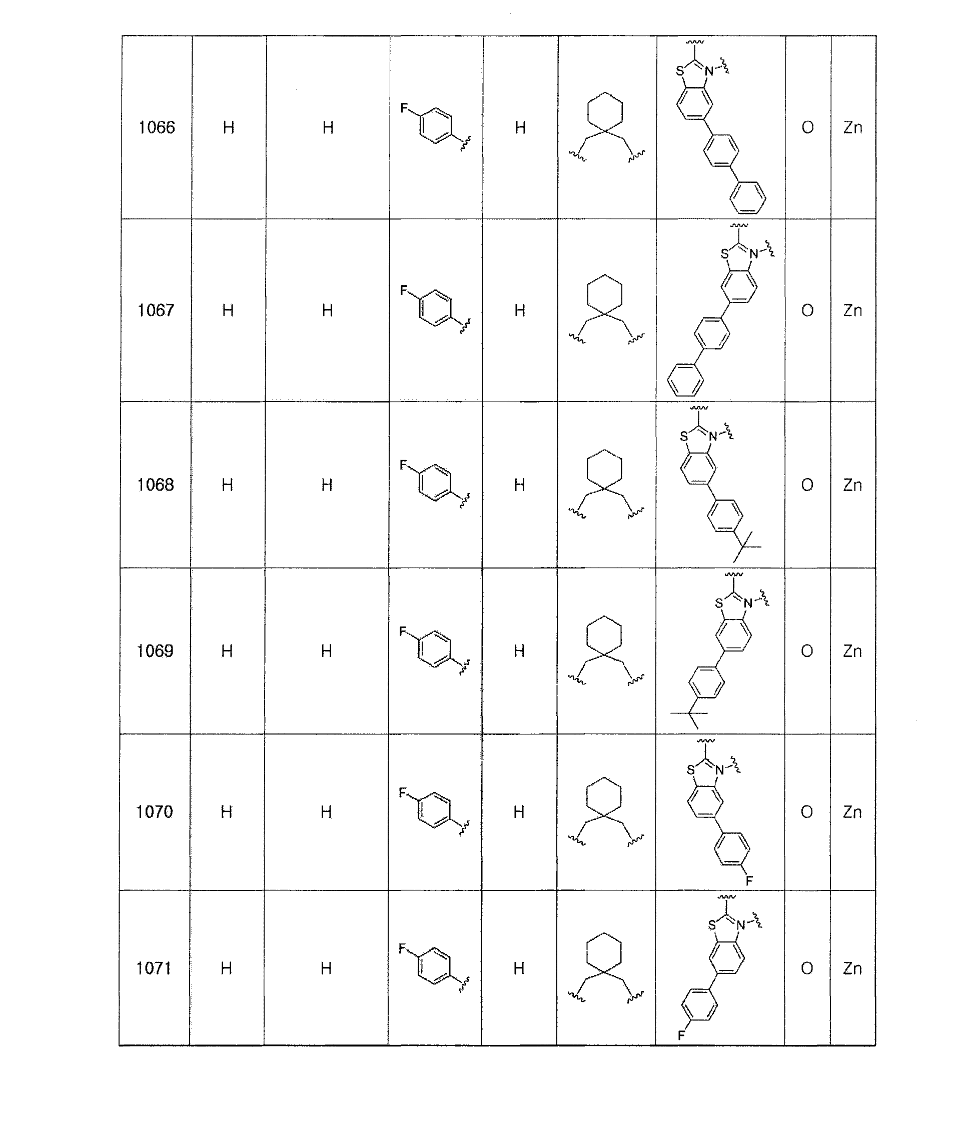

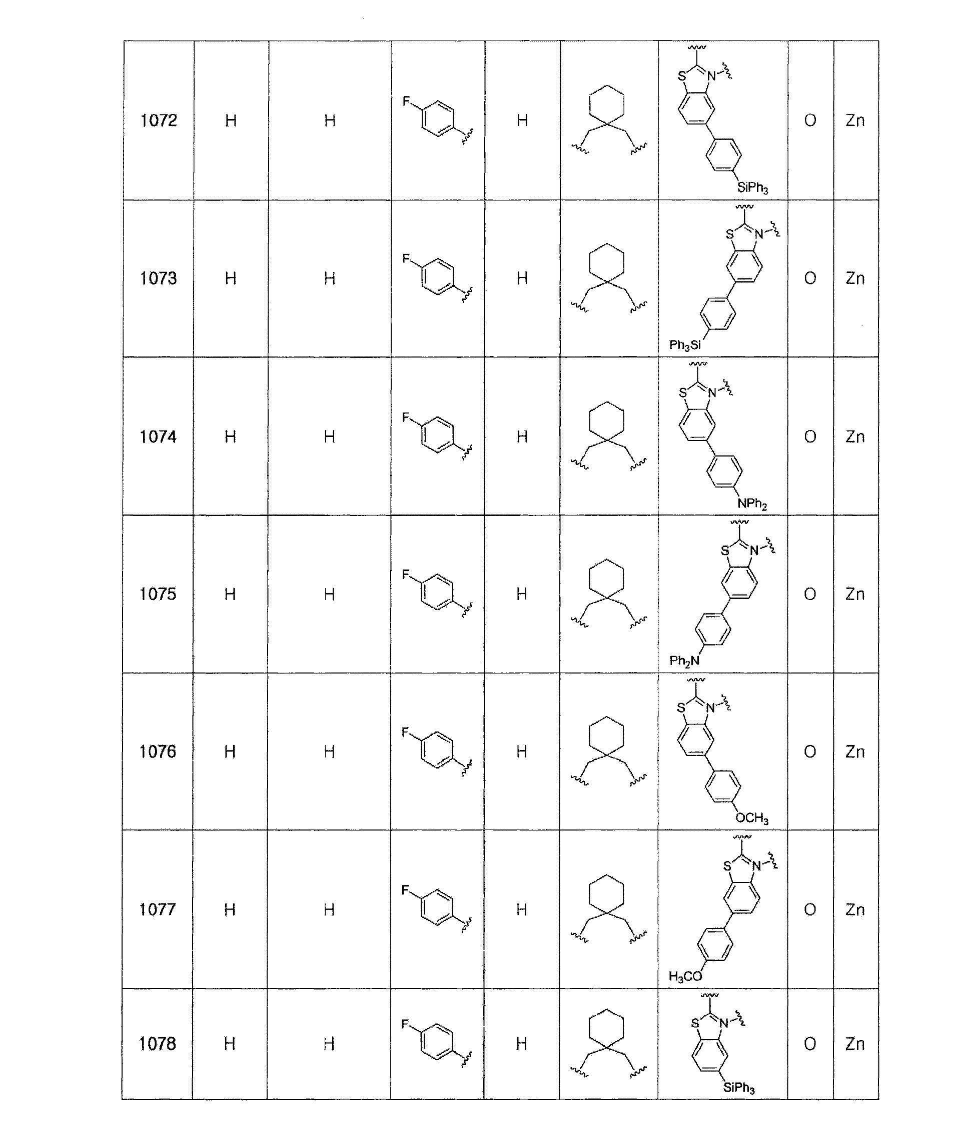

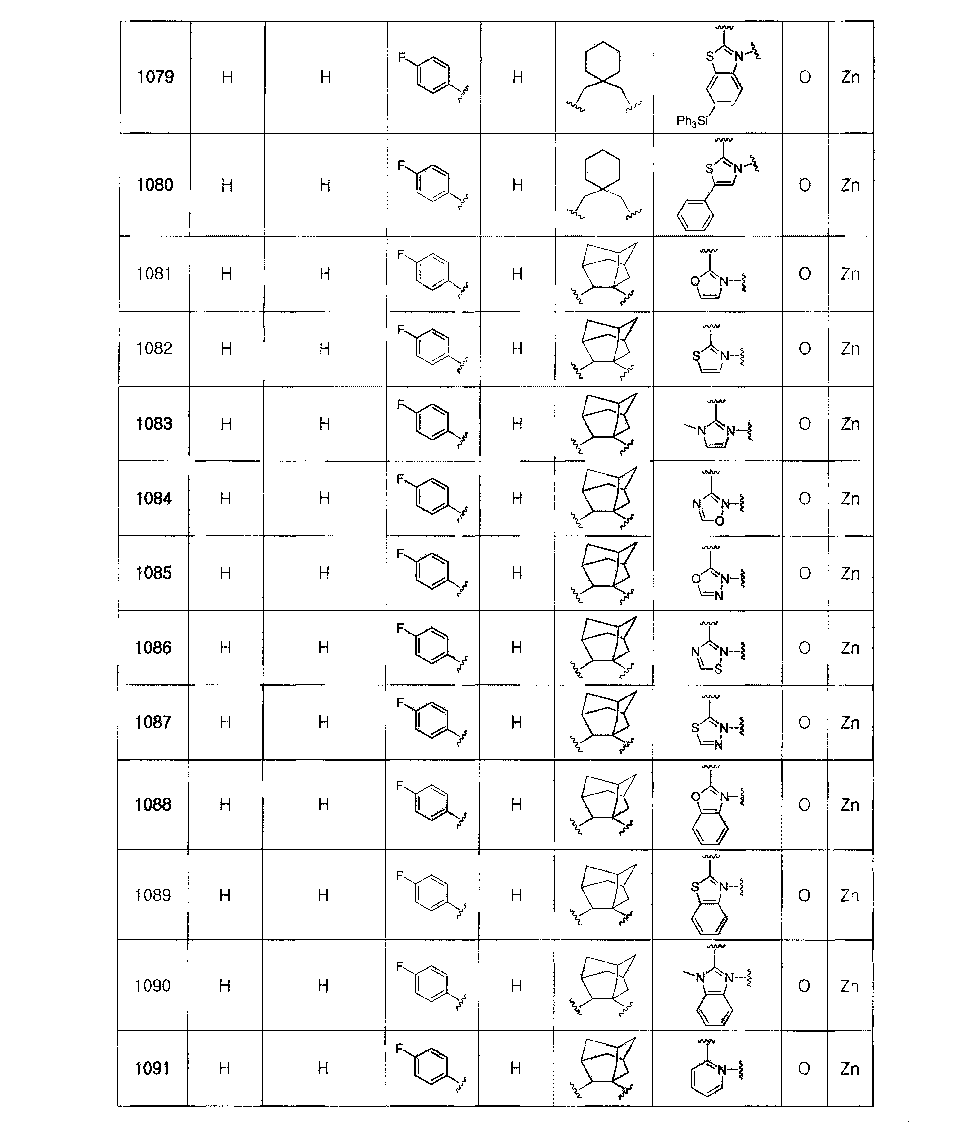

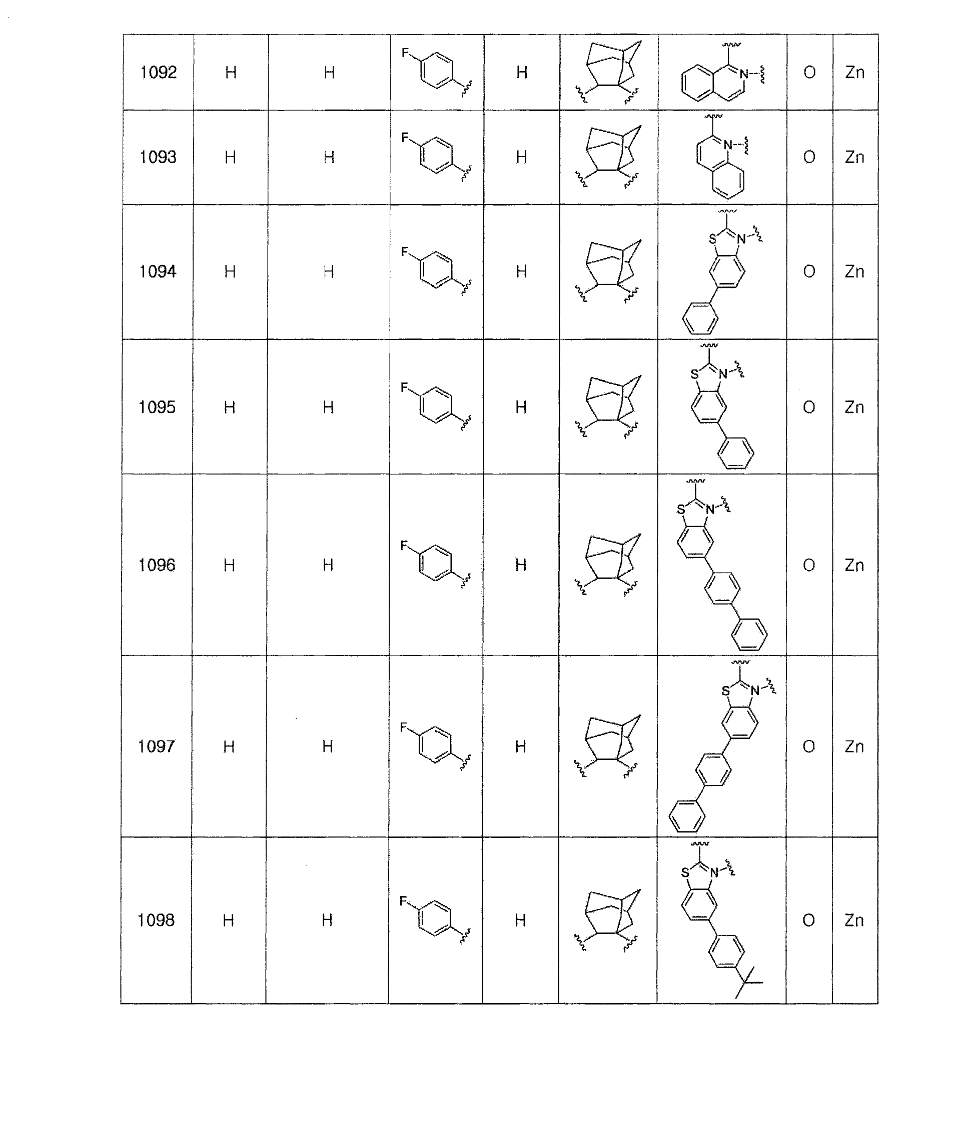

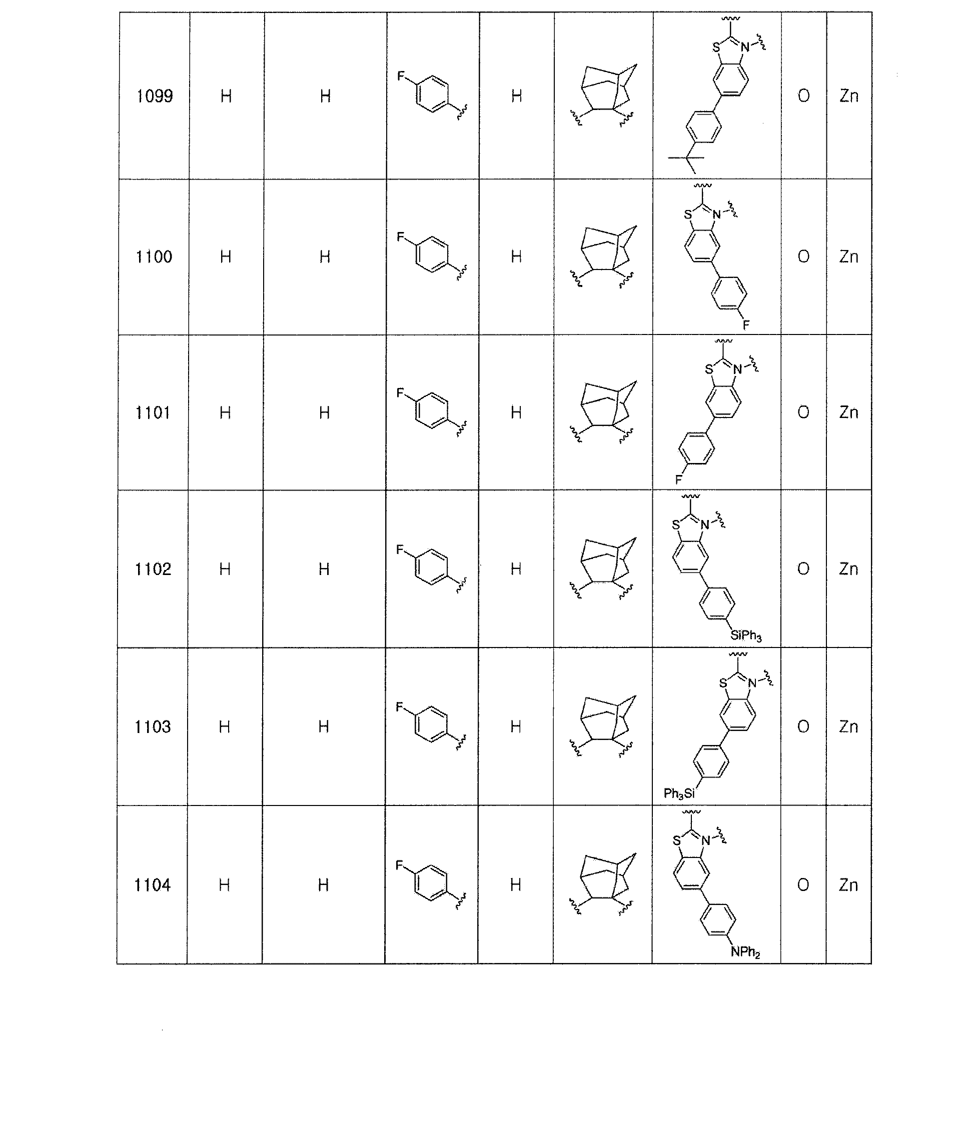

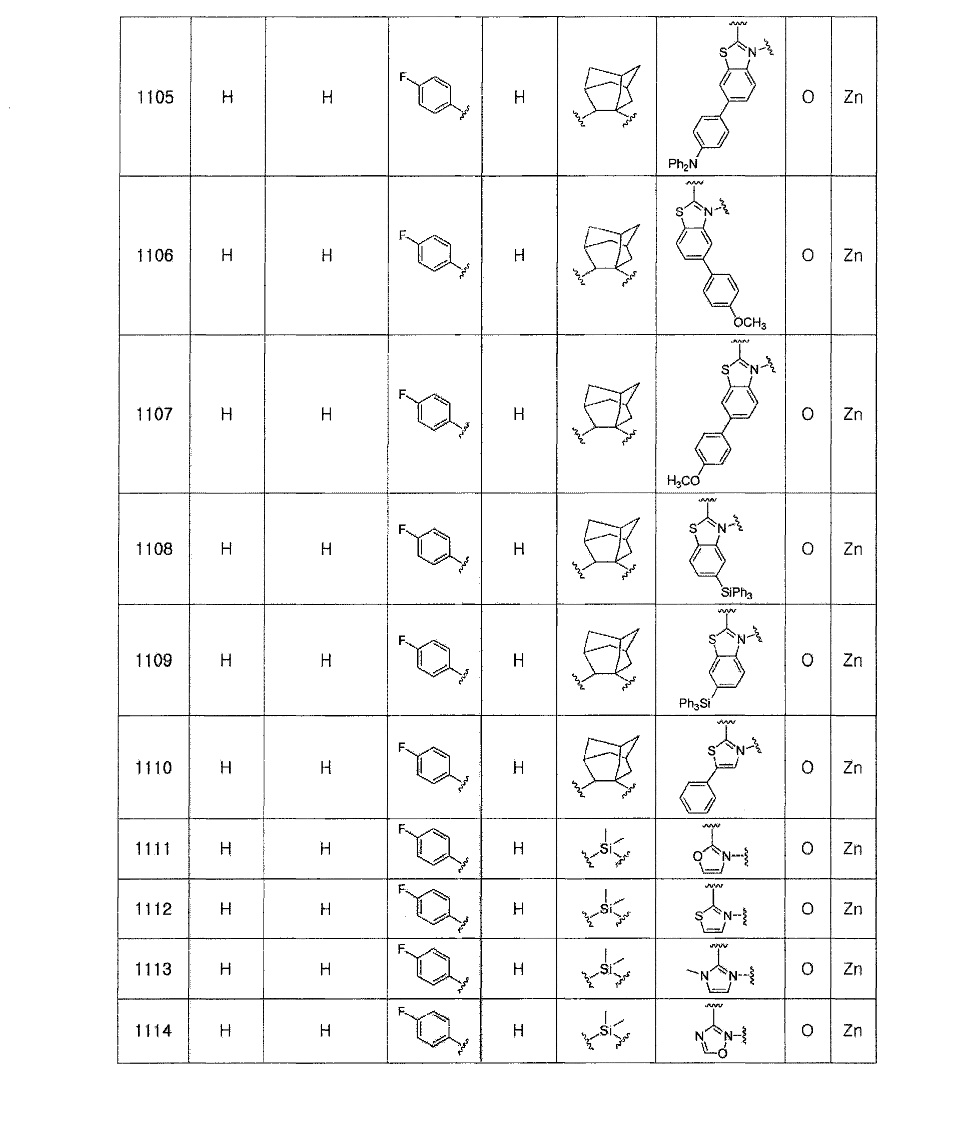

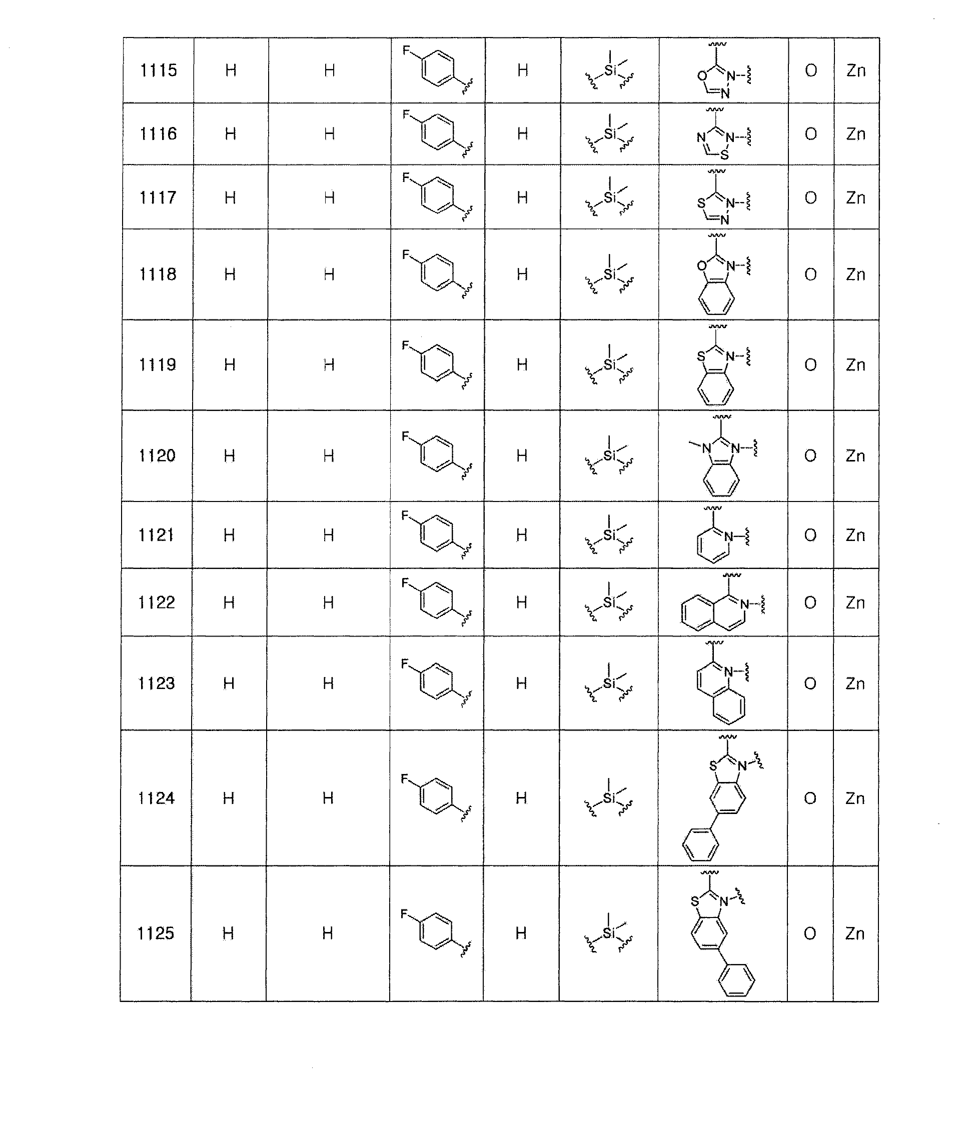

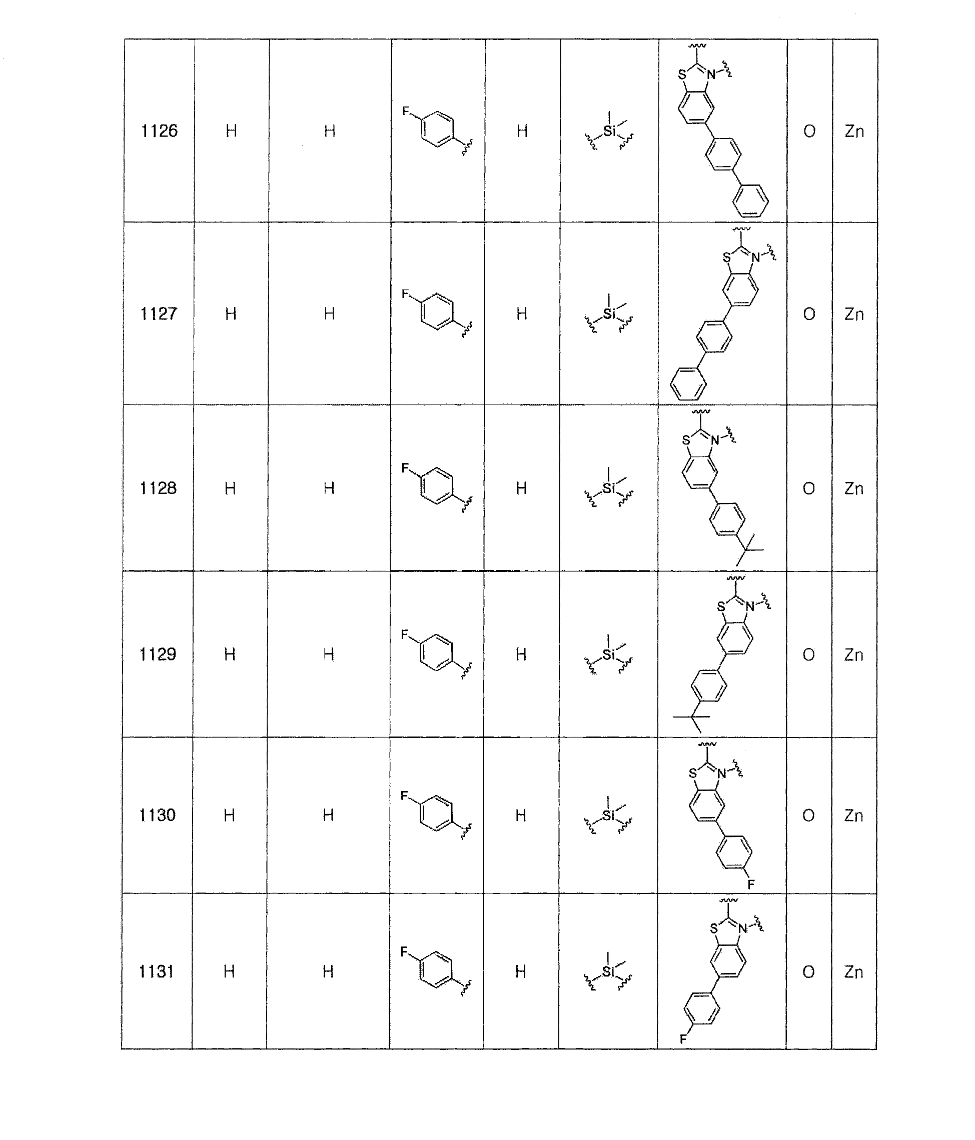

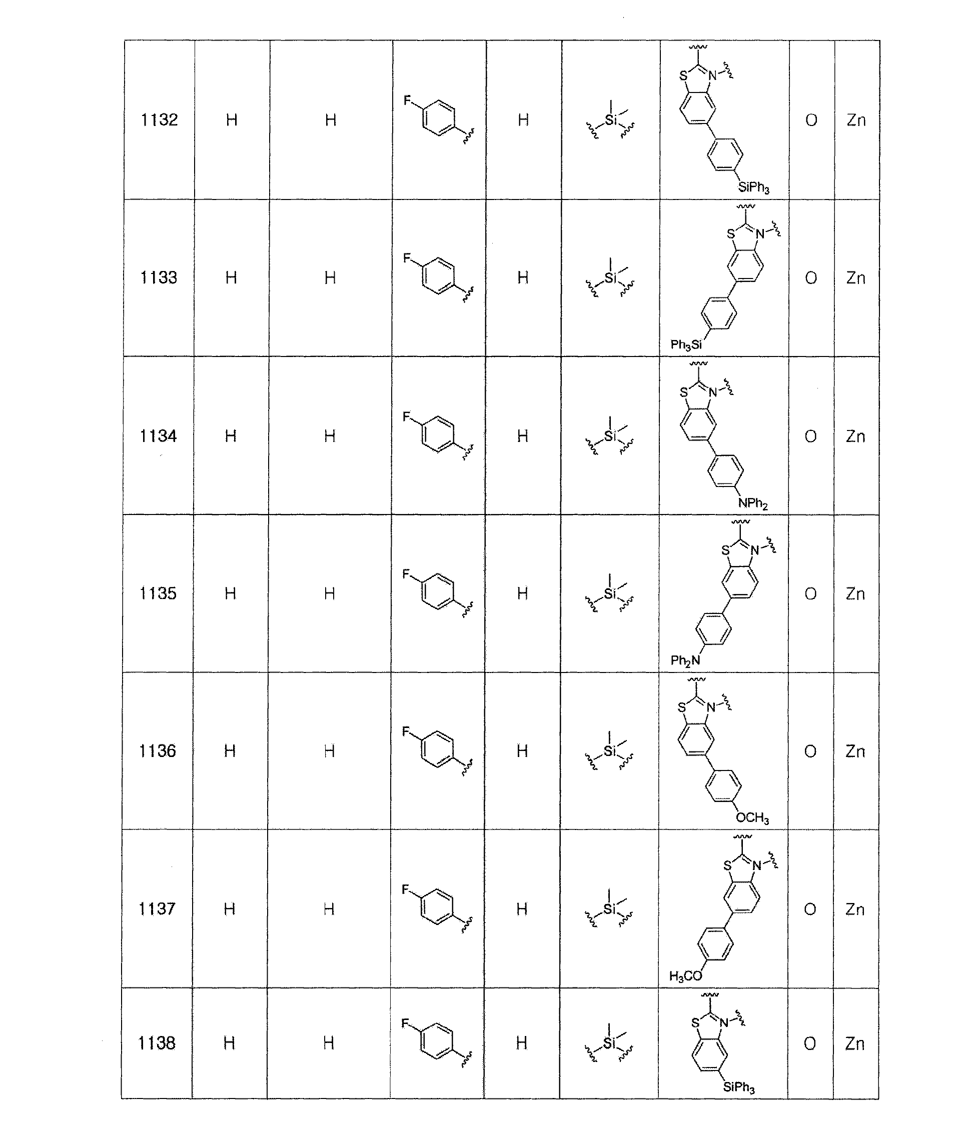

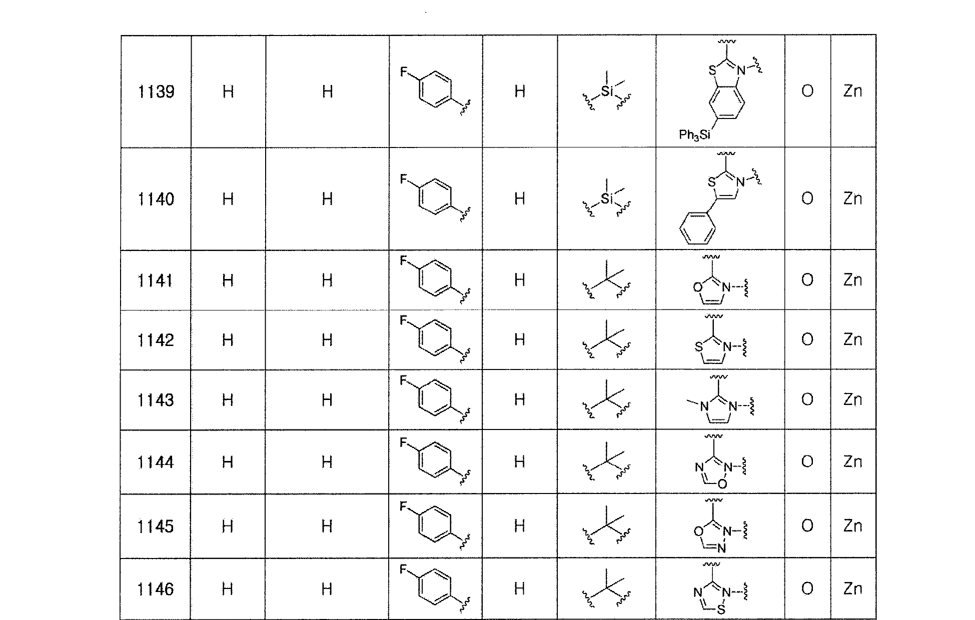

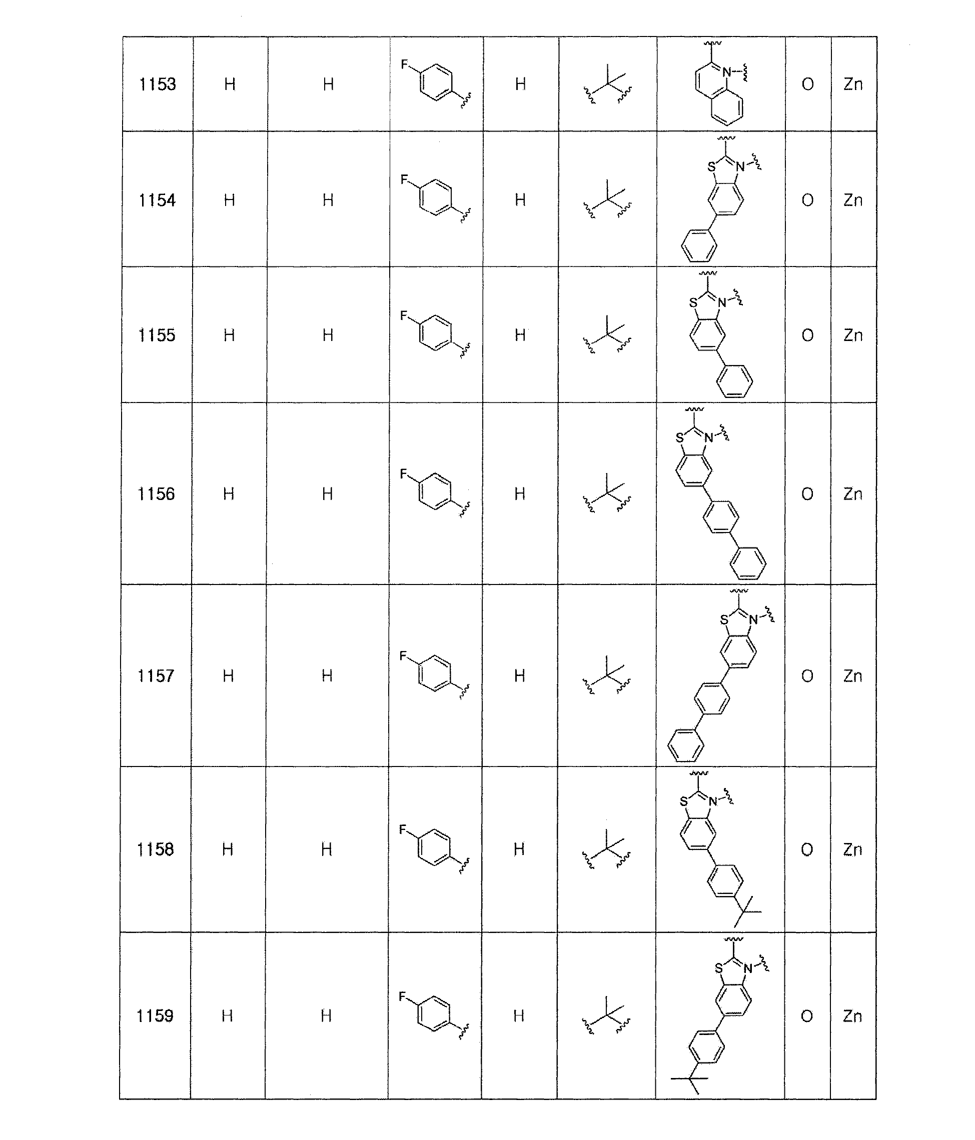

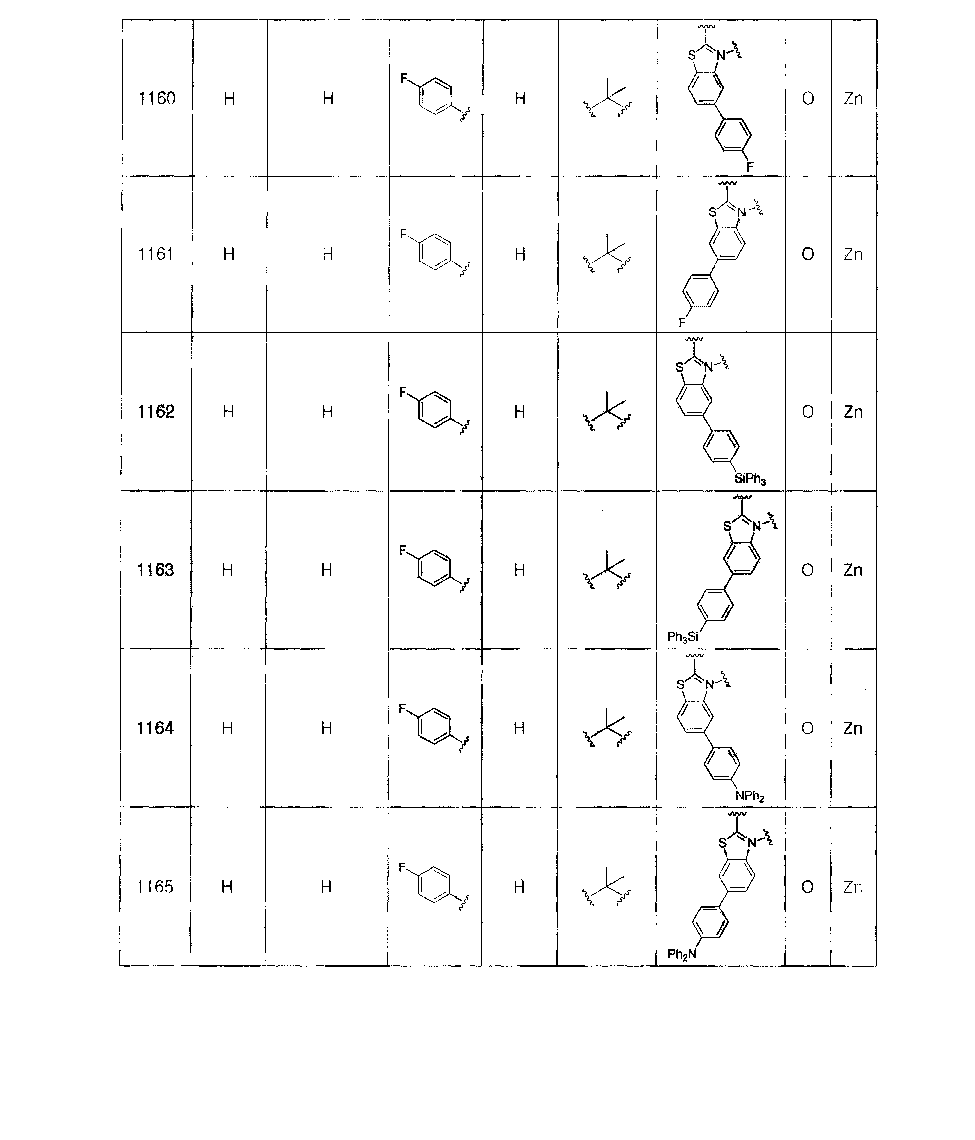

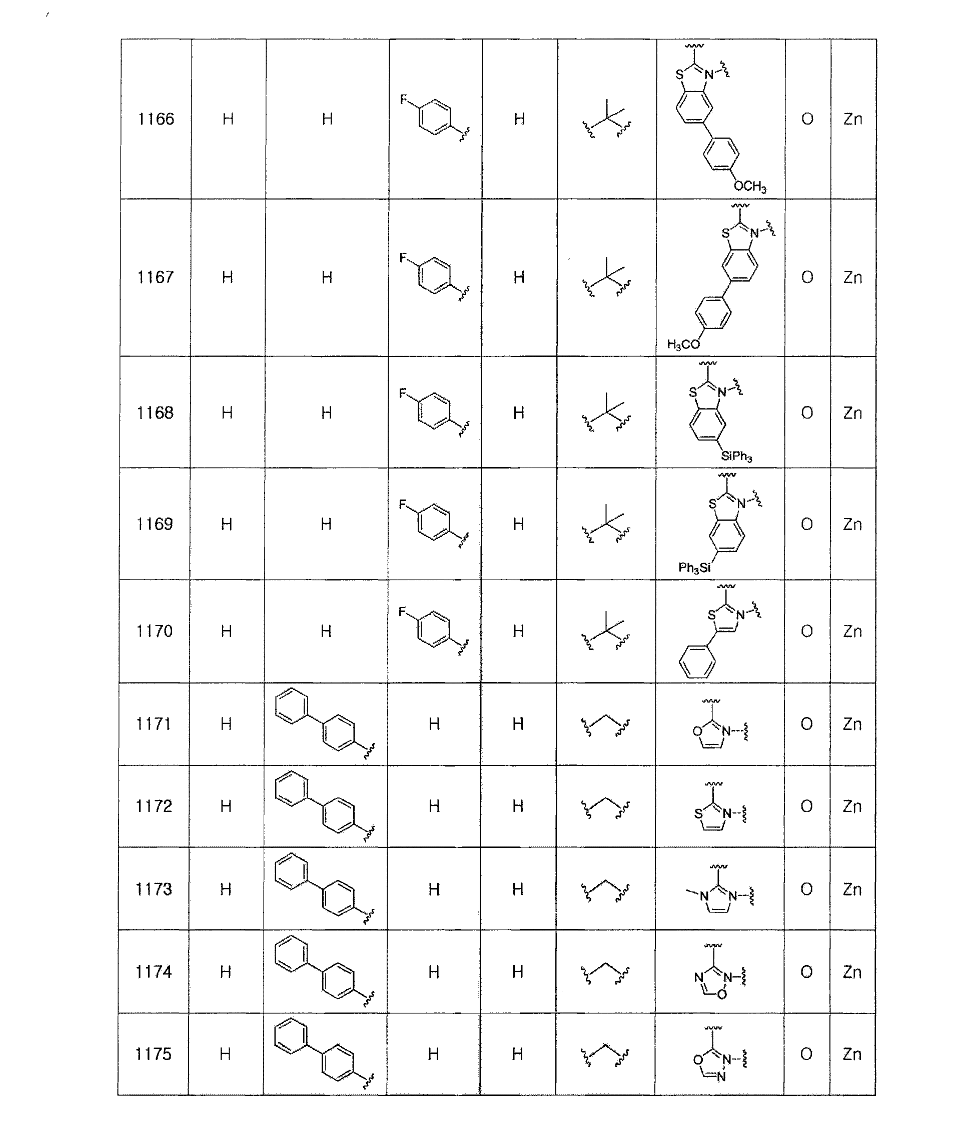

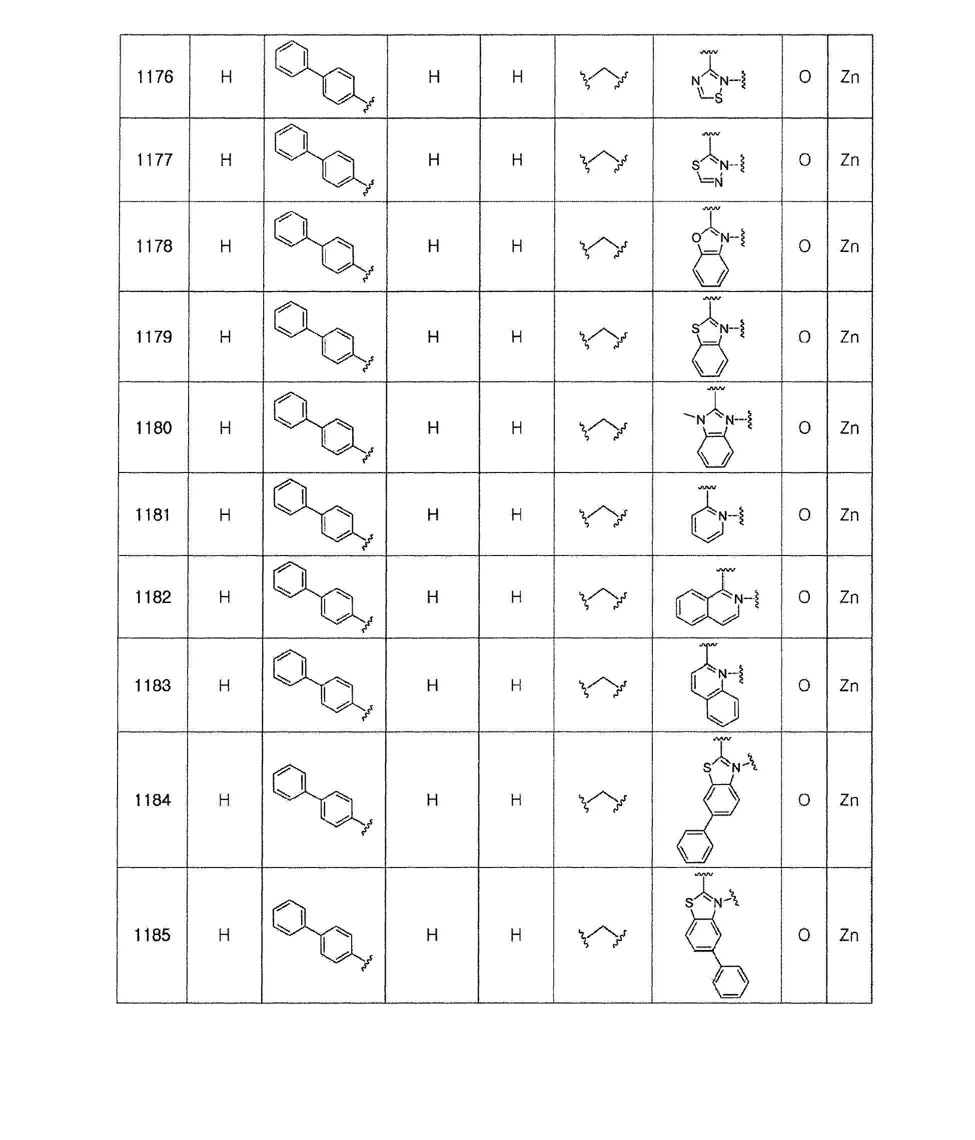

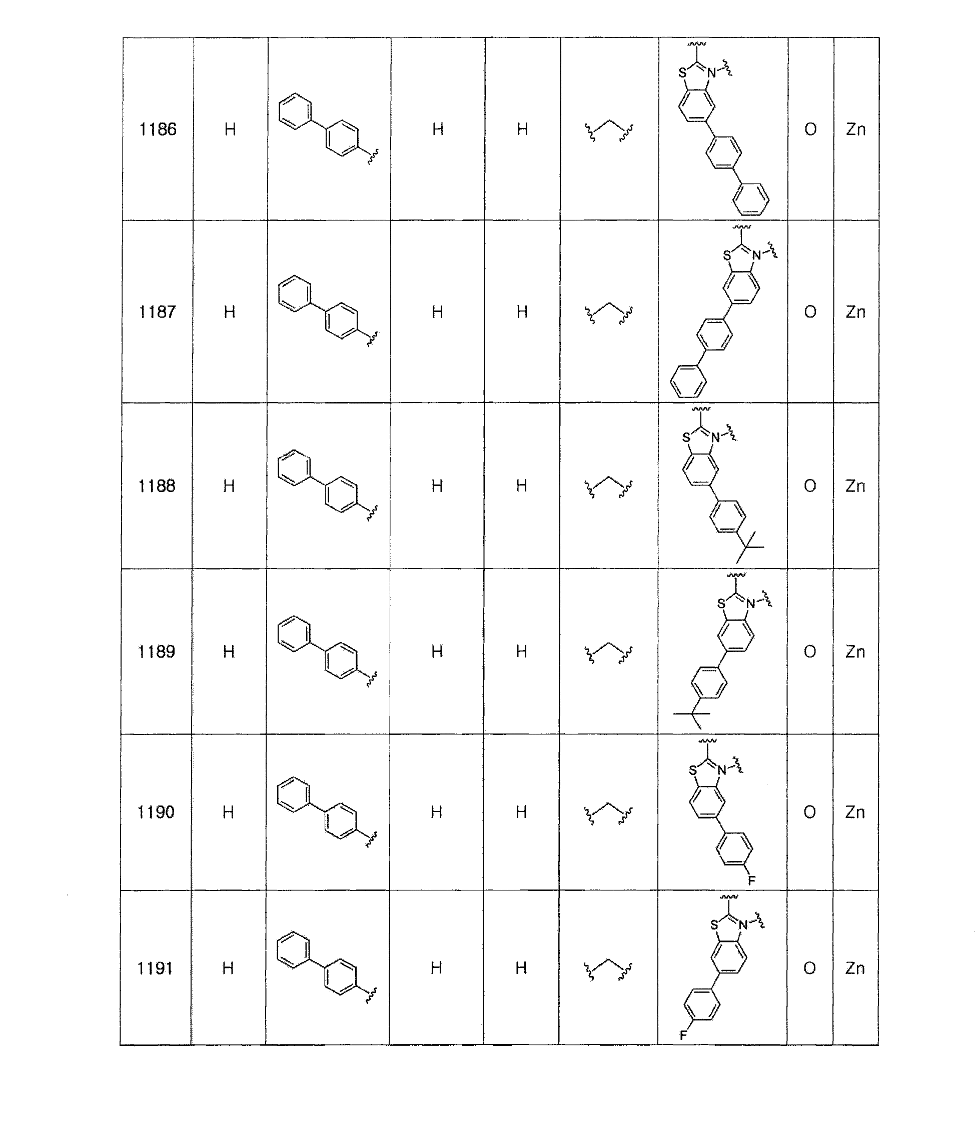

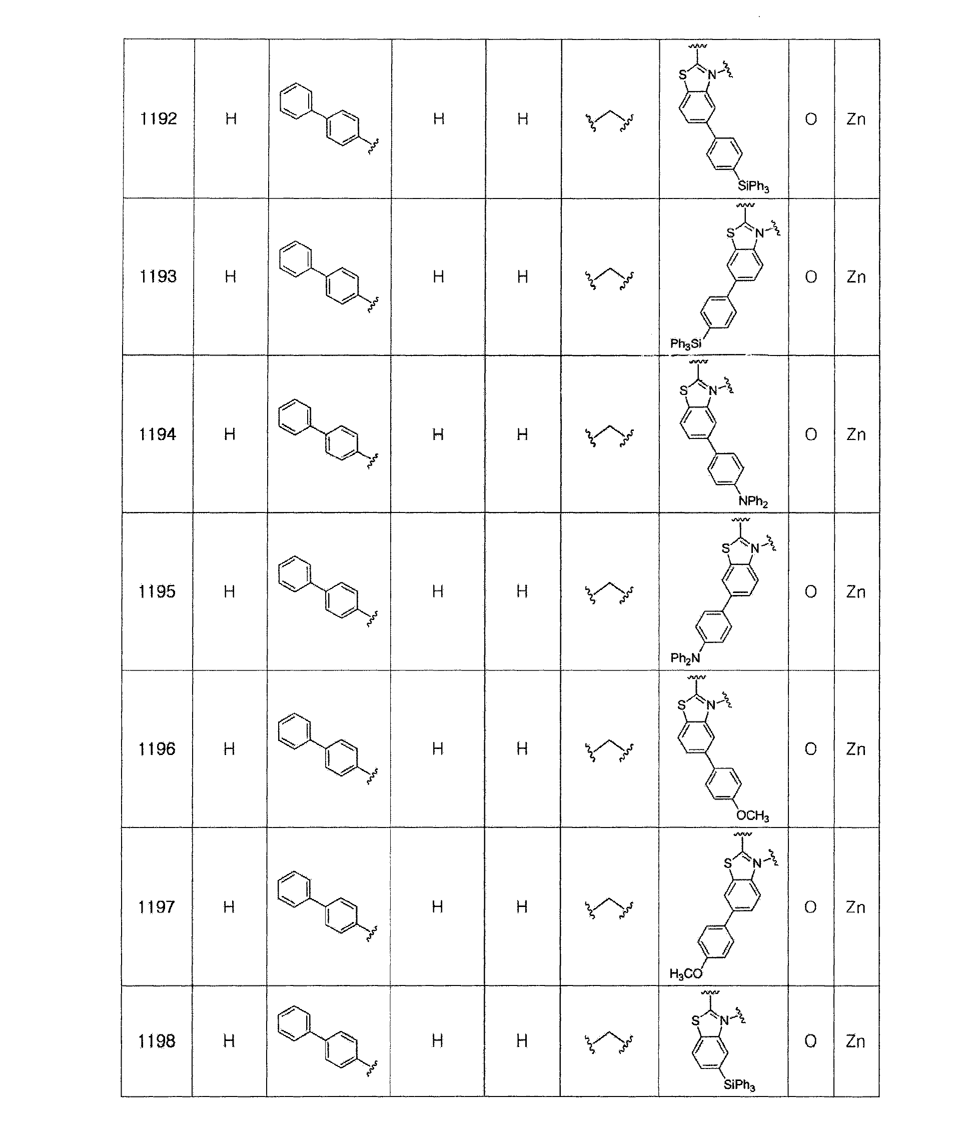

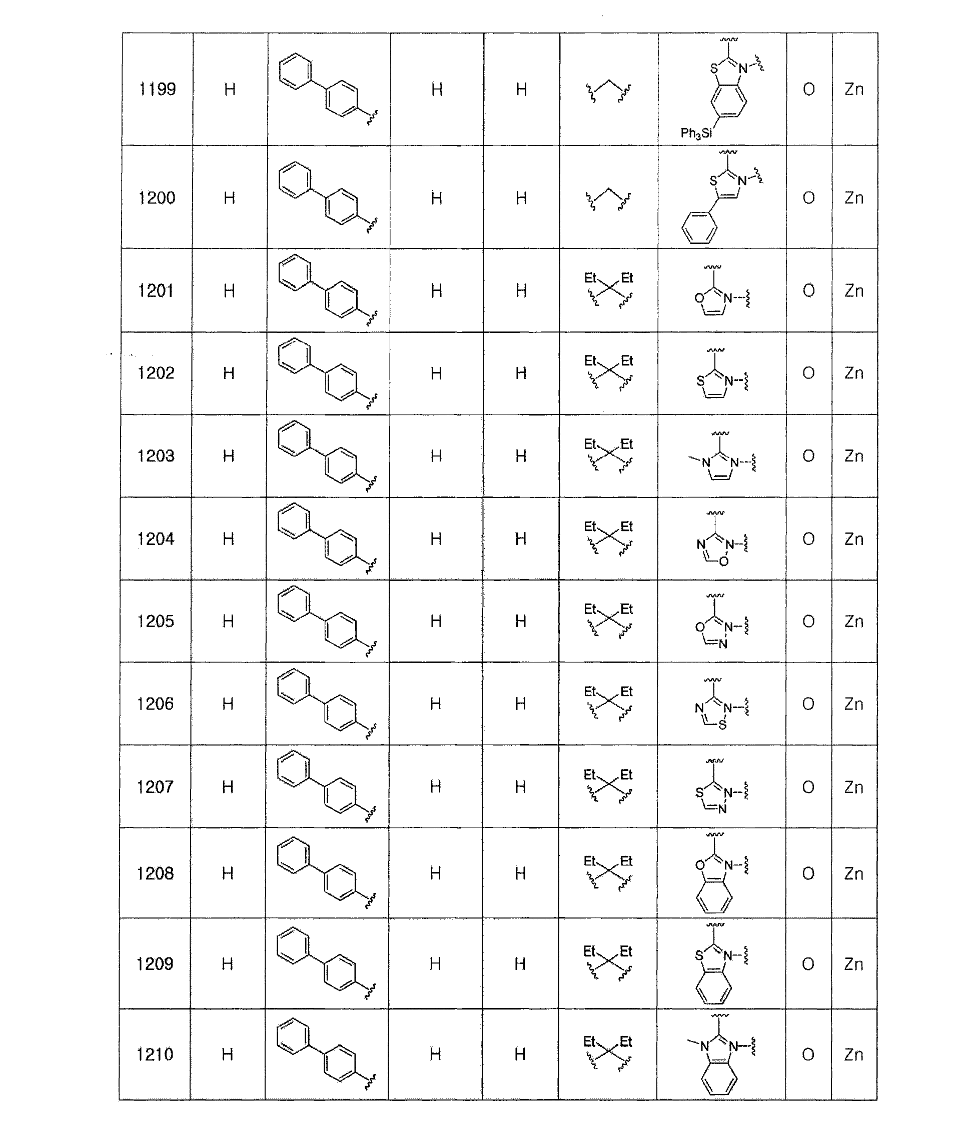

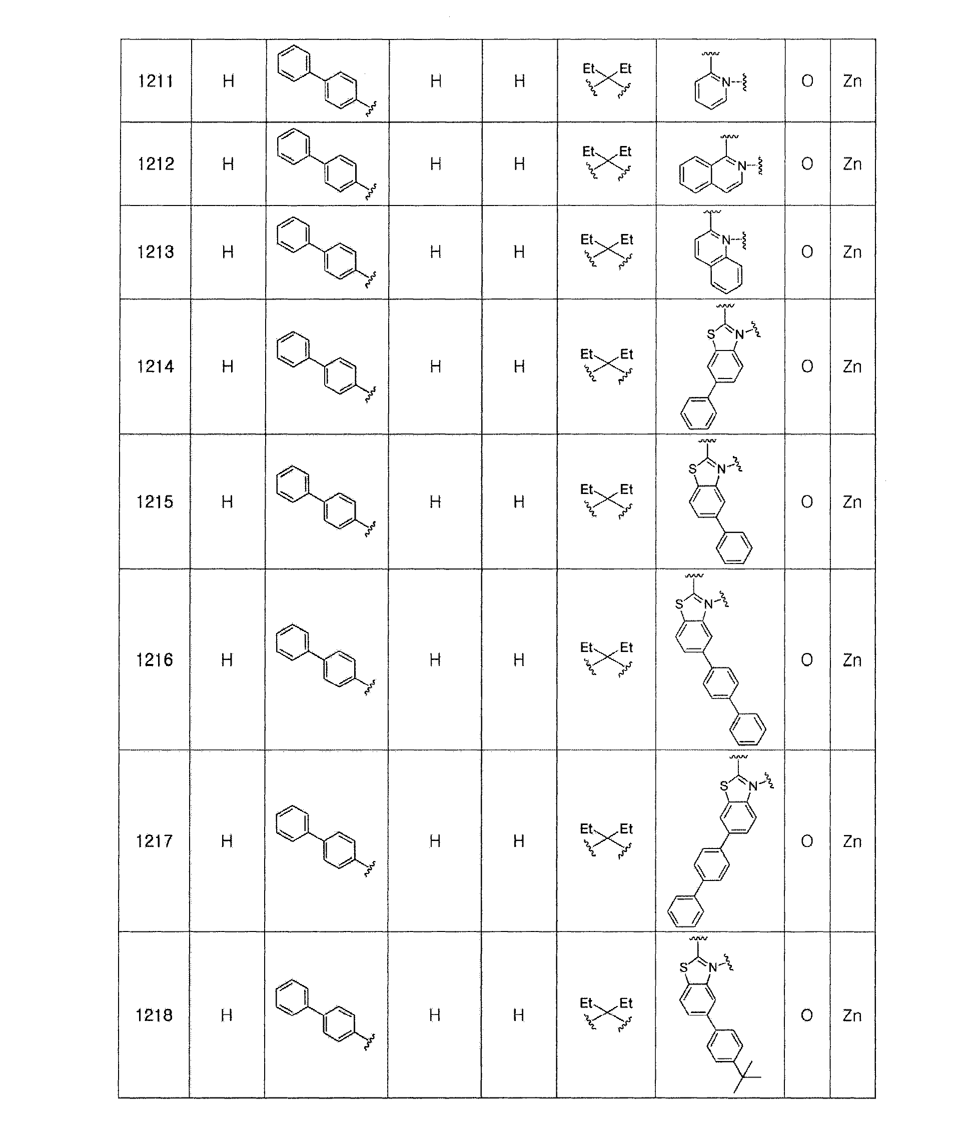

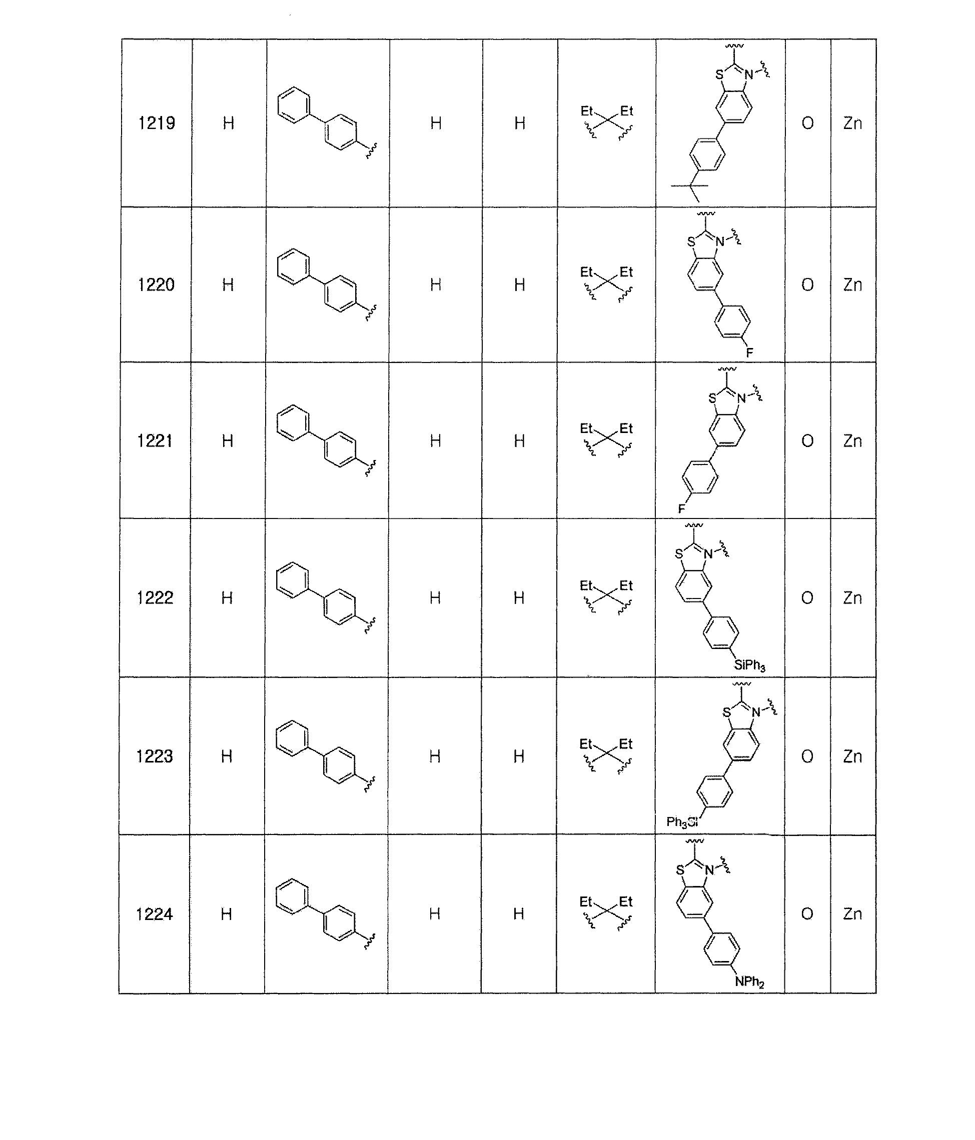

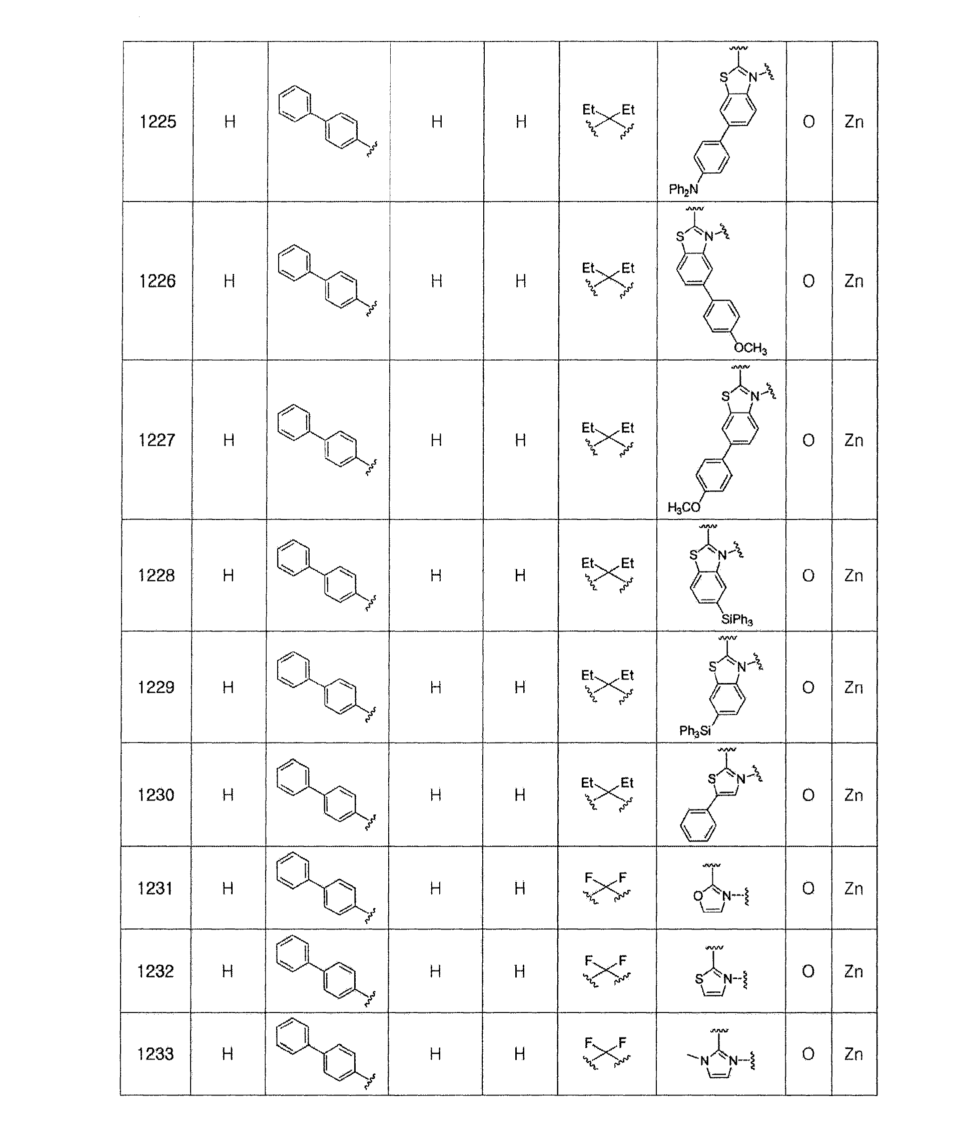

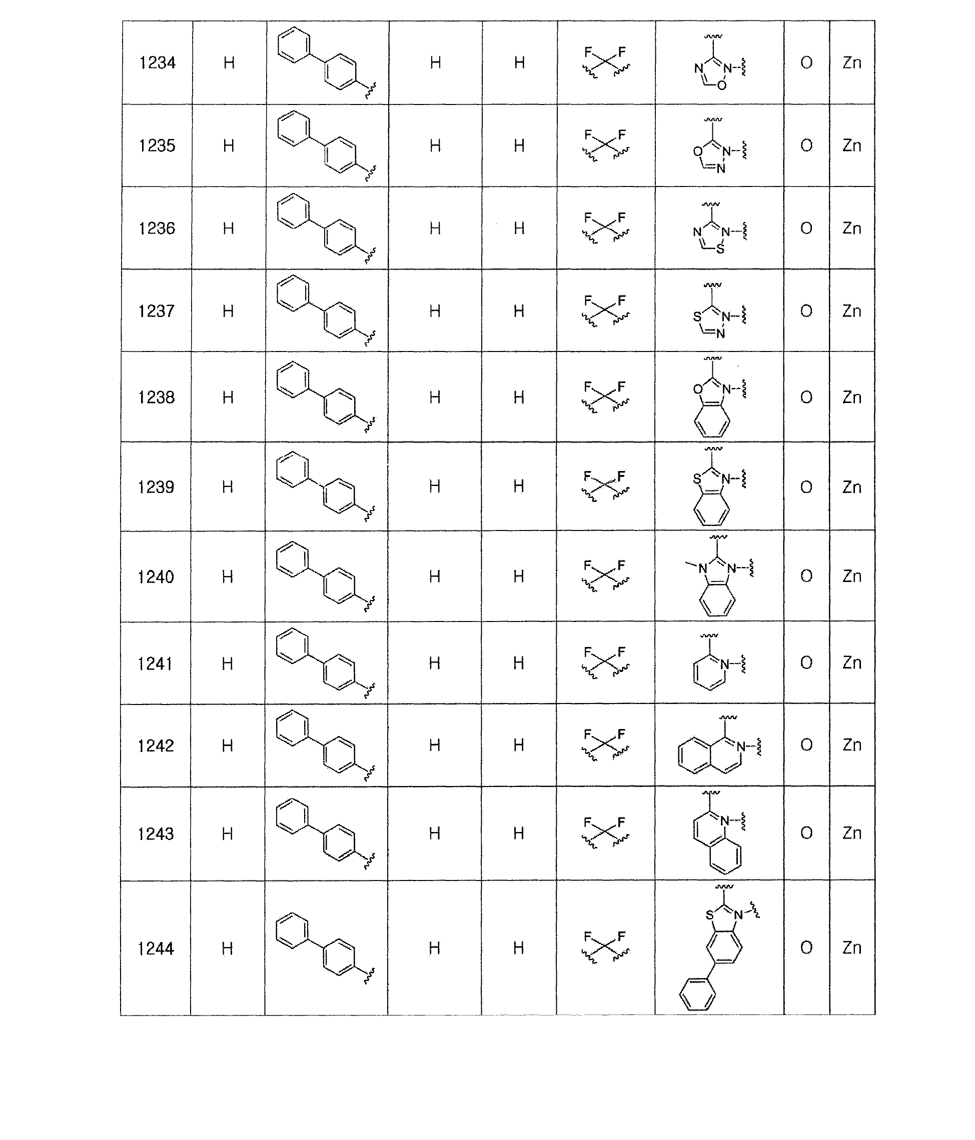

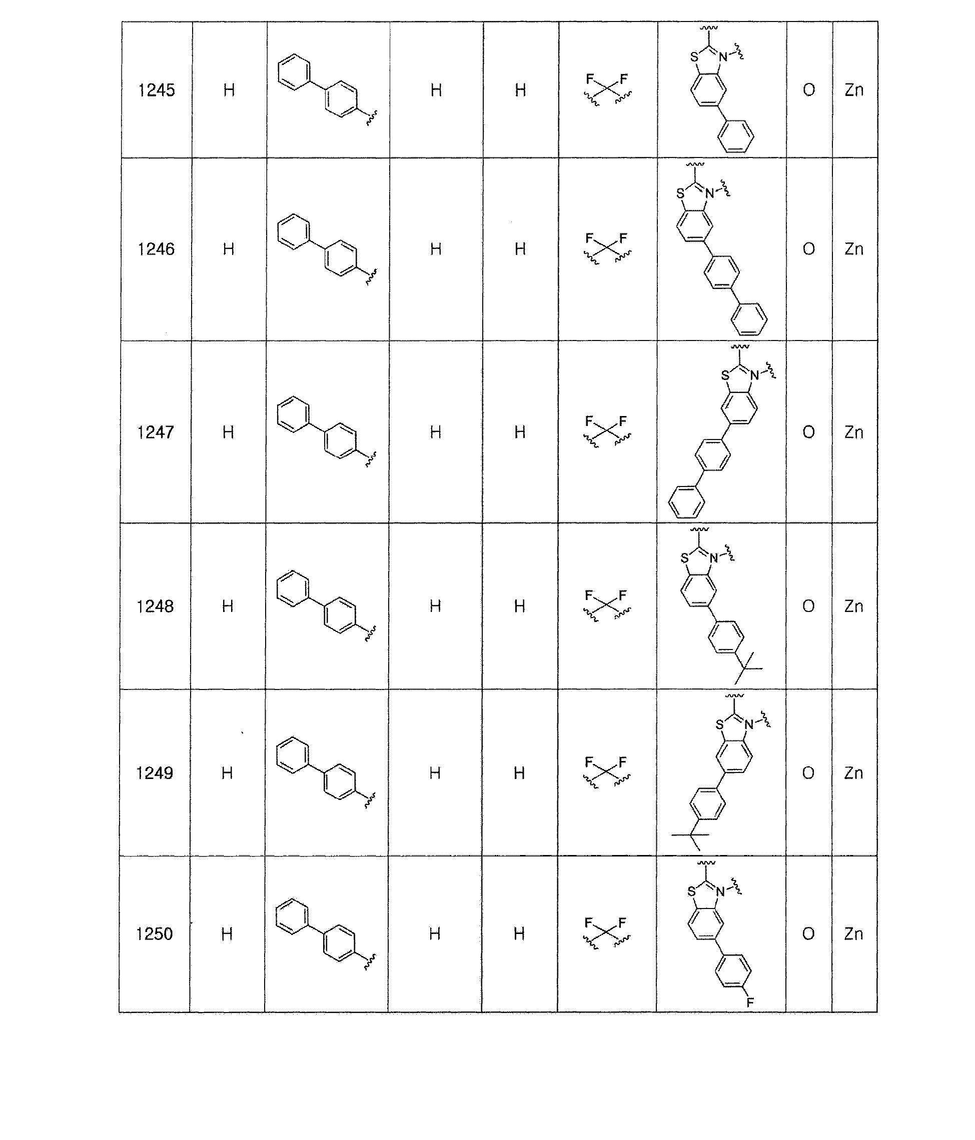

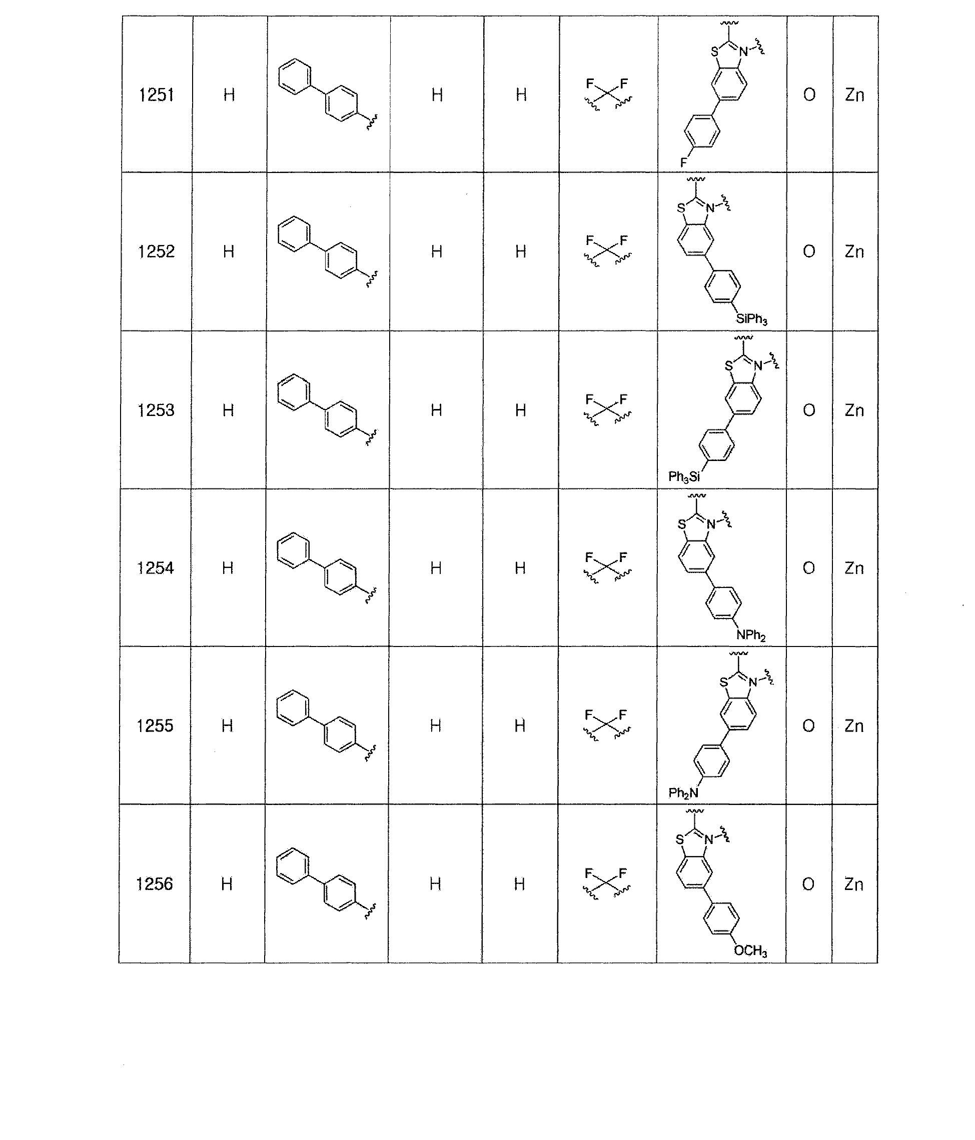

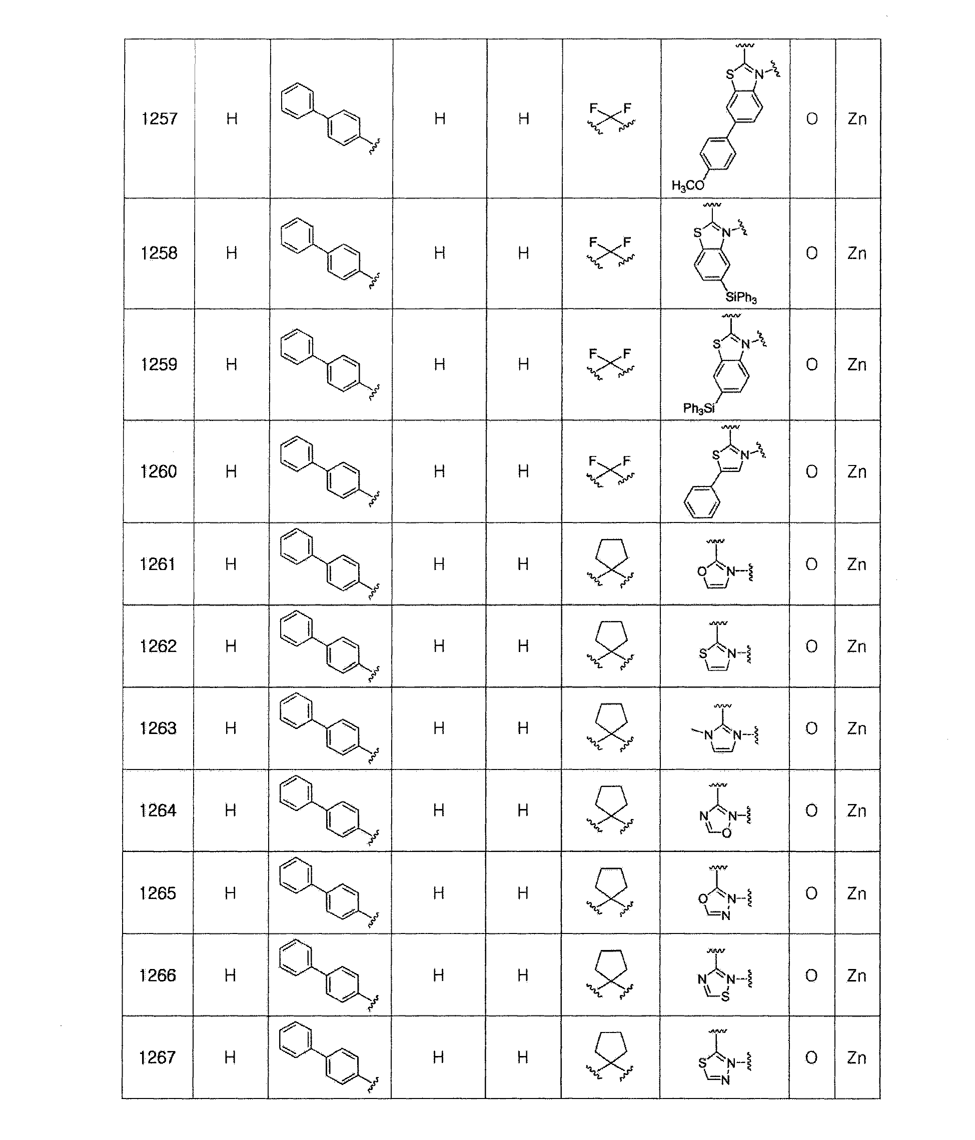

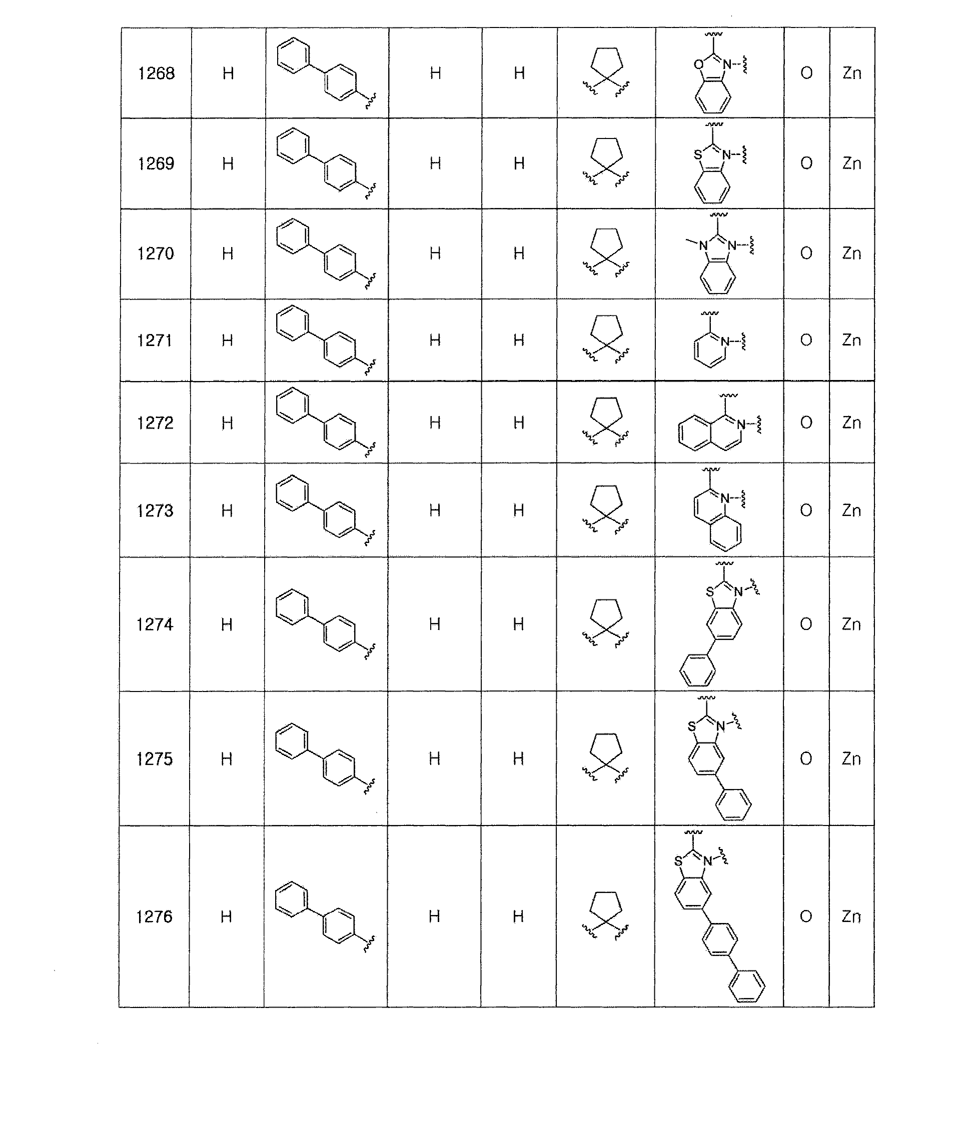

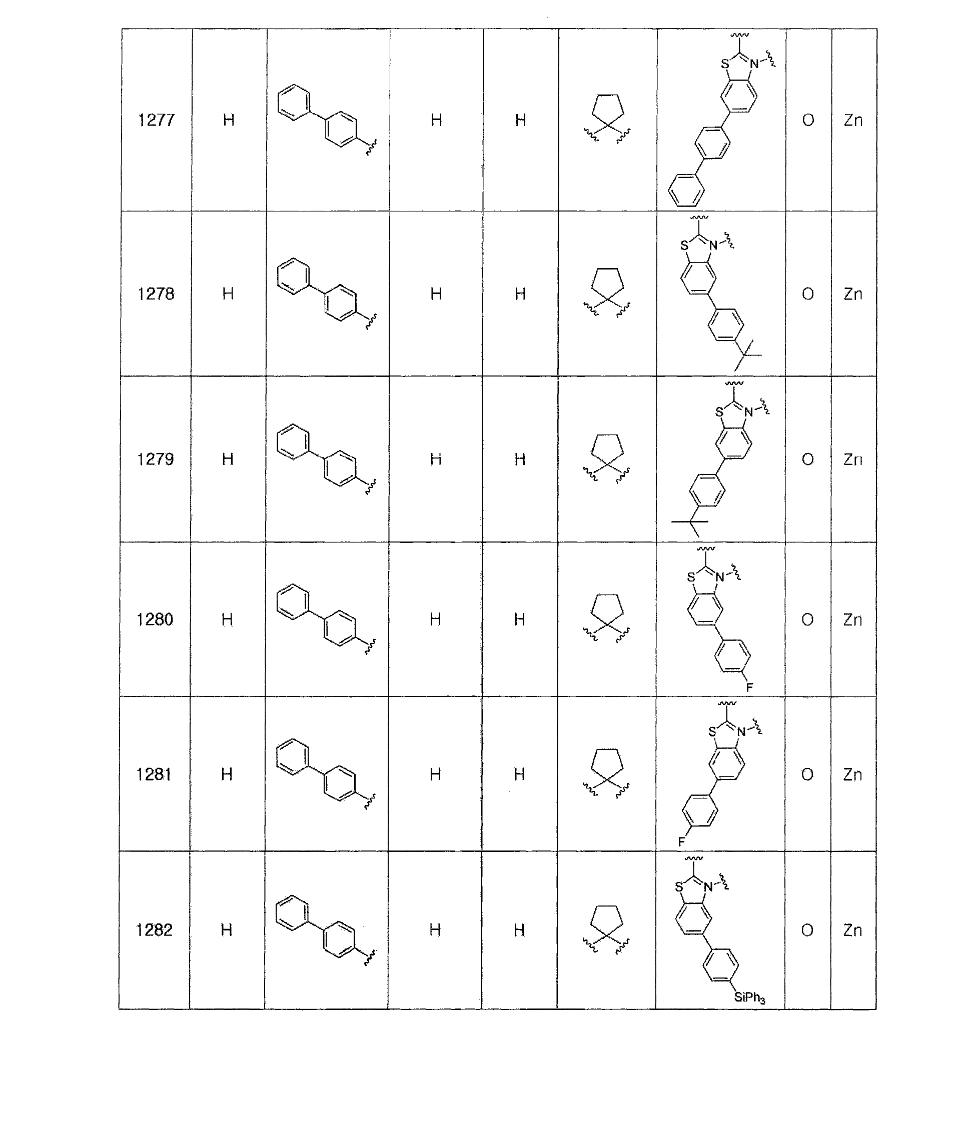

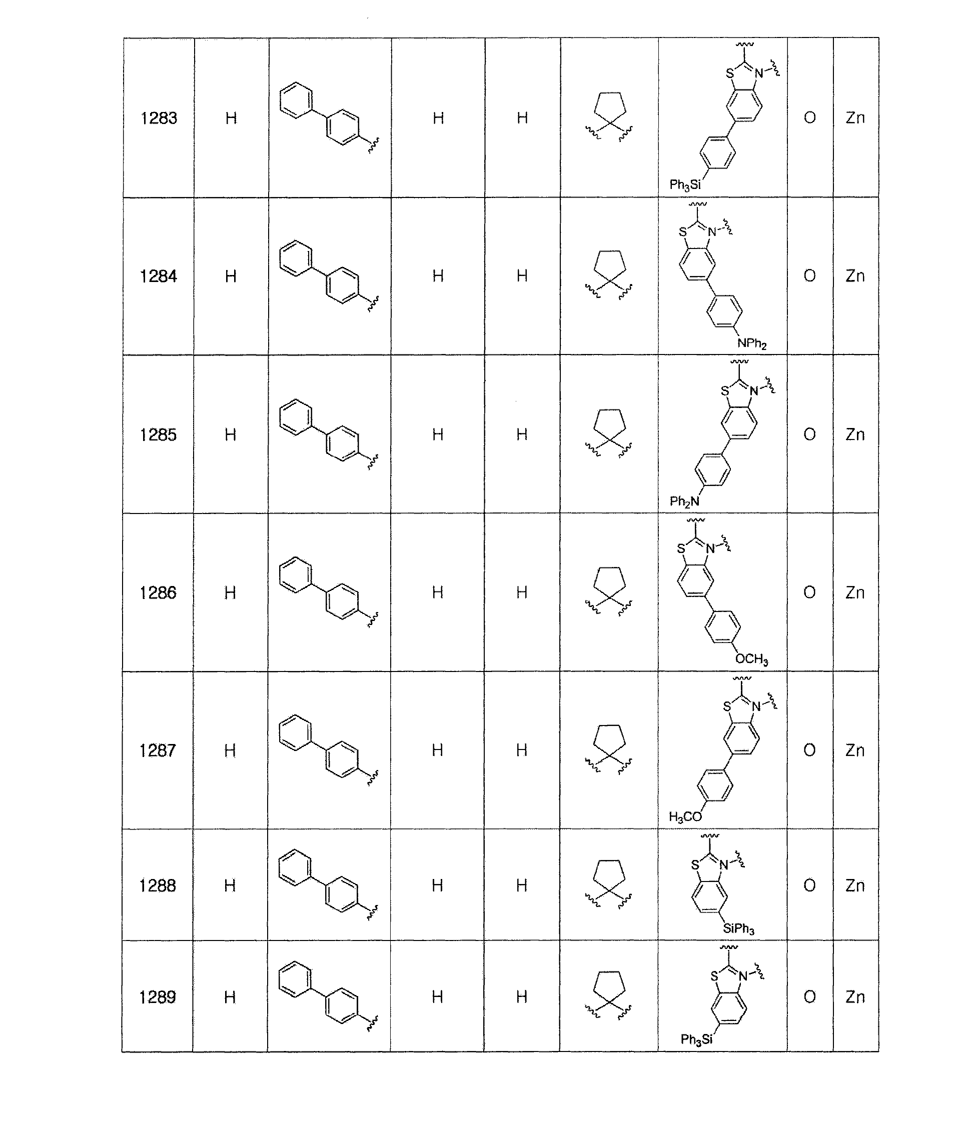

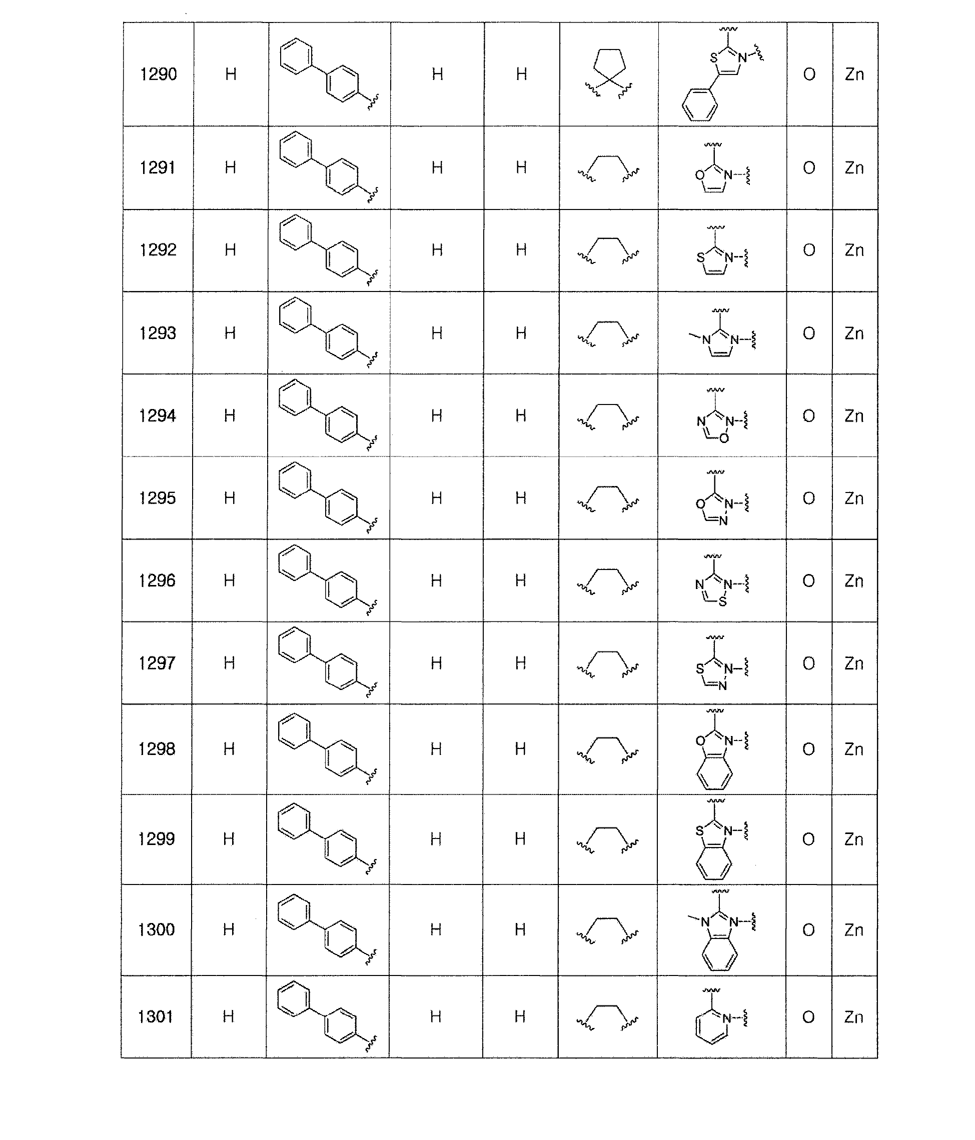

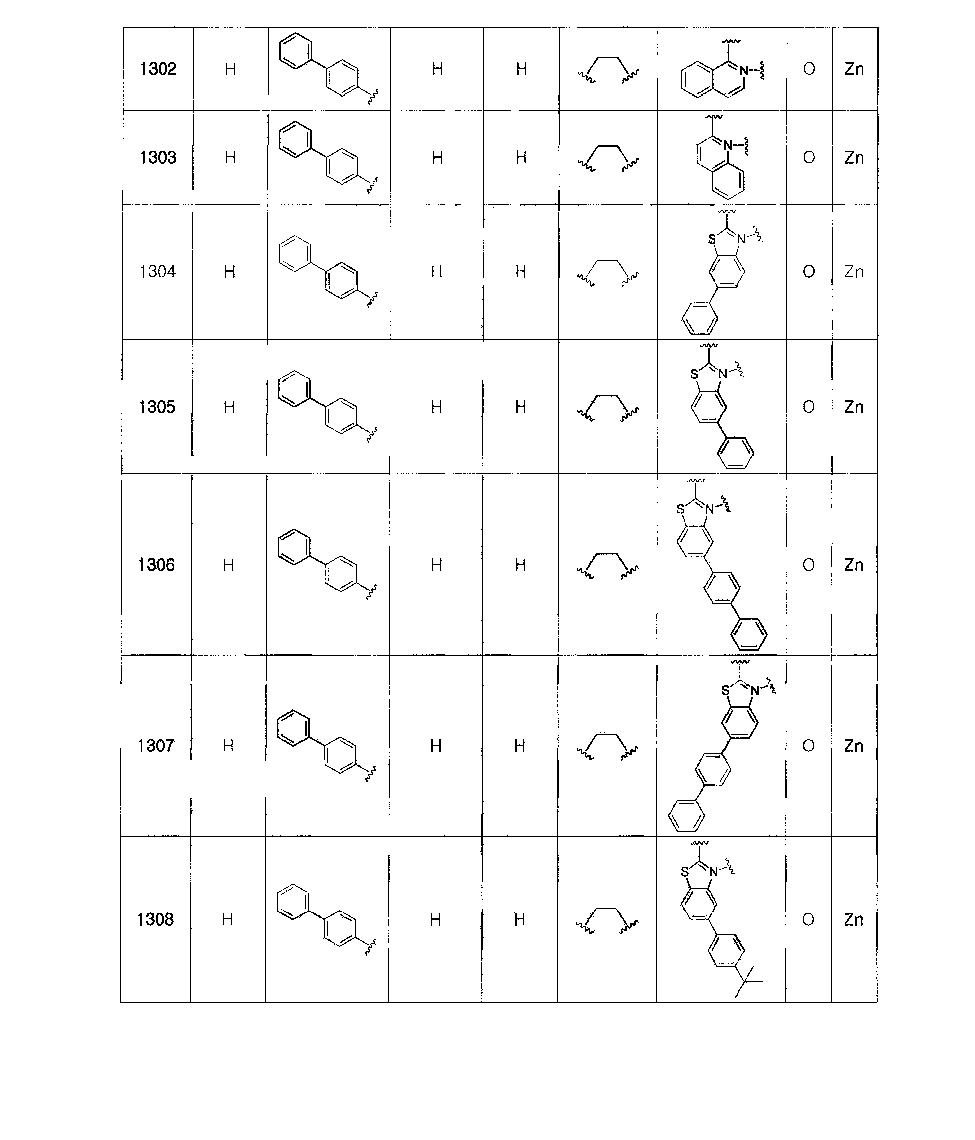

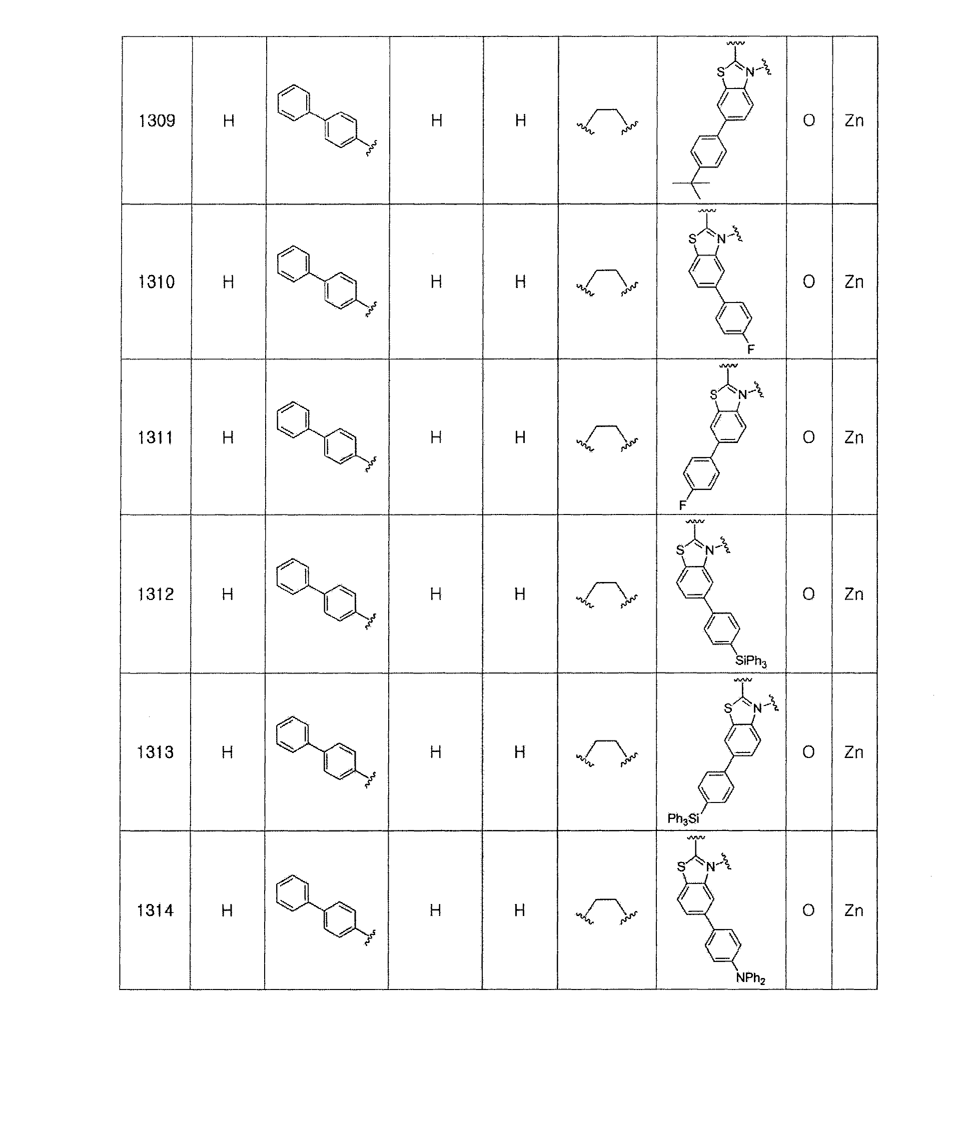

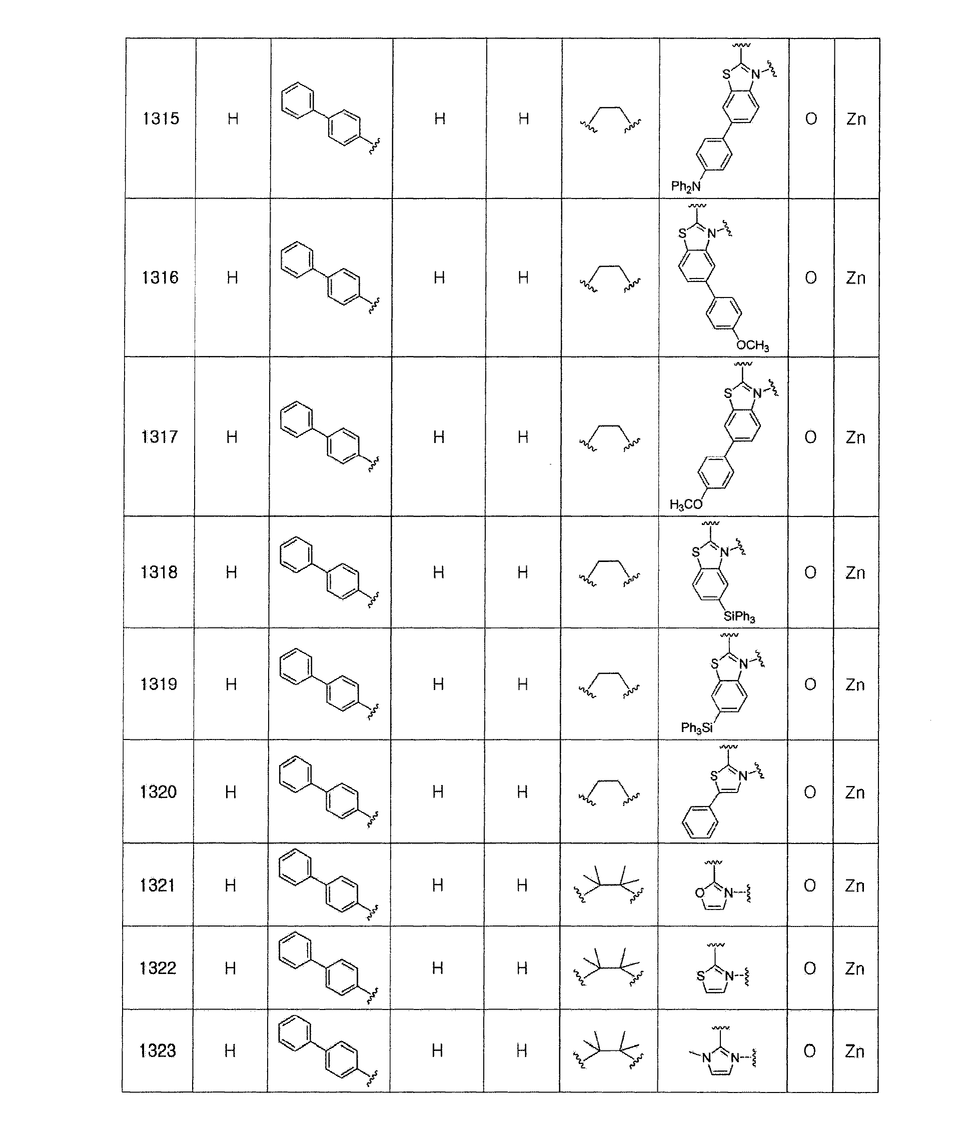

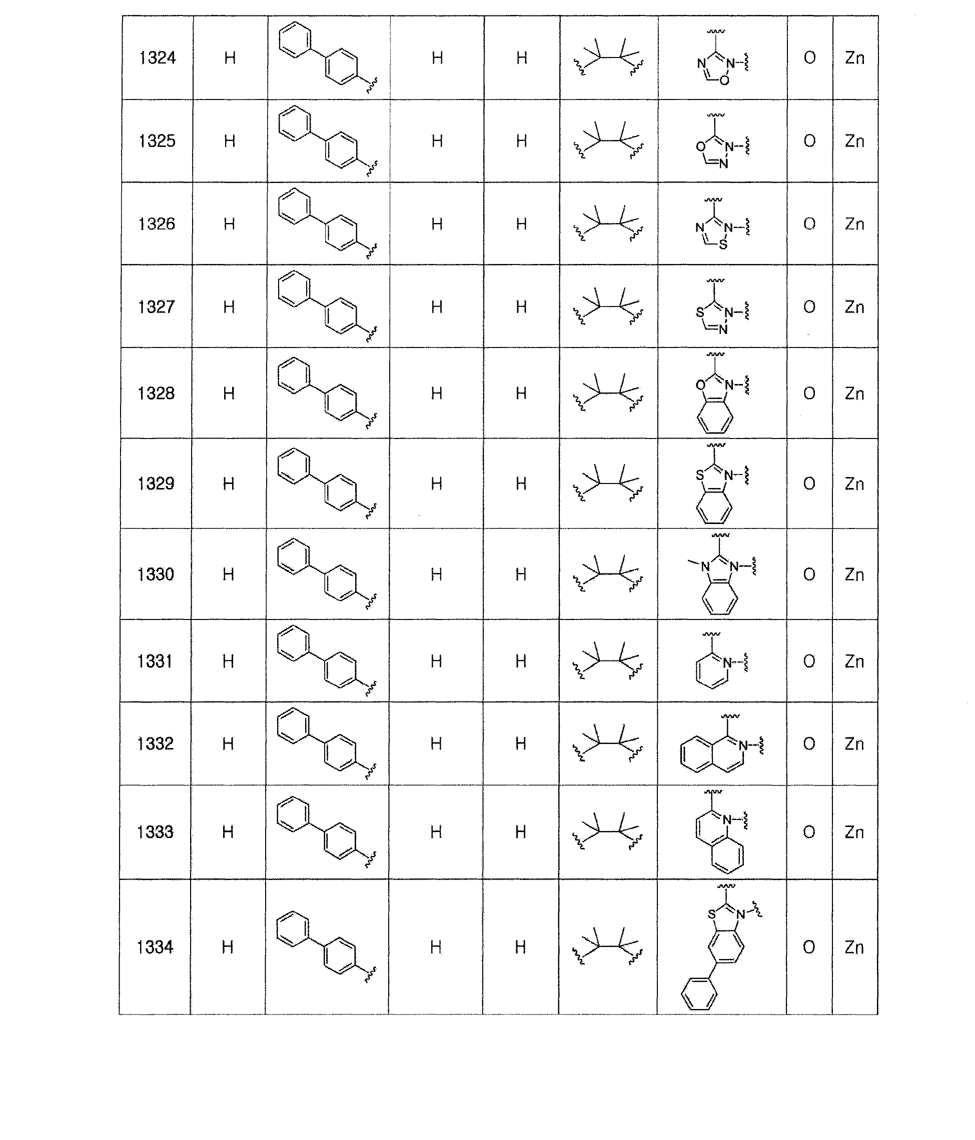

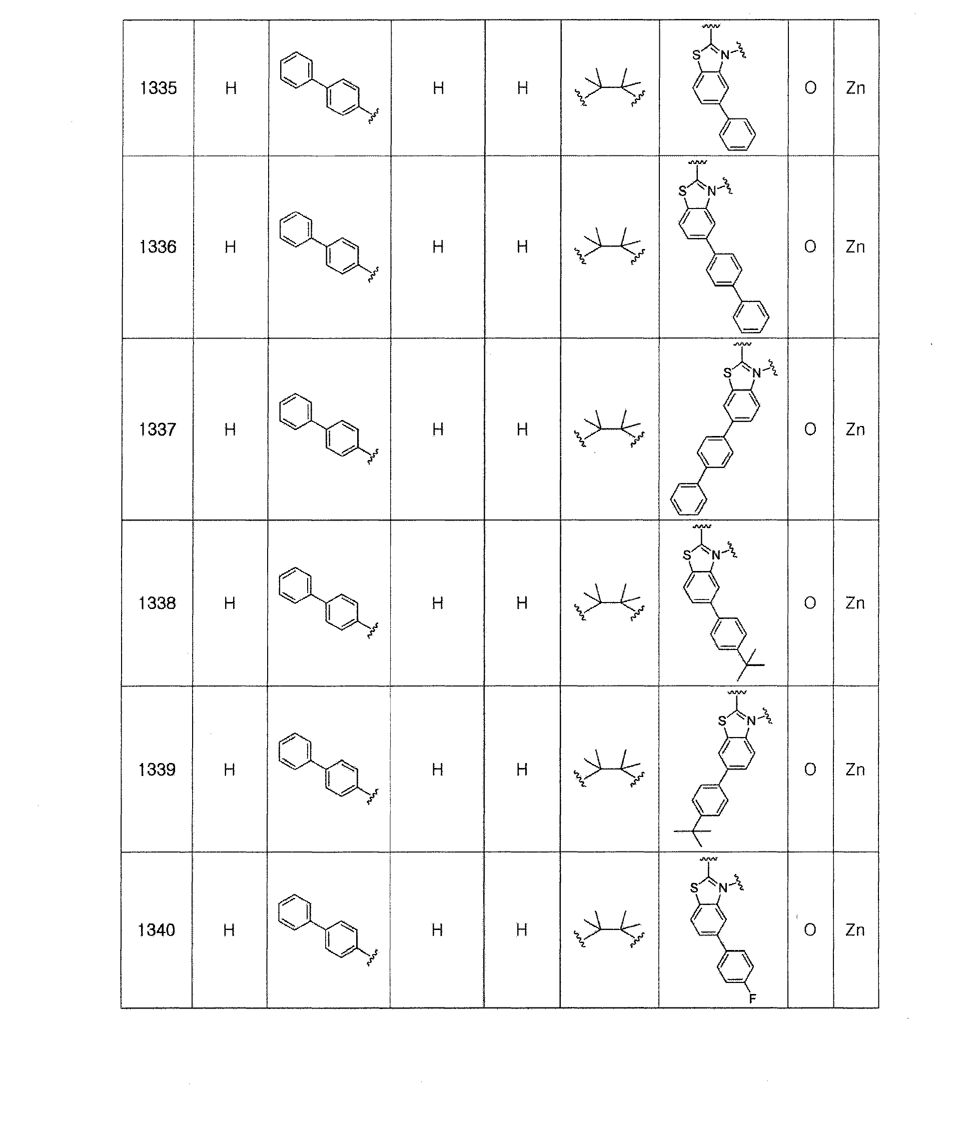

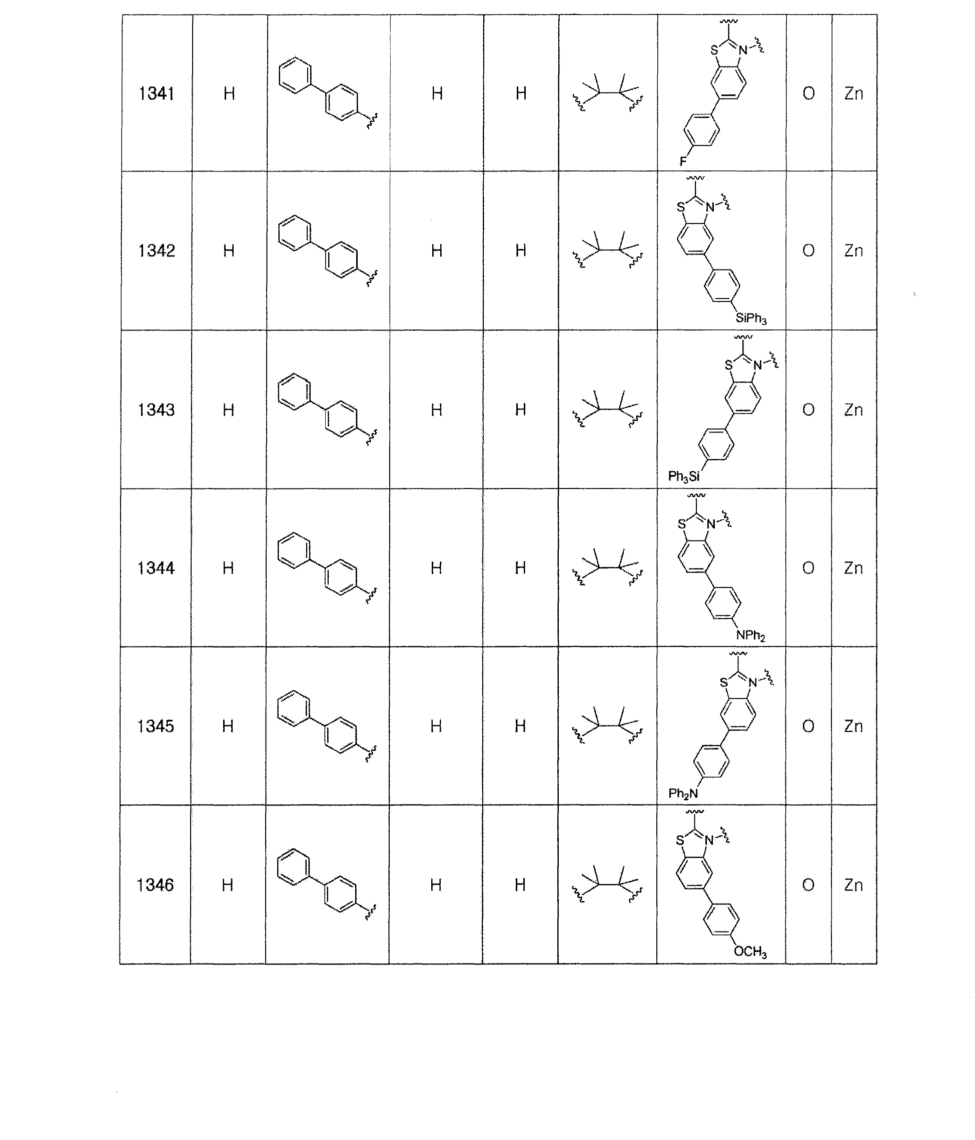

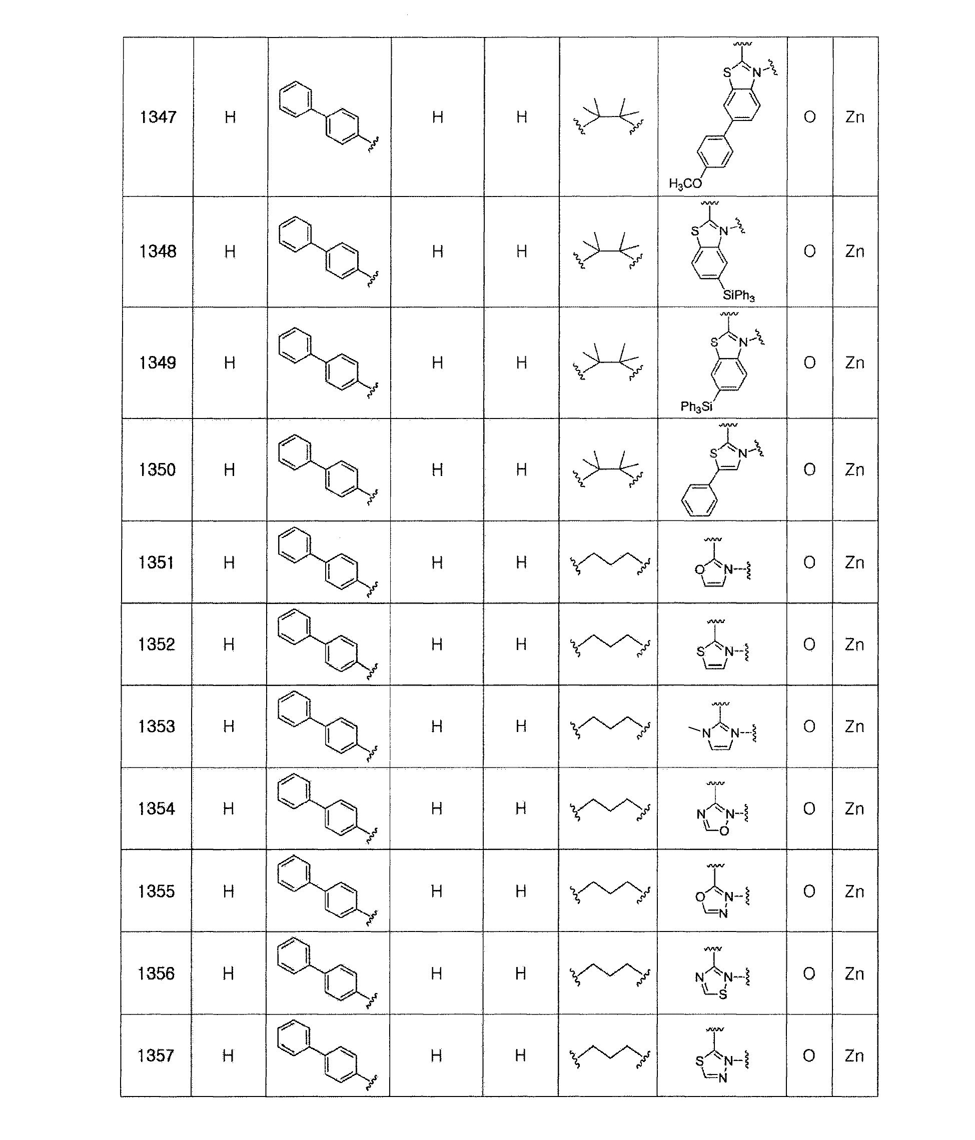

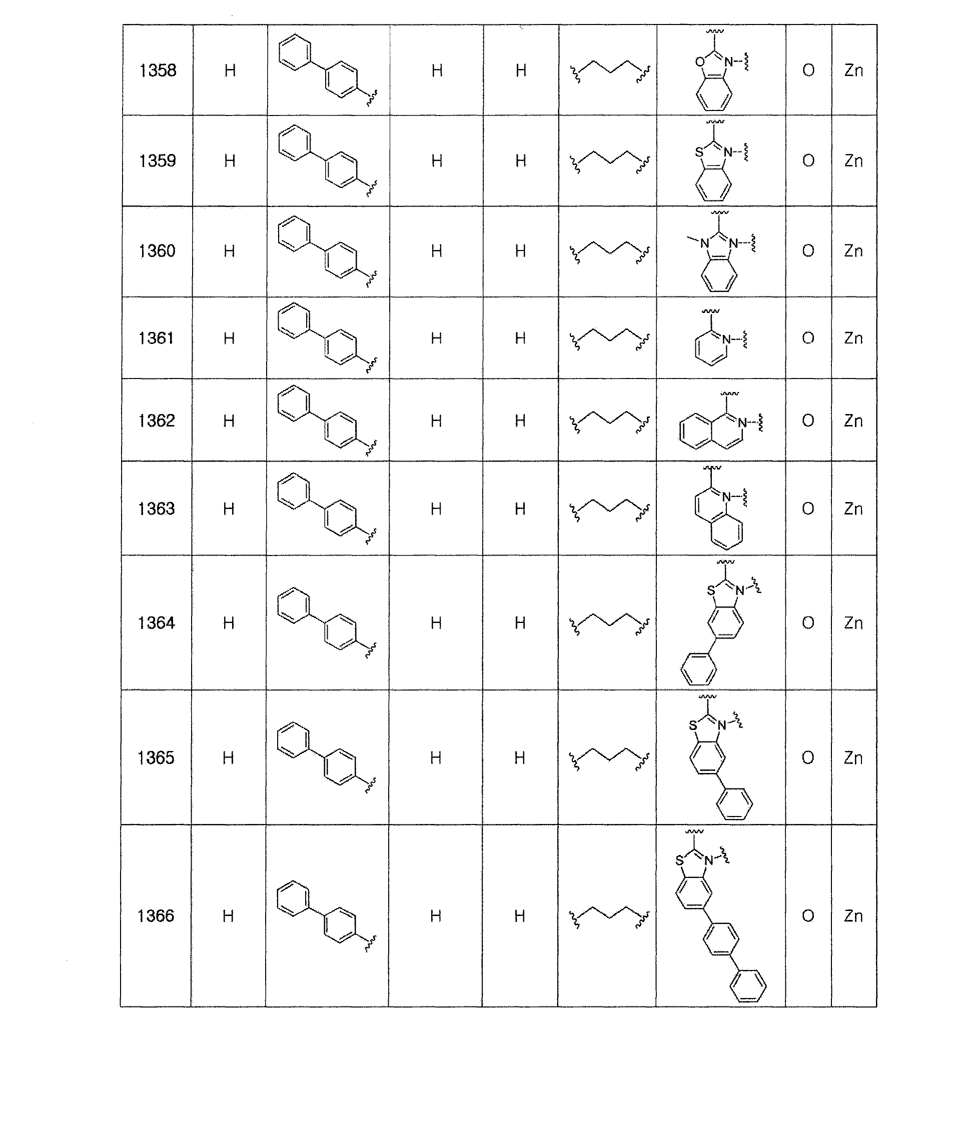

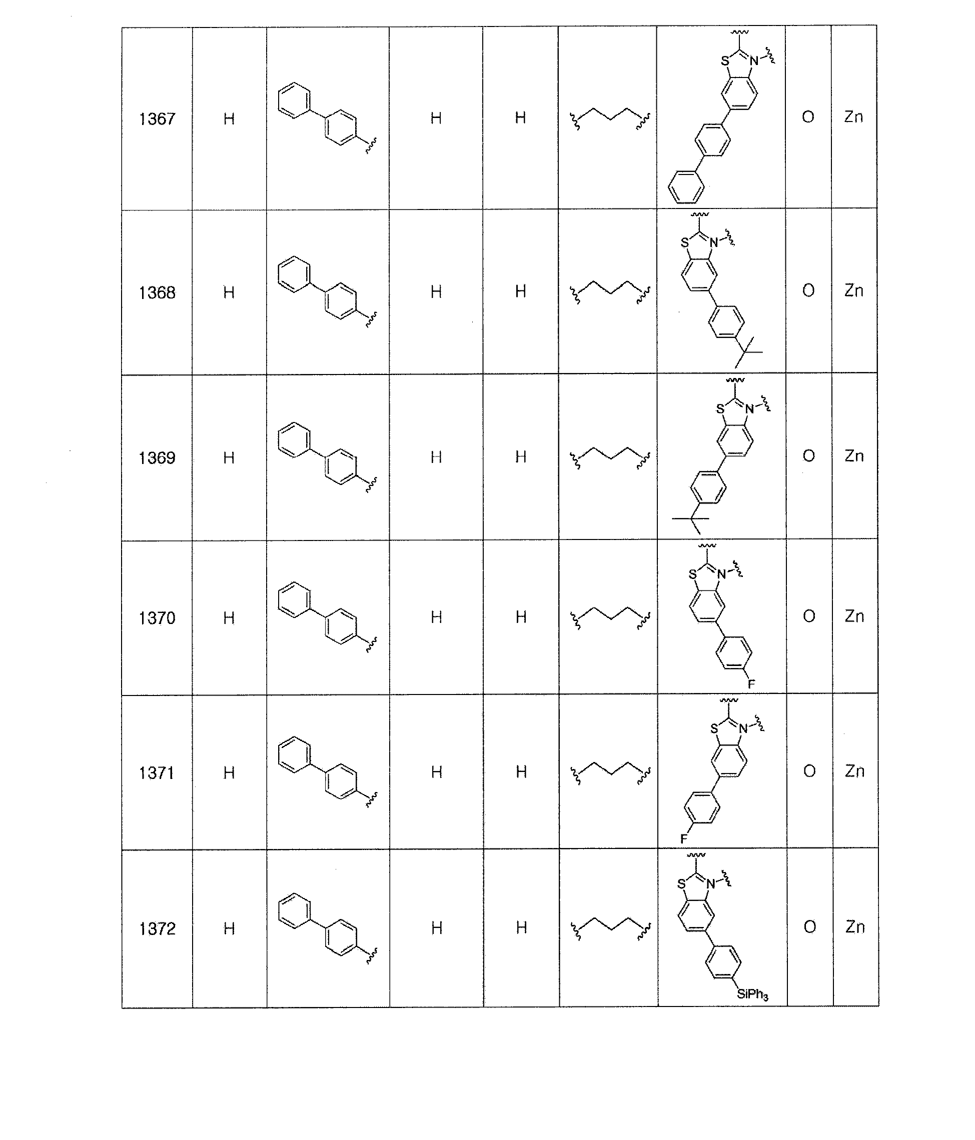

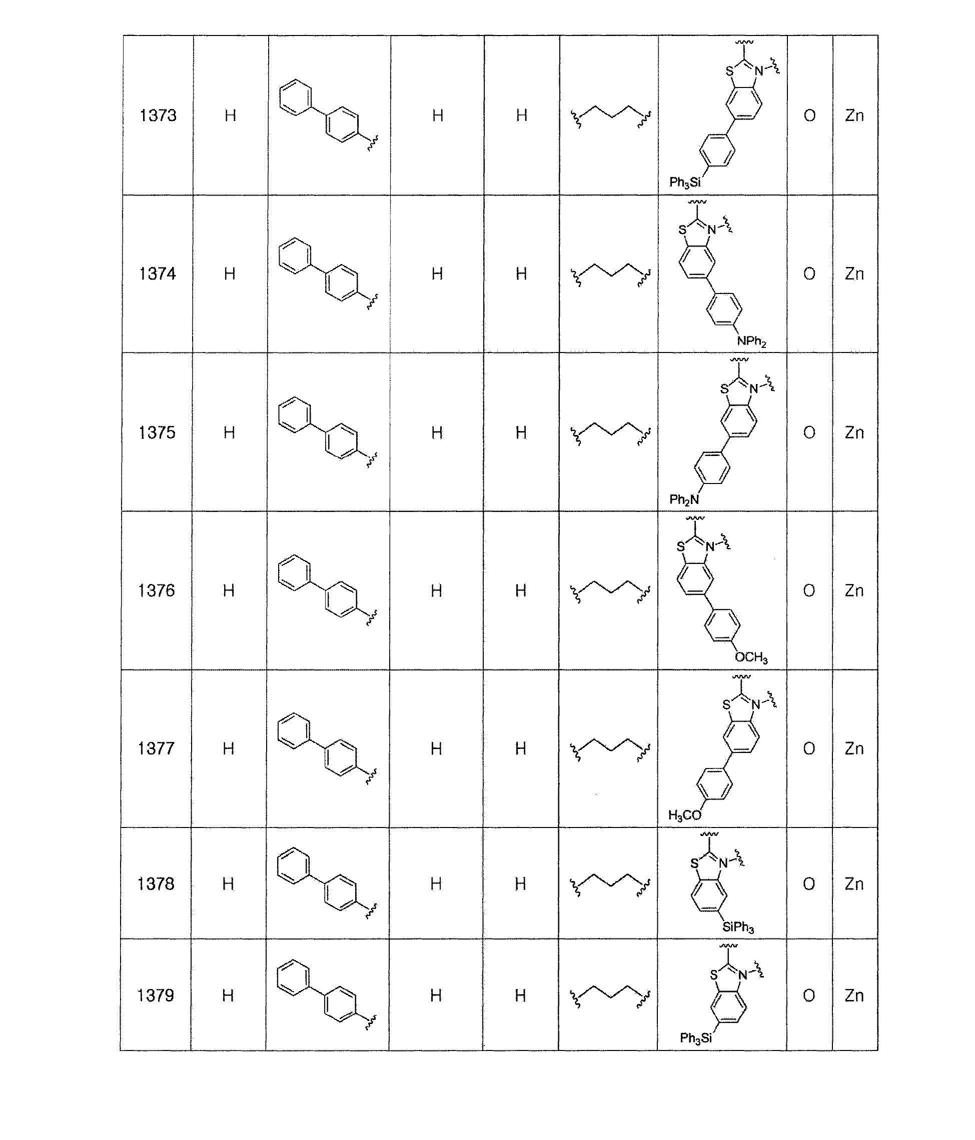

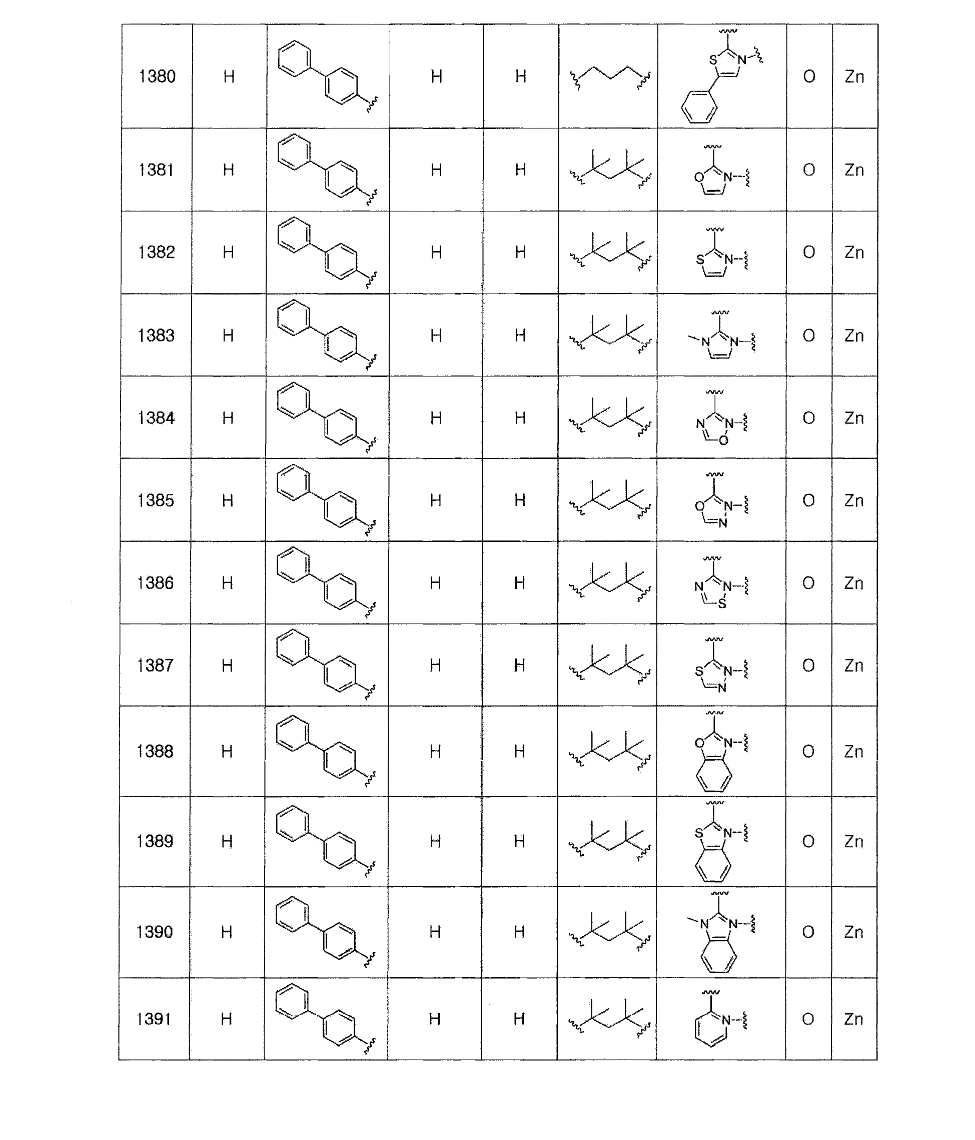

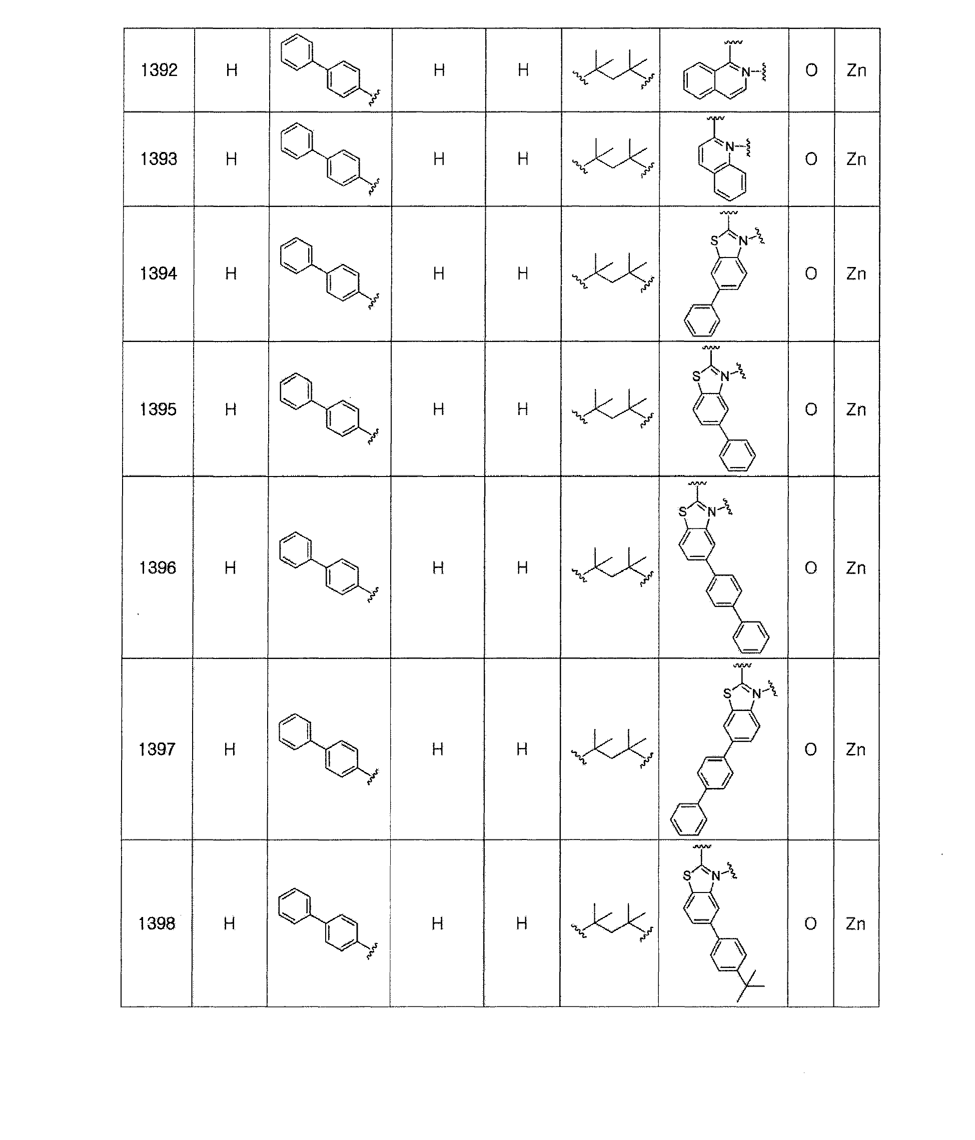

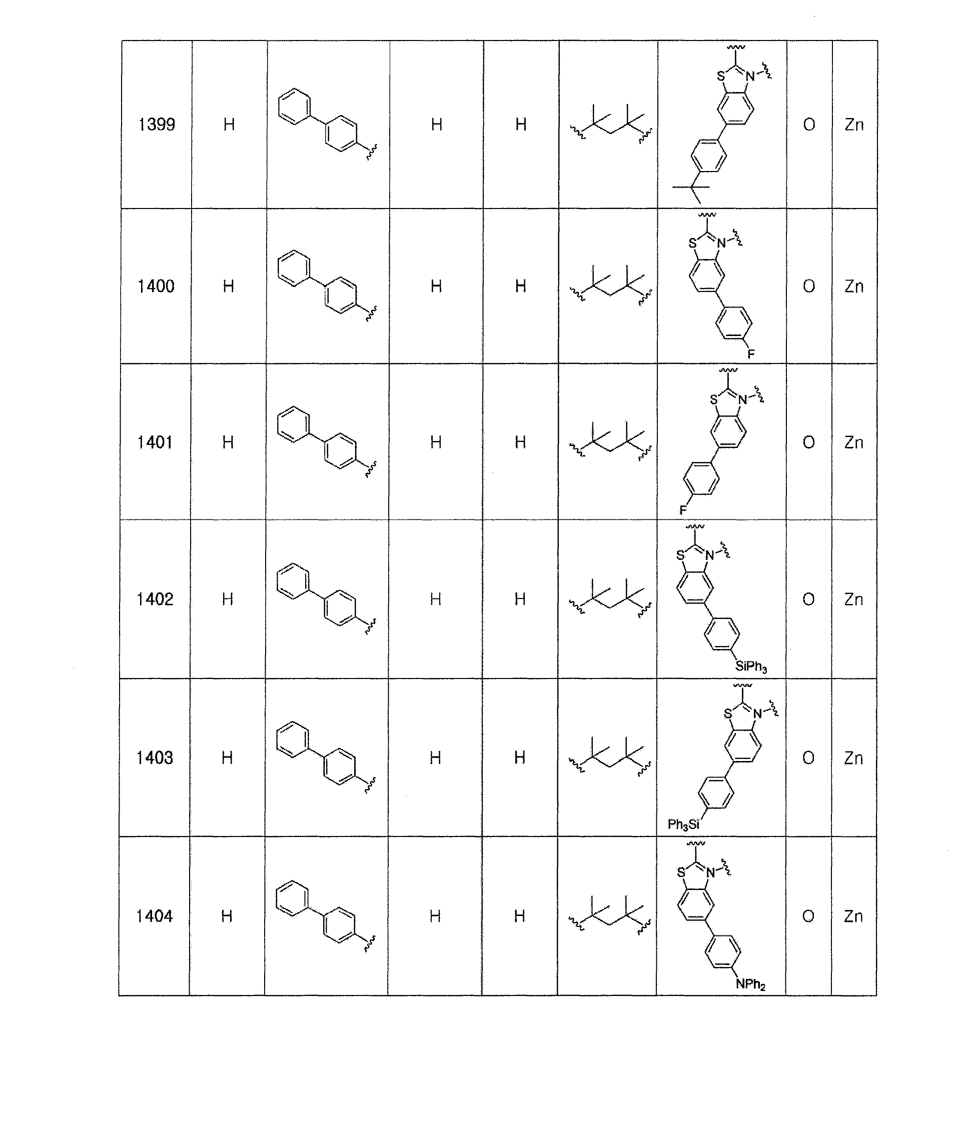

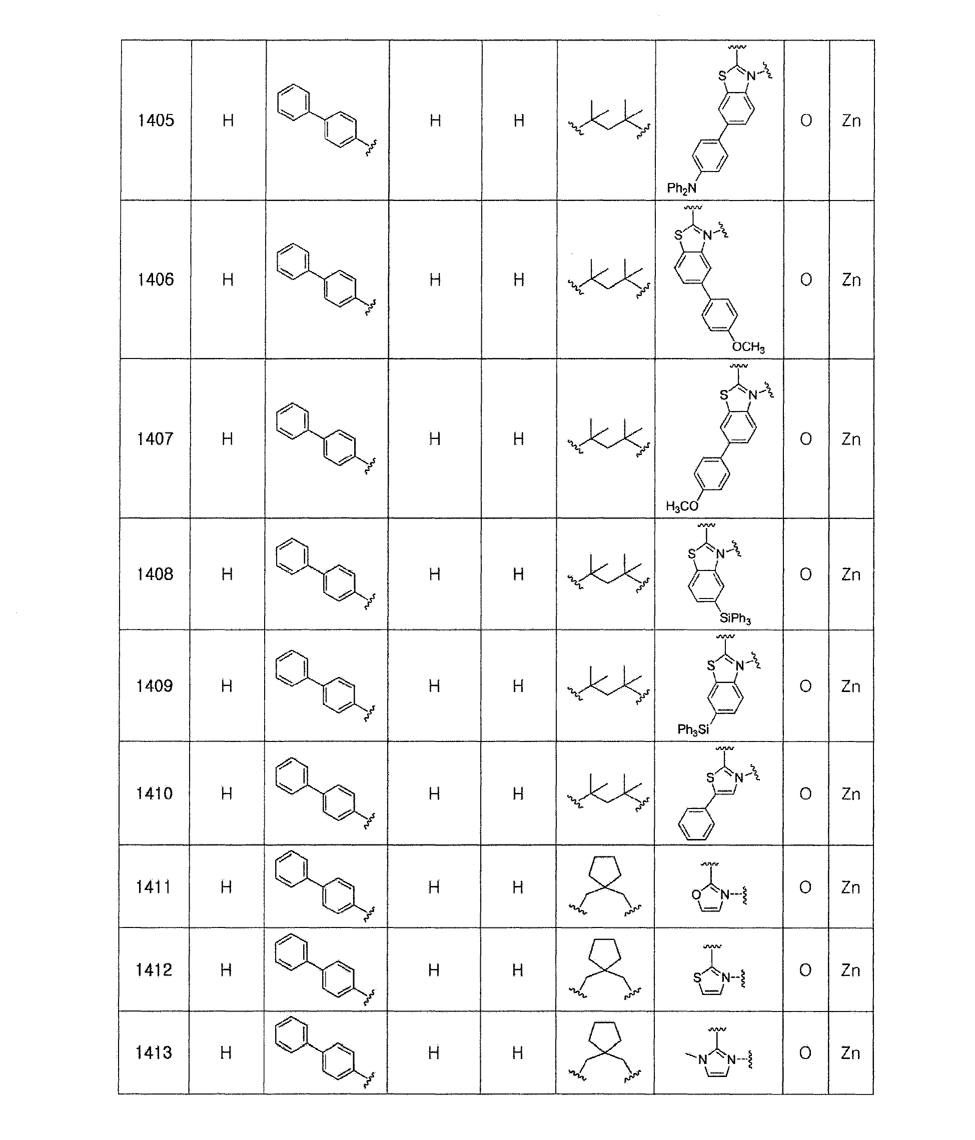

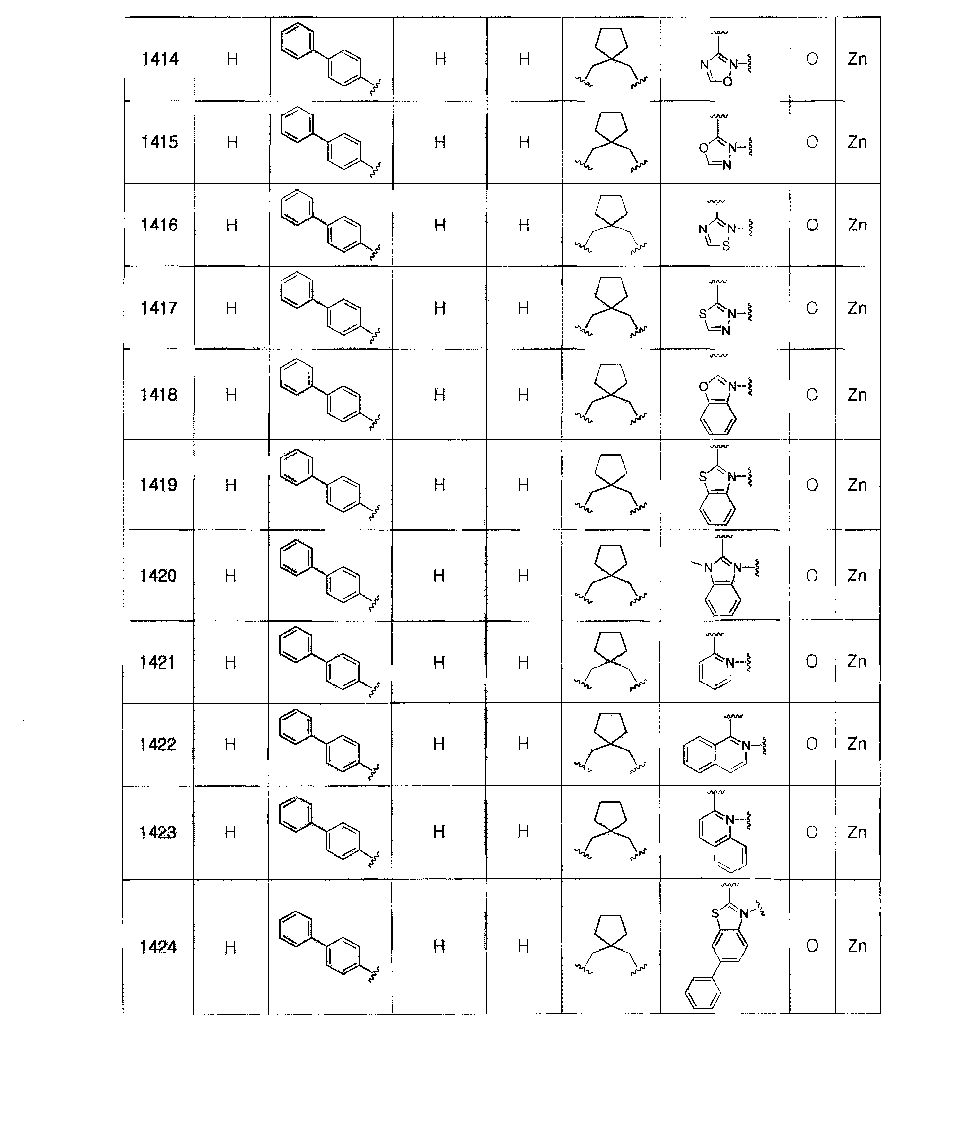

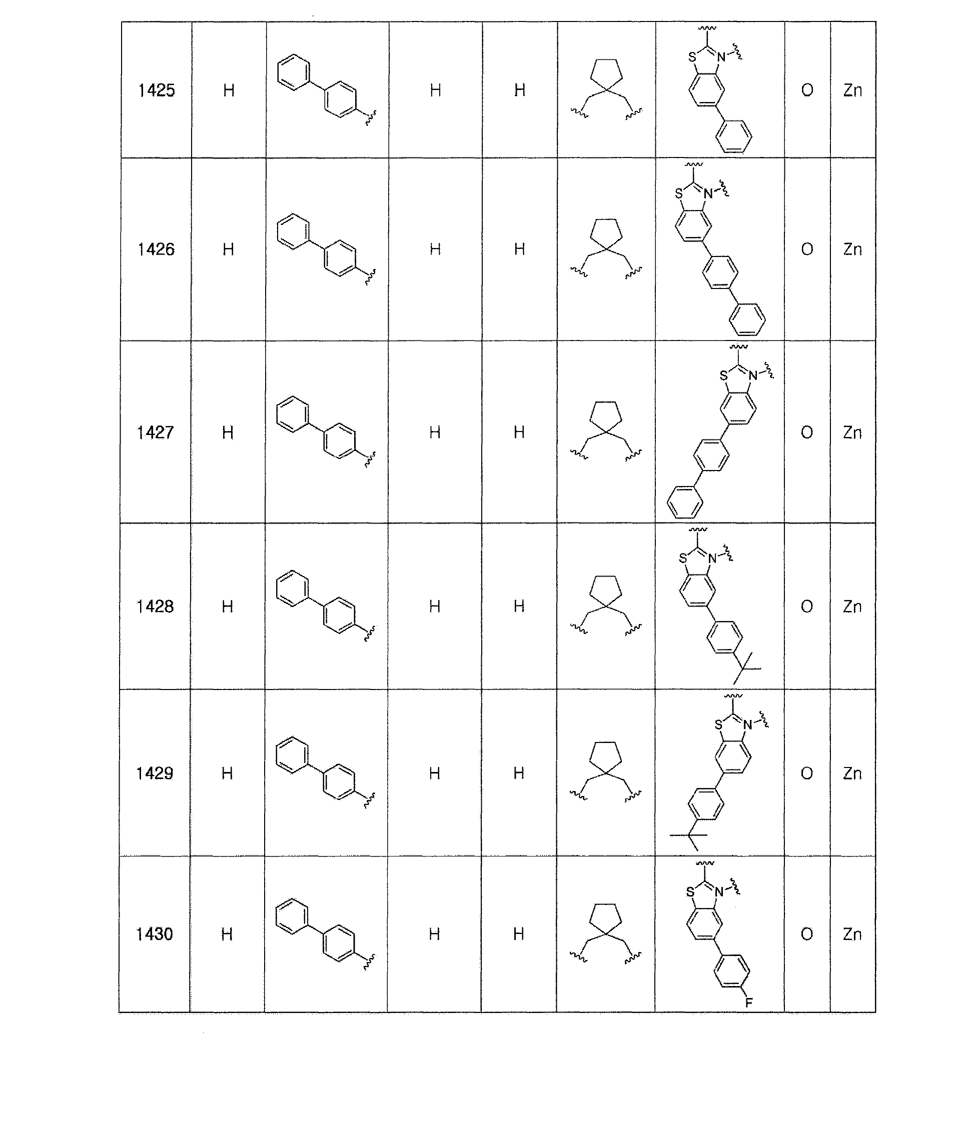

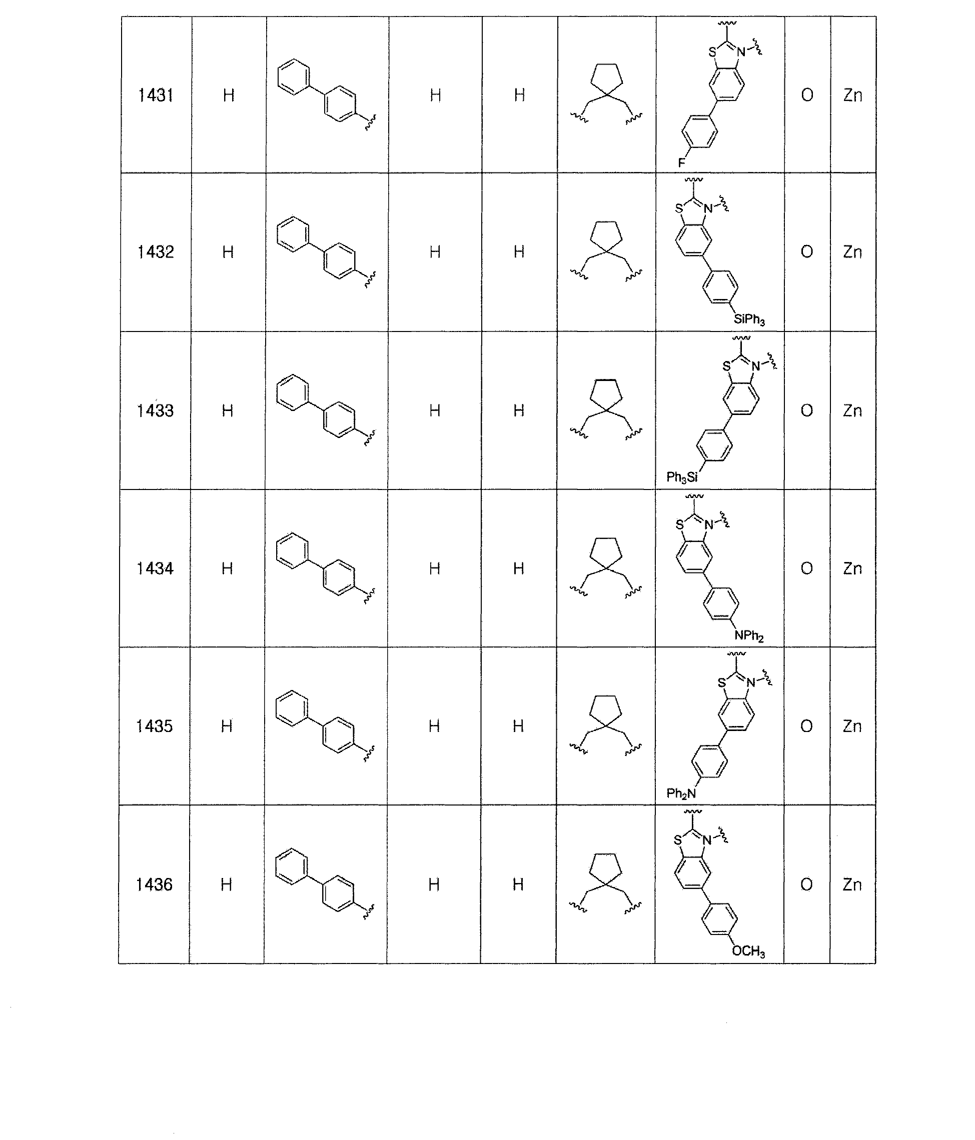

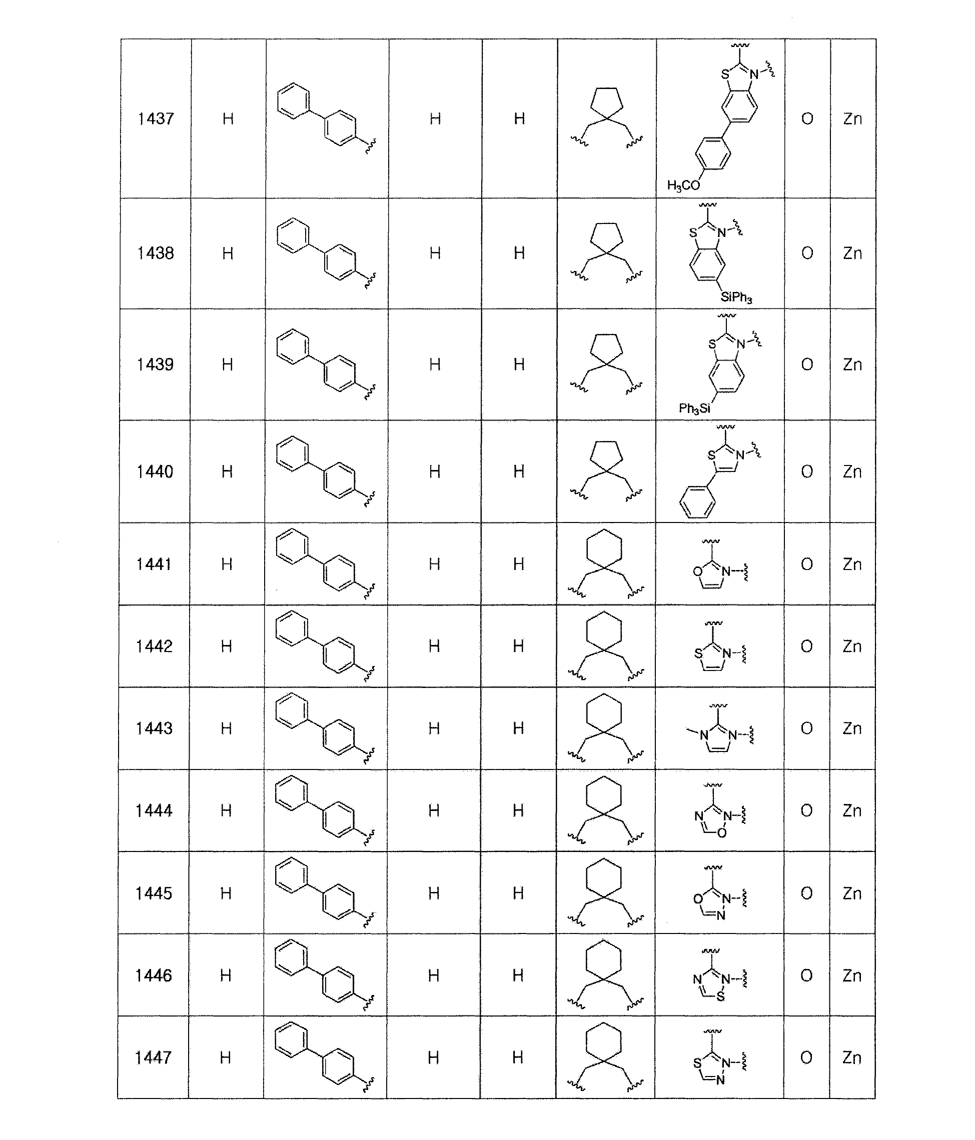

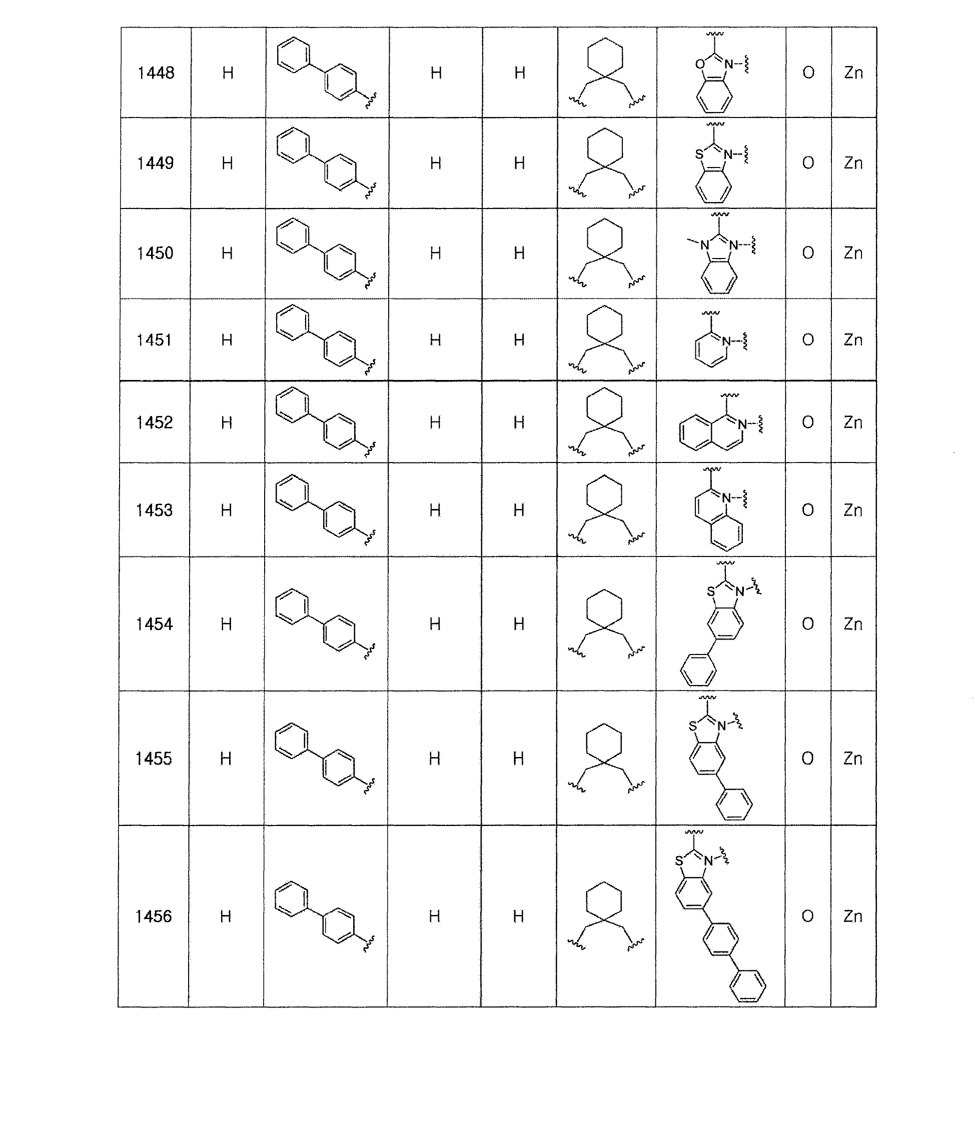

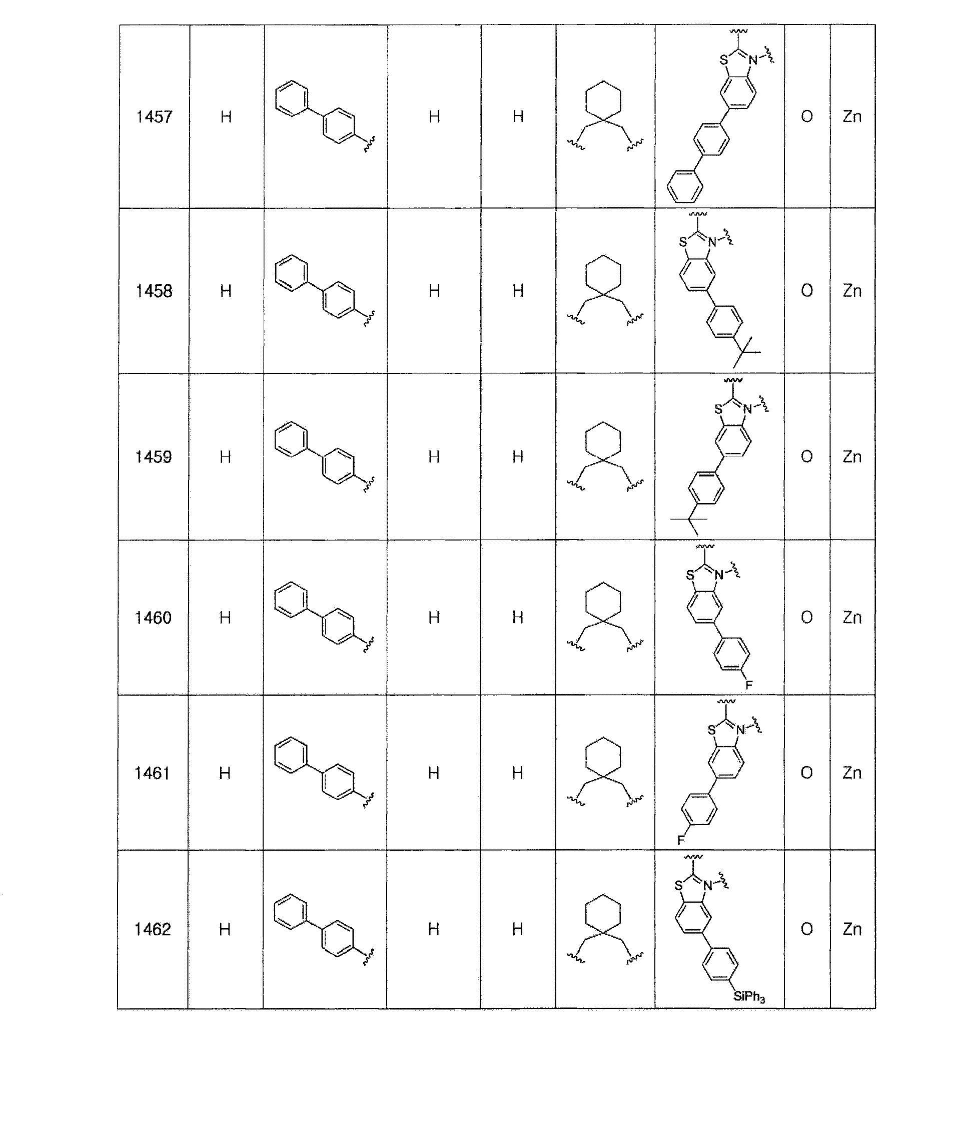

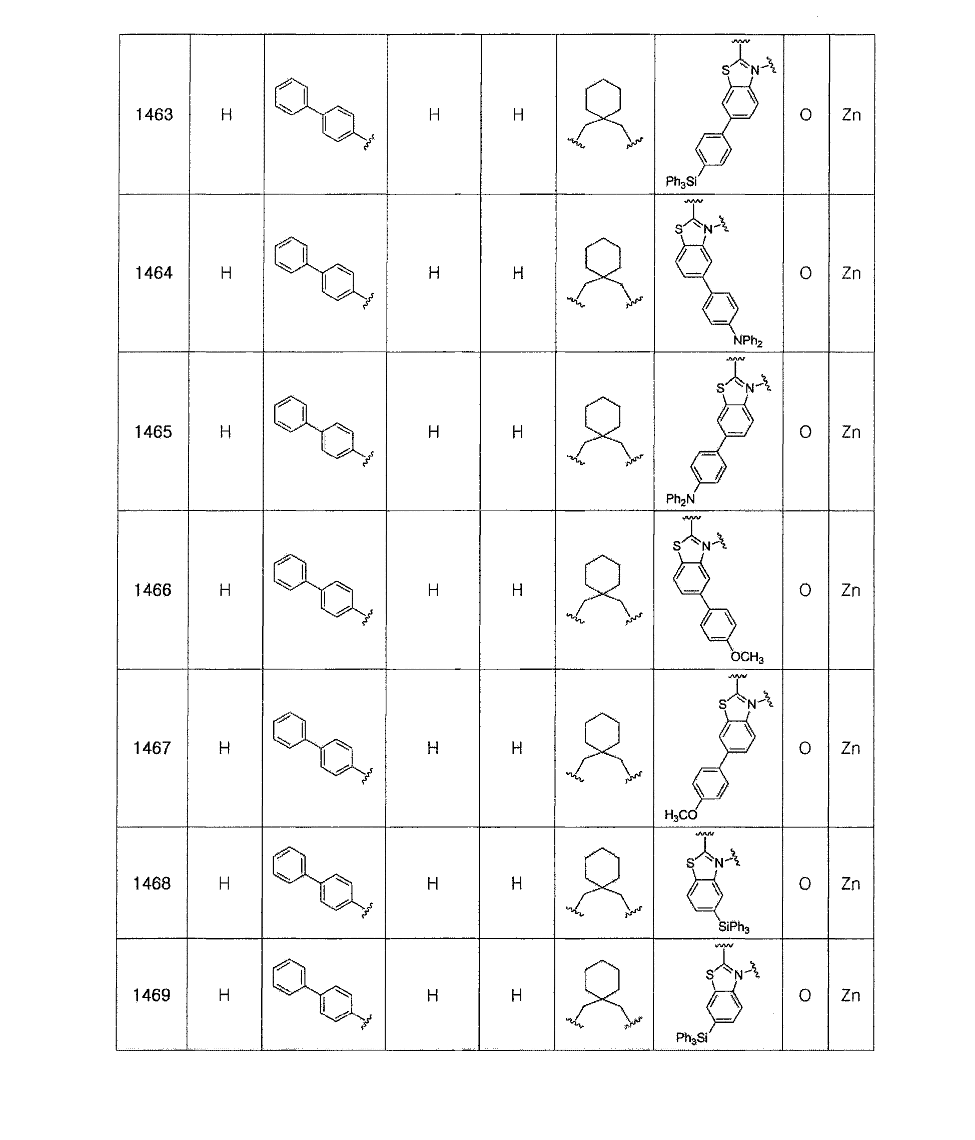

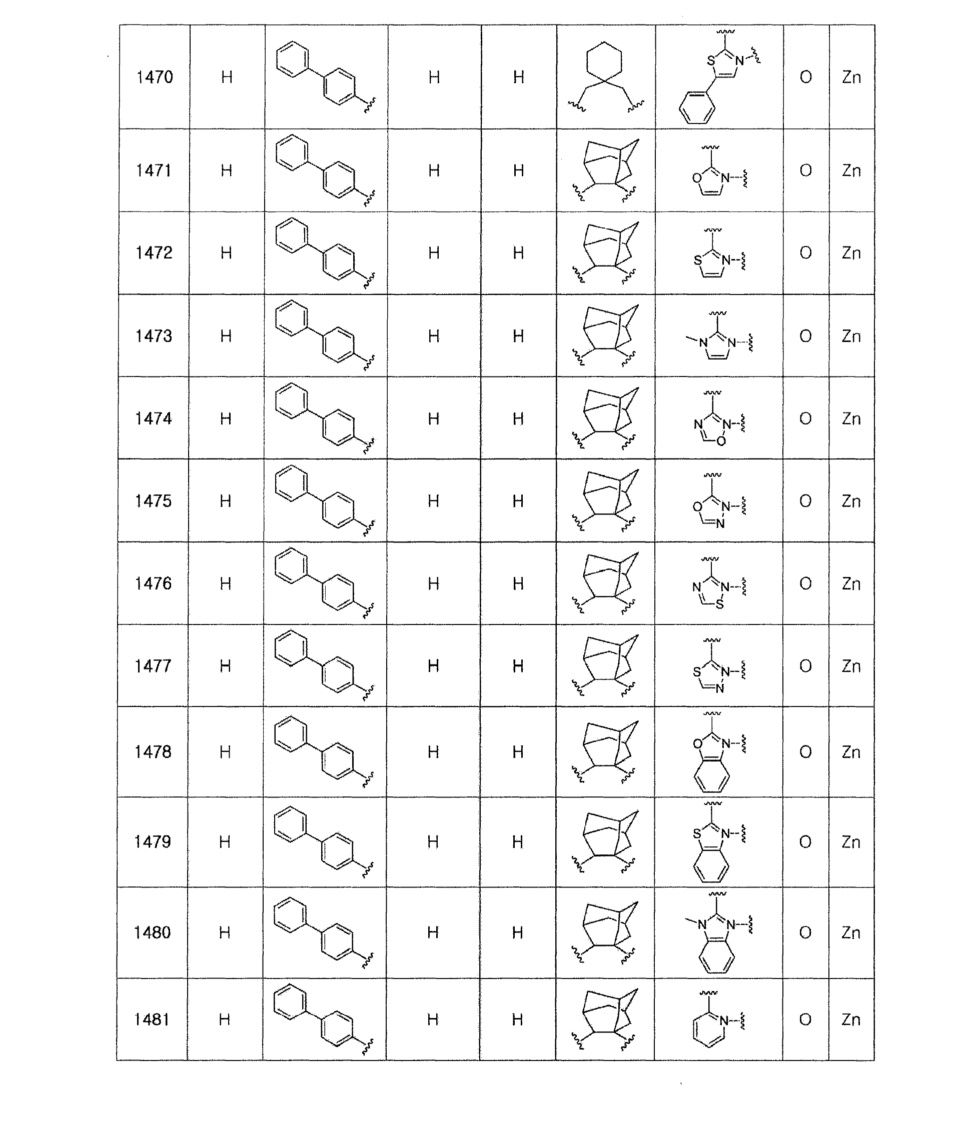

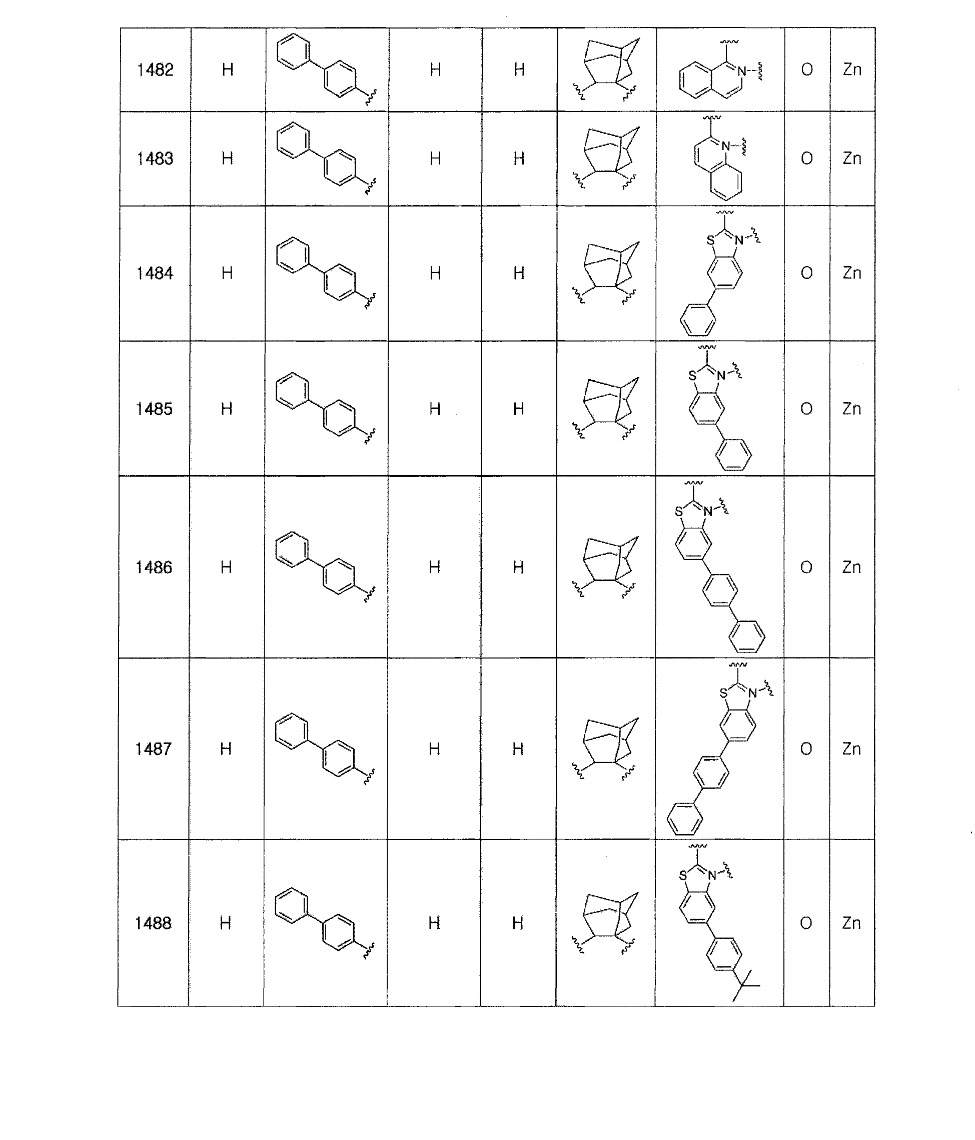

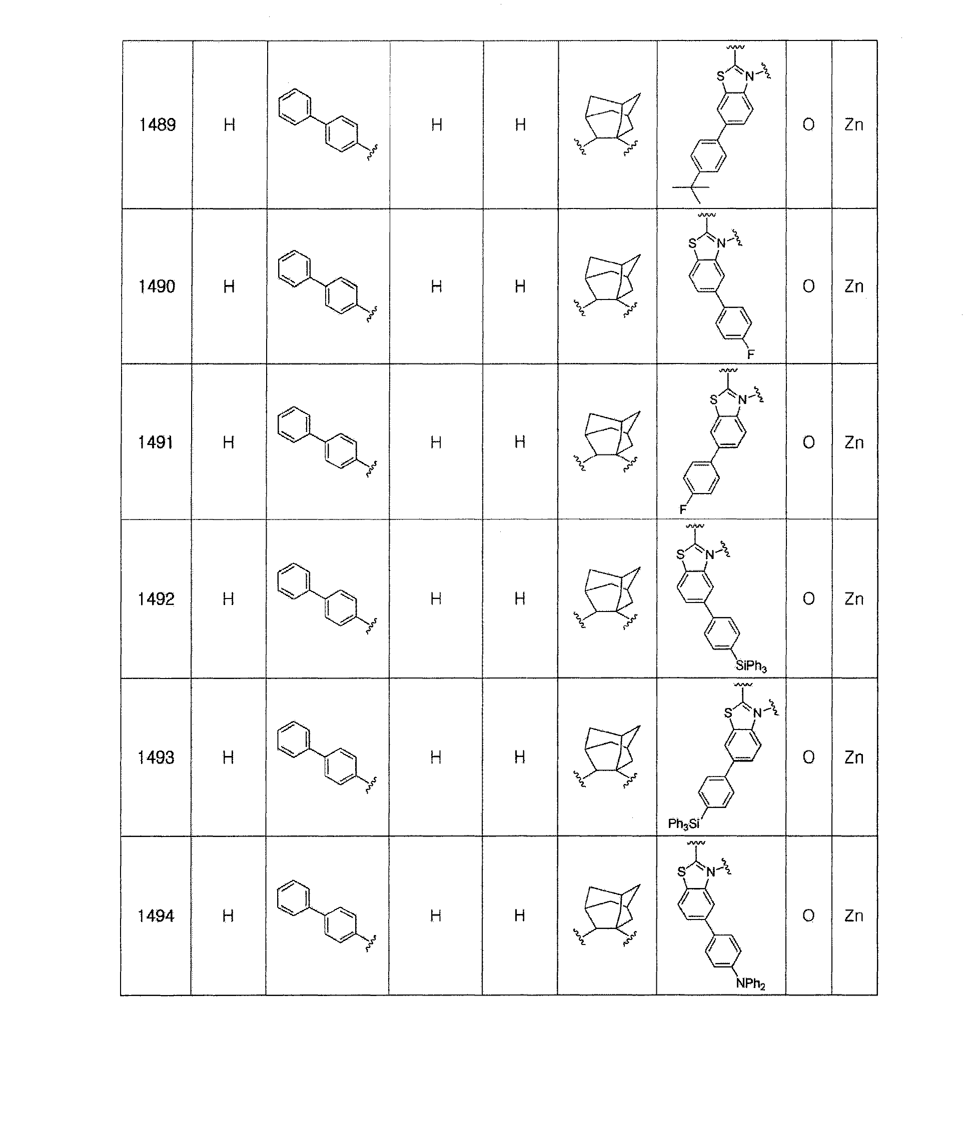

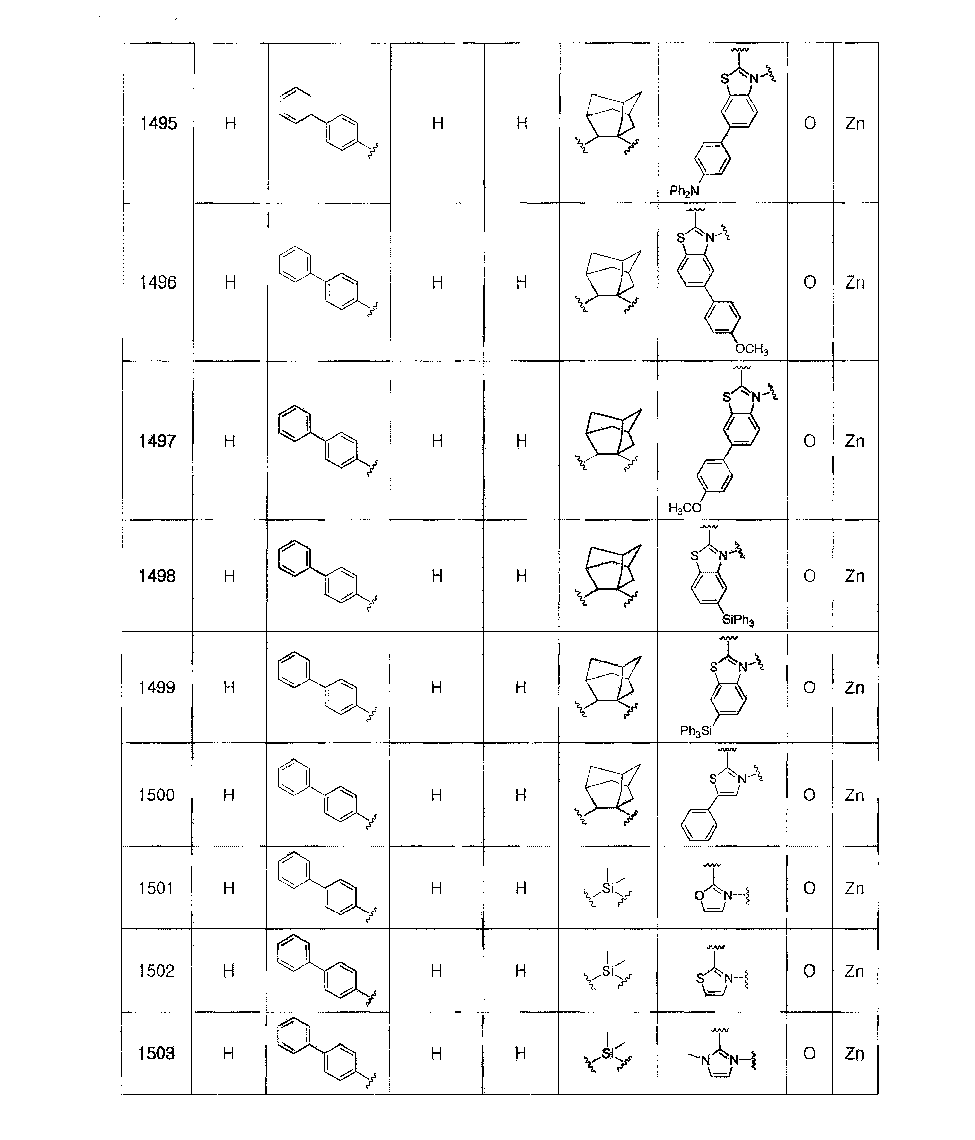

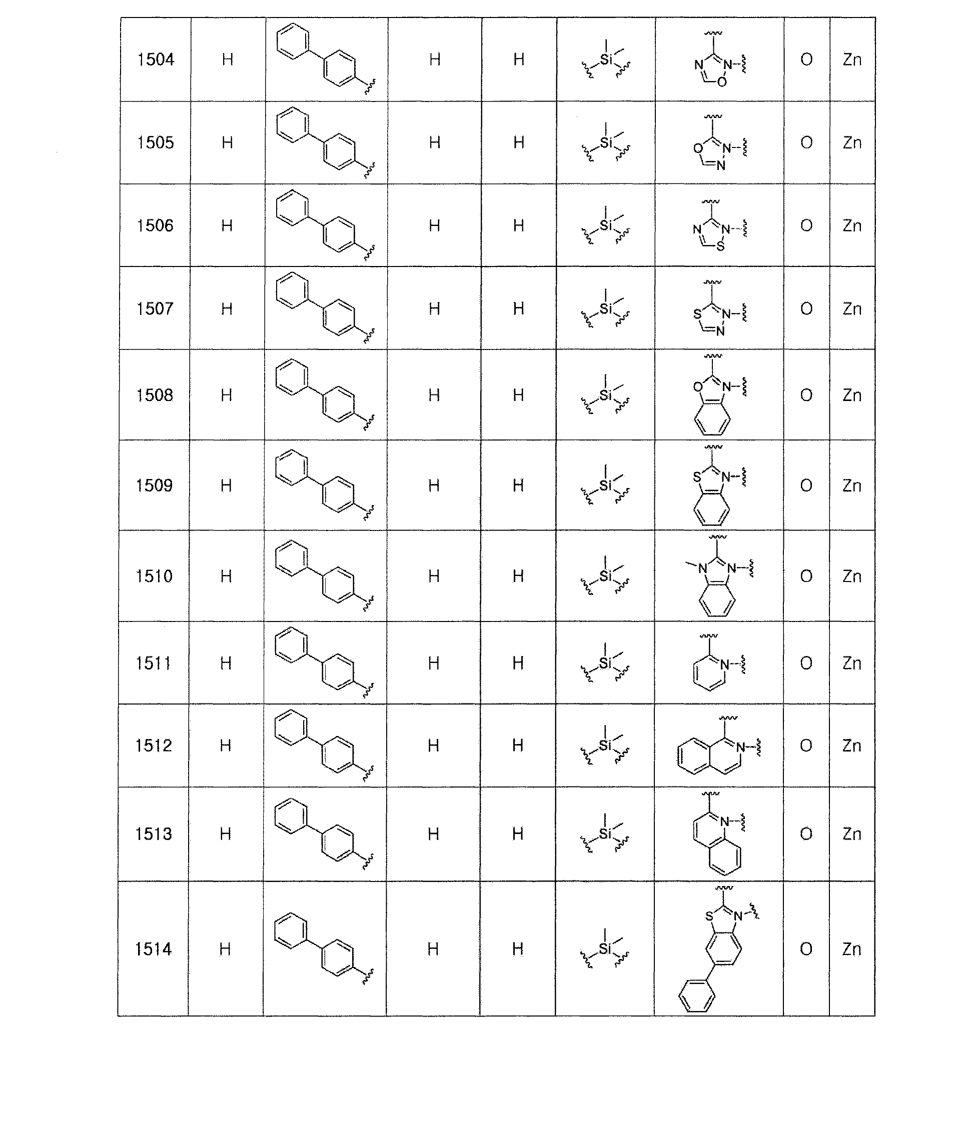

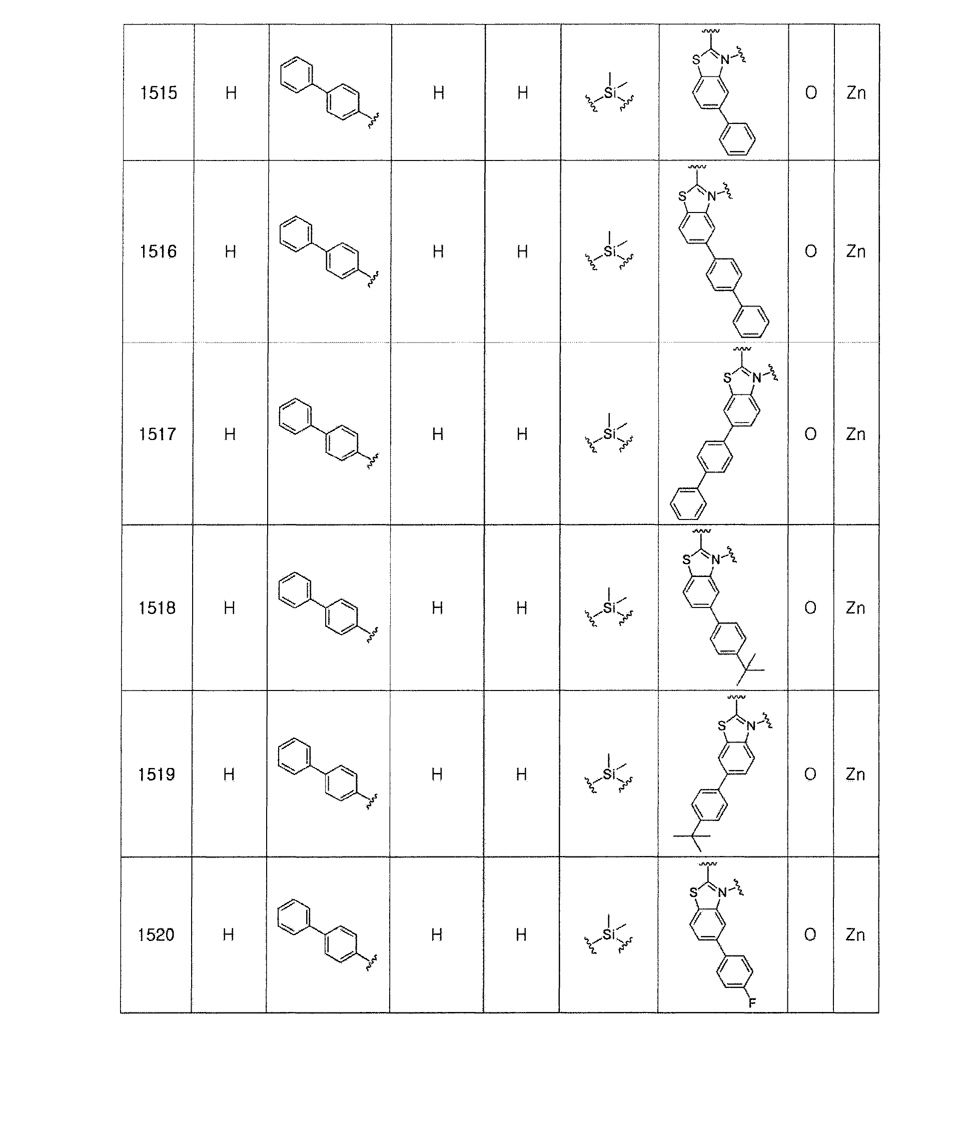

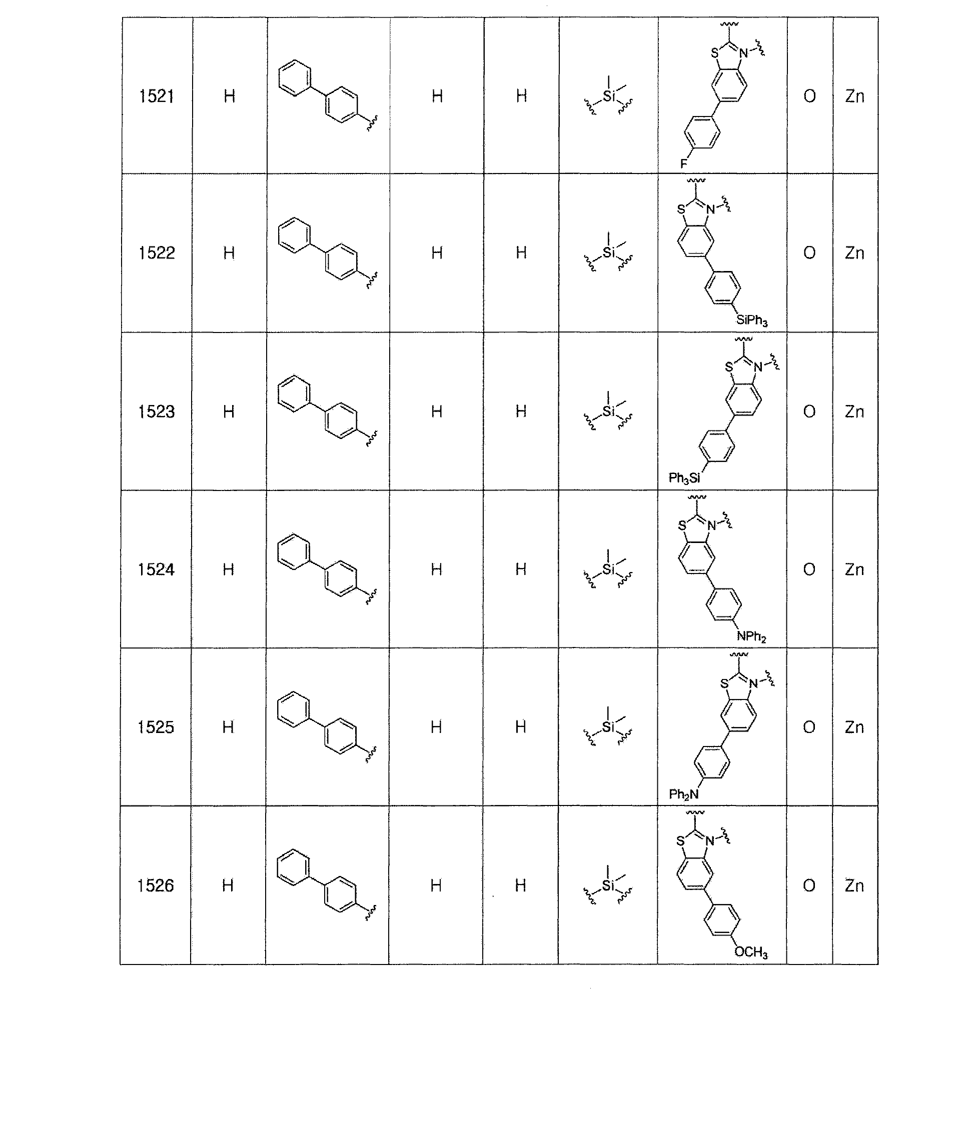

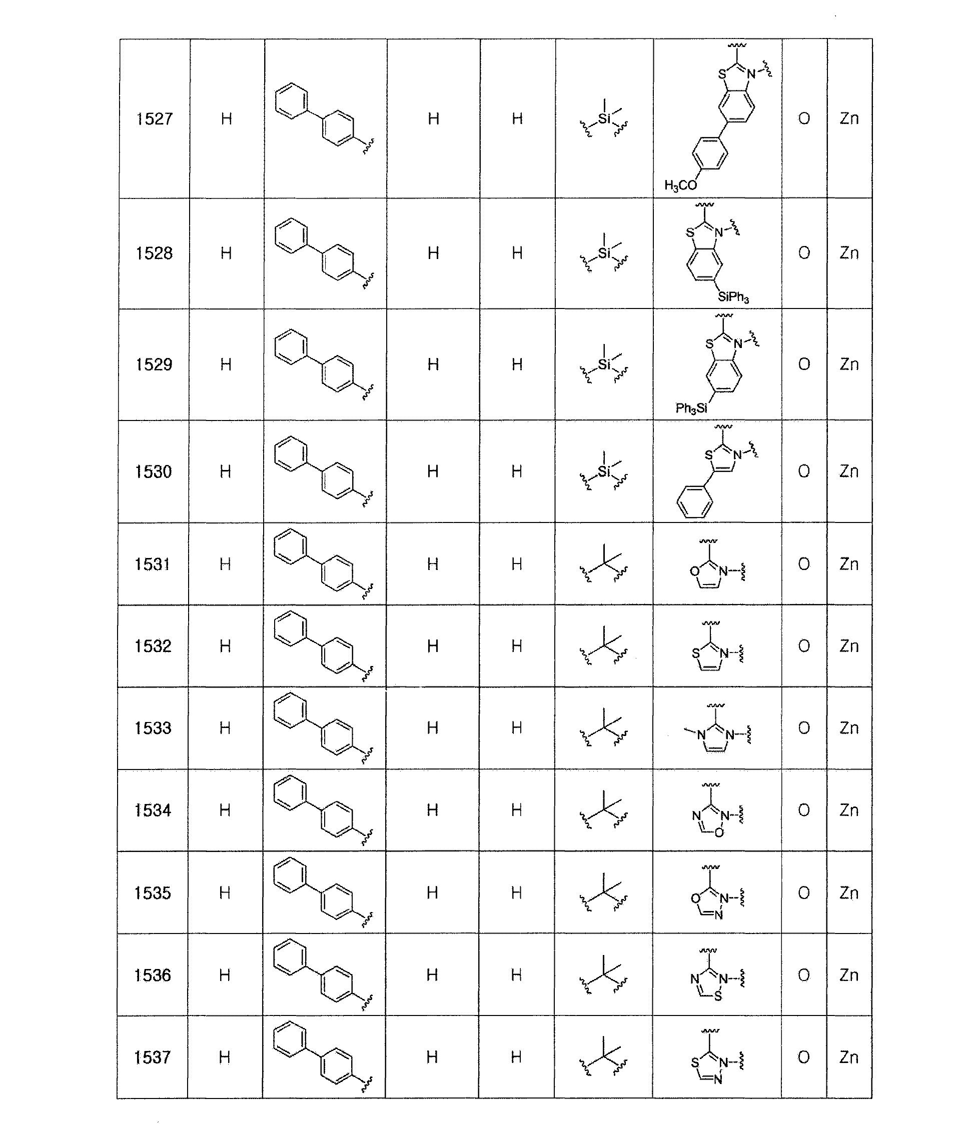

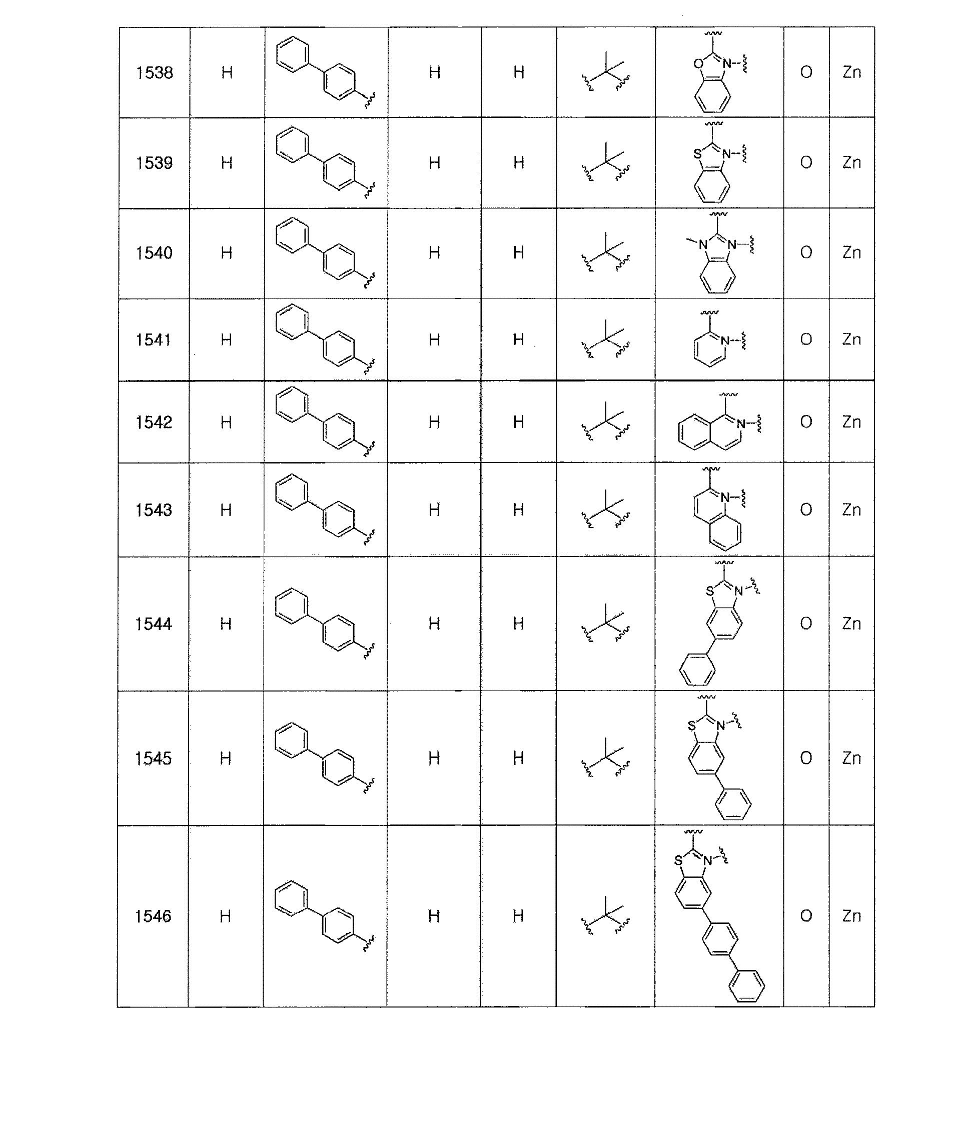

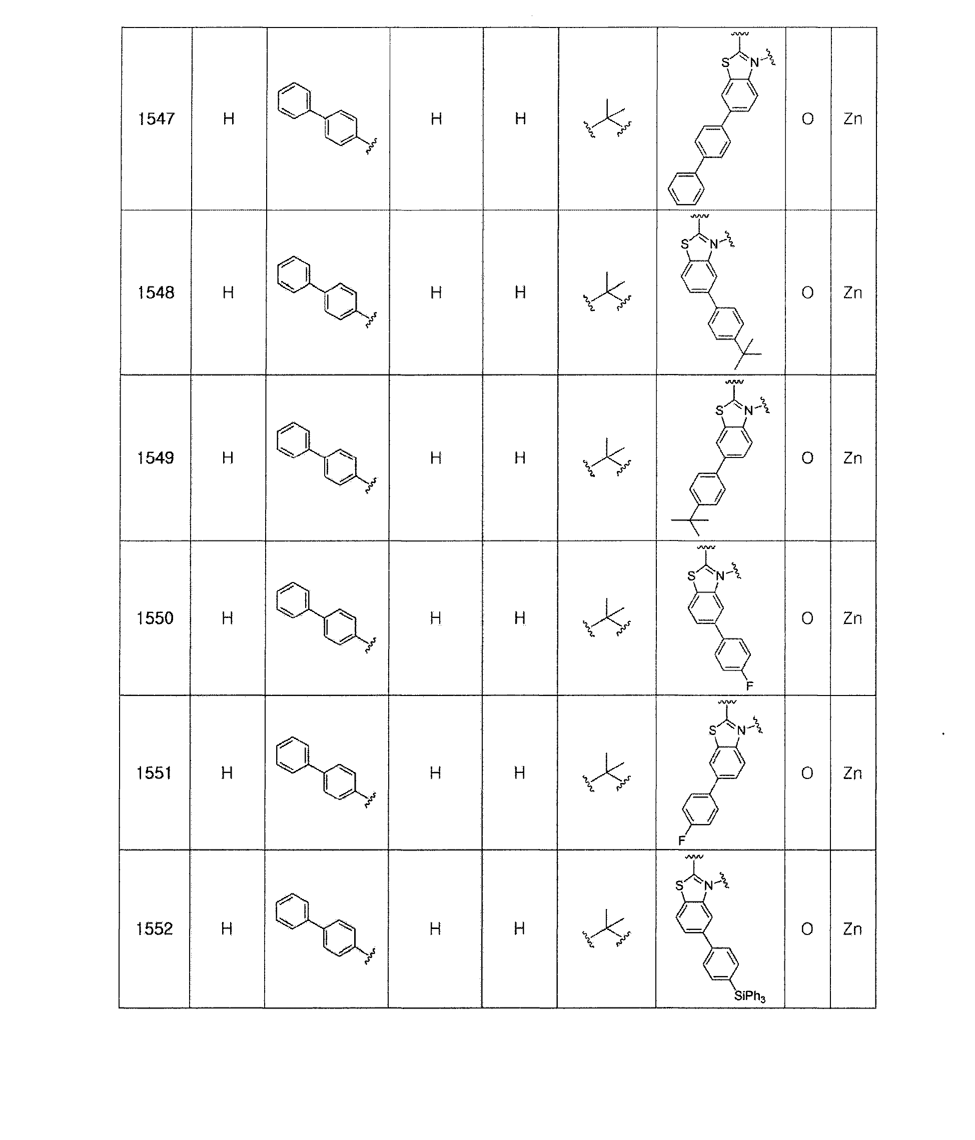

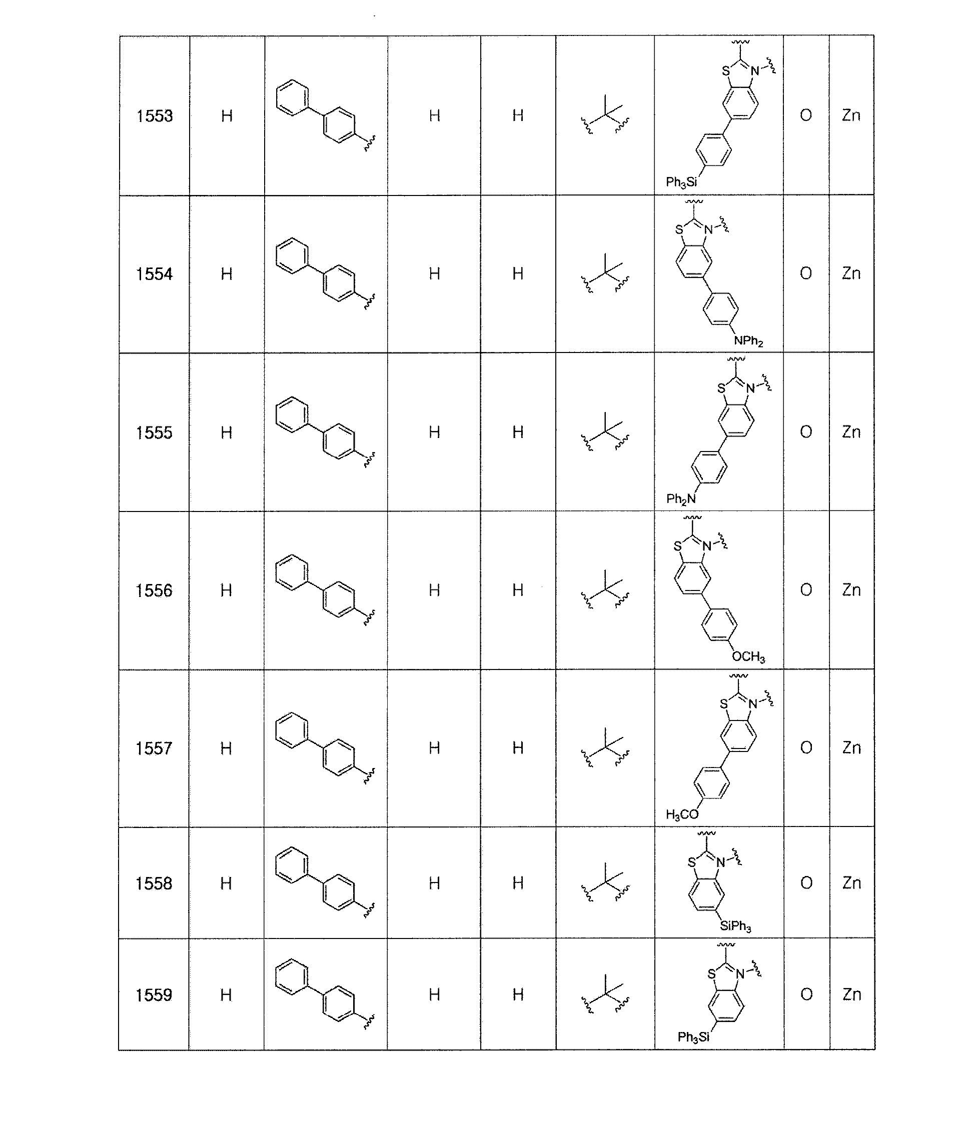

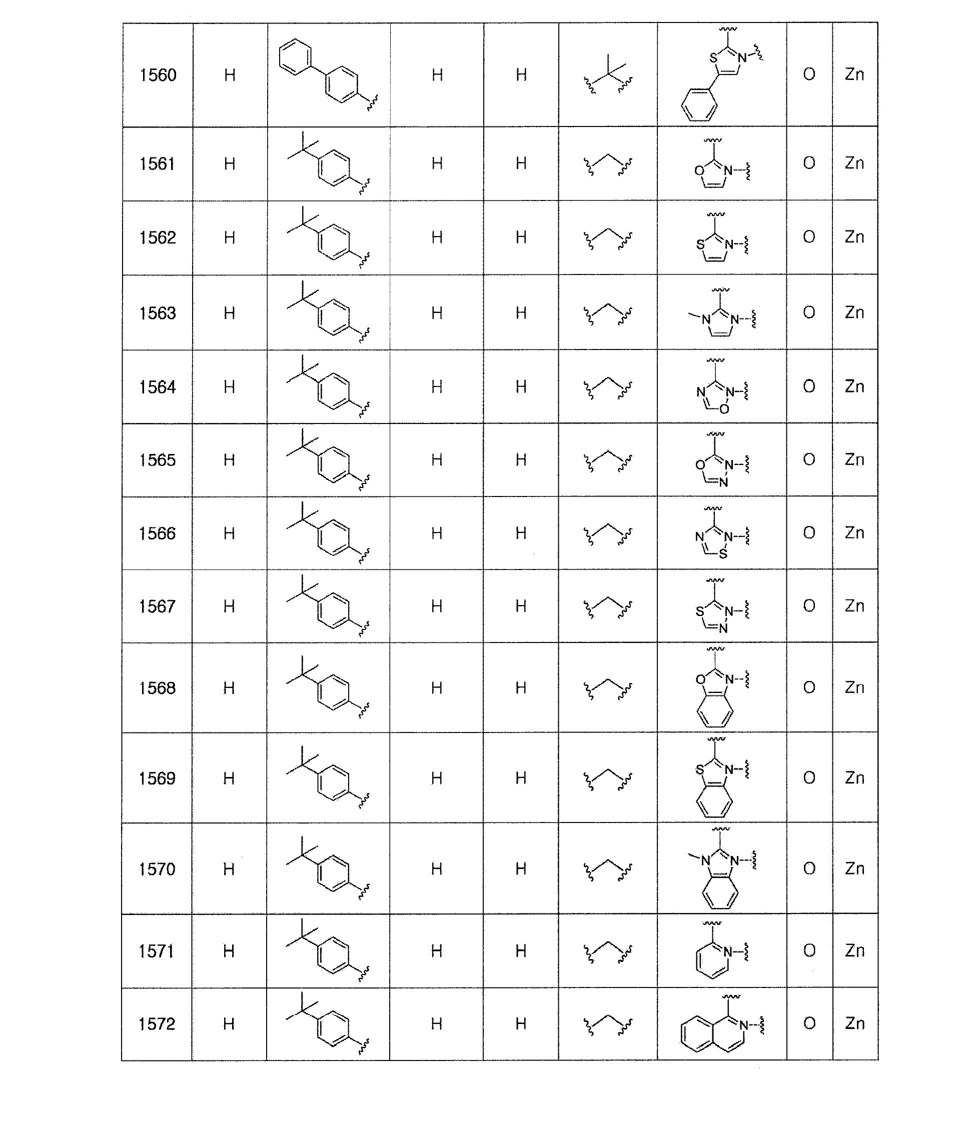

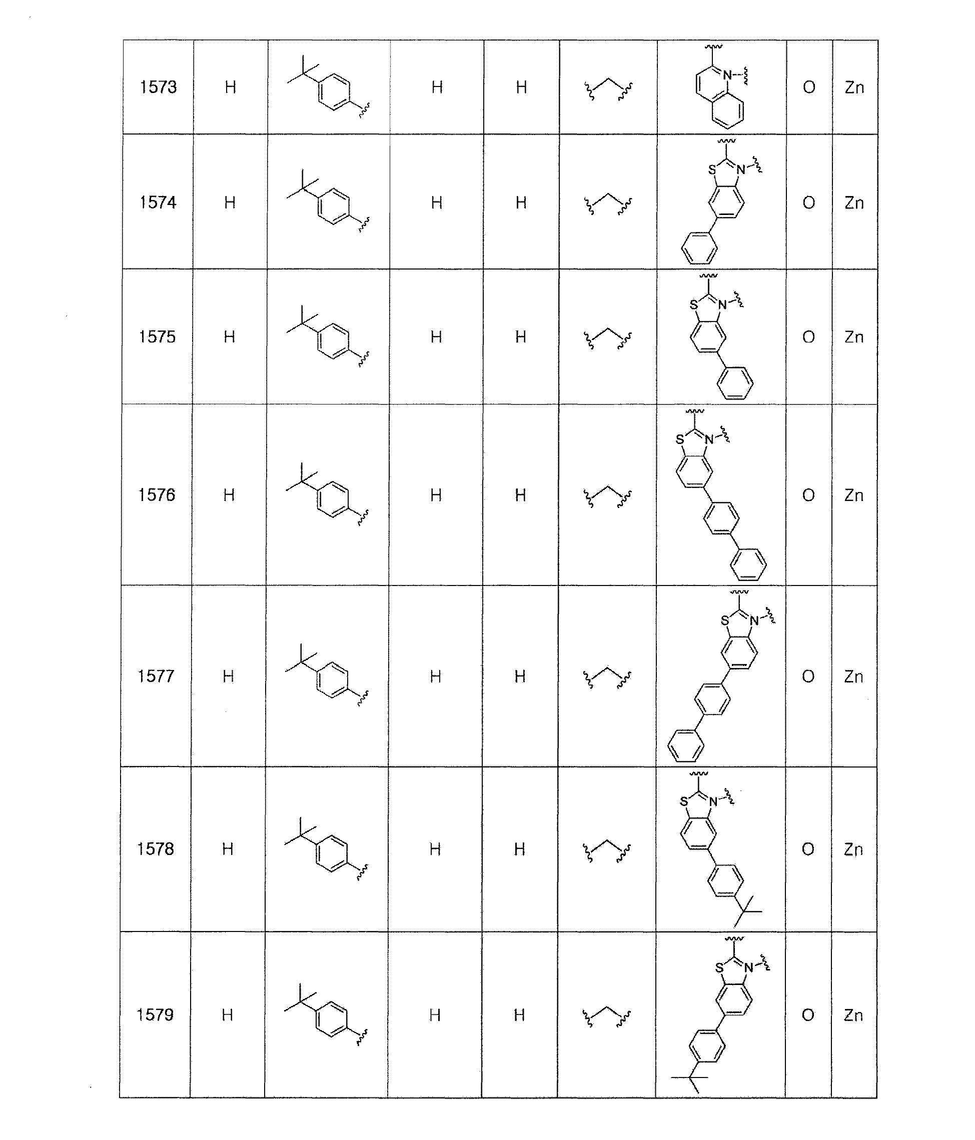

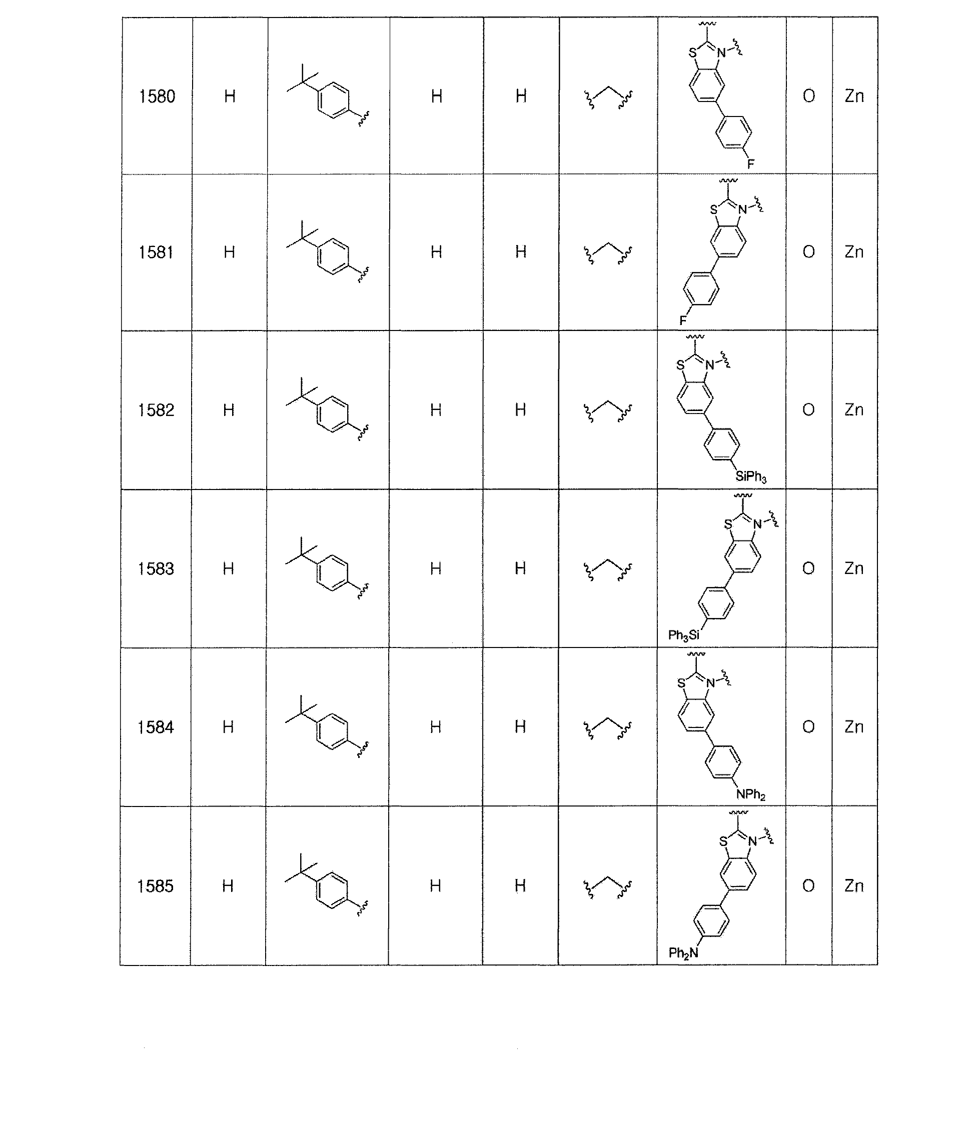

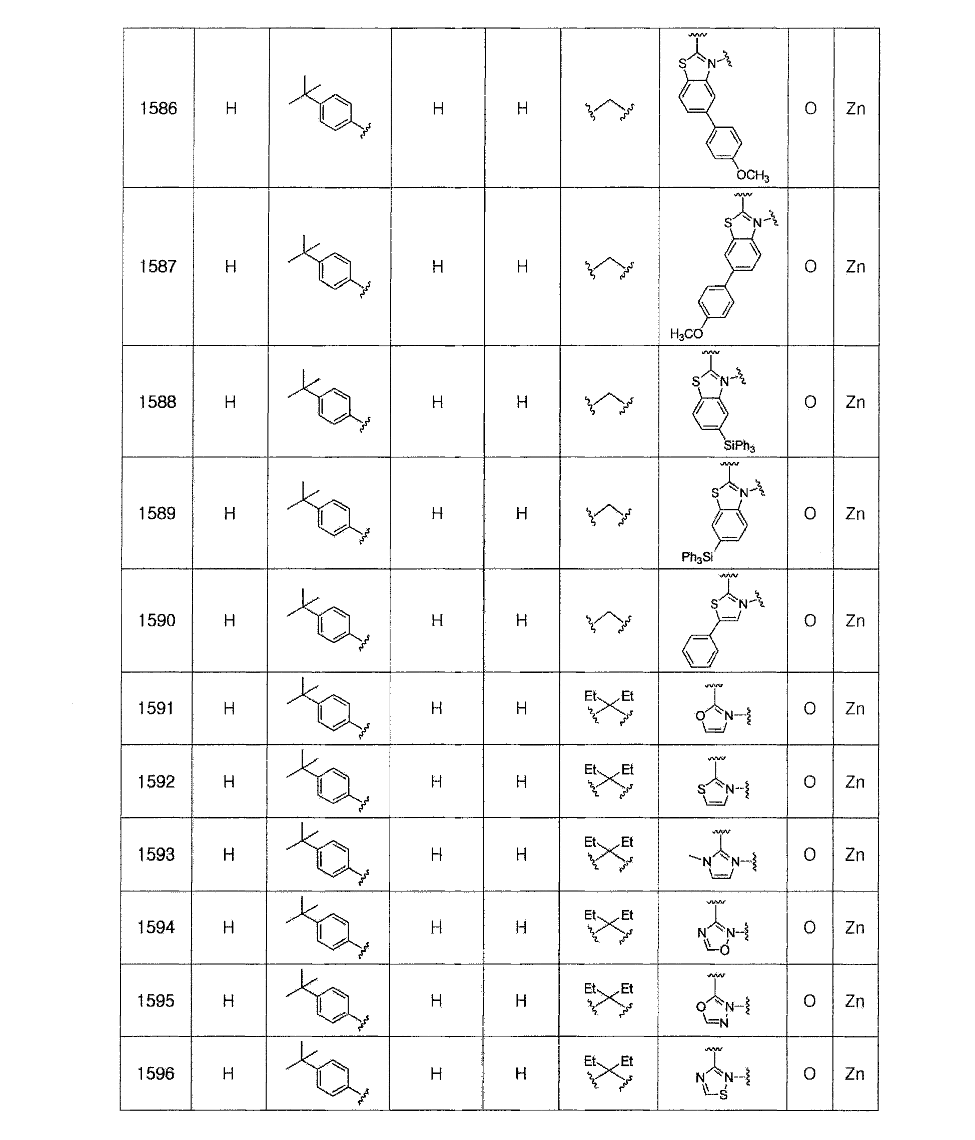

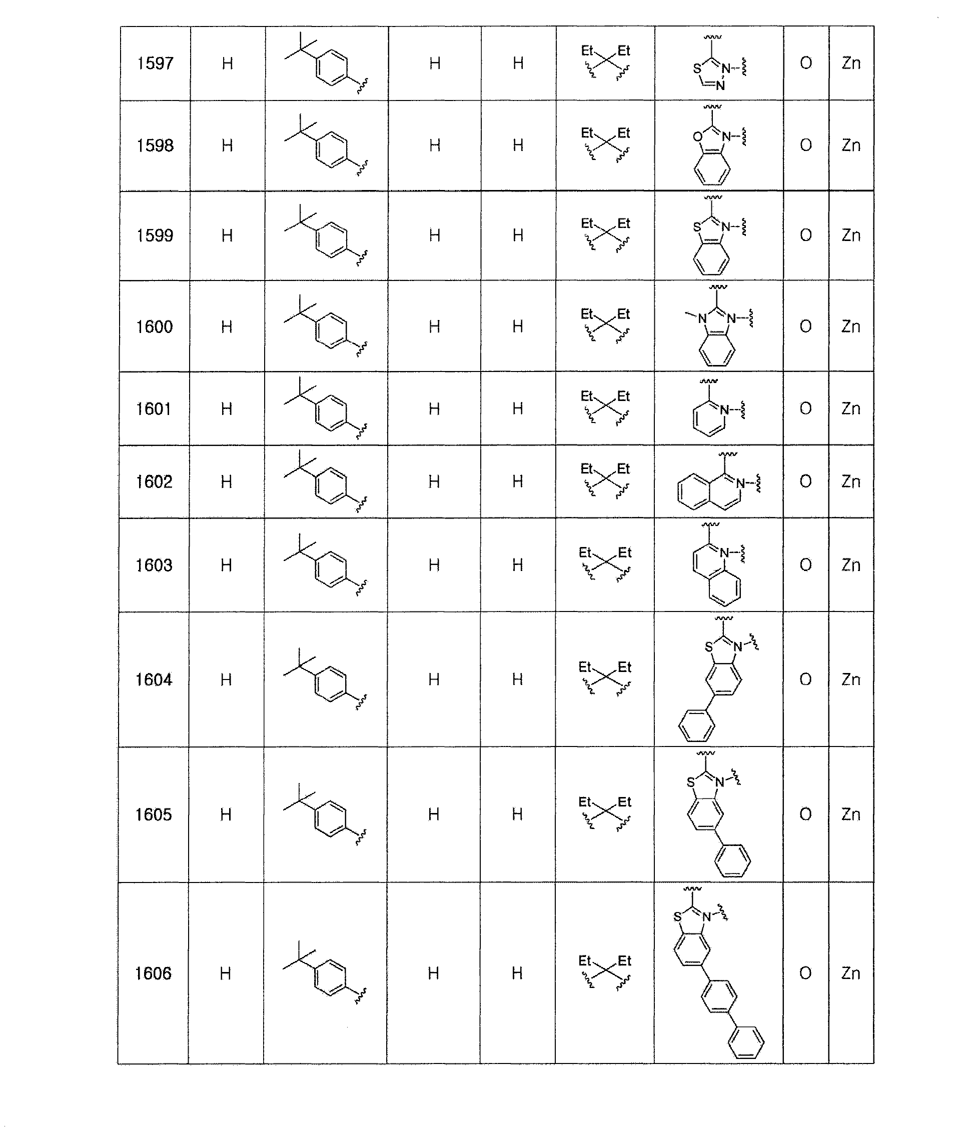

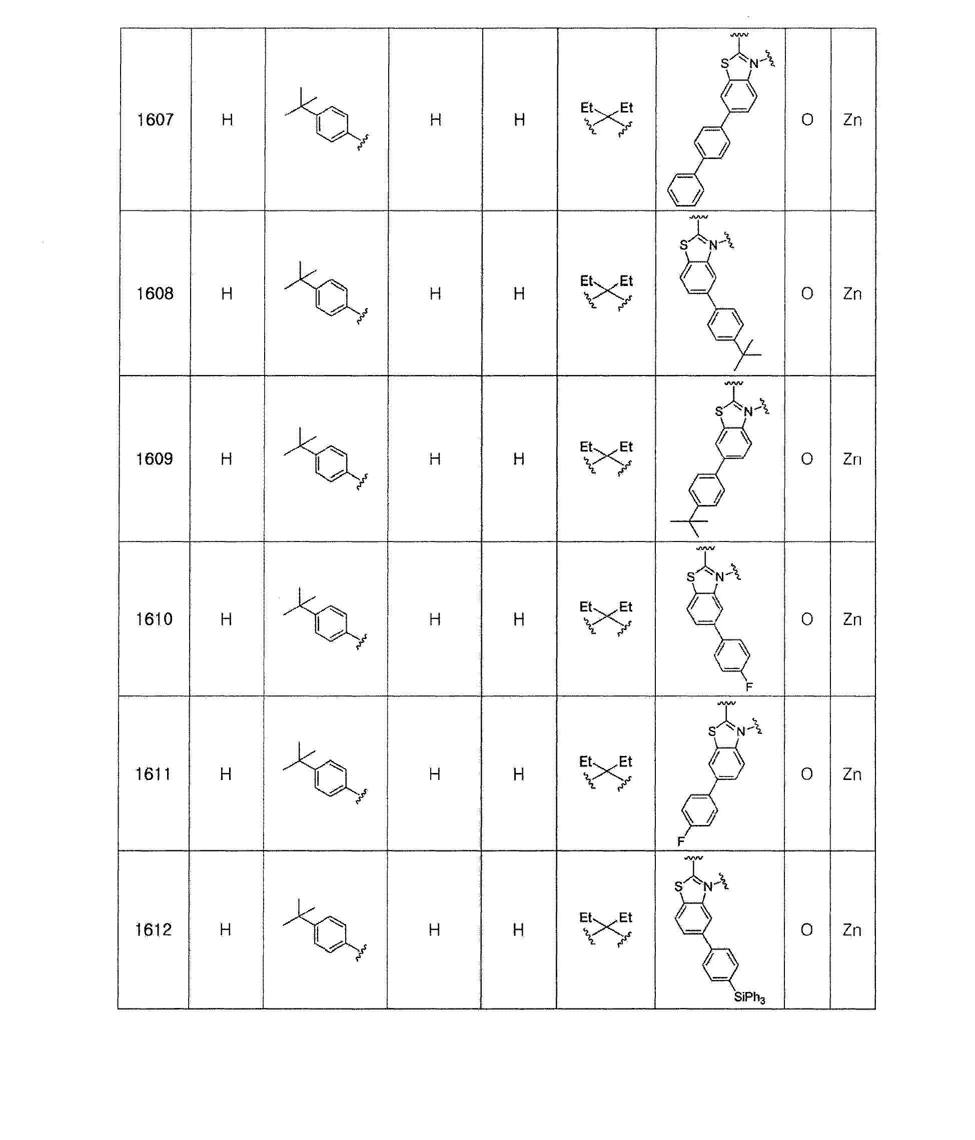

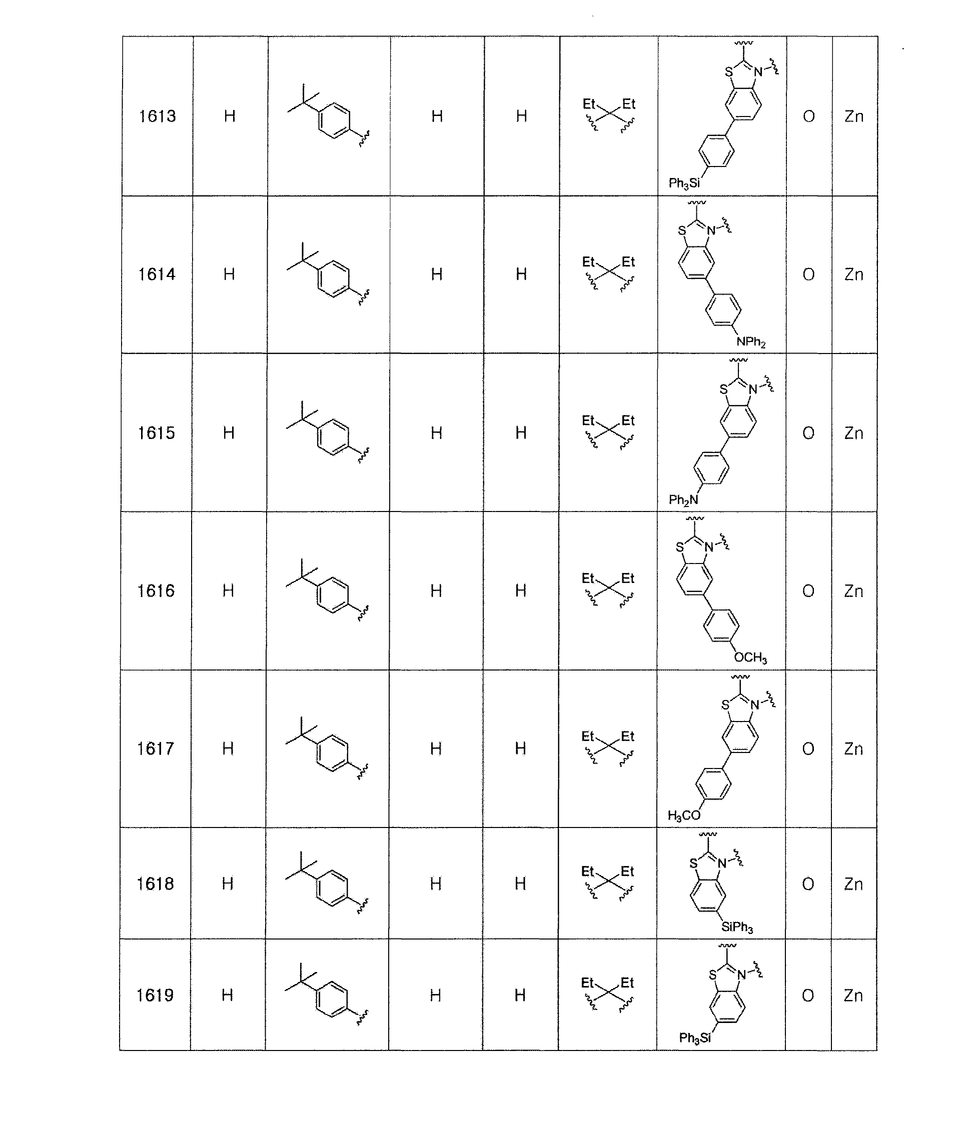

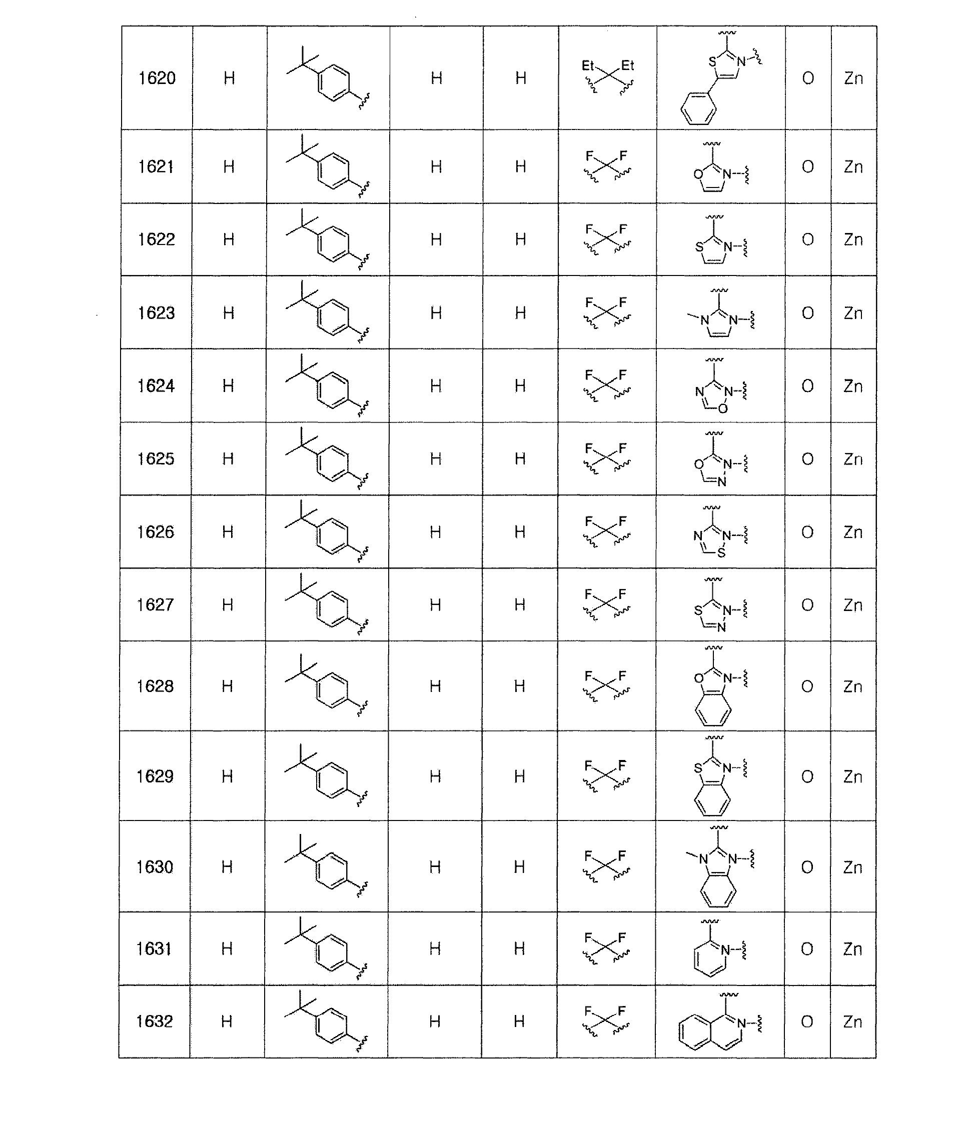

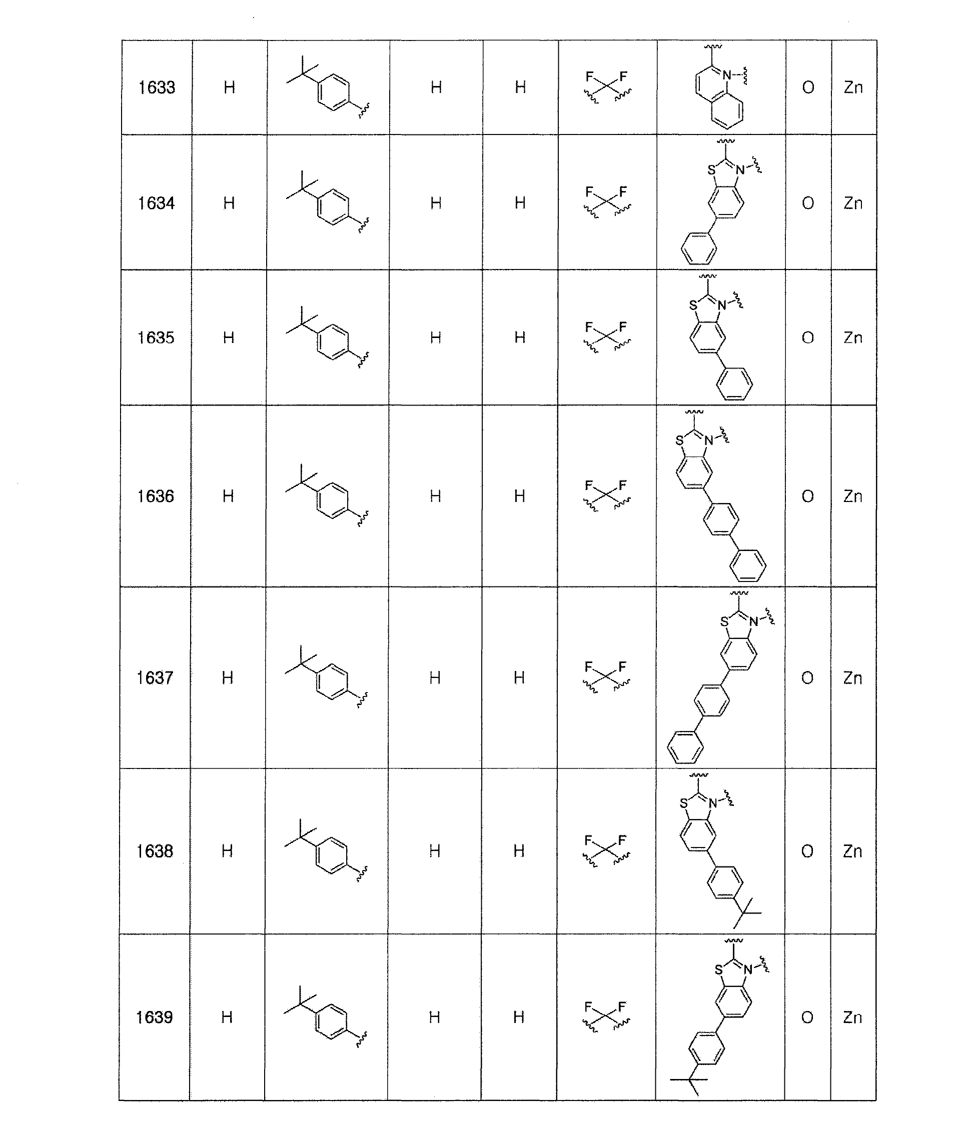

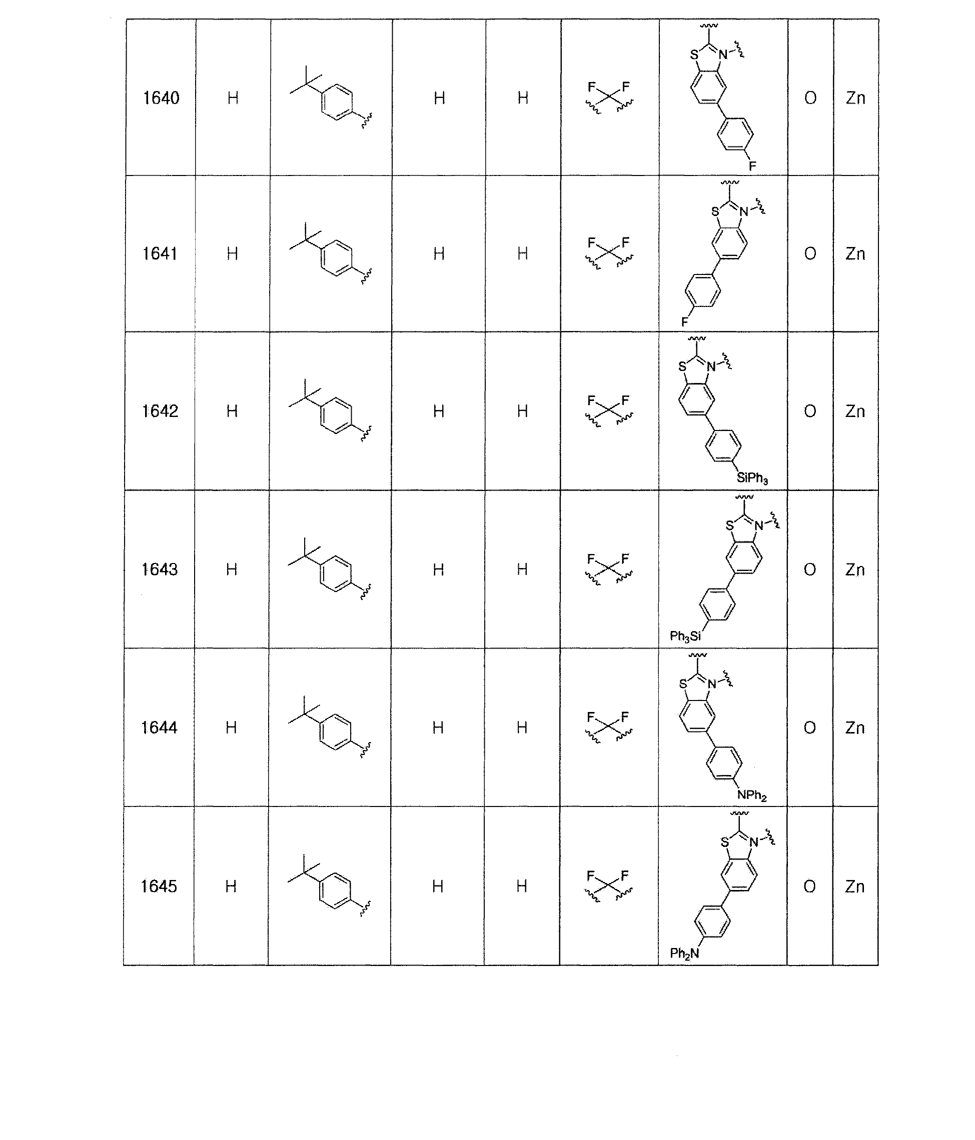

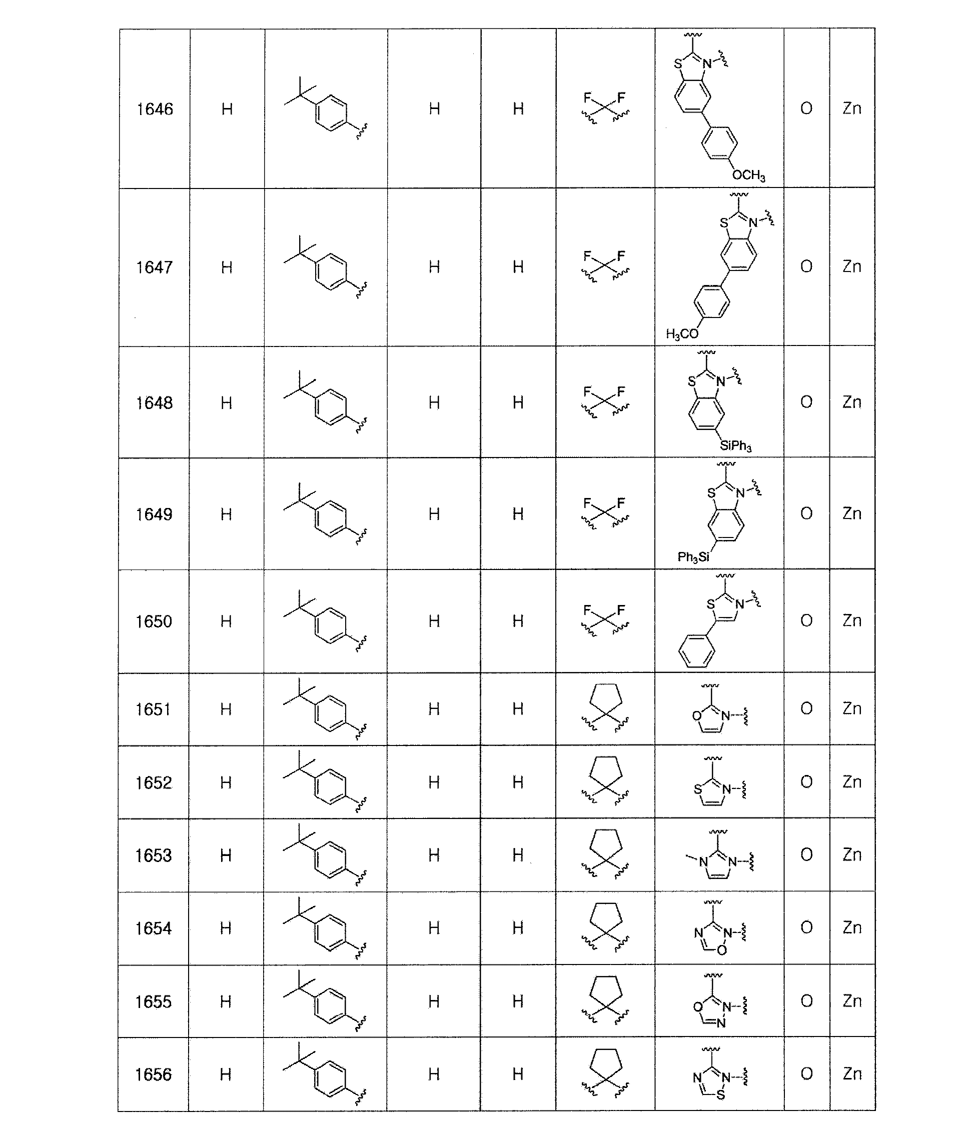

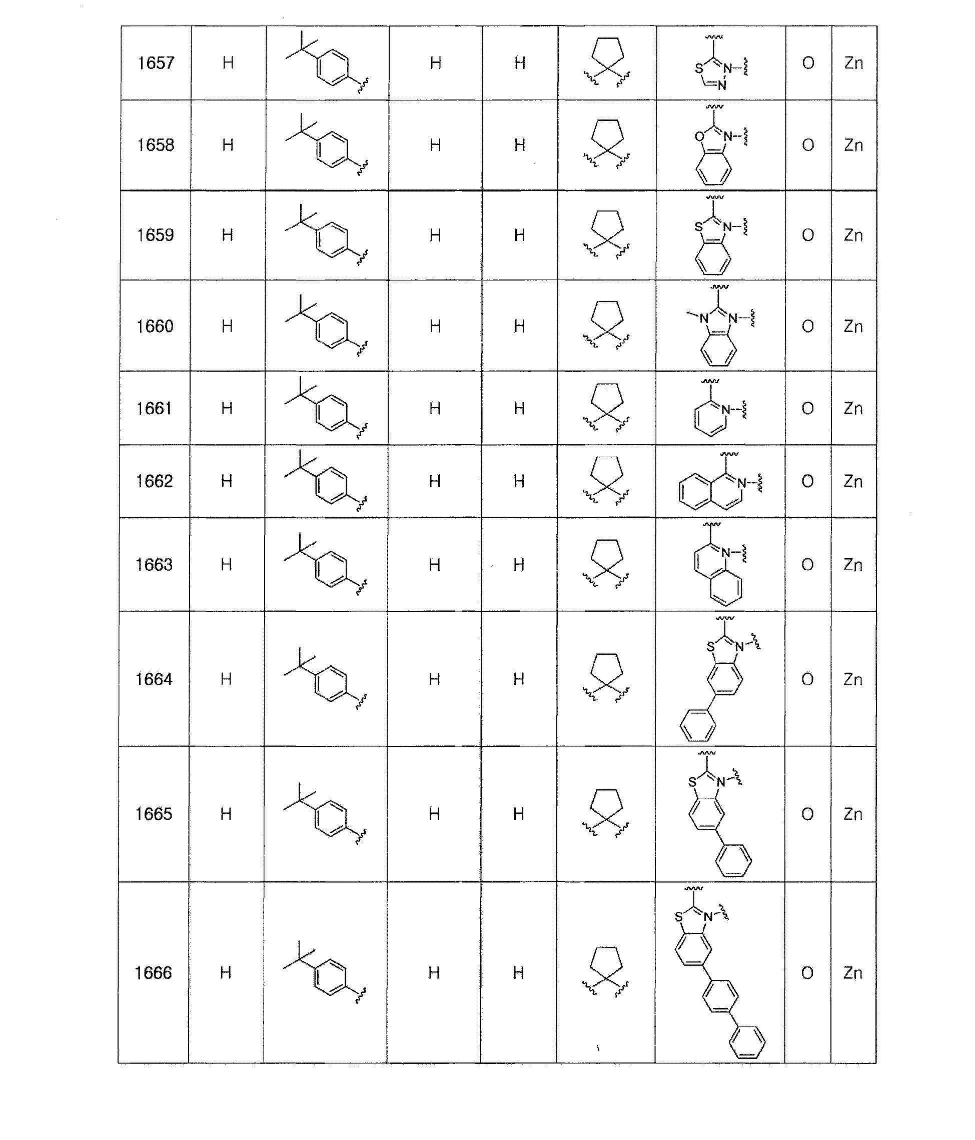

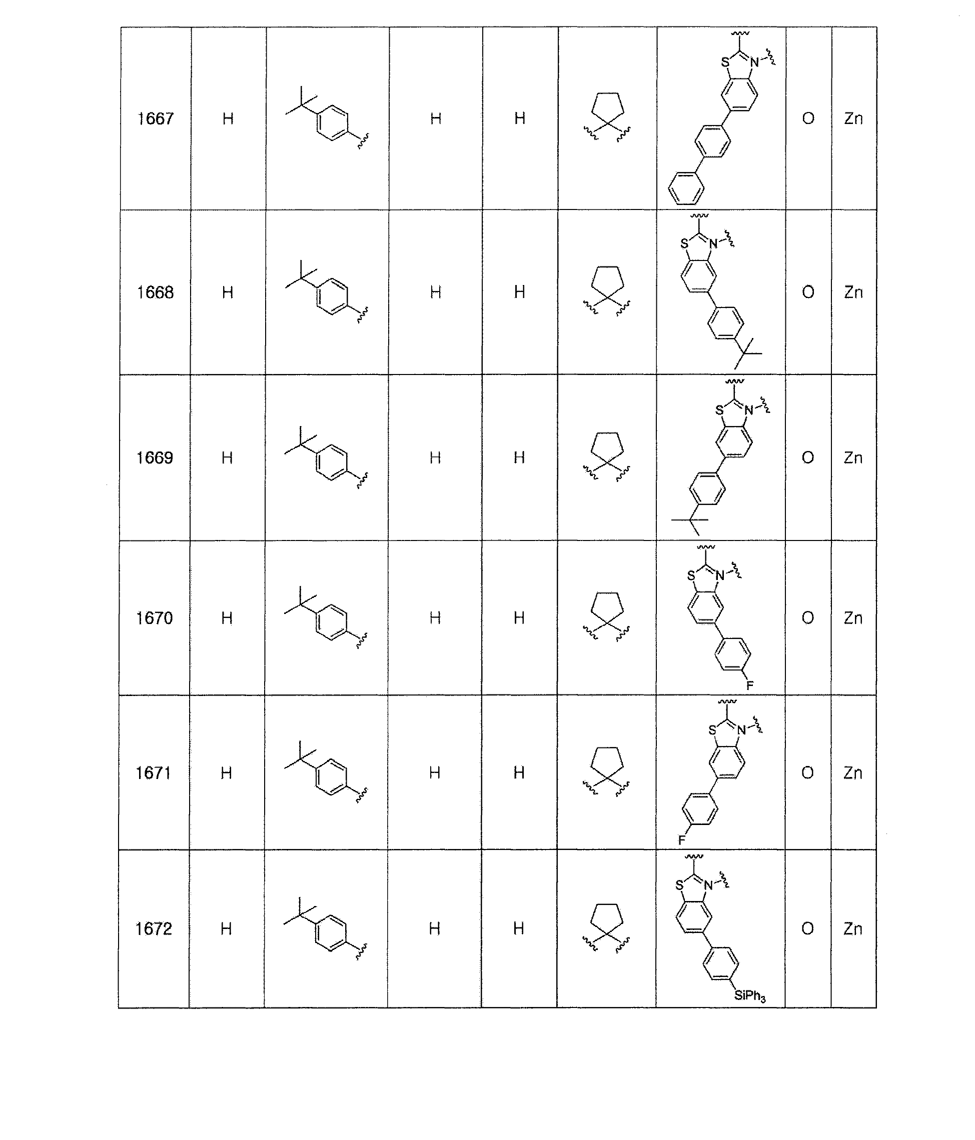

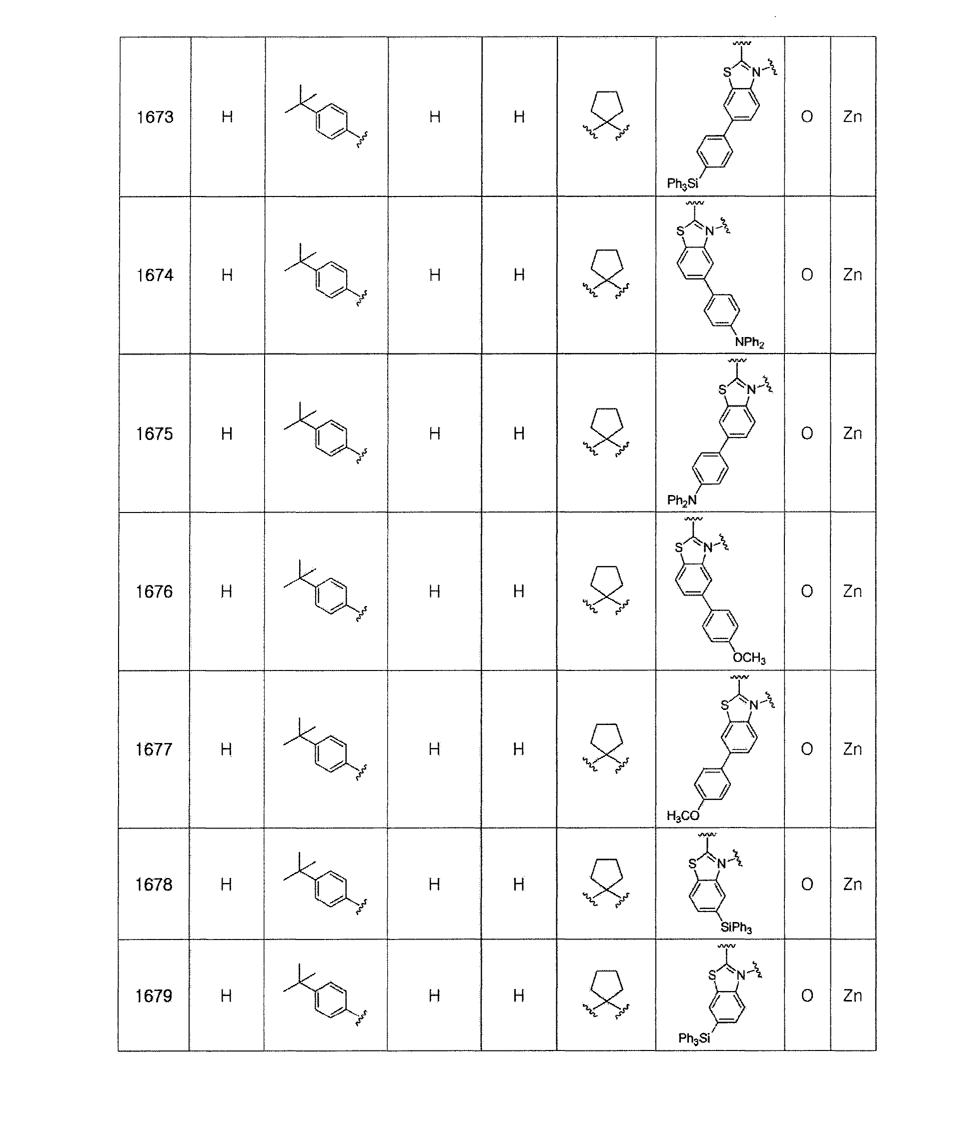

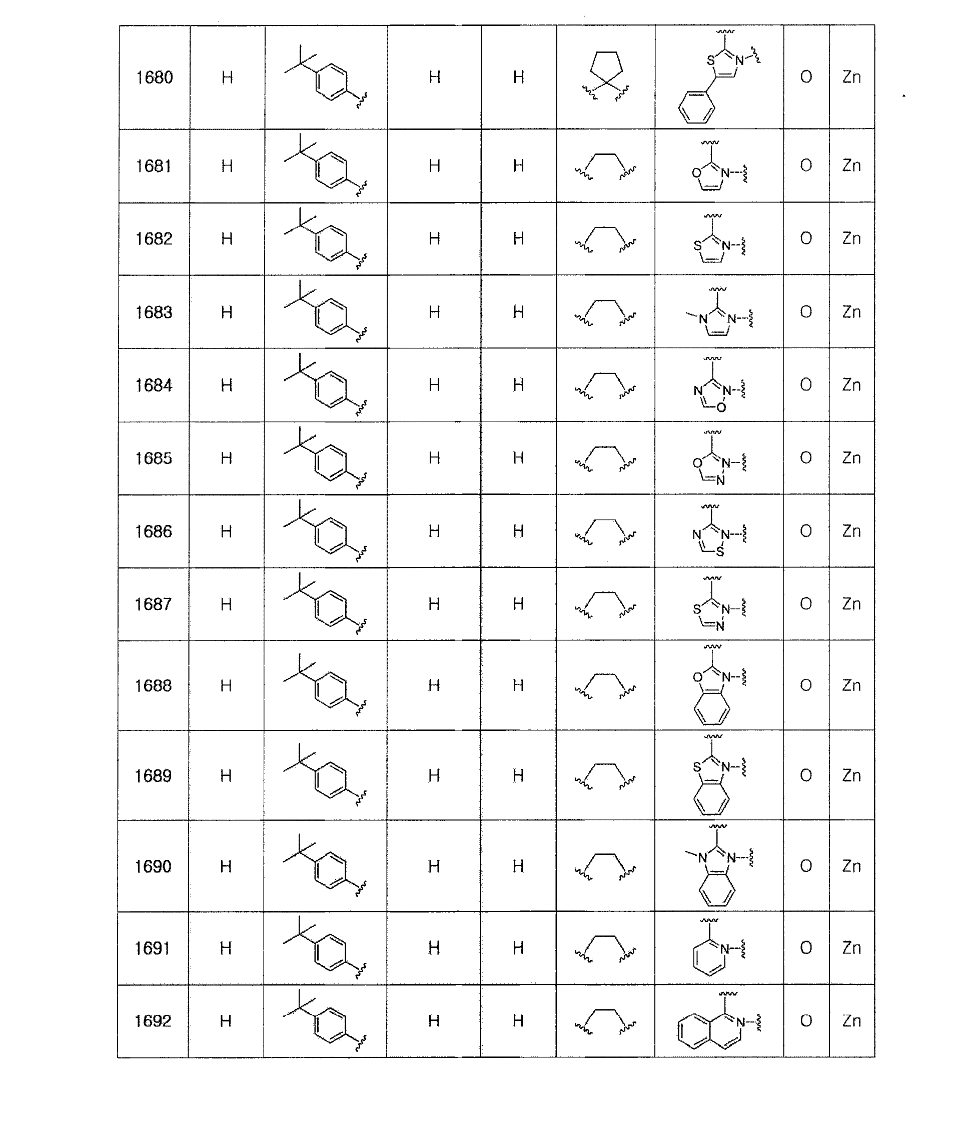

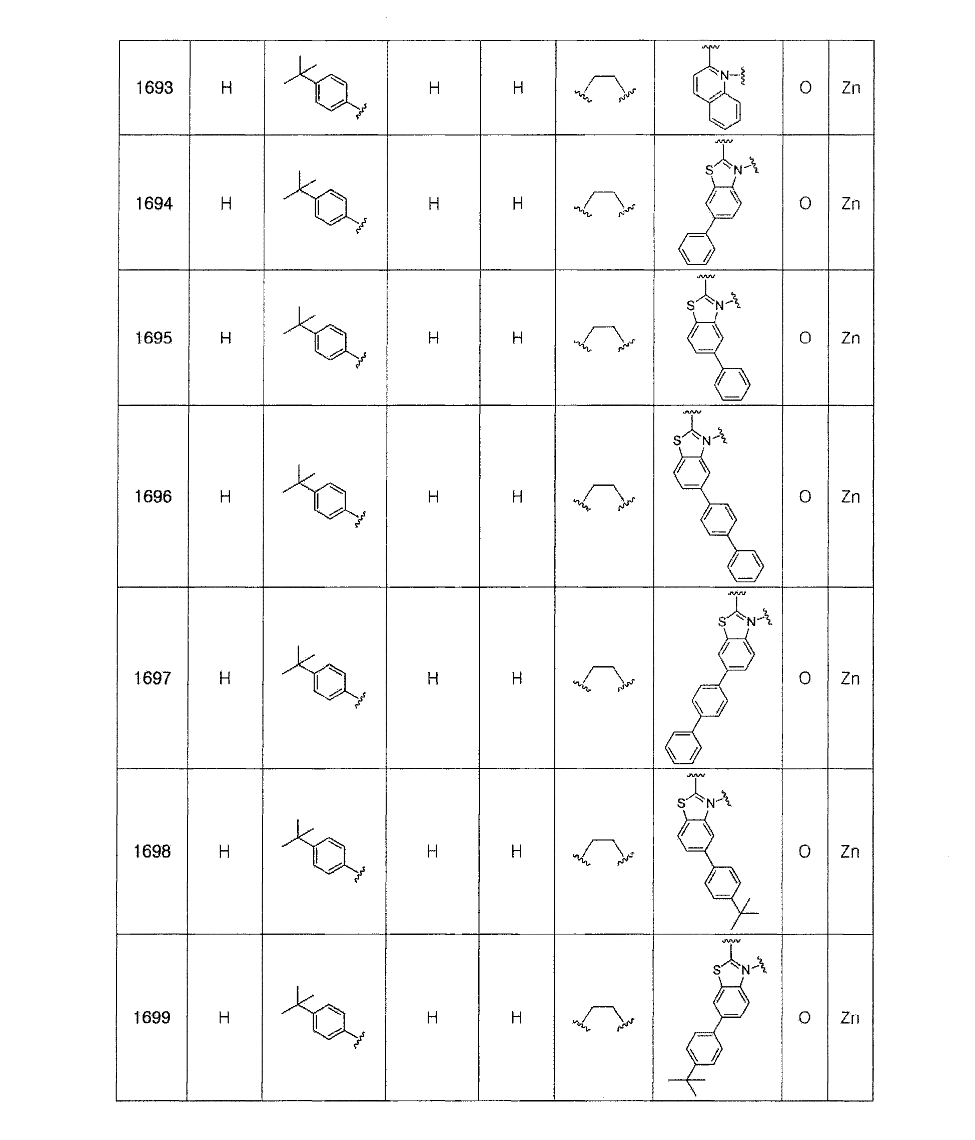

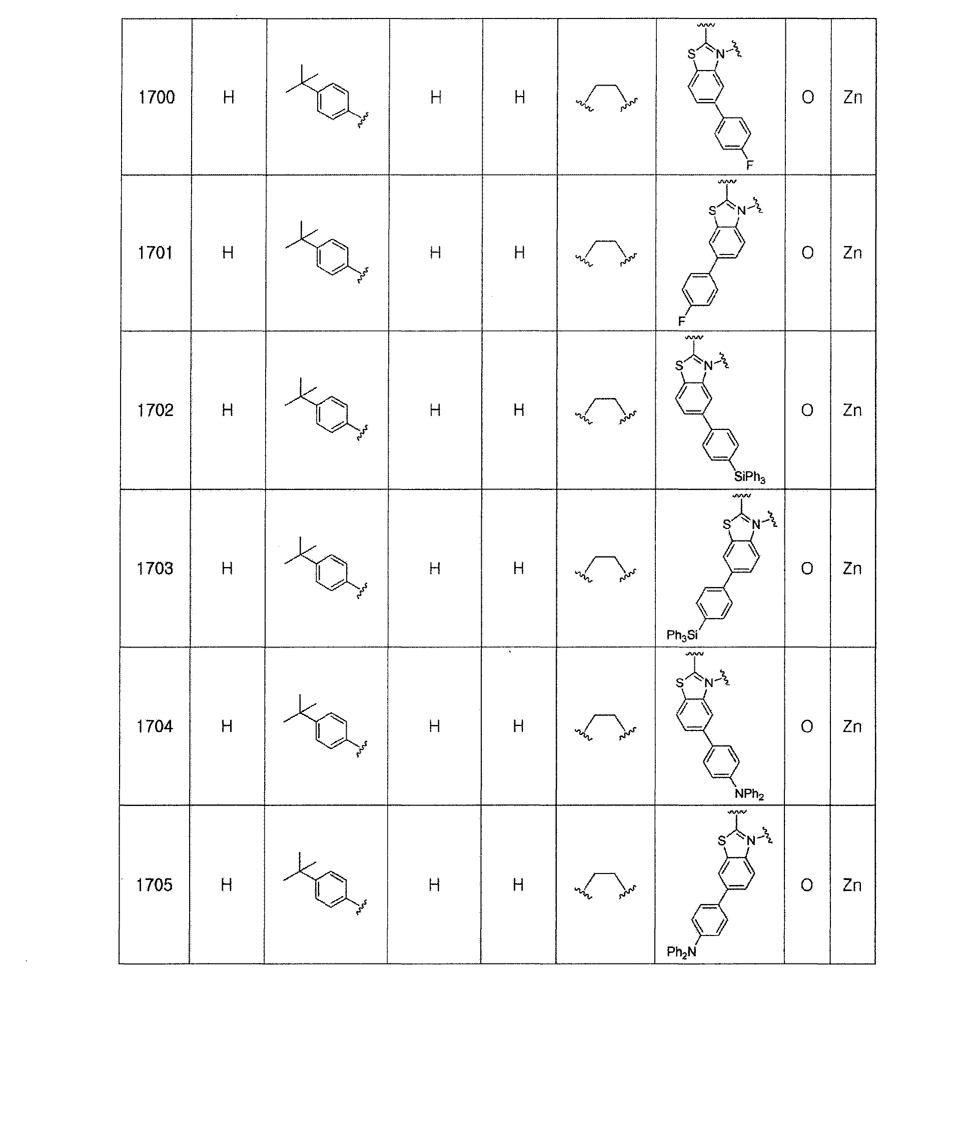

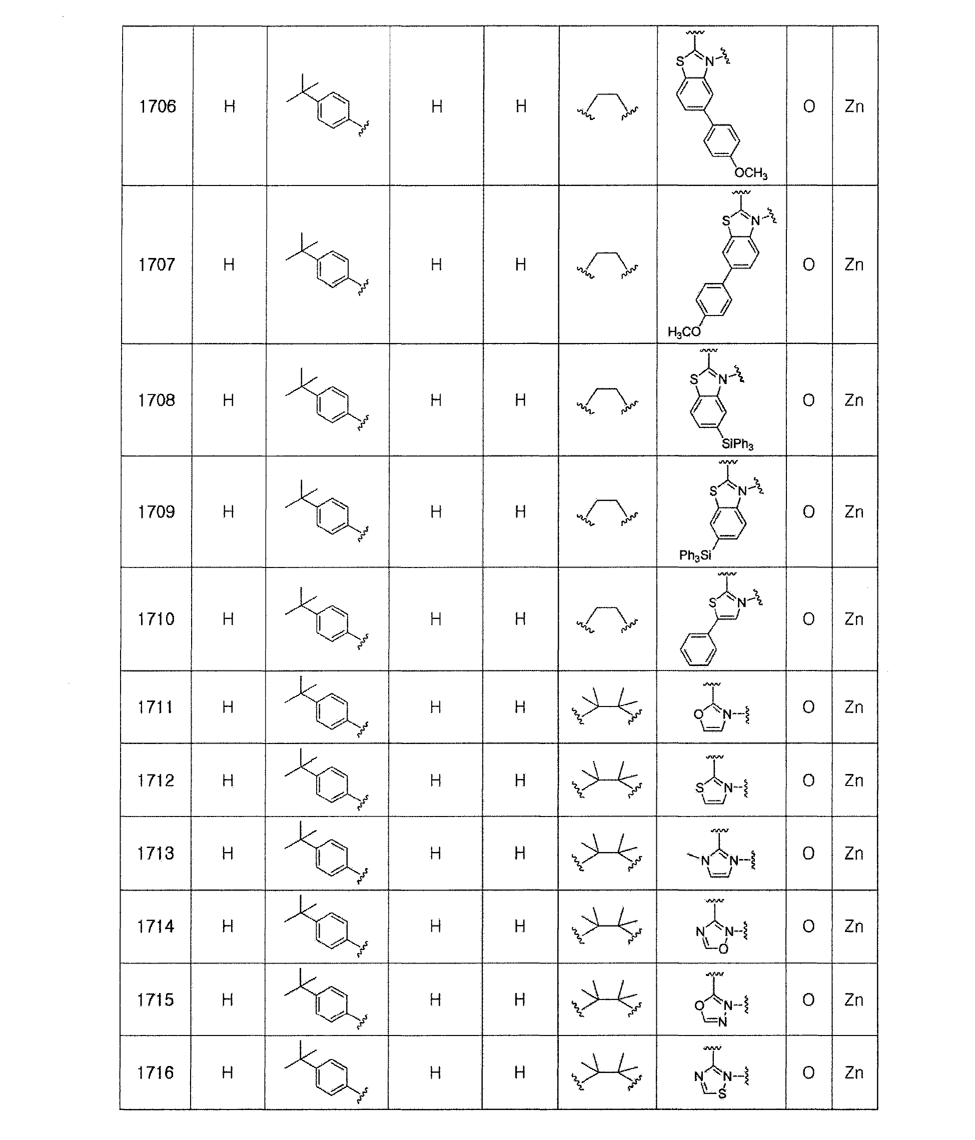

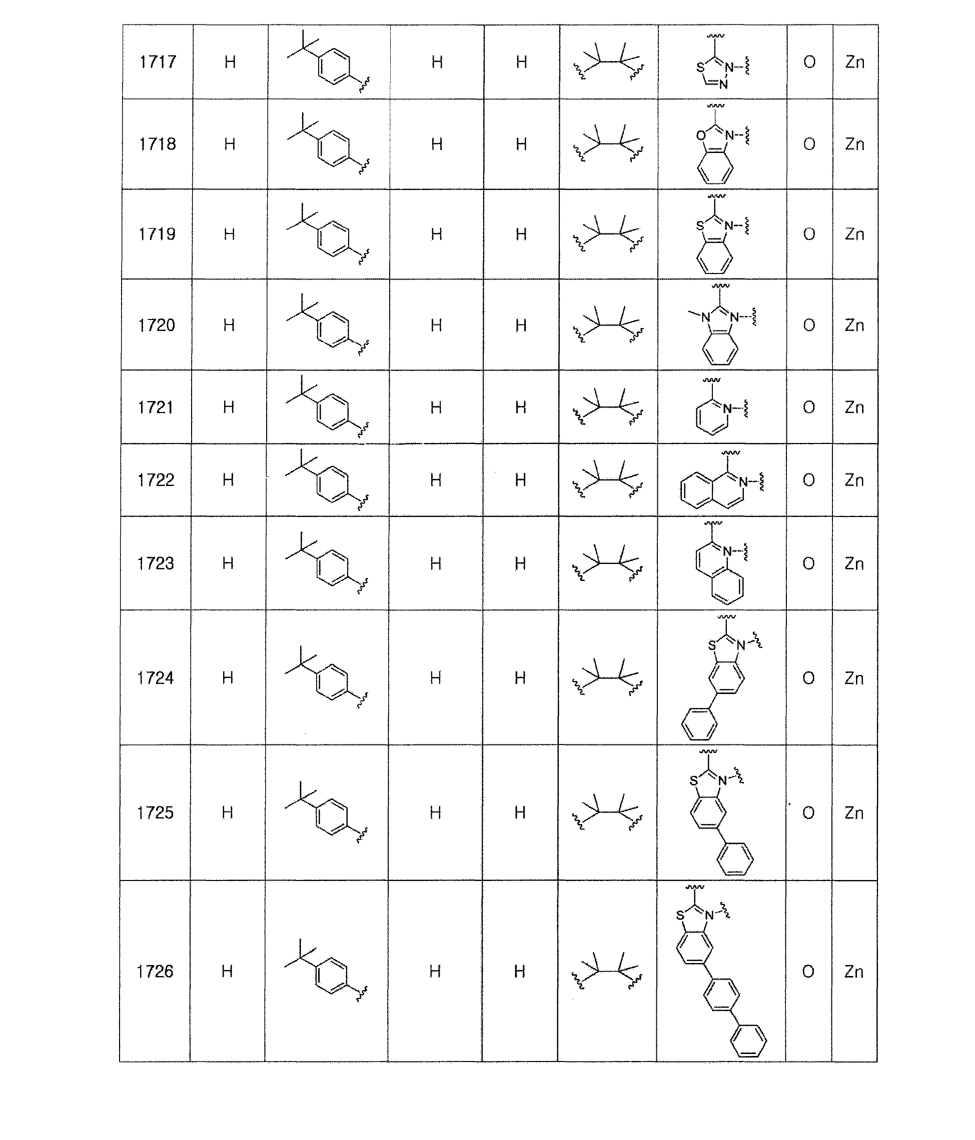

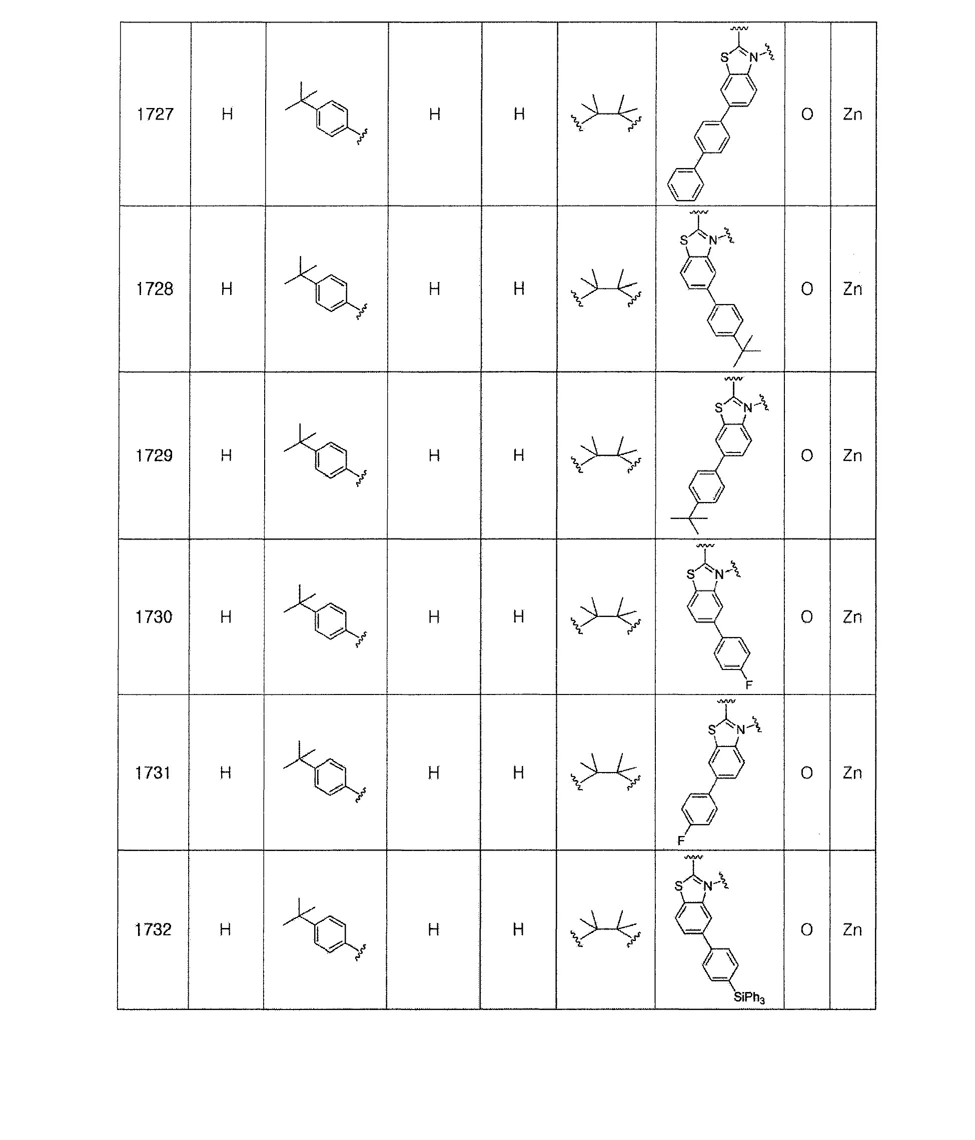

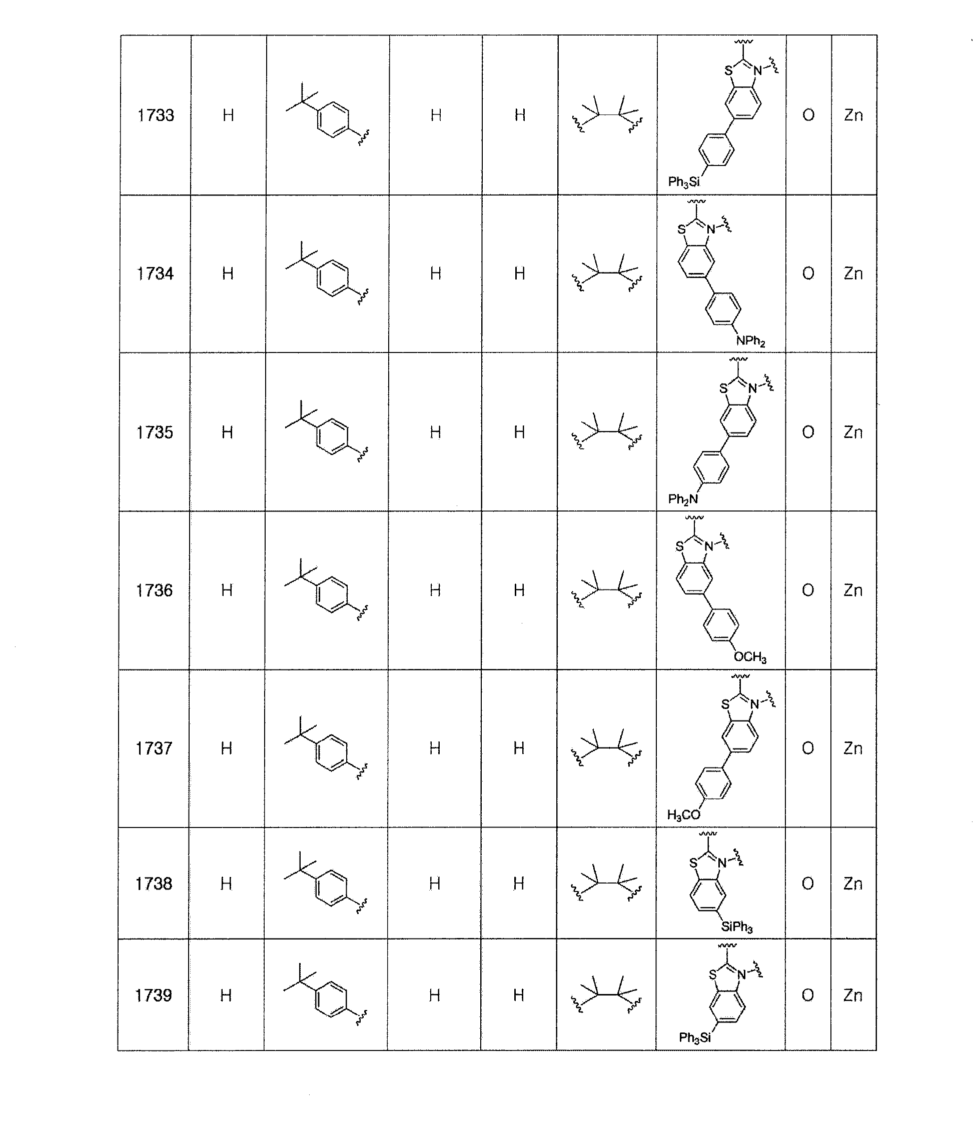

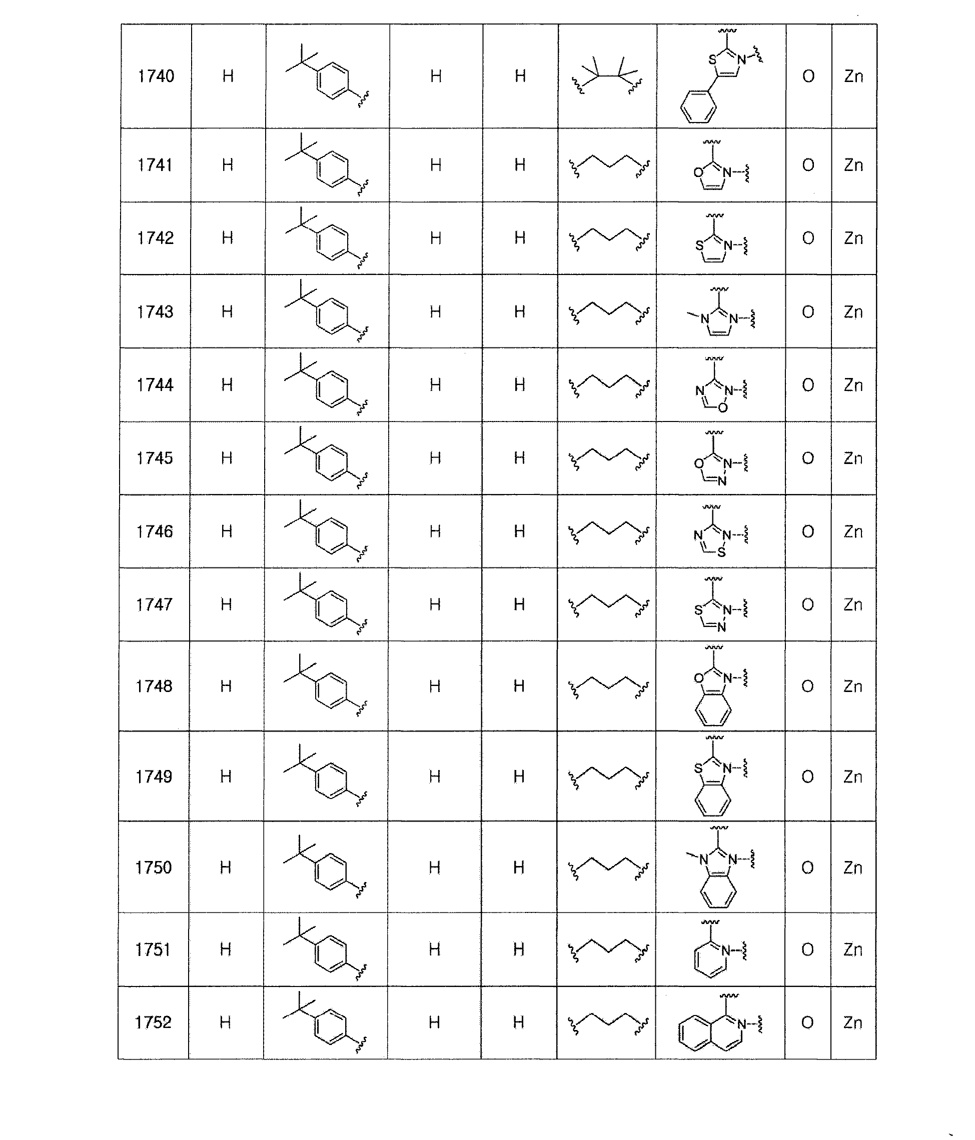

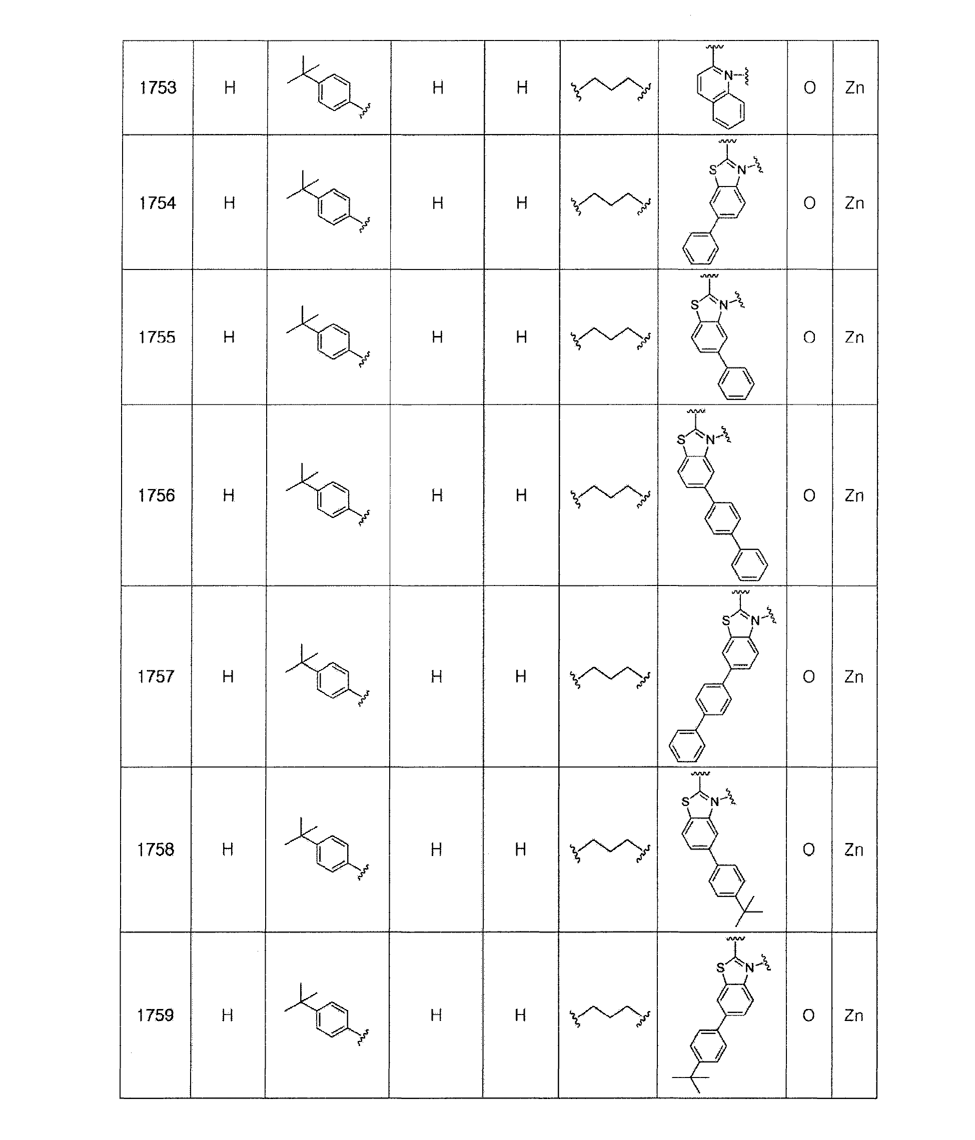

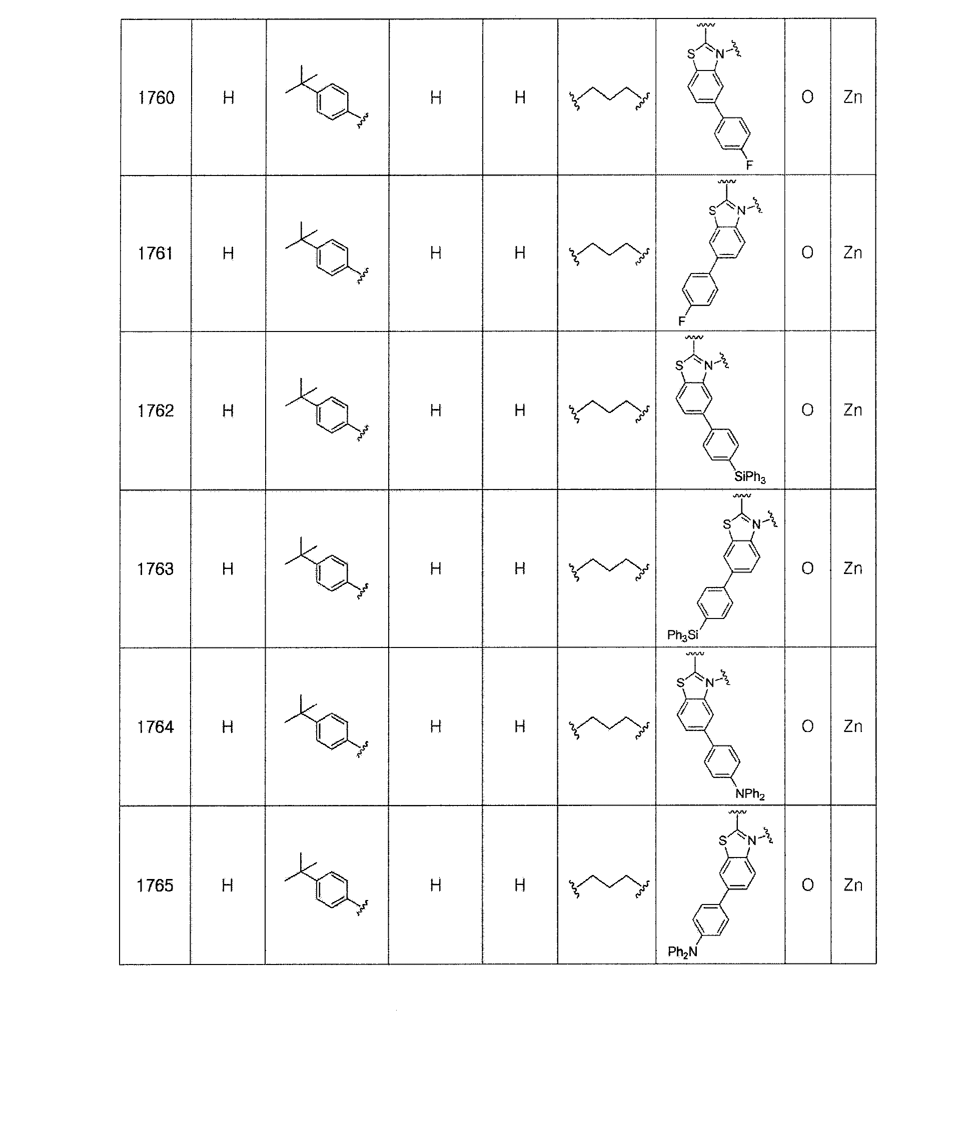

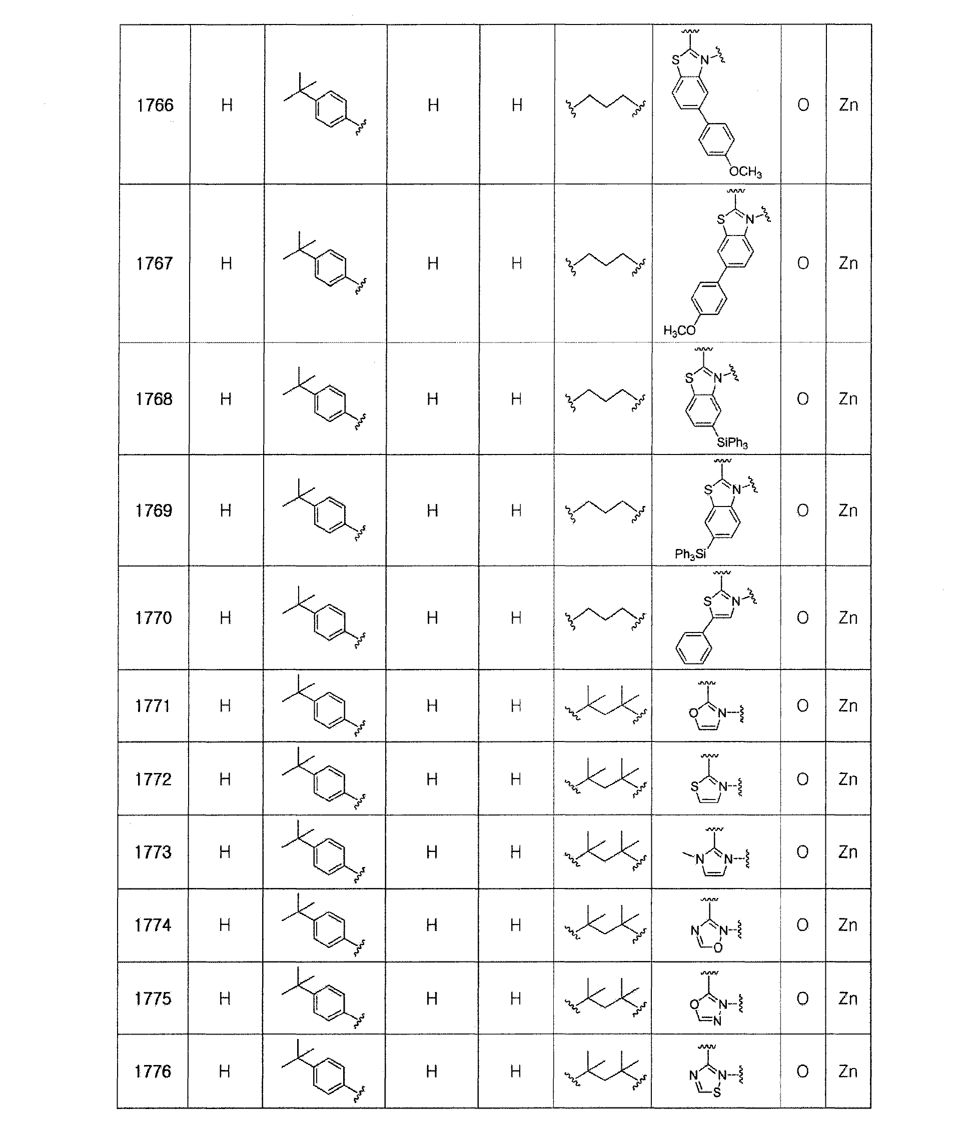

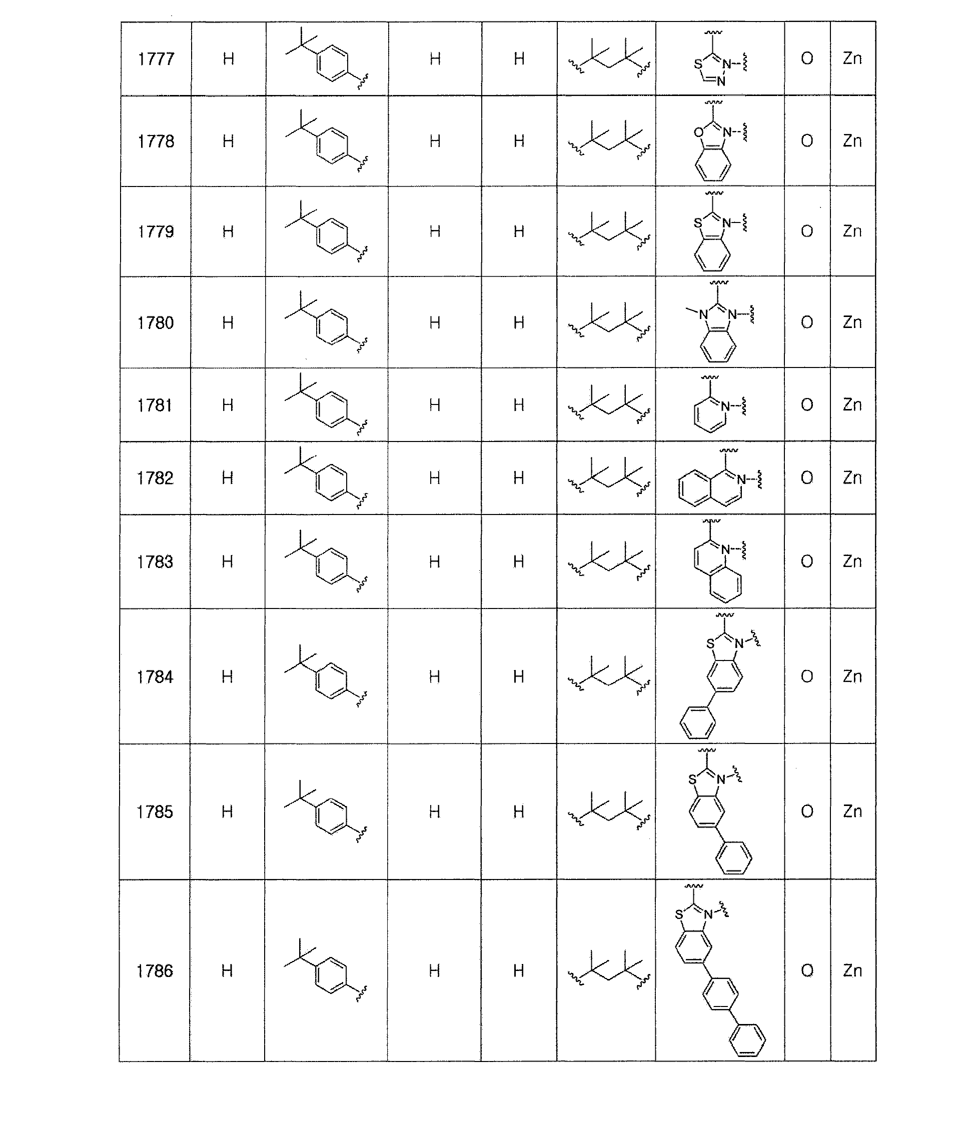

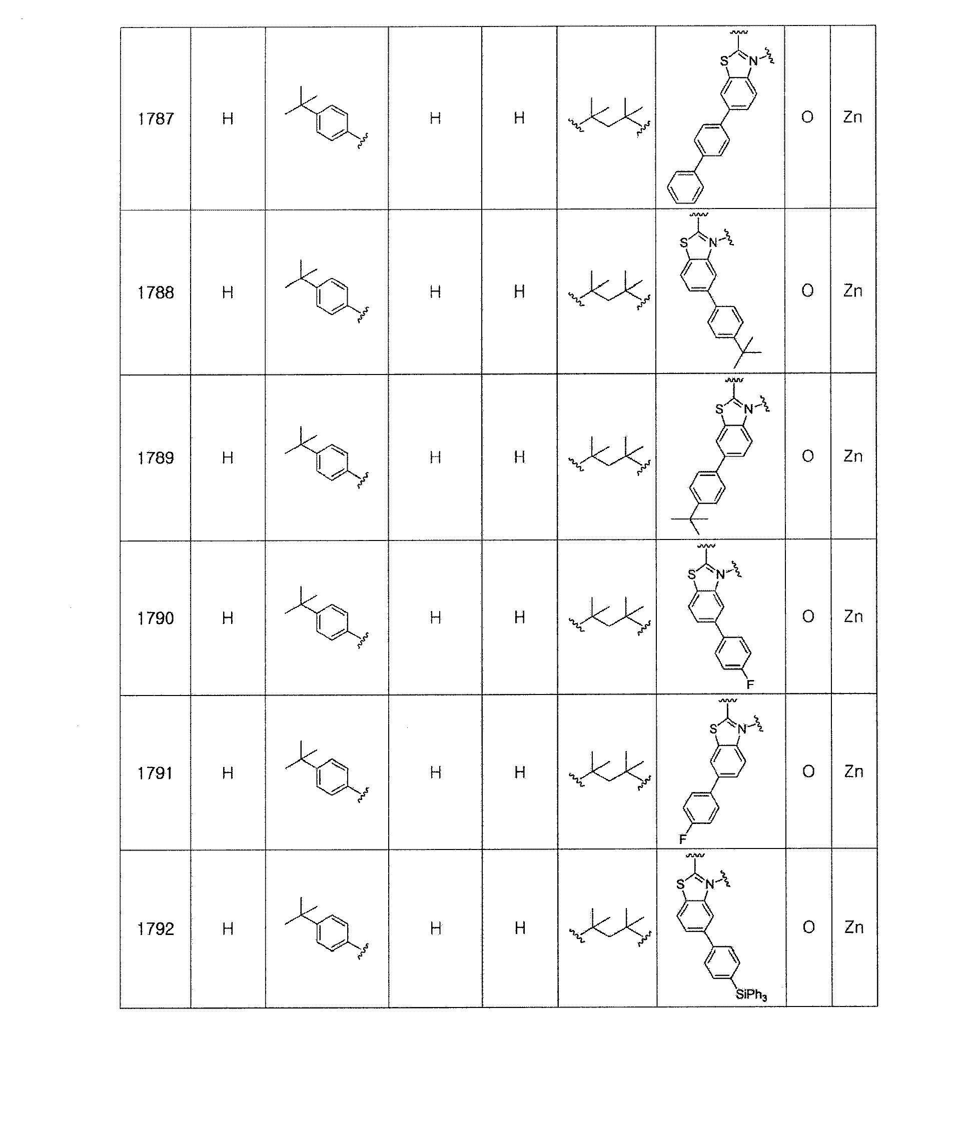

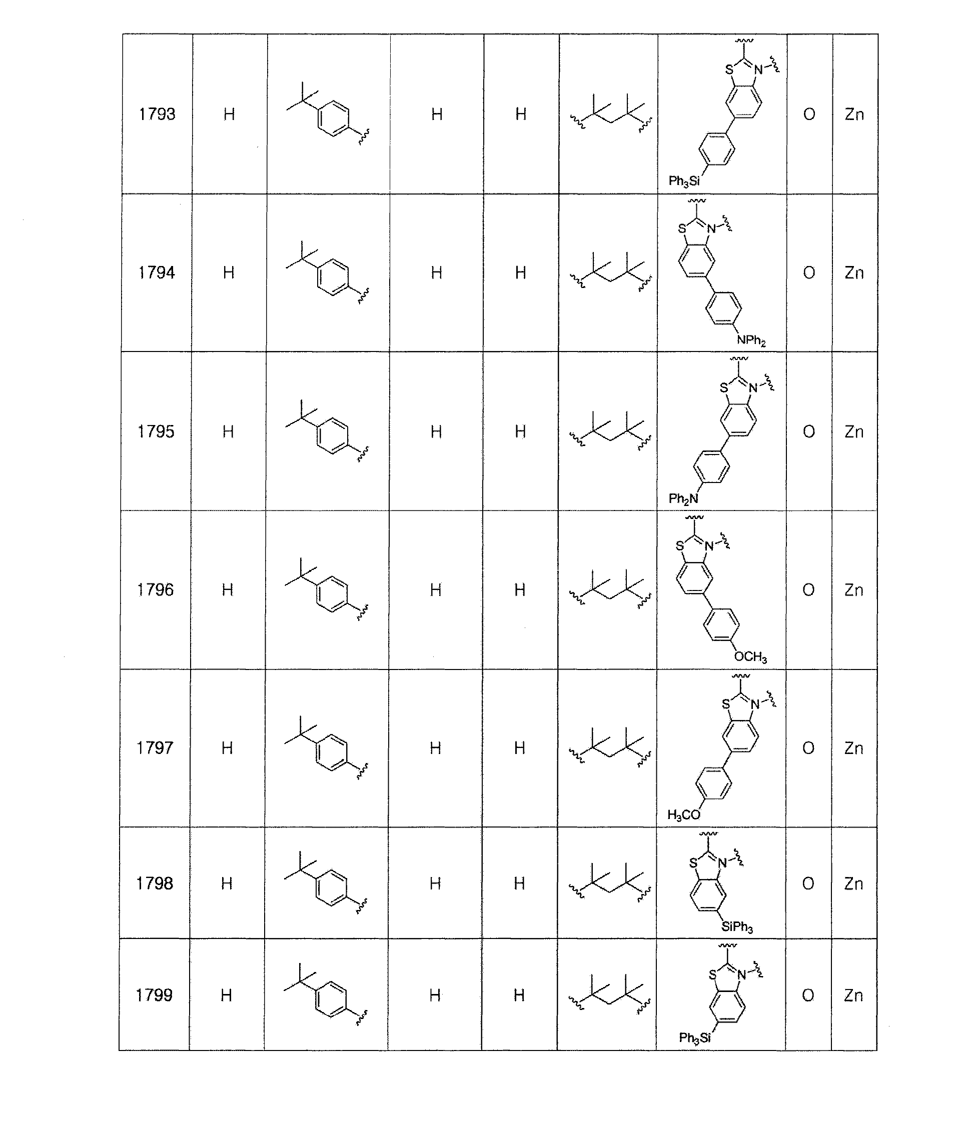

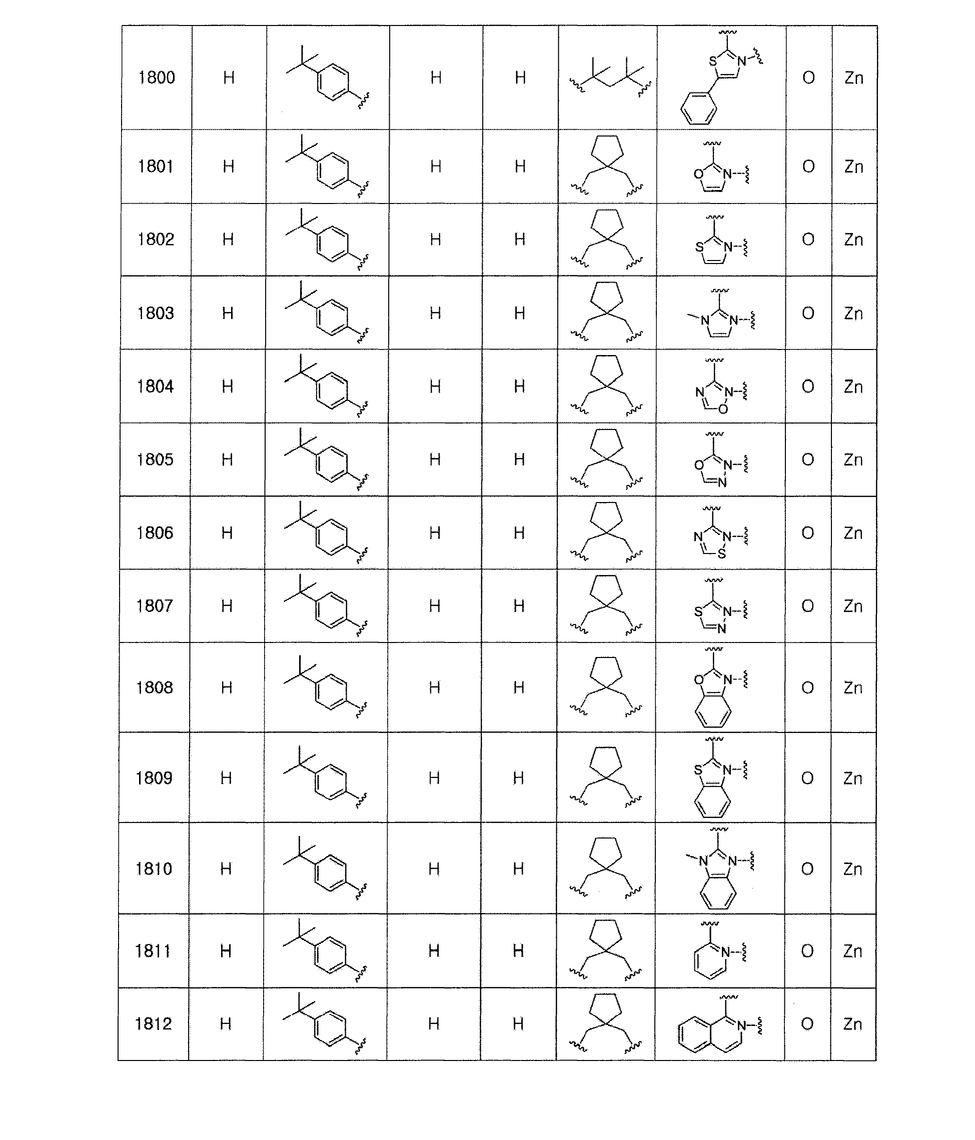

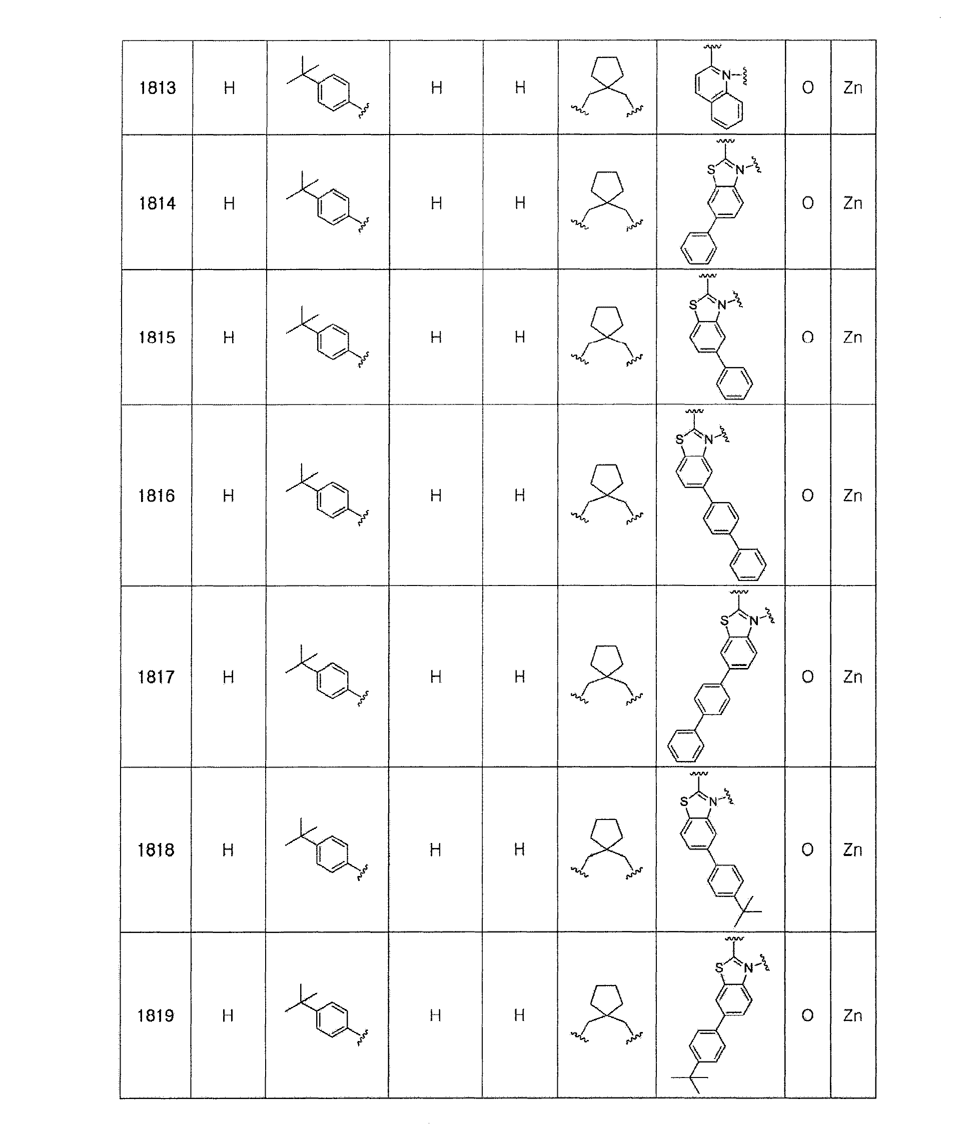

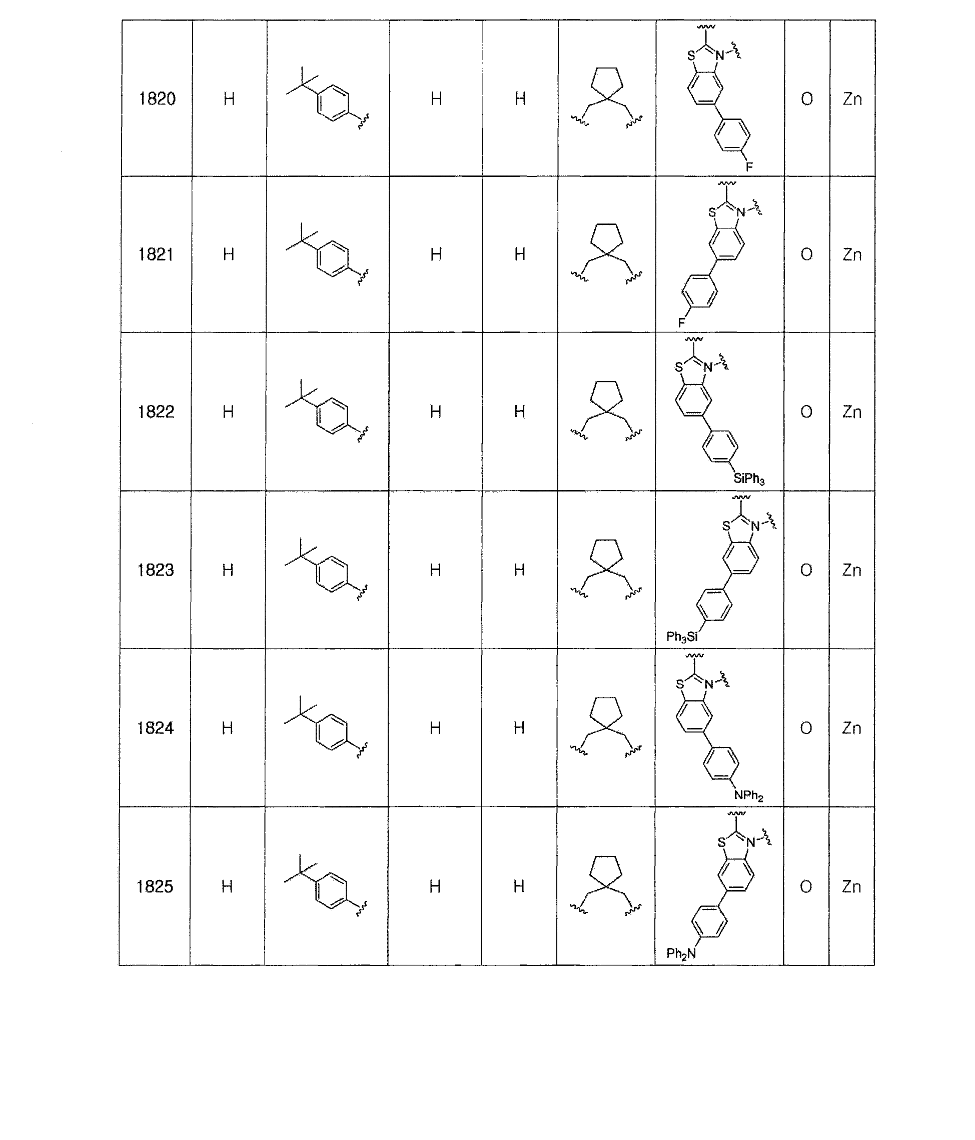

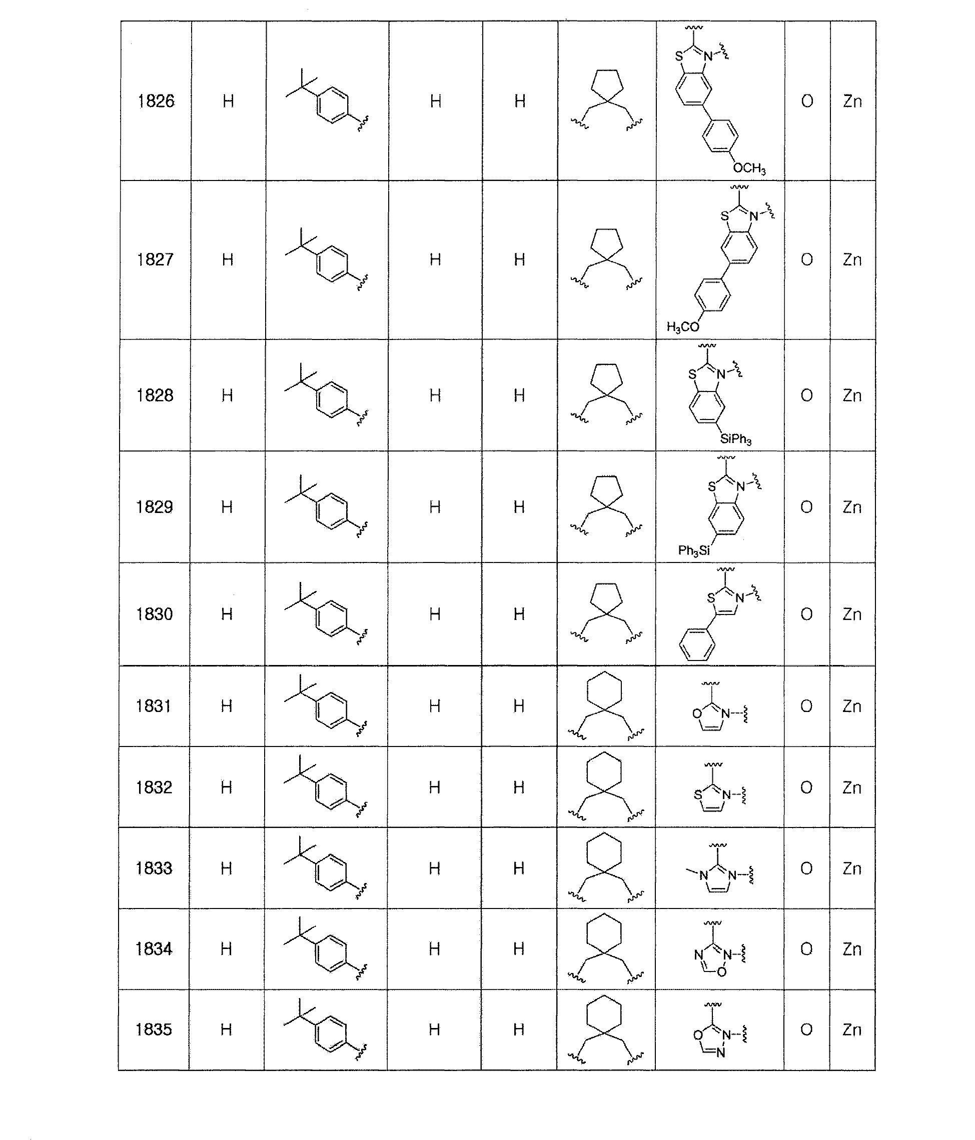

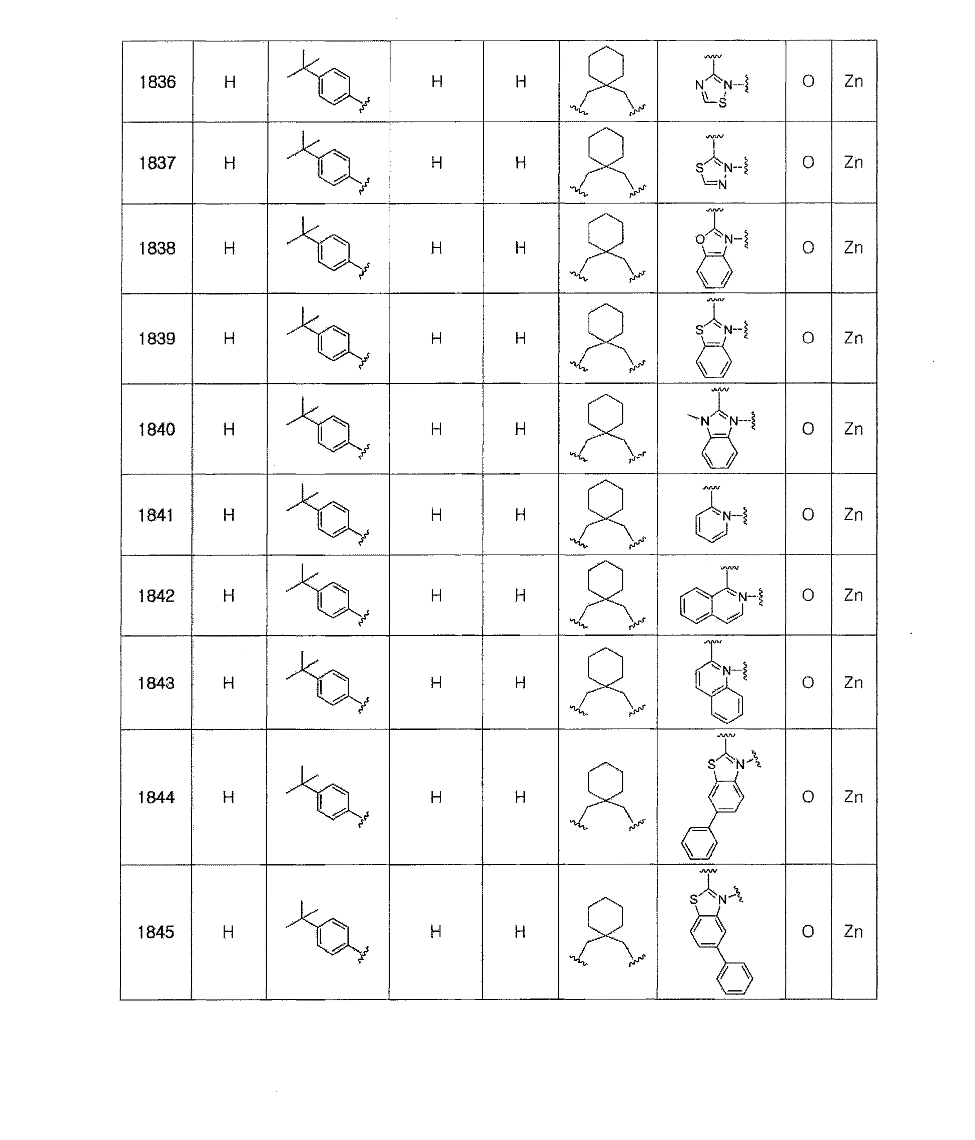

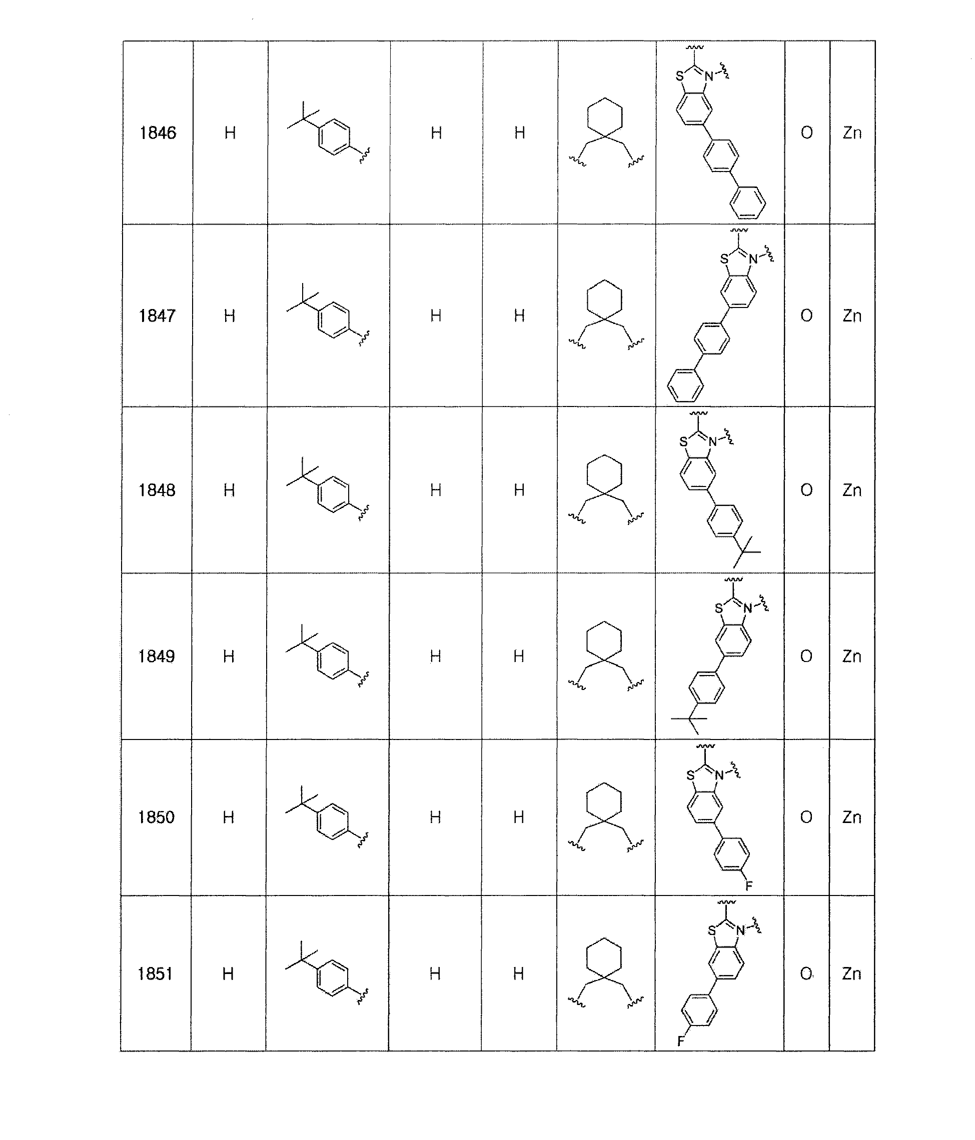

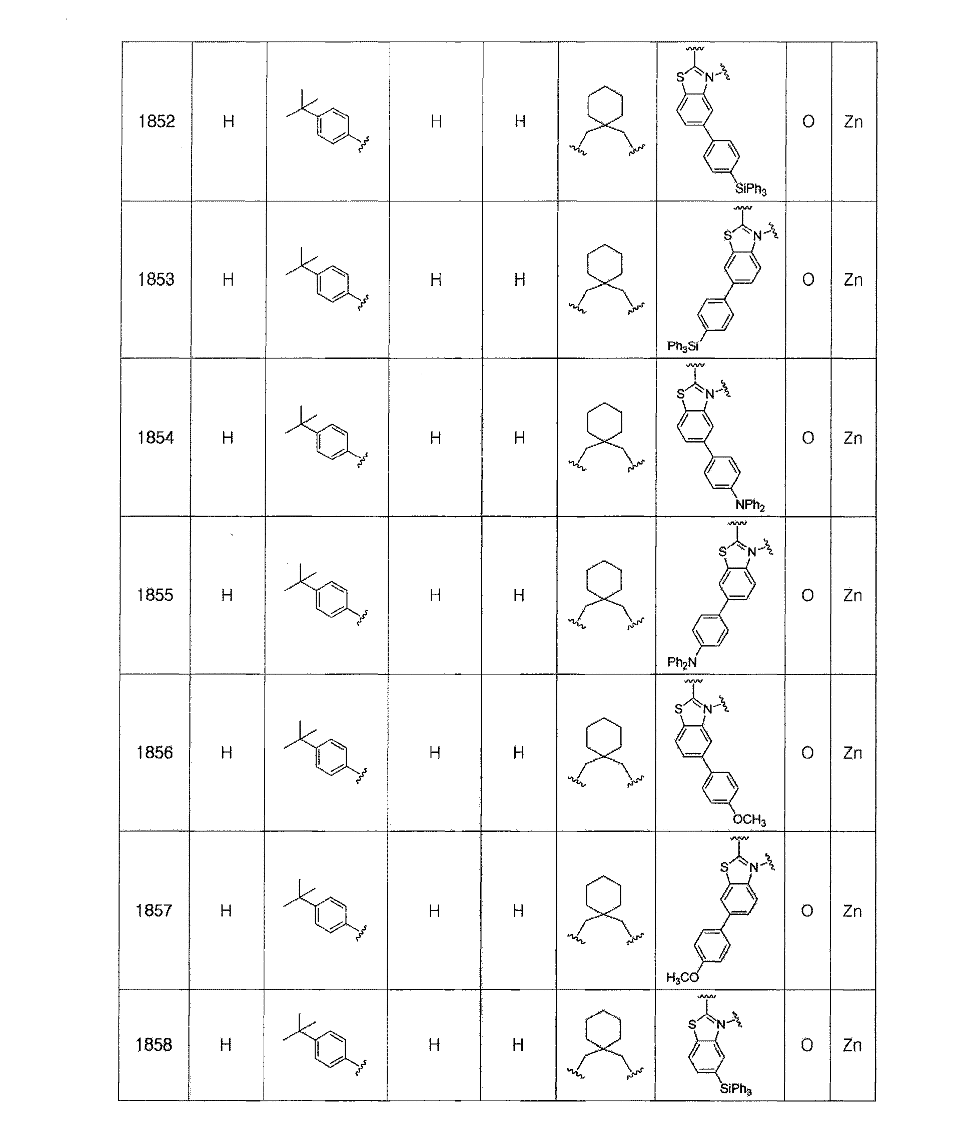

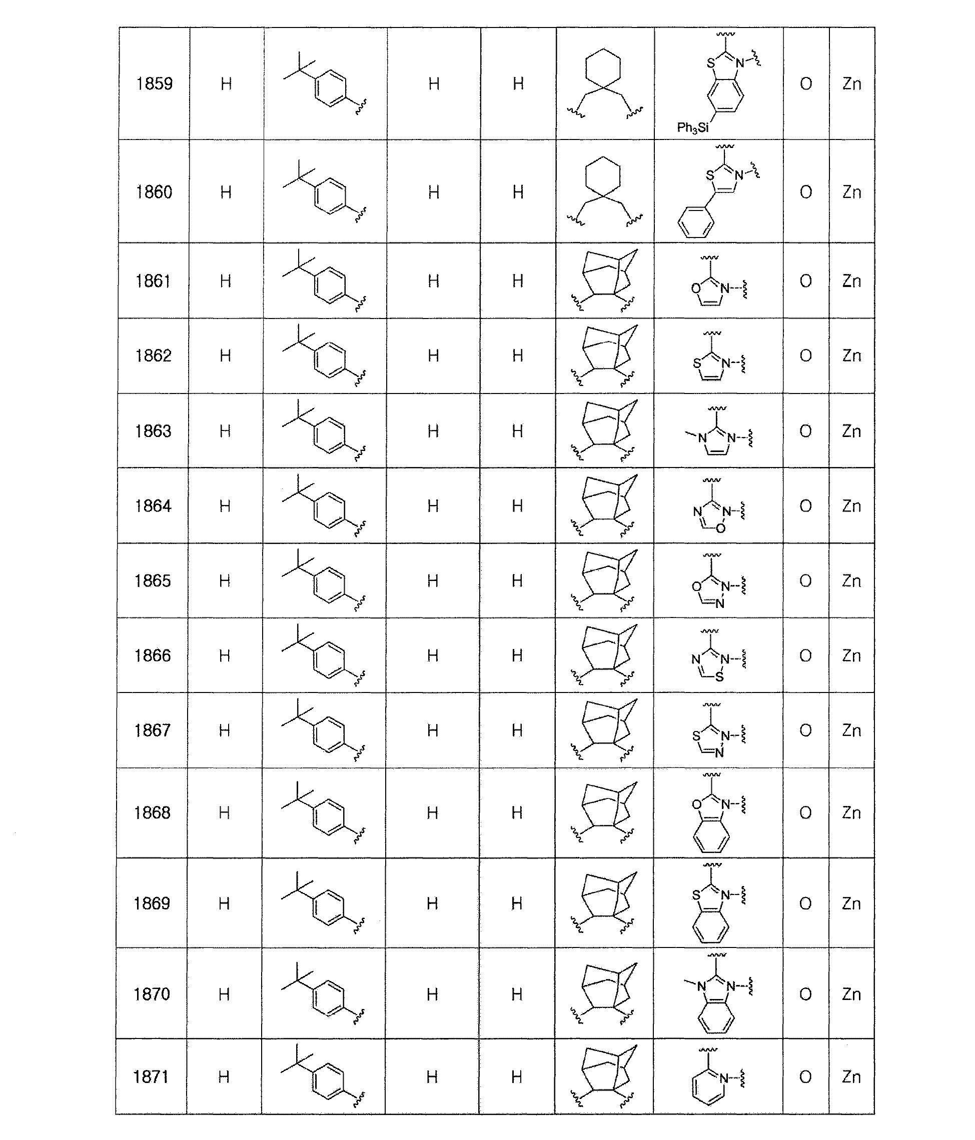

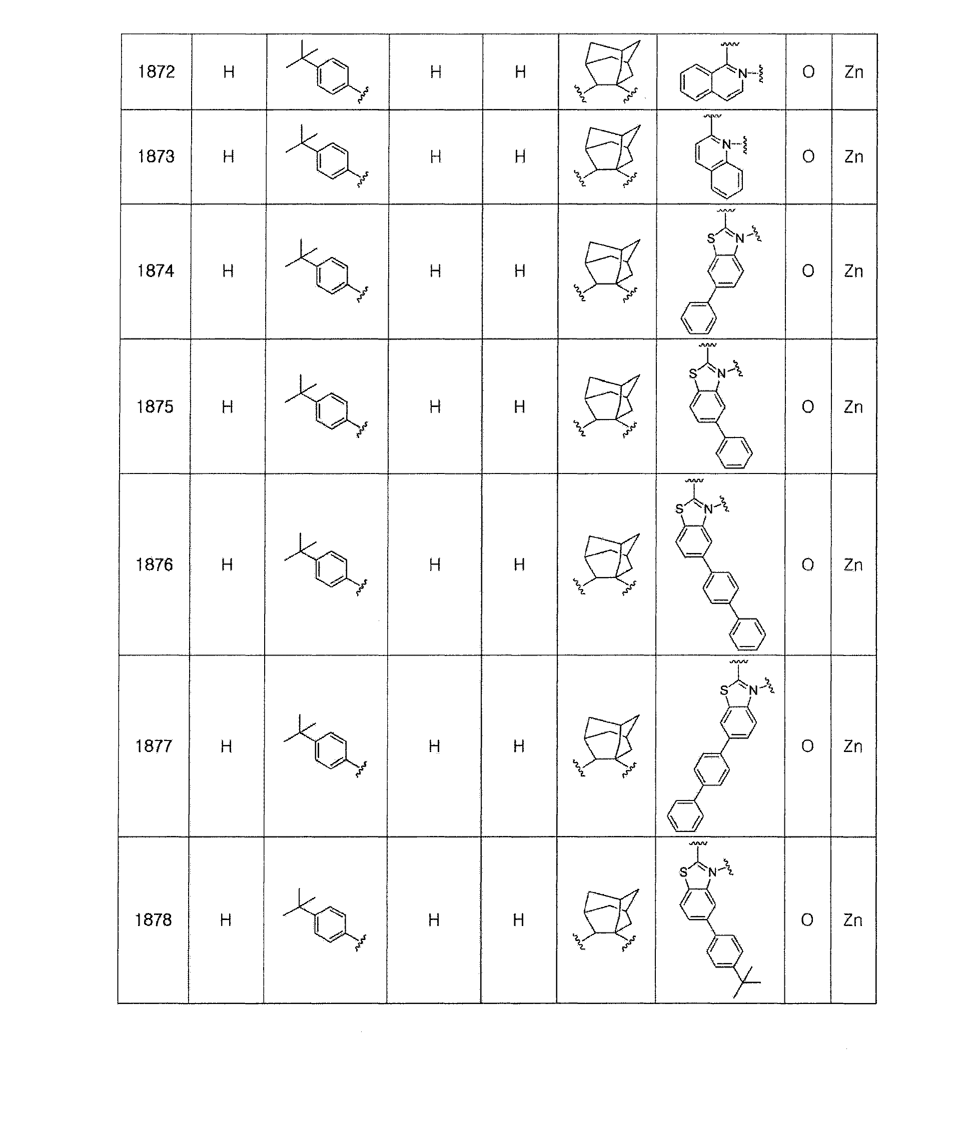

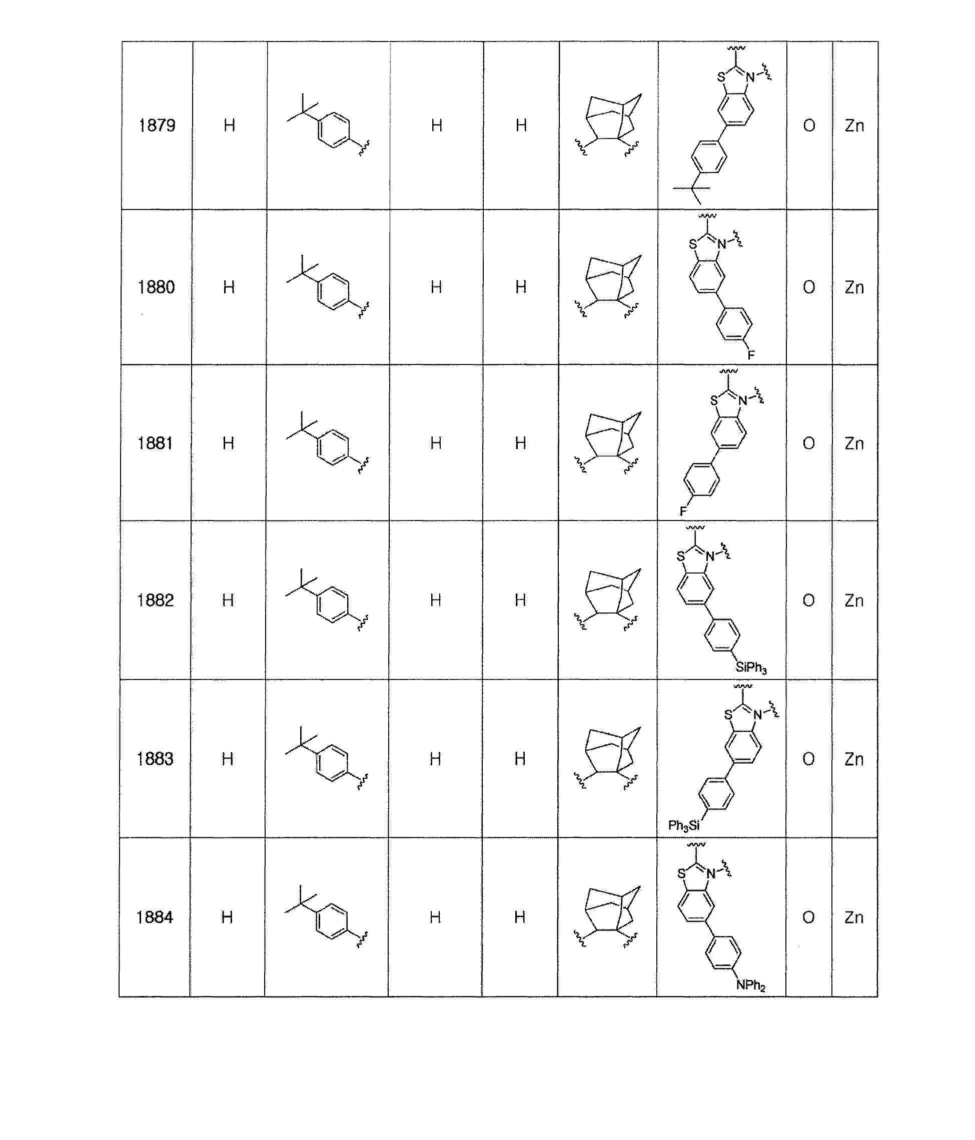

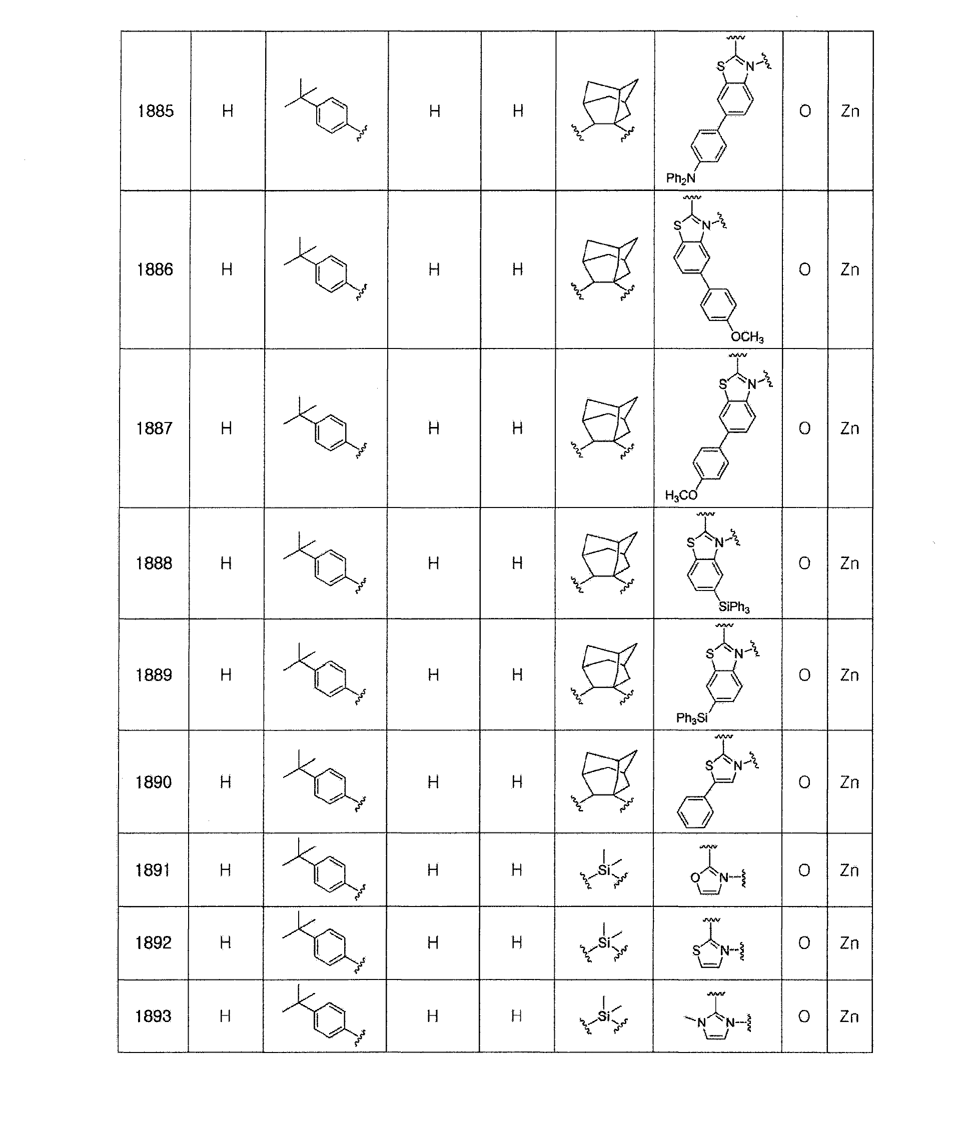

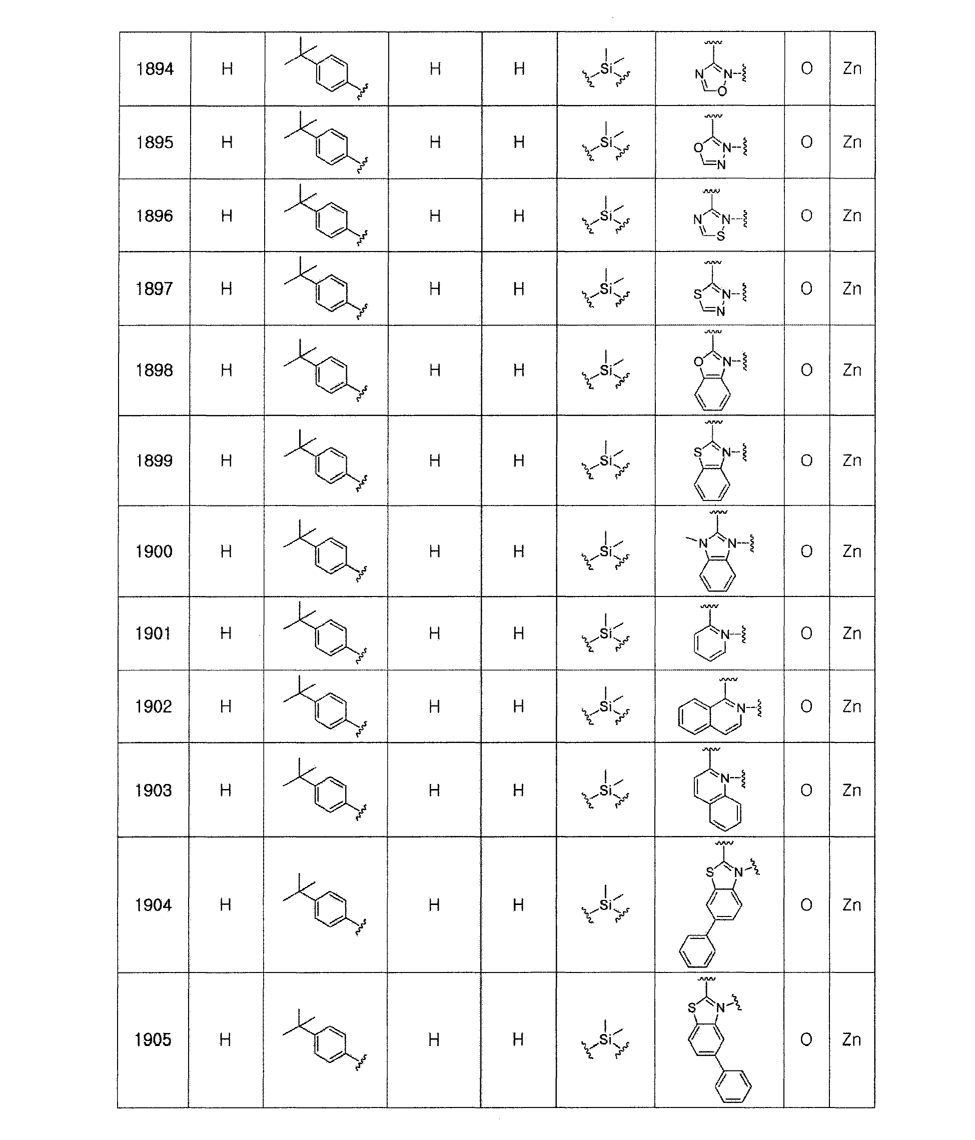

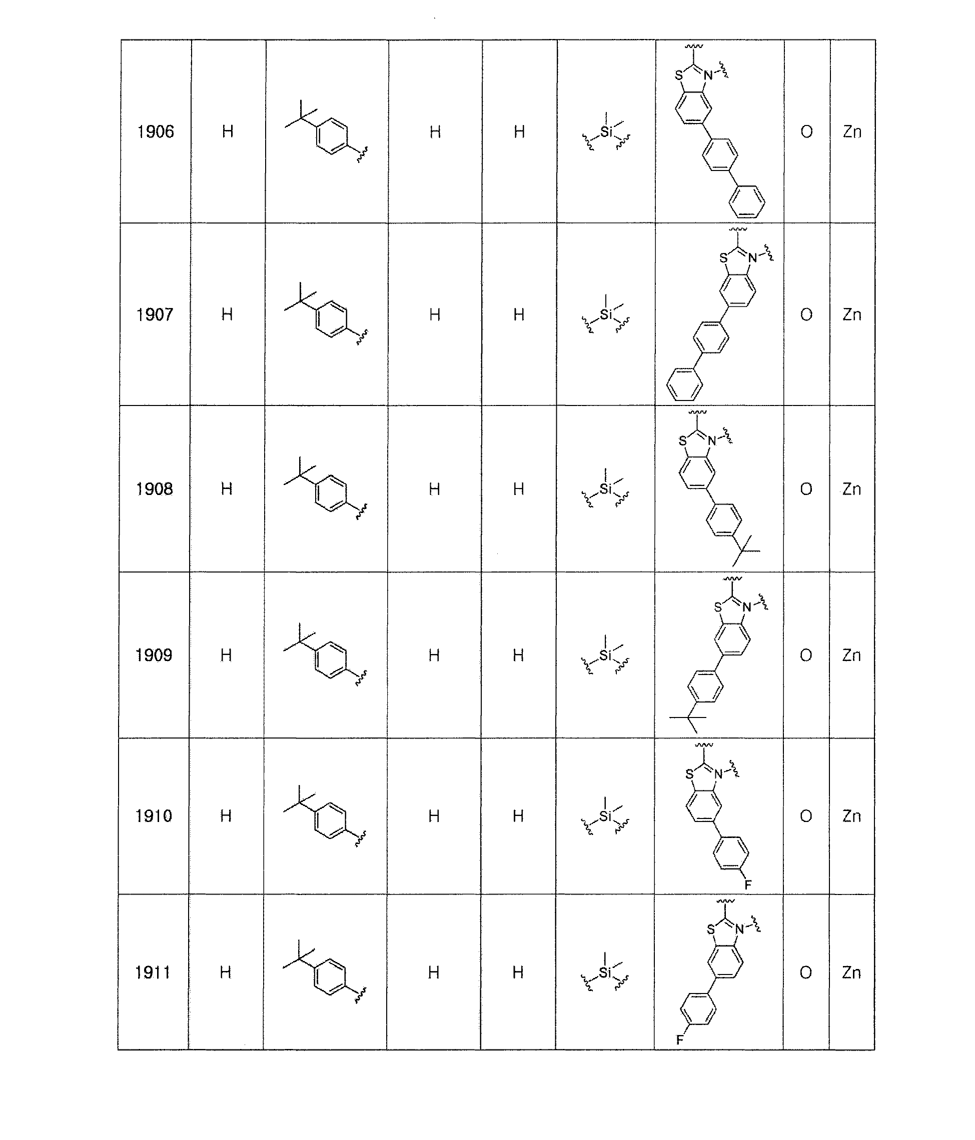

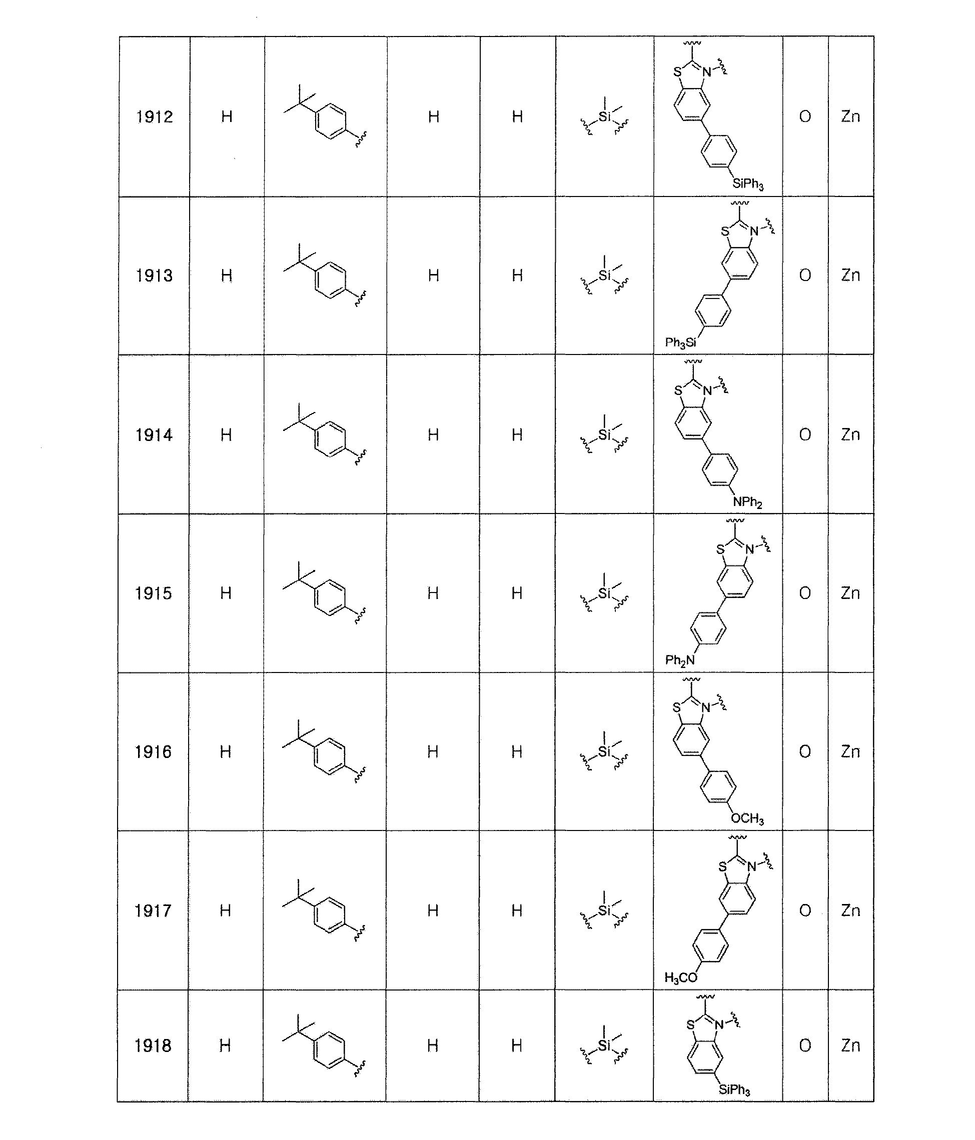

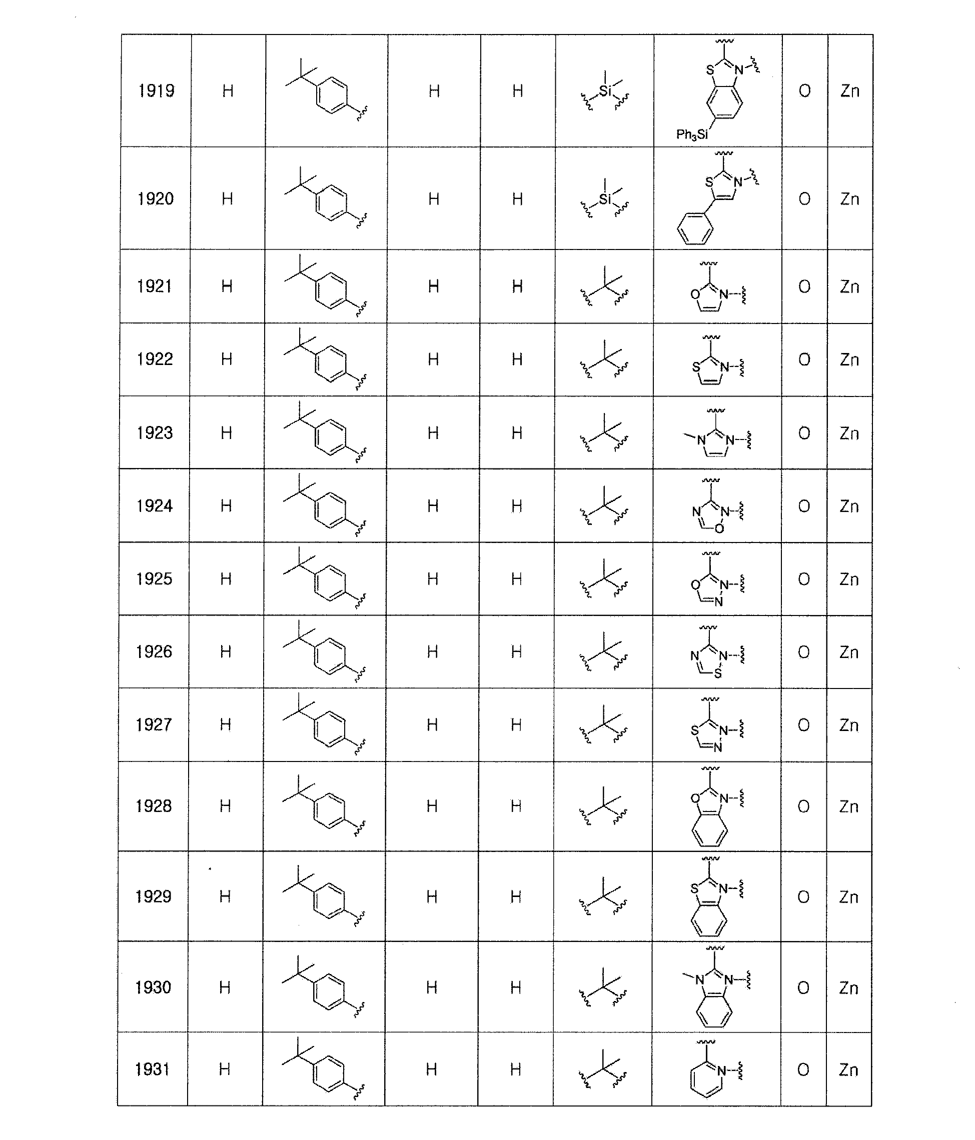

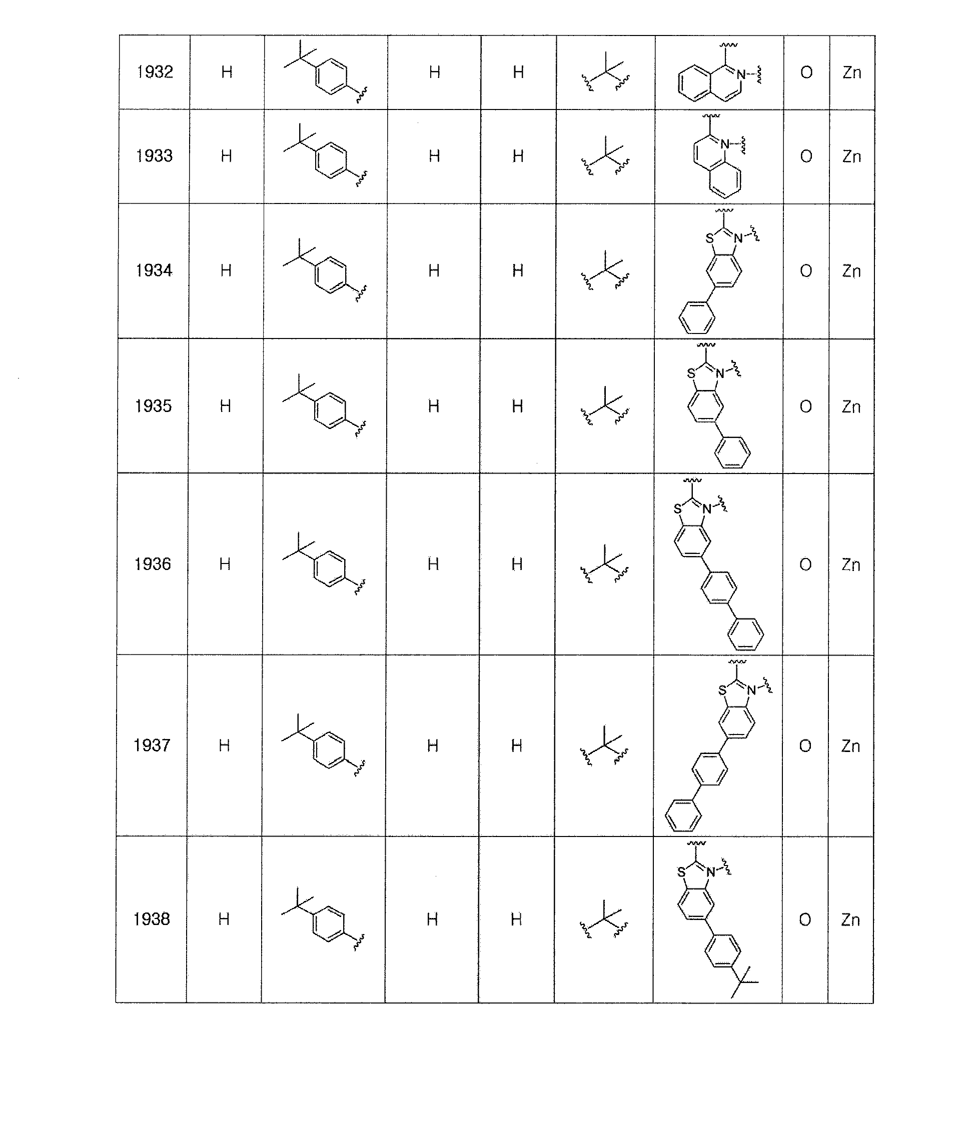

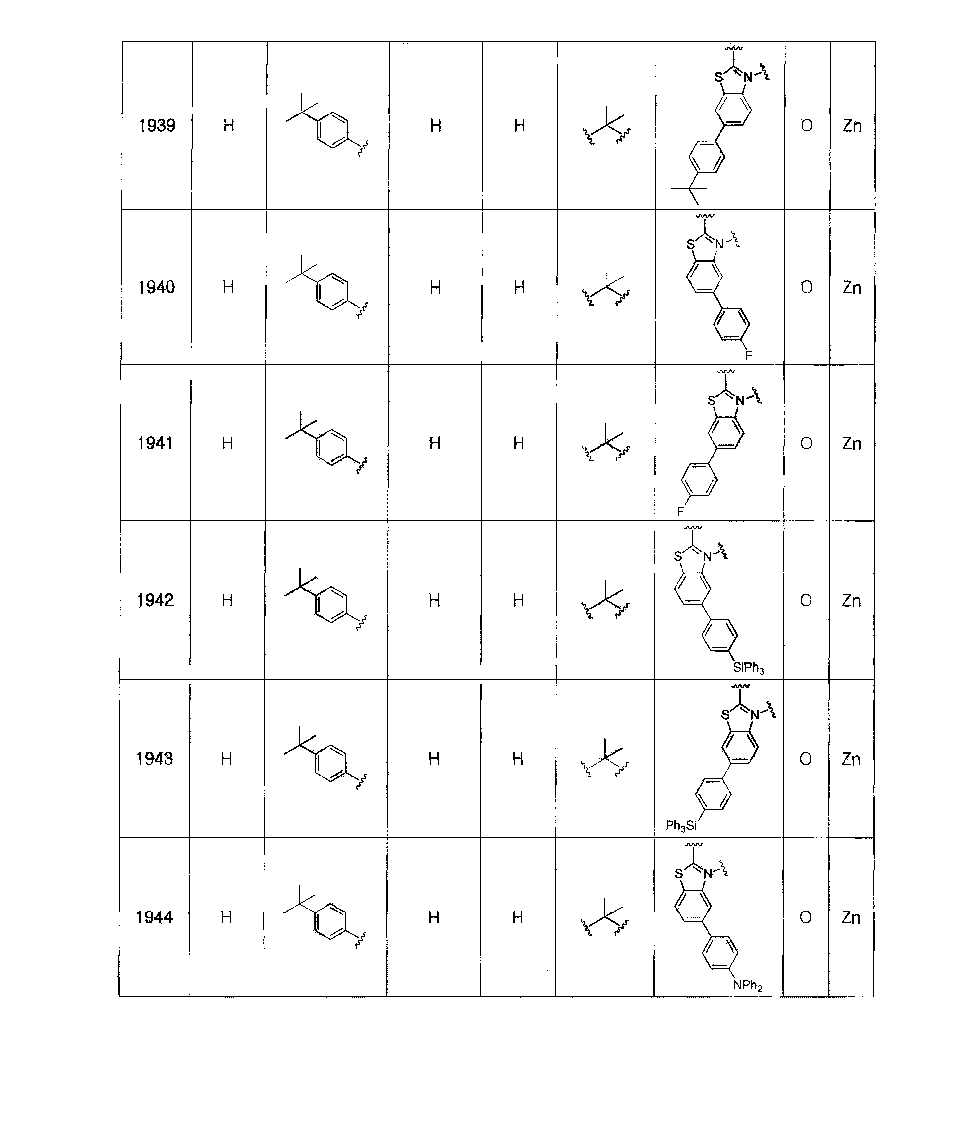

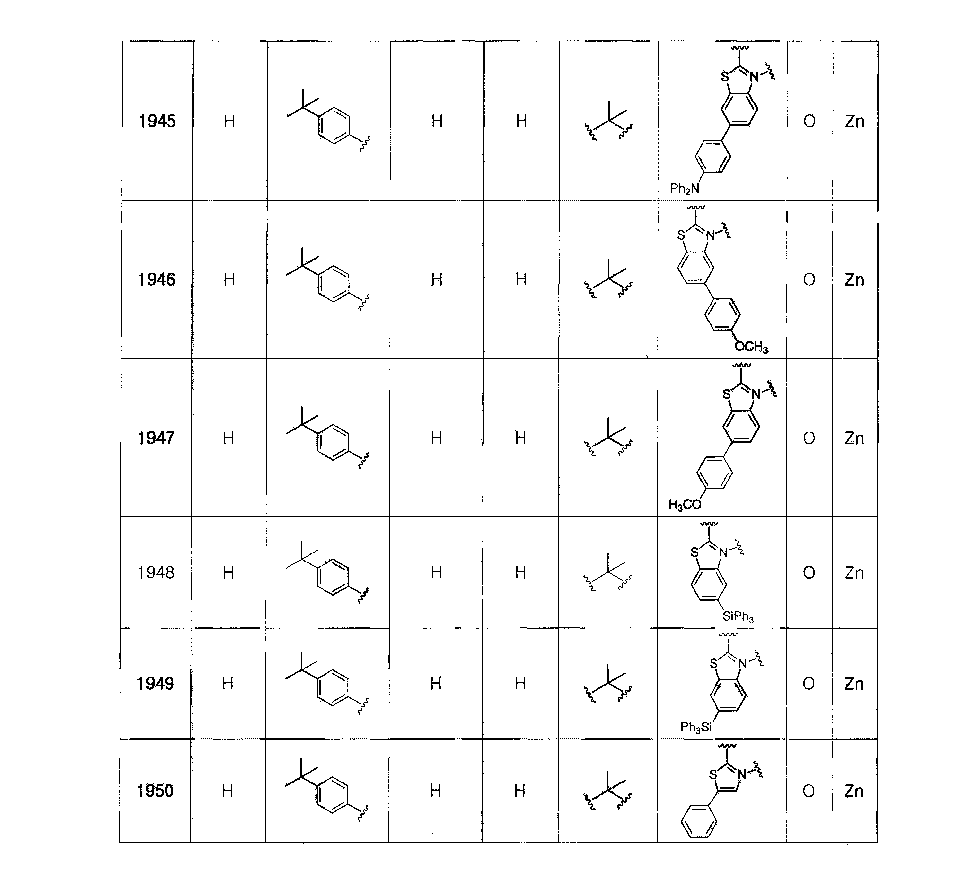

**Table 2**

| Comp. No. | ¹H NMR(CDCl₃, 200 MHz) | MS/FAB |
|---|---|---|
| 9 | δ = 8.23(m, 2H), 8.12(m, 2H), 7.55(m, 4H), 6.90-6.89(m, 4H), 6.70(m, 2H), 6.61(m, 2H), 3.81(s, 4H) | 545(found) 546.00(calculated) |
| 38 | δ = 7.26(m, 8H), 6.96-6.91(m, 4H), 6.74(m, 2H), 6.65(m, 2H), 1.91(s, 8H), 0.96(s, 12H) | 625(found) 626.08(calculated) |
| 67 | δ=6.90-6.89(m,4H),6.70(m.2H),6.61(m,2H) | 519(found) 519.82(calculated) |
| 96 | δ = 6.96-6.91(m, 4H), 6.74-7.65(m, 4H), 2.21(m, 4H), 1.96(m, 4H), 1.56-1.46(m, 8H) | 555(found) 556.04(calculated) |
| 154 | δ = 7.12(m, 2H), 6.89(m, 2H), 6.74(m, 2H), 6.65(m, 2H), 1.39(s, 24H) | 555(found) 555.98(calculated) |
| 212 | δ = 7.74(m, 2H), 7.12(m, 4H), 6.89(m, 2H), 6.74(m, 2H), 6.65(m, 2H), 1.79(s, 4H), 1.39(s, 24H) | 614(found) 614.20(calculated) |
| 241 | δ = 7.69(m, 2H), 7,09(m, 2H), 6.95-6.91(m, 4H), 6.77(m, 2H), 6.68(m, 2H), 2.47(s, 8H), 1.56-1.46(m, 12H), 1.30(m, 4H) | 577(found) 578.04(calculated) |
| 280 | δ = 7.70(m, 4H), 7.26(m, 4H), 6.95-6.91(m, 4H), 6.77(m, 2H), 6.68(m, 2H), 3,63(s, 6H), 2.47(s, 8H), 1.49-1.24(m, 20H) | 731(found) 732.28(calculated) |
| 311 | δ = 8.62(m, 2H), 7.67(m, 2H), 7.29-7.23(m, 4H), 6.96-6.91(m, 4H), 6.74-6.65(m, 4H), 3.08(m, 2H), 1.79-7.77(m, 4H), 1.56-1.41(m, 12H) 1.18-1.13(m, 6H) | 645 (found) 646.16(calculated) |
| 342 | δ = 8.55(m, 2H), 7.87(m, 2H), 7.71(m, 2H), 7.60-7.50(m, 6H), 7.10(m, 4H), 6.80(m, 2H0, 6.70(m, 2H), 0.66(s, 12H) | 621(found) 622.20(calculated) |
| 373 | δ = 8.02(m, 2H), 7.94(m, 2H), 7.69(m, 2H), 7.60(m, 2H), 7.39(m,2H), 7.12(m, 2H), 6.96-6.91(m, 4H), 6.74(m, 2H), 6.65(m, 2H), 1.67(s, 12H) | 589(found) 590.04(calculated) |
| 404 | δ = 8.34-8.29(m, 4H), 7.77(m, 2H), 7.48(m, 8H), 7.32-7.13(m, 16H), 6.71(m, 2H), 1.67(s, 12H) | 906(found) 906.48(calculated) |
| 795 | δ = 8.45(s, 2H), 8.18(m, 2H), 7.77(m, 2H), 7.48-7.46(m, 8H), 7.32(m, 4H), 7.22-7.13(m, 6H), 7.03(m, 4h), 6.71(m, 2H), 3.81(s, 4H) | 885(found) 886.36(calculated) |
| 1186 | δ = 8.45(m, 2H), 8.18(m, 2H), 7.77(m, 2H), 7.54-7.48(m, 24H), 7.32(m, 8H), 7.22(m, 4H), 7.12(m, 4H), 6.67(m, 2H), 3.81(s, 4H) | 1154(found) 1154.76(calculated) |
| 1577 | δ = 8.34-8.29(m, 4H), 7.77(m, 2H), 7.54-7.48(m, 12H), 7.40-7.32(m, 12H), 7.22(m, 2H), 7.12(m, 4H), 6.67(m, 2H), 3.81(s, 4H), 1.34(s,18H) | 1114(found) 1114.78(calculated) |

### [Example 1] Manufacture of an OLED by using an EL compound according to the invention

An OLED device was manufactured by using an EL material according to the invention as host material. The cross-sectional view of the OLED is shown in Fig. 1.

First, a transparent electrode ITO thin film (15 Ω/□) (produced by Samsung Corning) (2) prepared from glass for OLED (1) was subjected to ultrasonic washing with trichloroethylene, acetone, ethanol and distilled water, sequentially, and stored in isopropanol before use.

Then, an ITO substrate was equipped in a substrate folder of a vacuum vapor-deposit device, and 4,4',4"-tris(N,N-(2-naphthyl)-phenylamino)triphenylamine (2-TNATA) was placed in a cell of the vacuum vapor-deposit device, which was then ventilated up to 10⁻⁶ torr of vacuum in the chamber. Electric current was applied to the cell to evaporate 2-TNATA, thereby providing vapor-deposit of a hole injection layer (3) having 60 nm of thickness on the ITO substrate.

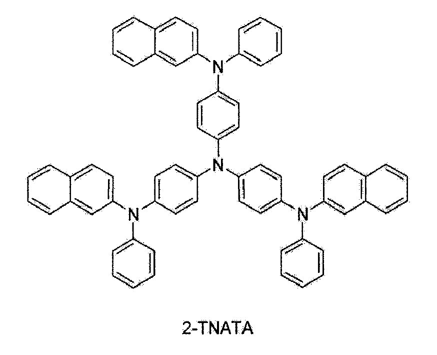

Then, to another cell of the vacuum vapor-deposit device, charged was N,N'-bis(α-naphthyl)-N,N'-diphenyl-4,4'-diamine (NPB), and electric current was applied to the cell to evaporate NPB, thereby providing vapor-deposit of a hole transport layer (4) of 20 nm of thickness on the hole injection layer.

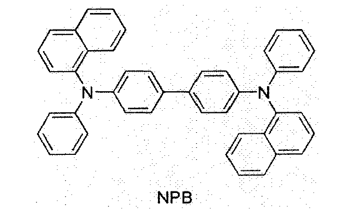

To one cell of said vacuum vapor-deposit device, charged was a compound according to the present invention (e.g. Compound 99) purified by vacuum sublimation, and an EL dopant [e.g. Compound (piq)₂Ir(acac)] was charged to another cell. The two materials were evaporated at different rates to carry out doping at a concentration of 4 to 10 wt%, to vapor-deposit an electroluminescent layer (5) having 30 nm of thickness on the hole transport layer.

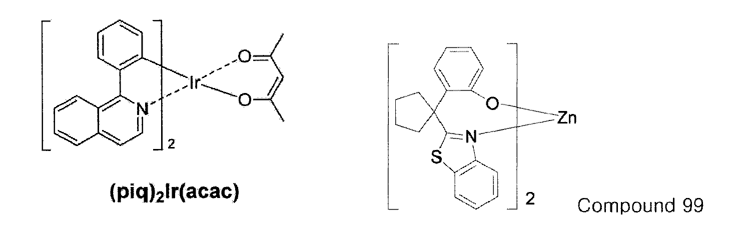

Then, tris(8-hydroxyquinoline)aluminum (III) (Alq) was vapor-deposited as an electron transport layer (6) with a thickness of 20 nm, and lithium quinolate (Liq) (of which the structure is shown below) was vapor-deposited as an electron injection layer (7) with a thickness of 1 to 2 nm. Thereafter, an Al cathode (8) was vapor-deposited with a thickness of 150 nm by using another vacuum vapor-deposit device to manufacture an OLED.

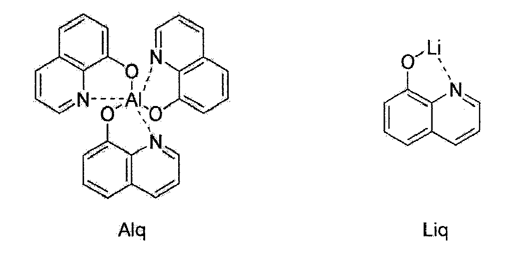

### [Comparative Example 1] Manufacture of an OLED by using a conventional EL material

An OLED was manufactured according to the same procedure described in Example 1, but another cell of the vapor-deposition device was charged with bis(2-methyl-8-quinolinato)(p-phenylphenolato)aluminum (III) (BAlq) as electroluminescent host material instead of the electroluminescent compound according to the present invention.

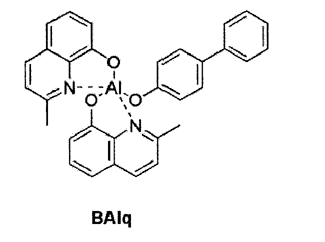

### [Experimental Example 1]

Operation voltage and power efficiency of an OLED of Example 1 comprising an electroluminescent compound according to the invention, and an OLED prepared from Comparative Example 1 comprising a conventional electroluminescent compound were measured at 1,000 cd/m², and the results are shown in Table 3.

From Table 3 showing the EL properties of the electroluminescent compounds developed by the present invention, it is confirmed that the EL compounds developed by the present invention exhibit excellent properties in view of performances as compared to conventional materials.

**Table 3**

| | Host | EL material | Operation voltage (V) @1,000 cd/m² | Power efficiency (Im/W)@1,000 cd/m² | EL color |
|---|---|---|---|---|---|
| Ex. 1 | 2 | (piq)₂Ir(acac) | 5.2 | 4.2 | Red |
| Ex. 2 | 99 | (piq)₂Ir(acac) | 5.0 | 5.2 | Red |
| Ex. 3 | 145 | (piq)₂Ir(acac) | 5.2 | 4.4 | Red |
| Ex. 4 | 308 | (piq)₂Ir(acac) | 5.5 | 4.1 | Red |
| Ex. 5 | 411 | (piq)₂Ir(acac) | 5.2 | 4.0 | Red |
| Ex. 6 | 589 | (piq)₂Ir(acac) | 4.9 | 4.2 | Red |
| Ex. 7 | 623 | (piq)₂Ir(acac) | 5.2 | 4.4 | Red |
| Ex. 8 | 685 | (piq)₂Ir(acac) | 5.7 | 4.3 | Red |
| Ex. 9 | 725 | (piq)₂Ir(acac) | 6.0 | 4.2 | Red |
| Ex. 10 | 846 | D-6 | 6.0 | 5.0 | Red |
| Ex. 11 | 894 | D-9 | 5.4 | 3.7 | Red |
| Ex. 12 | 922 | D-6 | 5.2 | 4.9 | Red |
| Ex. 13 | 1156 | D-12 | 5.2 | 4.8 | Red |
| Ex. 14 | 1220 | D-12 | 5.3 | 4.7 | Red |
| Ex. 15 | 1347 | D-12 | 5.5 | 4.6 | Red |
| Ex. 16 | 1490 | D-36 | 5.2 | 4.8 | Red |
| Ex. 17 | 1730 | D-36 | 5.7 | 4.7 | Red |
| Comp. Ex.1 | BAlq | (piq)₂Ir(acac) | 7.5 | 2.6 | Red |

As can be seen from Table 3, EL properties of the complexes developed by the present invention are more excellent as compared to those of conventional materials. Particularly, the OLED according to the present invention showed better current property than that of Comparative Example 1, and provided operation voltage lowered by at least 1V ∼ 2.5V. Due to excellent EL properties, the OLED according to the present invention exhibited far higher (2-fold or more) power efficiency than that of Comparative Example 1. When B was substituted by aryl group, the device was operated at a lower voltage by at least 2V as compared to the device comprising conventional material, with exhibiting higher power efficiency by at least 2 lm/W.

Thus, the device employing the electroluminescent compound according to the invention as host material exhibits excellent EL properties, and lowered operation voltage, to induce increase of power efficiency by 1.1∼2.6 lm/W and to improve the power consumption.

## Claims

1. An electroluminescent compound represented by Chemical Formula (1):
Chemical Formula 1 L¹L¹M
In Chemical Formula (1), ligand L¹ is represented by the following structural formula: 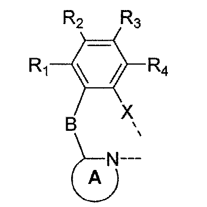 wherein, M represents a bivalent metal;
X represents O, S or Se;
ring A represents a 5- or 6-membered heteroaromatic ring or a 5- or 6-heteroaromatic ring fused with a (C6-C20)aromatic ring, and the heteroaromatic ring or the heteroaromatic ring fused with an aromatic ring may form a chemical bond with R₁ to create a fused ring, and ring A may be further substituted by (C1-C10)alkyl, halogen, (C1-C10)alkyl with halogen substituent(s), phenyl, naphthyl, biphenyl, fluorenyl, thiophenyl, furanyl, tri(C1-C10)alkylsilyl, tri(C6-C20)arylsilyl, di(C1-C10)alkyl(C6-C20)arylsilyl, di(C1-C10)alkylamino or di(C6-C20)arylamino;
B represents 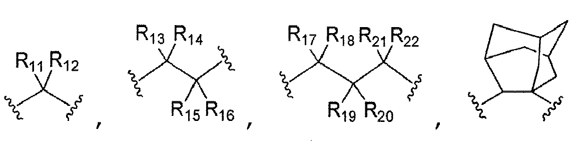 or 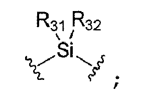 R₁ through R₄ independently represent hydrogen, (C1-C10)alkyl, halogen, (C1-C10)alkyl with halogen substituent(s), tri(C1-C10)alkylsilyl, tri(C6-C20)arylsilyl, di(C1-C10)alkyl(C6-C20)arylsilyl, (C6-C20)aryl, (C4-C20)heteroaryl, di(C1-C10)alkylamino or di(C6-C20)arylamino, or each of them may be linked to an adjacent substituent via alkylene or alkenylene to form a fused ring;
R₁₁ through R₂₂ independently represent hydrogen, (C1-C10)alkyl, halogen, (C1-C10)alkyl with halogen substituent(s), (C1-C10)alkoxy, phenyl, cyano or (C3-C7)cycloalkyl, or each of them may be linked to an adjacent substituent via alkylene or alkenylene to form a (C5-C7) spiro ring or a (C5-C9) fused ring, and R₁₁-R₁₂, R₁₃-R₁₄, R₁₅-R₁₆, R₁₇-R₁₈, R₁₉-R₂₀ or R₂₁-R₂₂ may form a double bond or carbonyl;
R₃₁ and R₃₂ independently represent (C1-C10)alkyl or (C6-C20)aryl; and
the phenyl, naphthyl, biphenyl, fluorenyl, thiophenyl or furanyl substituent on ring A, or aryl or heteroaryl of R₁ through R₄ may be further substituted by one or more substituent(s) selected from (C1-C10)alkyl, halogen, (C1 C10)alkyl with halogen substituent(s), (C1-C10)alkoxy, phenyl, naphthyl, fluorenyl, tri(C1-C10)alkylsilyl, tri(C6-C20)arylsilyl, di(C1-C10)alkyl(C6-C20)arylsilyl, di(C1-C10)alkylamino and di(C6-C20)arylamino.

2. The electroluminescent compound according to claim 1,
wherein L¹ is selected from the following structures: 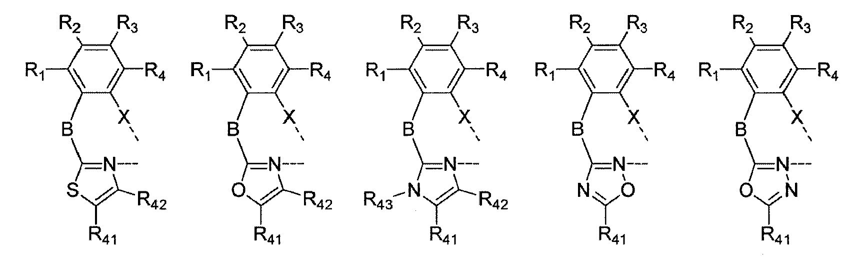 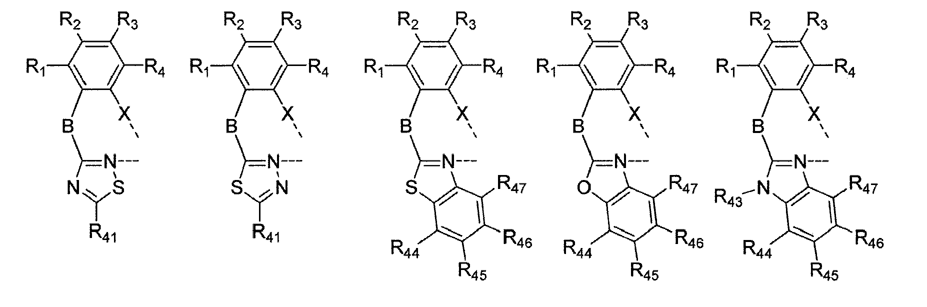 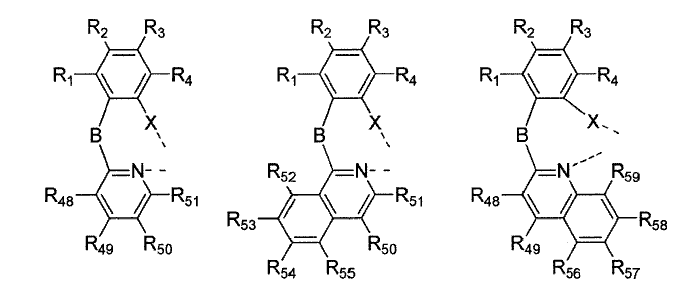 wherein, R₁, R₂, R₃, R₄, X and B are defined as in claim 1;
R₄₁ and R₄₂ independently represent hydrogen, (C1 C10)alkyl, halogen, (C1-C10)alkyl with halogen substituent(s), phenyl, naphthyl, biphenyl, fluorenyl, thiophenyl, furanyl, tri(C1-C10)alkylsilyl, tri(C6-C20)arylsilyl, di(C1-C10)alkylamino or di(C6-C20)arylamino;
R₄₃ represents (C1-C10)alkyl, phenyl or naphthyl;
R₄₄ through R₅₉ independently represent hydrogen, (C1-C10)alkyl, halogen, (C1-C10)alkyl with halogen substituent(s), phenyl, naphthyl, biphenyl, fluorenyl, thiophenyl, furanyl, tri(C1-C10)alkylsilyl, tri(C6-C20)arylsilyl, di(C1-C10)alkylamino or di(C6-C20)arylamino; and
the phenyl, naphthyl, biphenyl, fluorenyl, thiophenyl or furanyl of R₄₁ through R₅₉ may be further substituted by one or more substituent(s) selected from (C1-C10)alkyl, halogen, (C1-C10)alkoxy, phenyl, tri(C1-C10)alkylsilyl, tri(C6-C20)arylsilyl, di(C1-C10)alkylamino and di(C6-C20)arylamino.

3. The electroluminescent compound according to claim 1,
wherein M is selected from Be, Zn, Mg, Cu and Ni.

4. An electroluminescent device comprising an electroluminescent compound represented by Chemical Formula (1) :
Chemical Formula 1 L¹L¹M
In Chemical Formula (1), ligand L¹ is represented by the following structural formula: 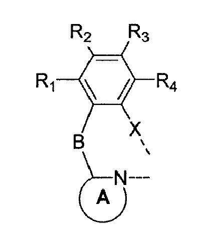 wherein, M represents a bivalent metal;
X represents O, S or Se;
ring A represents a 5- or 6-membered heteroaromatic ring or a 5- or 6-heteroaromatic ring fused with a (C6-C20)aromatic ring, and the heteroaromatic ring or the heteroaromatic ring fused with an aromatic ring may form a chemical bond with R₁ to create a fused ring, and ring A may be further substituted by (C1-C10)alkyl, halogen, (C1-C10)alkyl with halogen substituent(s), phenyl, naphthyl, biphenyl, fluorenyl, thiophenyl, furanyl, tri(C1-C10)alkylsilyl, tri(C6-C20)arylsilyl, di(C1-C10)alkyl(C6-C20)arylsilyl, di(C1-C10)alkylamino or di(C6-C20)arylamino; B represents 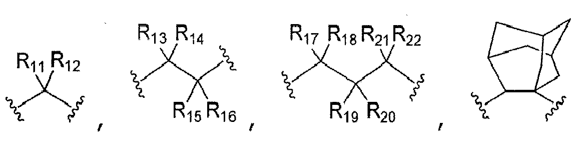 or 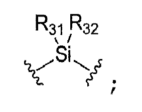 R₁ through R₄ independently represent hydrogen, (C1-C10)alkyl, halogen, (C1-C10)alkyl with halogen substituent(s), tri(C1-C10)alkylsilyl, tri(C6-C20)arylsilyl, di(C1-C10)alkyl(C6-C20)arylsilyl, (C6-C20)aryl, (C4-C20)heteroaryl, di(C1-C10)alkylamino or di(C6-C20)arylamino, or each of them may be linked to an adjacent substituent via alkylene or alkenylene to form a fused ring;
R₁₁ through R₂₂ independently represent hydrogen, (C1-C10)alkyl, halogen, (C1-C10)alkyl with halogen substituent(s), (C1-C10)alkoxy, phenyl, cyano or (C3-C7)cycloalkyl, or each of them may be linked to an adjacent substituent via alkylene or alkenylene to form a (C5-C7) spiro ring or a (C5-C9) fused ring, and R₁₁-R₁₂, R₁₃-R₁₄, R₁₅-R₁₆, R₁₇-R₁₈, R₁₉-R₂₀ or R₂₁-R₂₂ may form a double bond or carbonyl;
R₃₁ and R₃₂ independently represent (C1-C10)alkyl or (C6-C20)aryl; and the phenyl, naphthyl, biphenyl, fluorenyl, thiophenyl or furanyl substituent on ring A, or aryl or heteroaryl of R₁ through R₄ may be further substituted by one or more substituent(s) selected from (C1-C10)alkyl, halogen, (C1 C10)alkyl with halogen substituent(s), (C1-C10)alkoxy, phenyl, naphthyl, fluorenyl, tri(C1-C10)alkylsilyl, tri(C6-C20)arylsilyl, di(C1-C10)alkyl(C6-C20)arylsilyl, di(C1 C10)alkylamino and di(C6-C20)arylamino, wherein the electroluminescent compound is employed as host material of an electroluminescent layer.

5. The electroluminescent device according to claim 4, which is comprised of a first electrode; a second electrode; and at least one organic layer(s) interposed between the first electrode and the second electrode; wherein the organic layer comprises an electroluminescent region comprising one or more organic electroluminescent compound(s) according to any one of claims 1 to 3, and one or more dopant(s) selected from the compounds represented by Chemical Formula (2):
Chemical Formula 2 M¹L³L⁴L⁵
wherein, M¹ is selected from a group consisting of Group 7, 8, 9, 10, 11, 13, 14, 15 and 16 in the Periodic Table, and ligands L³, L⁴ and L⁵ are independently selected from the following structures: 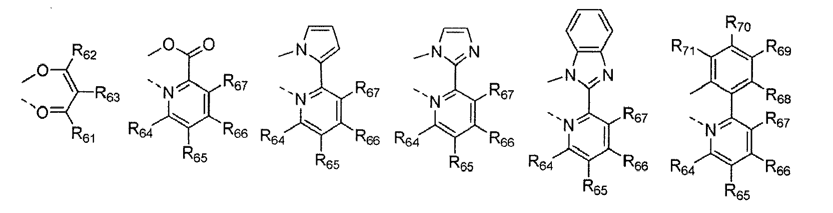 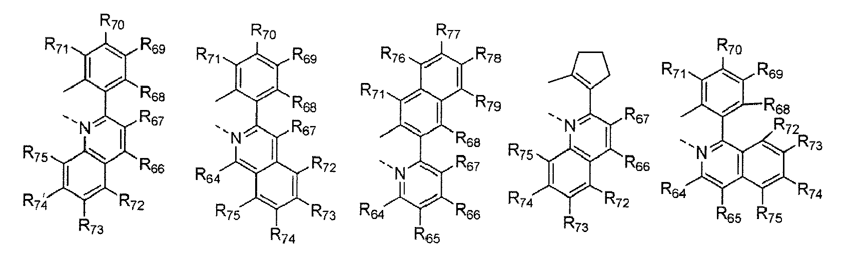 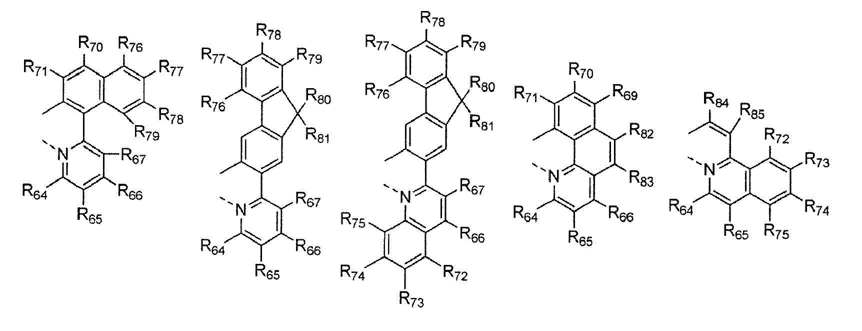 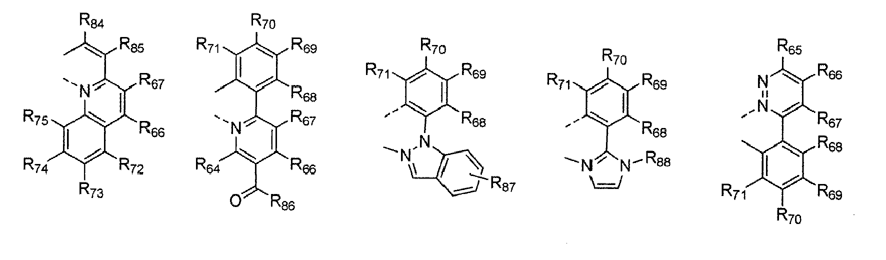 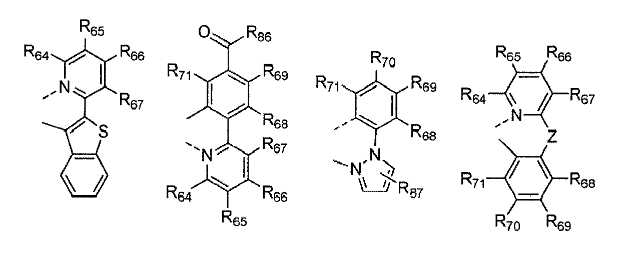 wherein, R₆₁ and R₆₂ independently represent hydrogen, (C1-C20)alkyl with or without halogen substituent(s), phenyl with or without (C1-C20)alkyl substituent(s), or halogen;
R₆₃ through R₇₉, R₈₂ and R₈₃ independently represent hydrogen, (C1-C20)alkyl with or without halogen substituent(s), (C1-C20)alkoxy, phenyl with or without (C1-C20)alkyl substituent(s), SF₅, tri(C1-C20)alkylsilyl or halogen;
R₈₀, R₈₁, R₈₄ and R₈₅ independently represent hydrogen, (C1-C20)alkyl, or phenyl with or without (C1-C20)alkyl substituent(s);
R₈₆ represents (C1-C20)alkyl, phenyl with or without (C1-C20)alkyl substituent(s), or halogen;
R₈₇ and R₈₈ independently represent hydrogen, (C1-C20)alkyl with or without halogen substituent(s), phenyl with or without (C1-C20)alkyl substituent(s), or halogen;
Z represents 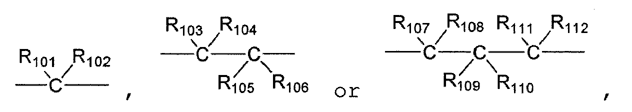 wherein R₁₀₁ through R₁₁₂ independently represent hydrogen, (C1-C20)alkyl with or without halogen substituent(s), alkoxy group, halogen, phenyl, ketone, cyano or (C5-C7) cycloalkyl, or R₁₀₁ through R₁₁₂ and another adjacent group from R₁₀₁through R₁₁₂ may be linked via alkylene or alkenylene to form a (C5-C7) spiro ring or a (C5-C9) fused ring, or they may be linked to R₆₇ or R₆₈ via alkylene or alkenylene to form a (C5-C7) fused ring.

6. The electroluminescent device according to claim 5,
wherein the organic layer comprises one or more compound(s) selected from a group consisting of arylamine compounds and styrylarylamine compounds, or one or more metal(s) selected from a group consisting of organic metals of Group 1, Group 2, 4^{th} period and 5^{th} period transition metals, lanthanide metals and d-transition elements.

7. The electroluminescent device according to claim 5, which is an organic display comprising an electroluminescent compound comprising an electroluminescent compound represented by Chemical Formula (1):
Chemical Formula 1 L¹L¹M
In Chemical Formula (1), ligand L¹ is represented by the following structural formula: 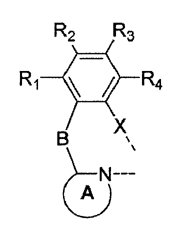 wherein, M represents a bivalent metal;
X represents O, S or Se;
ring A represents a 5- or 6-membered heteroaromatic ring or a 5- or 6-heteroaromatic ring fused with a (C6-C20)aromatic ring, and the heteroaromatic ring or the heteroaromatic ring fused with an aromatic ring may form a chemical bond with R₁ to create a fused ring, and ring A may be further substituted by (C1-C10)alkyl, halogen, (C1-C10)alkyl with halogen substituent(s), phenyl, naphthyl, biphenyl, fluorenyl, thiophenyl, furanyl, tri(C1-C10)alkylsilyl, tri(C6-C20)arylsilyl, di(C1-C10)alkyl(C6-C20)arylsilyl, di(C1-C10)alkylamino or di(C6-C20)arylamino;
B represents 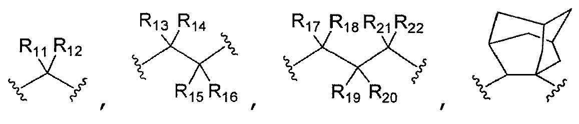 or 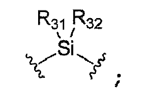 R₁ through R₄ independently represent hydrogen, (C1-C10)alkyl, halogen, (C1-C10)alkyl with halogen substituent(s), tri(C1-C10)alkylszlyl, tri(C6-C20)arylsilyl, di(C1-C10)alkyl(C6-C20)arylsilyl, (C6-C20)aryl, (C4-C20)heteroaryl, di(C1-C10)alkylamino or di(C6-C20)arylamino, or each of them may be linked to an adjacent substituent via alkylene or alkenylene to form a fused ring;
R₁₁ through R₂₂ independently represent hydrogen, (C1-C10)alkyl, halogen, (C1-C10)alkyl with halogen substituent(s), (C1-C10)alkoxy, phenyl, cyano or (C3-C7)cycloalkyl, or each of them may be linked to an adjacent substituent via alkylene or alkenylene to form a (C5-C7) spiro ring or a (C5-C9) fused ring, and R₁₁-R₁₂, R₁₃-R₁₄, R₁₅-R₁₆, R₁₇-R₁₈, R₁₉-R₂₀ or R₂₀-R₂₂ may form a double bond or carbonyl;
R₃₁ and R₃₂ independently represent (C1-C10)alkyl or (C6-C20)aryl; and
the phenyl, naphthyl, biphenyl, fluorenyl, thiophenyl or furanyl substituent on ring A, or aryl or heteroaryl of R₁ through R₄ may be further substituted by one or more substituent(s) selected from (C1-C10)alkyl, halogen, (C1-C10)alkyl with halogen substituent(s), (C1-C10)alkoxy, phenyl, naphthyl, fluorenyl, tri(C1-C10)alkylsilyl, tri(C6-C20)arylsilyl, di(C1-C10)alkyl(C6-C20)arylsilyl, di(C1-C10)alkylamino and di(C6-C20)arylamino, and compounds having the electroluminescent peak with wavelength of blue and green at the same time.

8. The electroluminescent device according to claim 5,
wherein the organic layer comprises an electroluminescent layer and a charge generating layer.

9. The electroluminescent device according to claim 5,
wherein a mixed region of reductive dopant and organic substance, or a mixed region of oxidative dopant and organic substance is placed on the inner surface of one or both electrode(s) among the pair of electrodes.

10. An organic solar cell which comprises an electroluminescent compound comprising an electroluminescent compound represented by Chemical Formula (1):
Chemical Formula 1 L¹_{L}¹_{M}
In Chemical Formula (1), ligand L¹ is represented by the following structural formula: 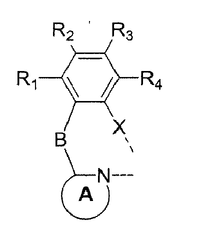 wherein, M represents a bivalent metal;
X represents O, S or Se;
ring A represents a 5- or 6-membered heteroaromatic ring or a 5- or 6-heteroaromatic ring fused with a (C6-C20)aromatic ring, and the heteroaromatic ring or the heteroaromatic ring fused with an aromatic ring may form a chemical bond with R₁ to create a fused ring, and ring A may be further substituted by (C1-C10)alkyl, halogen, (C1-C10)alkyl with halogen substituent(s), phenyl, naphthyl, biphenyl, fluorenyl, thiophenyl, furanyl, tri(C1-C10)alkylsilyl, tri(C6-C20)arylsilyl, di(C1-C10)alkyl(C6-C20)arylsilyl, di(C1-C10)alkylamino or di(C6-C20)arylamino;
B represents 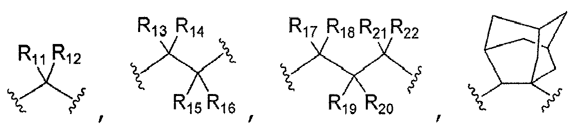 or 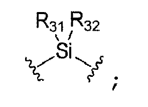 R₁ through R₄ independently represent hydrogen, (C1-C10)alkyl, halogen, (C1-C10)alkyl with halogen substituent(s), tri(C1-C10)alkylsilyl, tri(C6-C20)arylsilyl, di(C1-C10)alkyl(C6-C20)arylsilyl, (C6-C20)aryl, (C4-C20)heteroaryl, di(C1-C10)alkylamino or di(C6-C20)arylamino, or each of them may be linked to an adjacent substituent via alkylene or alkenylene to form a fused ring;
R₁₁ through R₂₂ independently represent hydrogen, (C1-C10)alkyl, halogen, (C1-C10)alkyl with halogen substituent(s), (C1-C10)alkoxy, phenyl, cyano or (C3-C7)cycloalkyl, or each of them may be linked to an adjacent substituent via alkylene or alkenylene to form a (C5-C7) spiro ring or a (C5-C9) fused ring, and R₁₁-R₁₂, R₁₃-R₁₄, R₁₅-R₁₆, R₁₇-R₁₈, R₁₉-R₂₀ or R₂₁-R₂₂ may form a double bond or carbonyl;
R₃₁ and R₃₂ independently represent (C1-C10)alkyl or (C6-C20)aryl; and
the phenyl, naphthyl, biphenyl, fluorenyl, thiophenyl or furanyl substituent on ring A, or aryl or heteroaryl of R₁ through R₄ may be further substituted by one or more substituent(s) selected from (C1-C10)alkyl, halogen, (C1-C10)alkyl with halogen substituent(s), (C1-C10)alkoxy, phenyl, naphthyl, fluorenyl, tri(C1-C10)alkylsilyl, tri(C6-C20)arylsilyl, di(C1-C10)alkyl(C6-C20)arylsilyl, di(C1-C10)alkylamino and di(C6-C20)arylamino.
